# EUROPEAN PATENT SPECIFICATION

(11) **EP 3 972 001 B1**
(45) Date of publication and mention of the grant of the patent: **21.06.2023**
(21) Application number: 21768508.0
(22) Date of filing: 11.03.2021
(51) Int. Cl.: H10K 85/60, C07D 405/00, H10K 50/11

(54) **ORGANIC LIGHT EMITTING DEVICE**
ORGANISCHE LICHTEMITTIERENDE VORRICHTUNG
DISPOSITIF ÉLECTROLUMINESCENT ORGANIQUE

(30) Priority: 11.03.2020 KR 20200030232
(43) Date of publication of application: 23.03.2022
(73) Proprietor: LG Chem, Ltd., Seoul 07336 (KR)
(72) Inventor: KIM, Minjun, Daejeon 34122 (KR); LEE, Dong Hoon, Daejeon 34122 (KR); CHA, Yongbum, Daejeon 34122 (KR); SUH, Sang Duk, Daejeon 34122 (KR); KIM, Young Seok, Daejeon 34122 (KR); OH, Joongsuk, Daejeon 34122 (KR); KIM, Seoyeon, Daejeon 34122 (KR)
(74) Representative: Hoffmann Eitle
(86) International application number: PCT/KR2021/003037
(87) International publication number: WO 2021/182893

(56) References cited:
- WO-A1-2019/066250
- WO-A1-2019/190101
- WO-A1-2019/212289
- WO-A1-2020/032428
- KR-A- 20190 005 522
- KR-A- 20190 008 035
- KR-A- 20190 008 073
- KR-A- 20200 009 971
- KR-A- 20200 018 229

## Description

### Technical Field

The present disclosure relates to relates to an organic light emitting device having improved driving voltage, efficiency and lifetime.

### Background Art

In general, an organic light emitting phenomenon refers to a phenomenon where electric energy is converted into light energy by using an organic material. The organic light emitting device using the organic light emitting phenomenon has characteristics such as a wide viewing angle, an excellent contrast, a fast response time, an excellent luminance, driving voltage and response speed, and thus many studies have proceeded.

The organic light emitting device generally has a structure which comprises an anode, a cathode, and an organic material layer disposed between the anode and the cathode. The organic material layer frequently has a multilayered structure that comprises different materials in order to enhance efficiency and stability of the organic light emitting device, and for example, the organic material layer may be formed of a hole injection layer, a hole transport layer, a light emitting layer, an electron transport layer, an electron injection layer and the like. In the structure of the organic light emitting device, if a voltage is applied between two electrodes, the holes are injected from an anode into the organic material layer and the electrons are injected from the cathode into the organic material layer, and when the injected holes and electrons meet each other, an exciton is formed, and light is emitted when the exciton falls to a ground state again.

In the organic light emitting devices as described above, there is a continuing need for the development of an organic light emitting device having improved driving voltage, efficiency and lifetime. Organic light emitting devices comprising a light emitting layer with multiple host compounds are already known from Patent Literature 2-4.

### [Prior Art Literature]

### [Patent Literature]

(Patent Literature 1) Korean Unexamined Patent Publication No. 10-2000-0051826
(Patent Literature 2) WO 2020/032428 A1 (Patent Literature 3) WO 2019/212289 A1
(Patent Literature 4) WO 2019/190101 A1.

### SUMMARY OF THE INVENTION

### Technical Problem

The present disclosure relates to an organic light emitting device having improved driving voltage, efficiency and lifetime.

### Technical Solution

The following organic light emitting device is provided herein:
An organic light emitting device including: an anode, a cathode, and a light emitting layer disposed between the anode and the cathode,
wherein the light emitting layer includes a compound represented by the following Chemical Formula 1 and a compound represented by the following Chemical Formula 2. 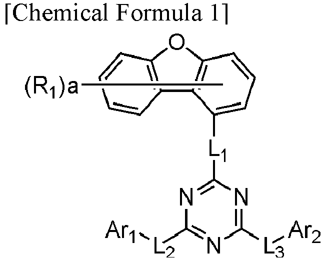
wherein in Chemical Formula 1,
Ar₁ and Ar₂ are each independently a substituted or unsubstituted C₆₋₆₀ aryl; or a substituted or unsubstituted C₂₋₆₀ heteroaryl containing one or more selected from the group consisting of N, O and S,
L₁ to L₃ are each independently a single bond; or a substituted or unsubstituted C₆₋₆₀ arylene,
R₁ is hydrogen; deuterium; a substituted or unsubstituted C₆₋₆₀ aryl; or a substituted or unsubstituted C₂₋₆₀ heteroaryl containing one or more selected from the group consisting of N, O and S,
a is an integer of 0 to 7, 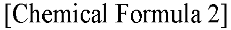 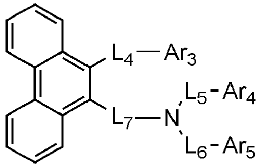
wherein in Chemical Formula 2,
Ar₃ is hydrogen; a substituted or unsubstituted C₆₋₆₀ aryl; or a substituted or unsubstituted C₂₋₆₀ heteroaryl containing one or more selected from the group consisting of N, O and S,
Ar₄ and Ar₅ are each independently a substituted or unsubstituted C₆₋₆₀ aryl; or a substituted or unsubstituted C₂₋₆₀ heteroaryl containing one or more selected from the group consisting of N, O and S
L₄ to L₆ are each independently a single bond; a substituted or unsubstituted C₆₋₆₀ arylene; or a substituted or unsubstituted C₂₋₆₀ heteroarylene containing one or more selected from the group consisting of N, O and S, and
L₇ is a substituted or unsubstituted C₆₋₆₀ arylene.

### Advantageous Effects

The above-mentioned organic light emitting device can improve the efficiency, achieve low driving voltage and/or improve lifetime characteristics by containing the compound represented by Chemical Formula 1 and the compound represented by Chemical Formula 2 in the light emitting layer.

### BRIEF DESCRIPTION OF THE DRAWINGS

FIG. 1 shows an example of an organic light emitting device comprising a substrate 1, an anode 2, a light emitting layer 3, and a cathode 4.
FIG. 2 shows an example of an organic light emitting device comprising a substrate 1, an anode 2, a hole injection layer 5, a hole transport layer 6, an electron blocking layer 7, a light emitting layer 3, a hole blocking layer 8, an electron injection and transport layer 9, and a cathode 4.

### DETAILED DESCRIPTION OF THE EMBODIMENTS

Hereinafter, embodiments of the present disclosure will be described in more detail to facilitate understanding of the invention.

As used herein, the notation 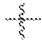 or 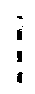 means a bond linked to another substituent group.

As used herein, the term "substituted or unsubstituted" means being unsubstituted or substituted with one or more substituents selected from the group consisting of deuterium; a halogen group; a nitrile group; a nitro group; a hydroxy group; a carbonyl group; an ester group; an imide group; an amino group; a phosphine oxide group; an alkoxy group; an aryloxy group; an alkylthioxy group; an arylthioxy group; an alkylsulfoxy group; an arylsulfoxy group; a silyl group; a boron group; an alkyl group; a cycloalkyl group; an alkenyl group; an aryl group; an aralkyl group; an aralkenyl group; an alkylaryl group; an alkylamine group; an aralkylamine group; a heteroarylamine group; an arylamine group; an arylphosphine group; or a heteroaryl containing at least one of N, O and S atoms, or being unsubstituted or substituted with a substituent to which two or more substituents of the above-exemplified substituents are connected. For example, "a substituent in which two or more substituents are connected" may be a biphenyl group. Namely, a biphenyl group may be an aryl group, or it may also be interpreted as a substituent in which two phenyl groups are connected.

In the present disclosure, the carbon number of a carbonyl group is not particularly limited, but is preferably 1 to 40. Specifically, the carbonyl group may be a group having the following structural formulas, but is not limited thereto.

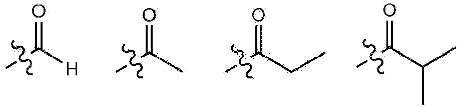

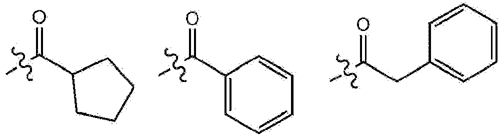

In the present disclosure, an ester group may have a structure in which oxygen of the ester group may be substituted by a straight-chain, branched-chain, or cyclic alkyl group having 1 to 25 carbon atoms, or an aryl group having 6 to 25 carbon atoms. Specifically, the ester group may be a group having the following structural formulas, but is not limited thereto.

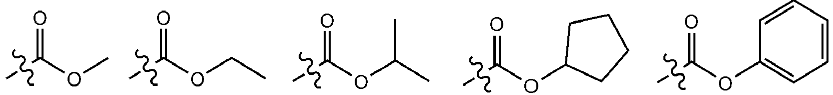

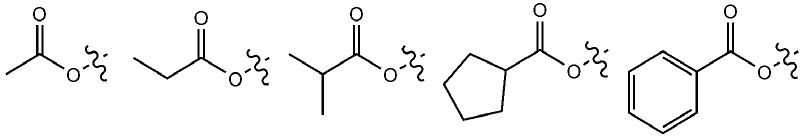

In the present disclosure, the carbon number of an imide group is not particularly limited, but is preferably 1 to 25. Specifically, the imide group may be a group having the following structural formulas, but is not limited thereto.

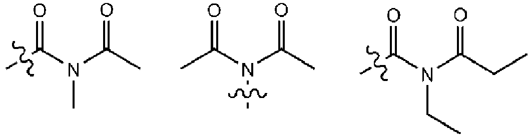

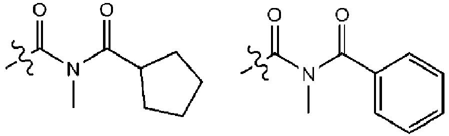

In the present disclosure, a silyl group specifically includes a trimethylsilyl group, a triethylsilyl group, a t-butyldimethylsilyl group, a vinyldimethylsilyl group, a propyldimethylsilyl group, a triphenylsilyl group, a diphenylsilyl group, a phenylsilyl group and the like, but is not limited thereto.

In the present disclosure, a boron group specifically includes a trimethylboron group, a triethylboron group, a t-butyldimethylboron group, a triphenylboron group, and a phenylboron group, but is not limited thereto.

In the present disclosure, examples of a halogen group include fluorine, chlorine, bromine, or iodine.

In the present disclosure, the alkyl group may be straight-chain or branched-chain, and the carbon number thereof is not particularly limited, but is preferably 1 to 40. According to one embodiment, the carbon number of the alkyl group is 1 to 20. According to another embodiment, the carbon number of the alkyl group is 1 to 10. According to another embodiment, the carbon number of the alkyl group is 1 to 6. Specific examples of the alkyl group include methyl, ethyl, propyl, n-propyl, isopropyl, butyl, n-butyl, isobutyl, tert-butyl, sec-butyl, 1-methyl-butyl, 1-ethyl-butyl, pentyl, n-pentyl, isopentyl, neopentyl, tert-pentyl, hexyl, n-hexyl, 1-methylpentyl, 2-methylpentyl, 4-methyl-2-pentyl, 3,3-dimethylbutyl, 2-ethylbutyl, heptyl, n-heptyl, 1-methylhexyl, cyclopentylmethyl, cyclohectylmethyl, octyl, n-octyl, tert-octyl, 1-methylheptyl, 2-ethylhexyl, 2-propylpentyl, n-nonyl, 2,2-dimethylheptyl, 1-ethyl-propyl, 1,1-dimethyl-propyl, isohexyl, 2-methylpentyl, 4-methylhexyl, 5-methylhexyl, and the like, but are not limited thereto.

In the present disclosure, the alkenyl group may be straight-chain or branched-chain, and the carbon number thereof is not particularly limited, but is preferably 2 to 40. According to one embodiment, the carbon number of the alkenyl group is 2 to 20. According to another embodiment, the carbon number of the alkenyl group is 2 to 10. According to still another embodiment, the carbon number of the alkenyl group is 2 to 6. Specific examples thereof include vinyl, 1-propenyl, isopropenyl, 1-butenyl, 2-butenyl, 3-butenyl, 1-pentenyl, 2-pentenyl, 3-pentenyl, 3-methyl-1-butenyl, 1,3-butadienyl, allyl, 1-phenylvinyl-1-yl, 2-phenylvinyl-1-yl, 2,2-diphenylvinyl-1-yl, 2-phenyl-2-(naphthyl-1-yl)vinyl-1-yl, 2,2-bis(diphenyl-1-yl)vinyl-1-yl, a stilbenyl group, a styrenyl group, and the like, but are not limited thereto.

In the present disclosure, a cycloalkyl group is not particularly limited, but the carbon number thereof is preferably 3 to 60. According to one embodiment, the carbon number of the cycloalkyl group is 3 to 30. According to another embodiment, the carbon number of the cycloalkyl group is 3 to 20. According to still another embodiment, the carbon number of the cycloalkyl group is 3 to 6. Specific examples thereof include cyclopropyl, cyclobutyl, cyclopentyl, 3-methylcyclopentyl, 2,3-dimethylcyclopentyl, cyclohexyl, 3-methylcyclohexyl, 4-methylcyclohexyl, 2,3-dimethylcyclohexyl, 3,4,5-trimethylcyclohexyl, 4-tert-butylcyclohexyl, cycloheptyl, cyclooctyl, and the like, but are not limited thereto.

In the present disclosure, an aryl group is not particularly limited, but the carbon number thereof is preferably 6 to 60, and it may be a monocyclic aryl group or a polycyclic aryl group. According to one embodiment, the carbon number of the aryl group is 6 to 30. According to one embodiment, the carbon number of the aryl group is 6 to 20. The aryl group may be a phenyl group, a biphenyl group, a terphenyl group or the like as the monocyclic aryl group, but is not limited thereto. The polycyclic aryl group includes a naphthyl group, an anthracenyl group, a phenanthryl group, a pyrenyl group, a perylenyl group, a chrysenyl group, or the like, but is not limited thereto.

In the present disclosure, the fluorenyl group may be substituted, and two substituents may be linked with each other to form a spiro structure. In the case where the fluorenyl group is substituted, 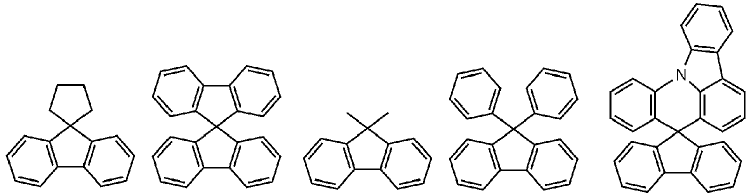 and the like can be formed. However, the structure is not limited thereto.

In the present disclosure, a heterocyclic group is a heterocyclic group containing one or more of O, N, Si and S as a heteroatom, and the carbon number thereof is not particularly limited, but is preferably 2 to 60. Examples of the heterocyclic group include a thiophene group, a furan group, a pyrrole group, an imidazole group, a thiazole group, an oxazol group, an oxadiazol group, a triazol group, a pyridyl group, a bipyridyl group, a pyrimidyl group, a triazine group, an acridyl group, a pyridazine group, a pyrazinyl group, a quinolinyl group, a quinazoline group, a quinoxalinyl group, a phthalazinyl group, a pyridopyrimidinyl group, a pyridopyrazinyl group, a pyrazinopyrazinyl group, an isoquinoline group, an indole group, a carbazole group, a benzoxazole group, a benzoimidazole group, a benzothiazol group, a benzocarbazole group, a benzothiophene group, a dibenzothiophene group, a benzofuranyl group, a phenanthroline group, an isoxazolyl group, a thiadiazolyl group, a phenothiazinyl group, a dibenzofuranyl group, and the like, but are not limited thereto.

In the present disclosure, the aryl group in the aralkyl group, the aralkenyl group, the alkylaryl group and the arylamine group is the same as the aforementioned examples of the aryl group. In the present disclosure, the alkyl group in the aralkyl group, the alkylaryl group and the alkylamine group is the same as the aforementioned examples of the alkyl group. In the present disclosure, the heteroaryl in the heteroarylamine can be applied to the aforementioned description of the heterocyclic group. In the present disclosure, the alkenyl group in the aralkenyl group is the same as the aforementioned examples of the alkenyl group. In the present disclosure, the aforementioned description of the aryl group may be applied except that the arylene is a divalent group. In the present disclosure, the aforementioned description of the heteroaryl group can be applied except that the heteroarylene is a divalent group. In the present disclosure, the aforementioned description of the aryl group or cycloalkyl group can be applied except that the hydrocarbon ring is not a monovalent group but formed by combining two substituent groups. In the present disclosure, the aforementioned description of the heterocyclic group can be applied, except that the heterocyclic ring is not a monovalent group but formed by combining two substituent groups.

Hereinafter, the present disclosure will be described in detail for each configuration.

### Anode and Cathode

The anode and cathode used in the present disclosure mean electrodes used in an organic light emitting device.

As the anode material, generally, a material having a large work function is preferably used so that holes can be smoothly injected into the organic material layer. Specific examples of the anode material include metals such as vanadium, chrome, copper, zinc, and gold, or an alloy thereof; metal oxides such as zinc oxides, indium oxides, indium tin oxides (ITO), and indium zinc oxides (IZO); a combination of metals and oxides, such as ZnO:Al or SNO₂:Sb; conductive polymers such as poly(3-methylthiophene), poly[3,4-(ethylene-1,2-dioxy)thiophene](PEDOT), polypyrrole, and polyaniline, and the like, but are not limited thereto.

As the cathode material, generally, a material having a small work function is preferably used so that electrons can be easily injected into the organic material layer. Specific examples of the cathode material include metals such as magnesium, calcium, sodium, potassium, titanium, indium, yttrium, lithium, gadolinium, aluminum, silver, tin, and lead, or an alloy thereof; a multilayered structure material such as LiF/Al or LiO₂/Al, and the like, but are not limited thereto.

### Hole injection layer

The organic light emitting device according to the present disclosure may further include a hole injection layer on the anode, if necessary.

The hole injection layer is a layer injecting holes from an electrode, and the hole injection material is preferably a compound which has an ability of transporting the holes, a hole injection effect in the anode and an excellent hole injection effect to the light emitting layer or the light emitting material, prevents movement of an exciton generated in the light emitting layer to the electron injection layer or the electron injection material, and has an excellent thin film forming ability. It is preferable that a HOMO (highest occupied molecular orbital) of the hole injection material is between the work function of the anode material and a HOMO of a peripheral organic material layer.

Specific examples of the hole injection material include metal porphyrine, oligothiophene, an arylamine-based organic material, a hexanitrilehexaazatriphenylene-based organic material, a quinacridone-based organic material, a perylene-based organic material, anthraquinone, polyaniline and polythiophene-based conductive polymer, and the like, but are not limited thereto.

### Hole Transport Layer

The organic light emitting device according to the present disclosure may include a hole transport layer on the anode (or on a hole injection layer when the hole injection layer is present), if necessary.

The hole transport layer is a layer that receives holes from an anode or a hole injection layer and transports the holes to the light emitting layer. The hole transport material is suitably a material having large mobility to the holes, which may receive holes from the anode or the hole injection layer and transfer the holes to the light emitting layer.

Specific examples of the hole transport material include an arylamine-based organic material, a conductive polymer, a block copolymer in which a conjugate portion and a non-conjugate portion are present together, and the like, but are not limited thereto.

### Electron Blocking Layer

The electron blocking layer is a layer provided between the hole transport layer and the light emitting layer in order to prevent the electrons injected in the cathode from being transferred to the hole transport layer without being recombined in the light emitting layer, which may also be referred to as an electron inhibition layer or an electron stopping layer. The electron blocking layer is preferably a material having a smaller electron affinity than the electron transport layer.

### Light Emitting Layer

The light emitting layer used in the present disclosure means a layer that can emit light in the visible light region by combining holes and electrons transported from the anode and the cathode. Generally, the light emitting layer includes a host material and a dopant material, and in the present disclosure, the compound represented by Chemical Formula 1 and the compound represented by Chemical Formula 2 are included as a host.

Preferably, the compound represented by Chemical Formula 1 may be represented by any one of the following Chemical Formulas 1-1 to 1-3: 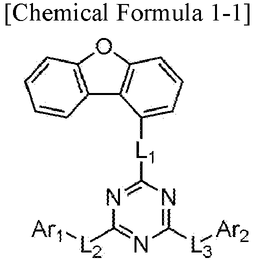 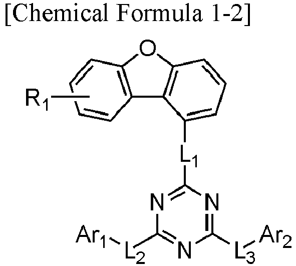 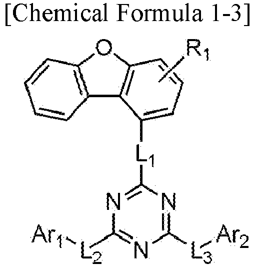 wherein in Chemical Formulas 1-1 to 1-3,
Ar₁ and Ar₂, L₁ to L₃ and R₁ are as defined in Chemical Formula 1.

Preferably, Ar₁ and Ar₂ may be each independently a substituted or unsubstituted C₆₋₂₀ aryl; or a substituted or unsubstituted C₂₋₂₀ heteroaryl containing one or more selected from the group consisting of N, O and S,
more preferably, Ar₁ and Ar₂ may be each independently phenyl, biphenylyl, terphenylyl, naphthyl, phenanthrenyl, dibenzofuranyl, or dibenzothiophenyl, and
most preferably, Ar₁ and Ar₂ may be each independently any one selected from the group consisting of the following:

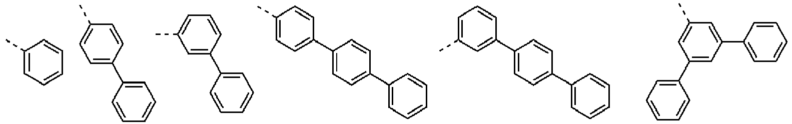

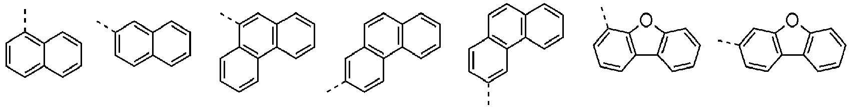

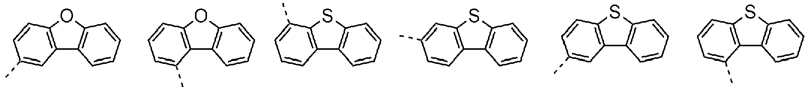

Preferably, L₁ to L₃ may be each independently a single bond; or a substituted or unsubstituted C₆₋₂₀ arylene,
more preferably, L₁ to L₃ may be each independently a single bond, phenylene, biphenylylene or naphthylene, and
most preferably, L₁ to L₃ may be each independently a single bond or any one selected from the group consisting of the following:

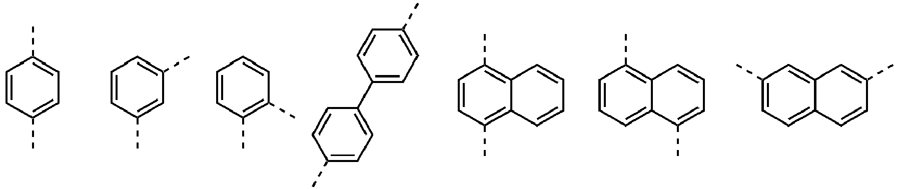

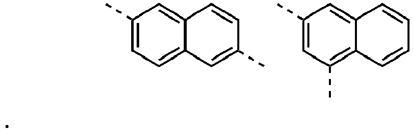

Preferably, each R₁ may be independently hydrogen; deuterium; a substituted or unsubstituted C₆₋₂₀ aryl; or a substituted or unsubstituted C₂₋₂₀ heteroaryl containing one or more selected from the group consisting of N, O and S, and
more preferably, each R₁ may be independently hydrogen, deuterium, phenyl, biphenylyl, terphenylyl, naphthyl, phenanthrenyl, triphenylenyl, naphthyl phenyl, phenyl naphthyl, fluoranthenyl, dihydroindenyl, dibenzofuranyl, dibenzothiophenyl, benzonaphthofuranyl, or benzonaphthothiophenyl.

Preferably, a may be 0 or 1. More preferably, a may be 1.

Preferably, at least one of Ar₁, Ar₂ and R₁ may be naphthyl, phenyl naphthyl, naphthyl phenyl, phenanthrenyl, fluoranthenyl, dibenzofuranyl, dibenzothiophenyl, benzonaphthofuranyl, or benzonaphthothiophenyl.

More preferably, at least one of Ar₁, Ar₂ and R₁ may be naphthyl, phenyl naphthyl, naphthyl phenyl, fluoranthenyl, dibenzofuranyl, benzonaphthofuranyl, or benzonaphthothiophenyl.

Representative examples of the compound represented by Chemical Formula 1 are as follows:

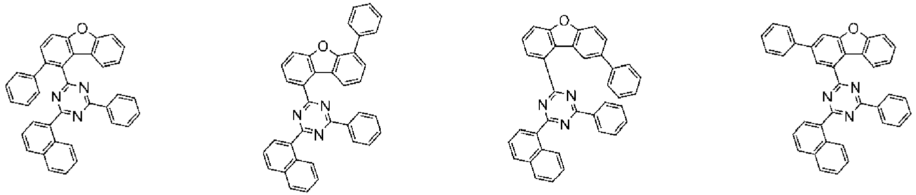

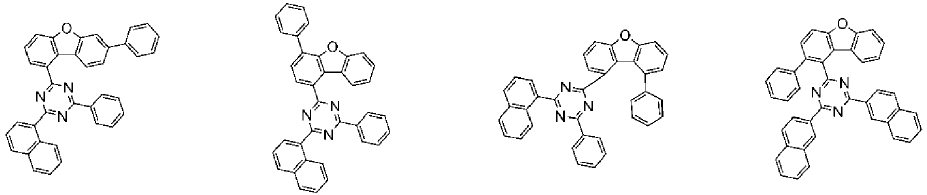

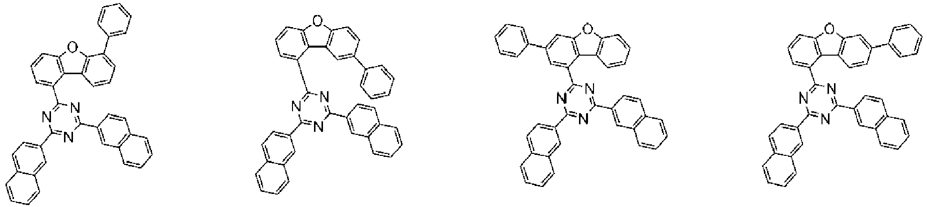

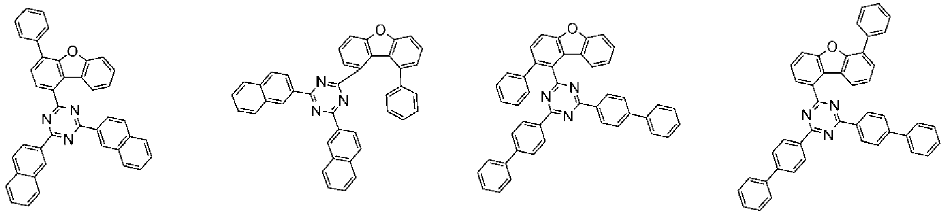

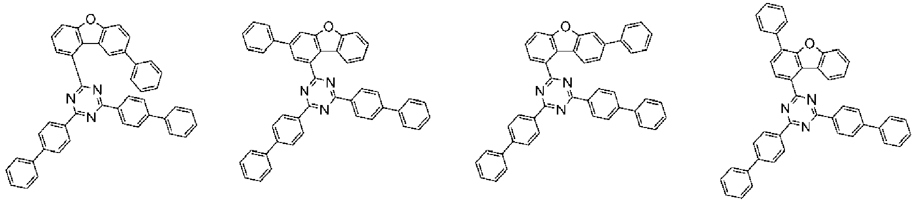

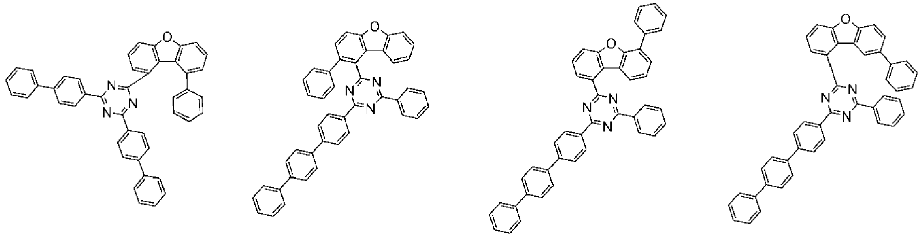

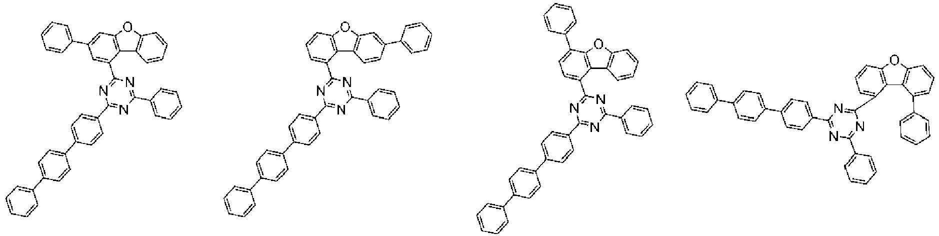

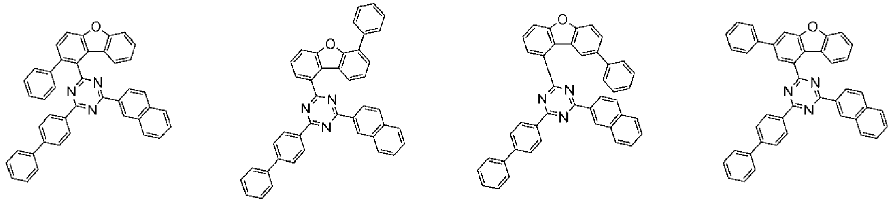

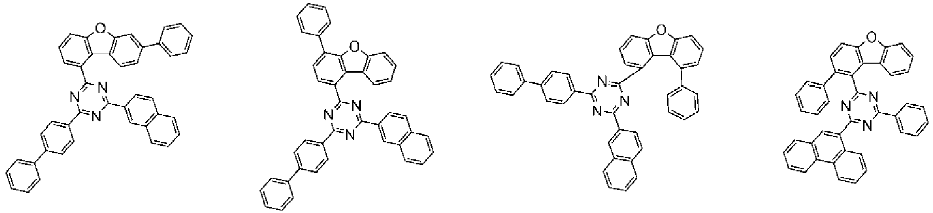

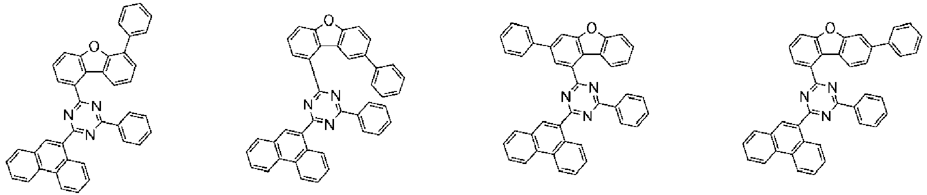

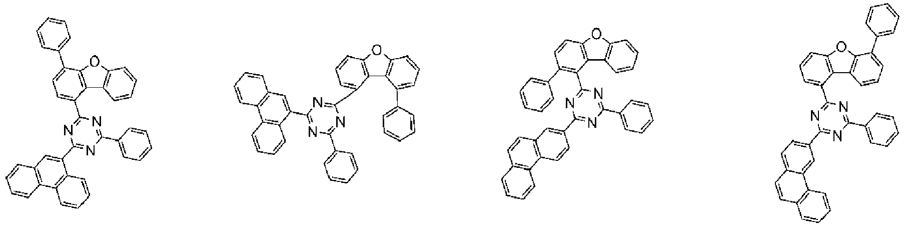

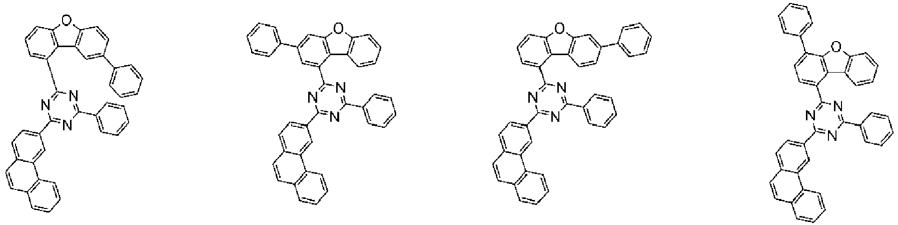

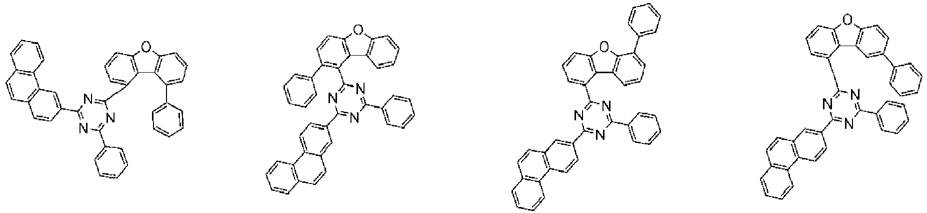

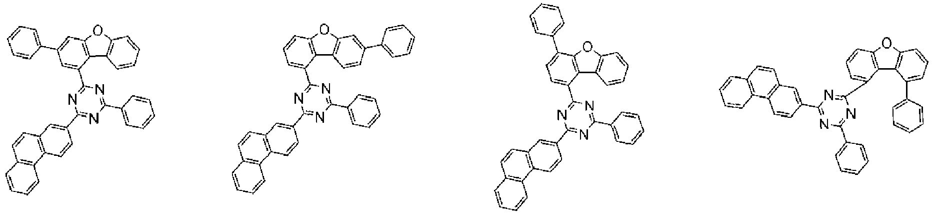

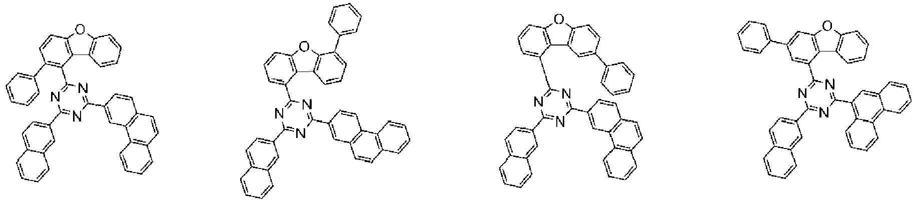

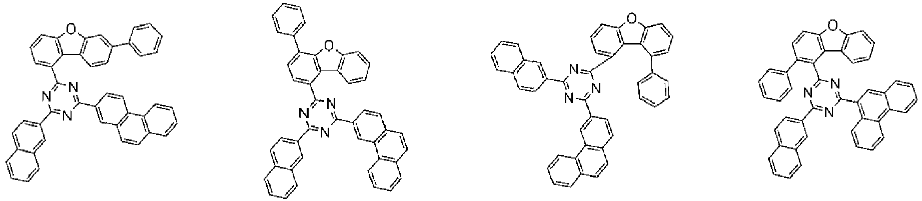

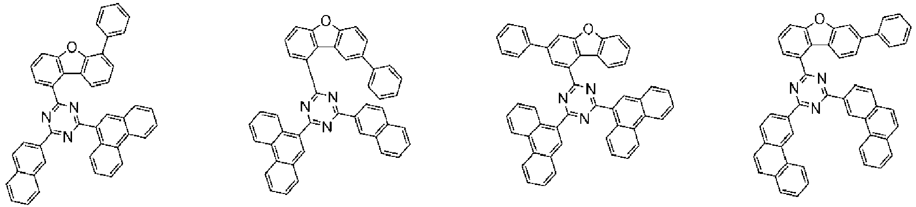

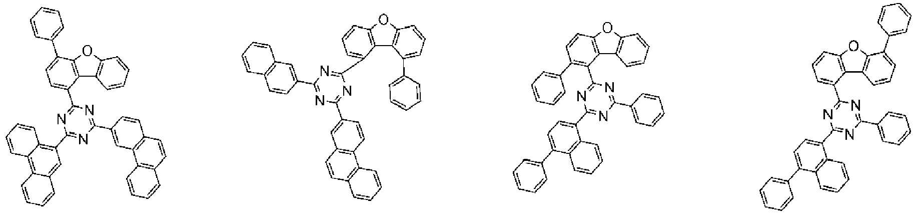

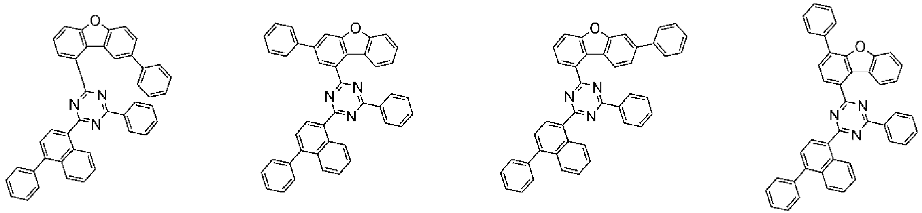

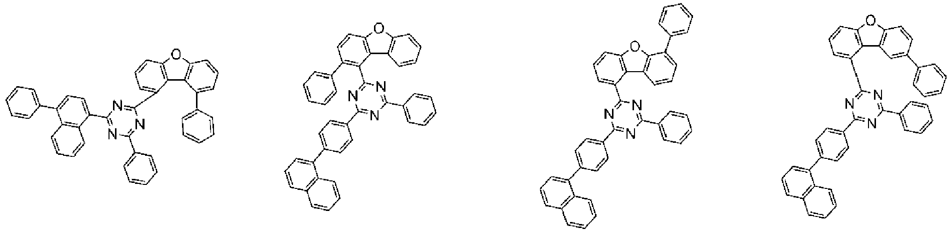

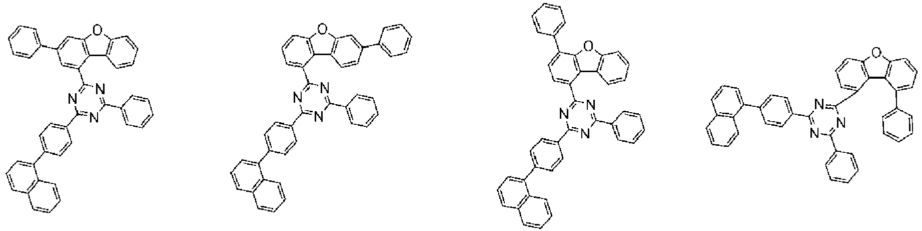

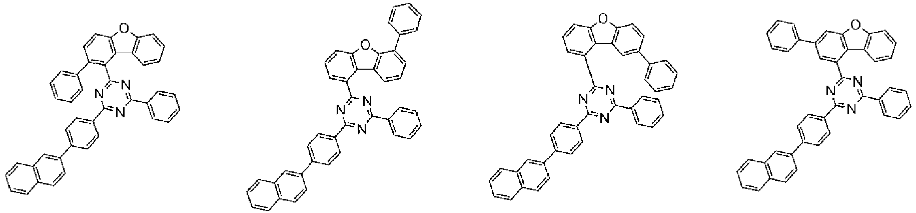

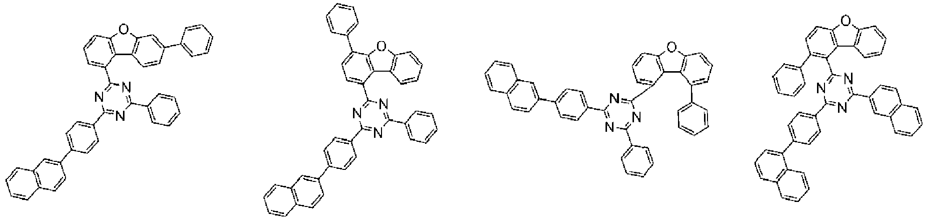

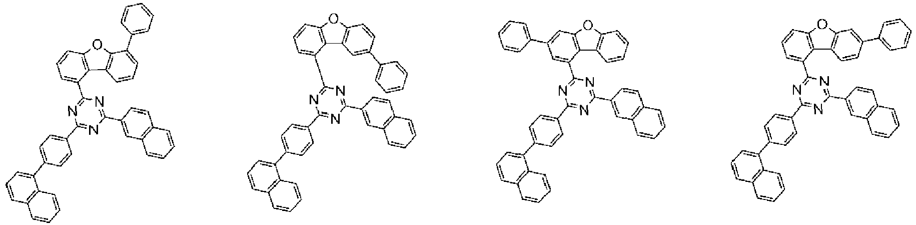

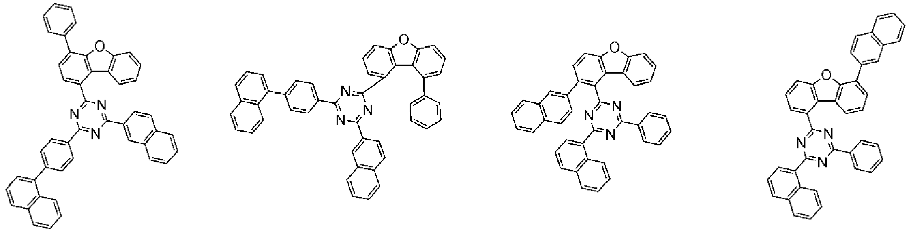

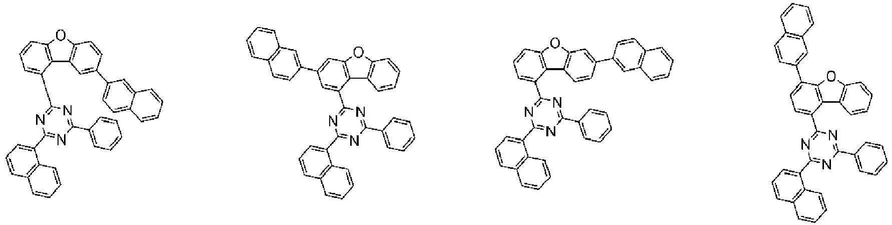

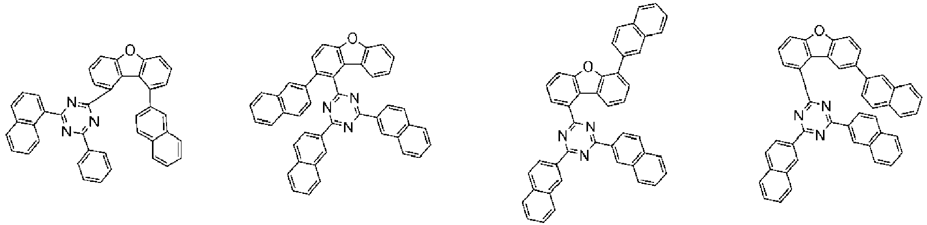

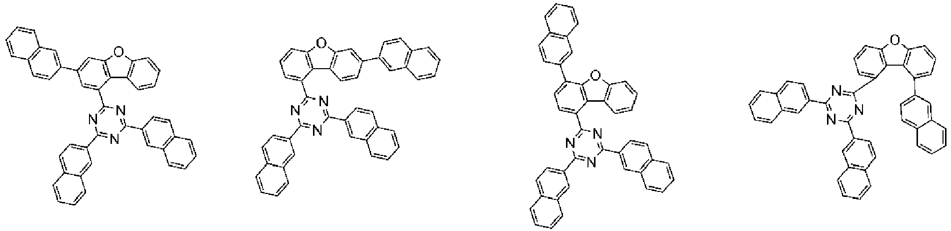

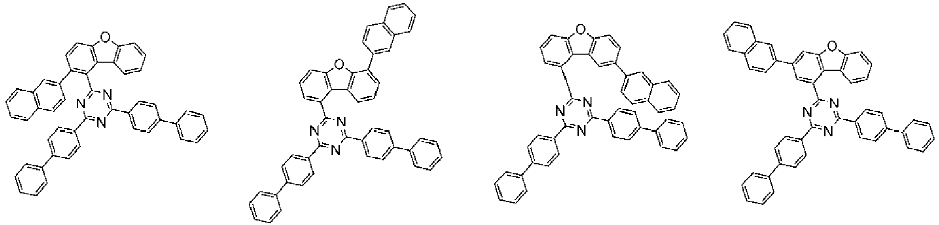

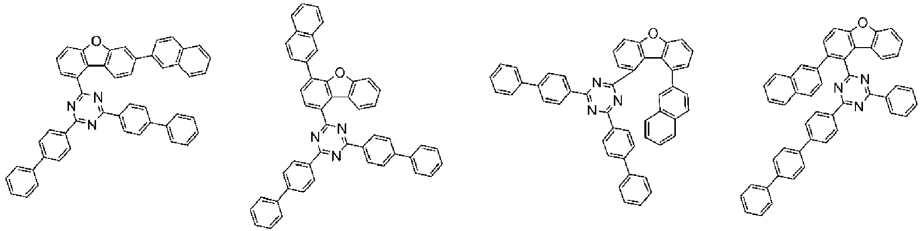

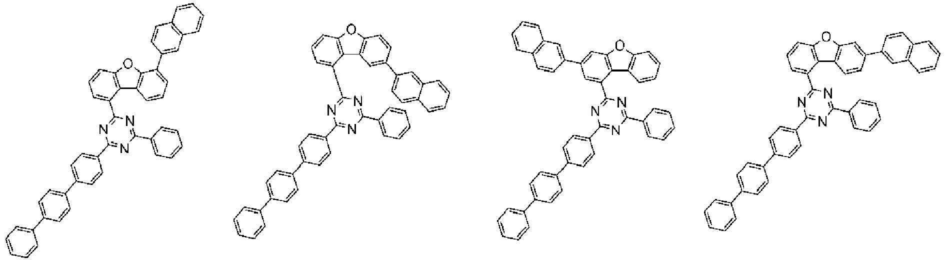

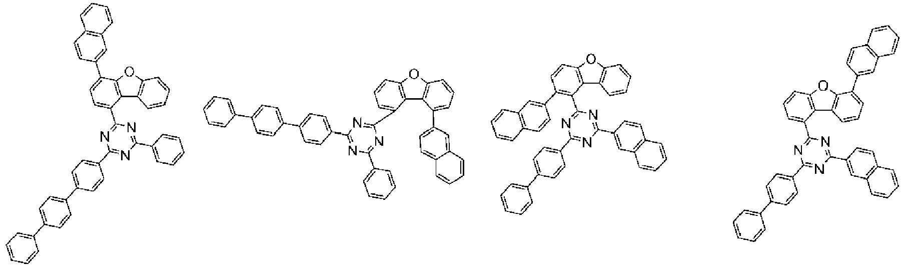

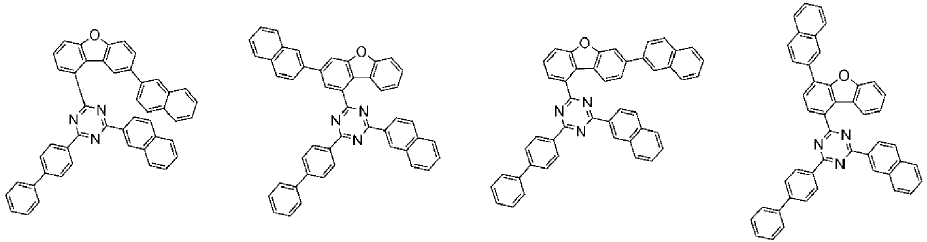

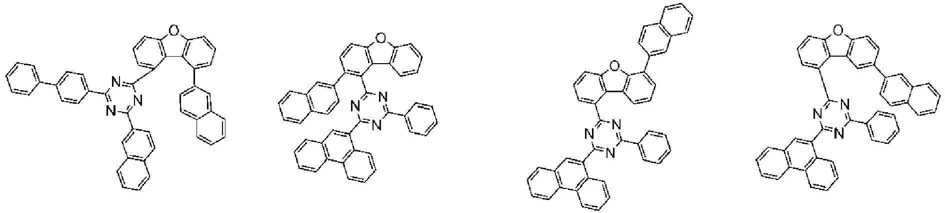

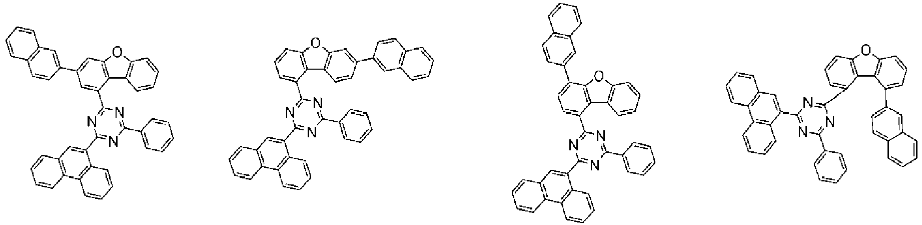

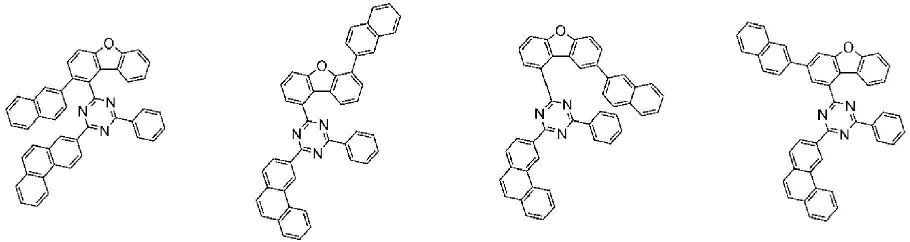

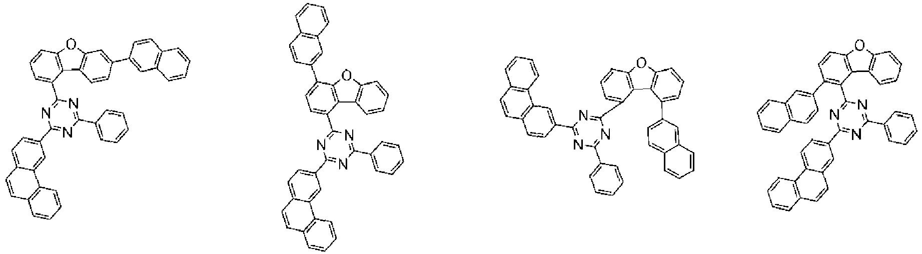

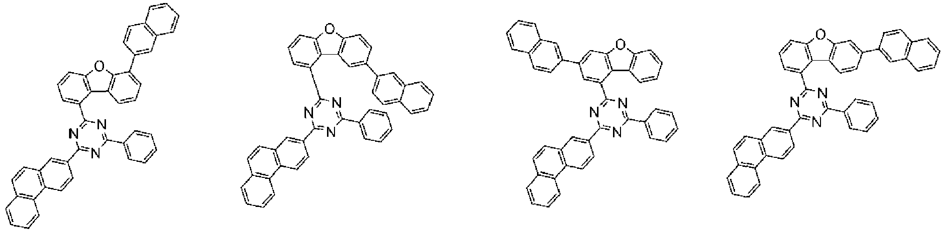

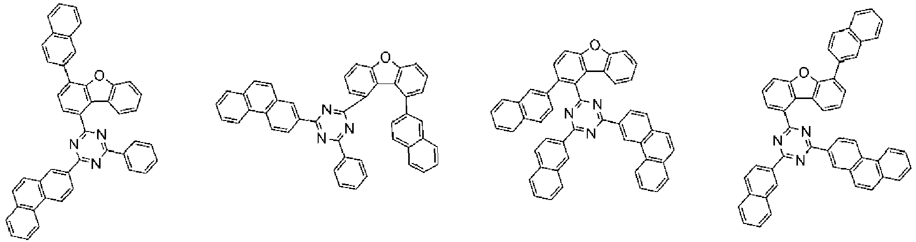

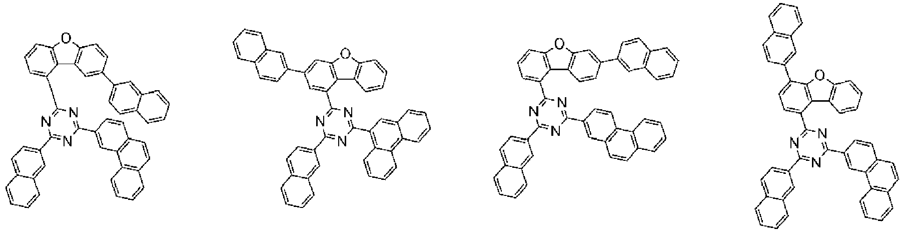

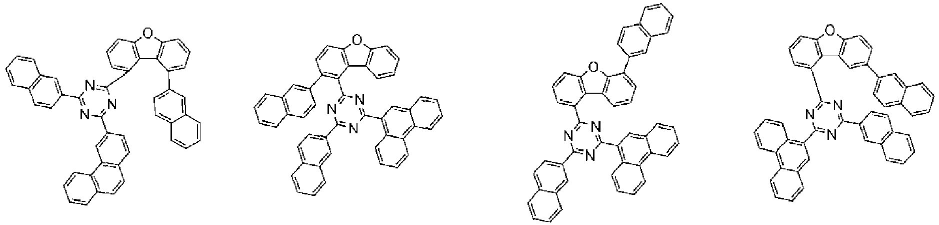

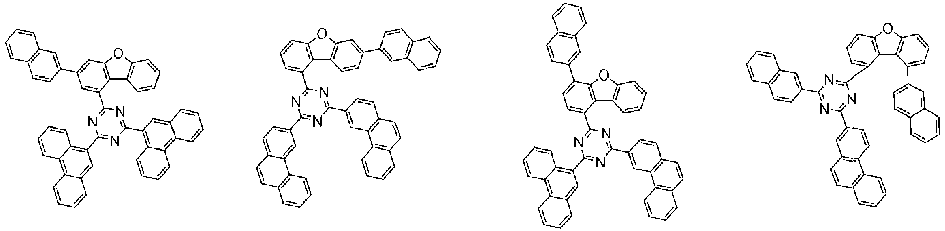

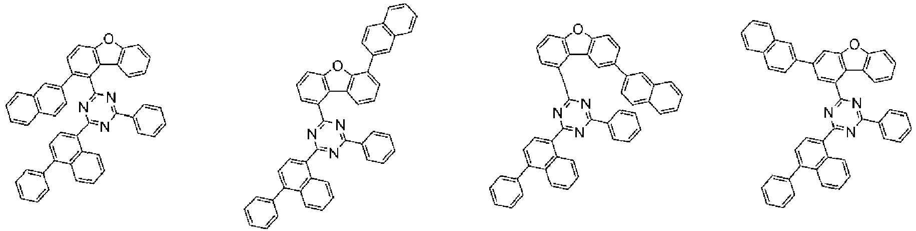

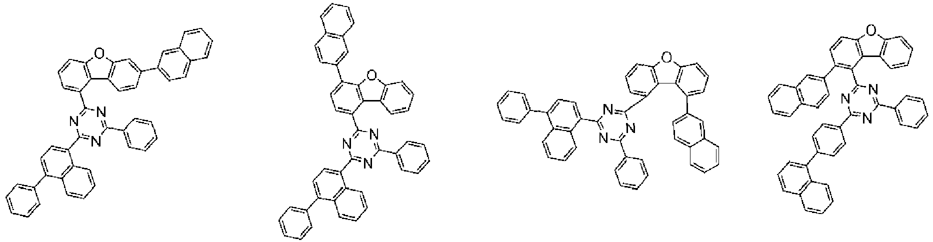

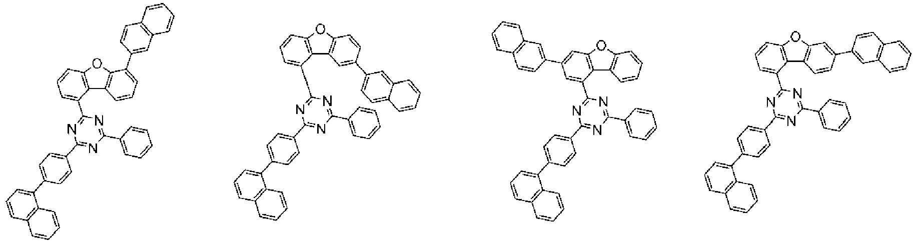

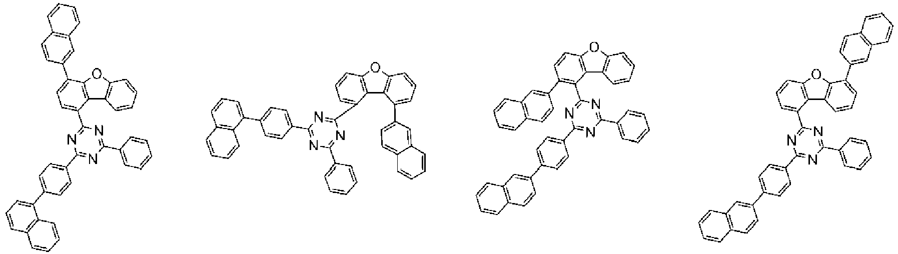

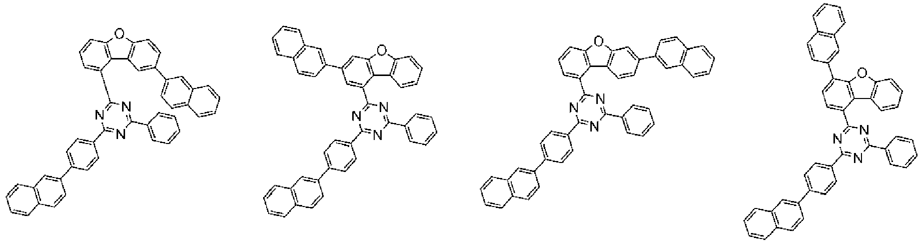

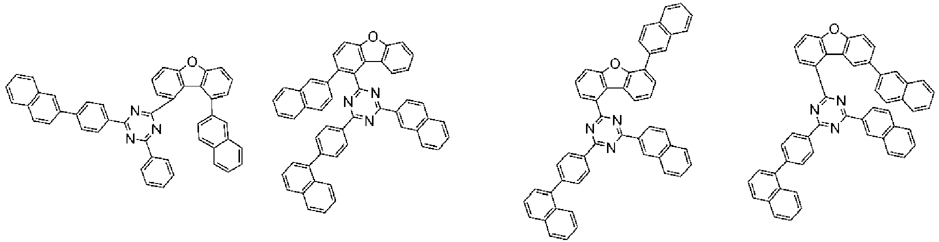

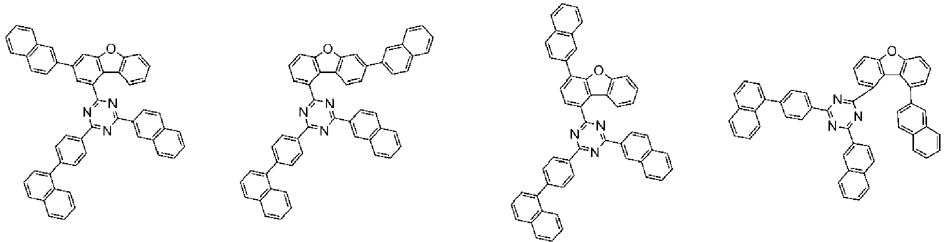

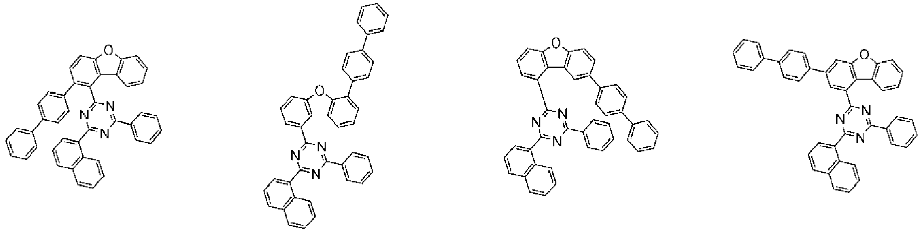

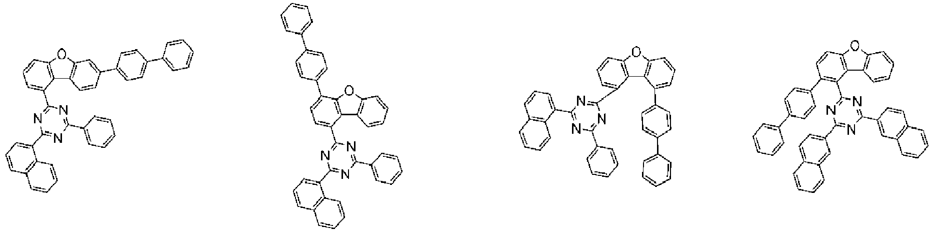

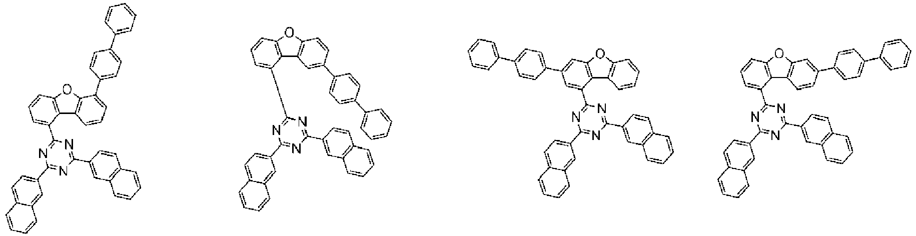

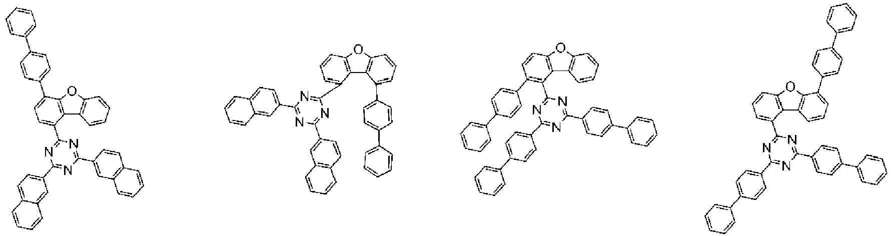

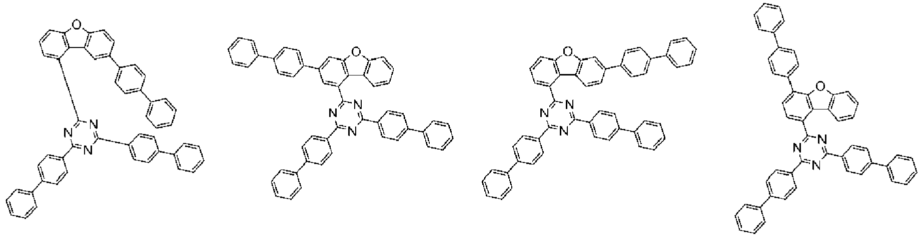

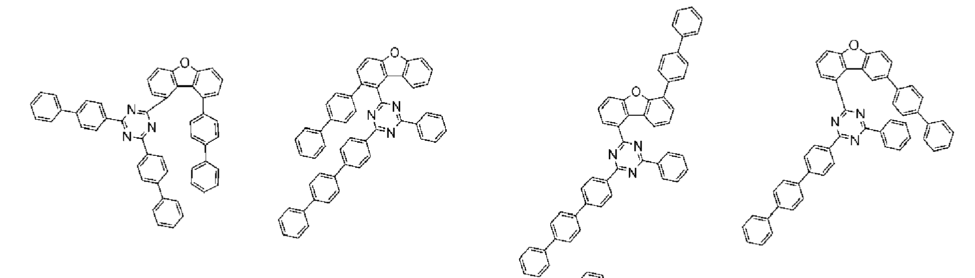

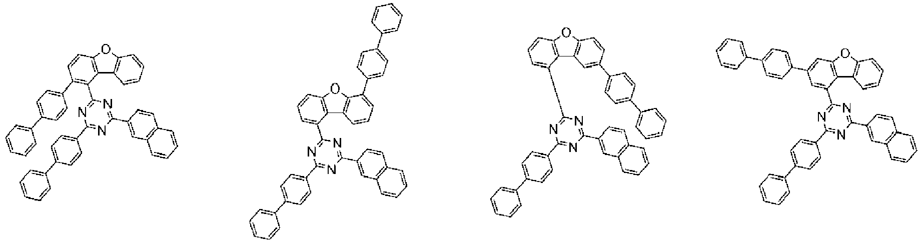

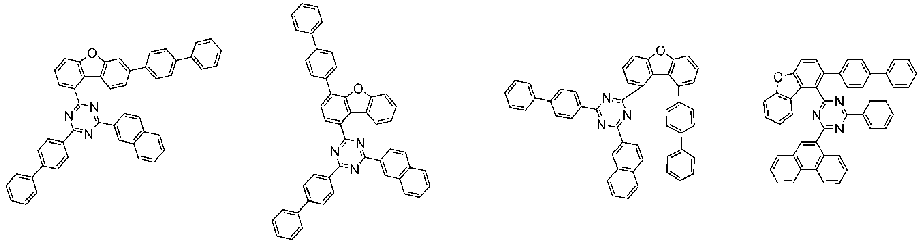

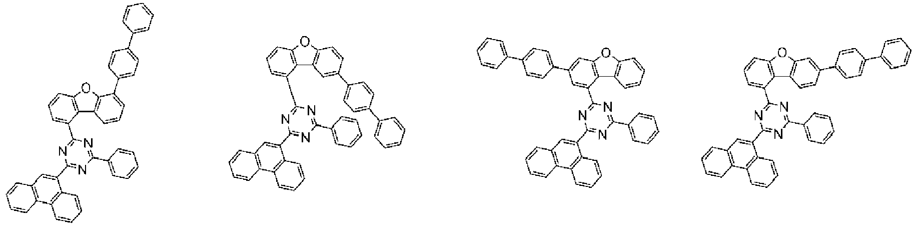

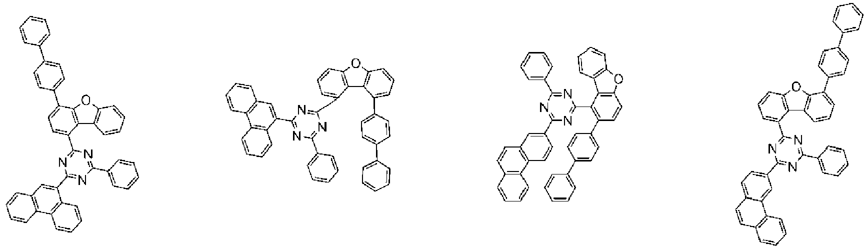

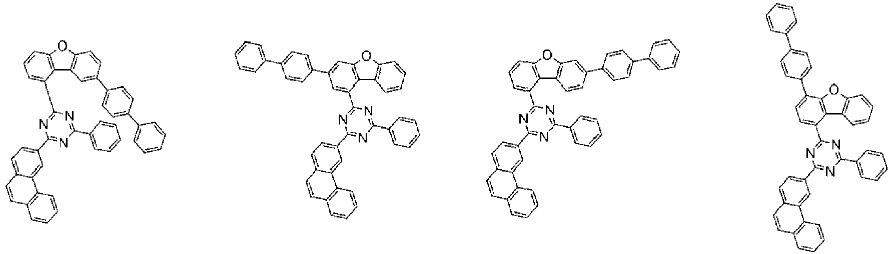

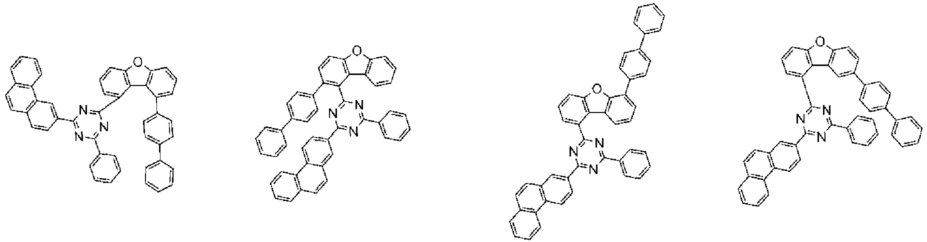

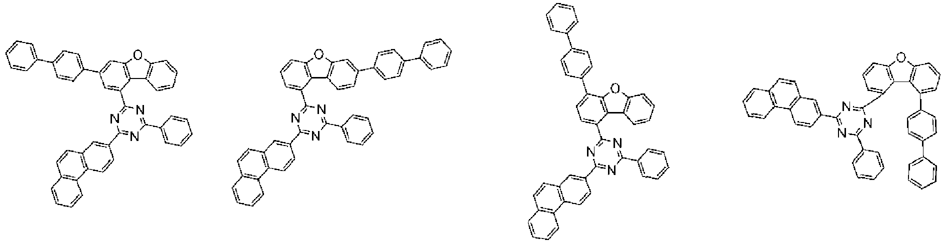

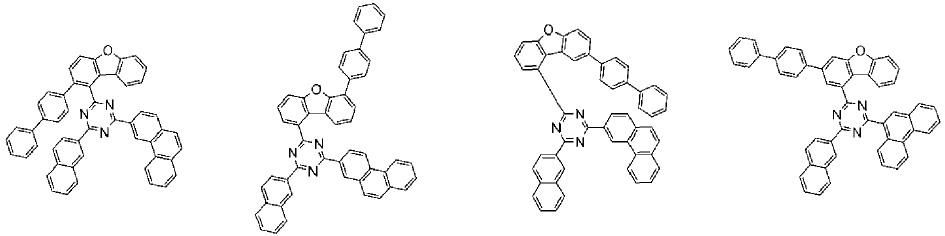

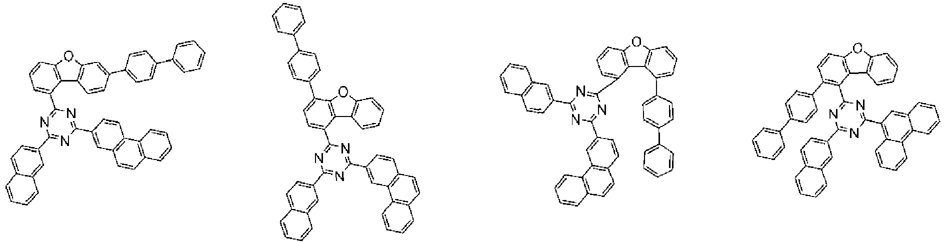

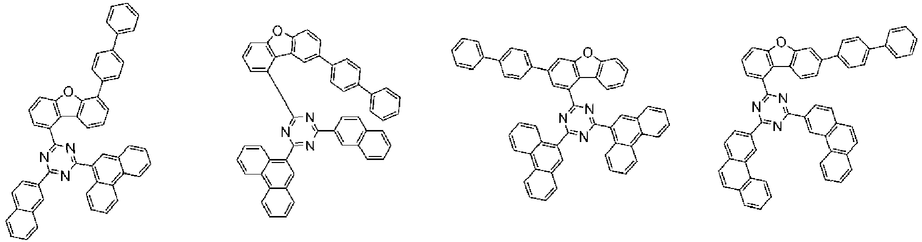

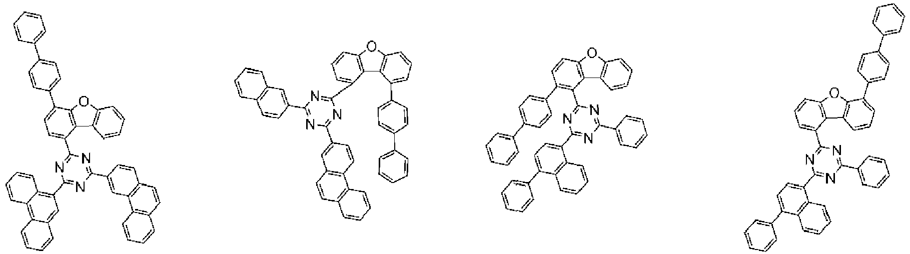

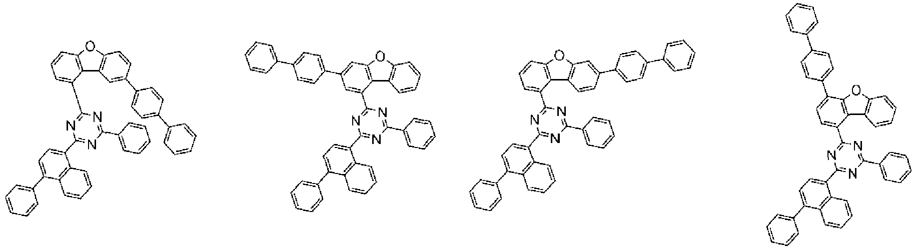

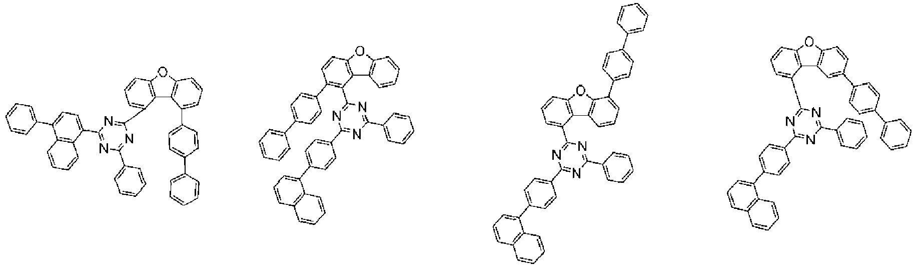

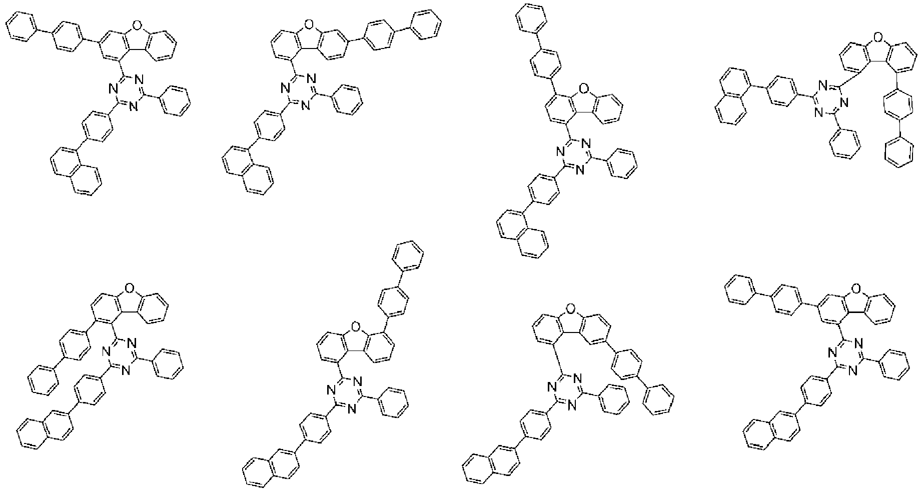

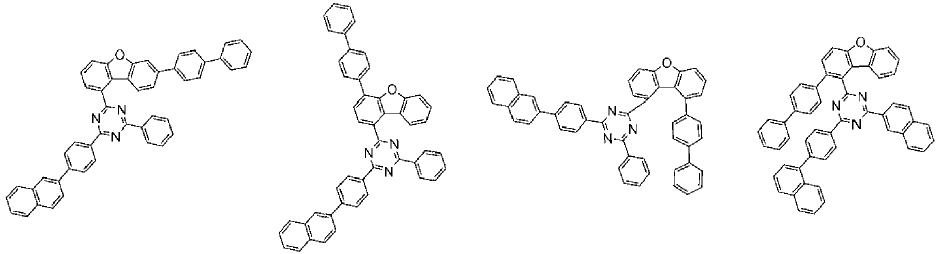

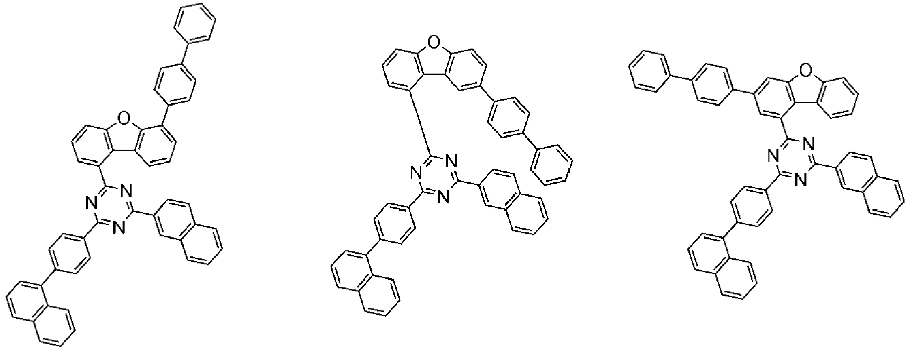

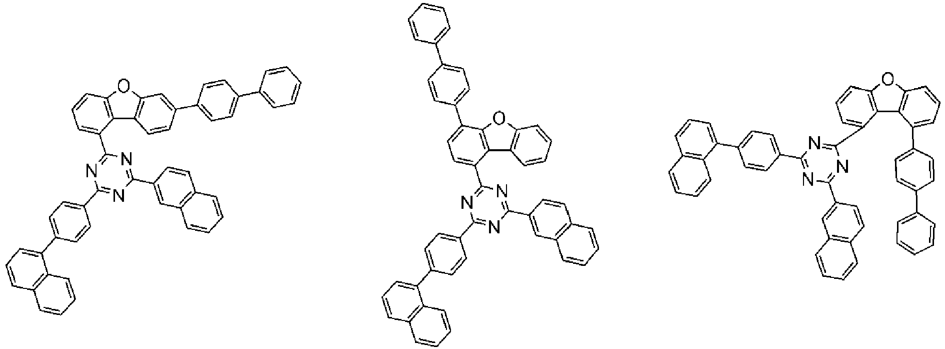

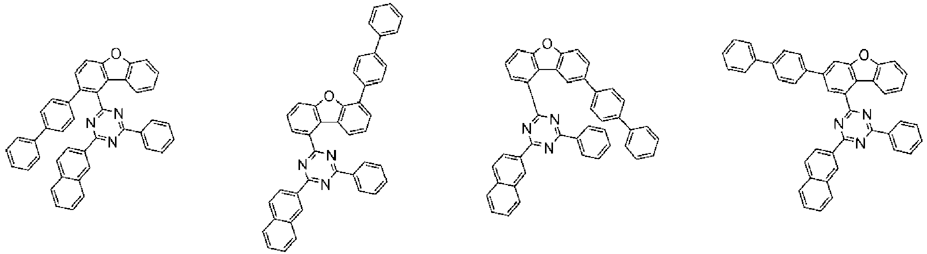

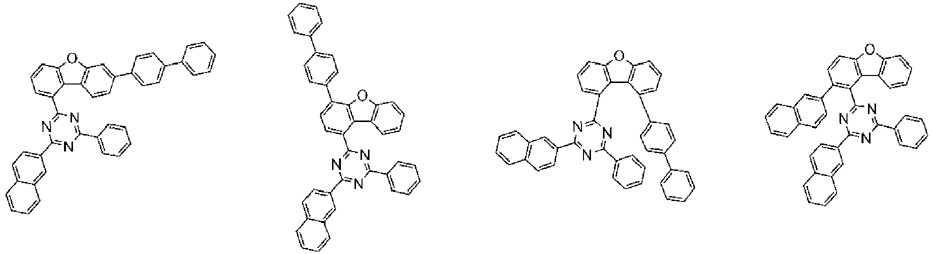

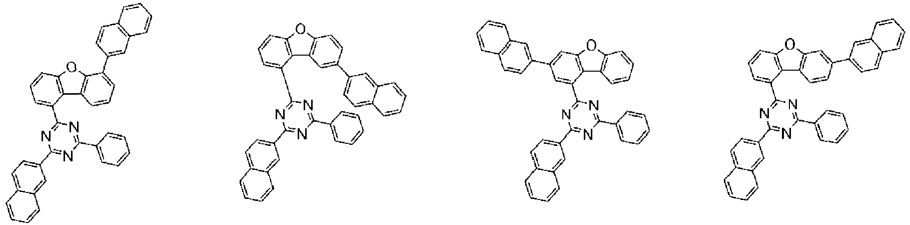

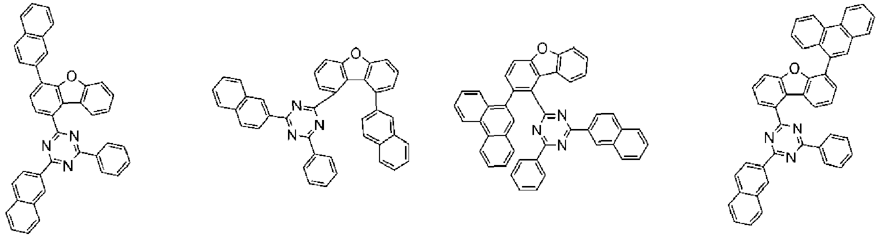

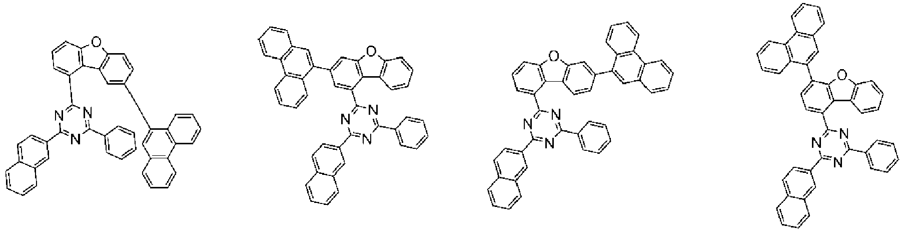

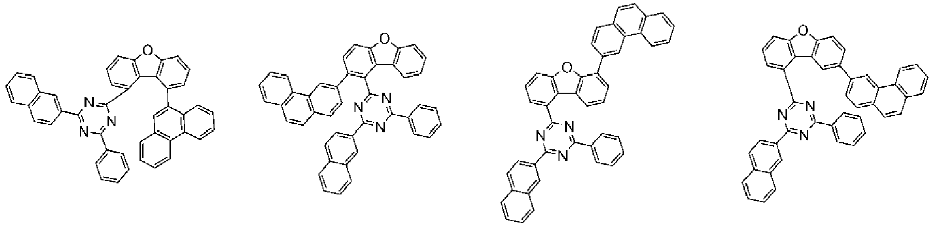

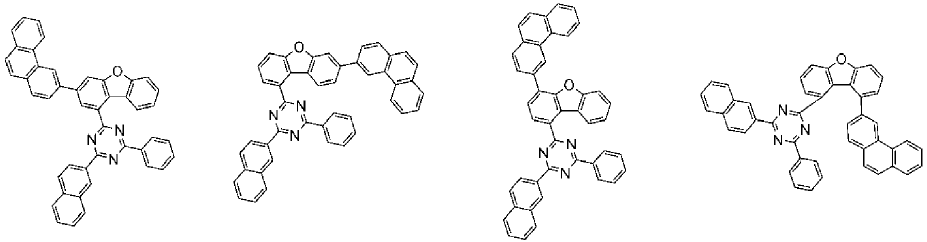

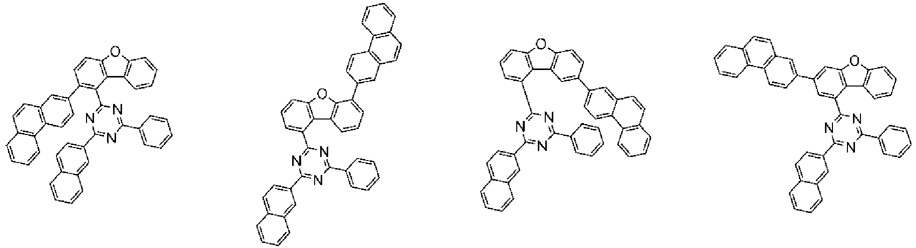

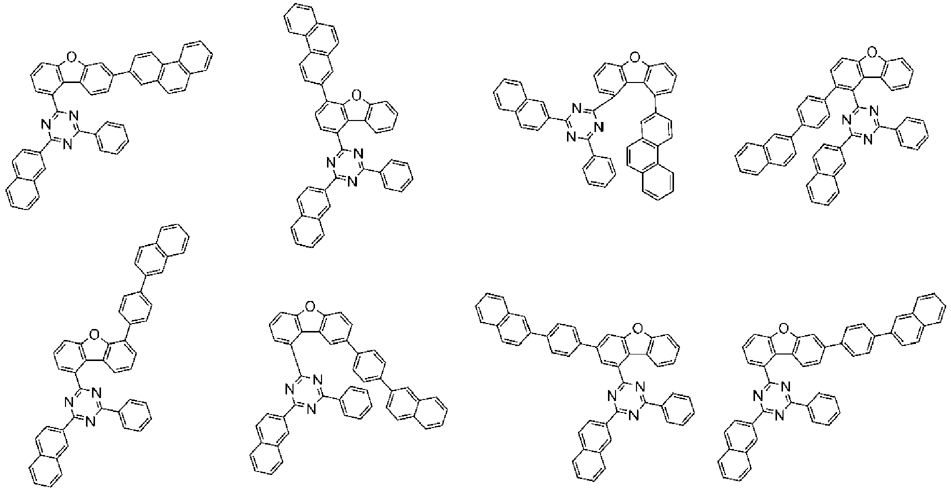

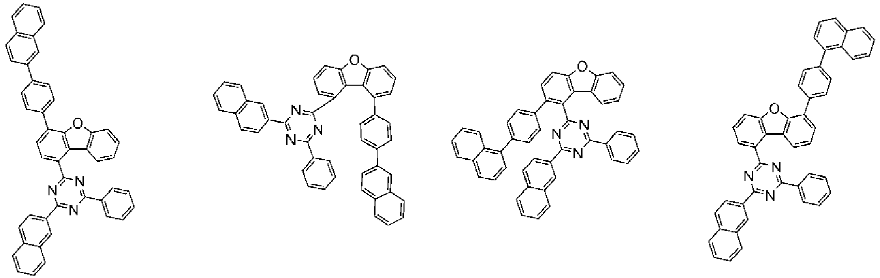

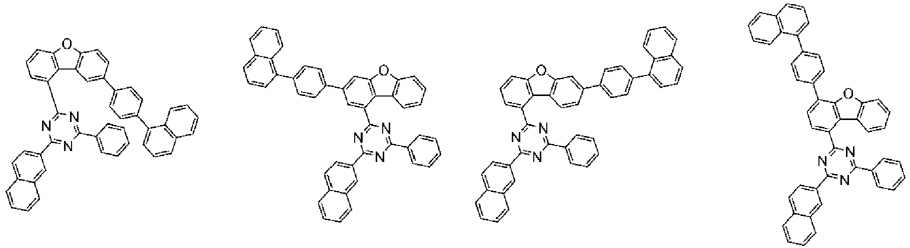

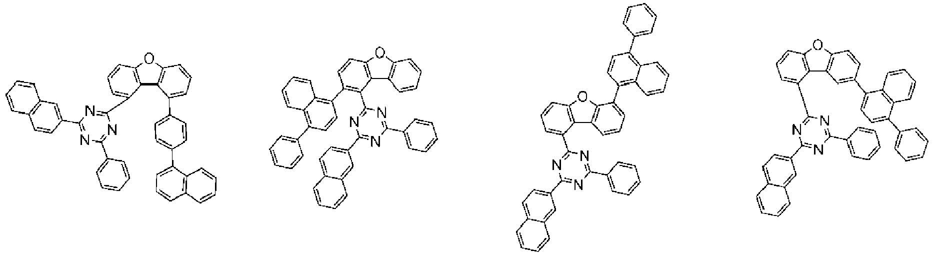

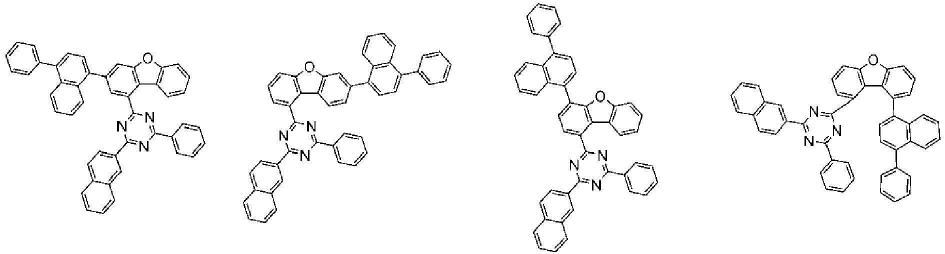

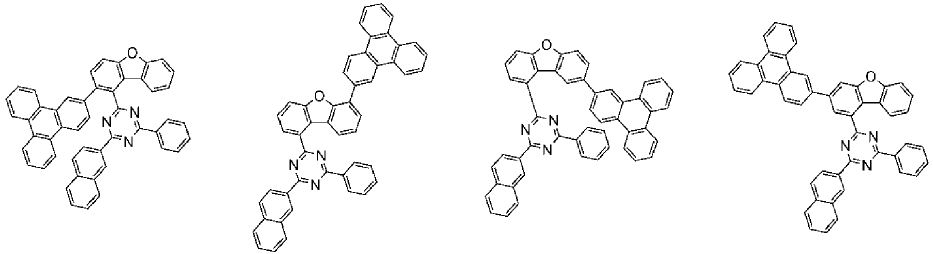

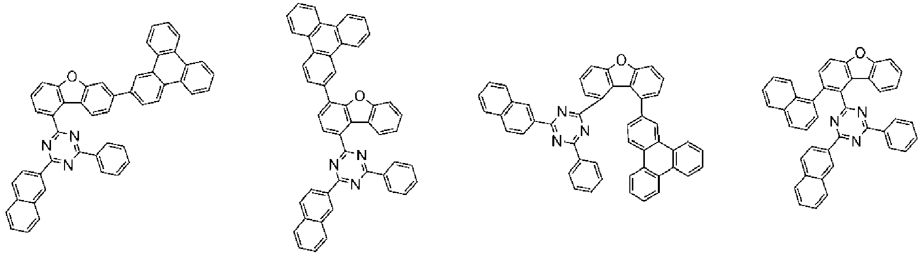

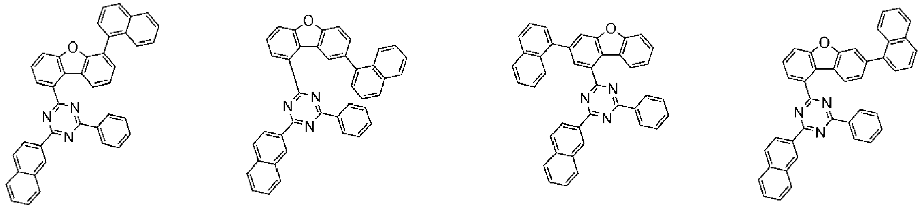

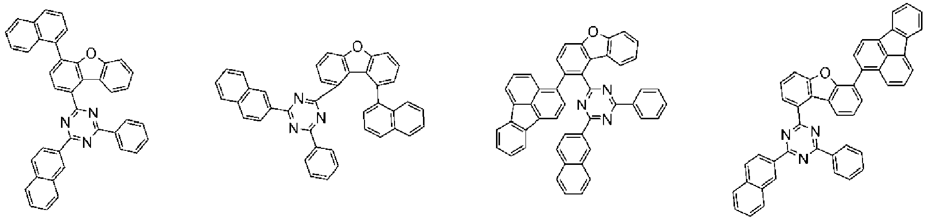

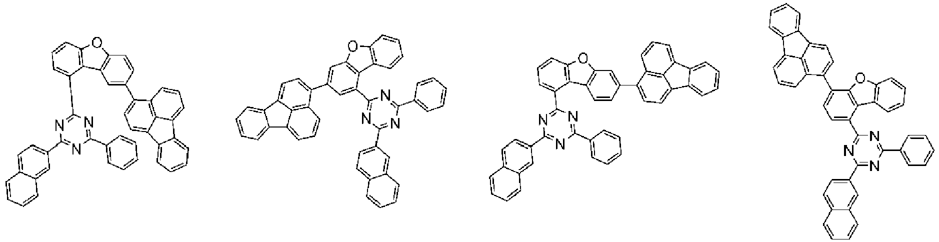

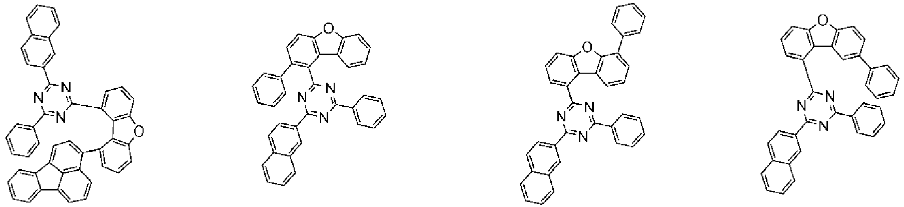

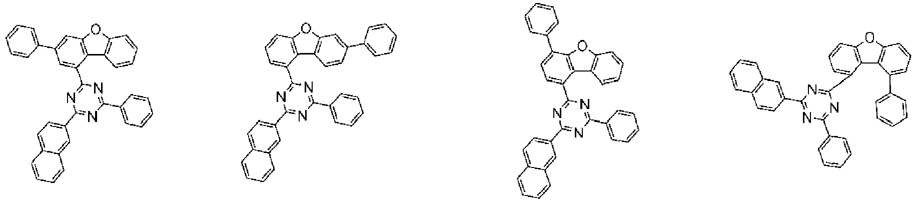

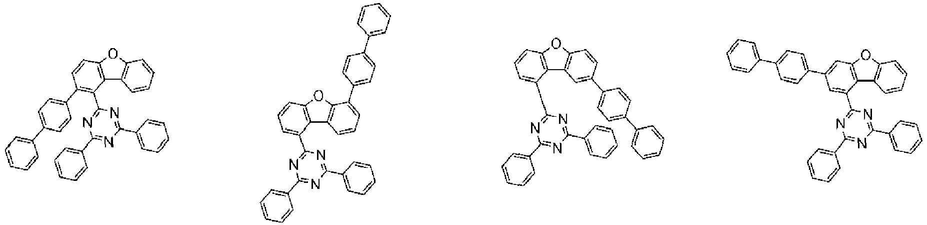

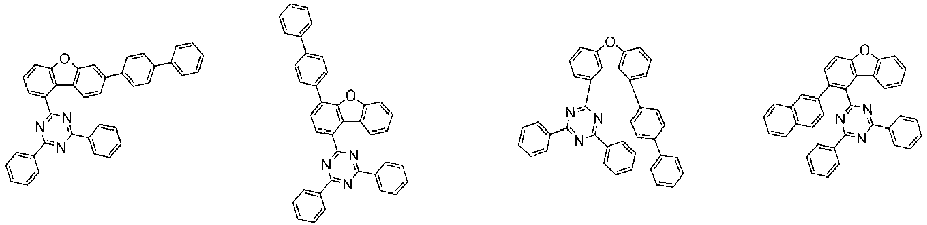

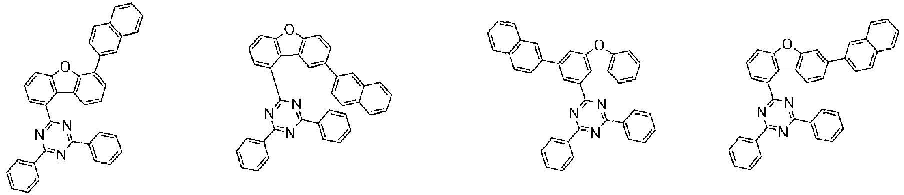

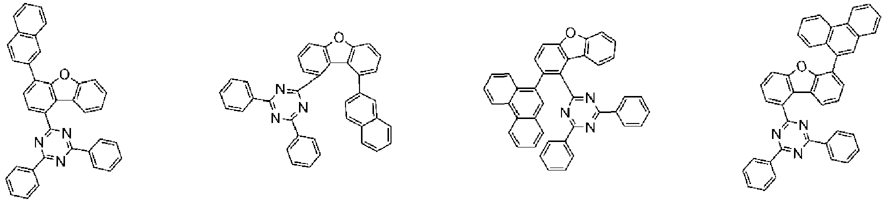

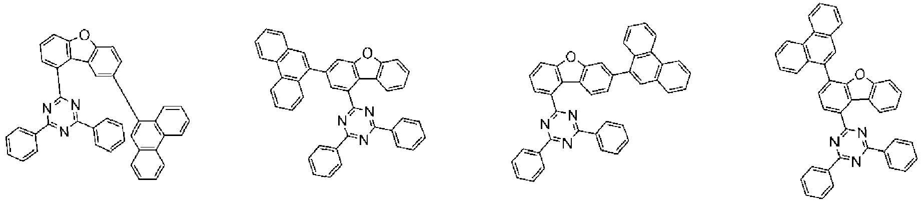

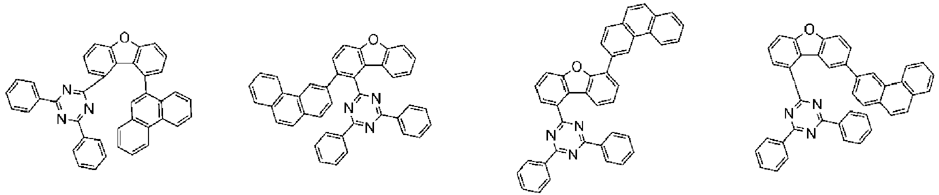

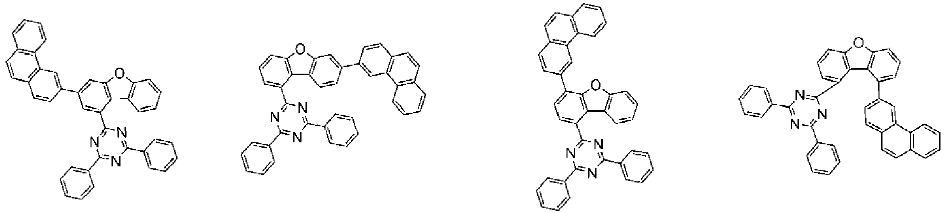

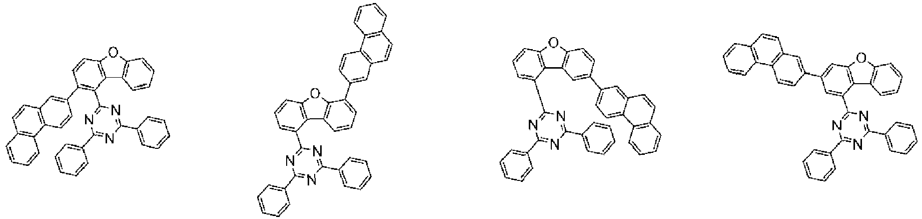

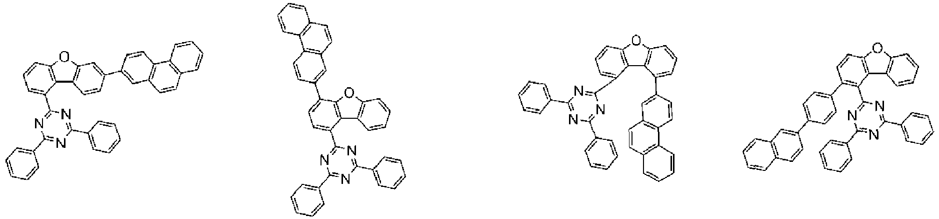

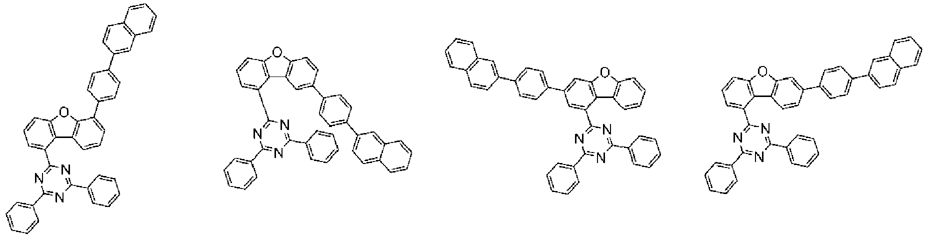

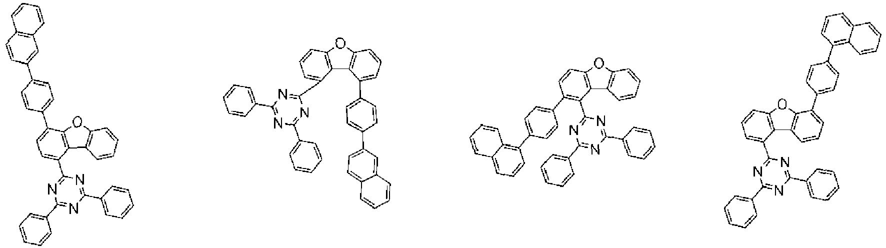

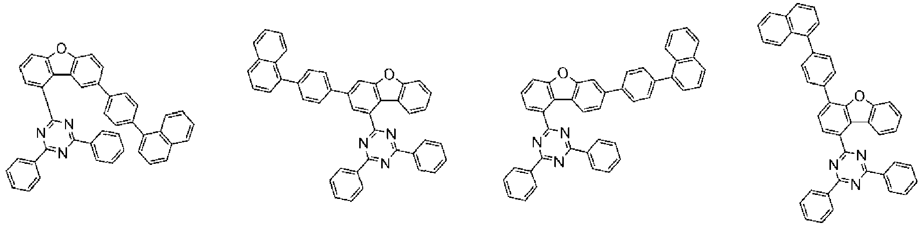

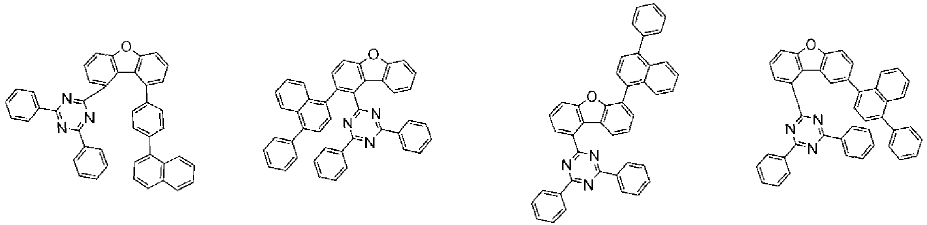

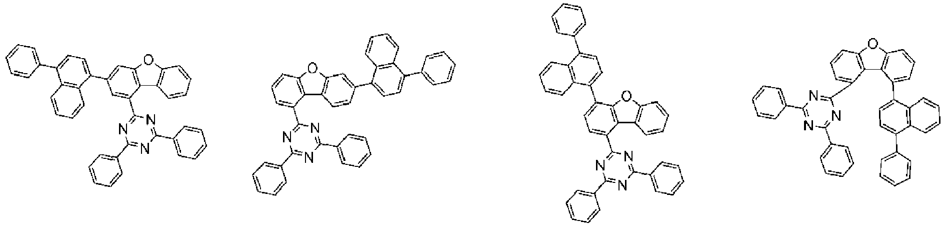

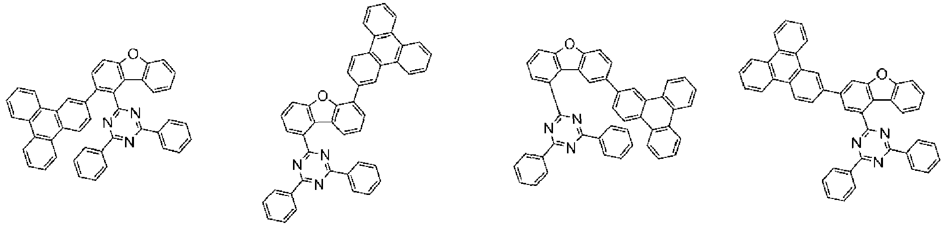

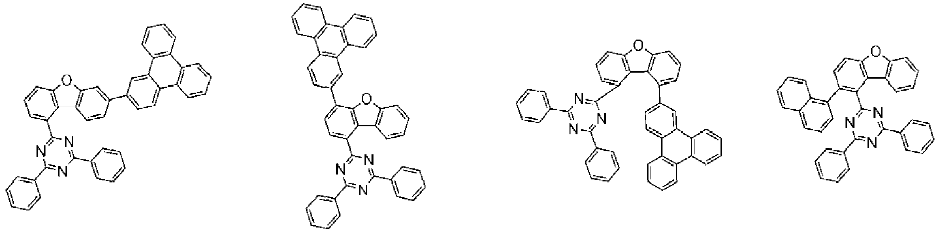

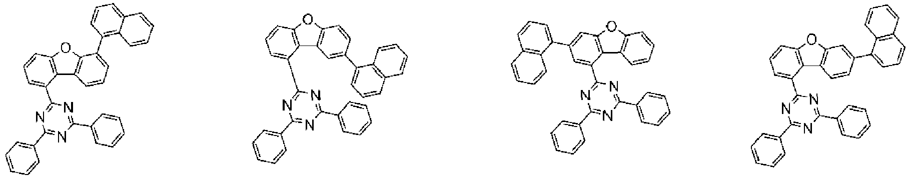

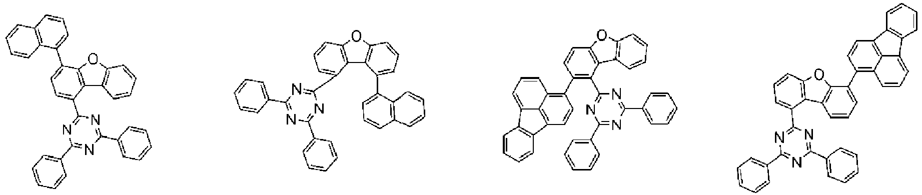

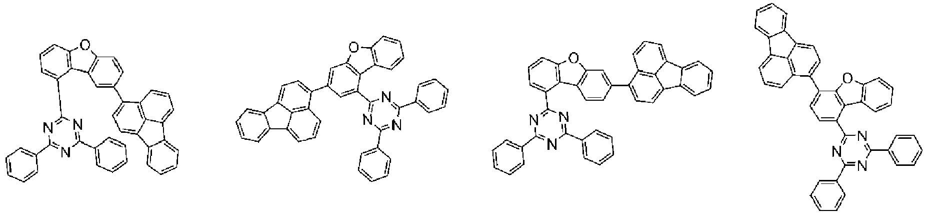

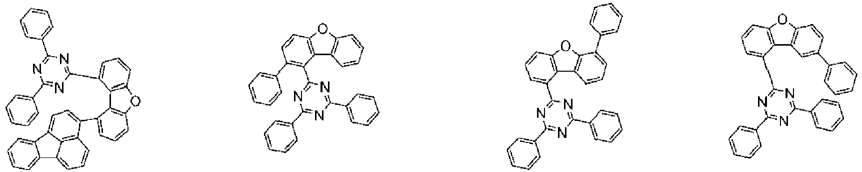

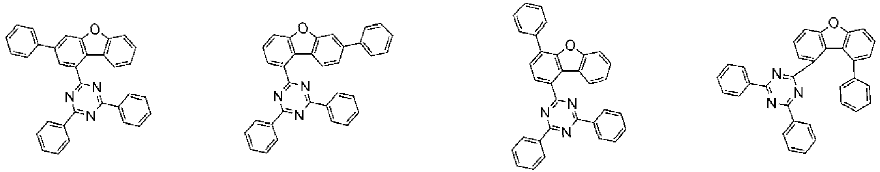

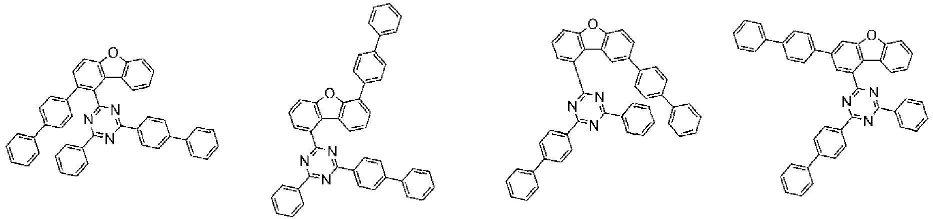

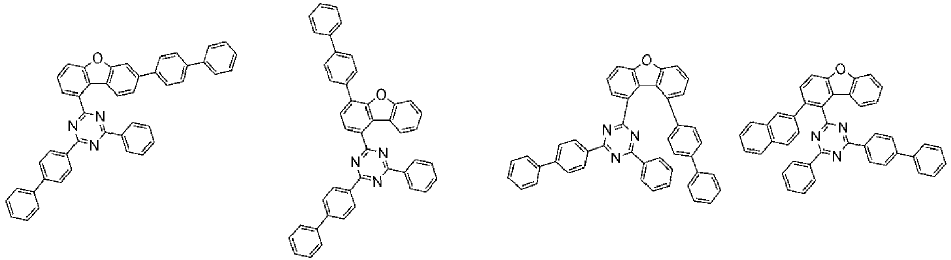

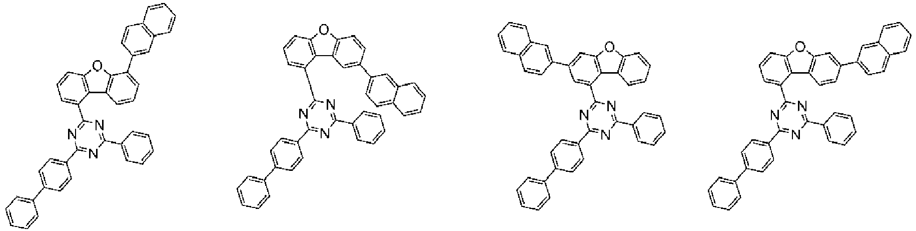

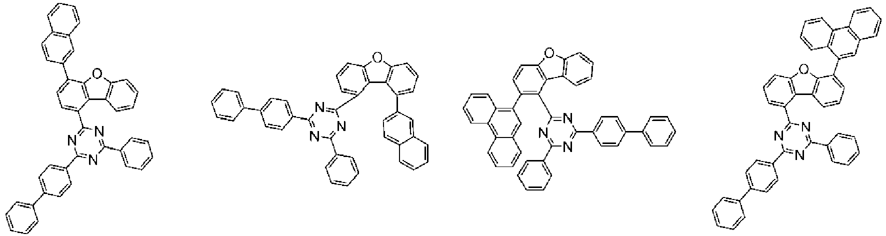

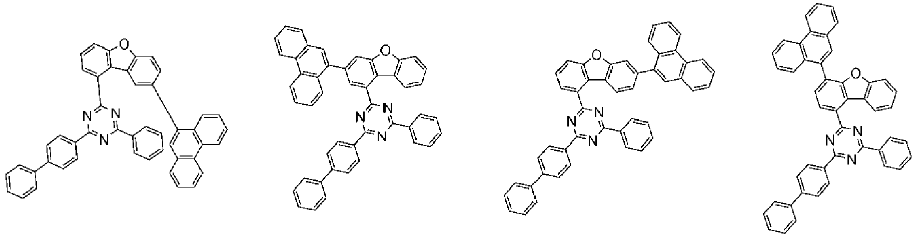

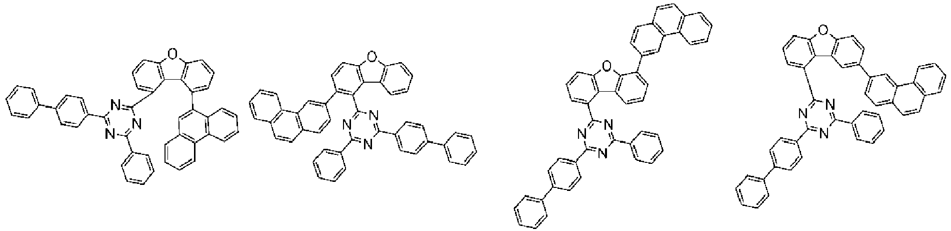

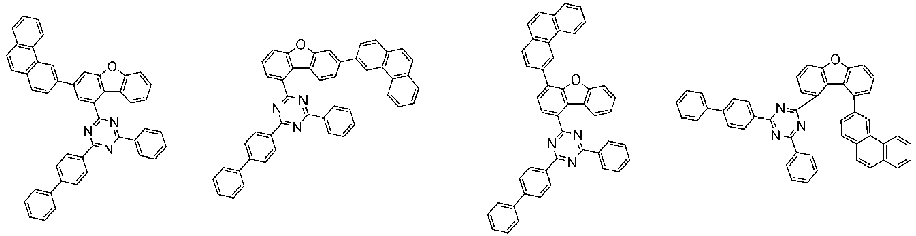

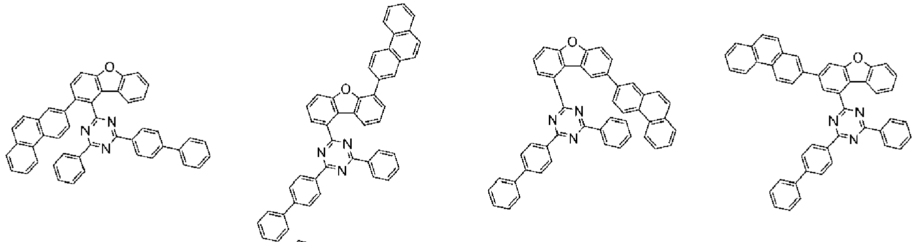

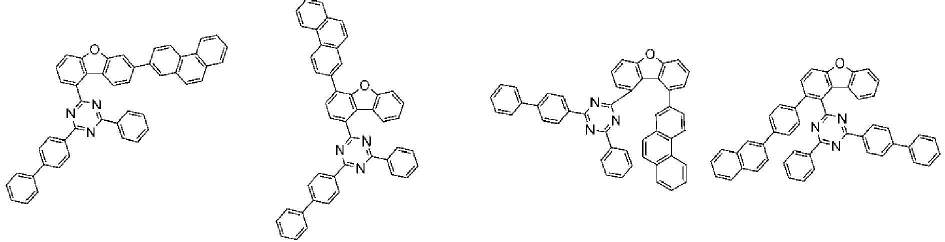

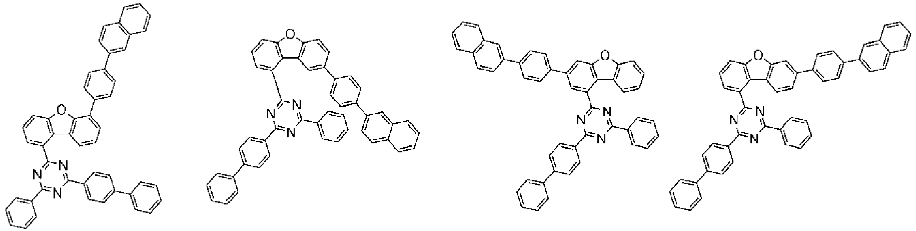

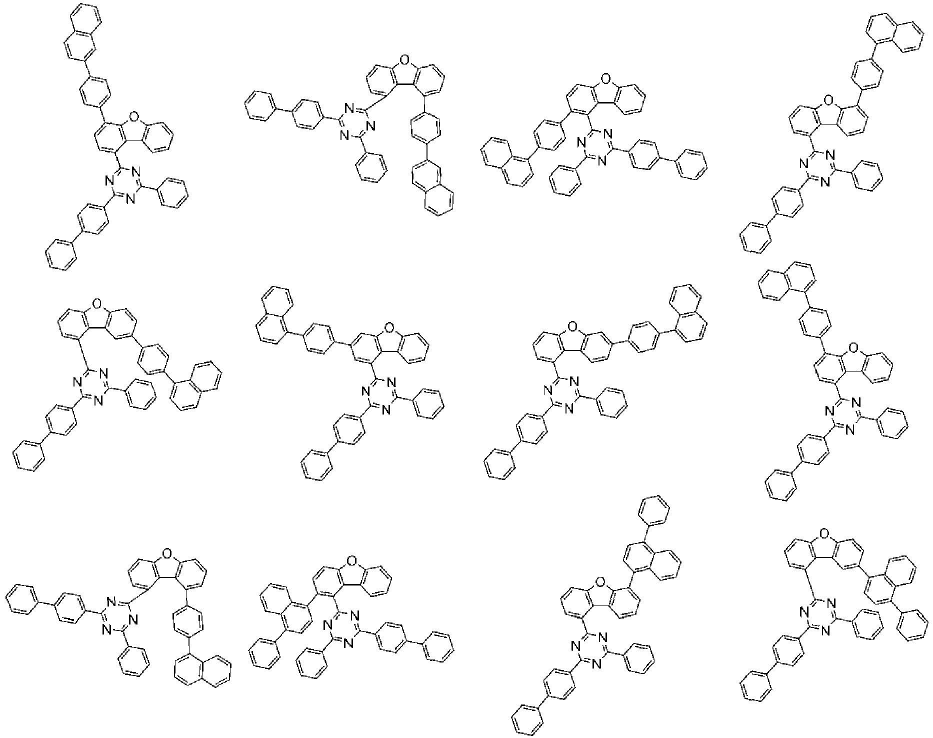

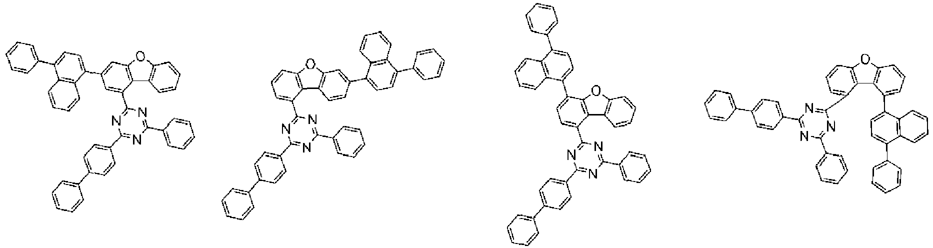

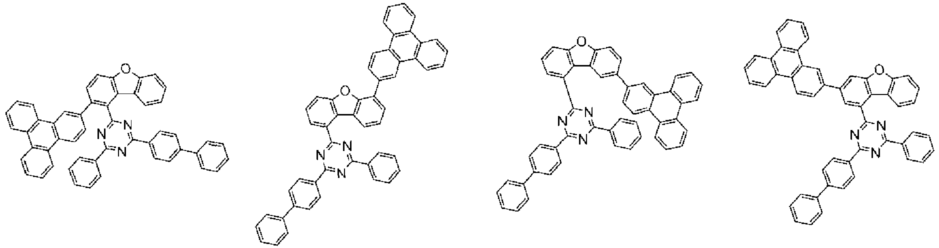

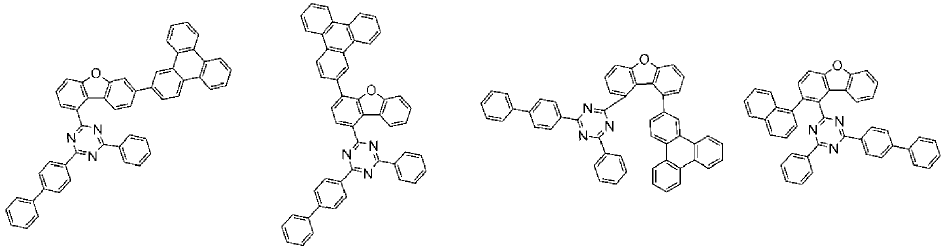

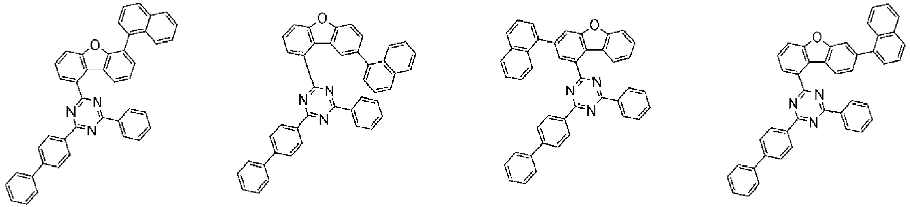

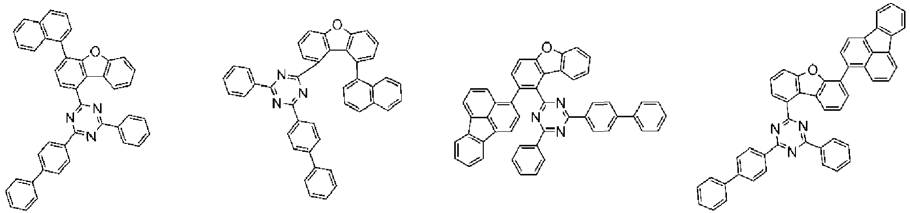

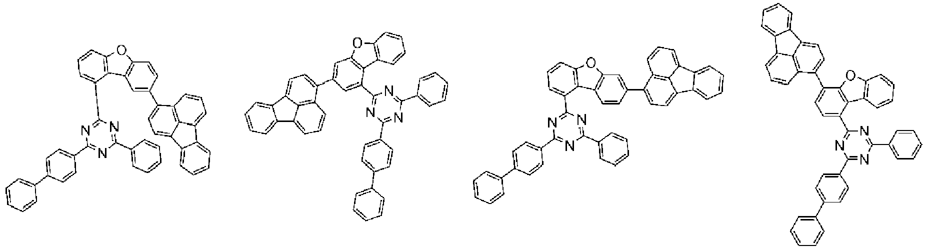

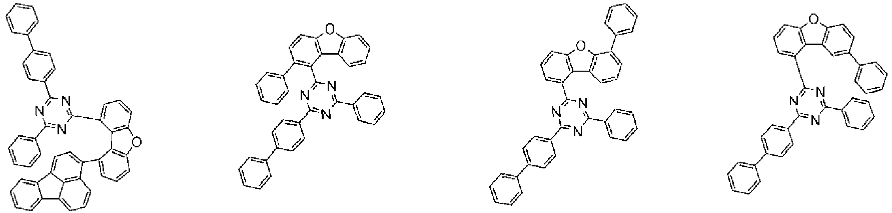

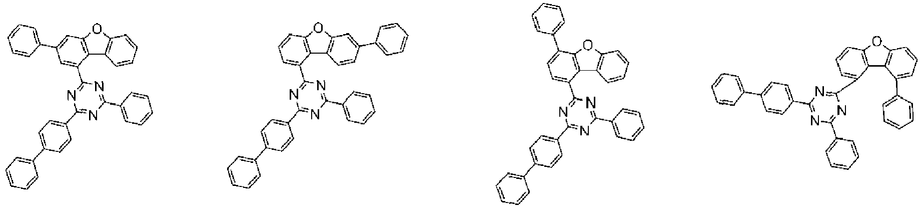

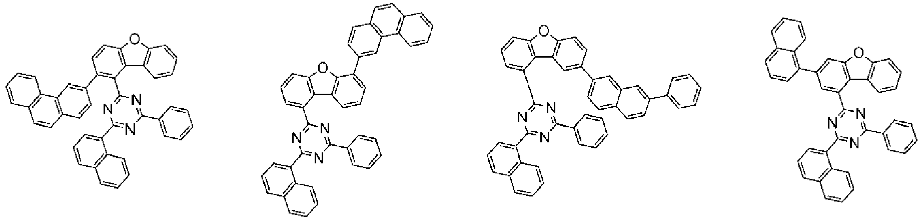

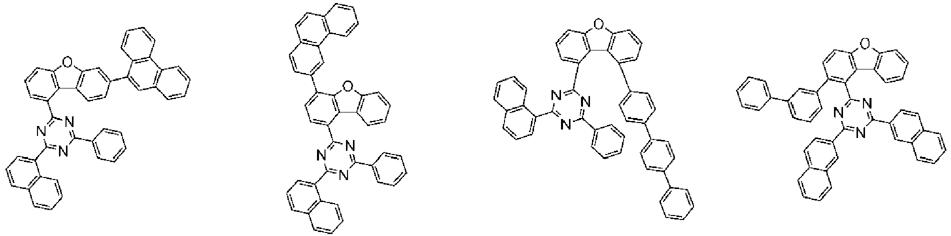

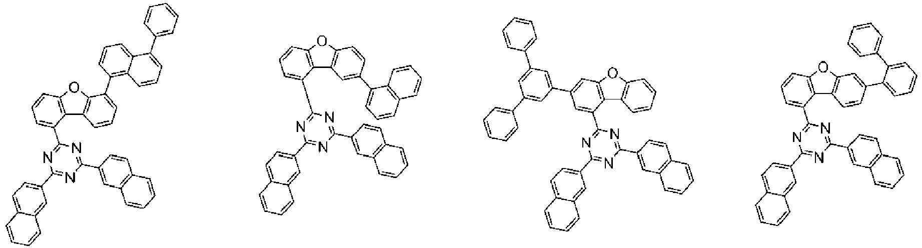

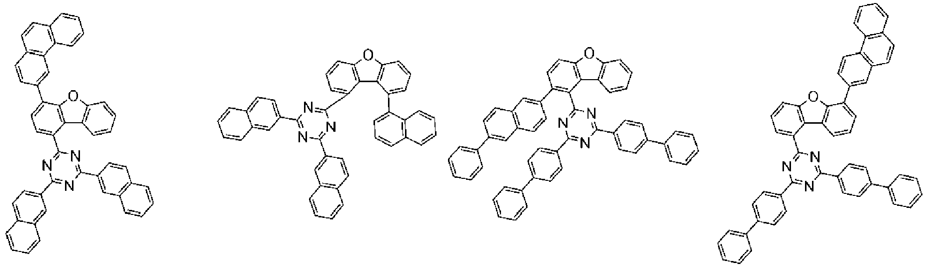

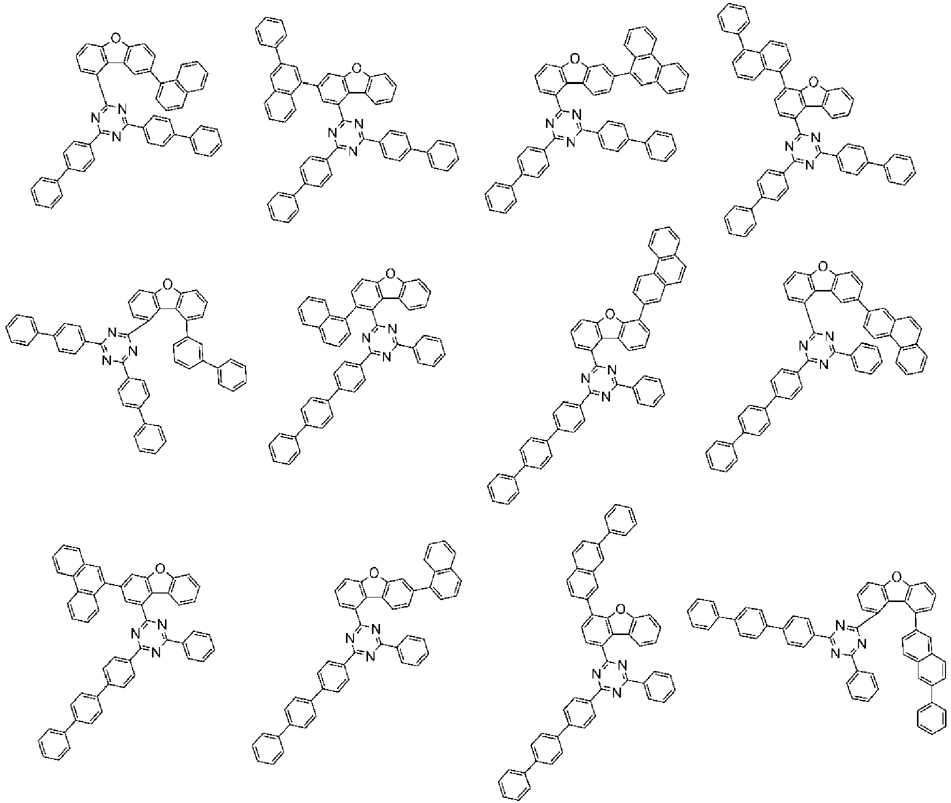

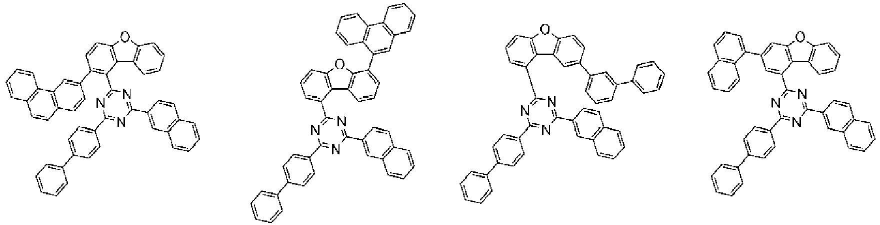

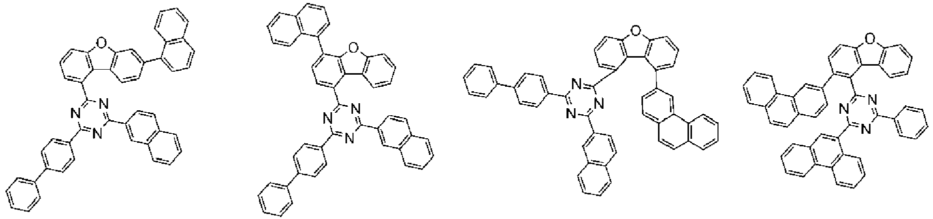

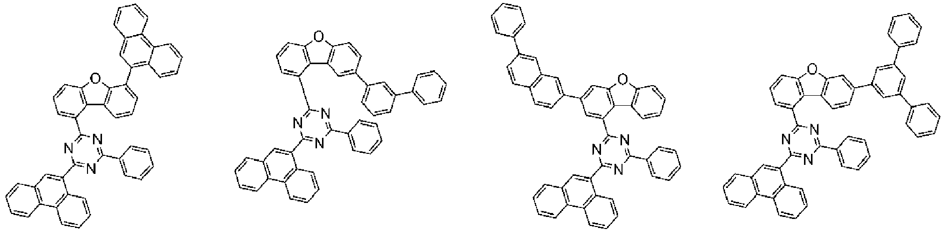

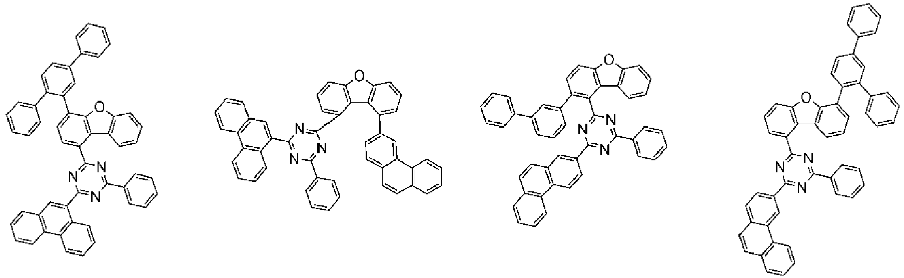

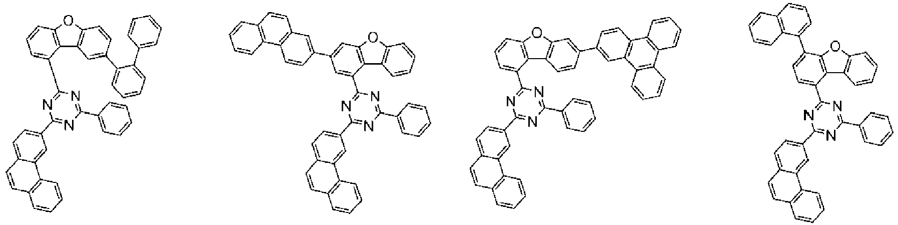

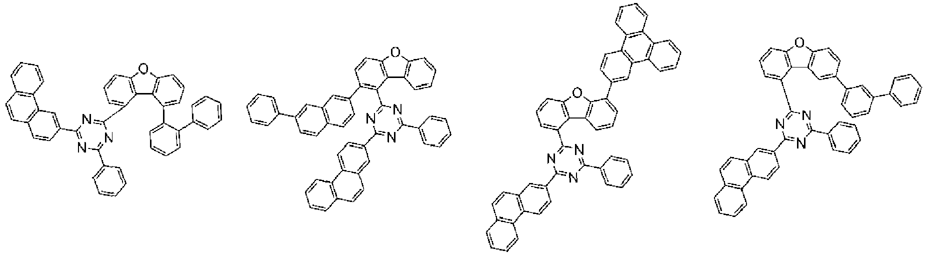

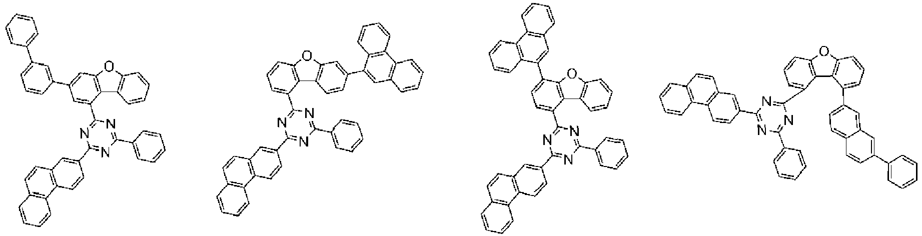

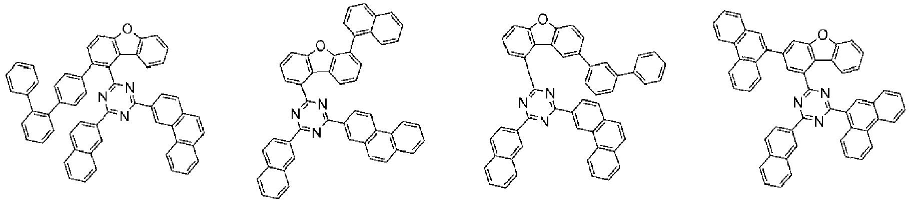

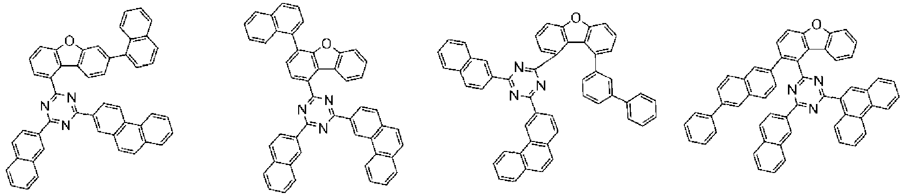

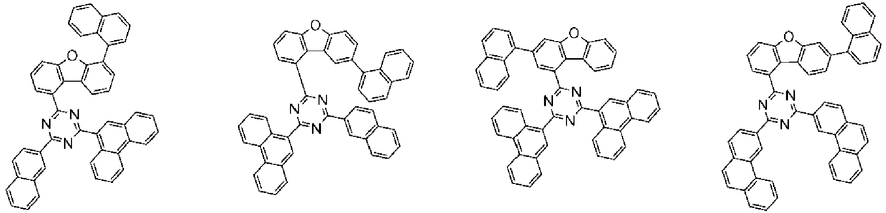

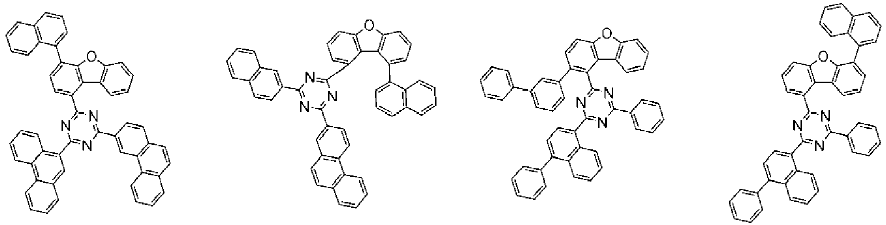

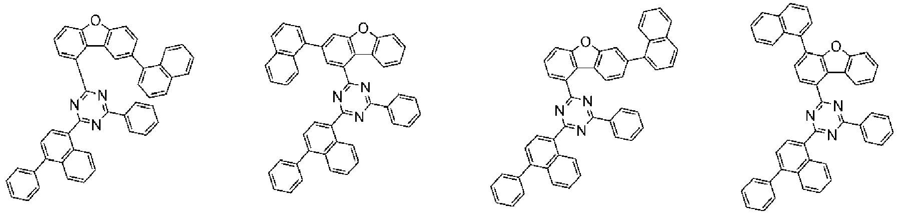

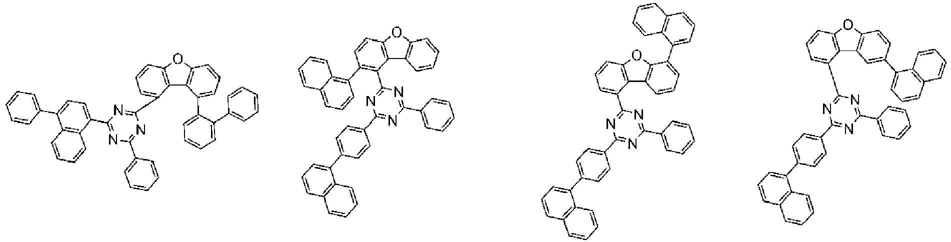

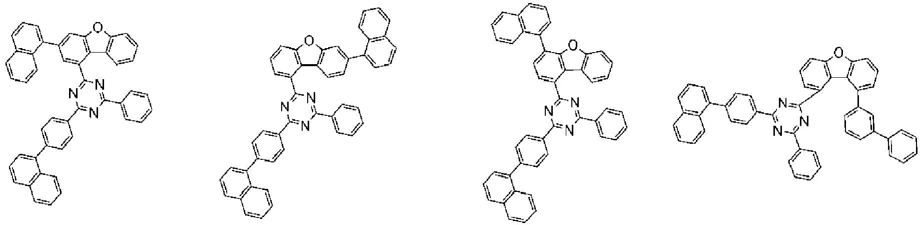

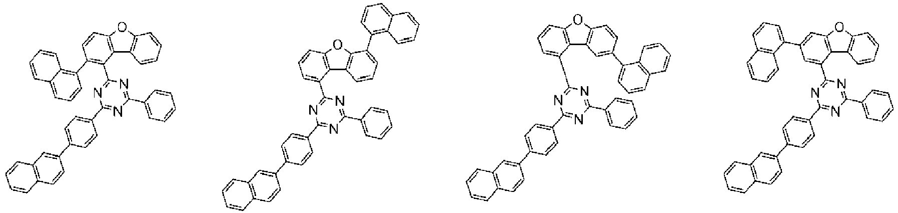

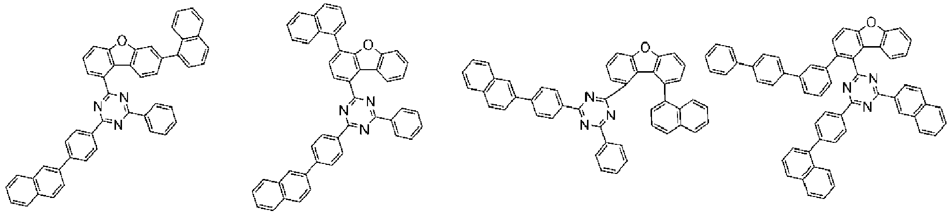

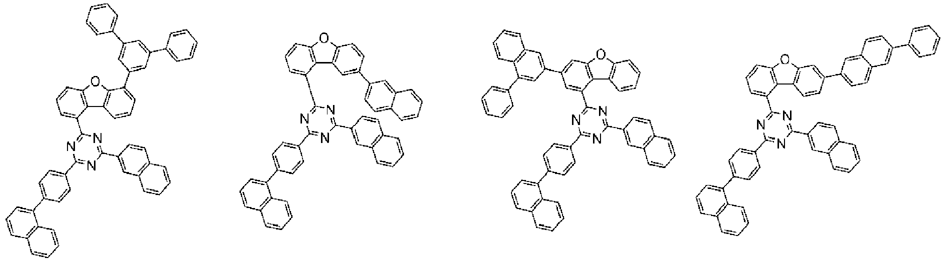

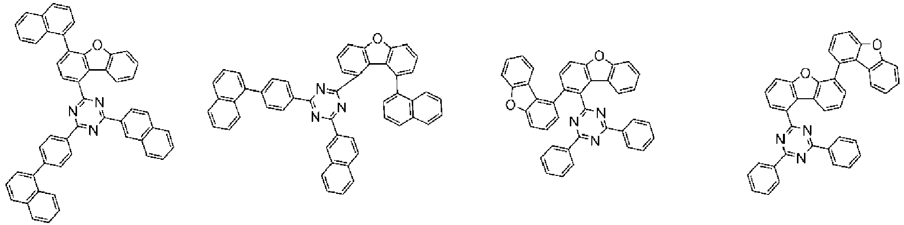

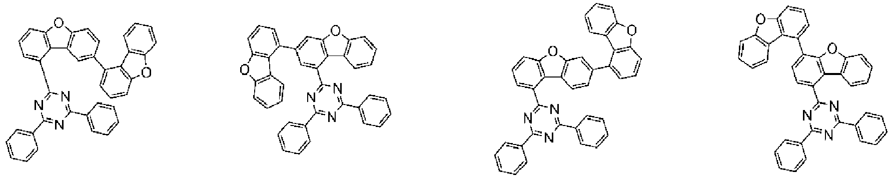

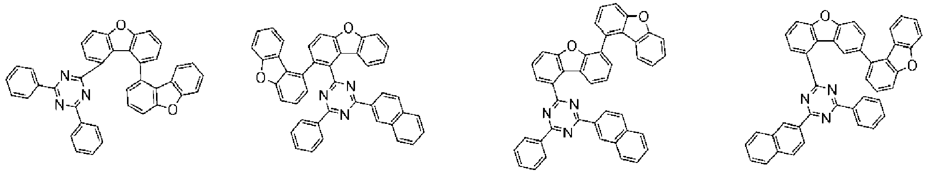

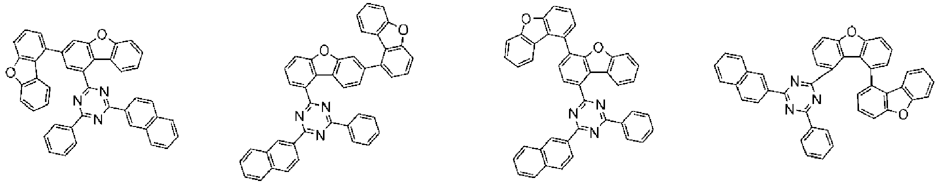

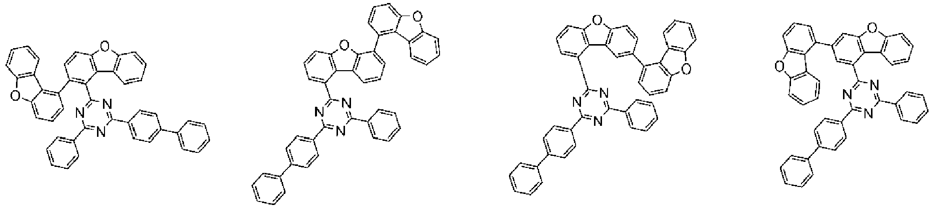

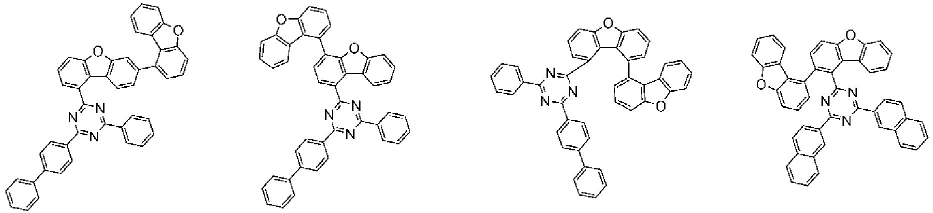

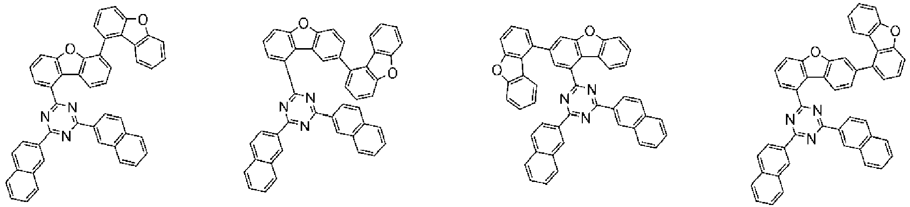

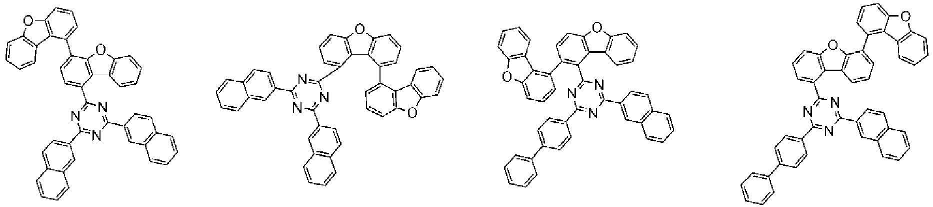

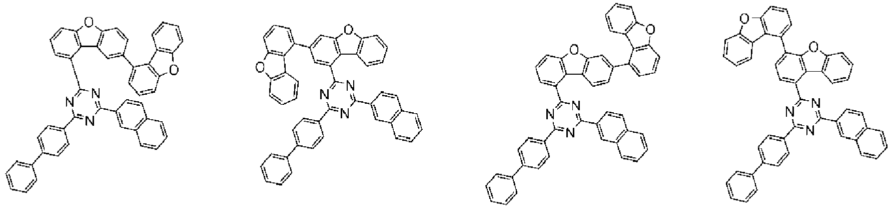

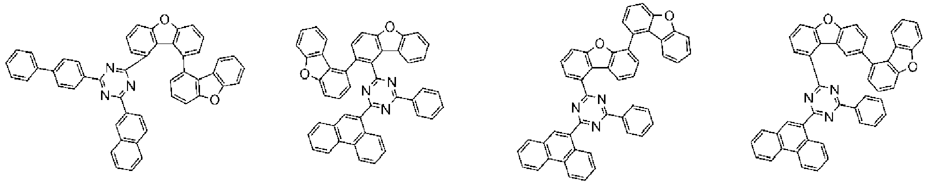

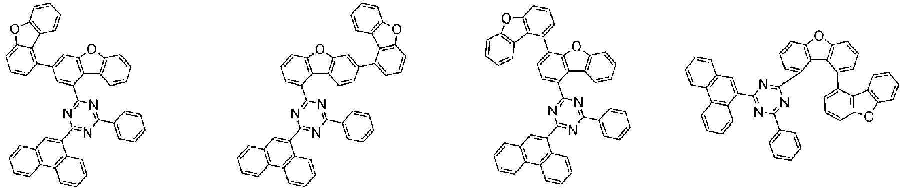

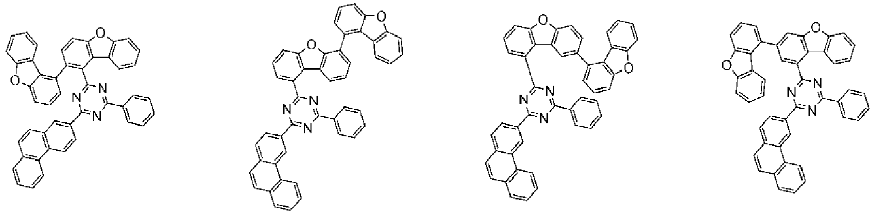

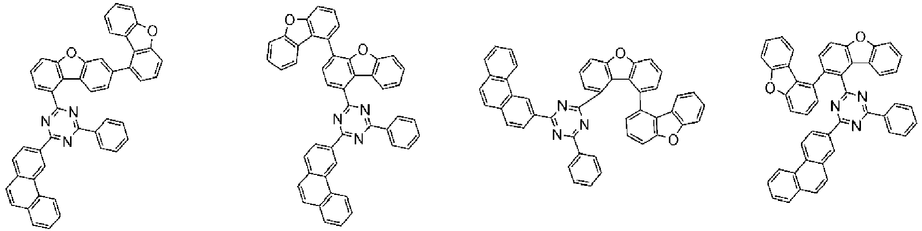

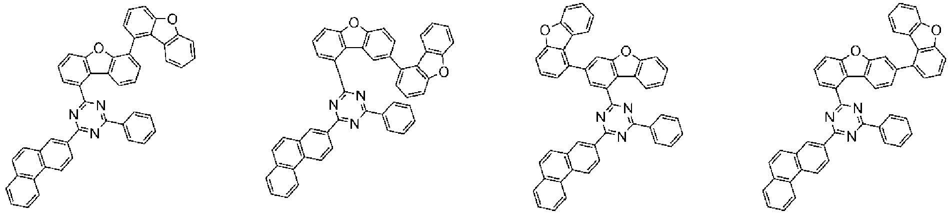

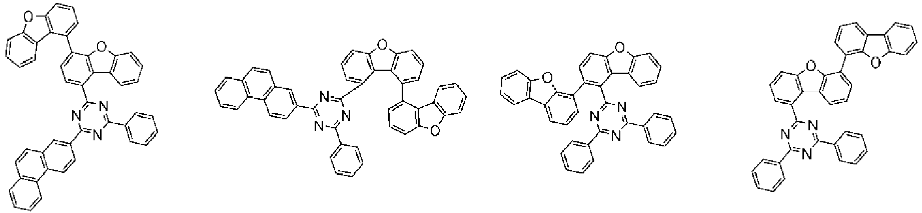

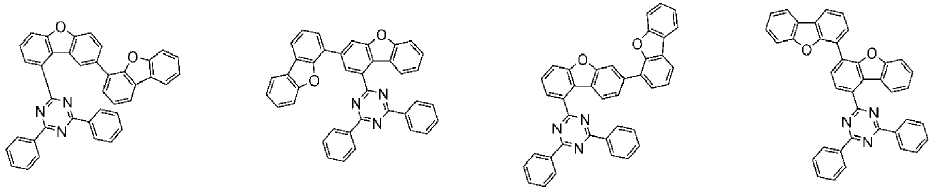

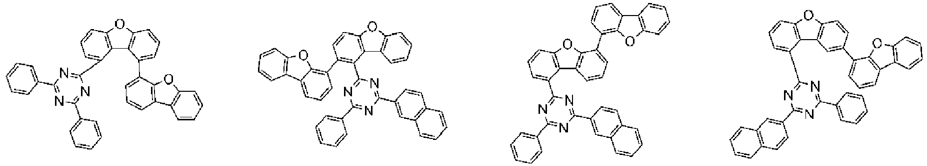

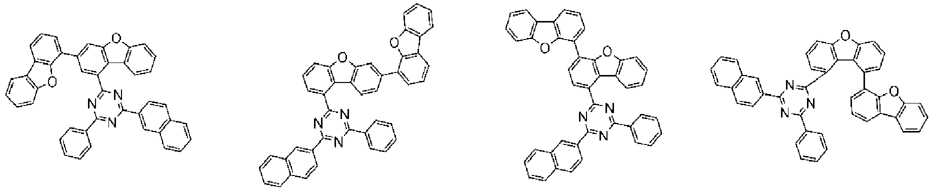

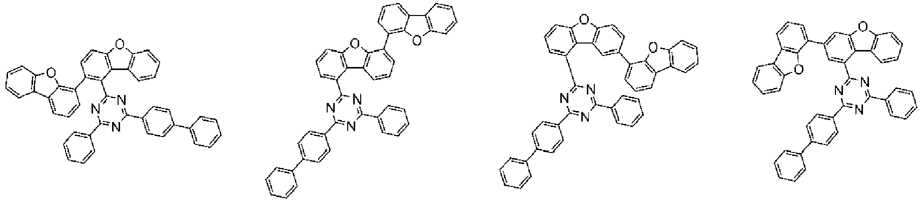

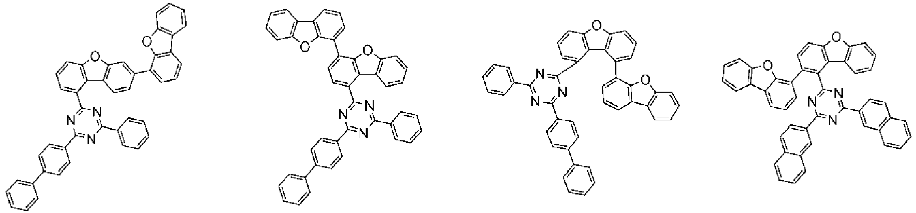

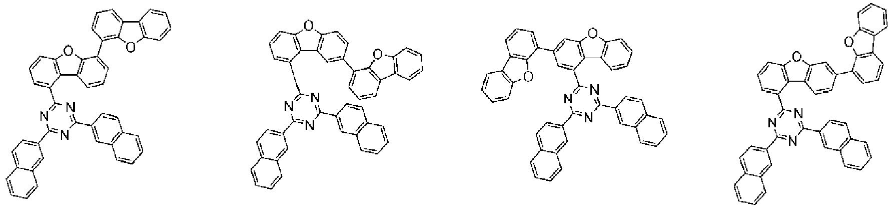

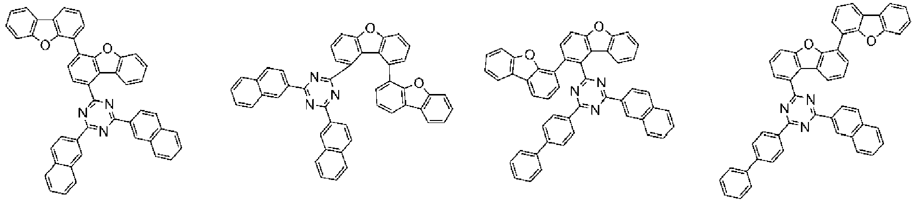

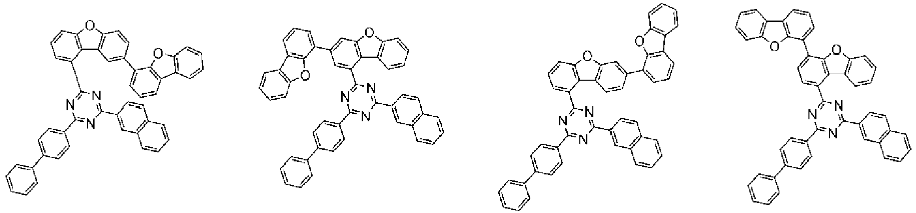

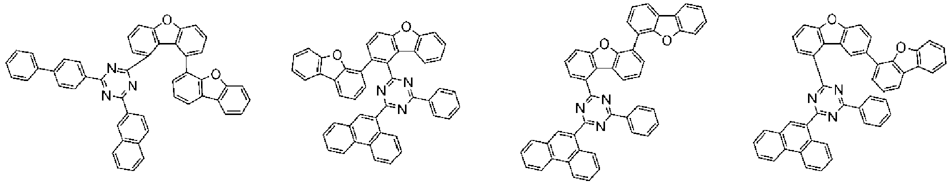

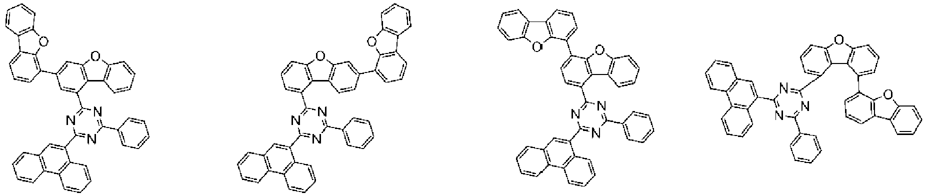

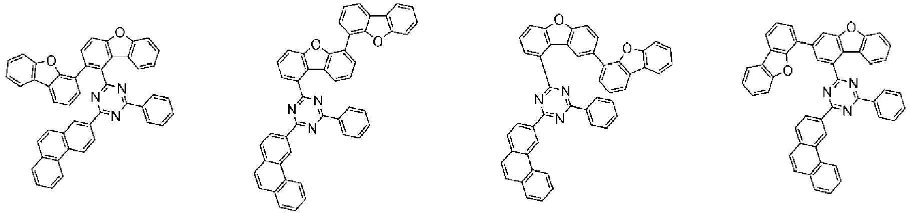

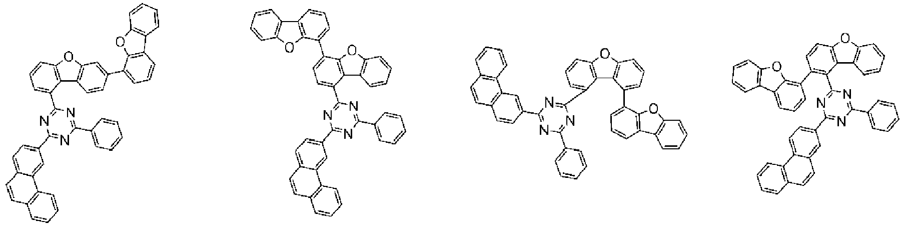

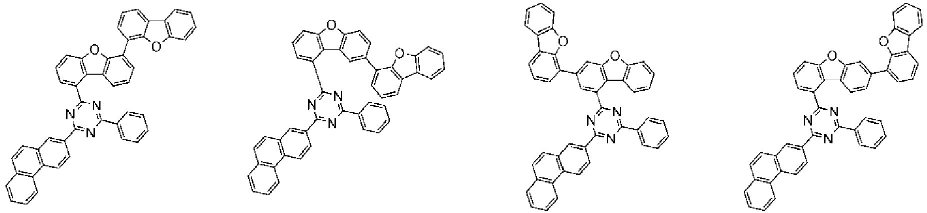

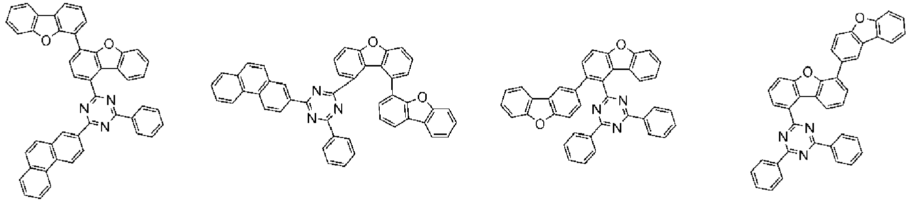

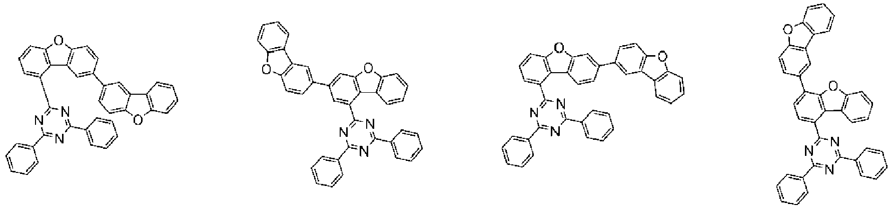

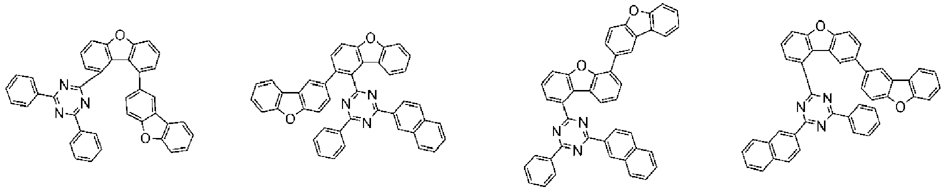

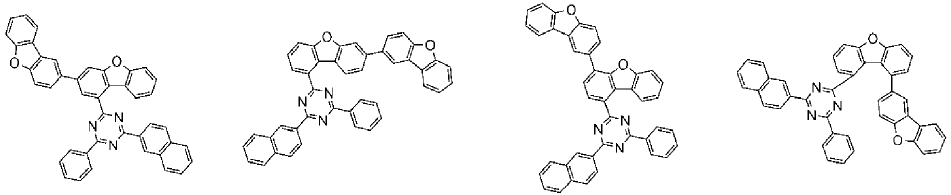

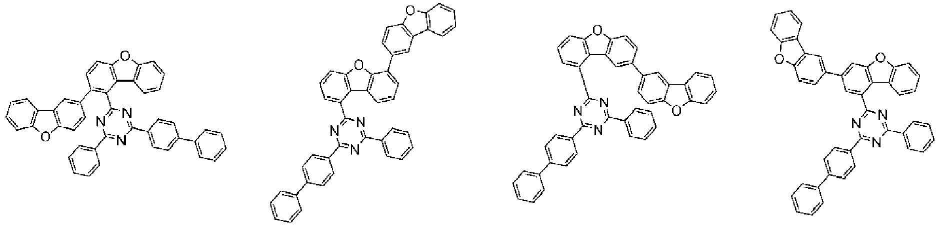

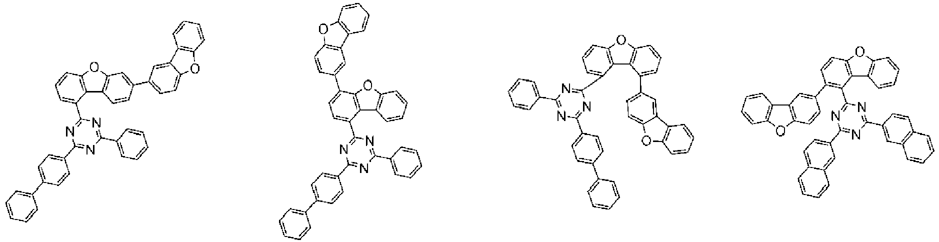

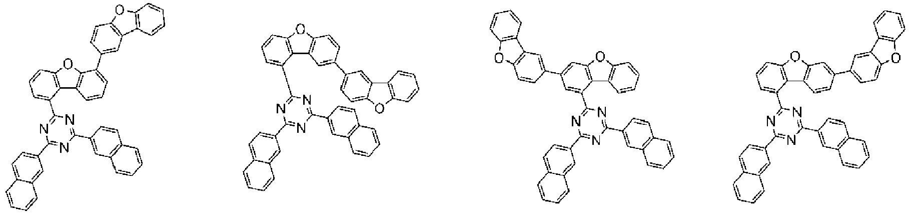

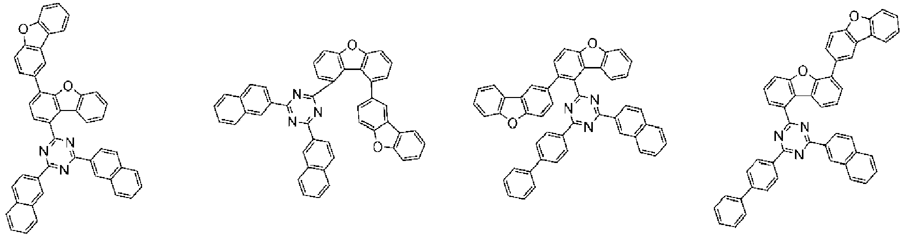

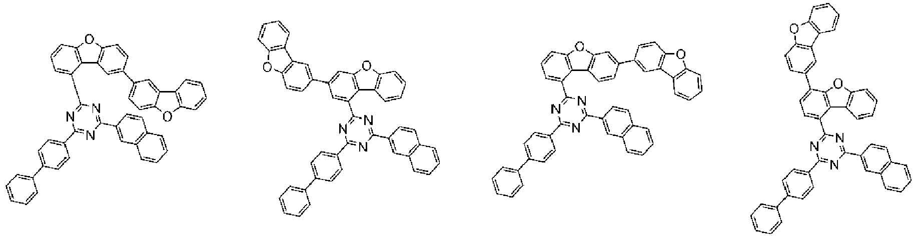

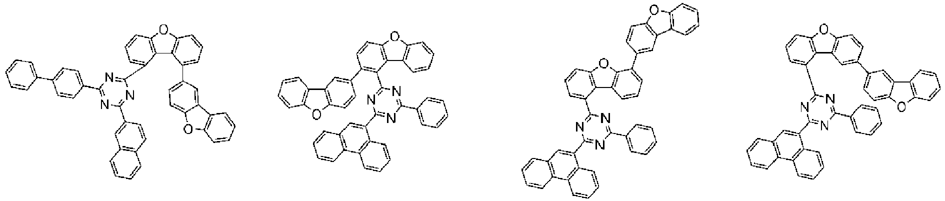

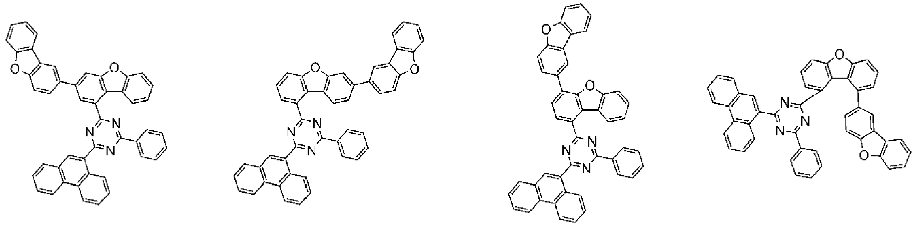

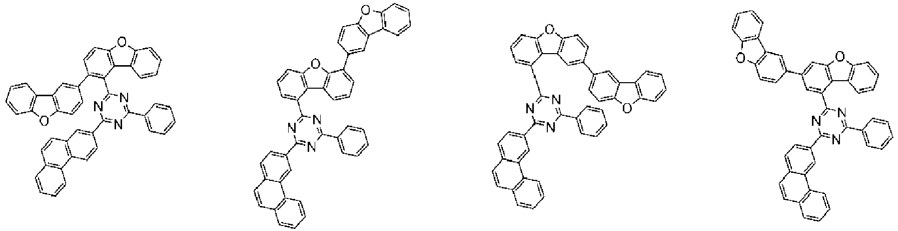

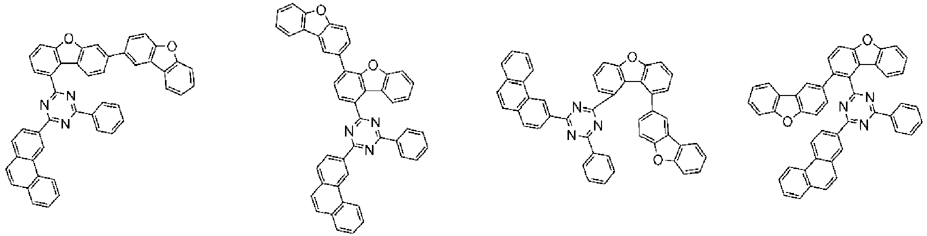

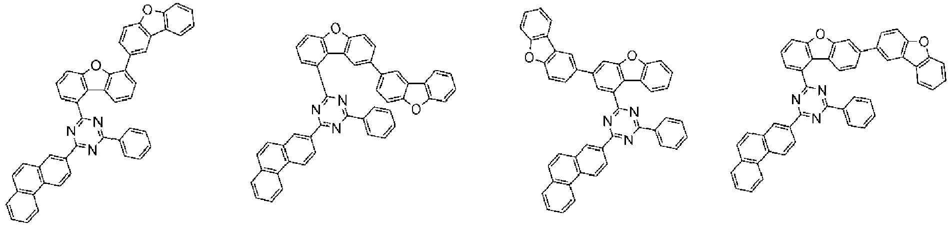

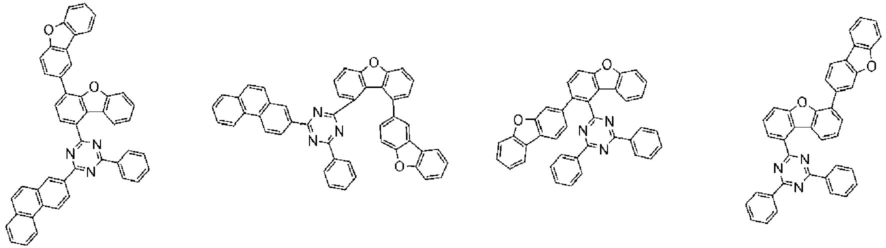

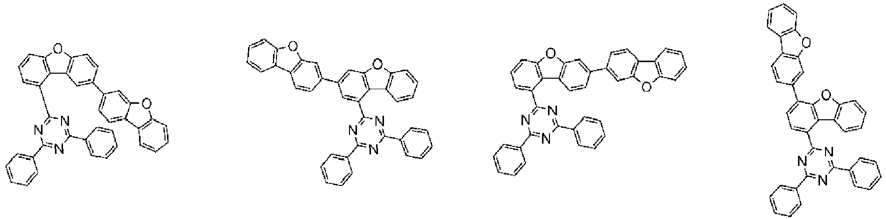

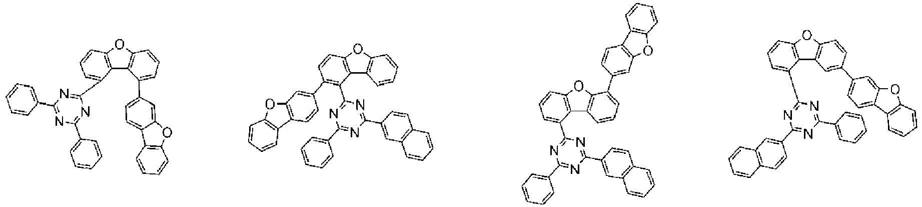

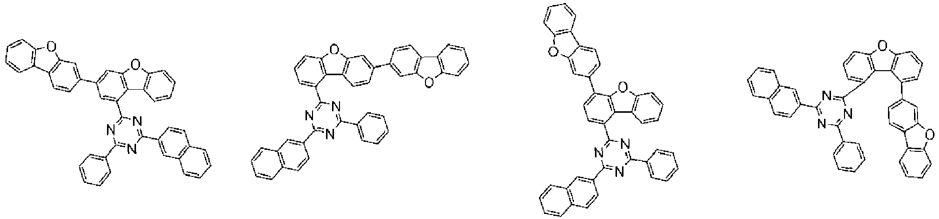

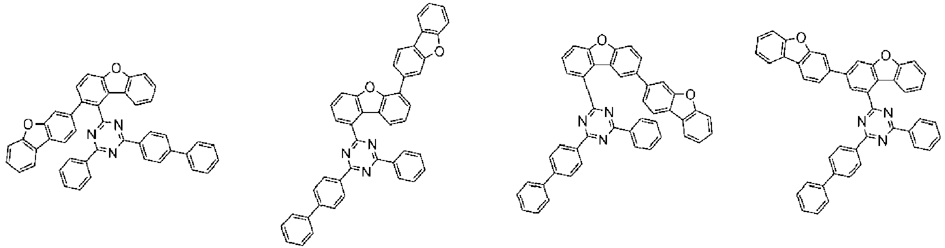

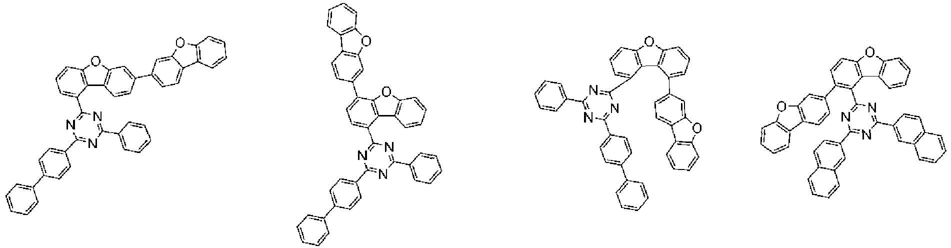

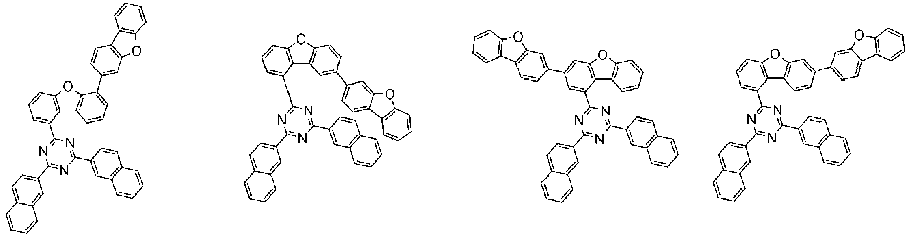

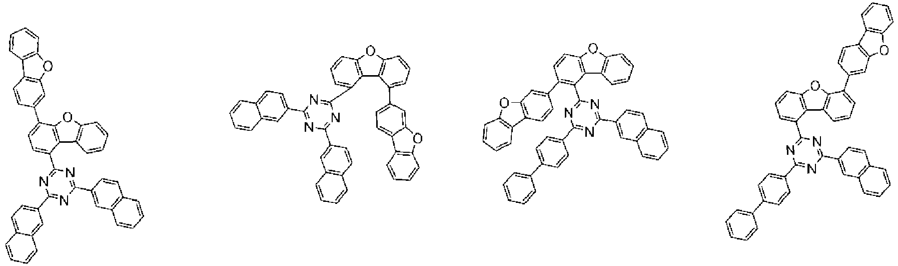

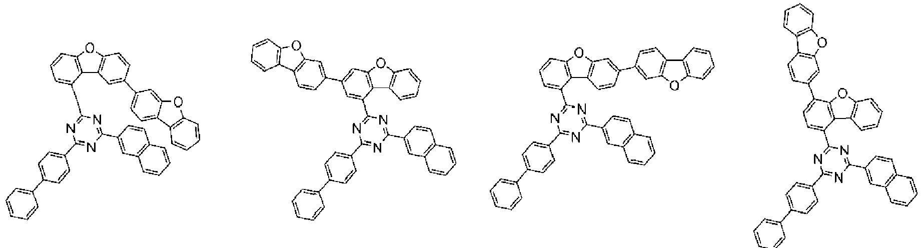

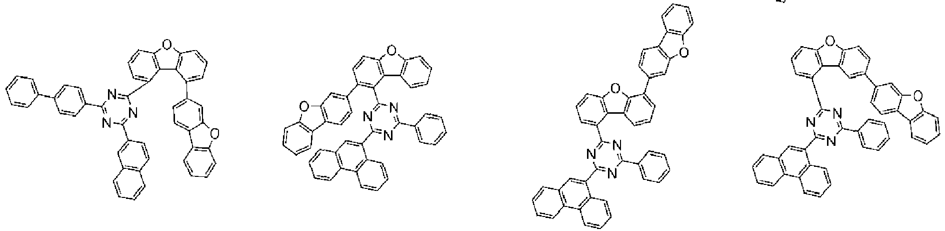

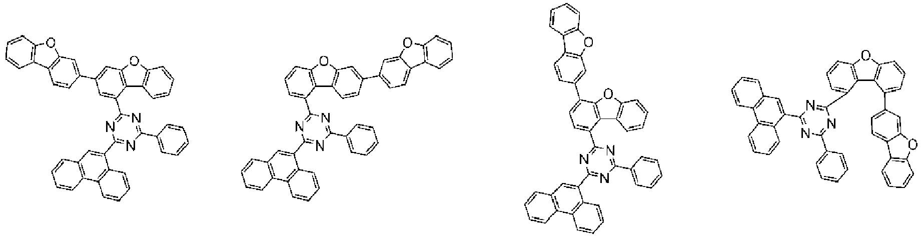

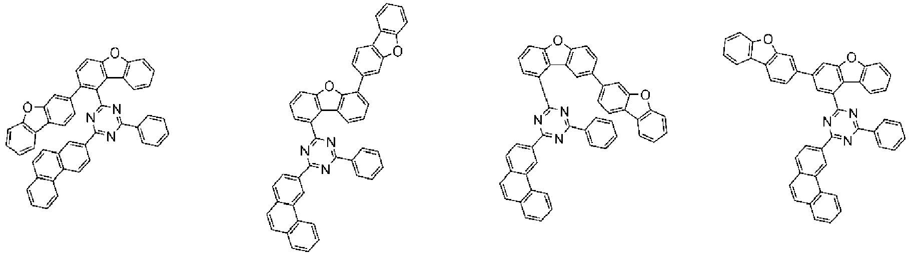

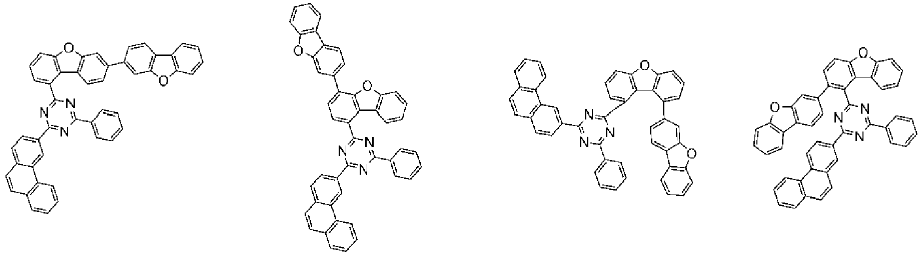

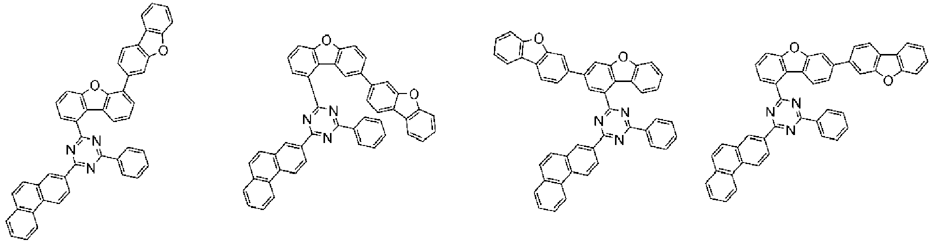

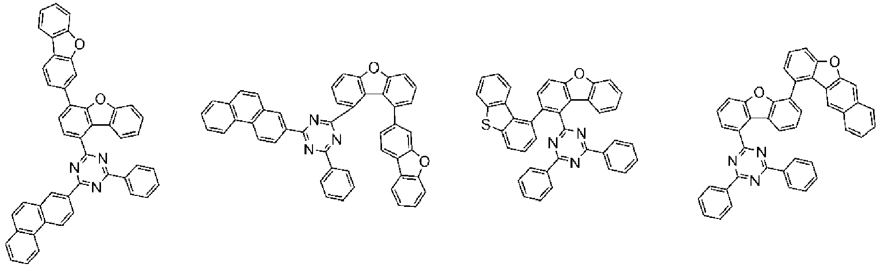

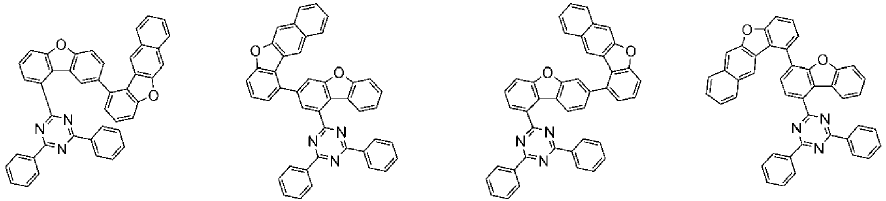

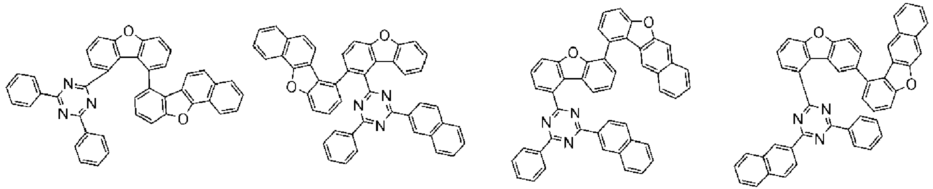

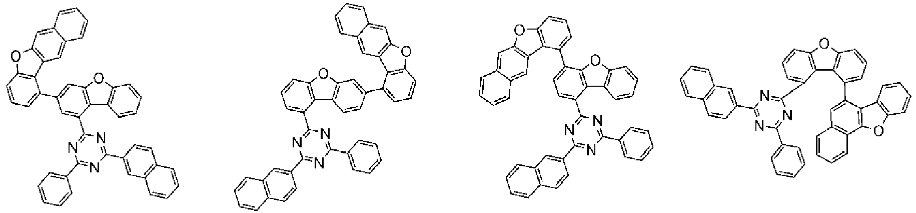

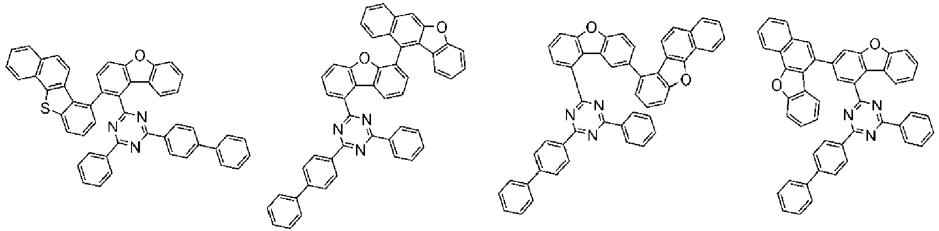

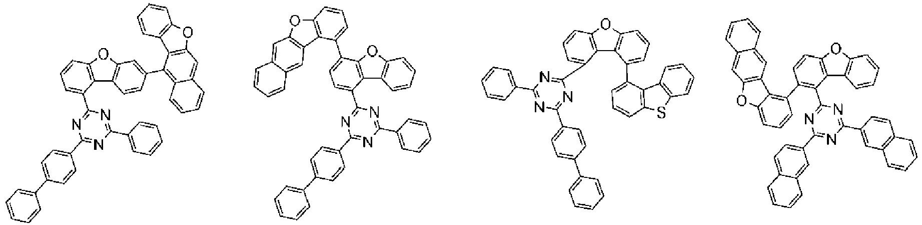

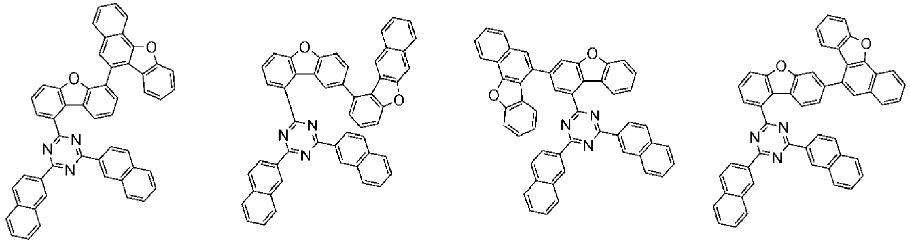

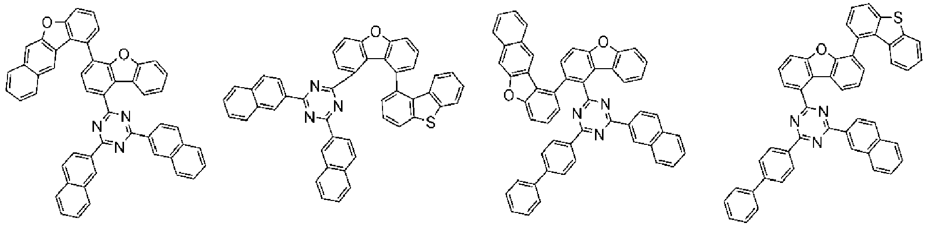

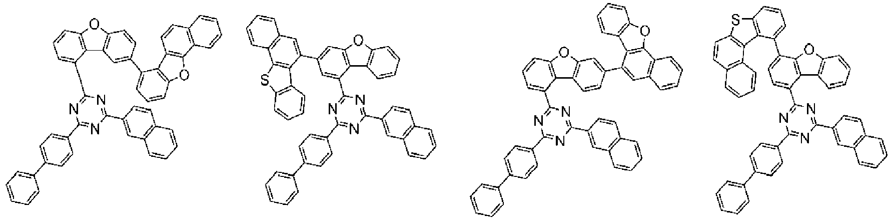

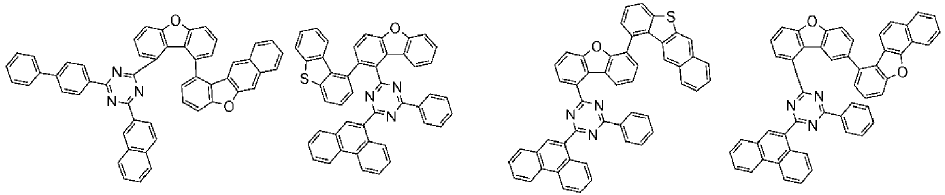

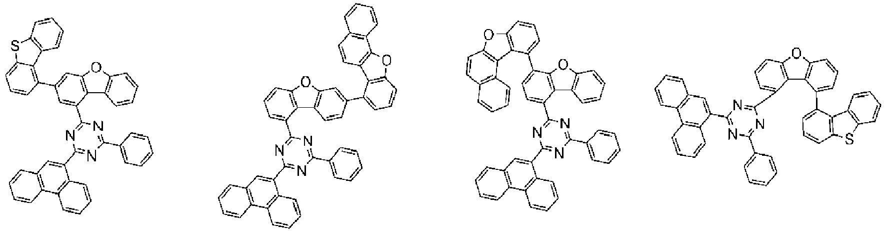

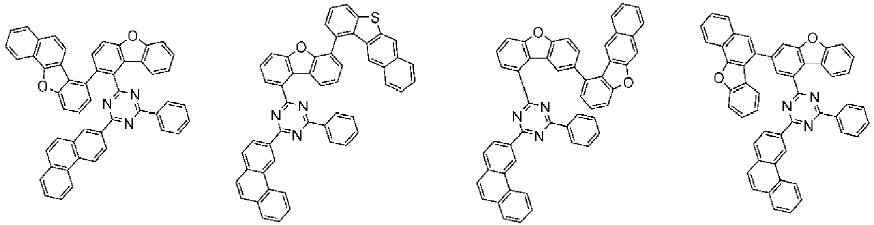

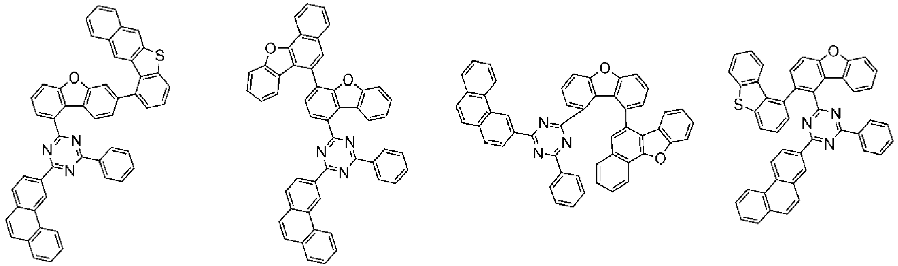

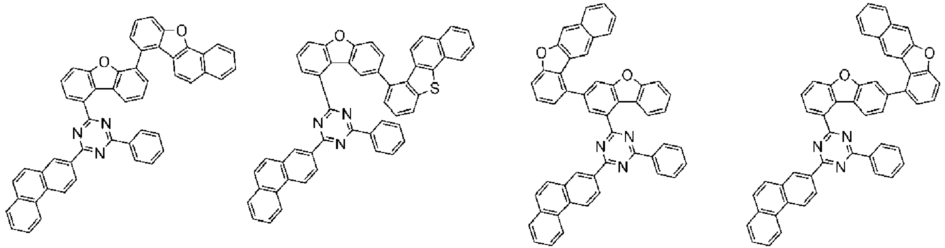

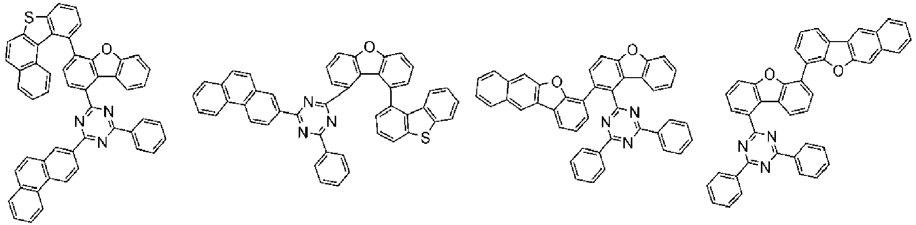

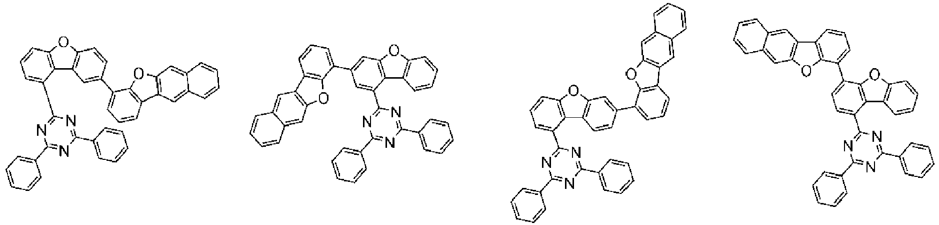

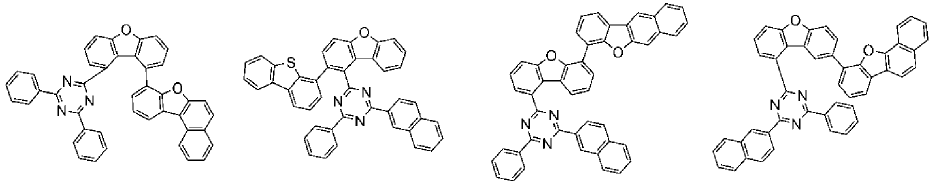

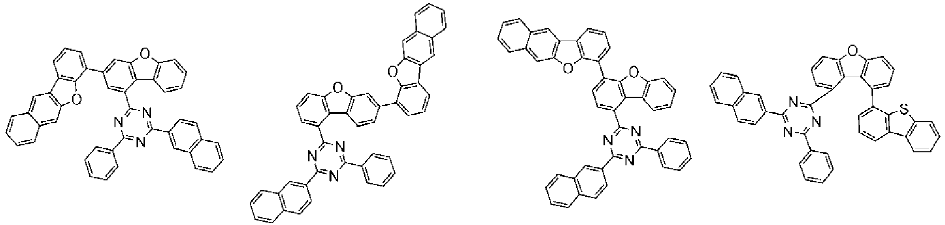

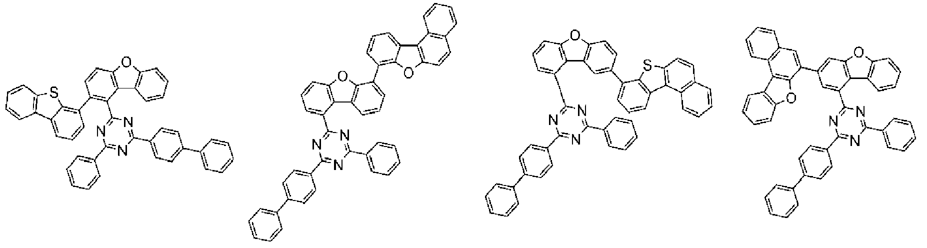

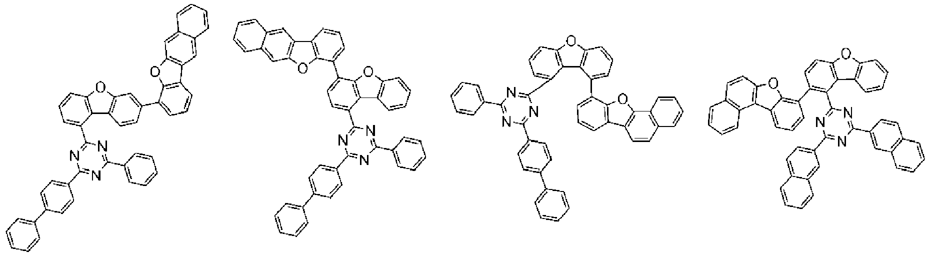

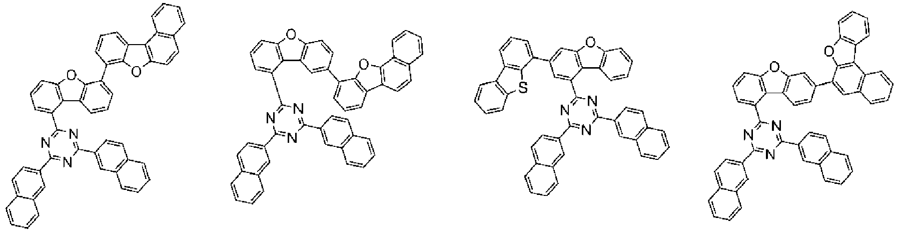

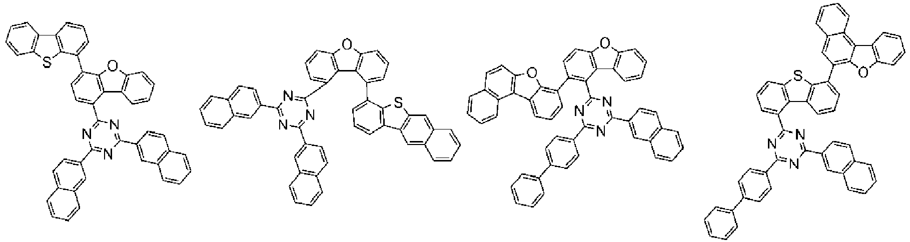

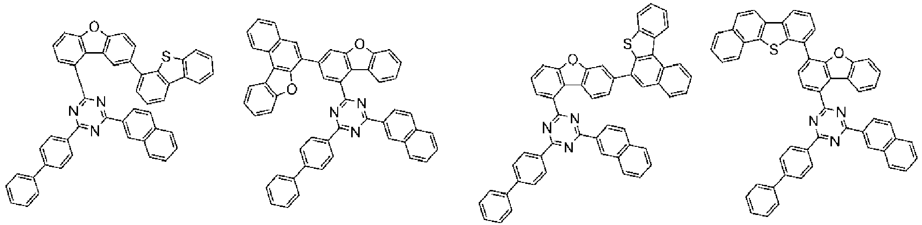

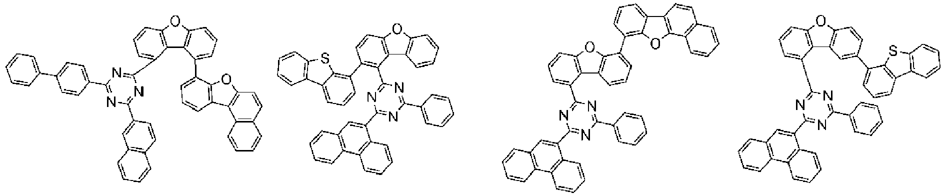

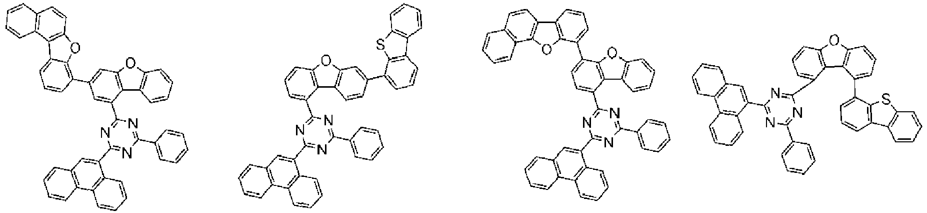

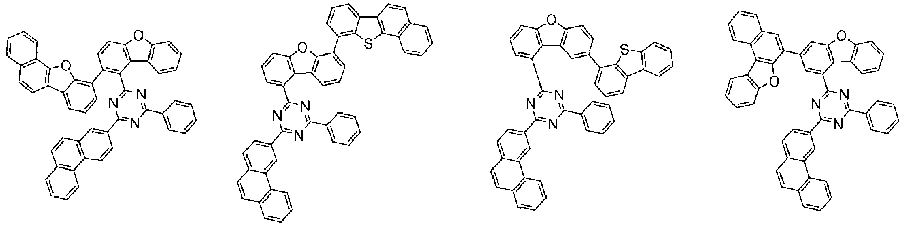

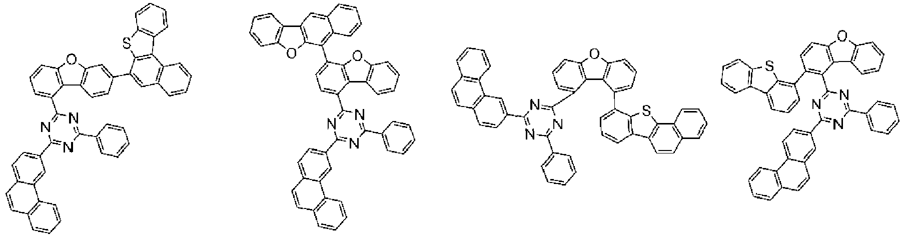

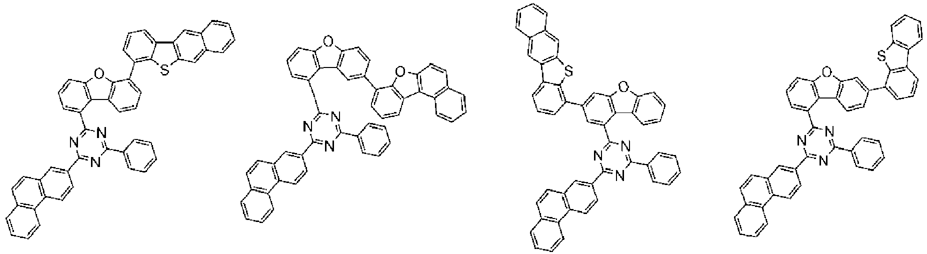

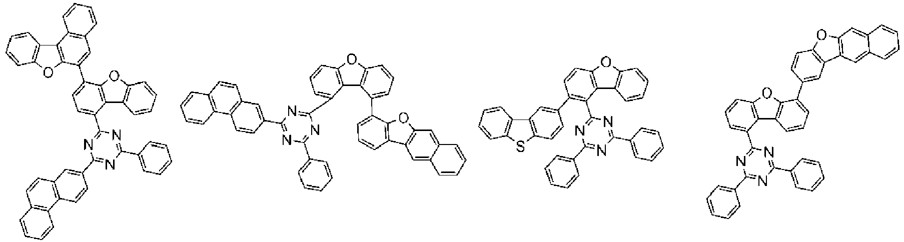

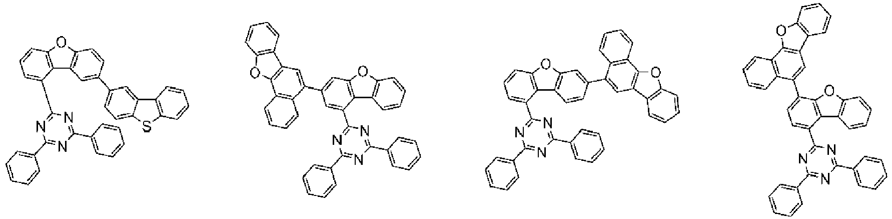

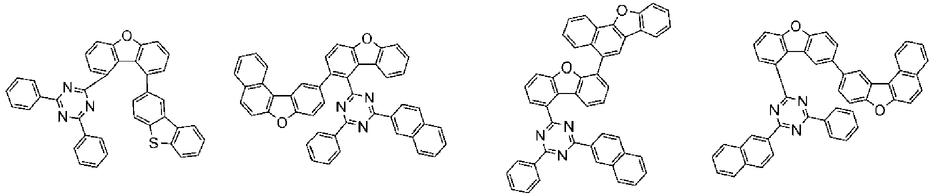

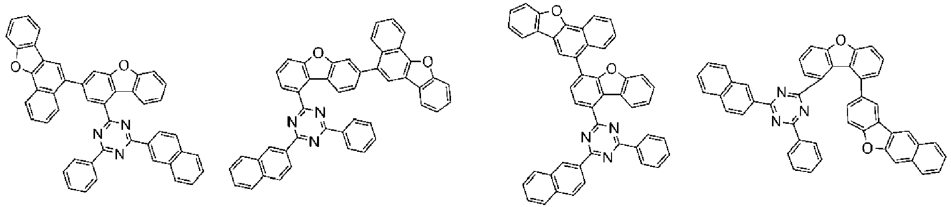

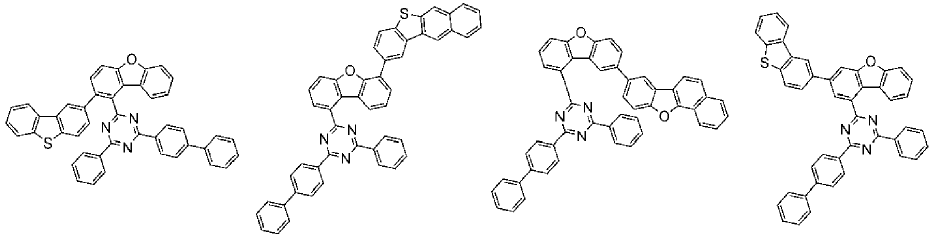

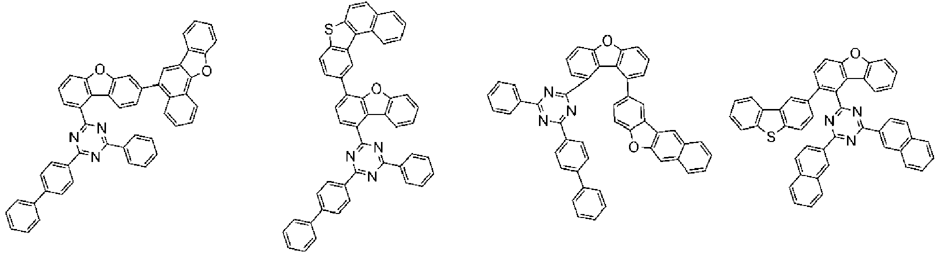

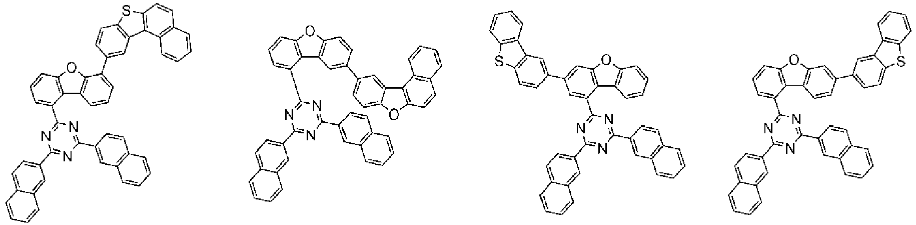

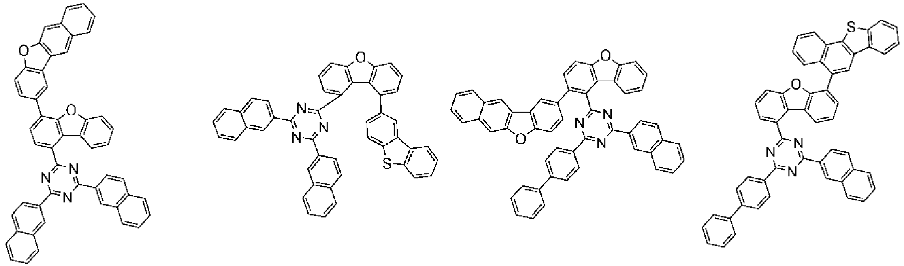

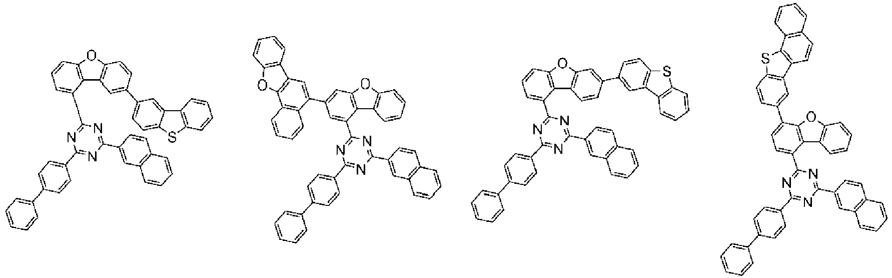

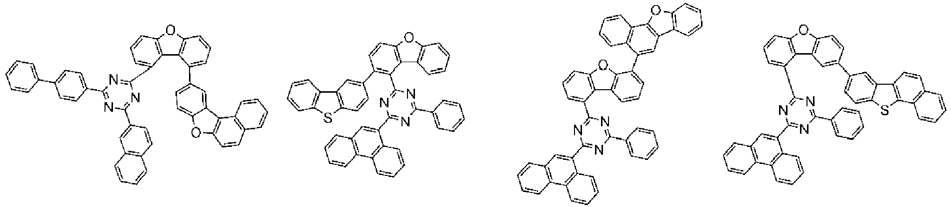

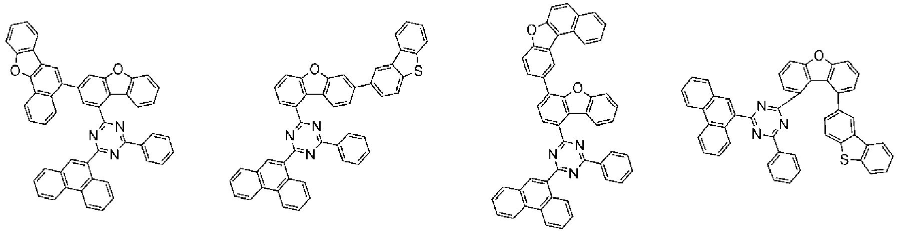

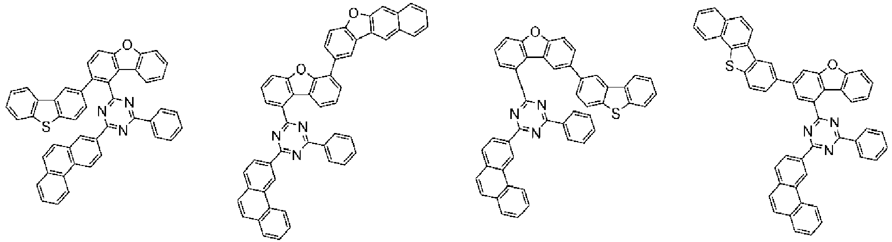

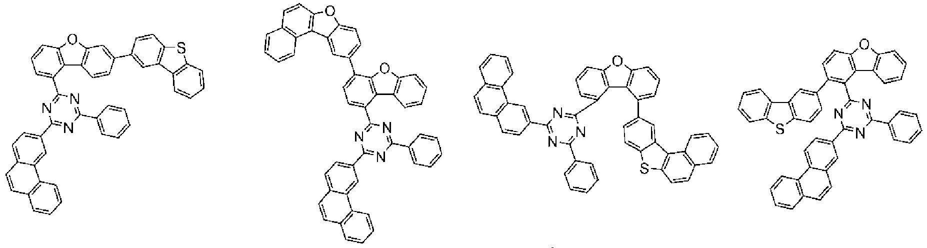

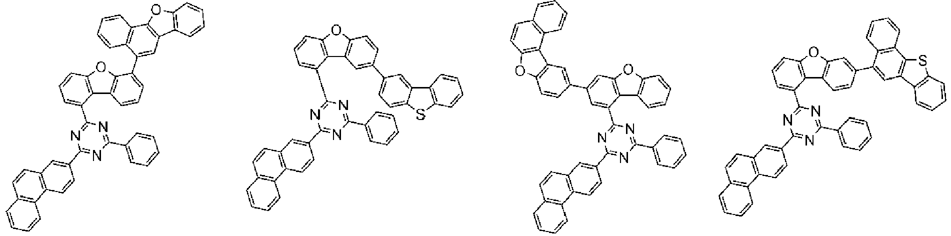

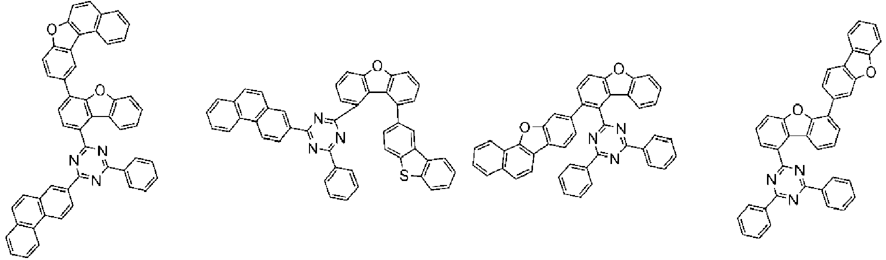

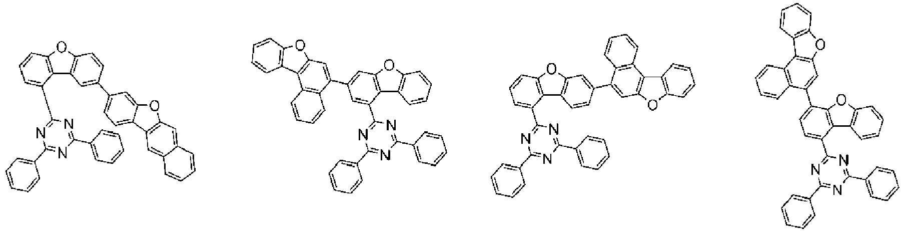

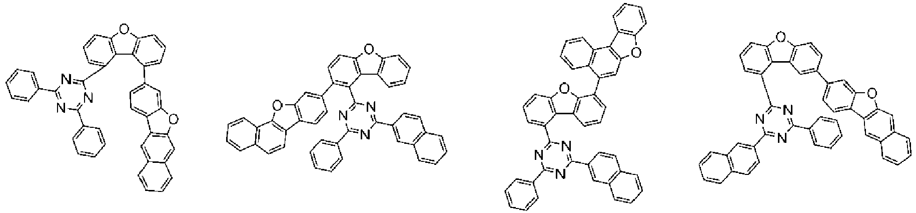

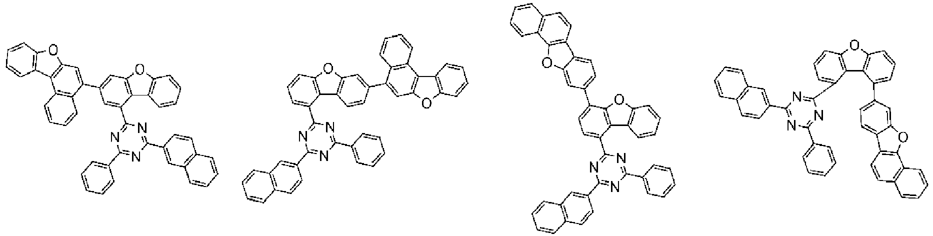

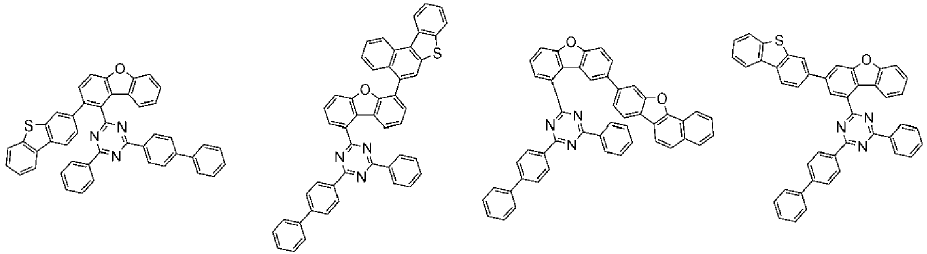

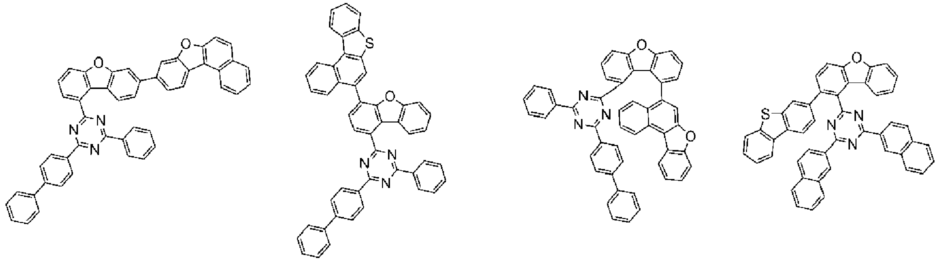

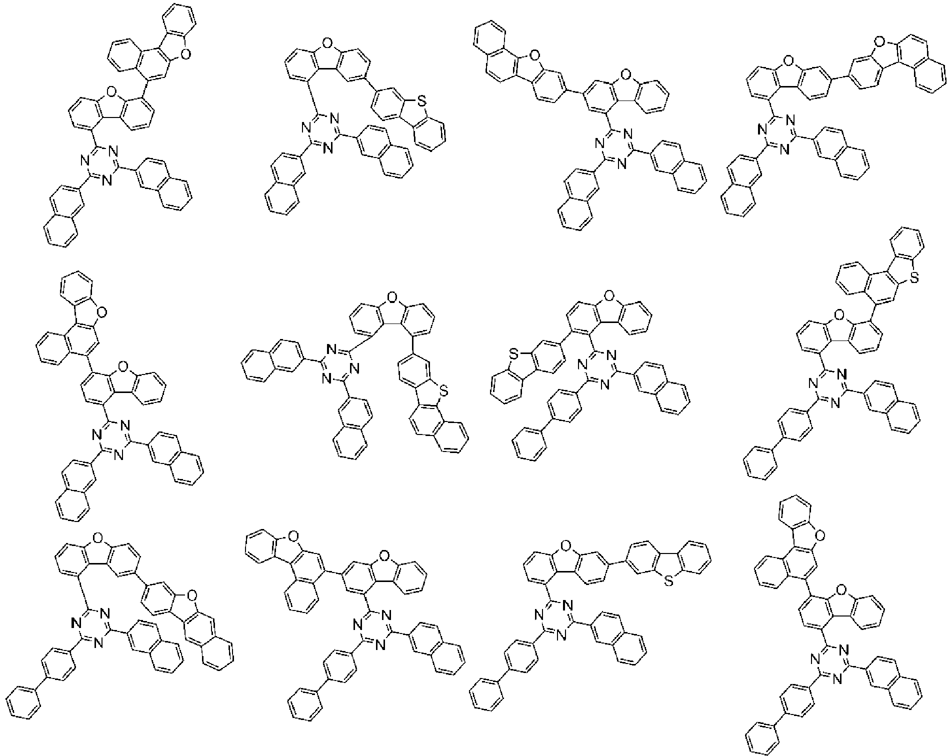

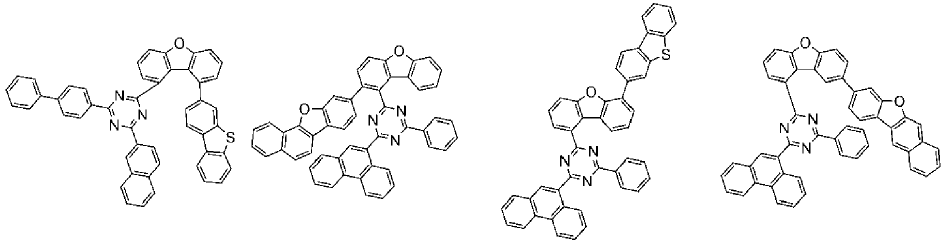

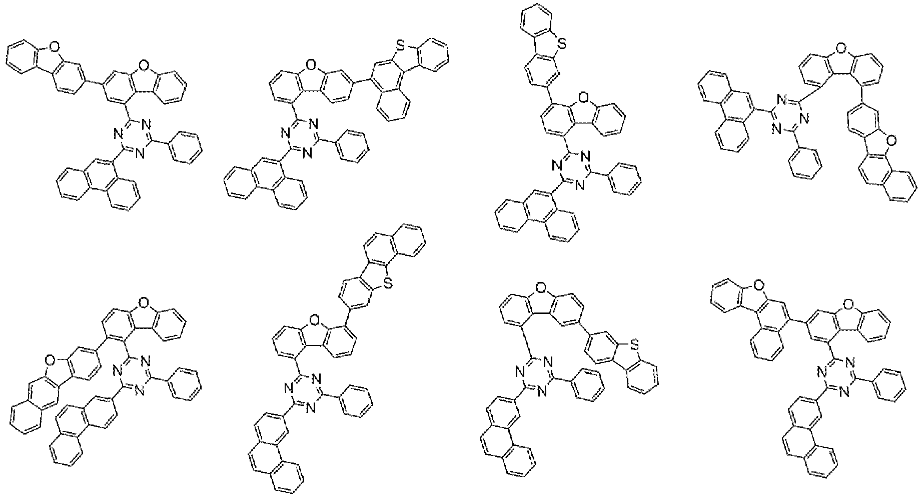

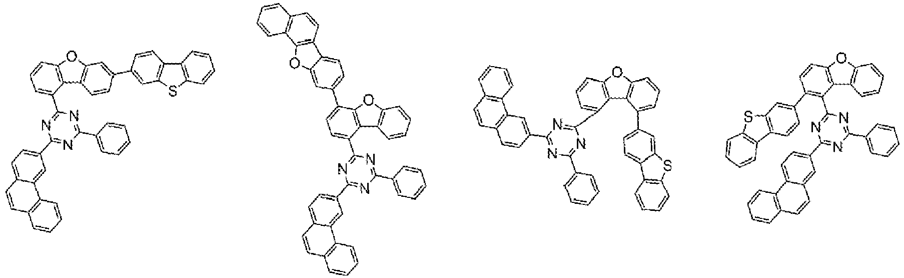

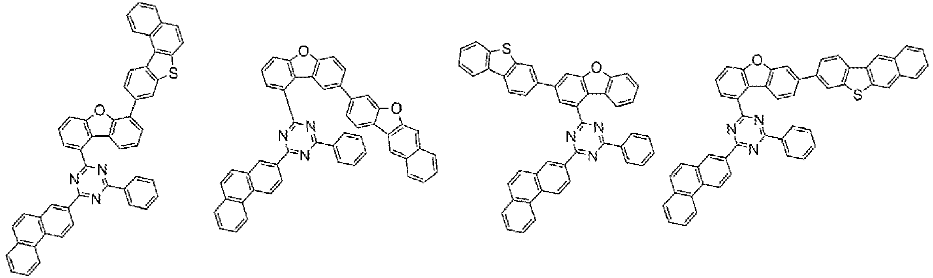

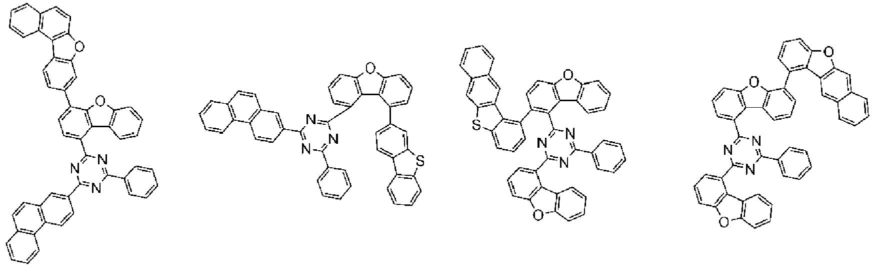

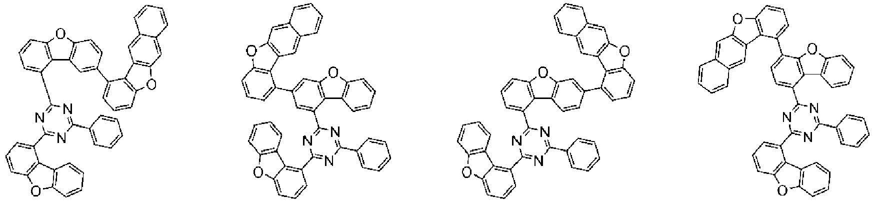

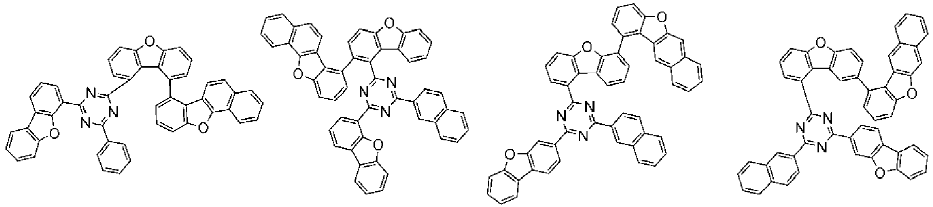

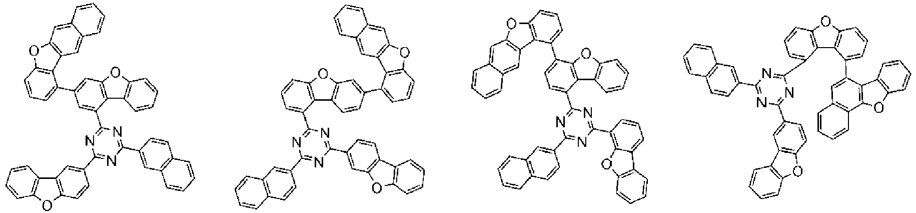

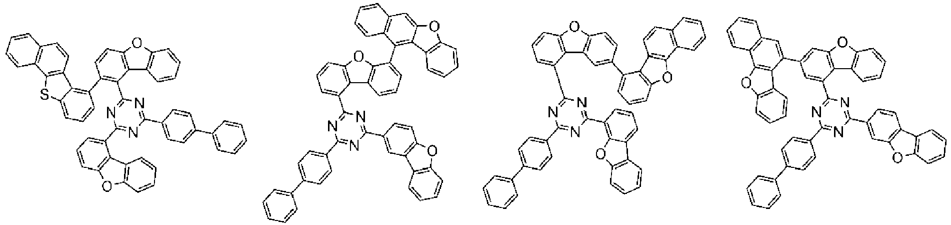

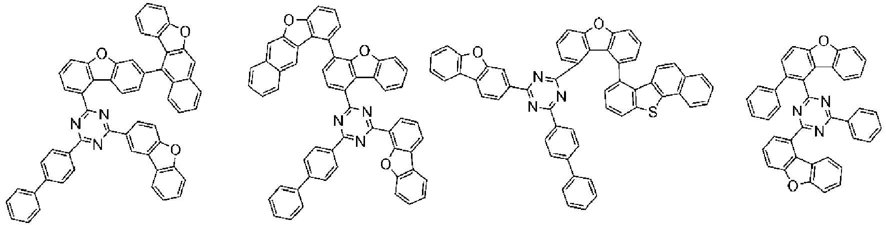

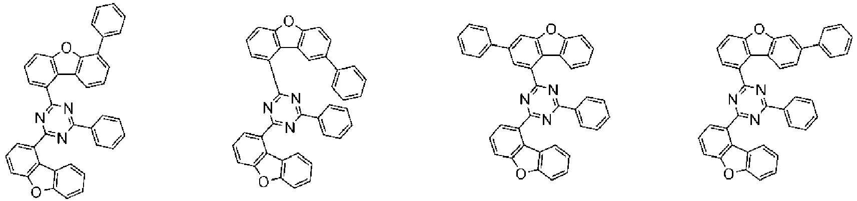

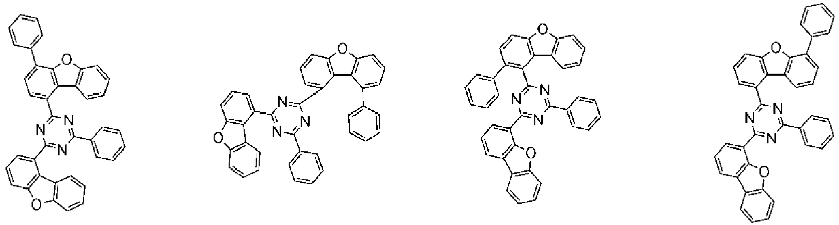

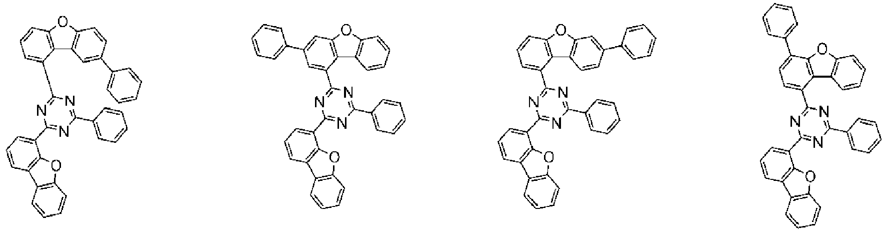

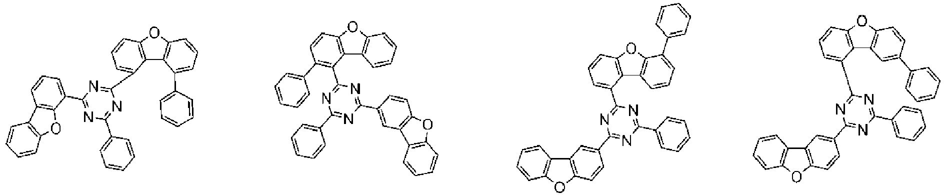

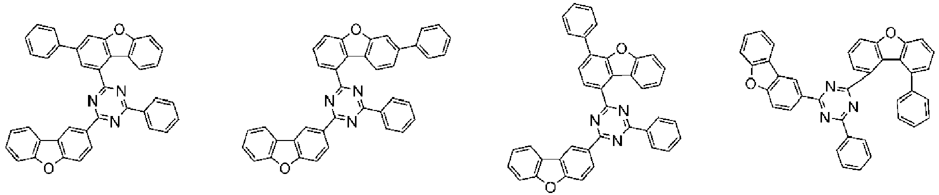

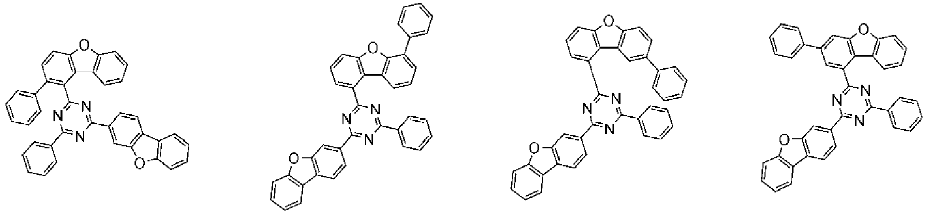

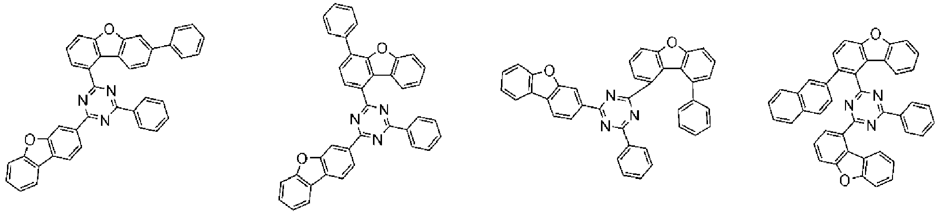

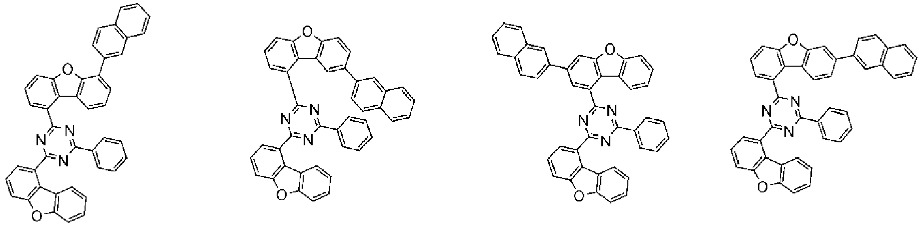

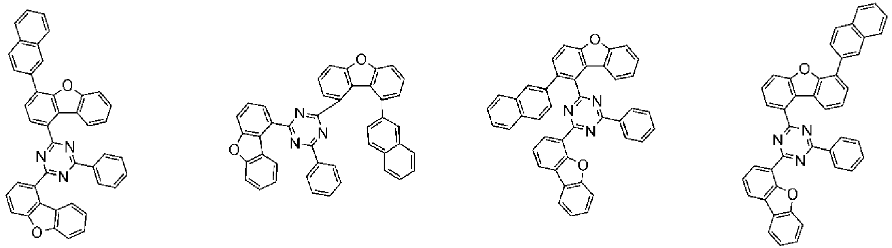

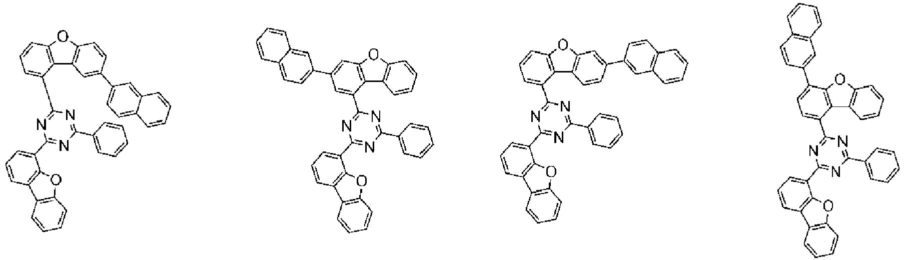

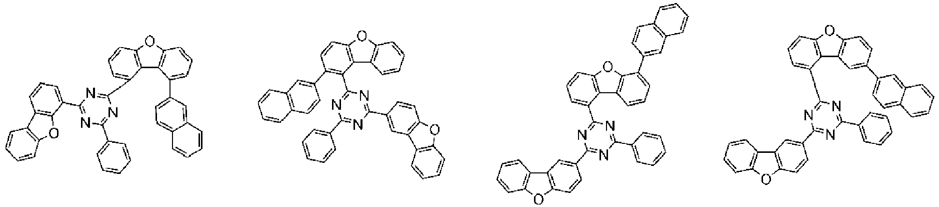

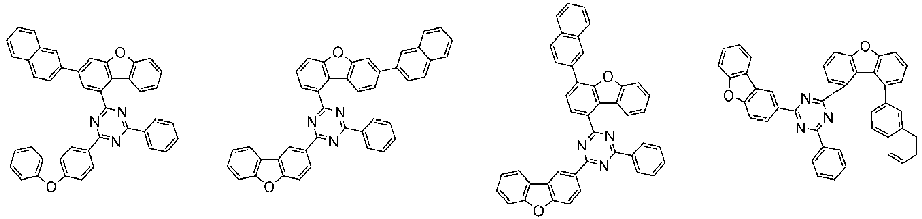

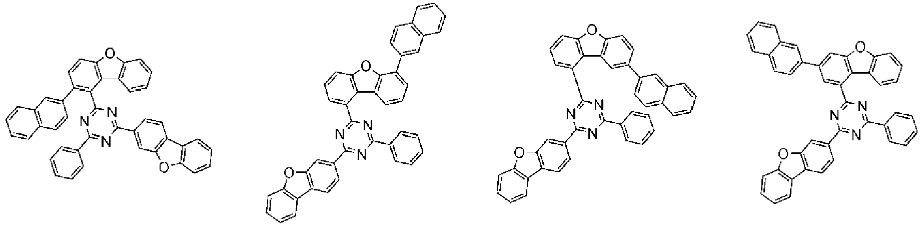

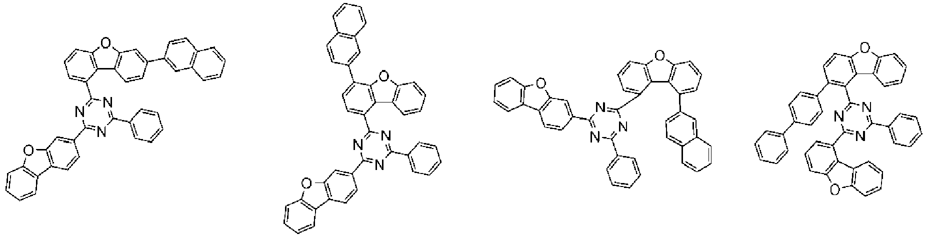

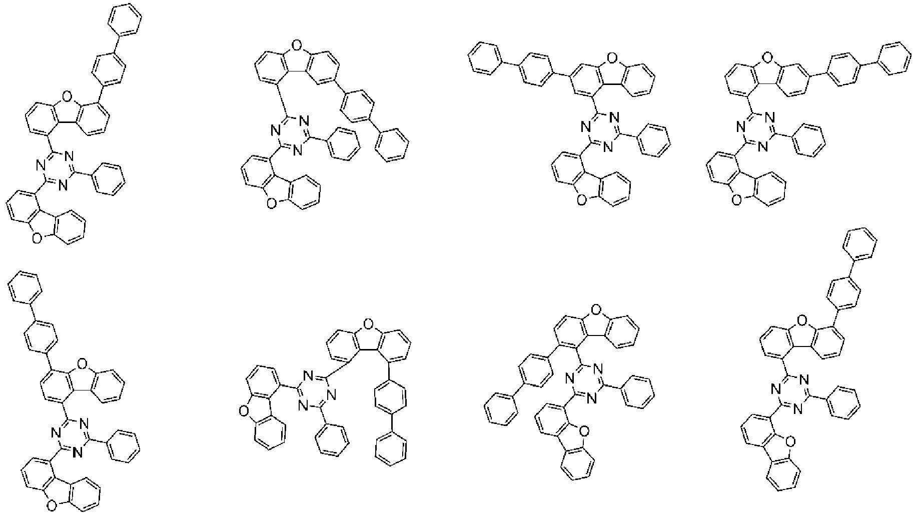

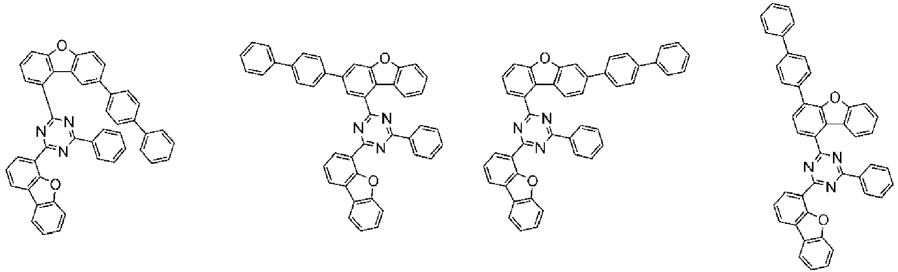

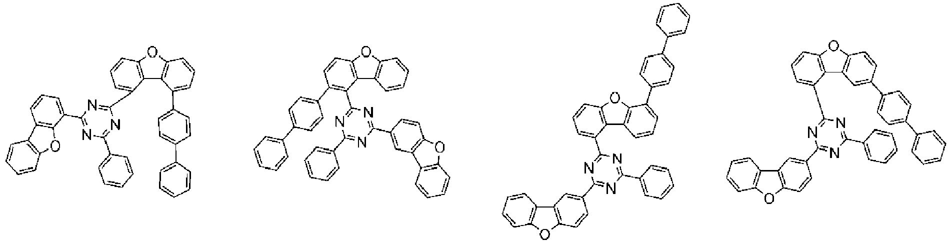

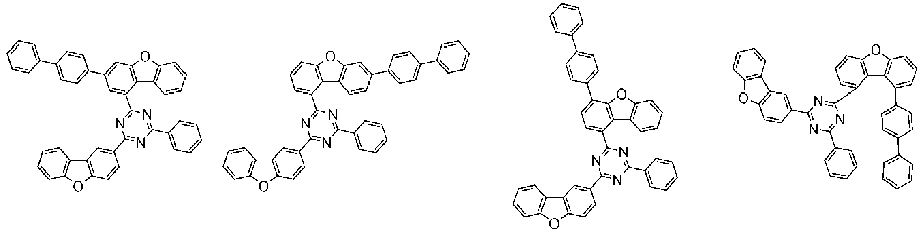

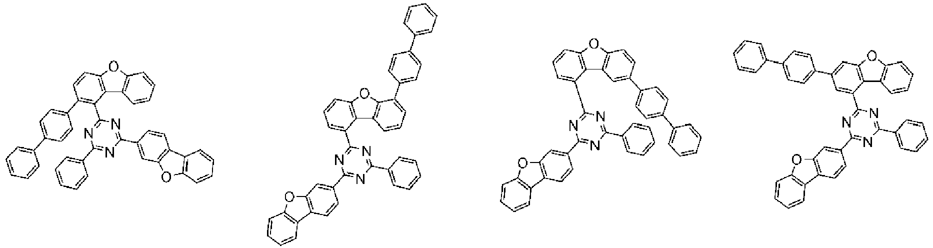

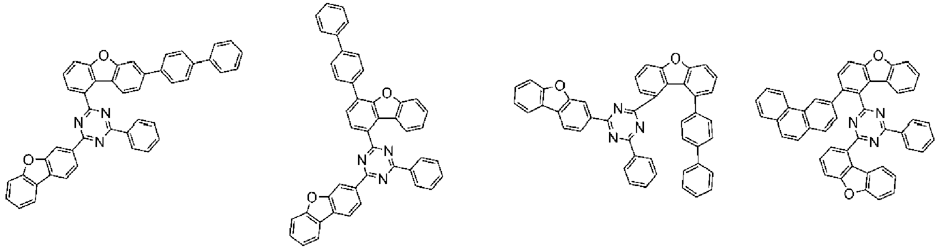

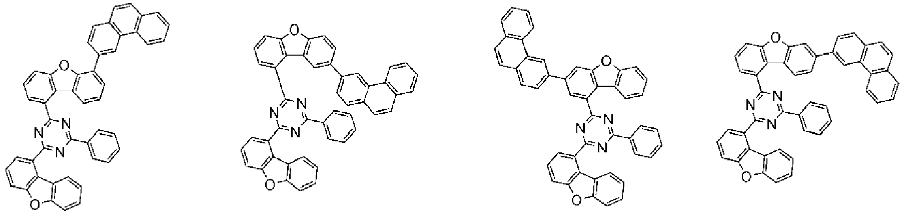

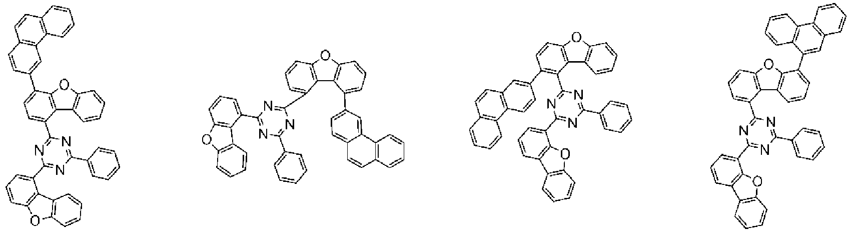

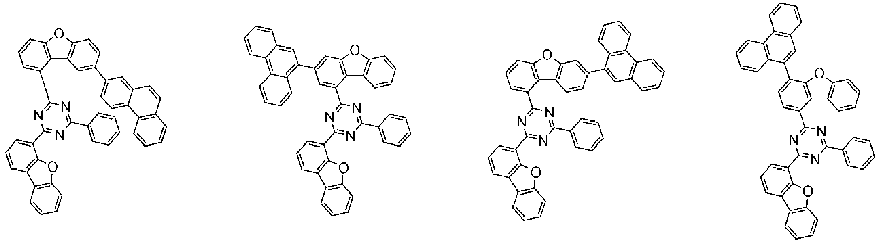

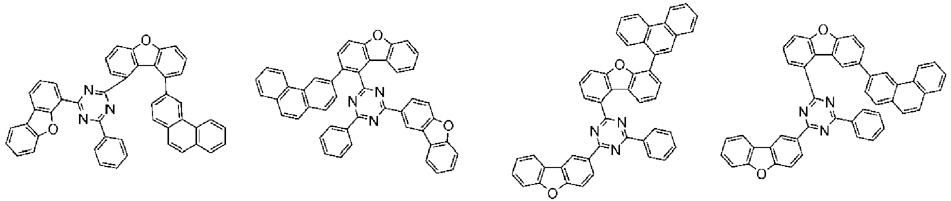

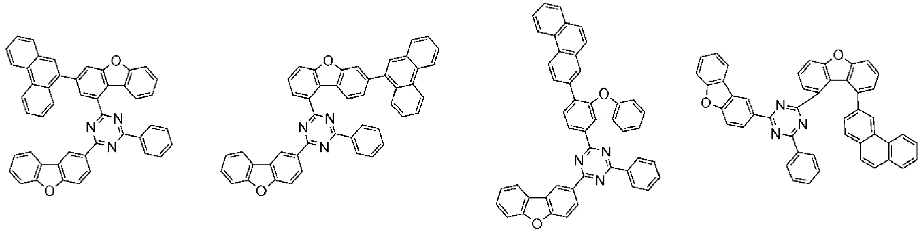

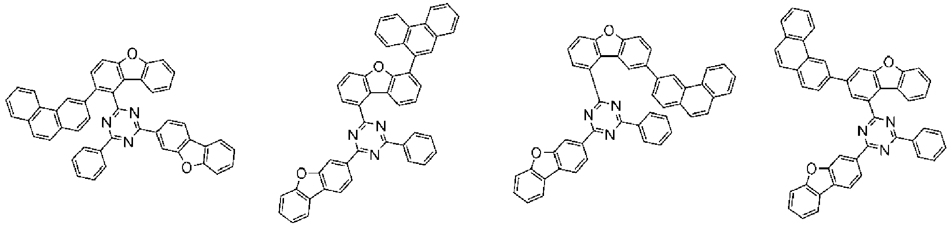

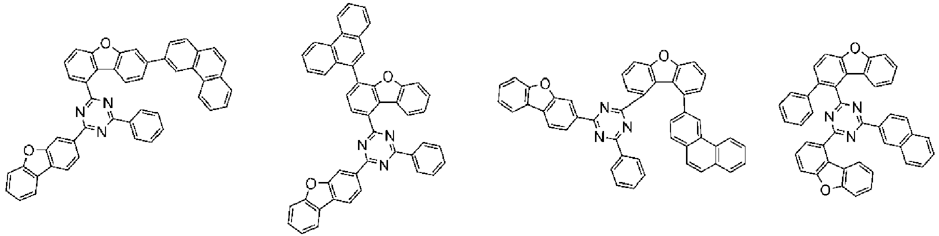

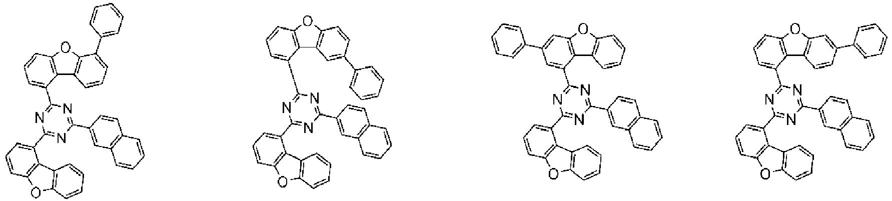

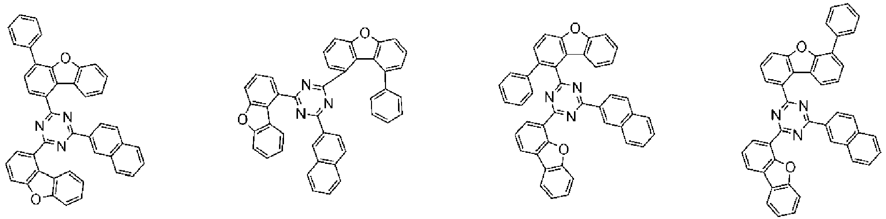

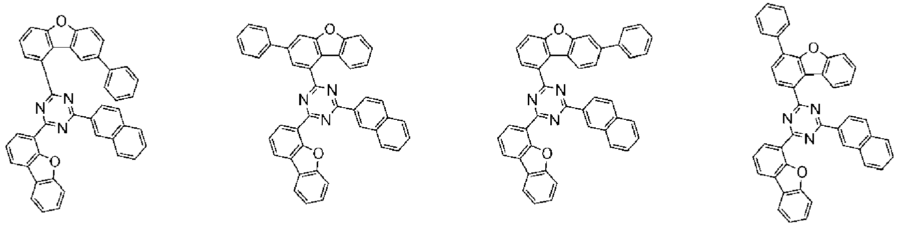

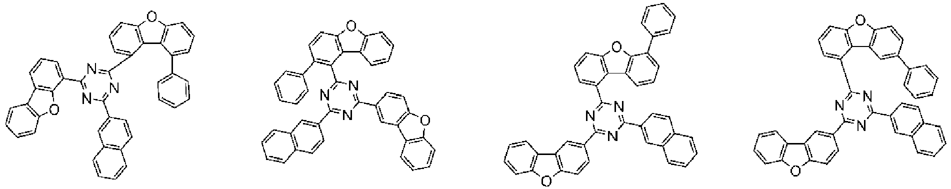

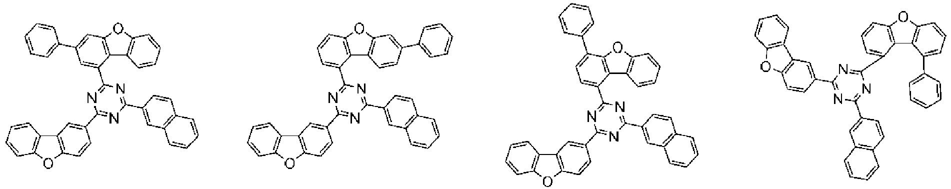

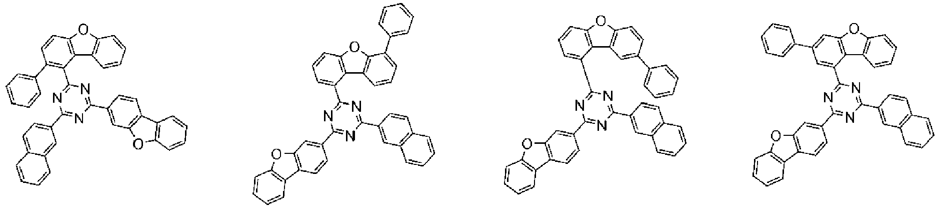

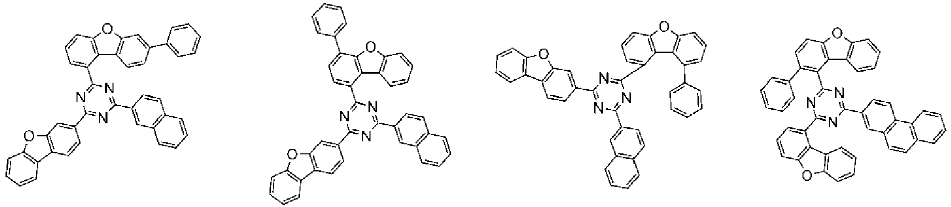

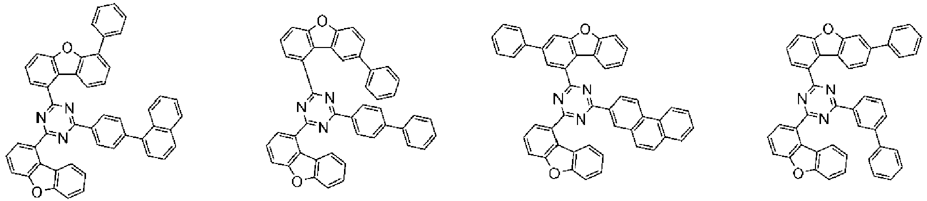

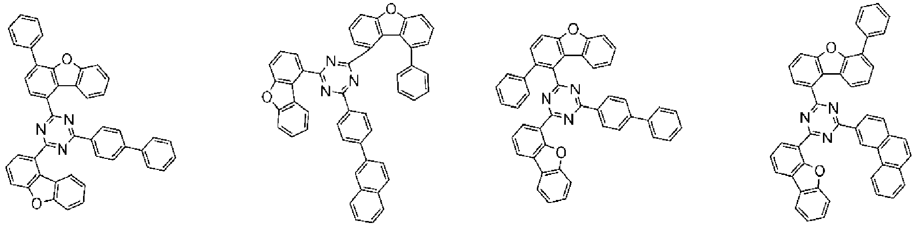

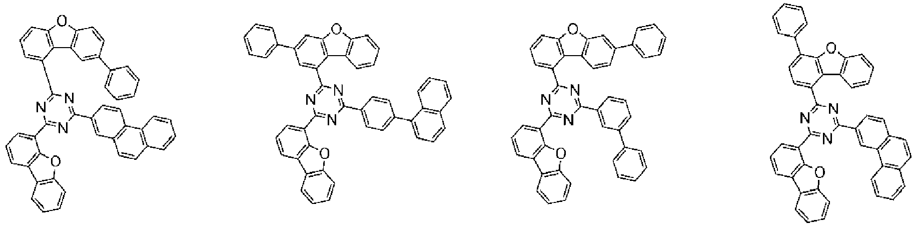

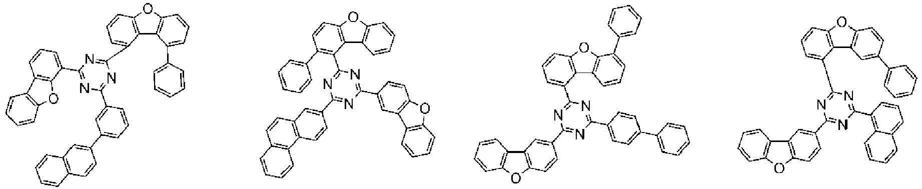

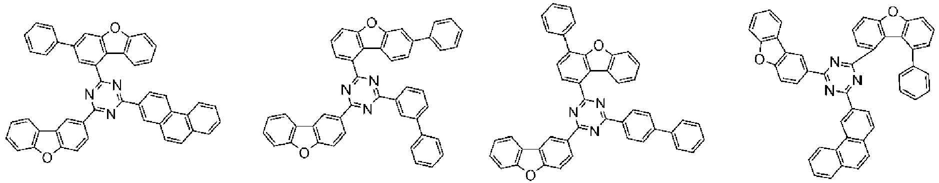

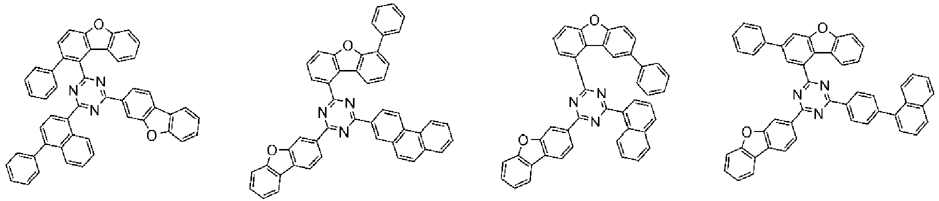

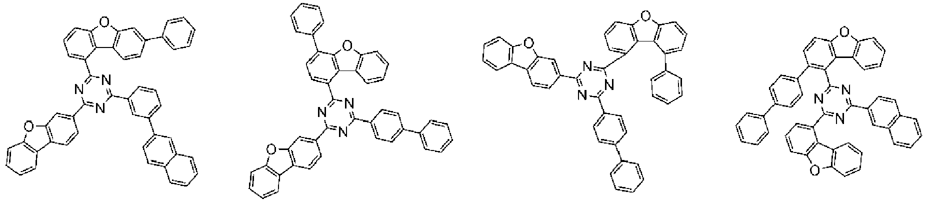

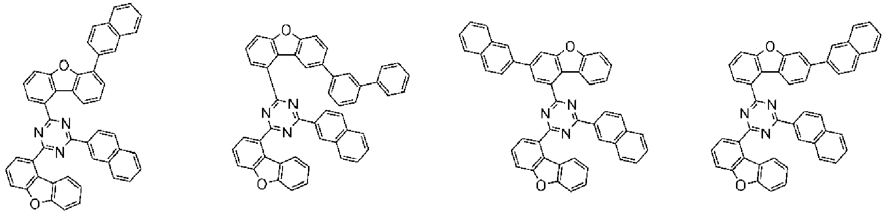

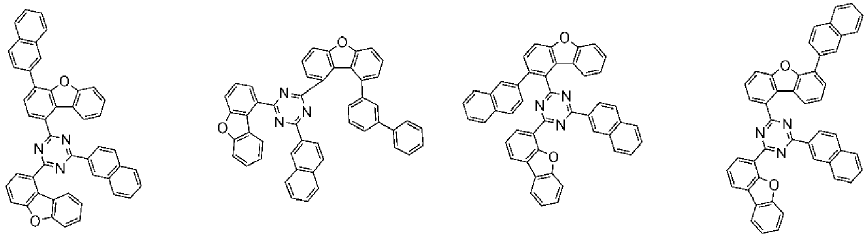

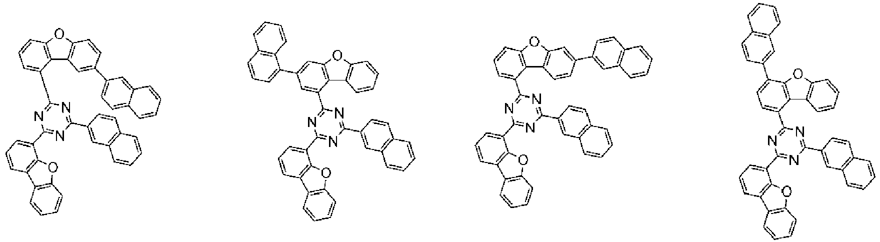

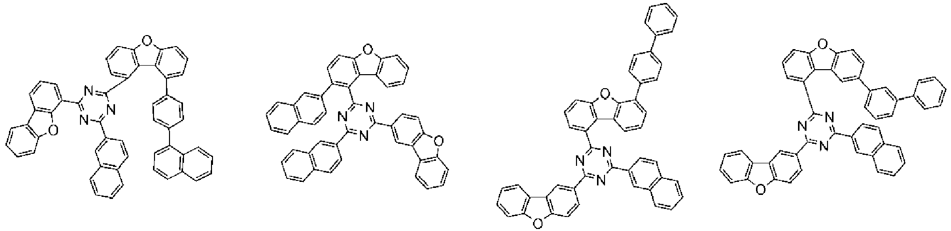

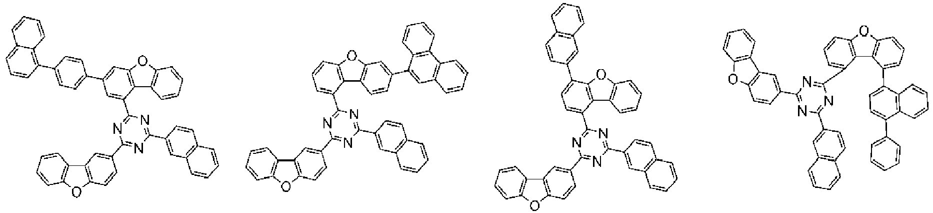

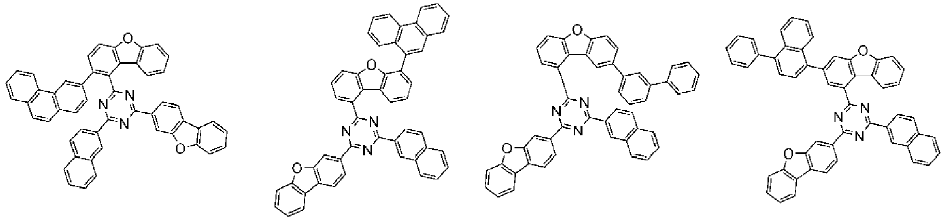

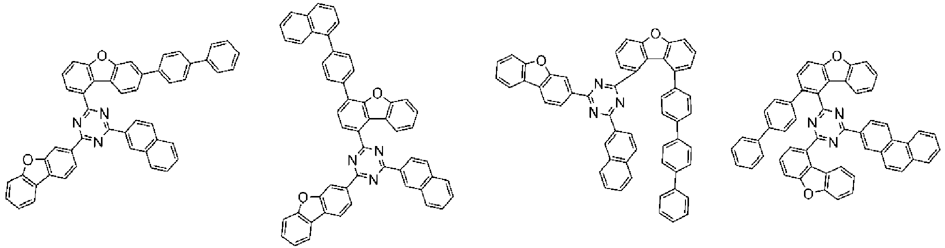

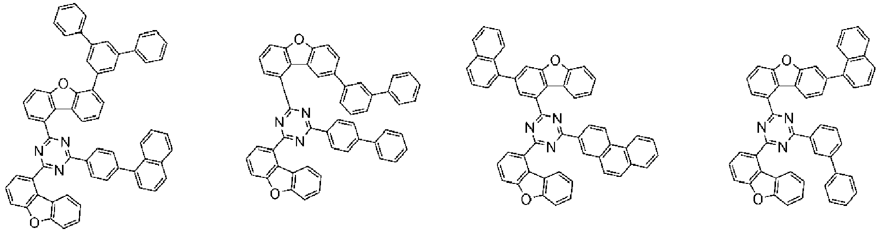

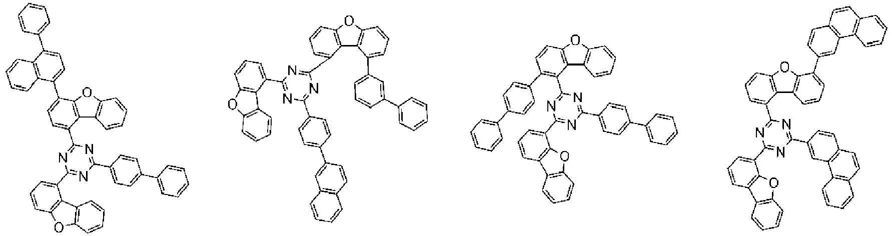

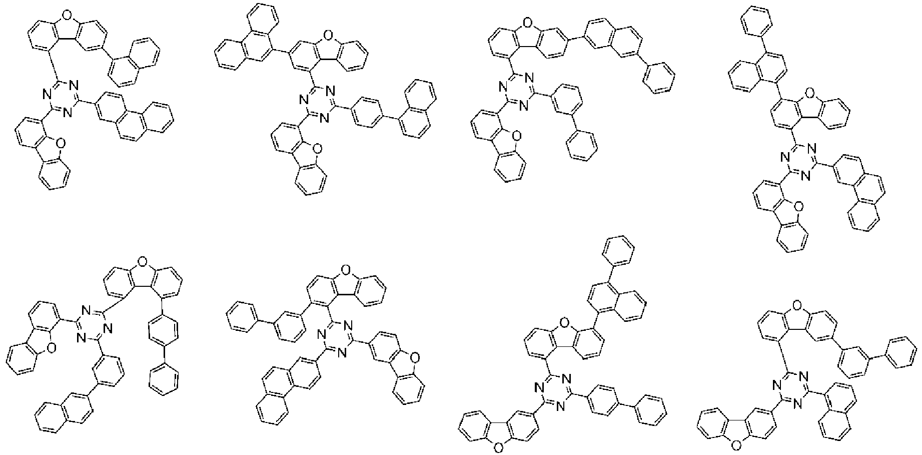

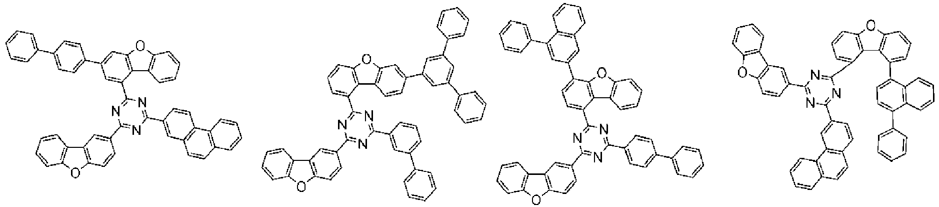

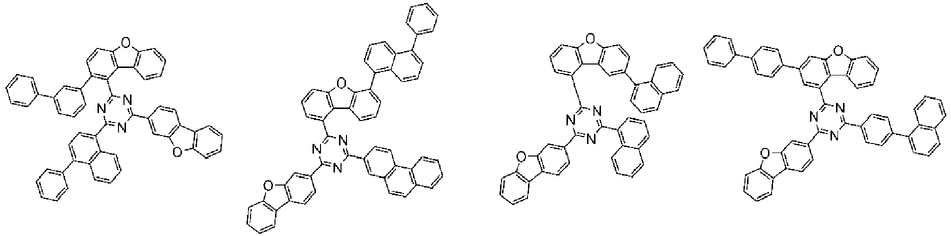

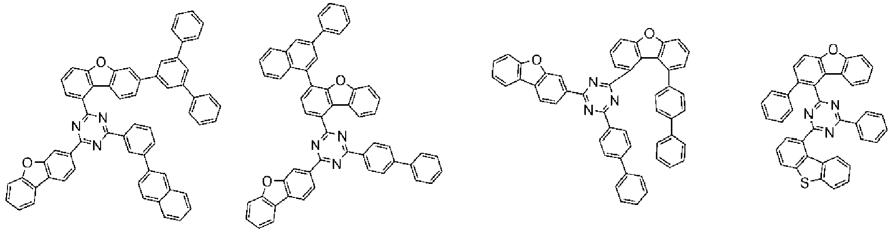

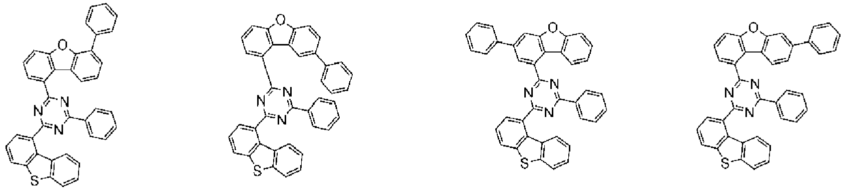

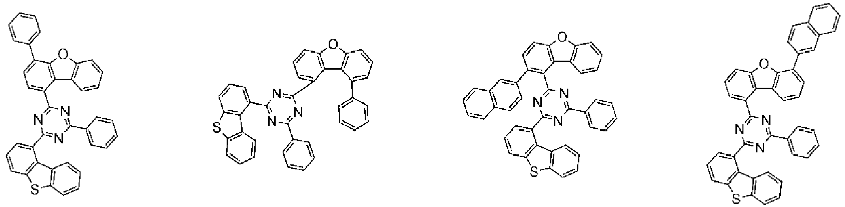

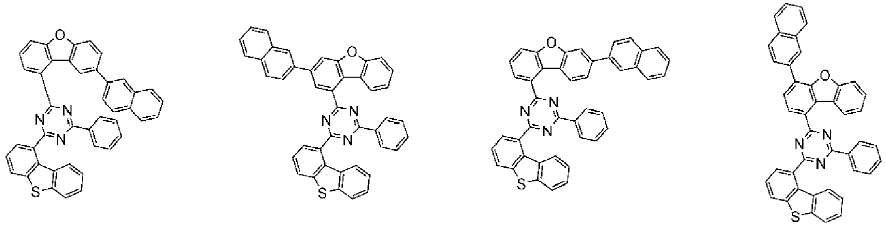

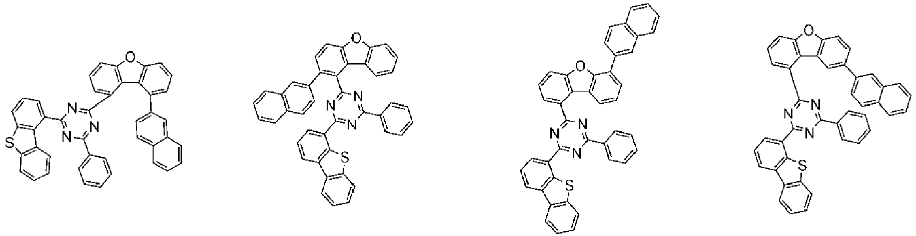

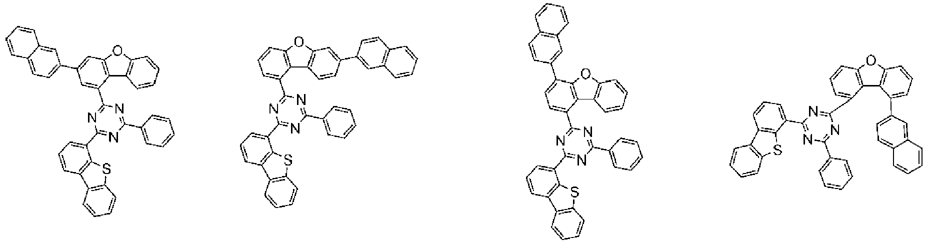

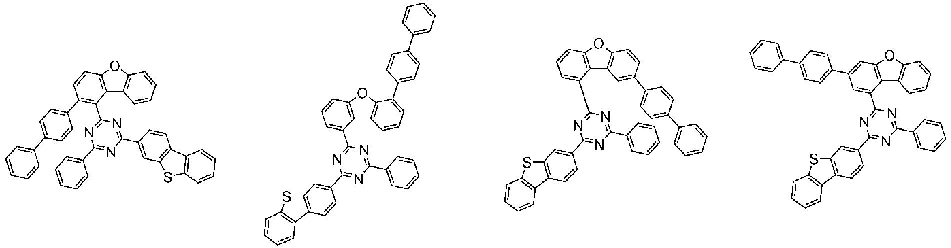

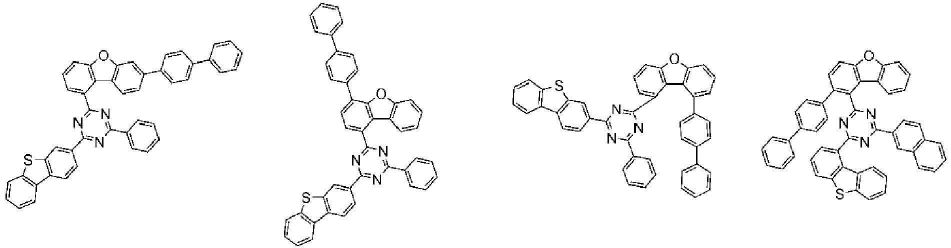

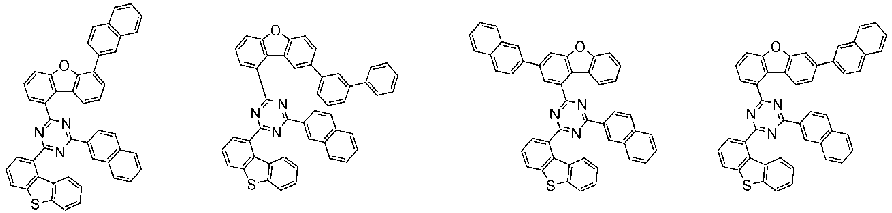

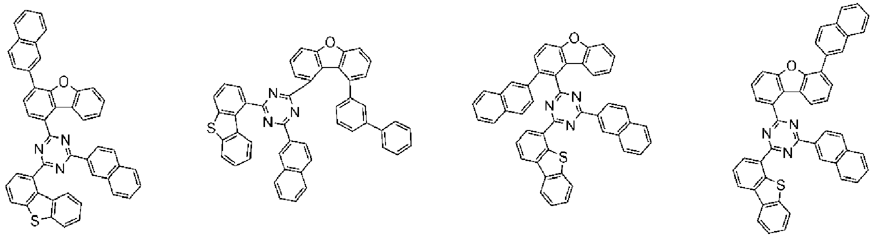

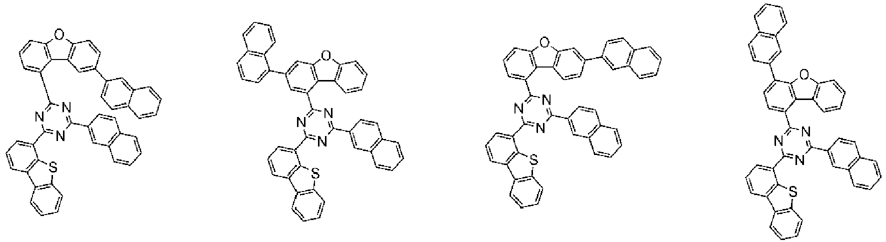

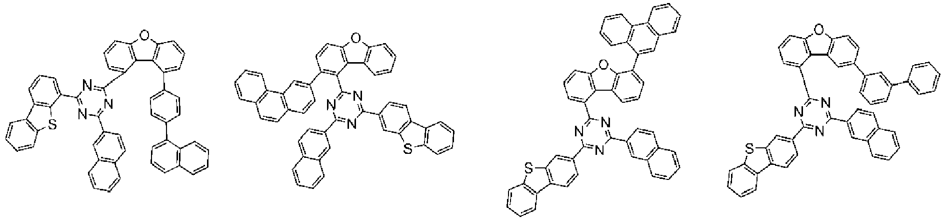

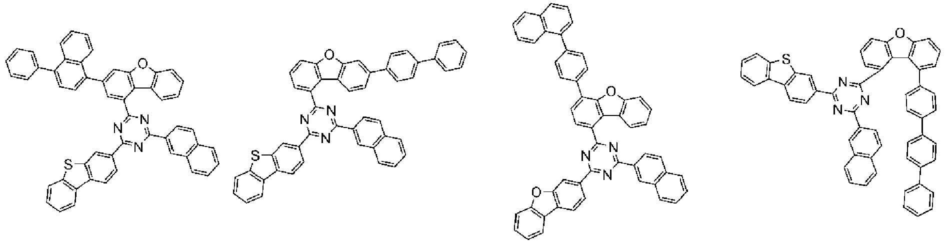

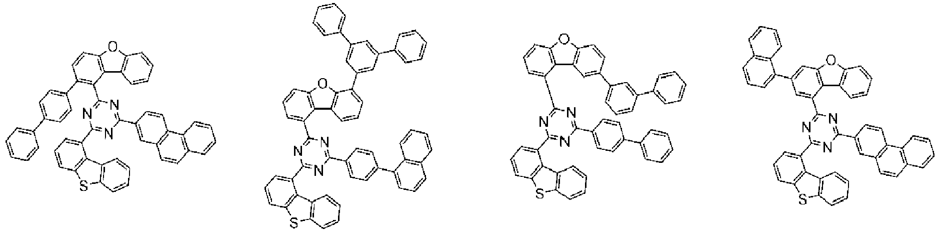

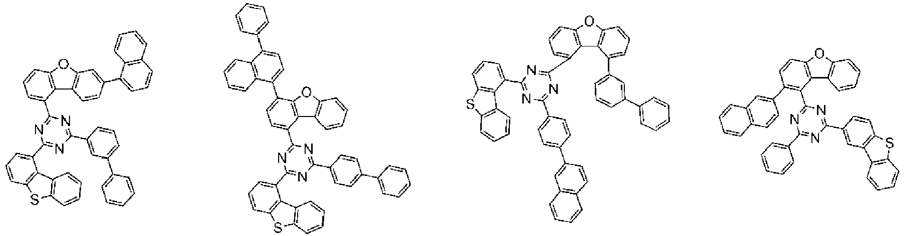

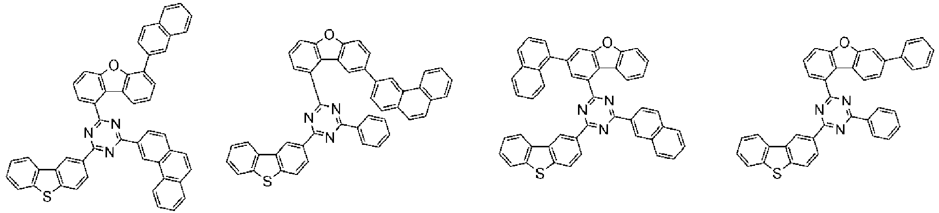

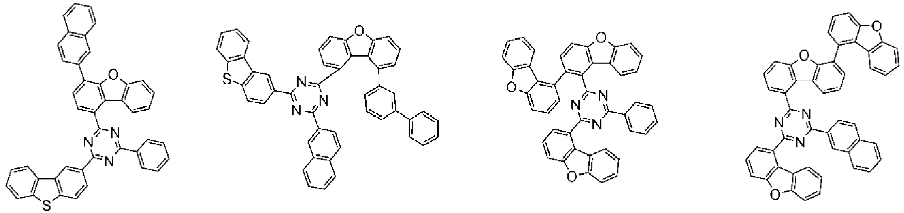

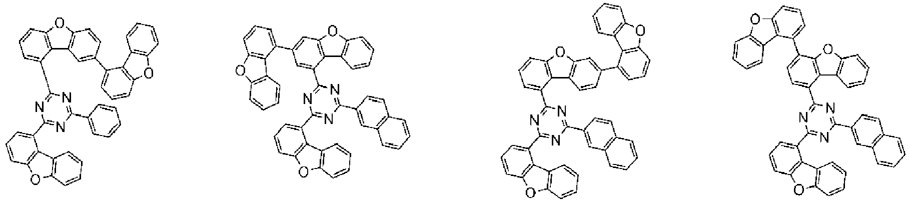

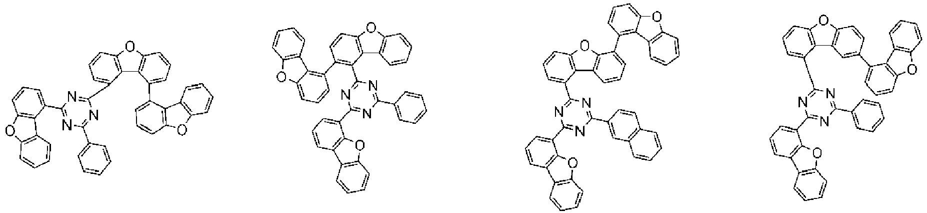

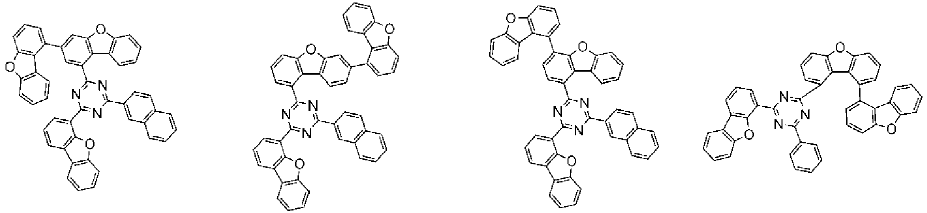

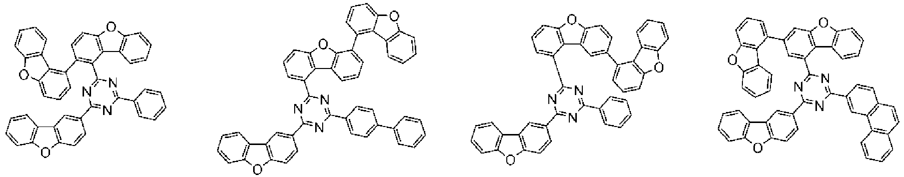

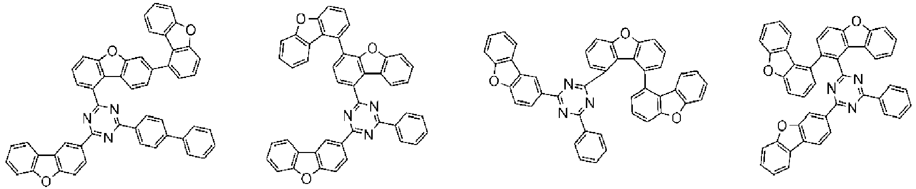

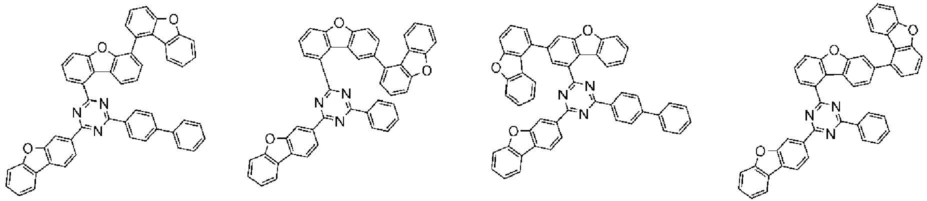

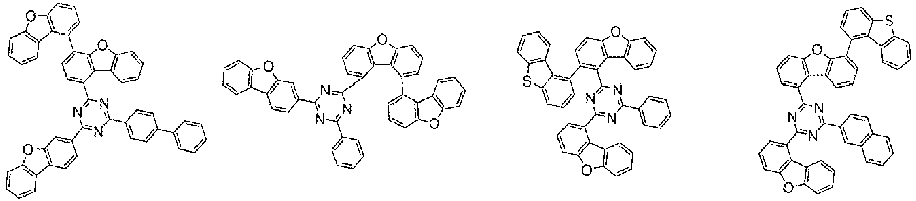

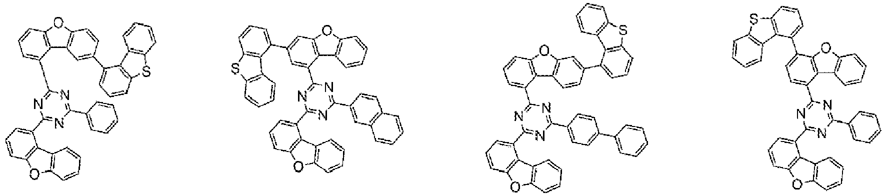

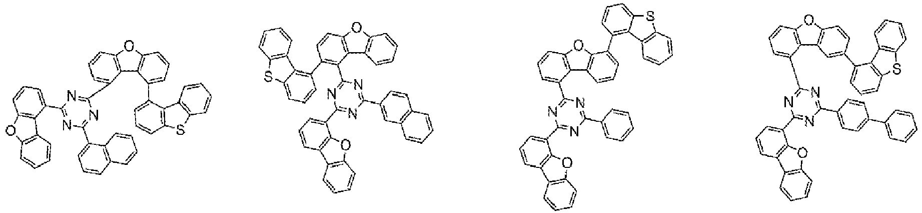

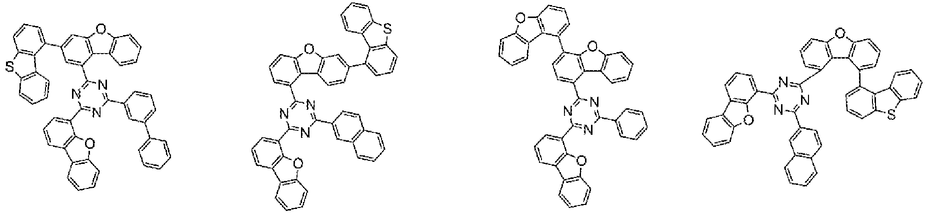

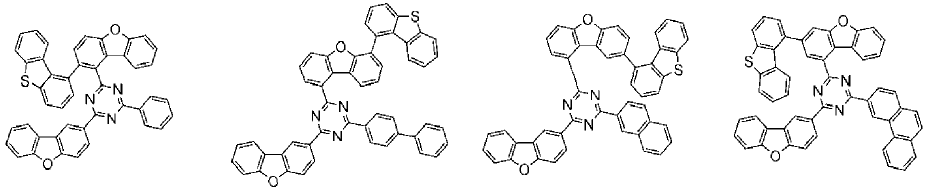

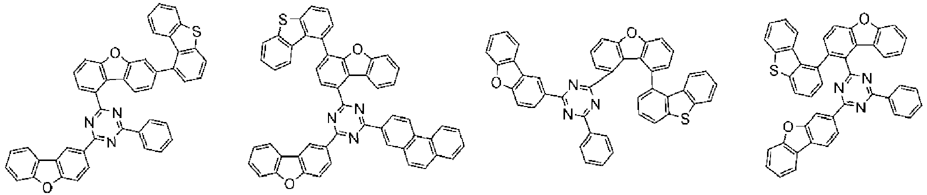

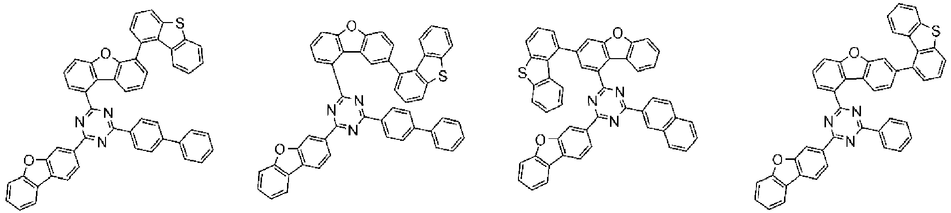

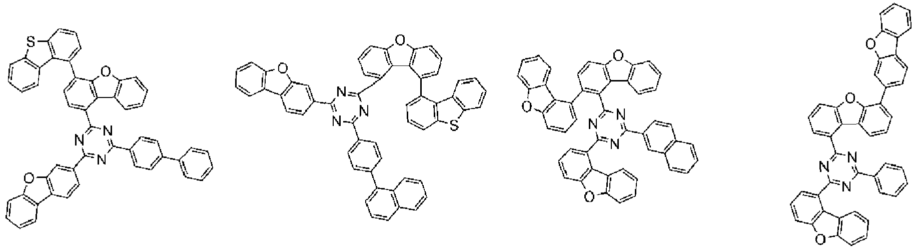

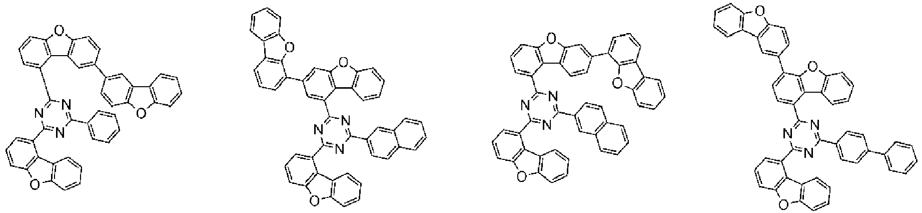

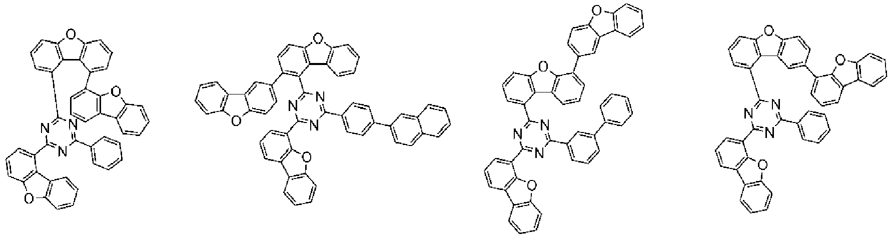

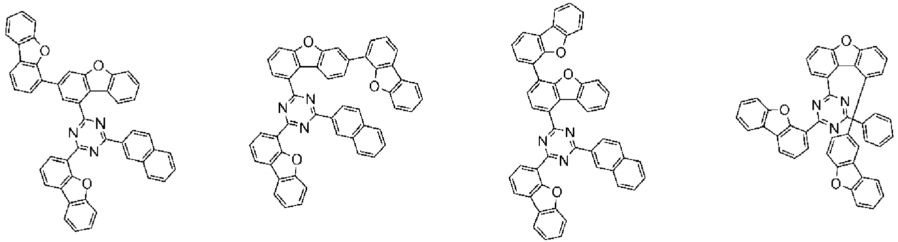

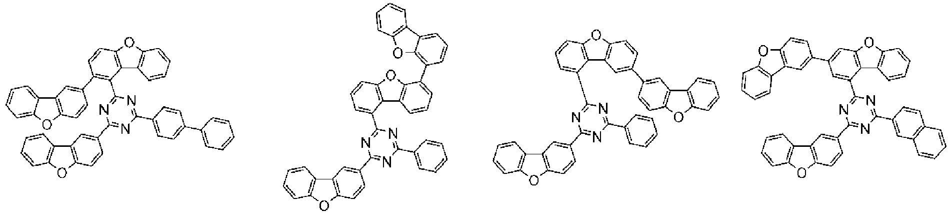

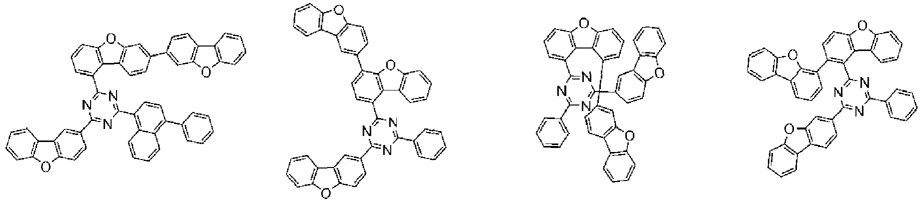

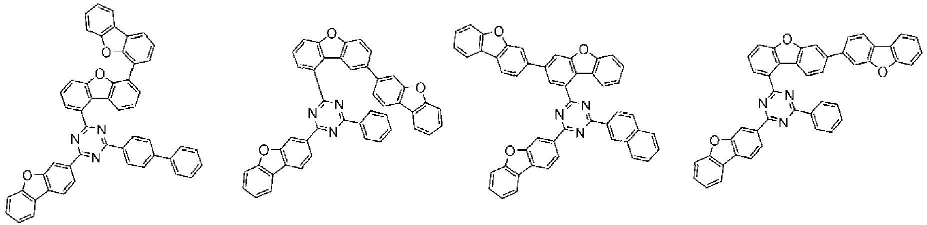

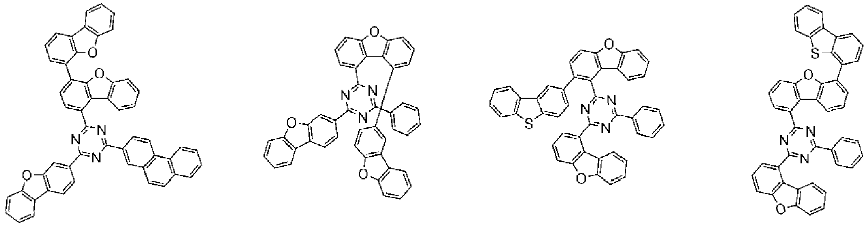

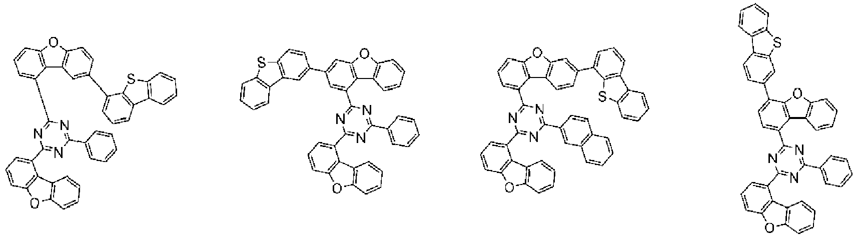

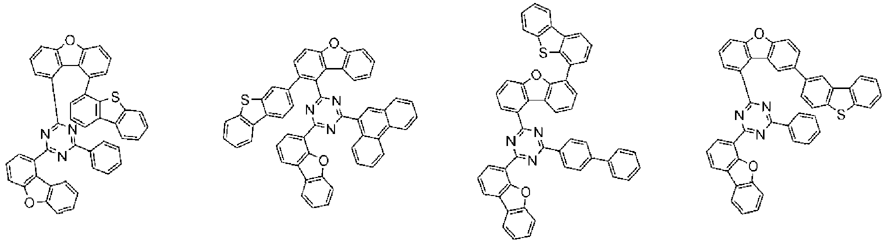

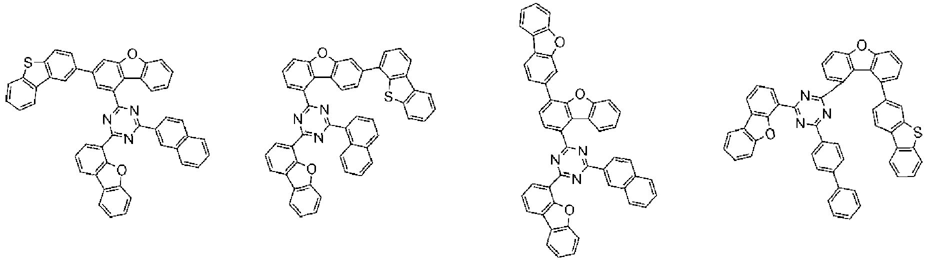

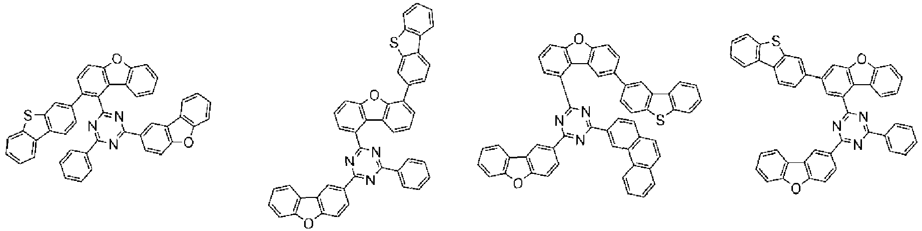

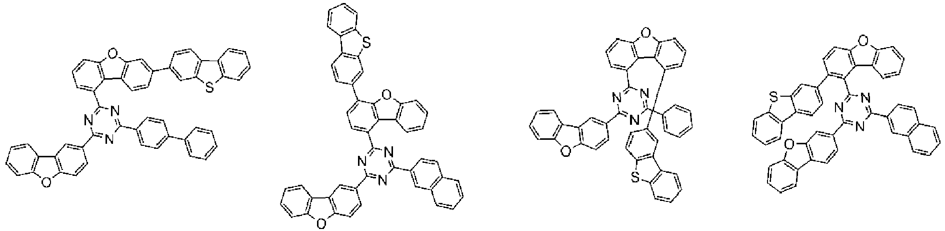

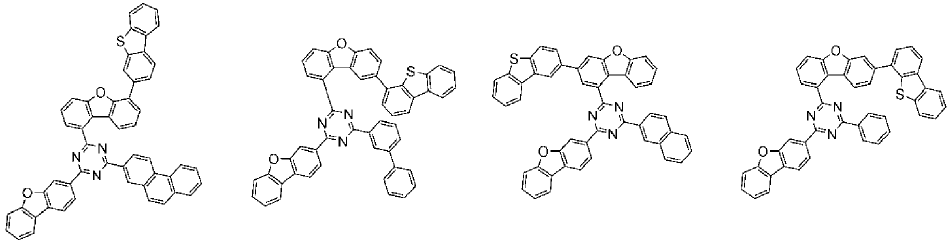

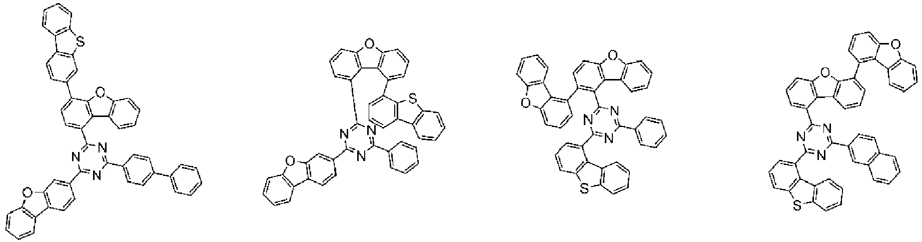

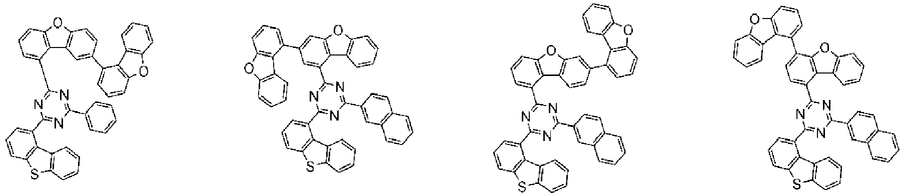

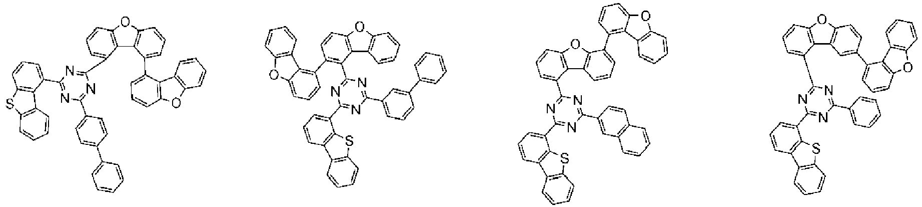

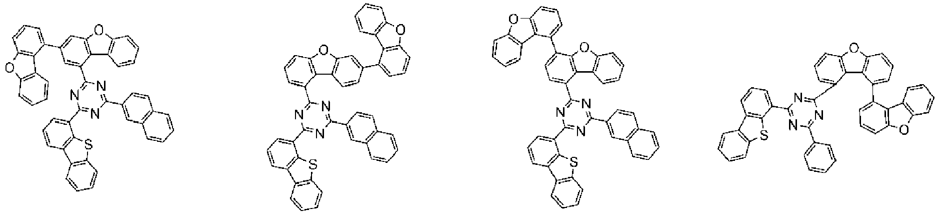

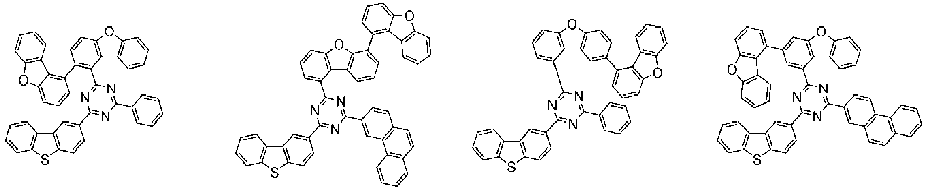

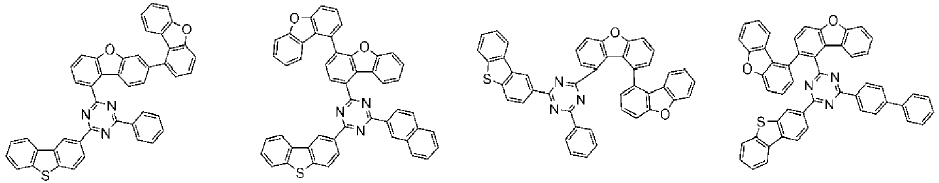

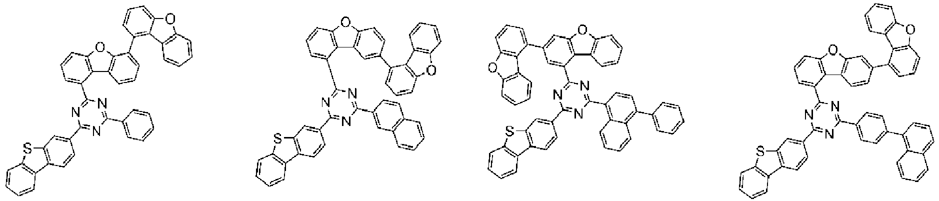

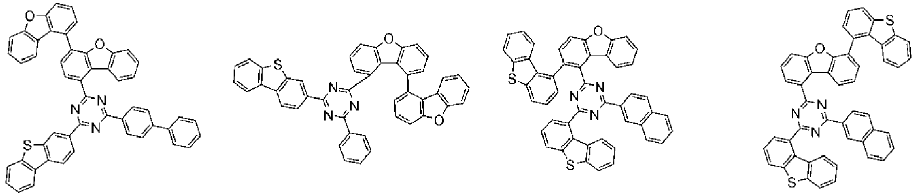

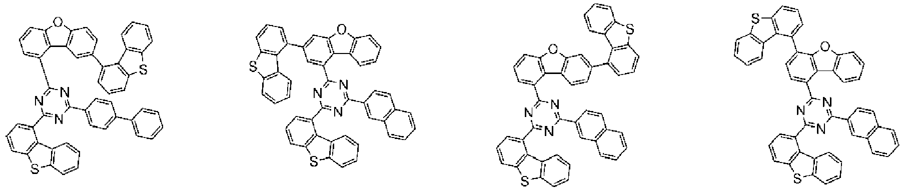

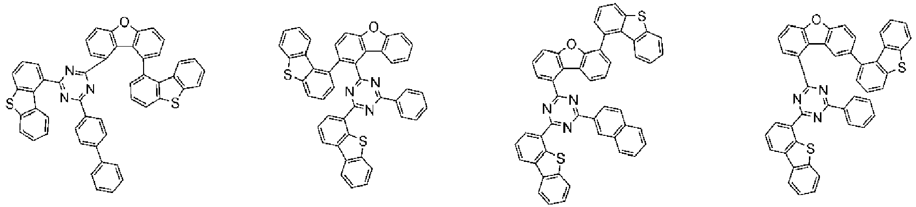

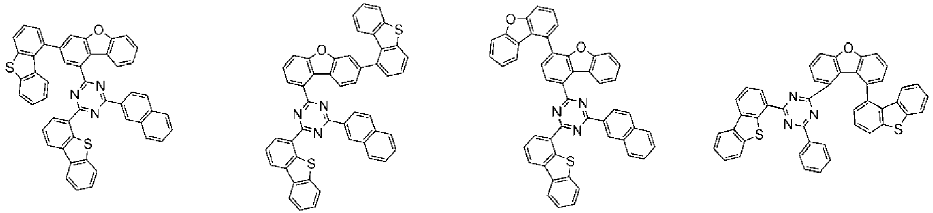

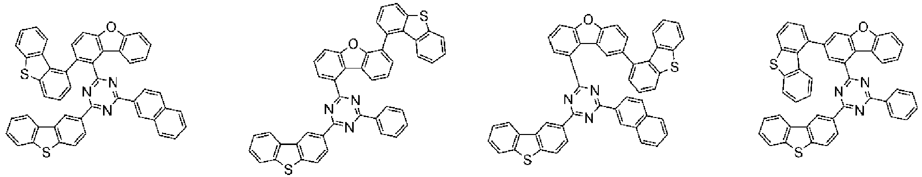

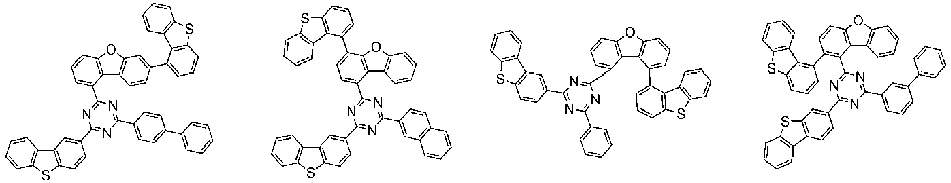

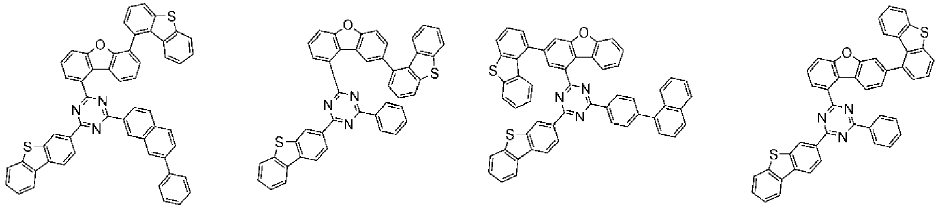

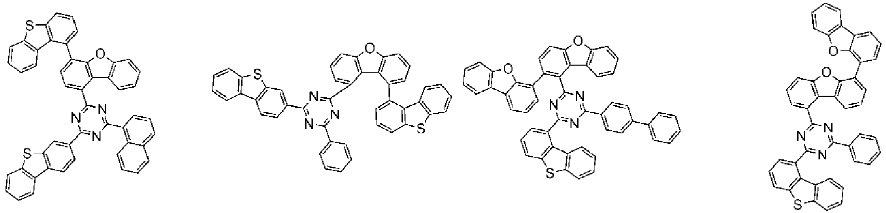

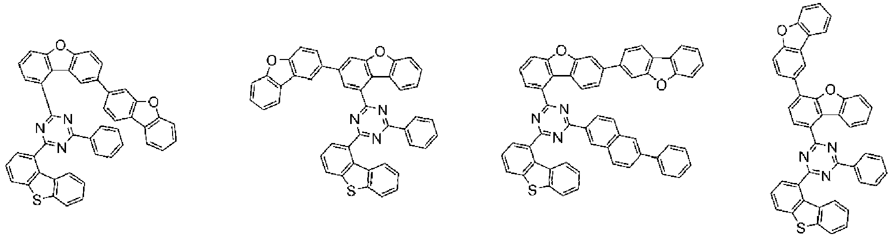

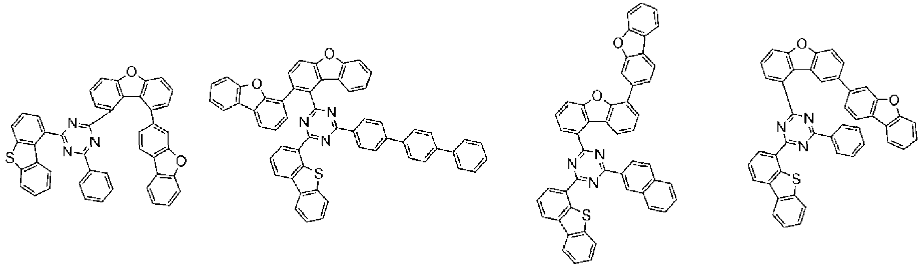

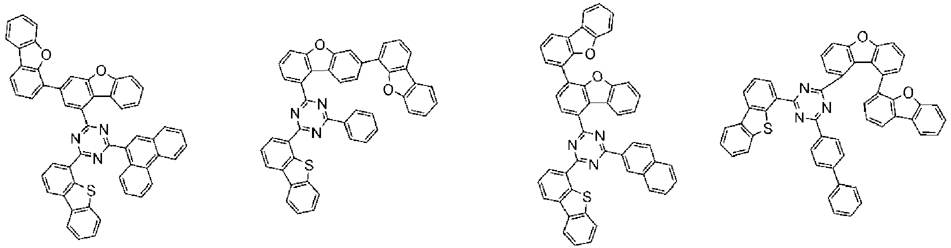

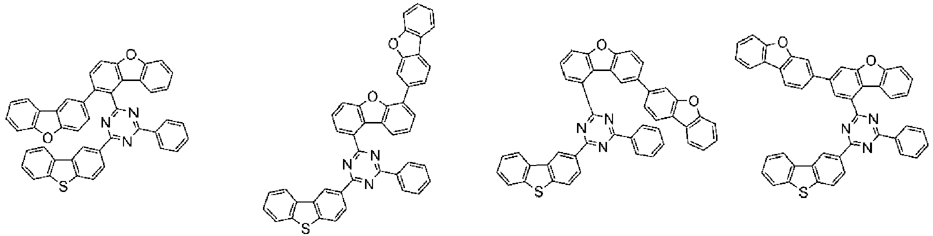

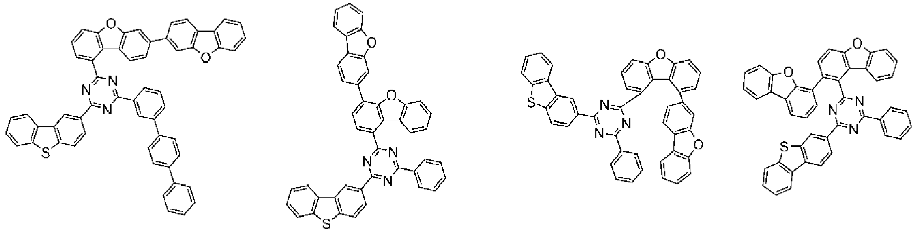

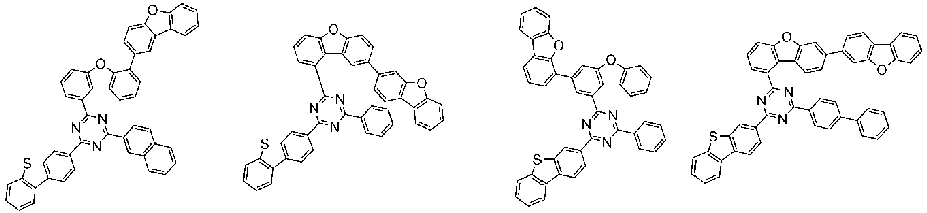

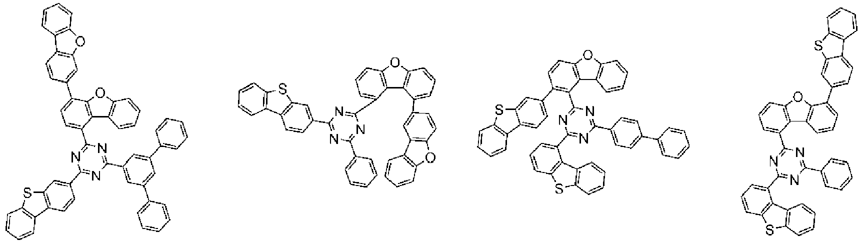

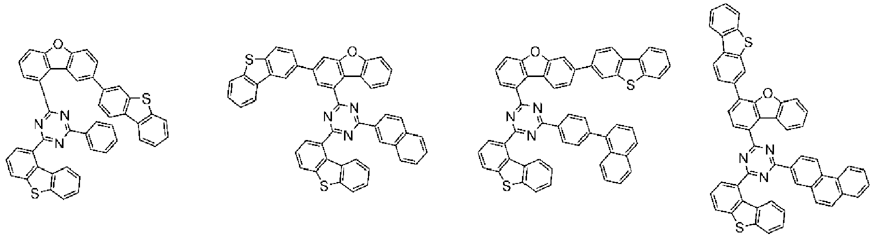

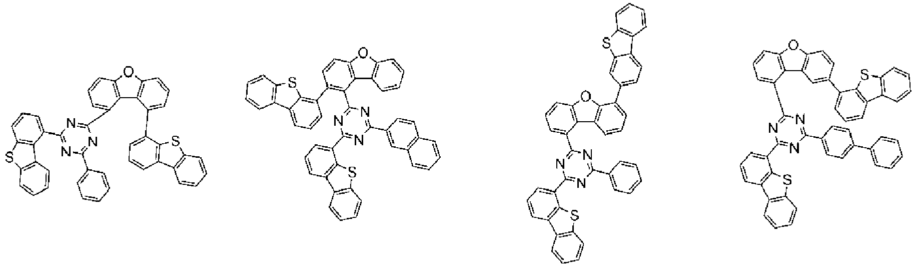

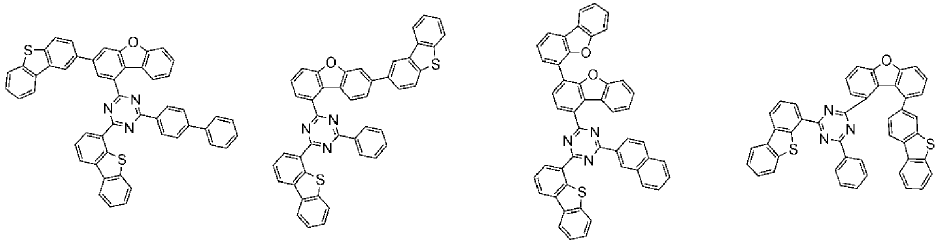

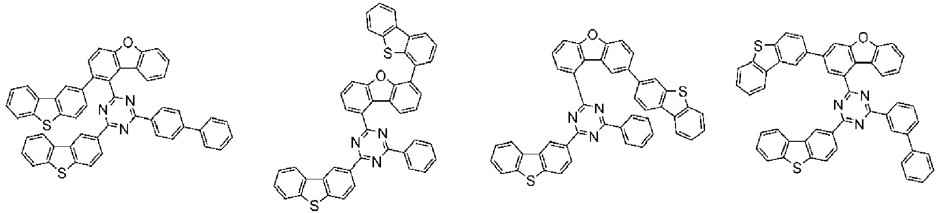

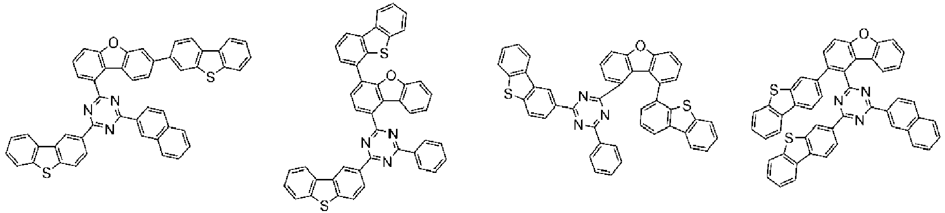

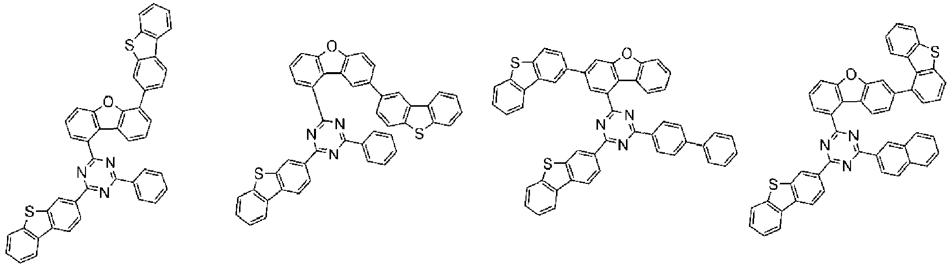

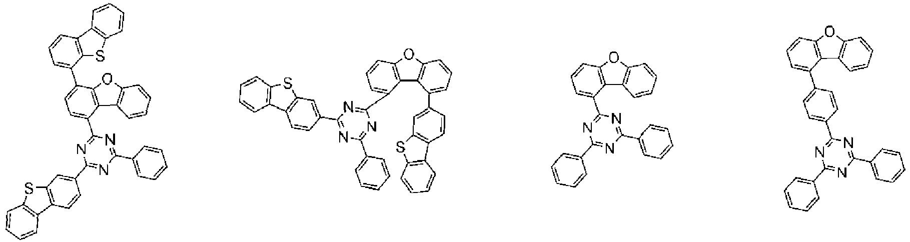

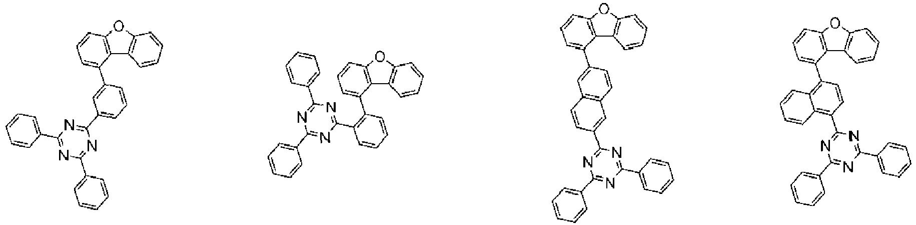

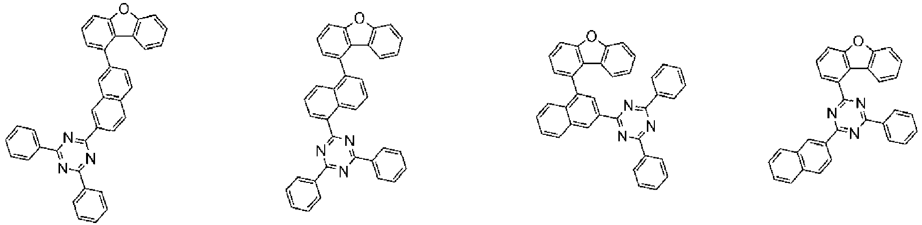

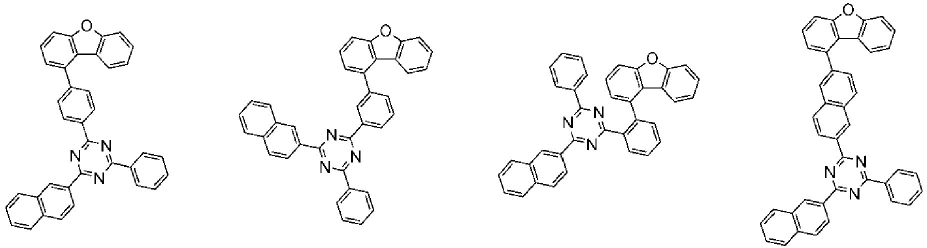

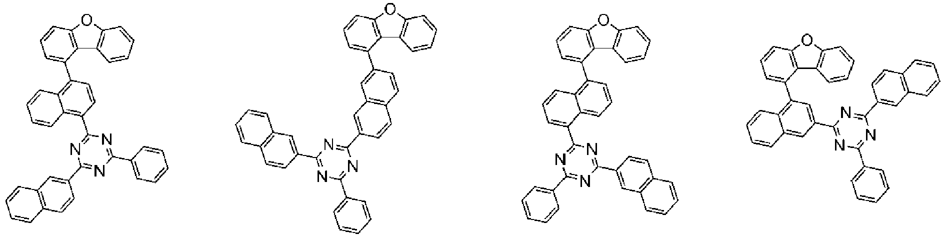

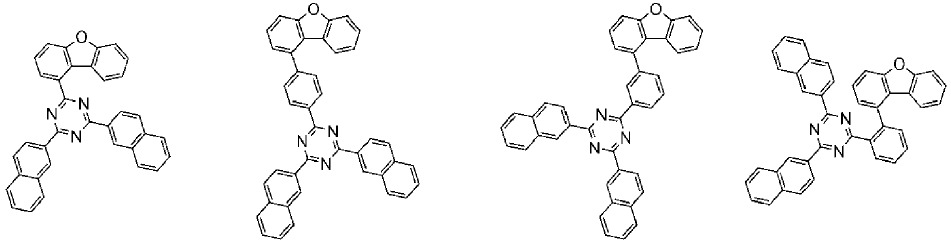

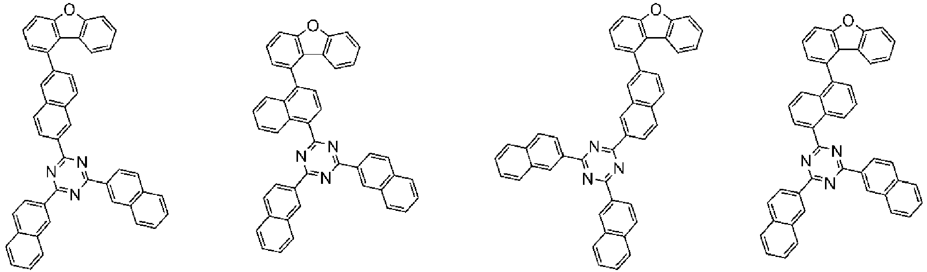

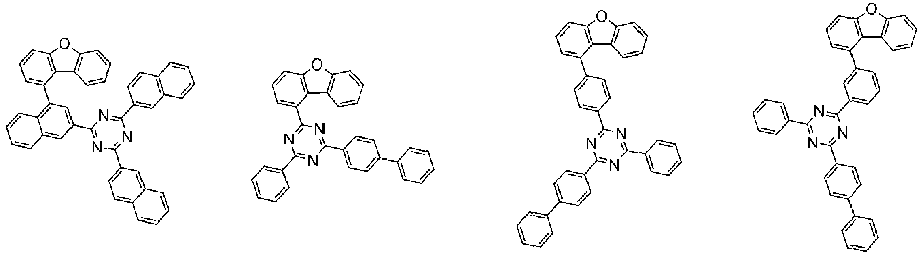

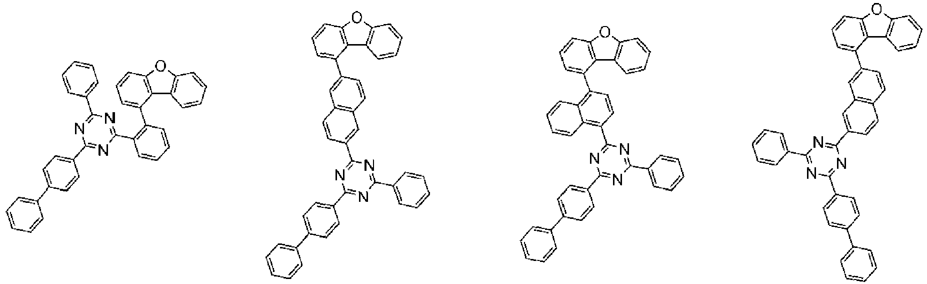

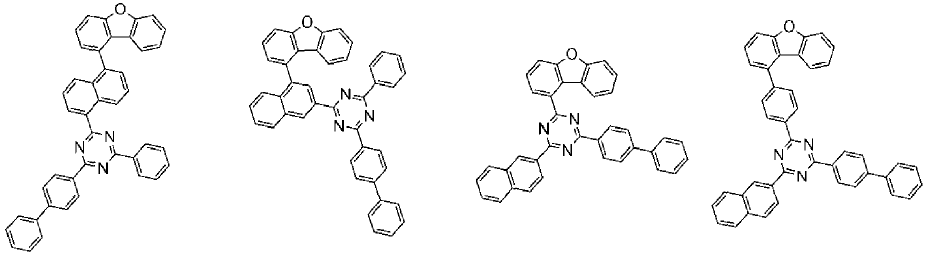

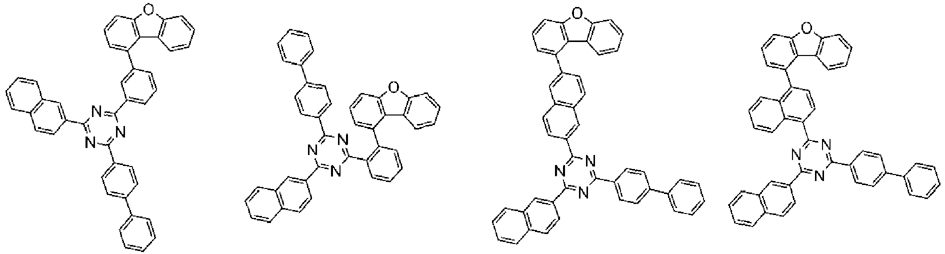

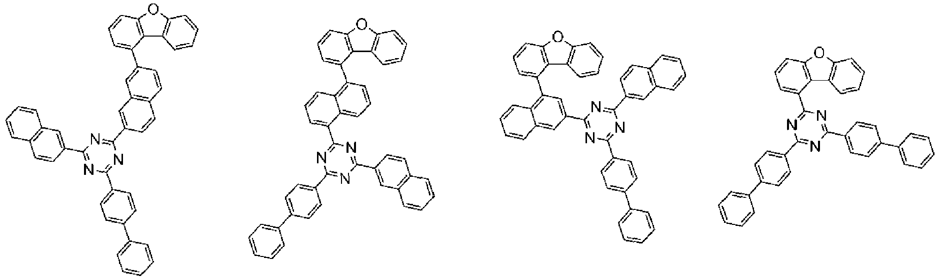

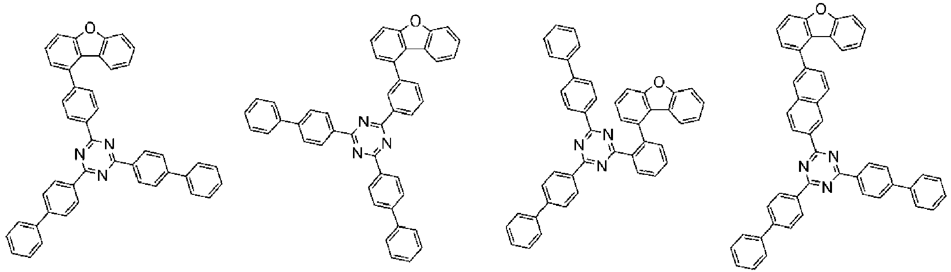

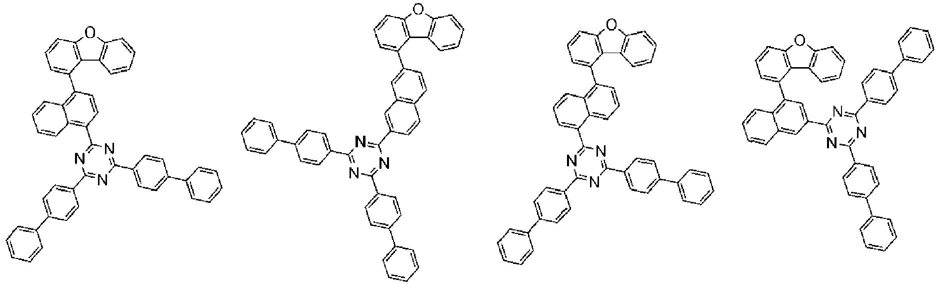

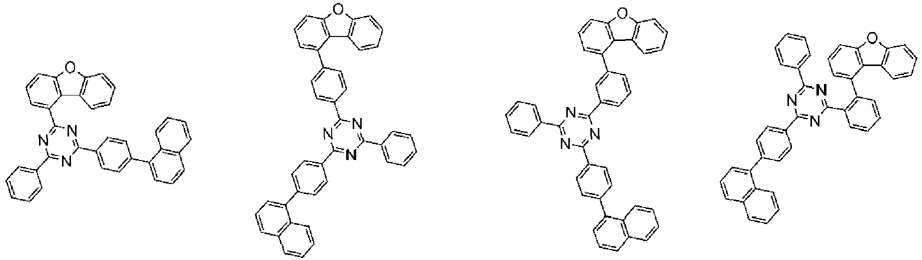

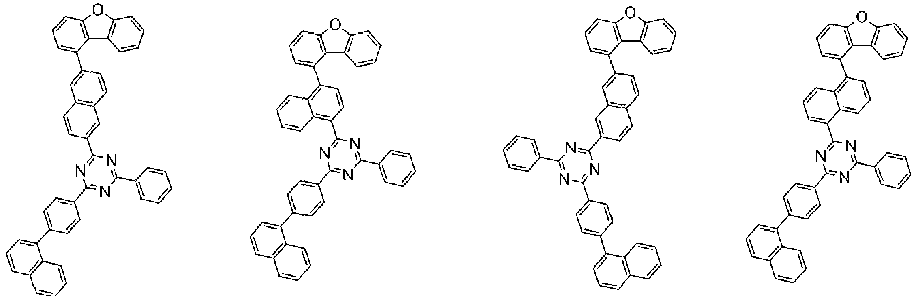

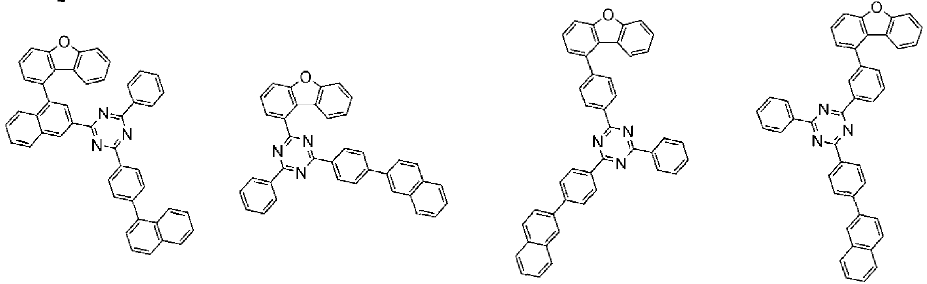

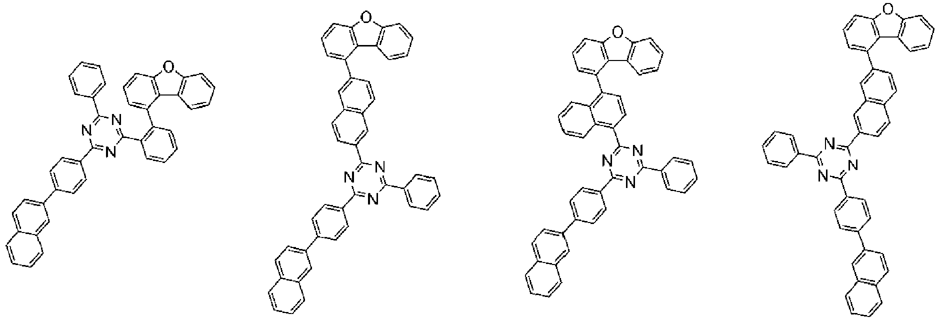

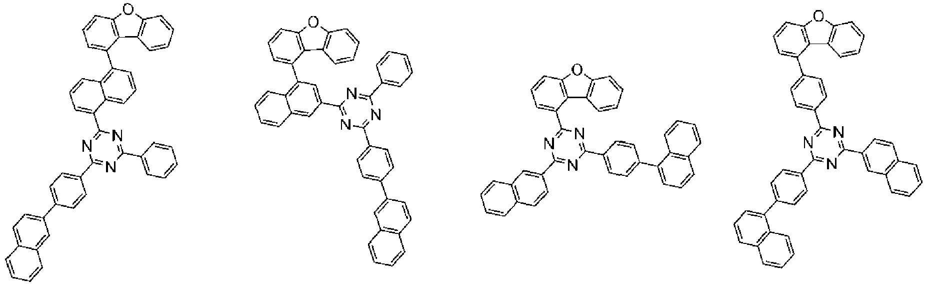

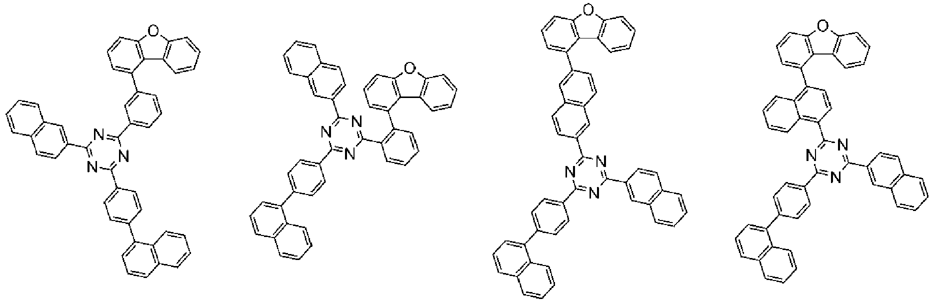

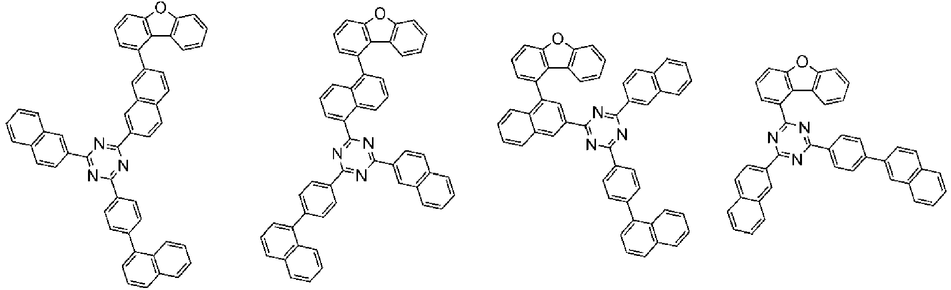

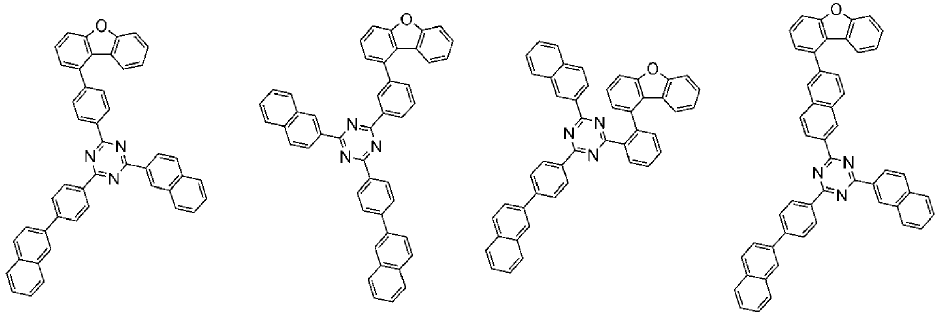

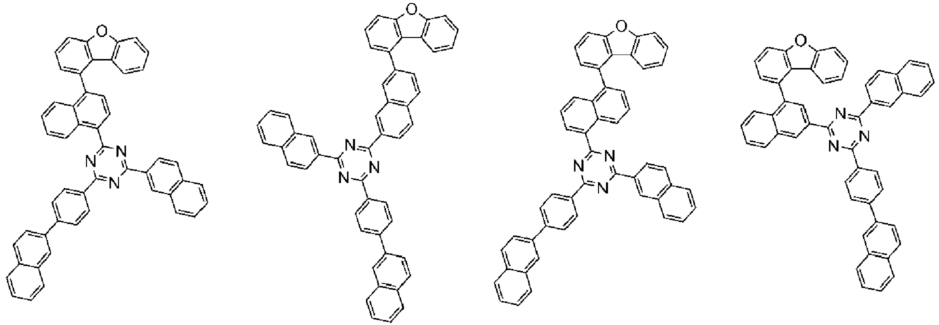

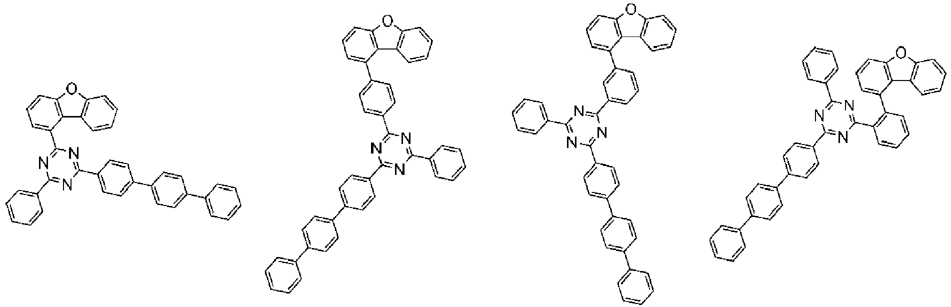

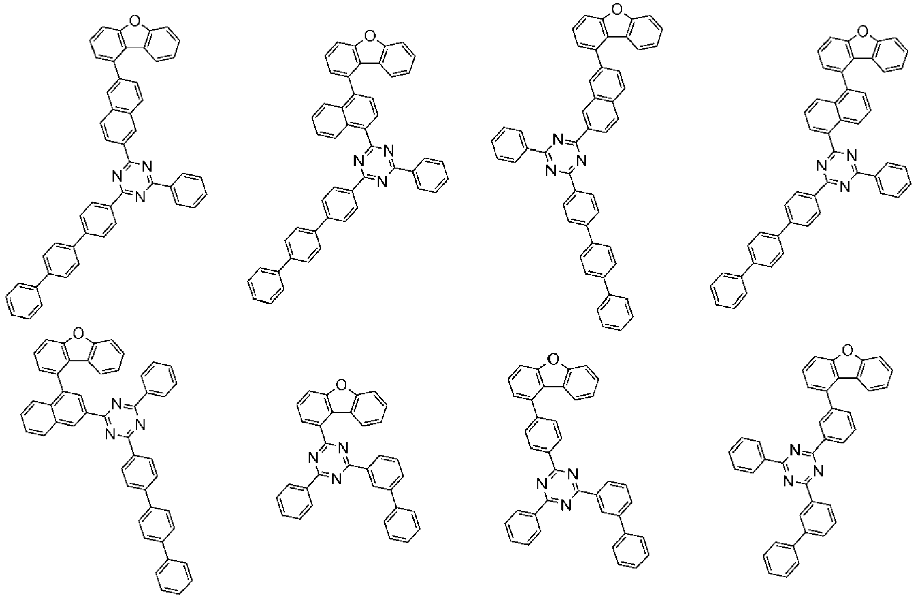

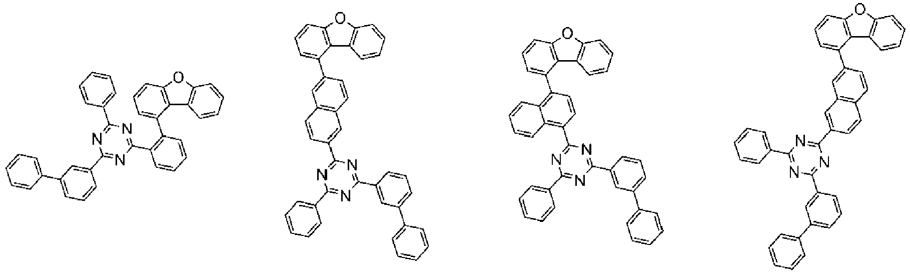

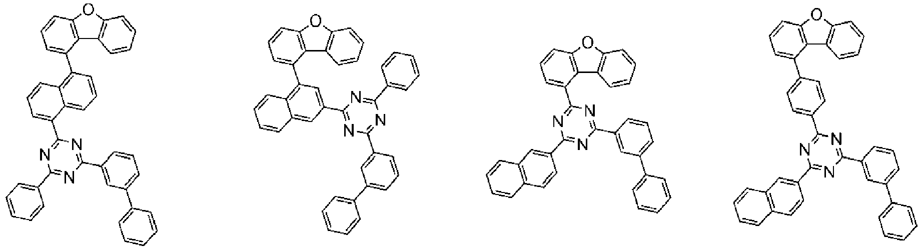

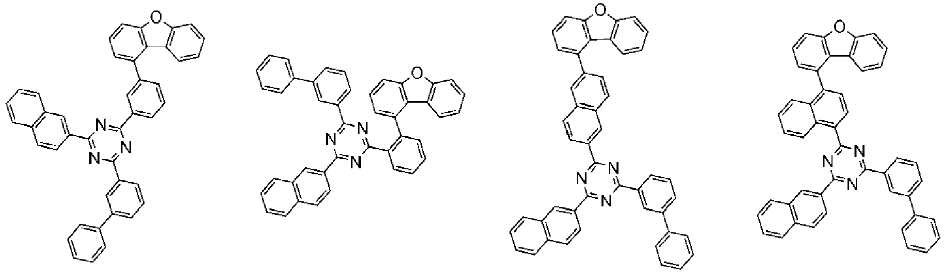

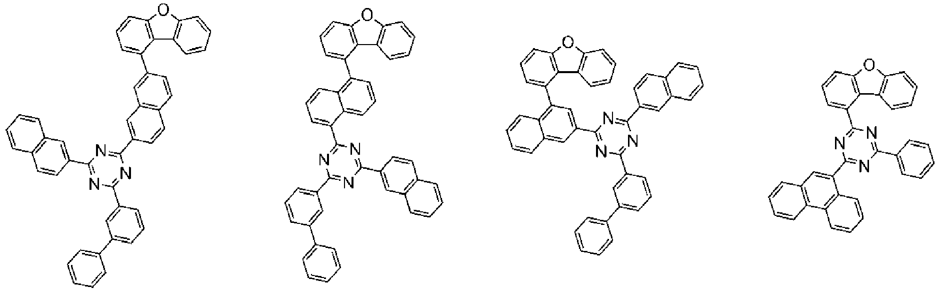

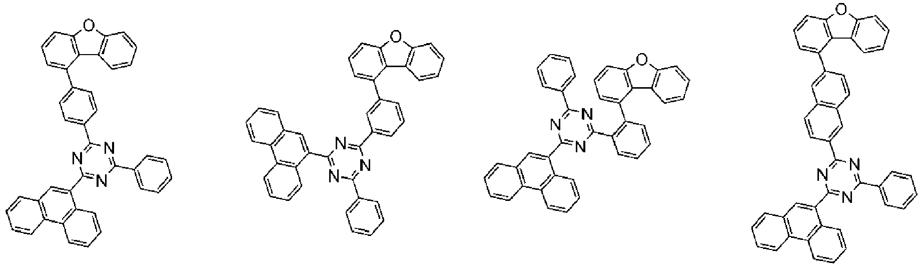

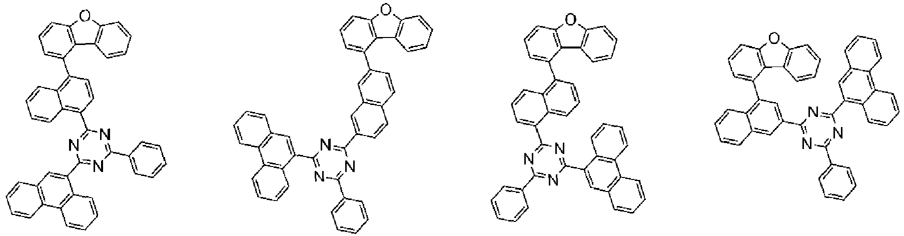

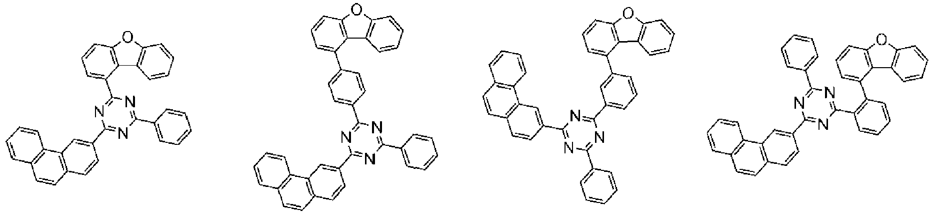

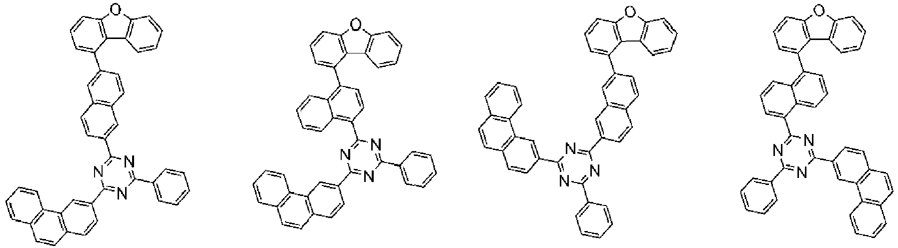

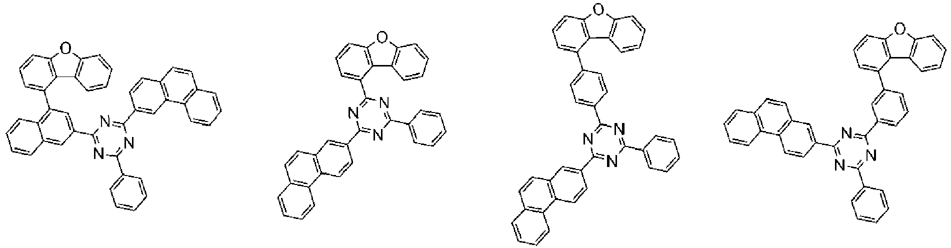

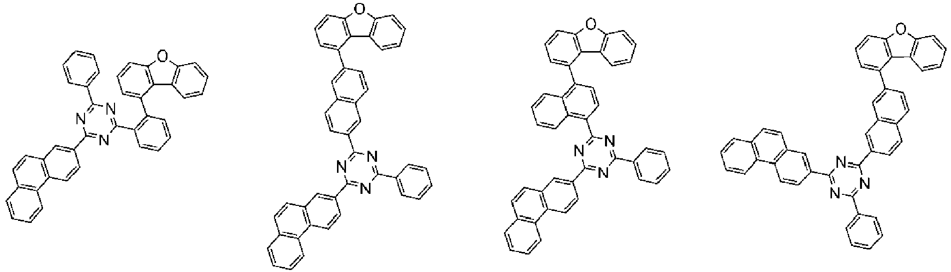

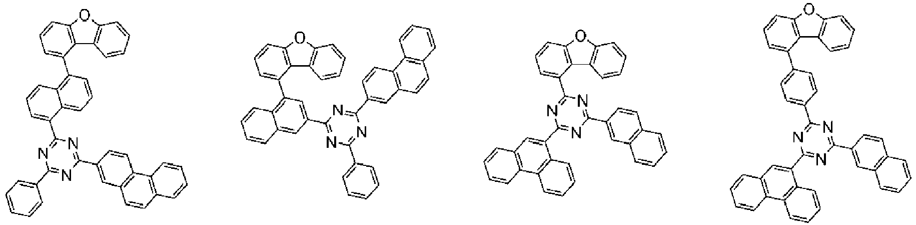

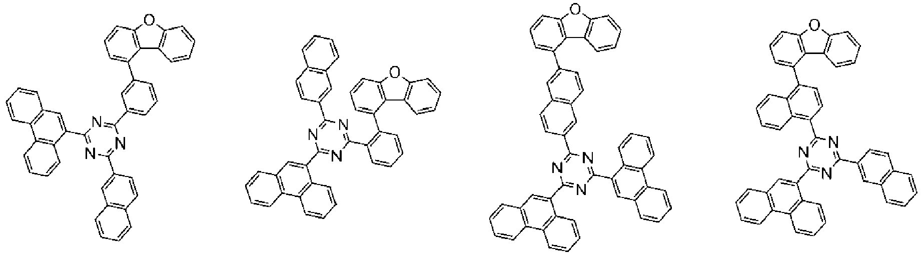

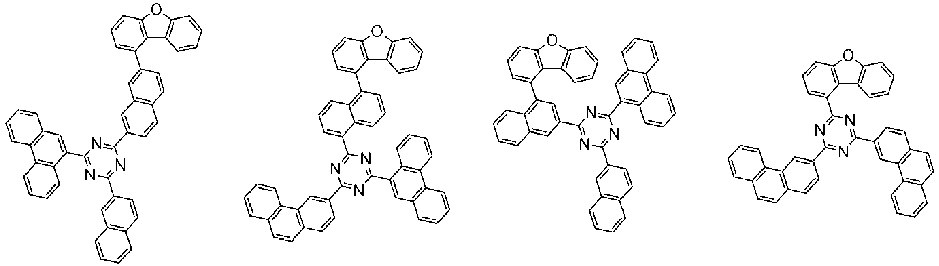

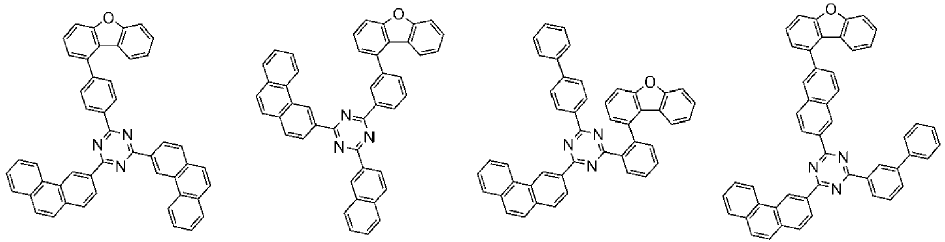

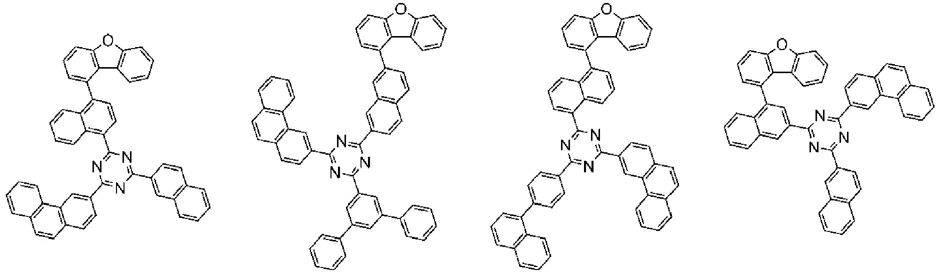

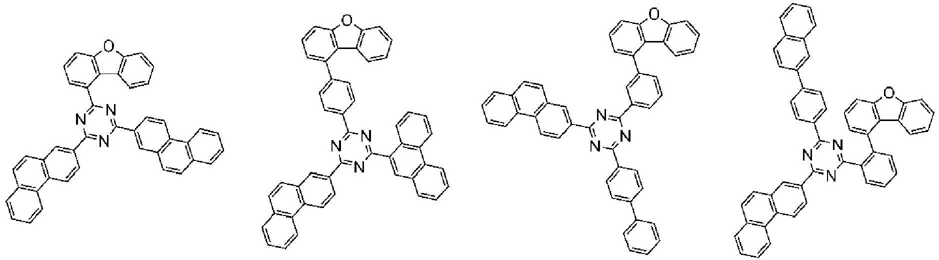

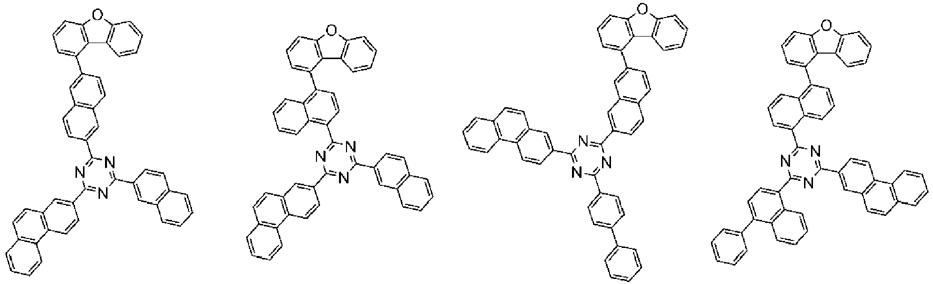

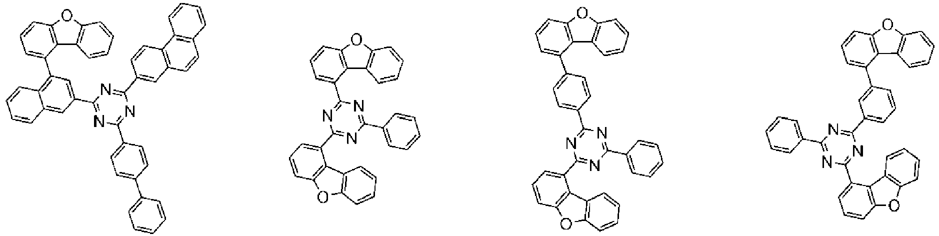

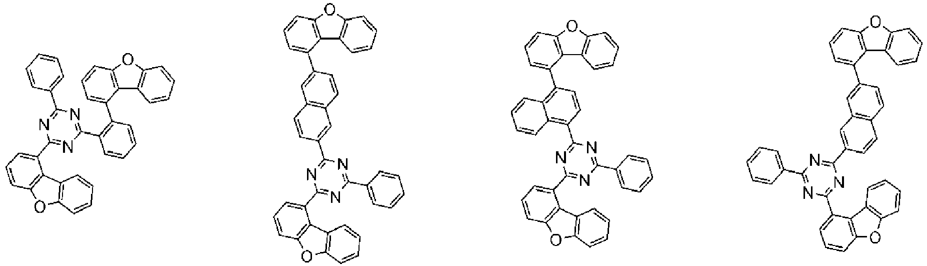

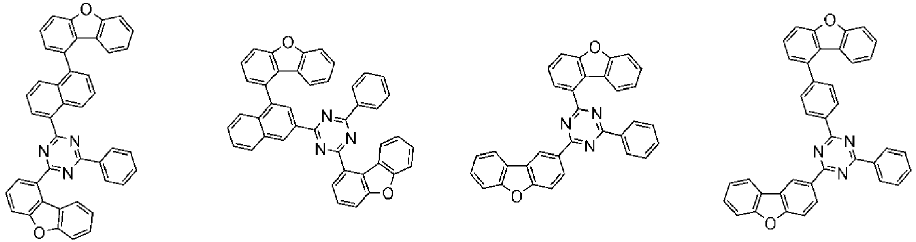

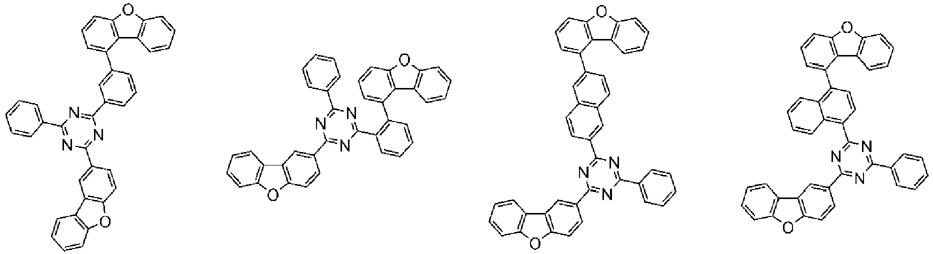

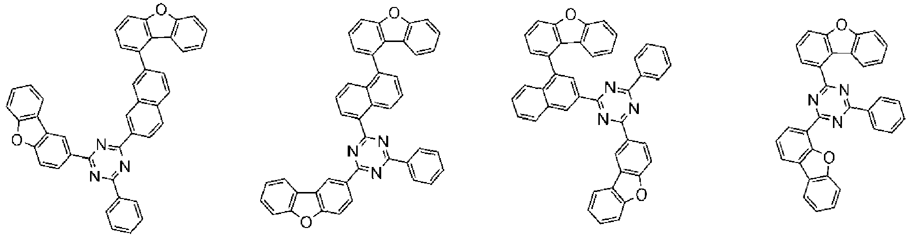

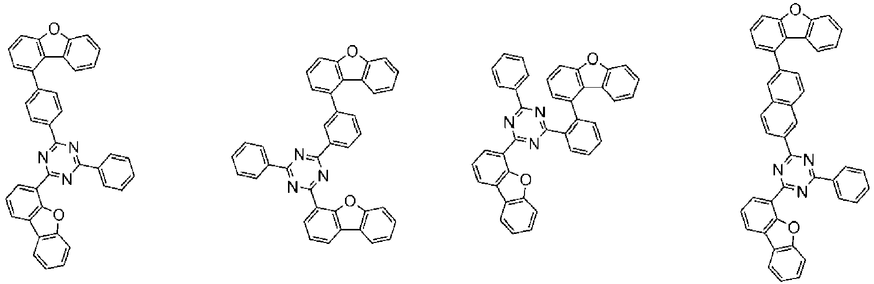

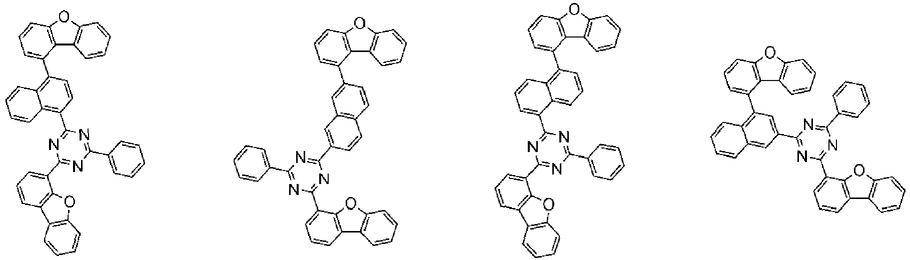

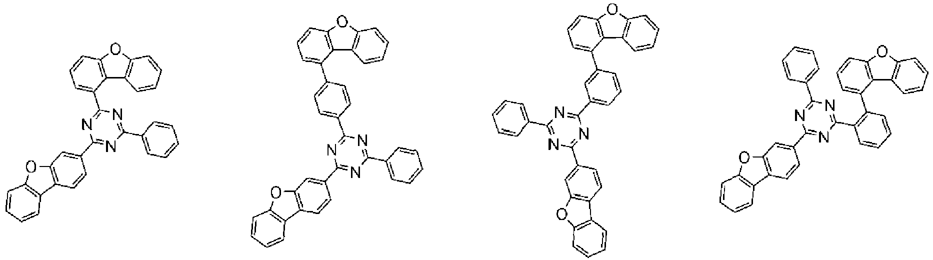

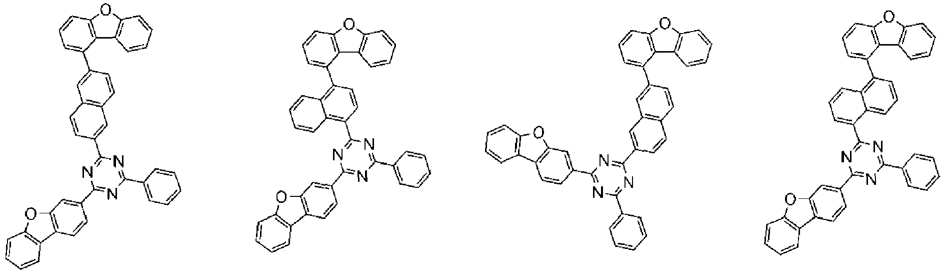

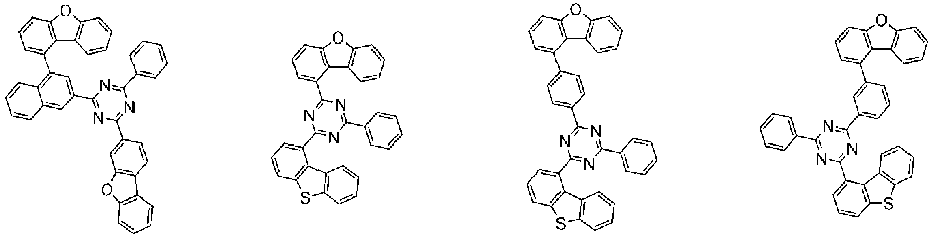

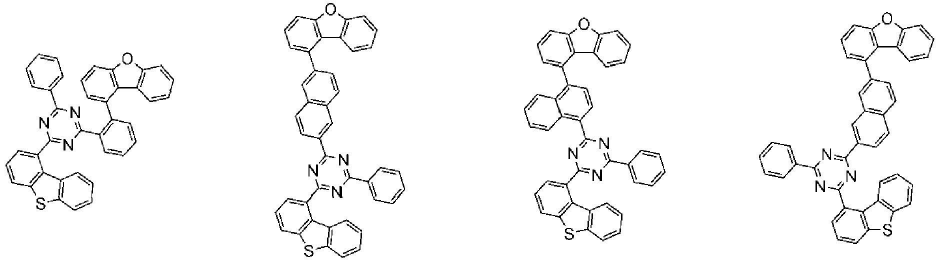

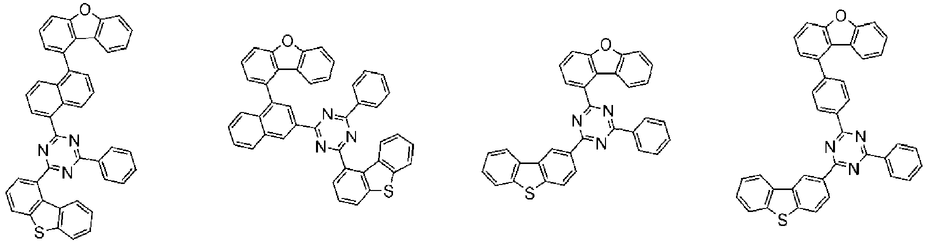

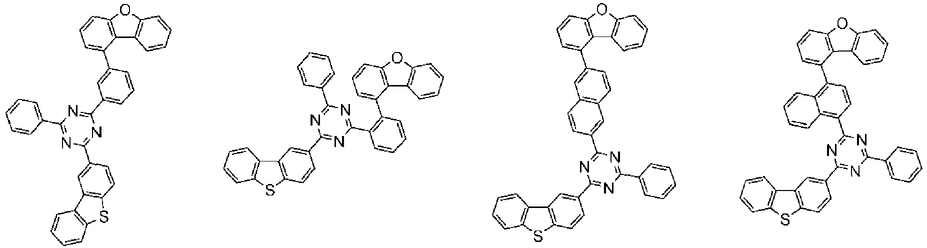

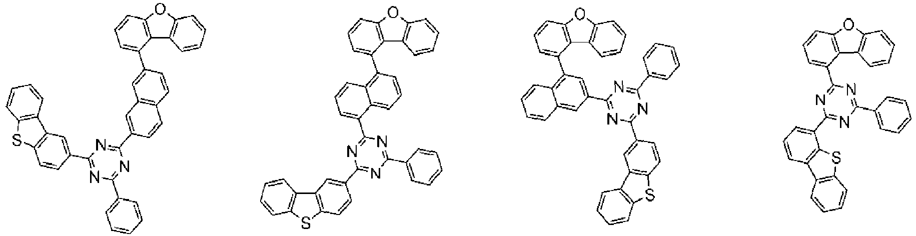

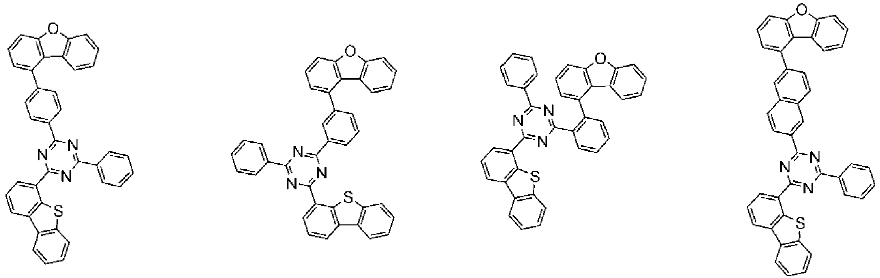

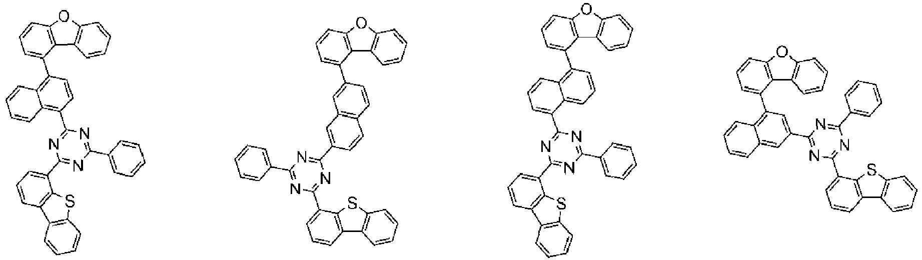

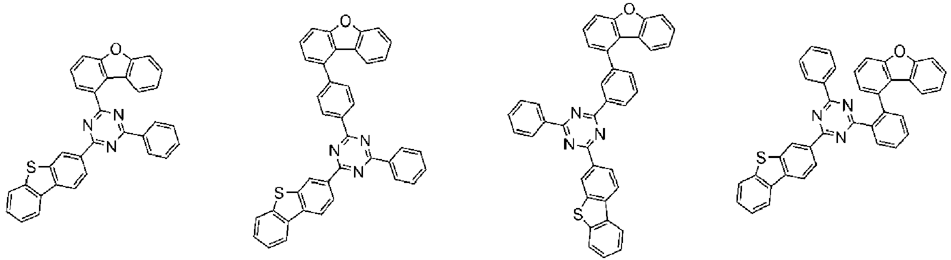

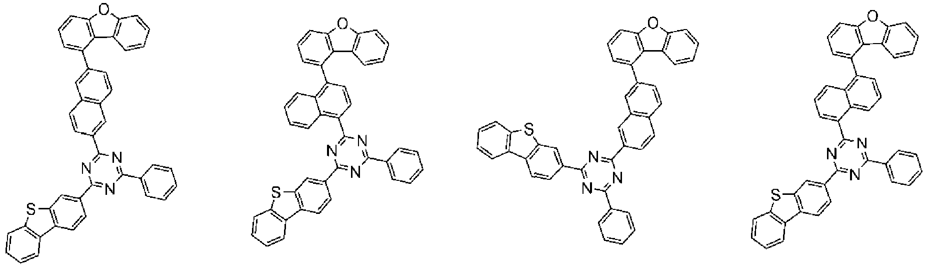

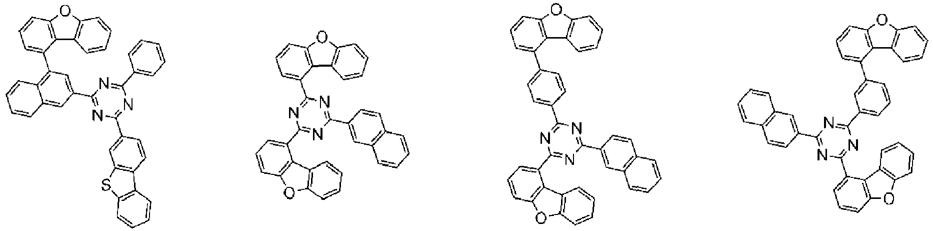

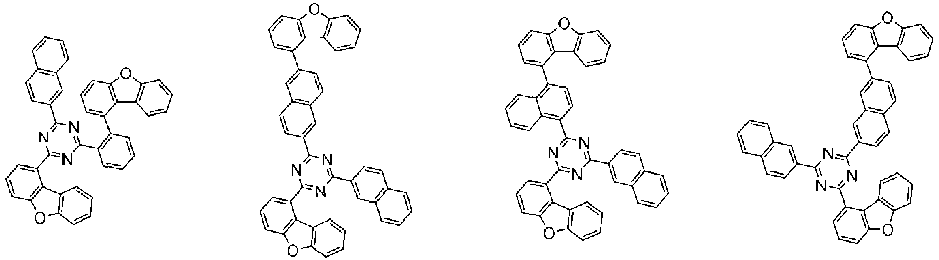

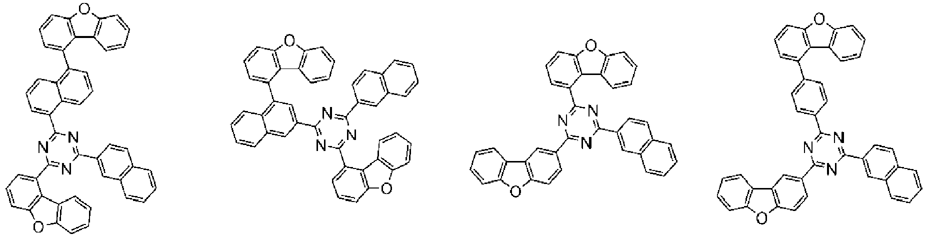

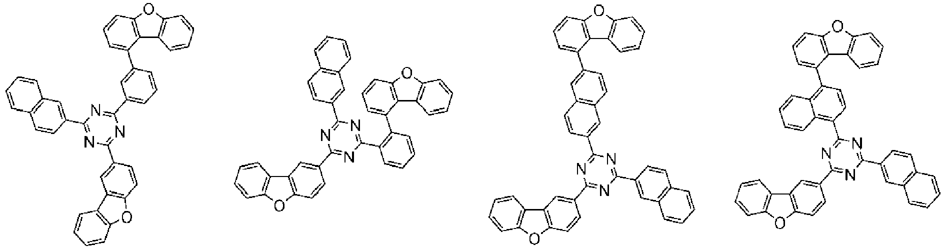

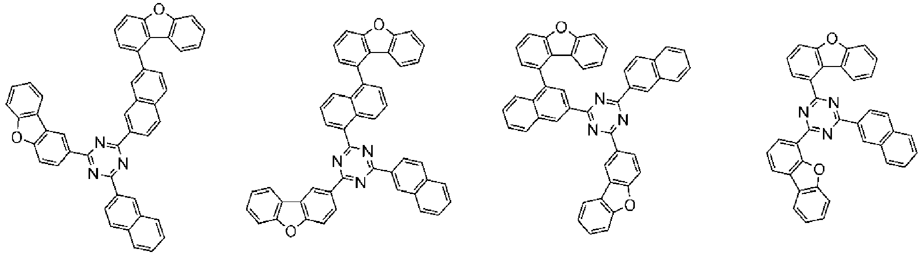

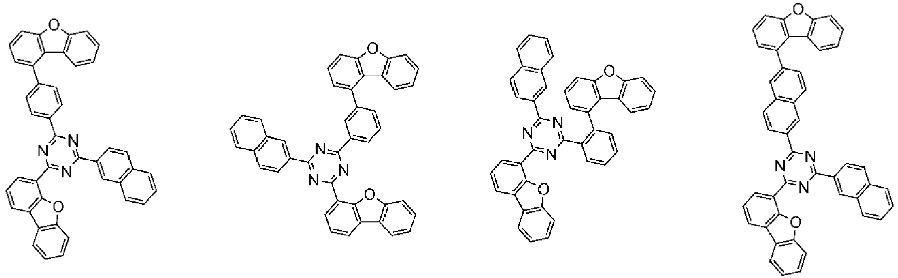

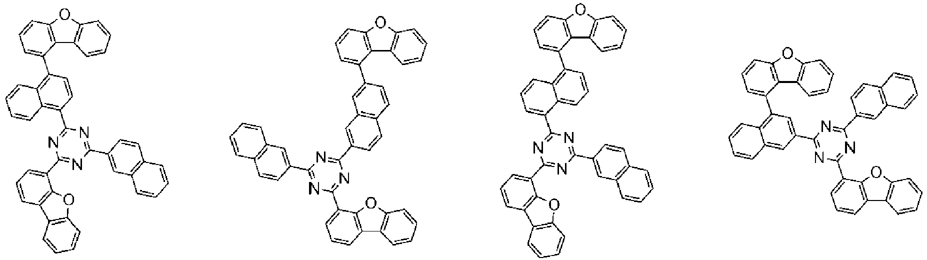

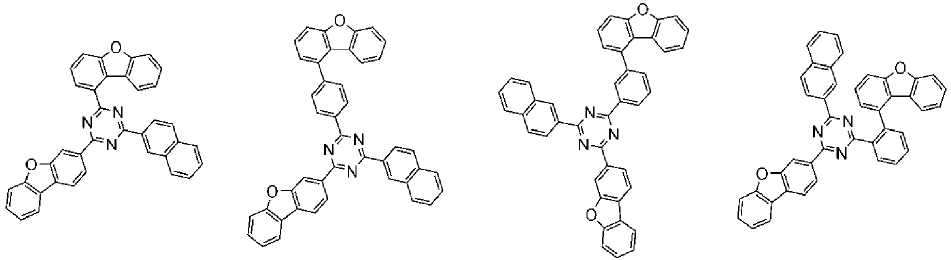

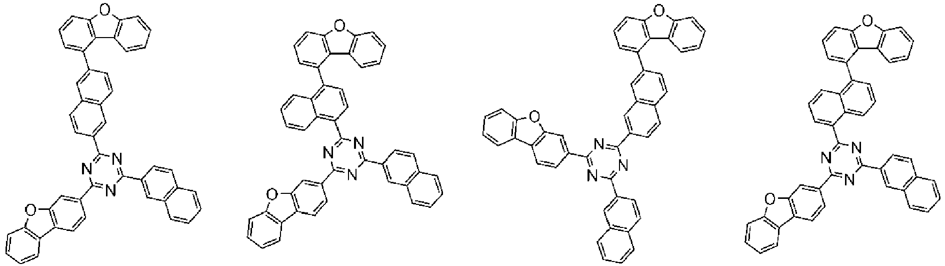

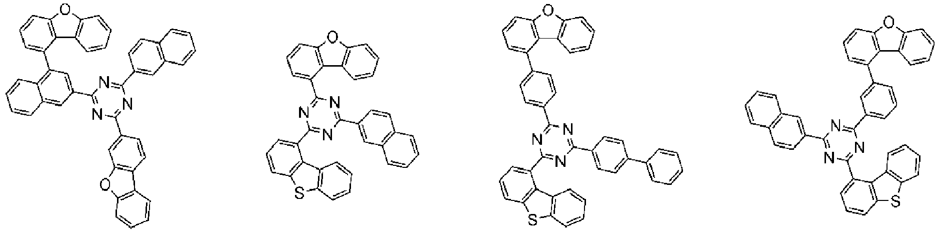

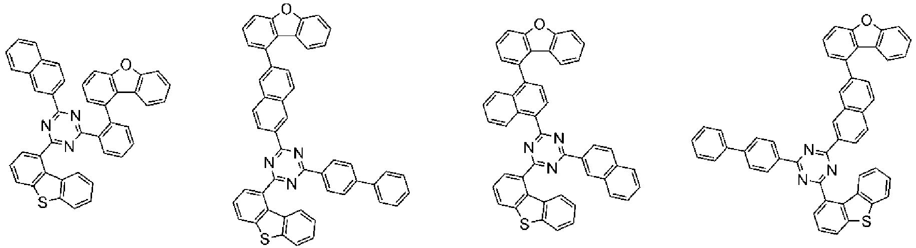

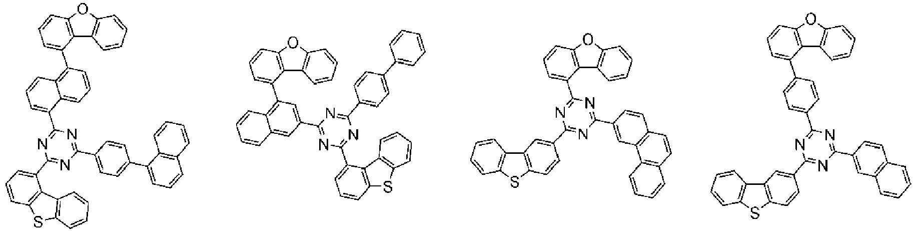

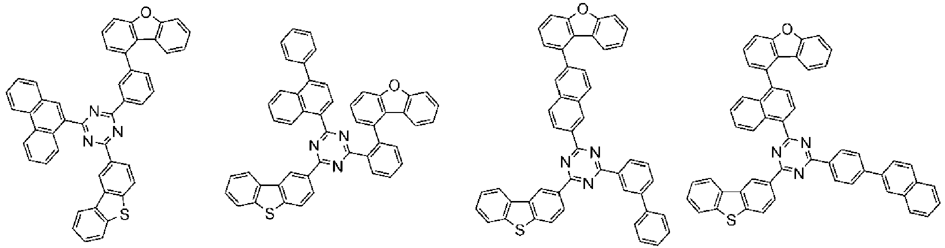

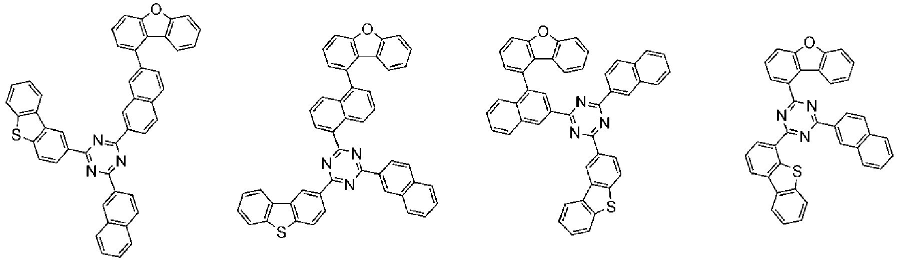

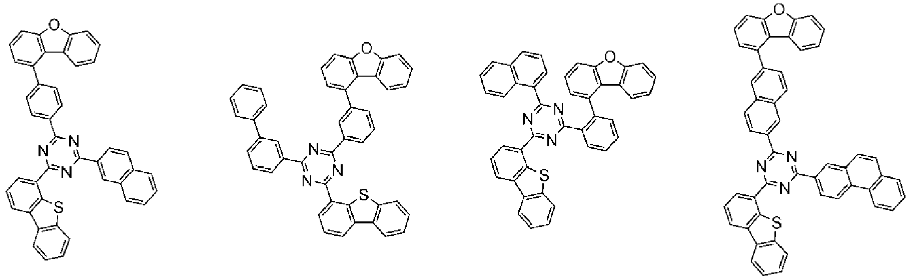

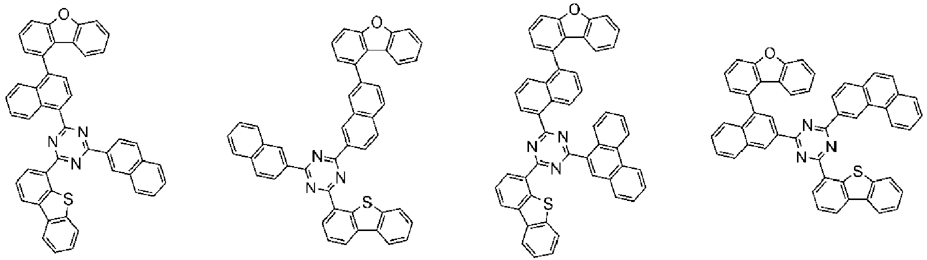

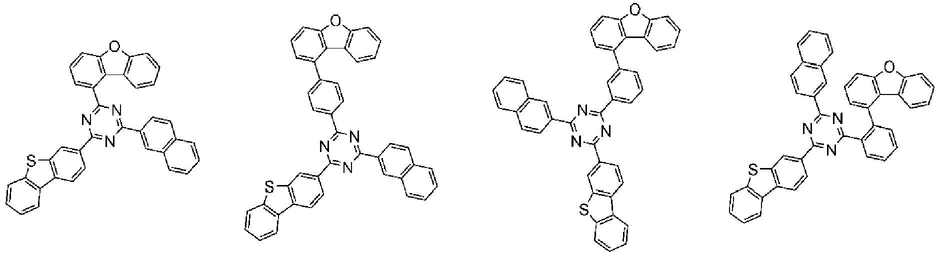

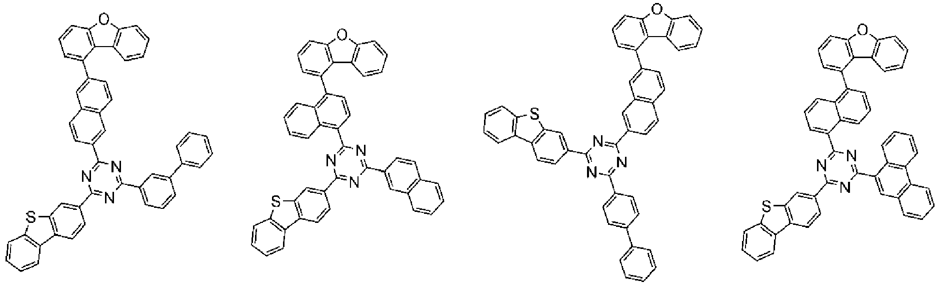

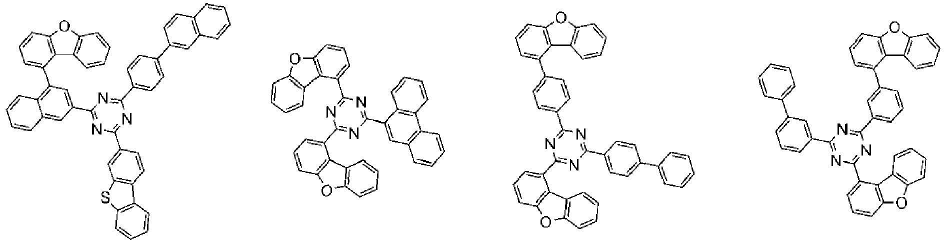

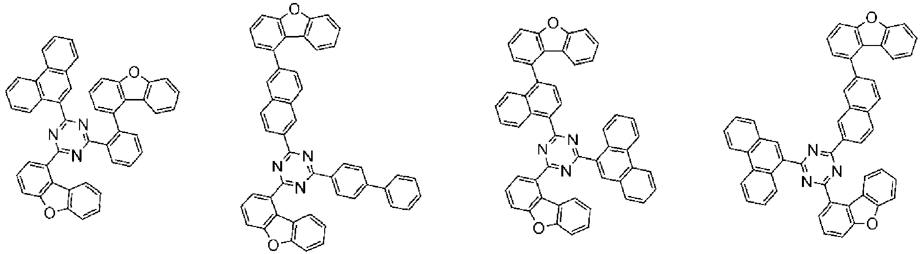

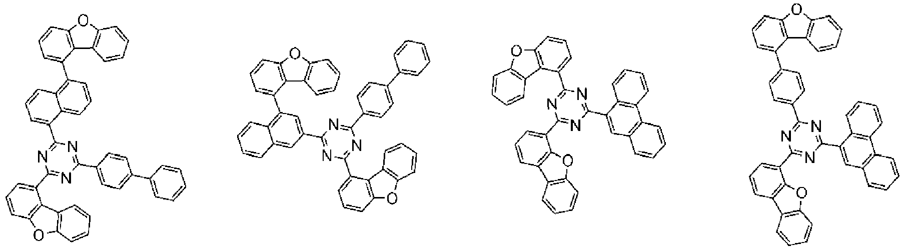

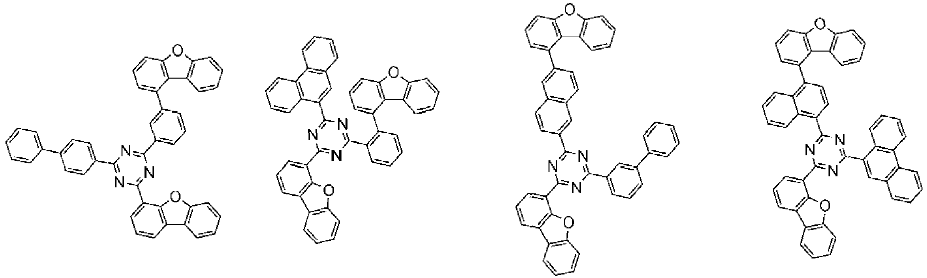

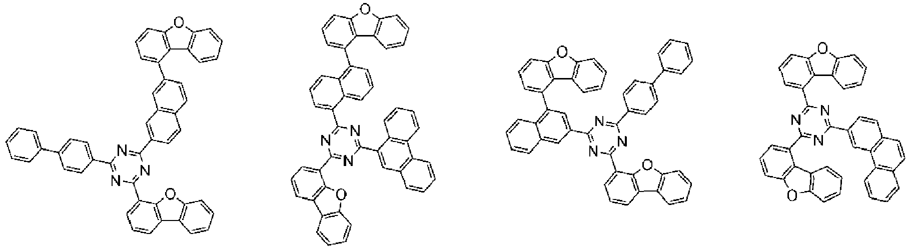

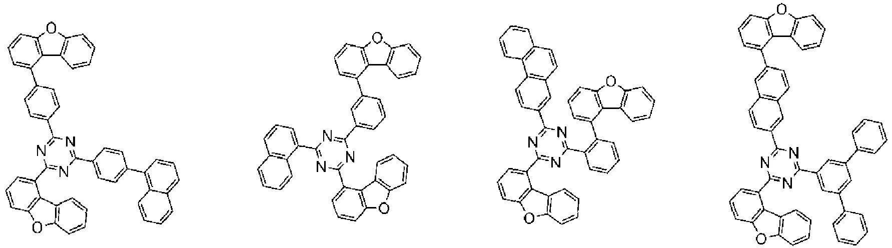

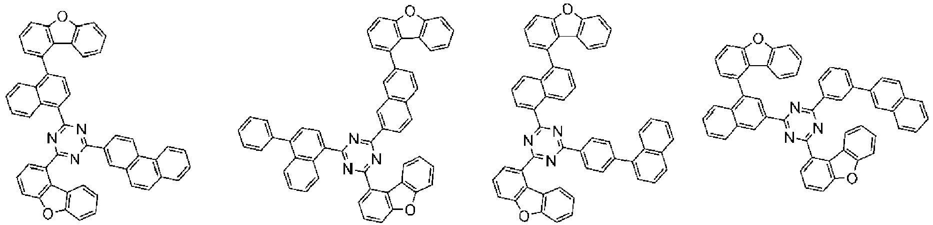

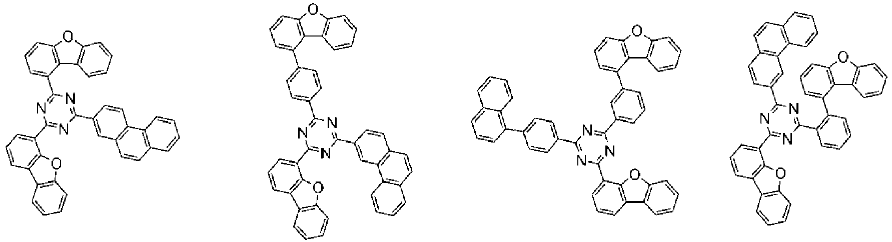

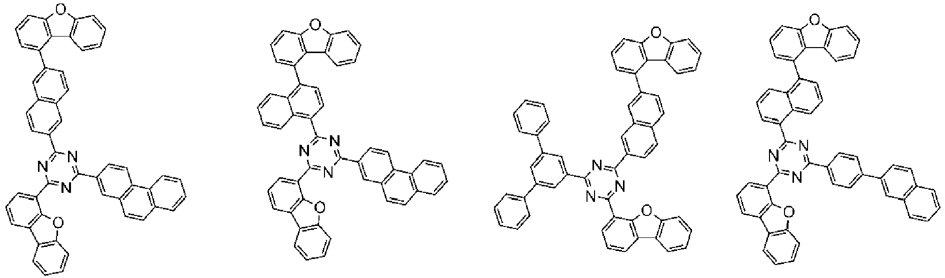

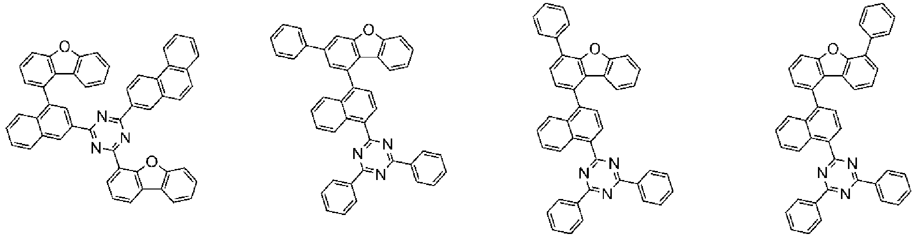

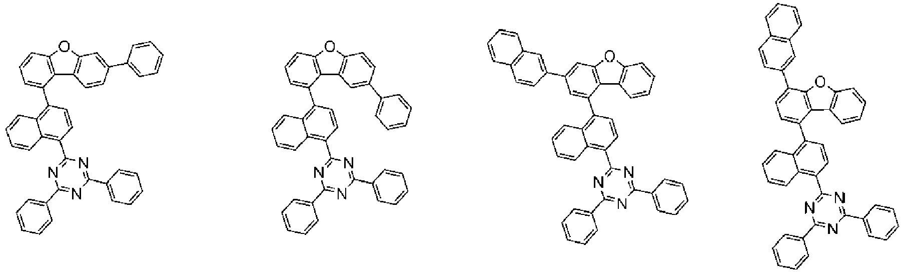

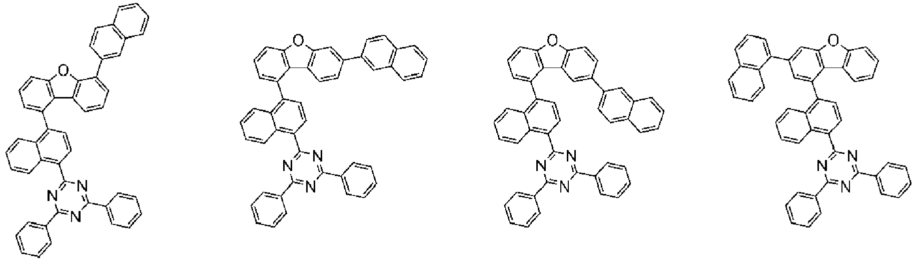

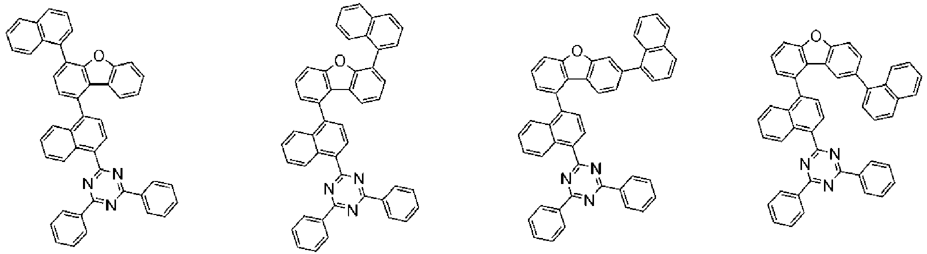

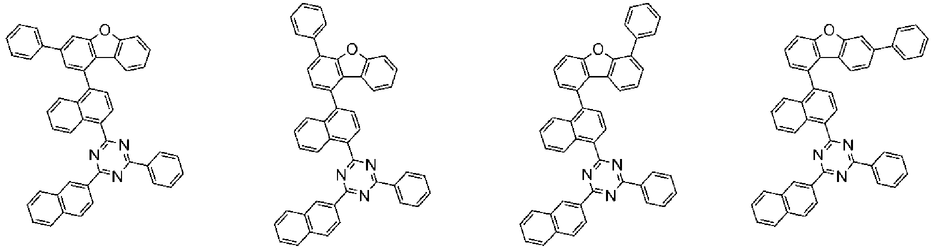

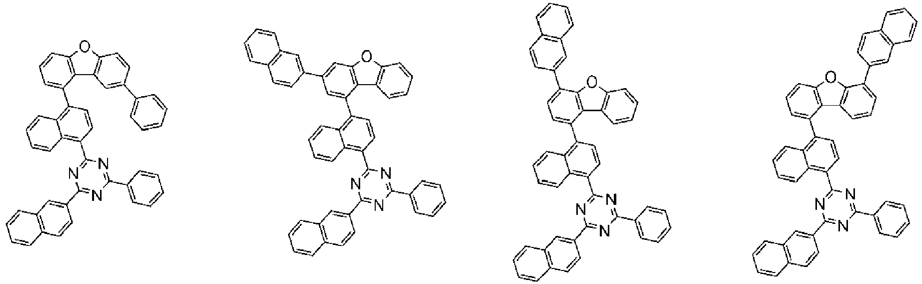

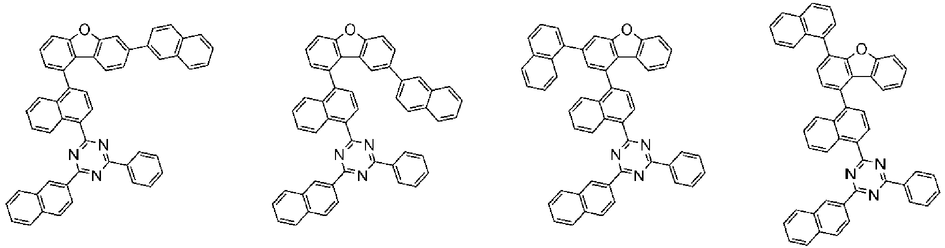

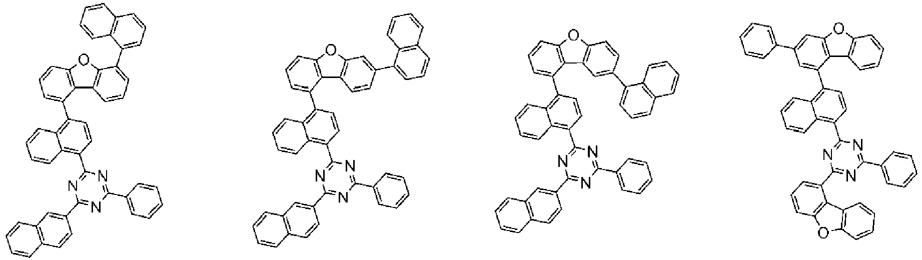

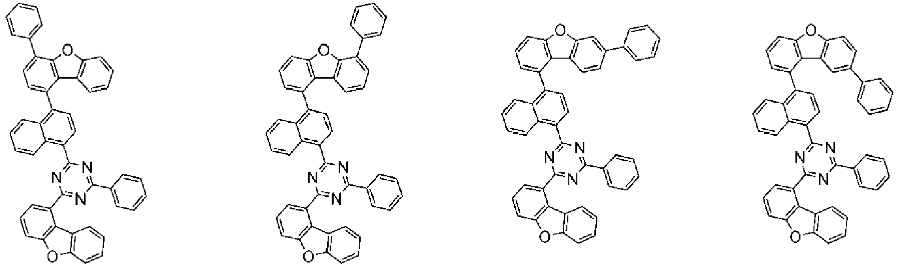

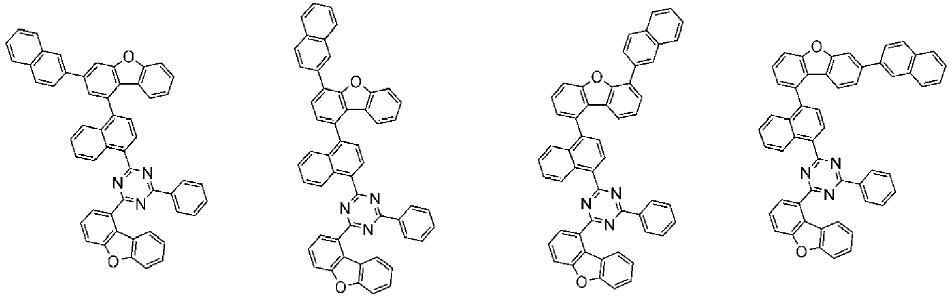

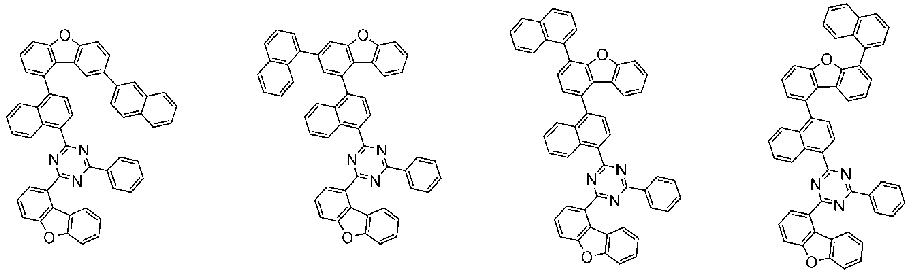

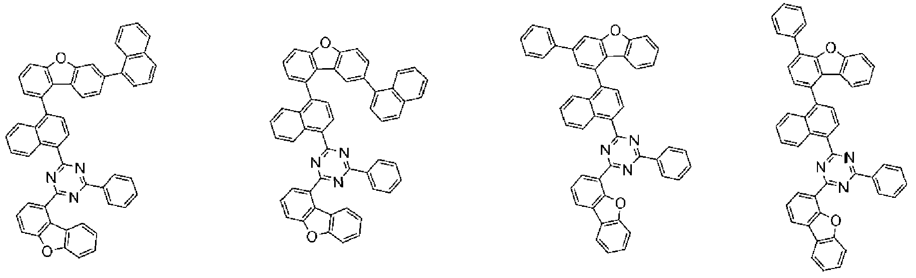

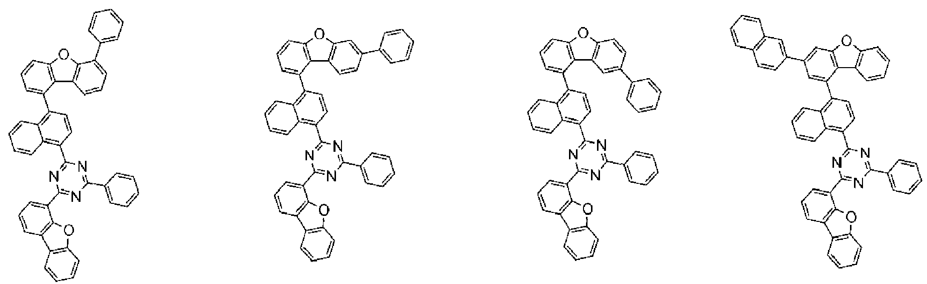

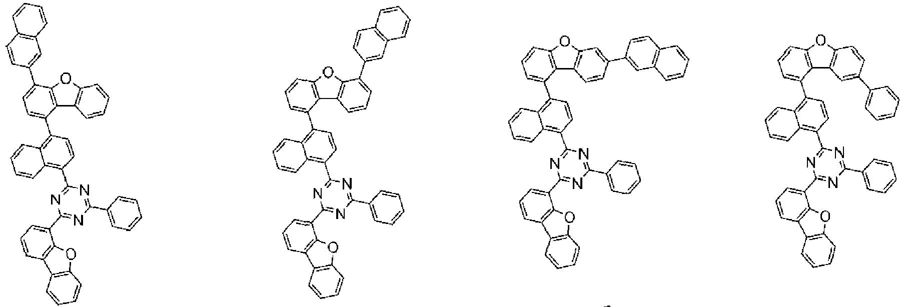

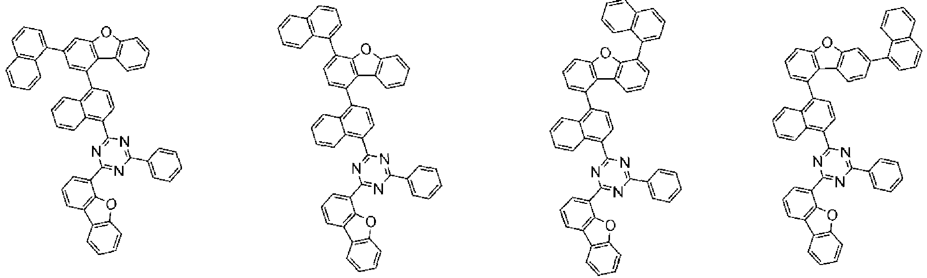

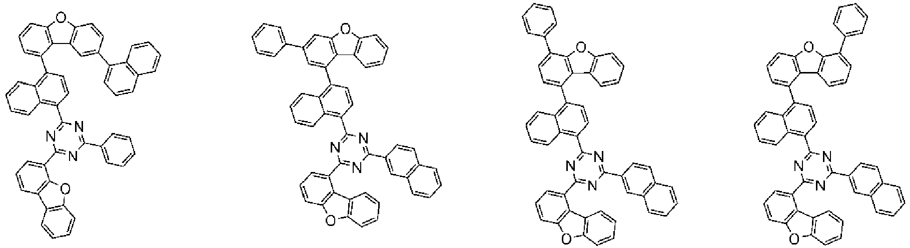

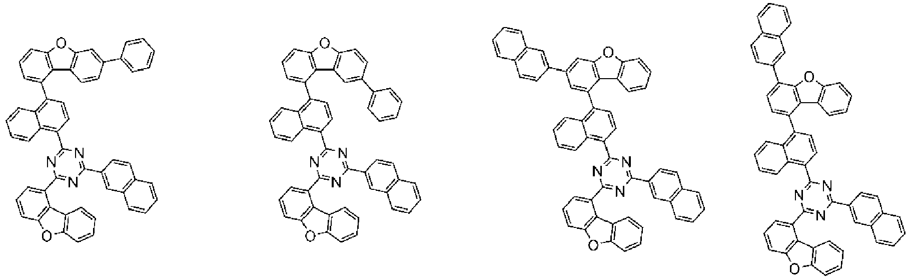

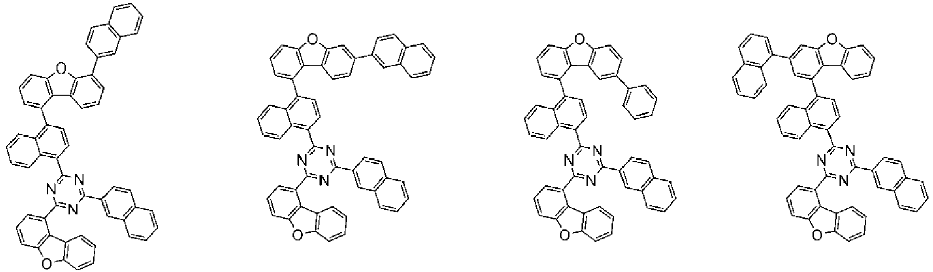

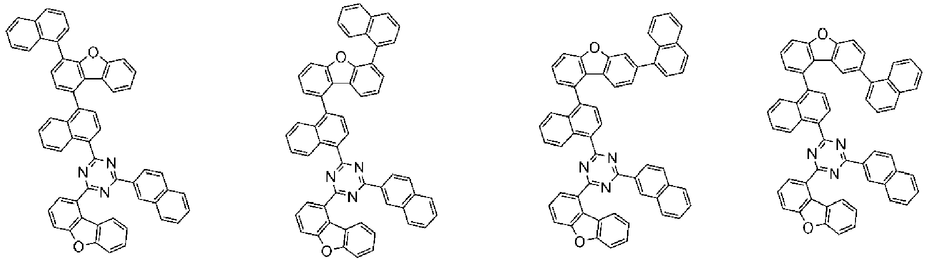

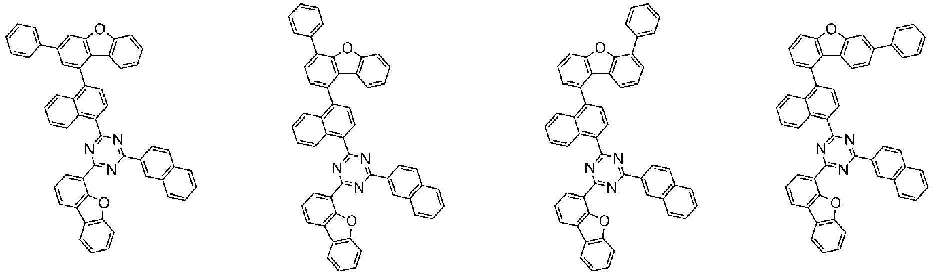

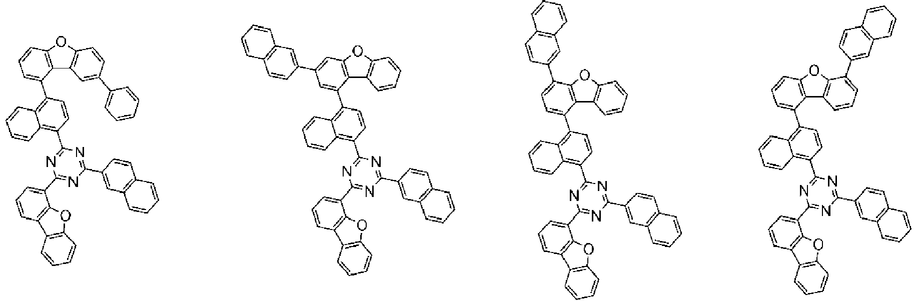

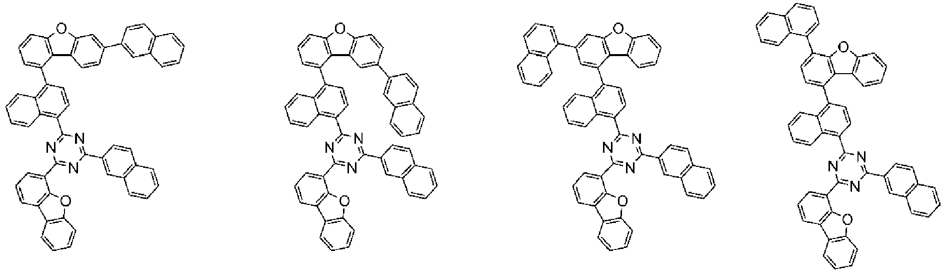

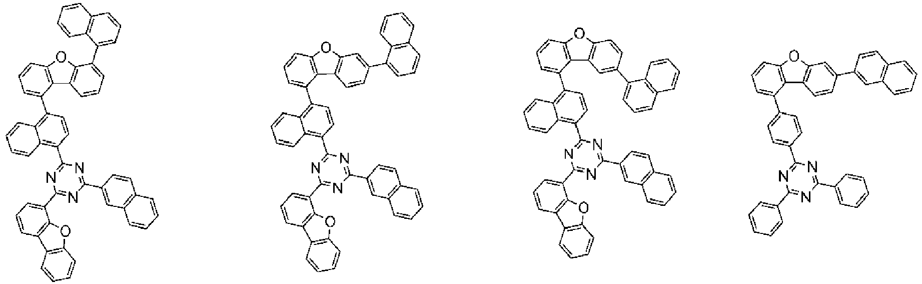

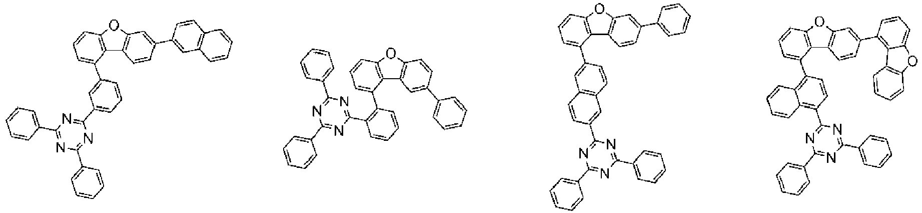

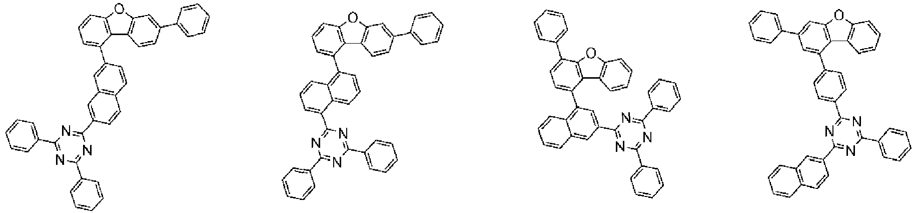

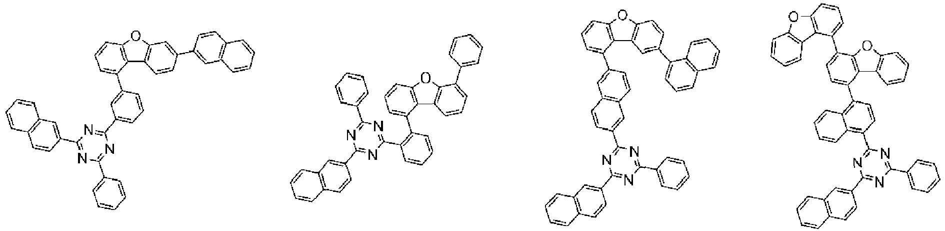

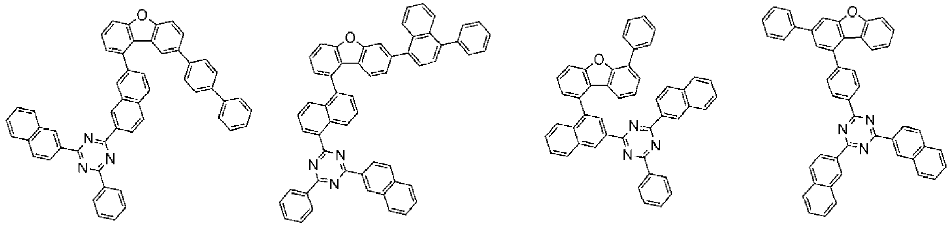

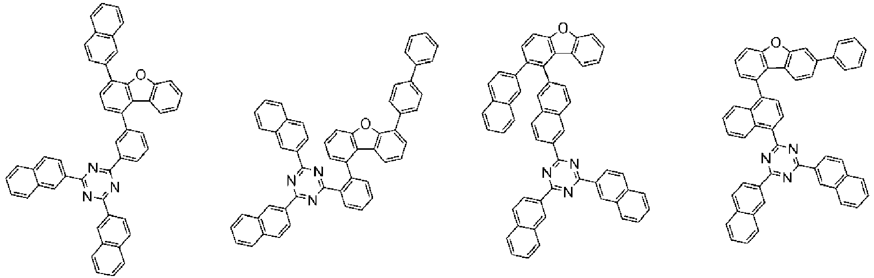

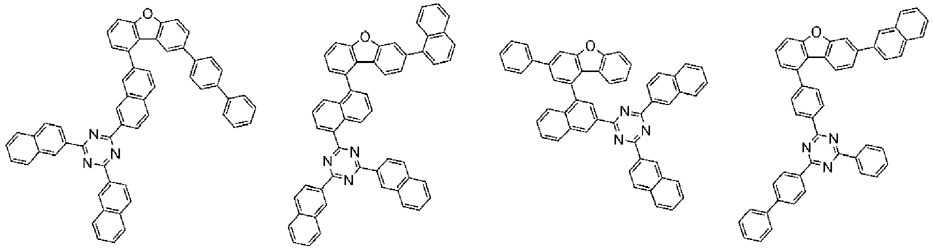

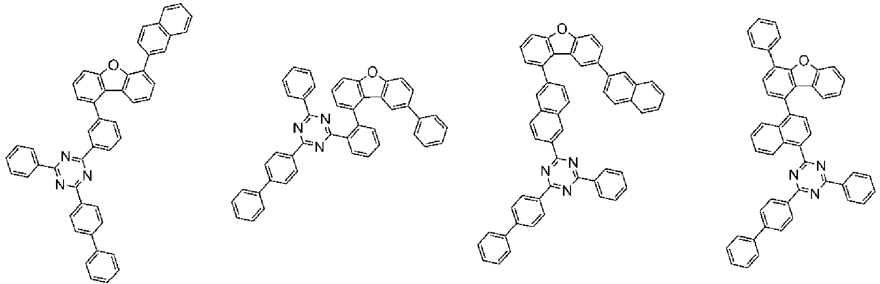

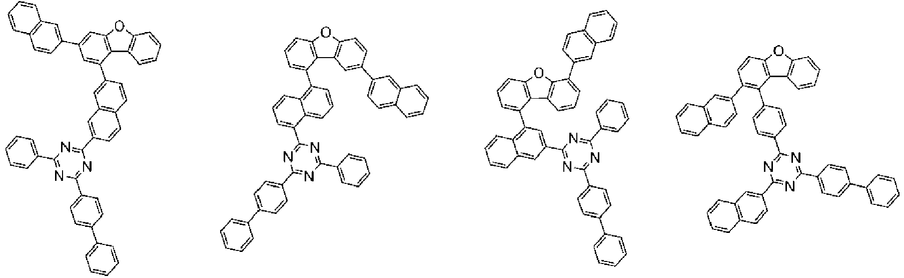

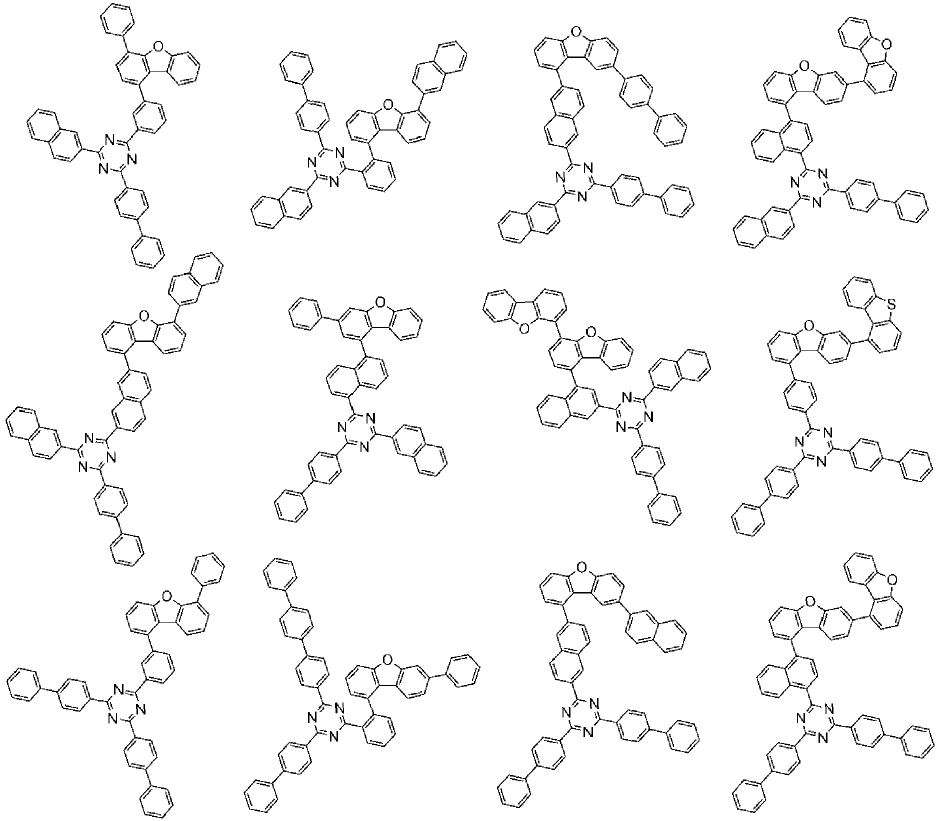

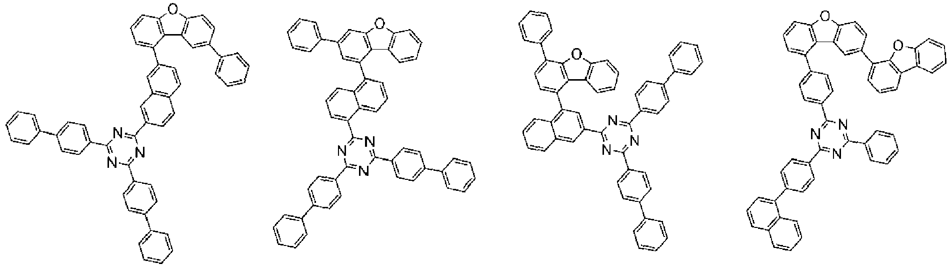

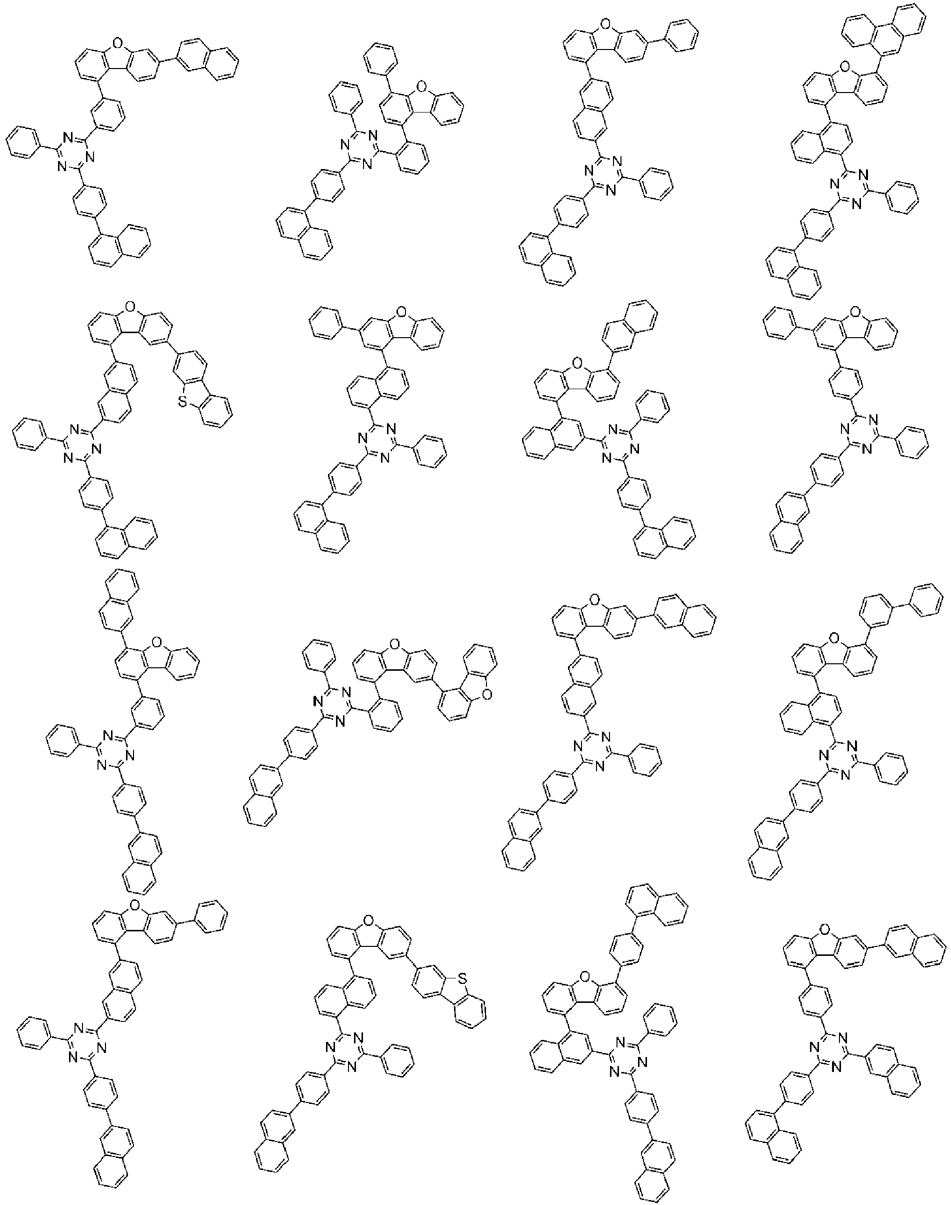

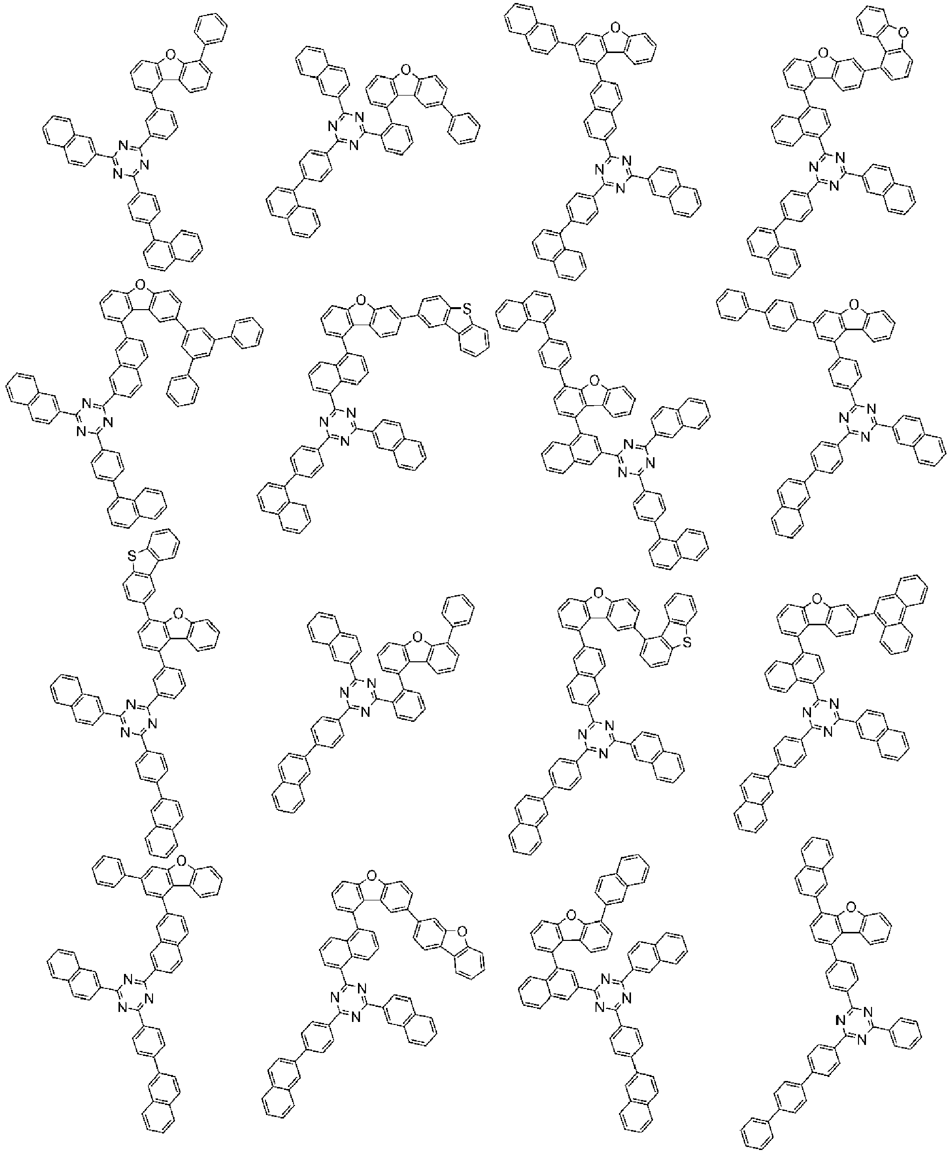

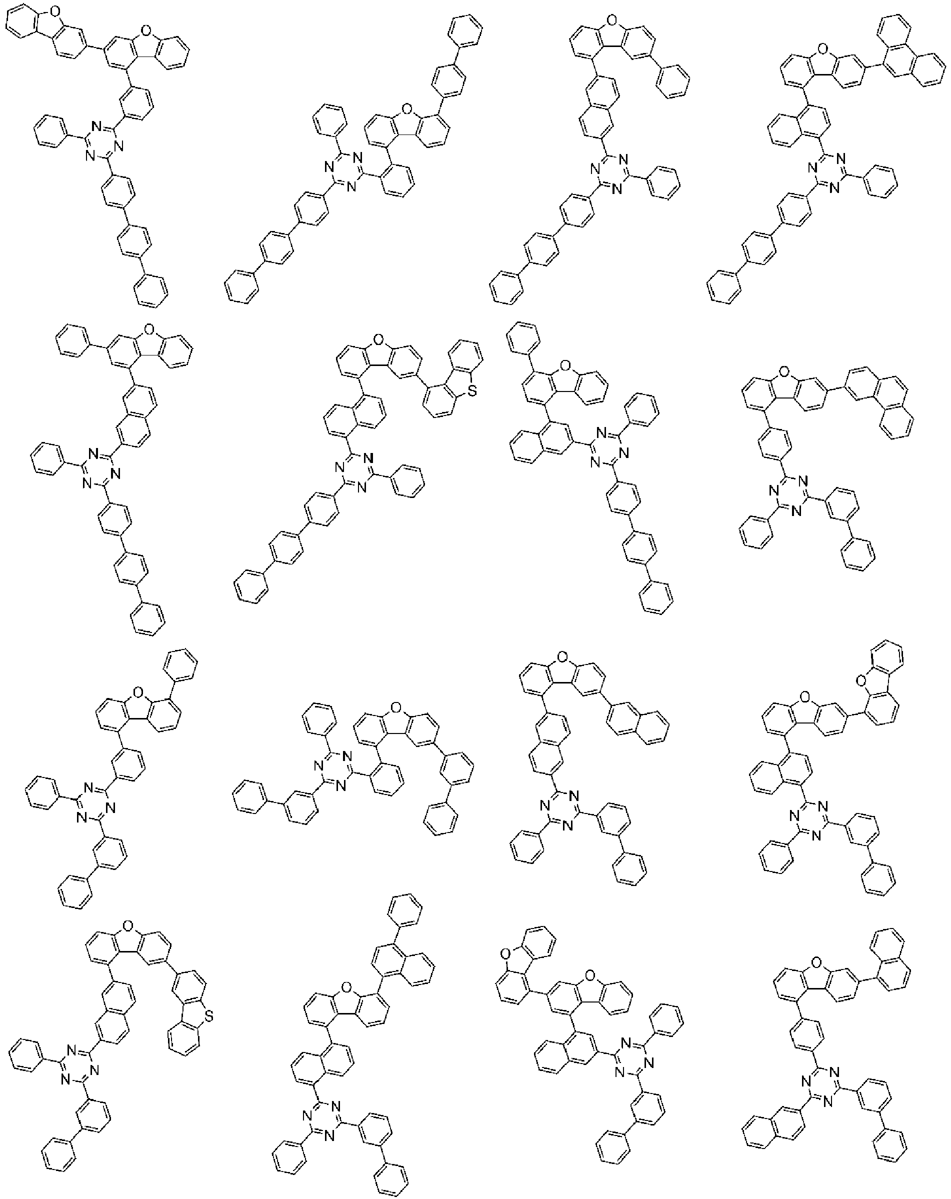

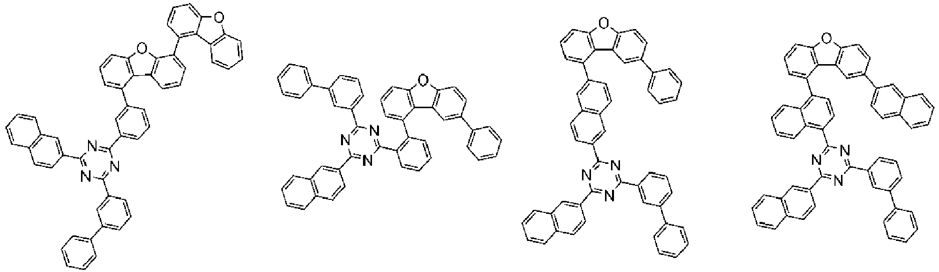

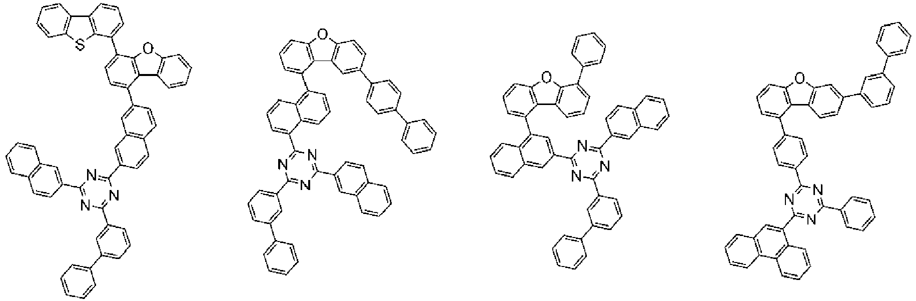

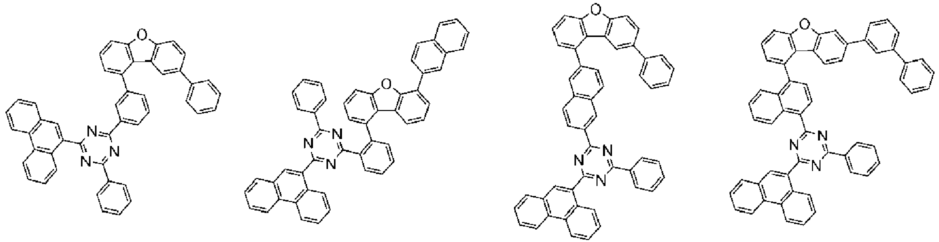

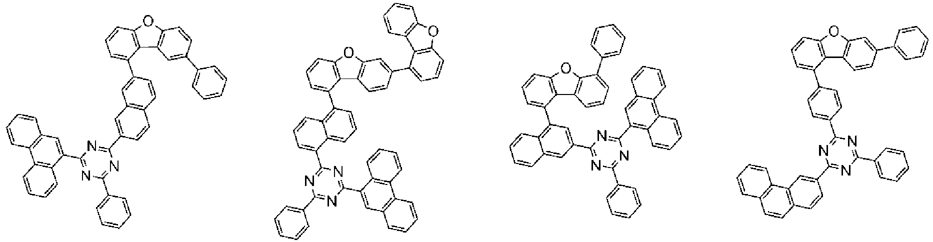

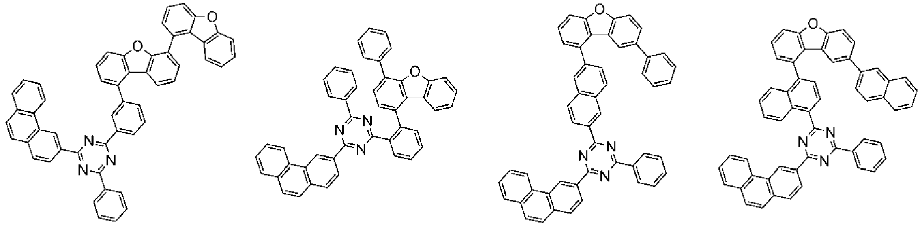

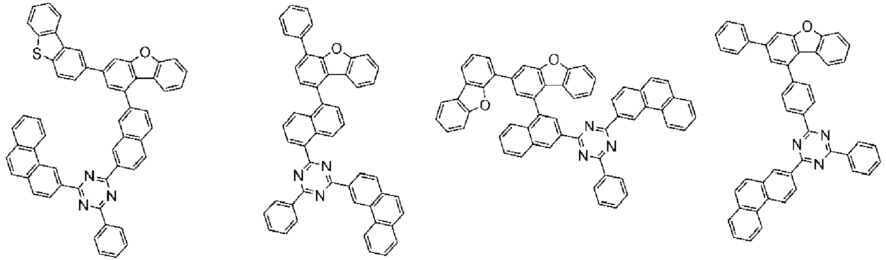

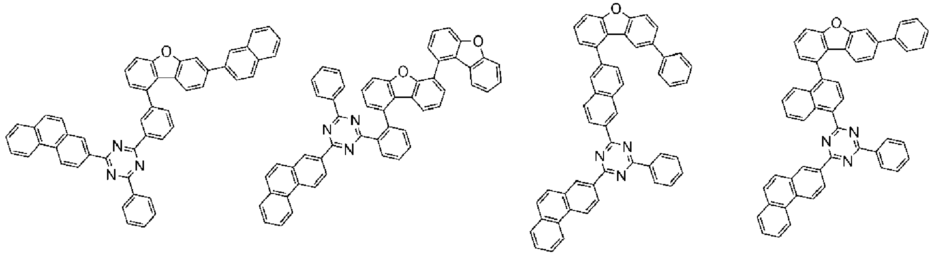

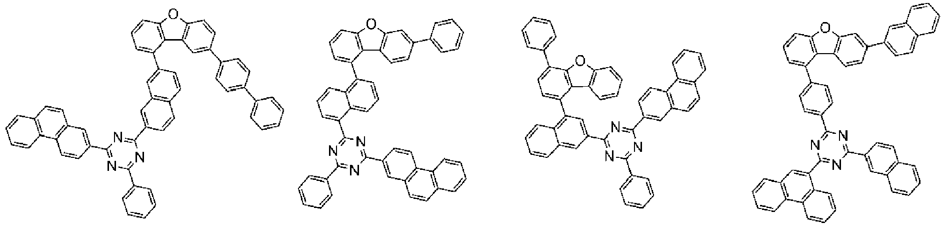

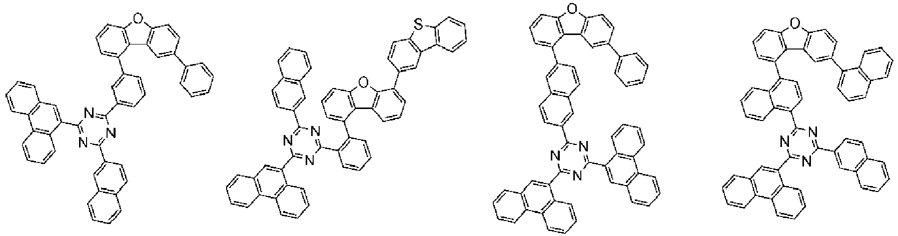

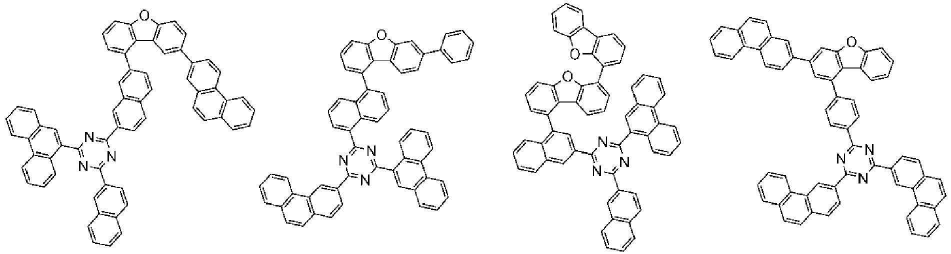

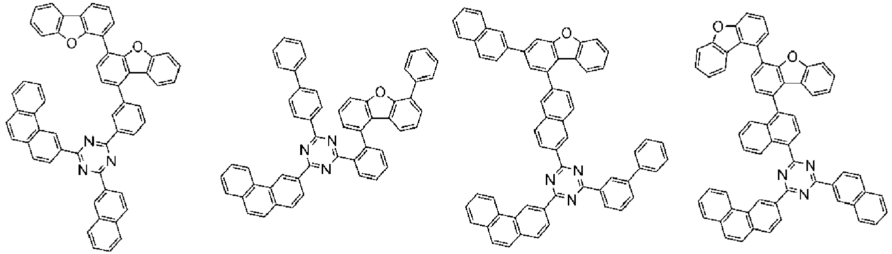

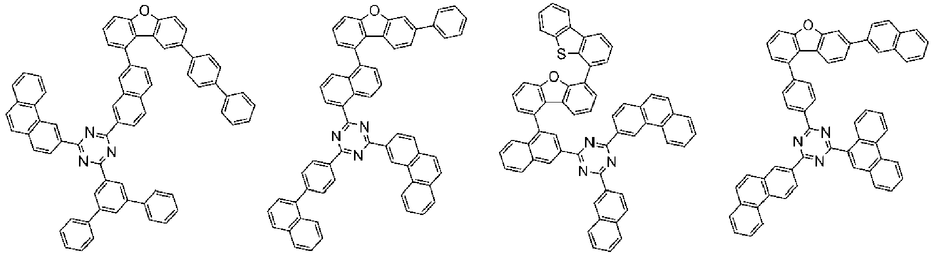

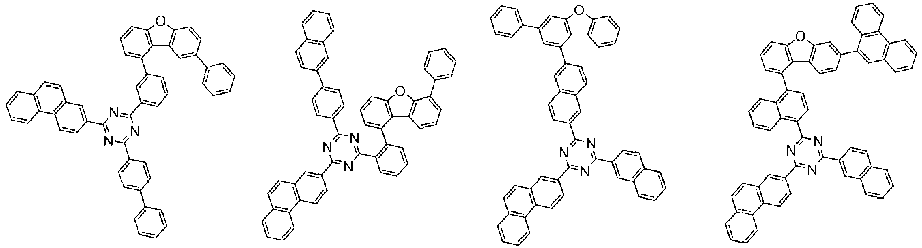

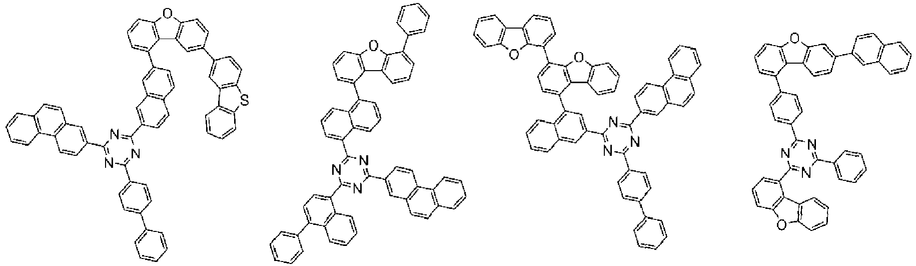

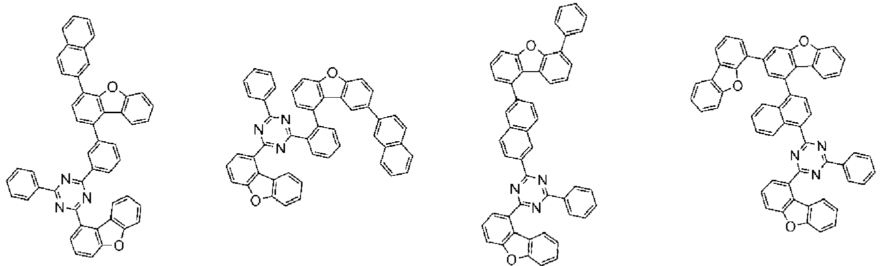

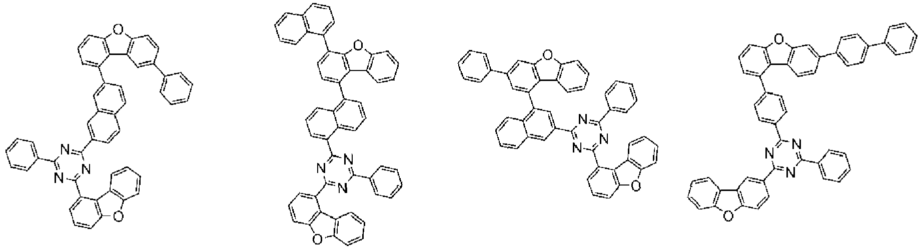

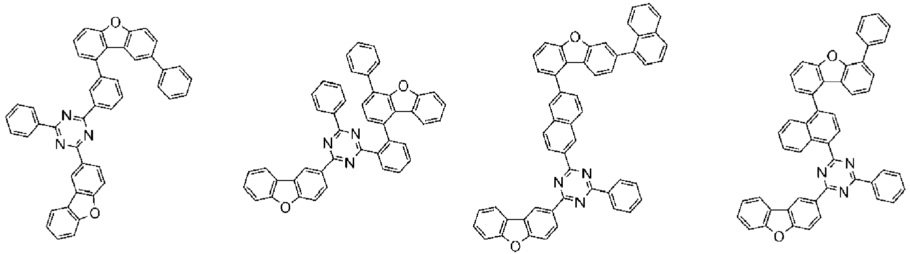

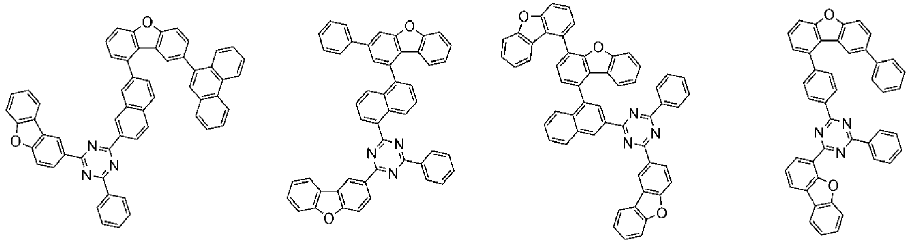

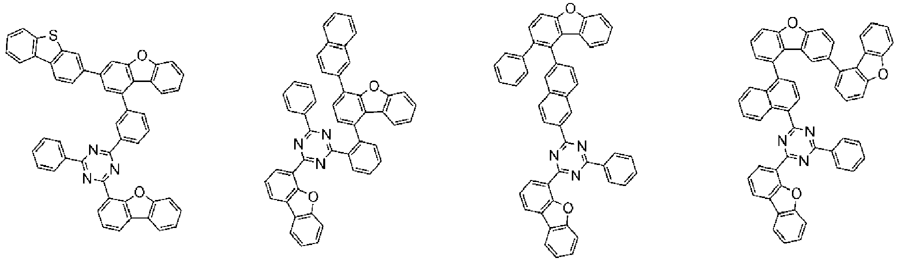

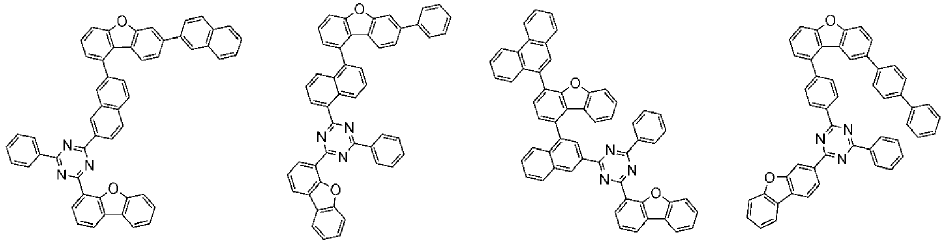

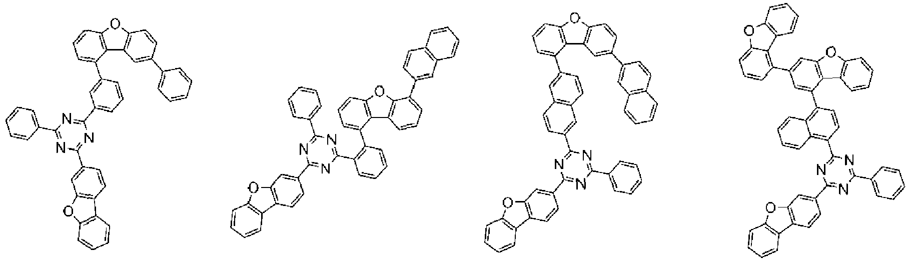

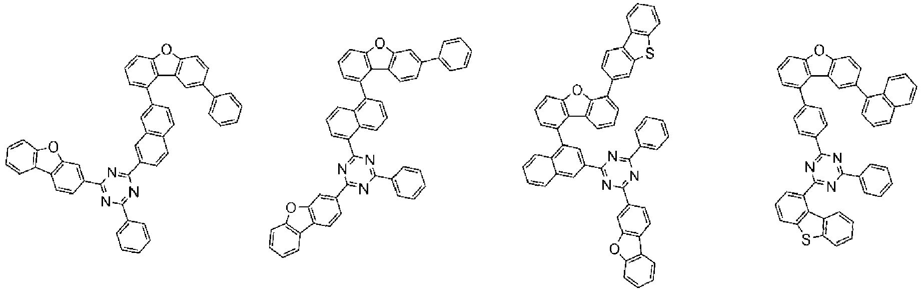

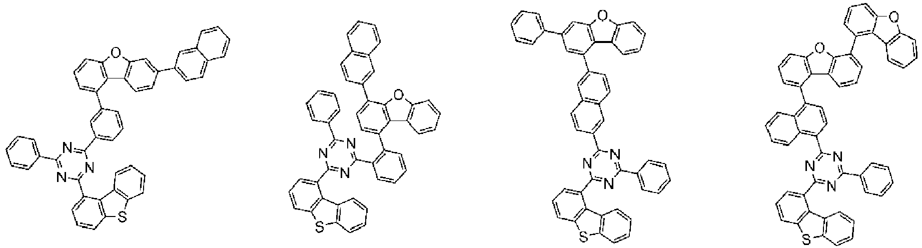

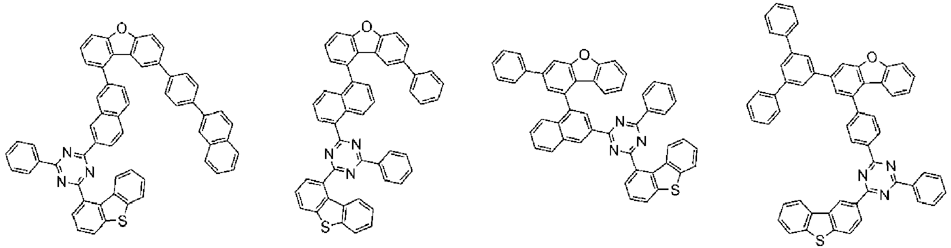

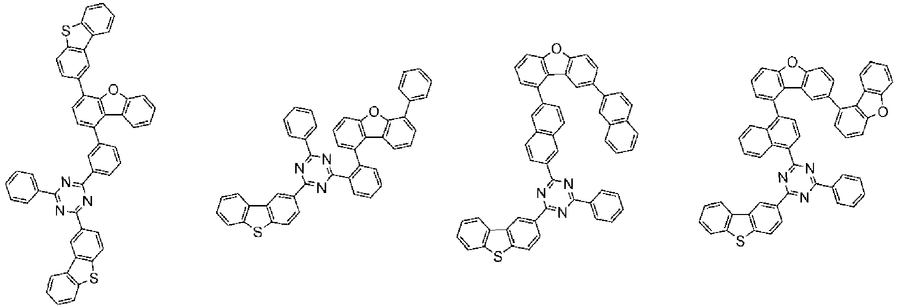

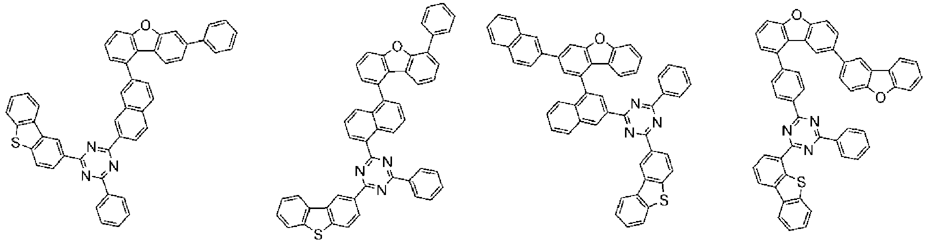

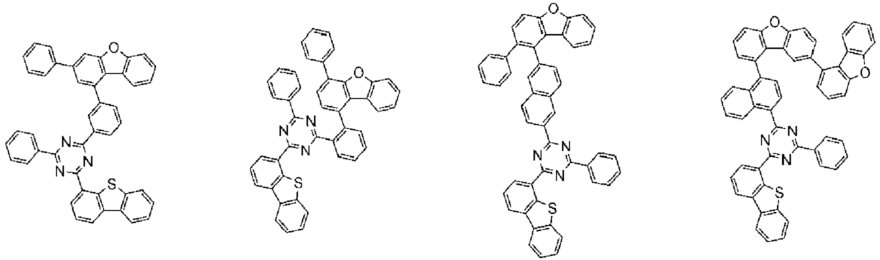

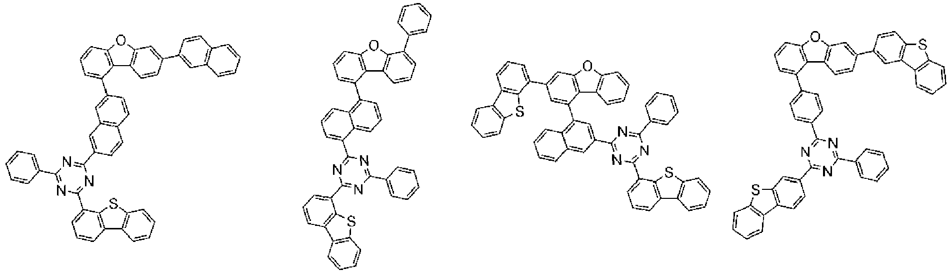

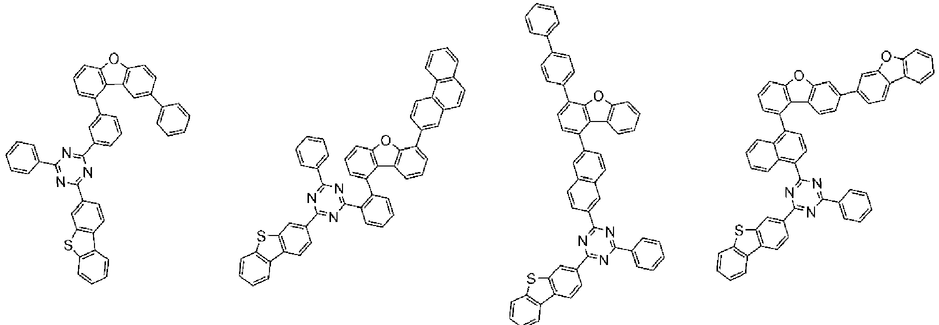

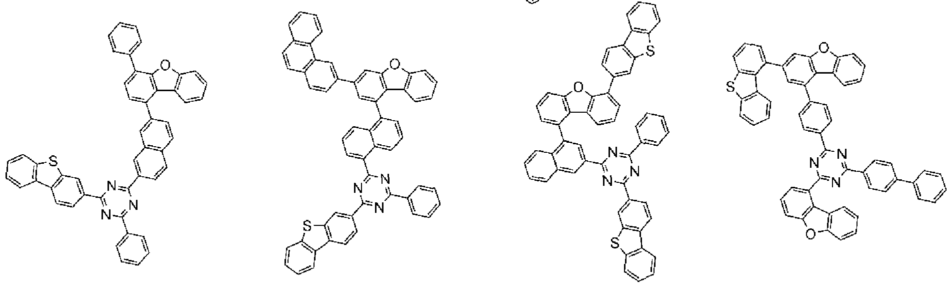

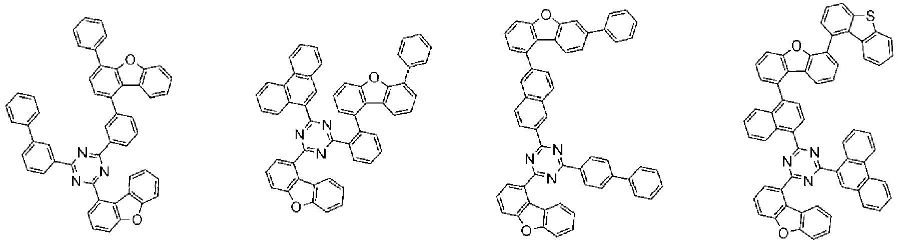

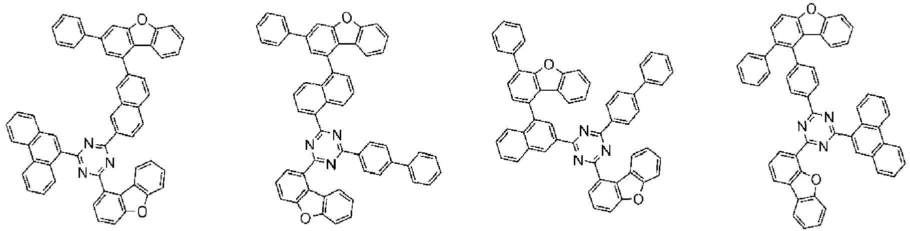

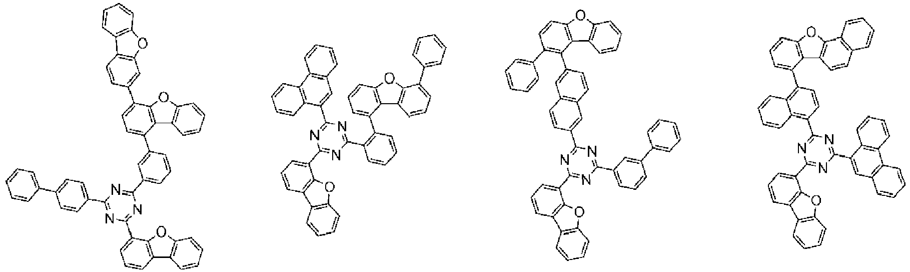

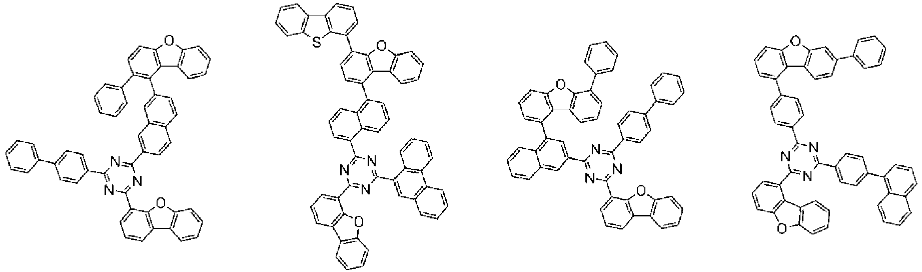

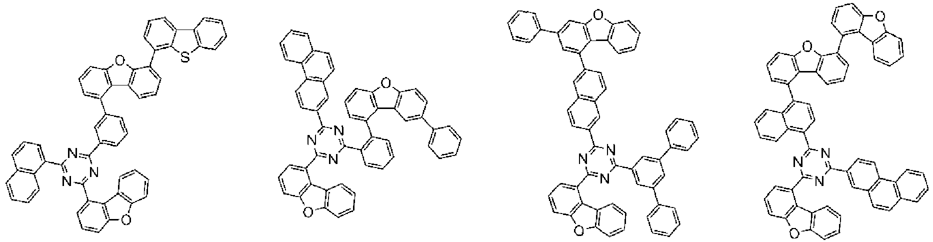

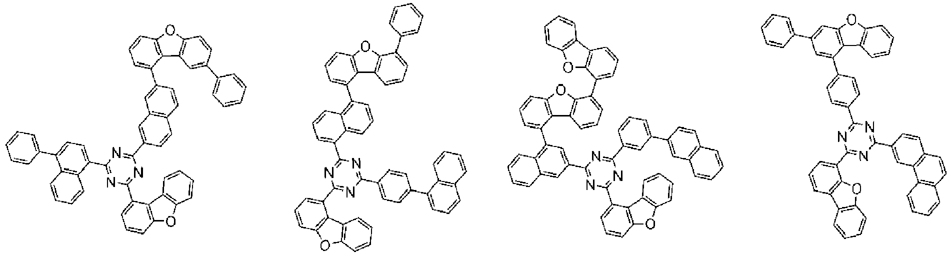

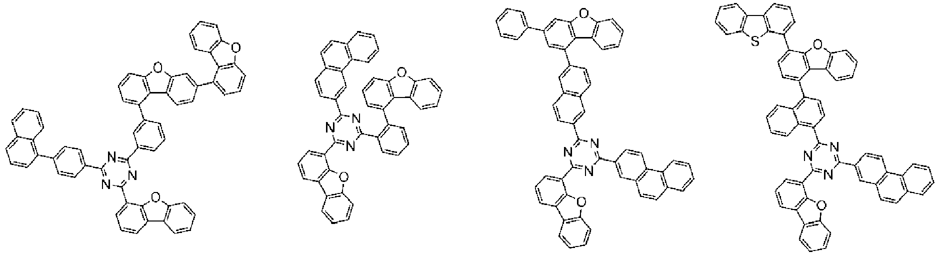

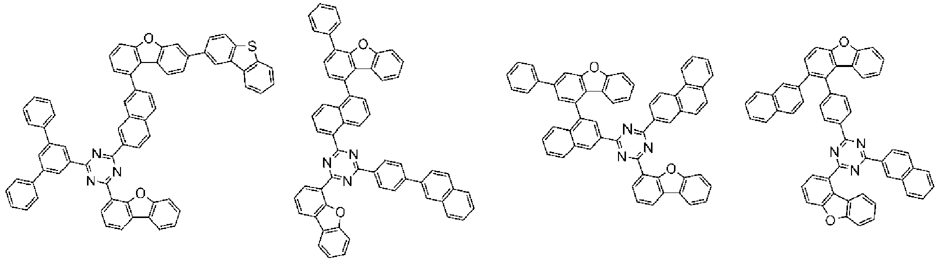

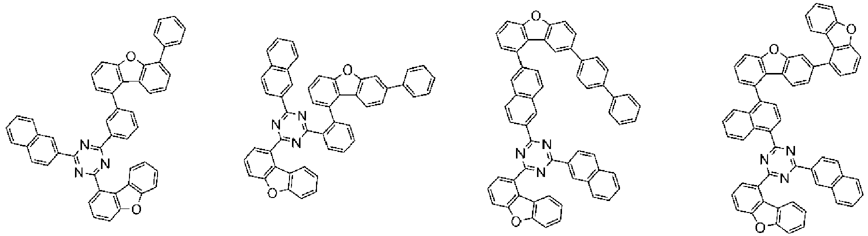

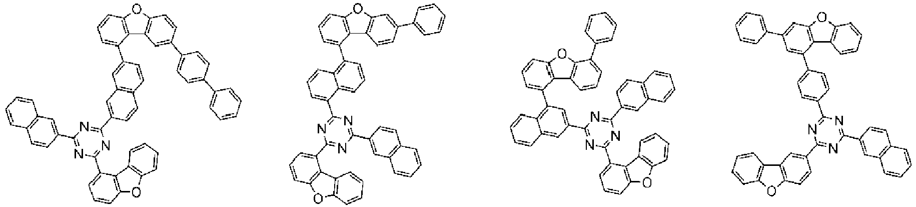

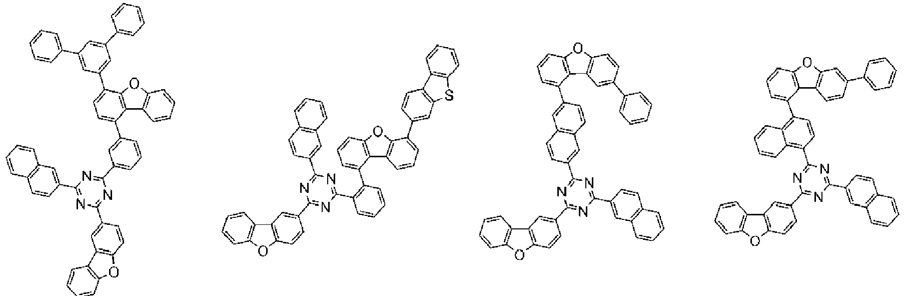

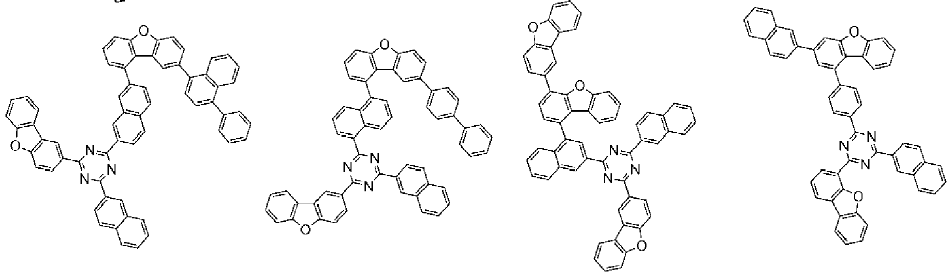

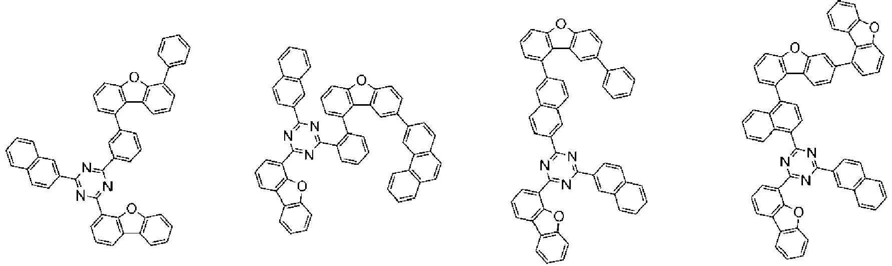

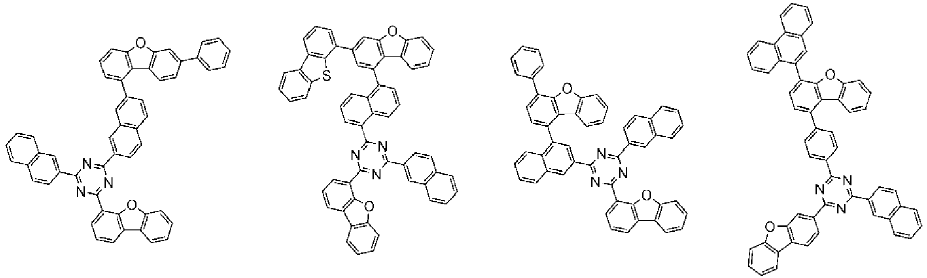

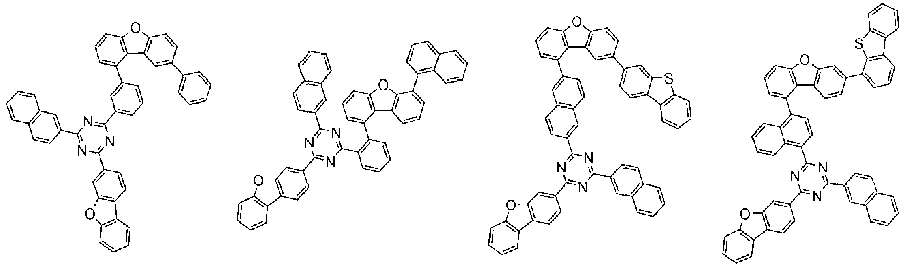

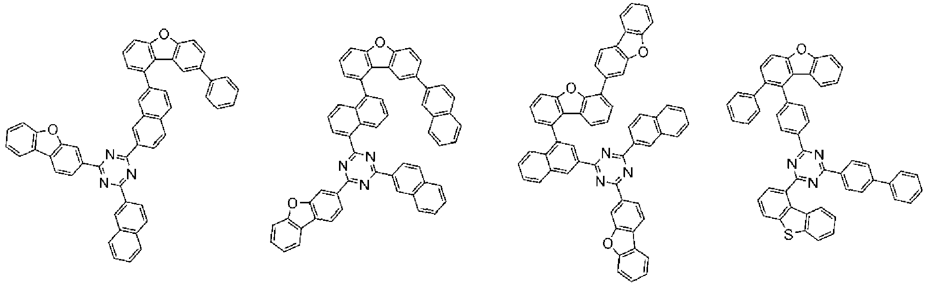

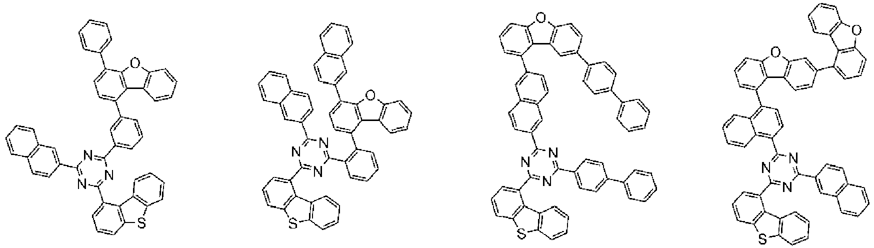

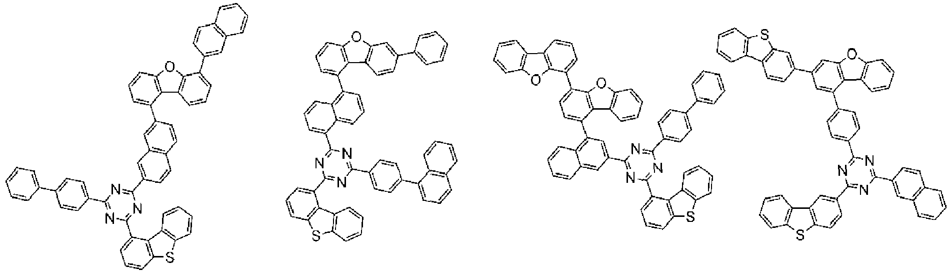

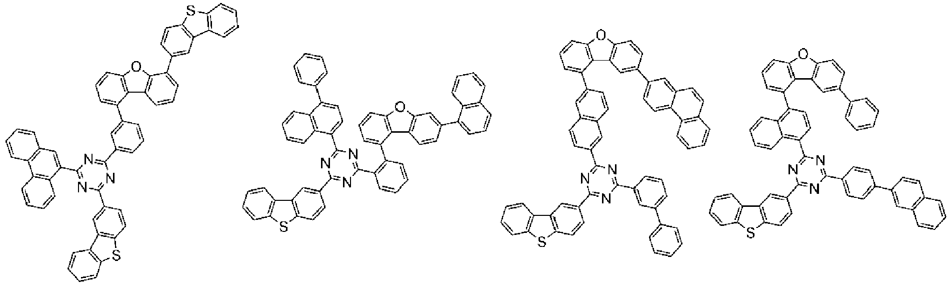

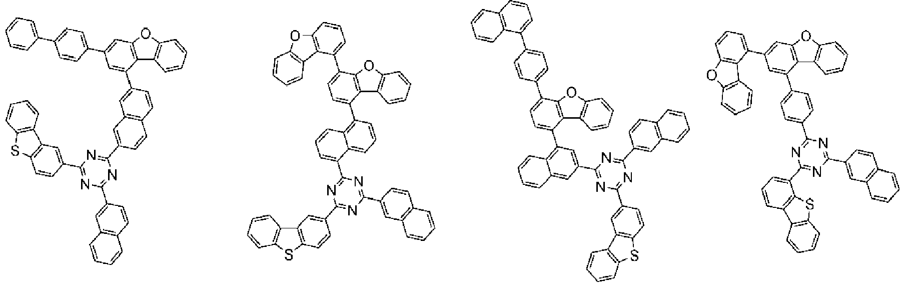

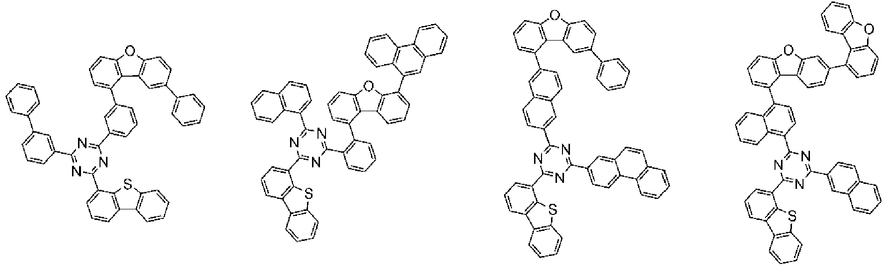

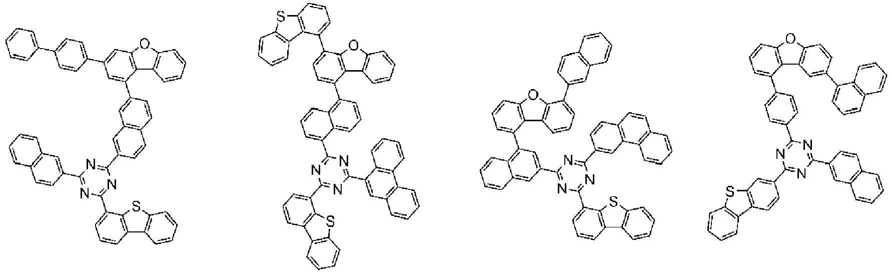

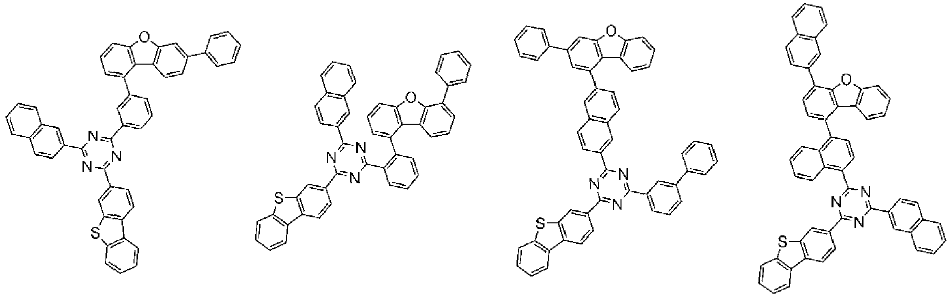

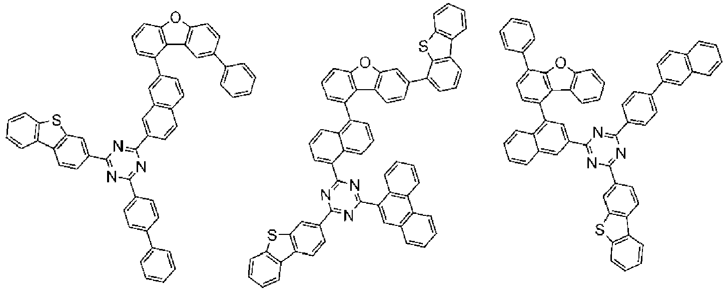

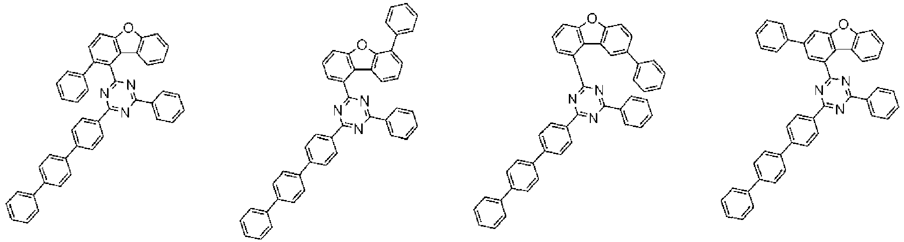

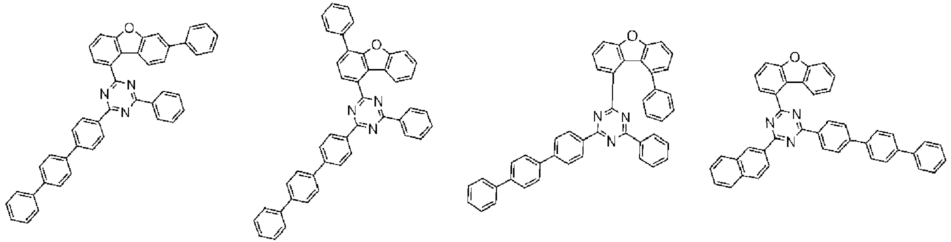

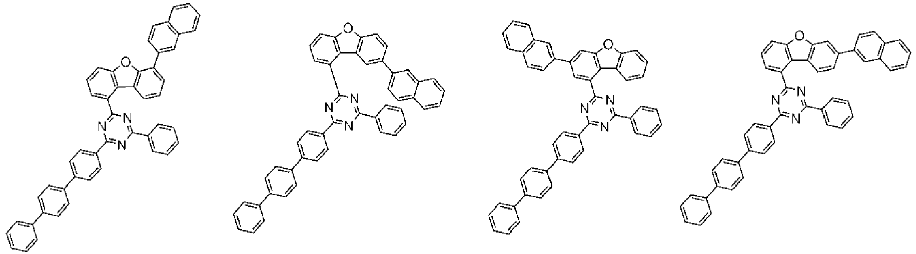

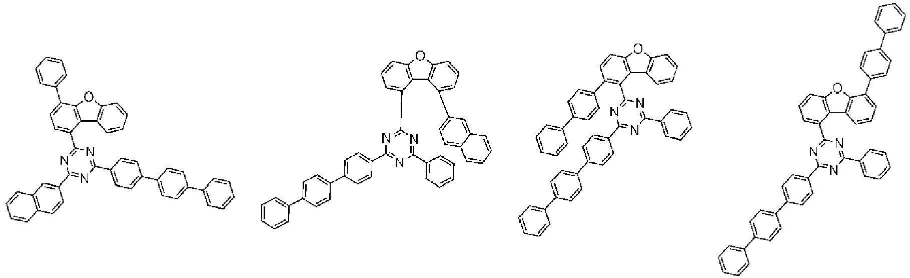

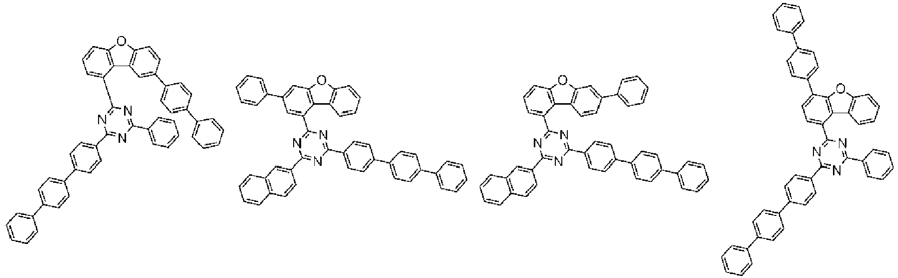

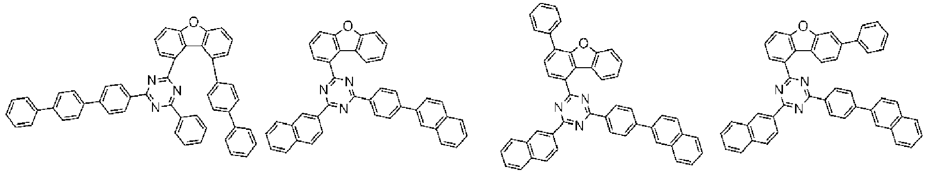

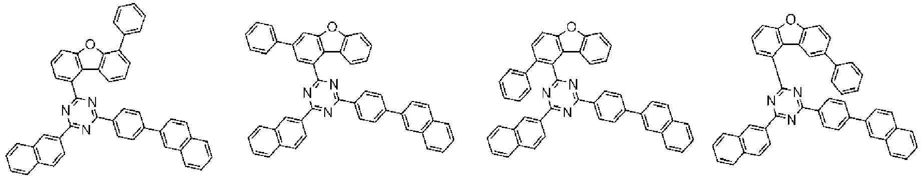

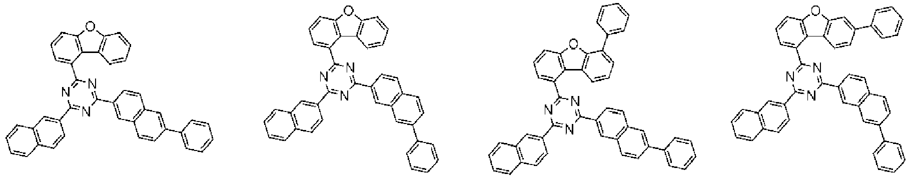

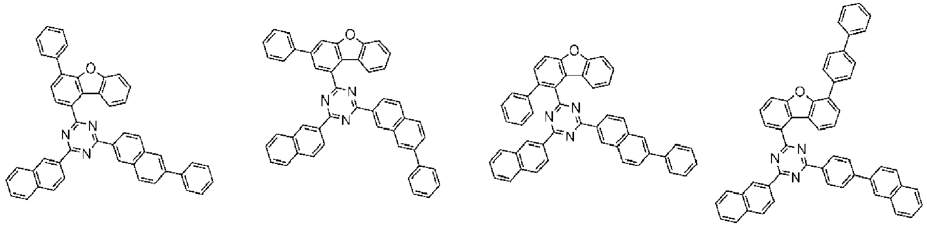

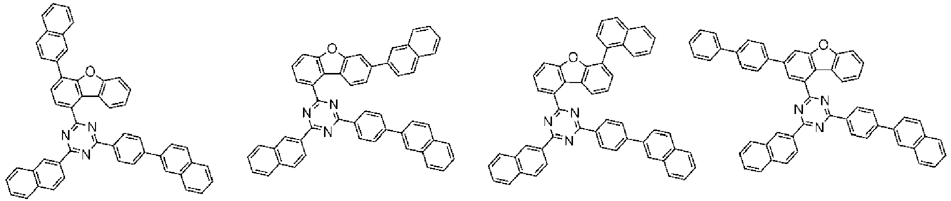

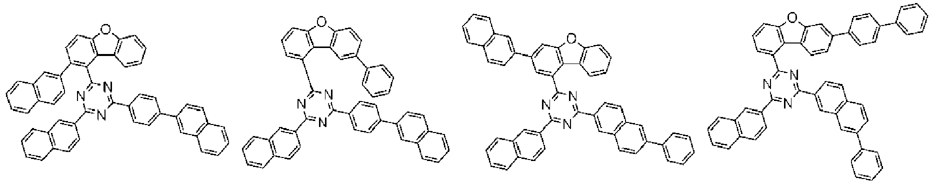

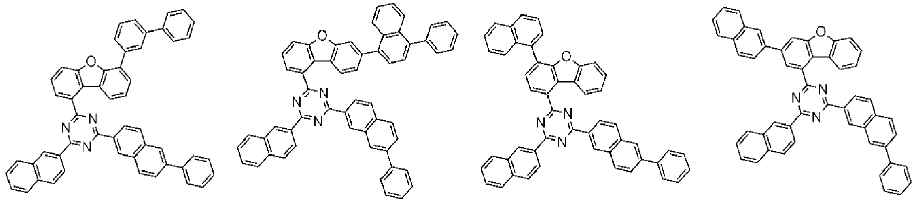

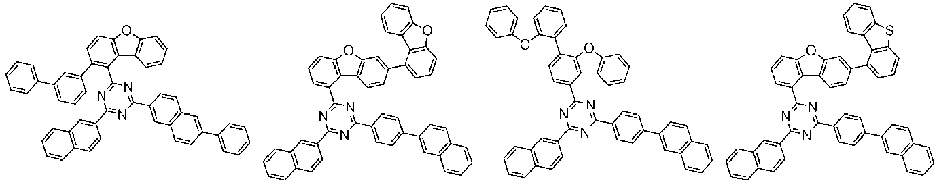

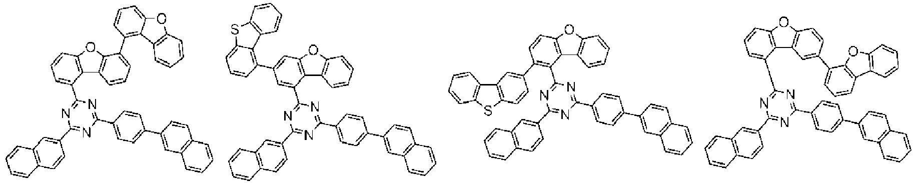

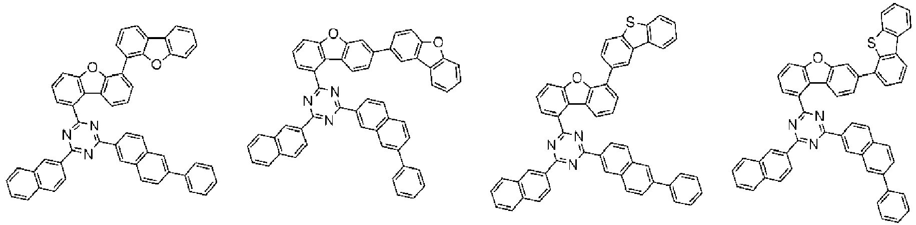

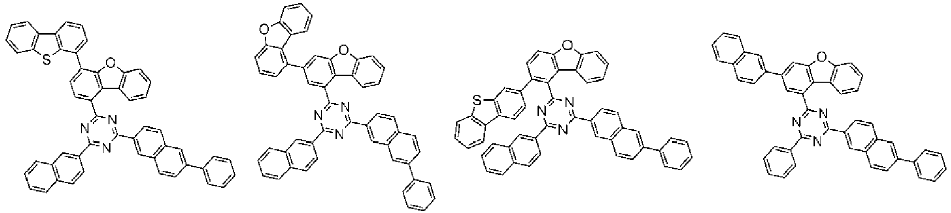

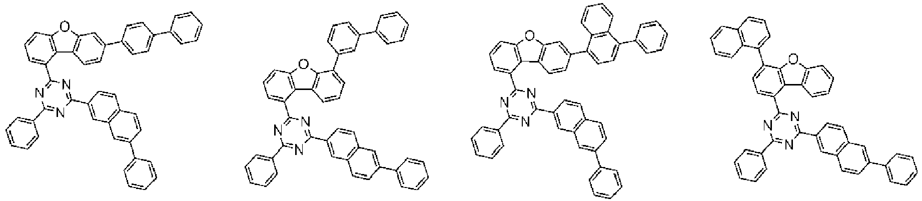

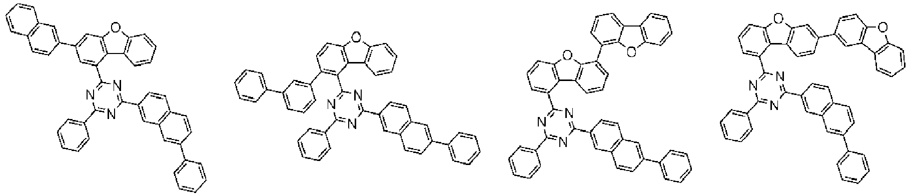

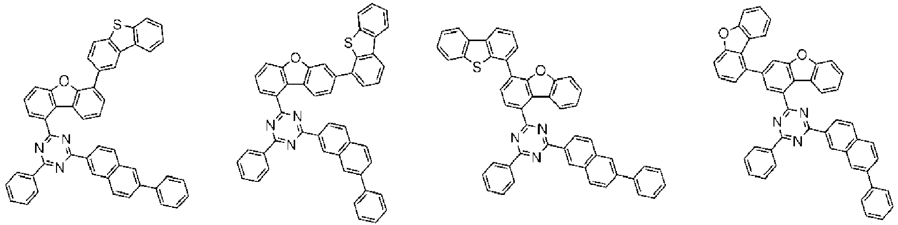

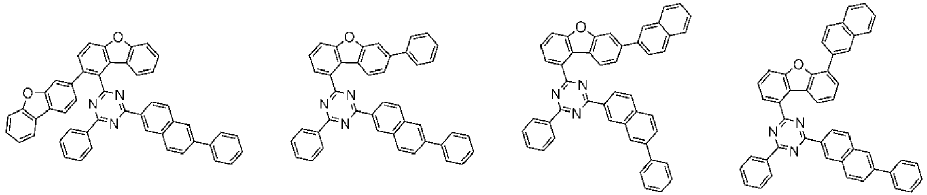

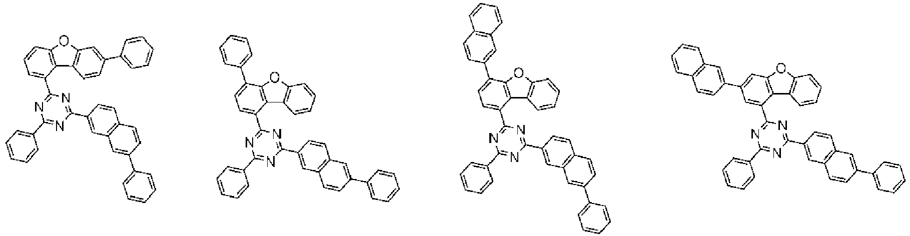

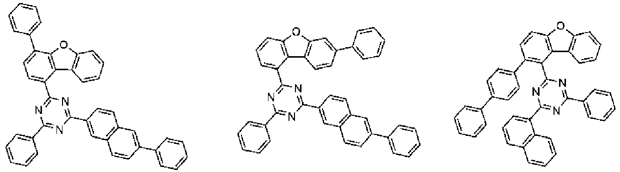

The compound represented by Chemical Formula 1 may be prepared, for example, according to the preparation method as shown in the following Reaction Scheme 1, and the other remaining compounds can be prepared in a similar manner. 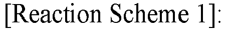 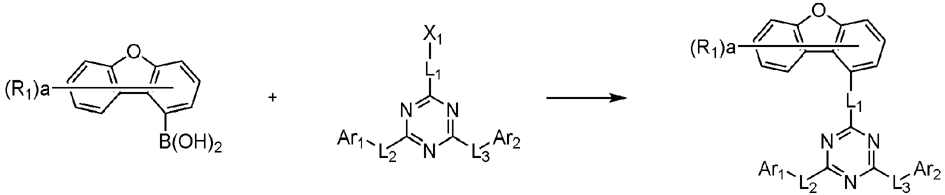 wherein in Reaction Scheme 1, Ar₁, Ar₂, L₁ to L₃, R₁ and a are as defined in Chemical Formula 1, and X₁ is halogen, preferably X₁ is chloro or bromo.

The Reaction Scheme 1 is a Suzuki coupling reaction, which is preferably carried out in the presence of a palladium catalyst and a base, and a reactive group for the Suzuki coupling reaction can be modified as known in the art. The above preparation method may be further embodied in the Preparation Examples described hereinafter.

Preferably, Ar₃ may be hydrogen; a substituted or unsubstituted C₆₋₂₀ aryl; or a substituted or unsubstituted C₂₋₂₀ heteroaryl containing one or more selected from the group consisting of N, O and S, and
more preferably, Ar₃ may be hydrogen or phenyl.

Preferably, Ar₄ and Ar₅ may be each independently a substituted or unsubstituted C₆₋₂₀ aryl; or a substituted or unsubstituted C₂₋₂₀ heteroaryl containing one or more selected from the group consisting of N, O and S,
more preferably, Ar₄ and Ar₅ may be each independently phenyl, phenyl substituted with 5 deuteriums, biphenylyl, biphenylyl substituted with 4 deuteriums, biphenylyl substituted with 9 deuteriums, terphenylyl, terphenylyl substituted with 4 deuteriums, quarterphenylyl, naphthyl, phenanthrenyl, triphenylenyl, dimethylfluorenyl, diphenylfluorenyl, carbazolyl, phenylcarbazolyl, dibenzofuranyl, dibenzothiophenyl, or phenyl dibenzofuranyl, and
most preferably, Ar₄ and Ar₅ may be each independently any one selected from the group consisting of the following:

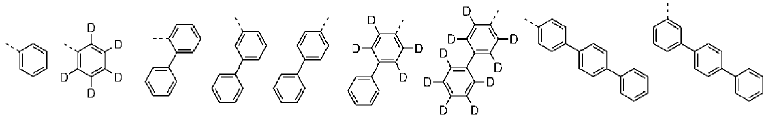

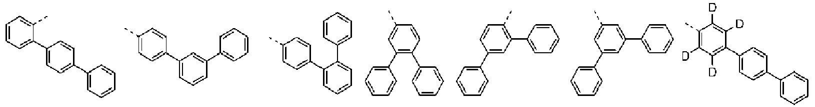

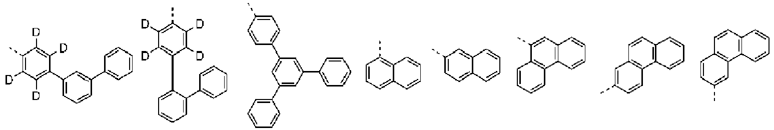

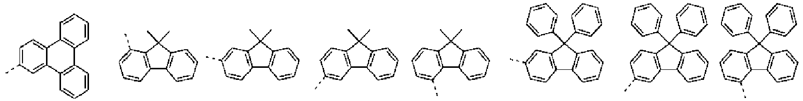

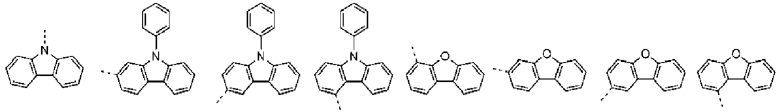

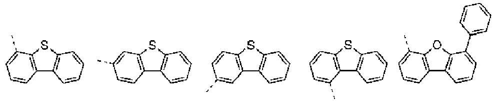

Preferably, L₄ to L₆ may be each independently a single bond; a substituted or unsubstituted C₆₋₂₀ arylene; or a substituted or unsubstituted C₂₋₂₀ heteroarylene containing one or more selected from the group consisting of N, O and S,
more preferably, L₄ to L₆ may be each independently a single bond, phenylene, phenylene substituted with 4 deuteriums, biphenylylene, naphthylene, phenyl naphthylene, carbazolylene, phenyl cartiazolylene, phenyl carbazolylene substituted with 4 deuteriums, dibenzofuranylene, phenyl dibenzofuranylene, phenyl dibenzofuranylene substituted with 4 deuteriums, or dimethylfluorenylene, and
most preferably, L₄ to L₆ may be each independently a single bond or any one selected from the group consisting of the following:

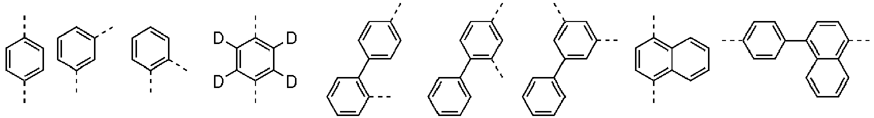

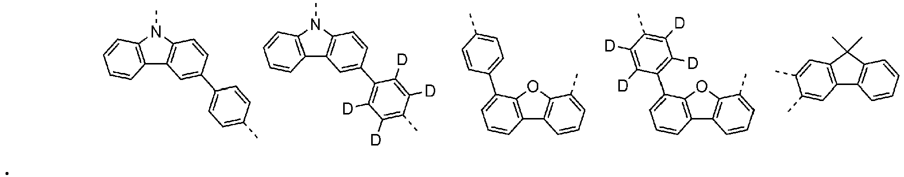

Preferably, L₄ is a single bond, and L₅ and L₆ may be each independently a single bond; a substituted or unsubstituted C₆₋₂₀ arylene; or a substituted or unsubstituted C₂₋₂₀ heteroarylene containing at least one selected from the group consisting of N, O and S,
more preferably, L₄ is a single bond, and L₅ and L₆ may be each independently a single bond, phenylene, phenylene substituted with 4 deuteriums, biphenylylene, naphthylene, phenyl naphthylene, carbazolylene, phenyl carbazolylene, phenyl carbazolylene substituted with 4 deuteriums, dibenzofuranylene, phenyl dibenzofuranylene, phenyl dibenzofuranylene substituted with 4 deuteriums, or dimethylfluorenylene, and
most preferably, L₄ is a single bond, and L₅ and L₆ may be each independently a single bond or any one selected from the group consisting of the following:

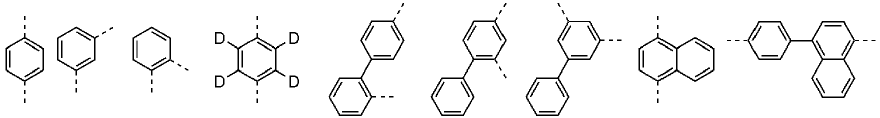

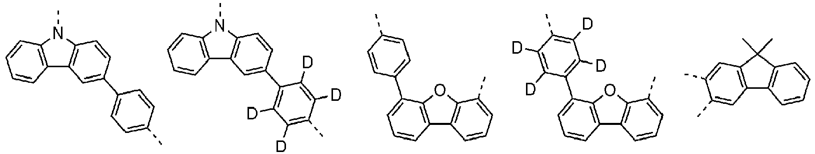

Preferably, L₇ may be a substituted or unsubstituted C₆₋₂₀ arylene,
more preferably, L₇ may be a substituted or unsubstituted phenylene, a substituted or unsubstituted biphenylylene, or a substituted or unsubstituted naphthylene, and
most preferably, L₇ may be phenylene, phenylene substituted with 4 deuteriums, biphenylylene, or naphthylene.

Preferably, the compound represented by Chemical Formula 2 may be represented by the following Chemical Formula 2-1: 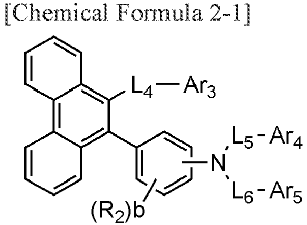 wherein in Chemical Formula 2-1,
Ar₃ to Ar₅ and L₄ to L₆ are as defined in Chemical Formula 2,
R₂ is hydrogen; deuterium; or a substituted or unsubstituted C₆₋₆₀ aryl, and
b is an integer of 0 to 4.

Preferably, R₂ may be hydrogen; deuterium; or a substituted or unsubstituted C₆₋₂₀ aryl, and
more preferably, R₂ may be hydrogen or deuterium.

Representative examples of the compound represented by Chemical Formula 2 are as follows:

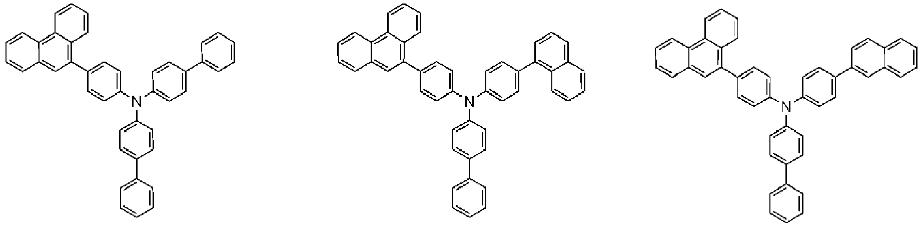

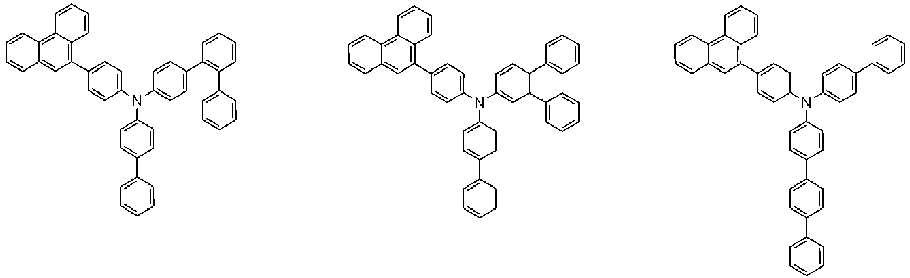

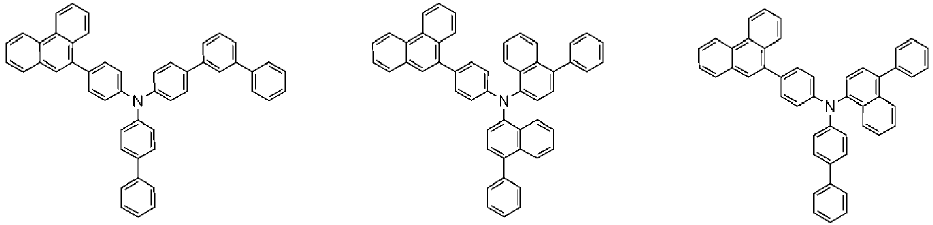

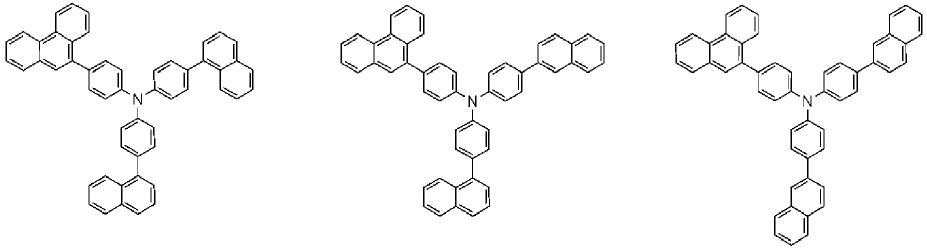

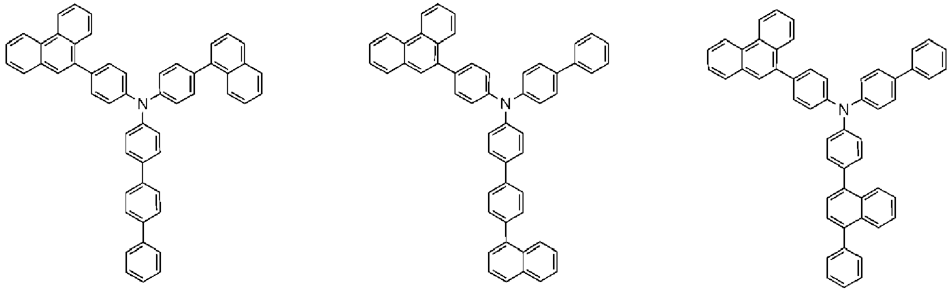

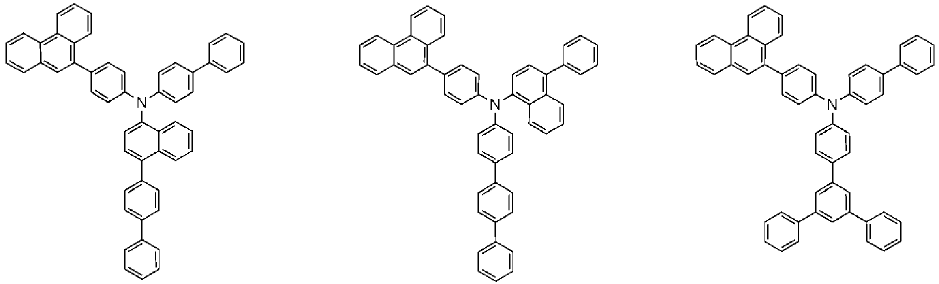

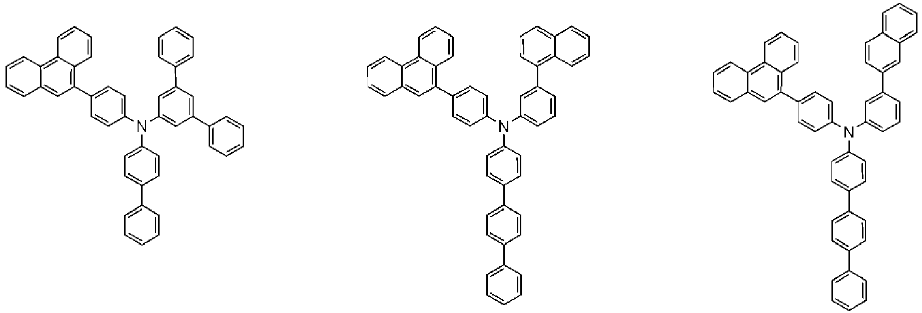

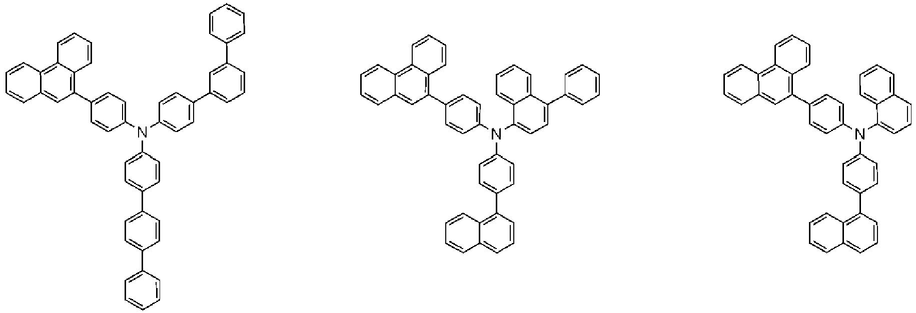

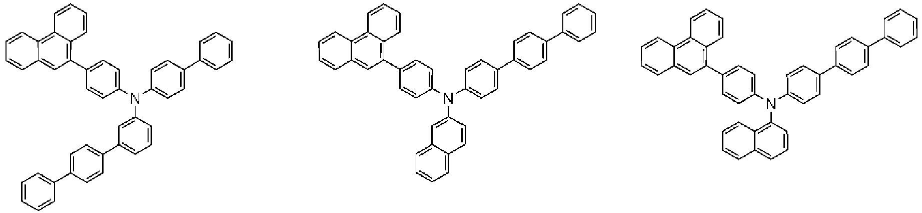

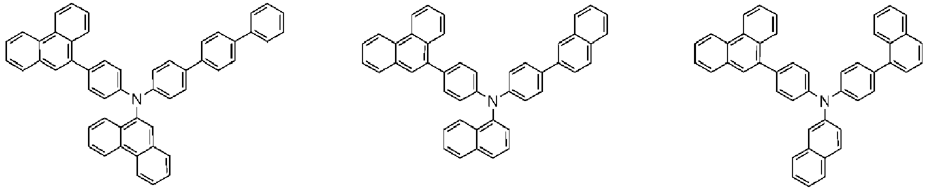

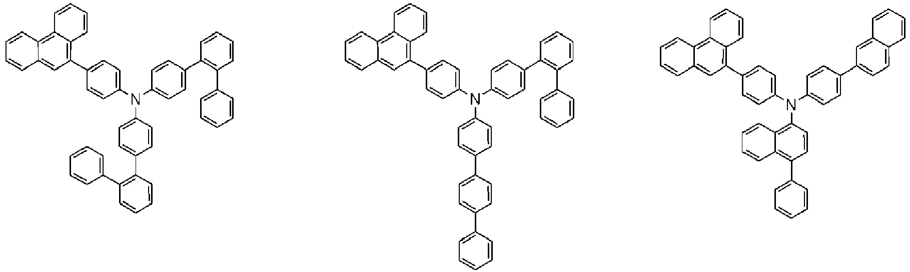

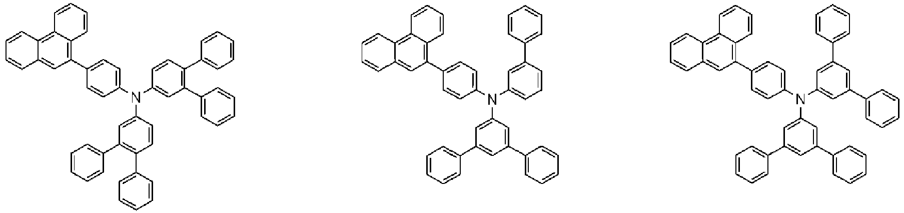

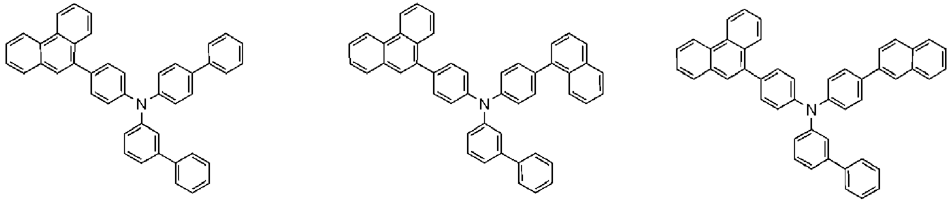

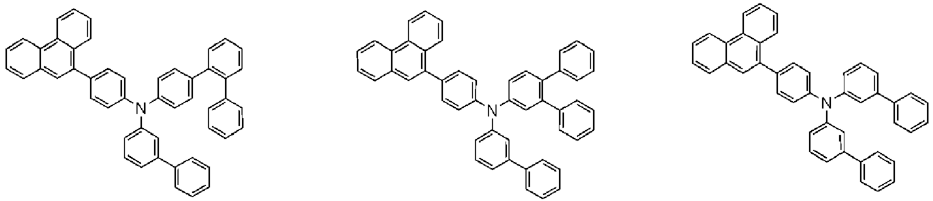

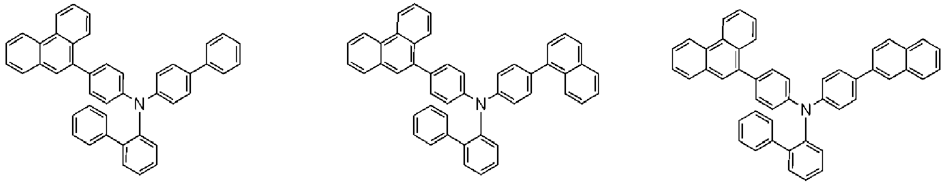

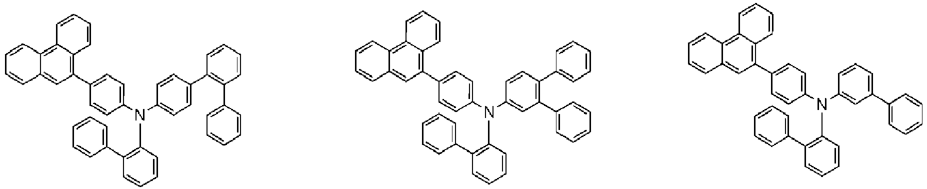

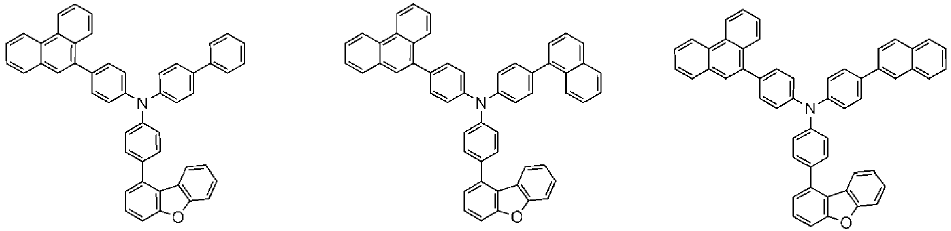

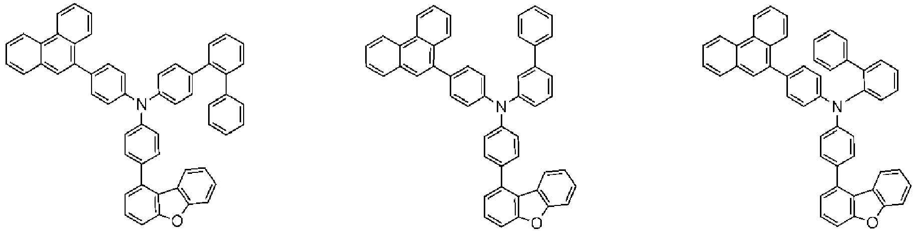

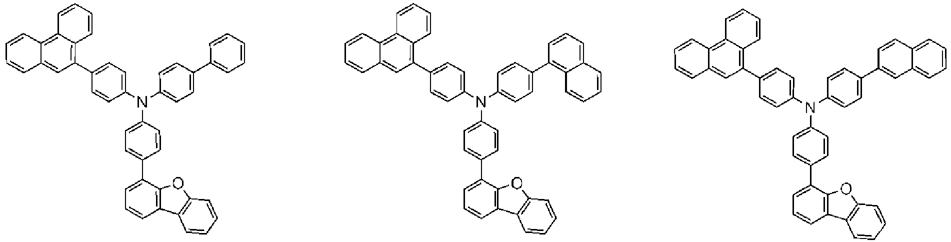

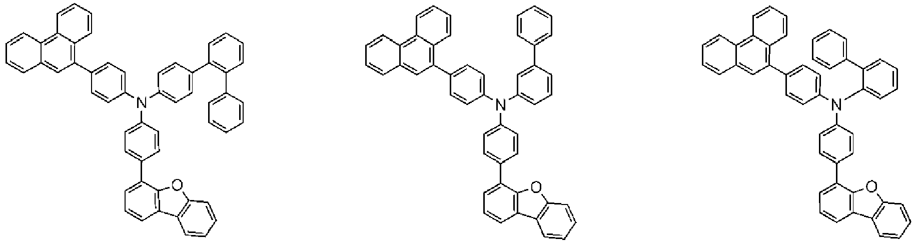

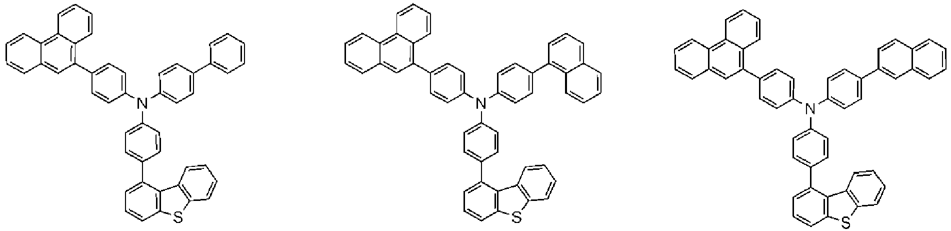

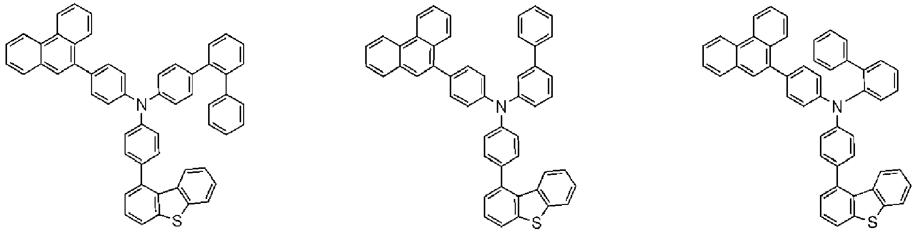

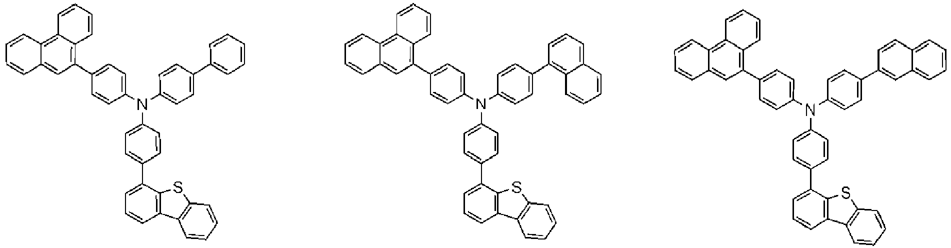

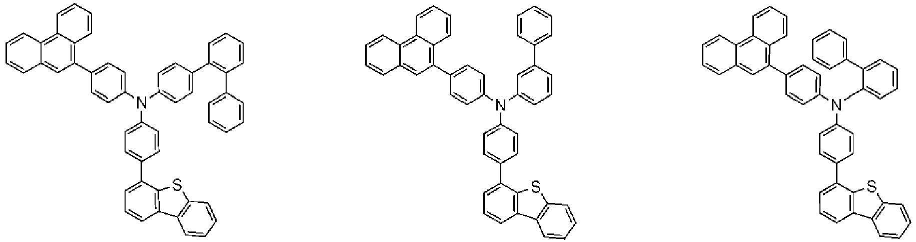

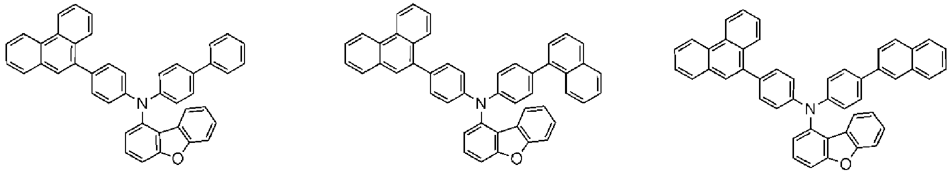

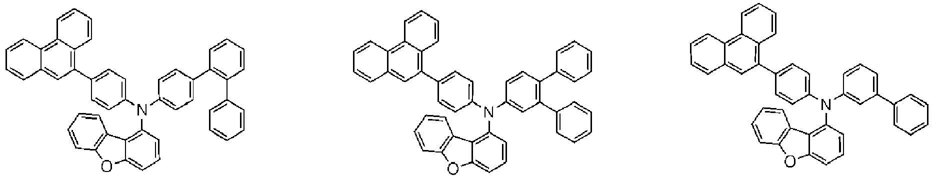

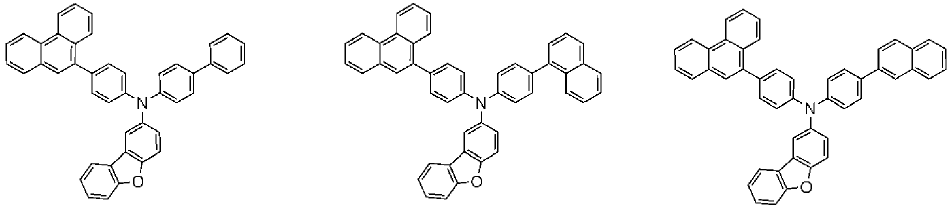

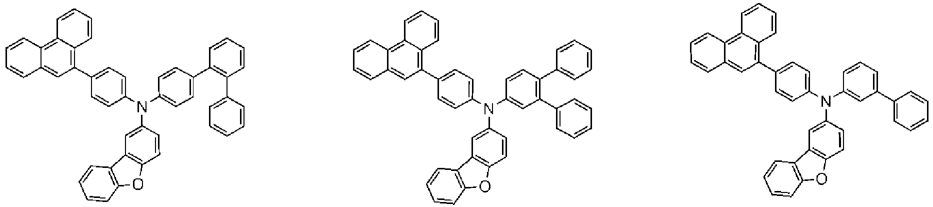

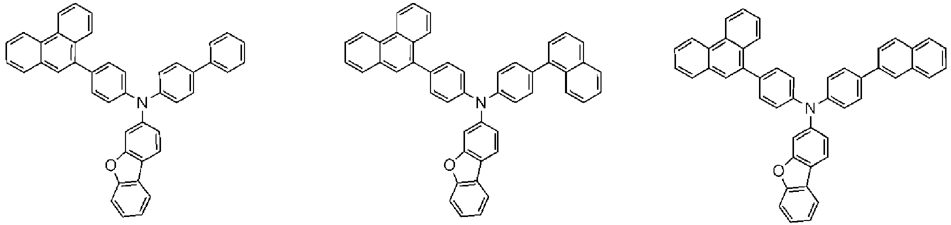

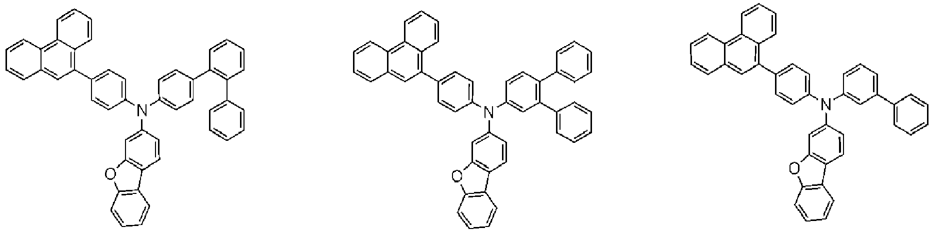

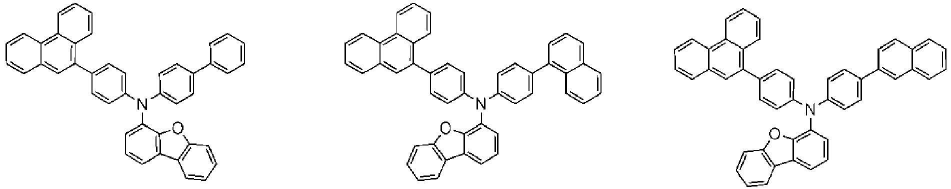

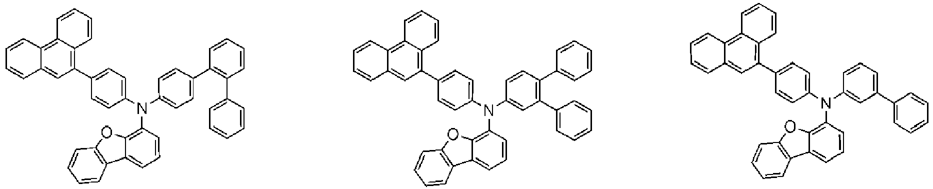

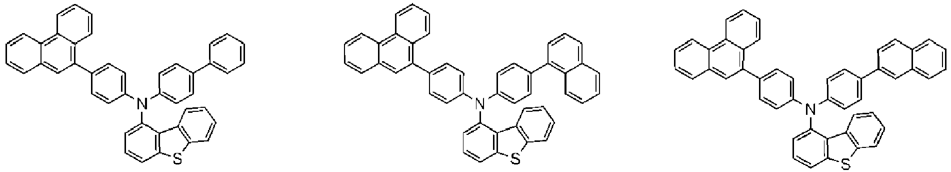

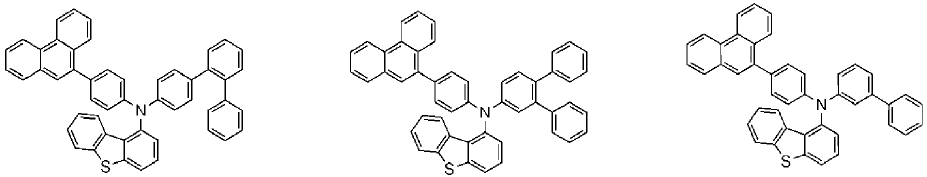

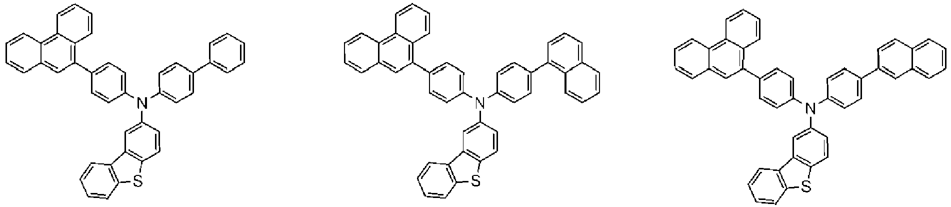

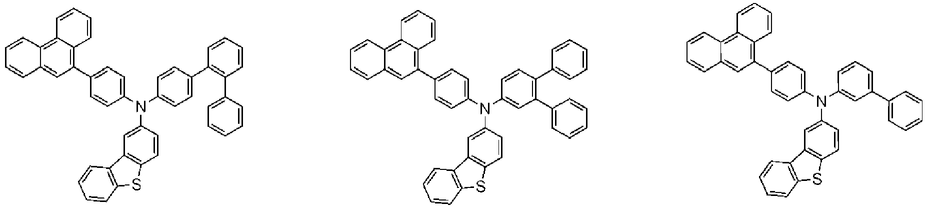

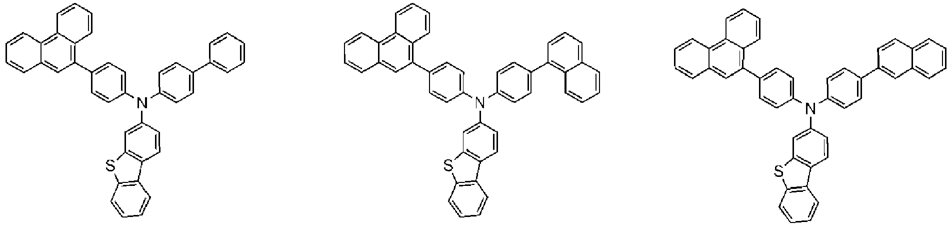

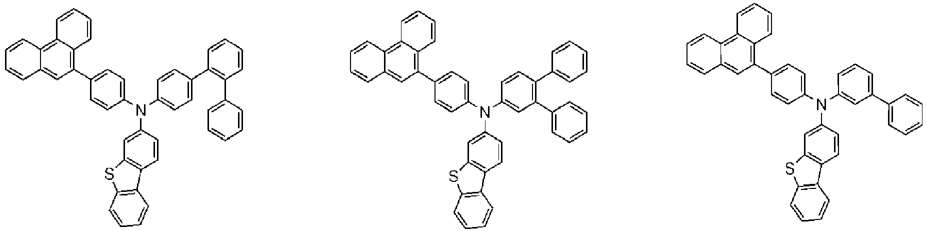

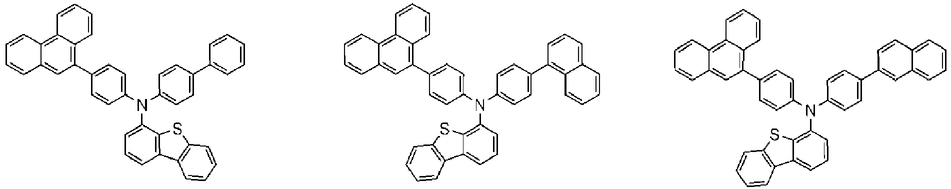

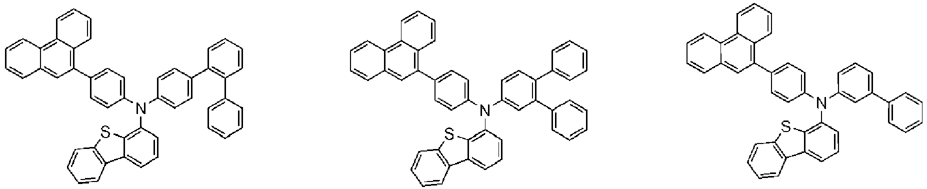

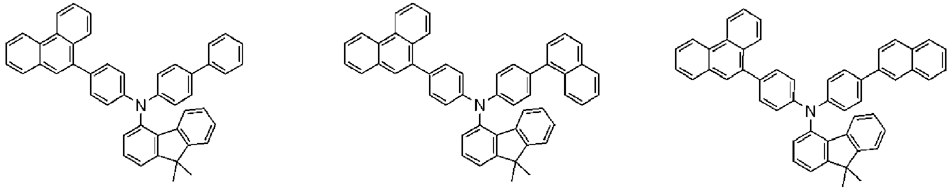

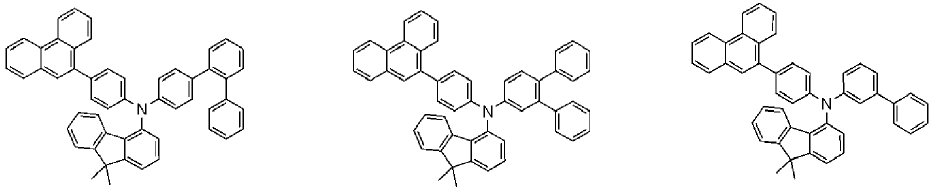

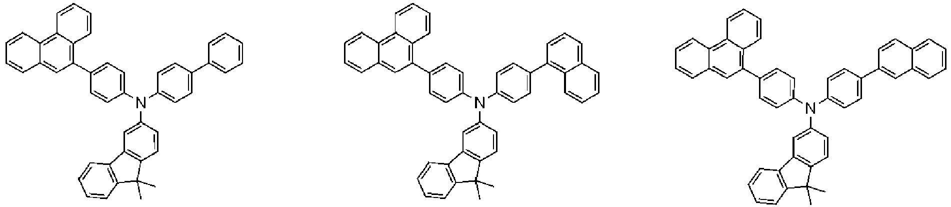

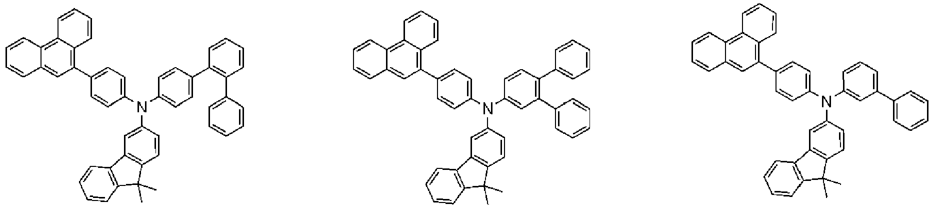

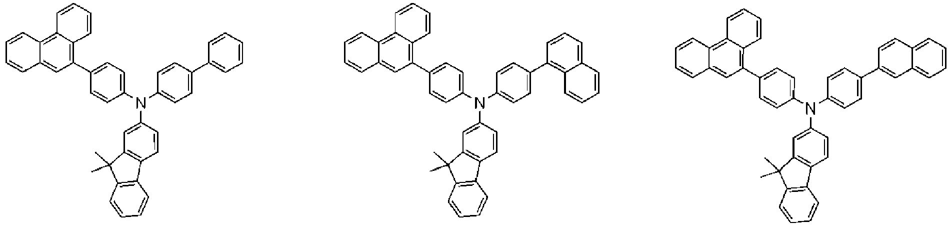

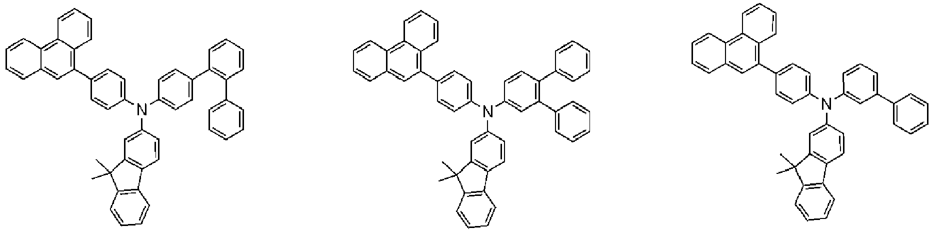

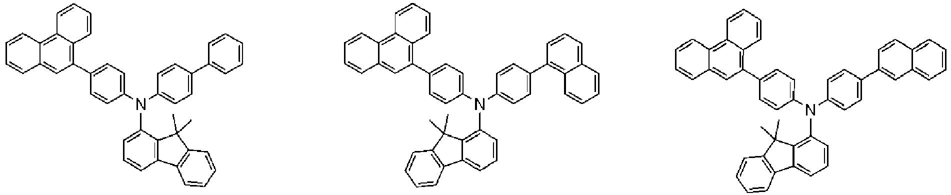

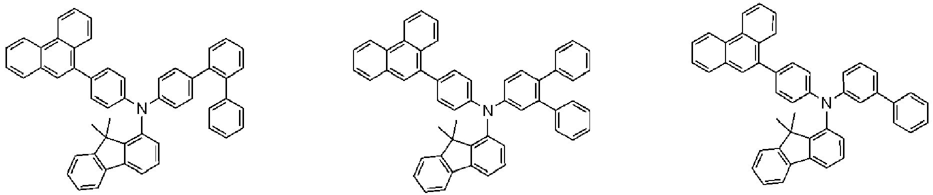

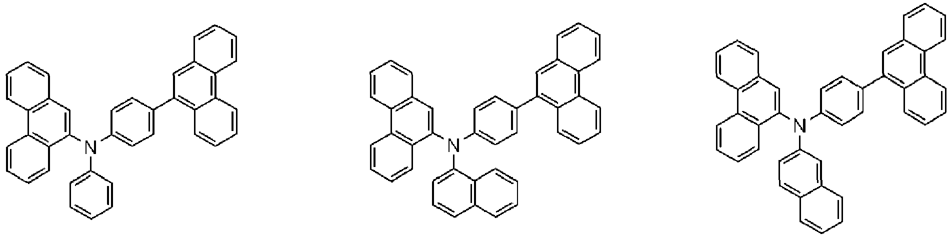

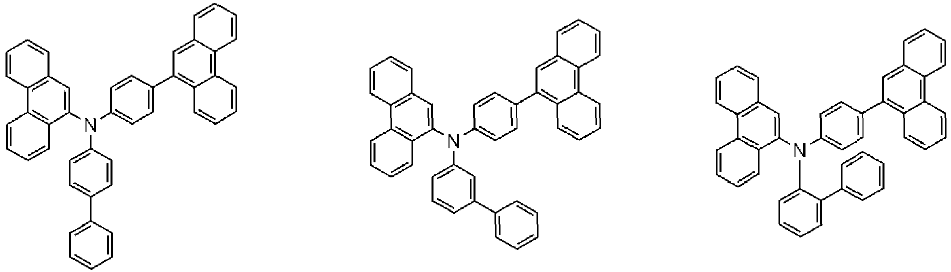

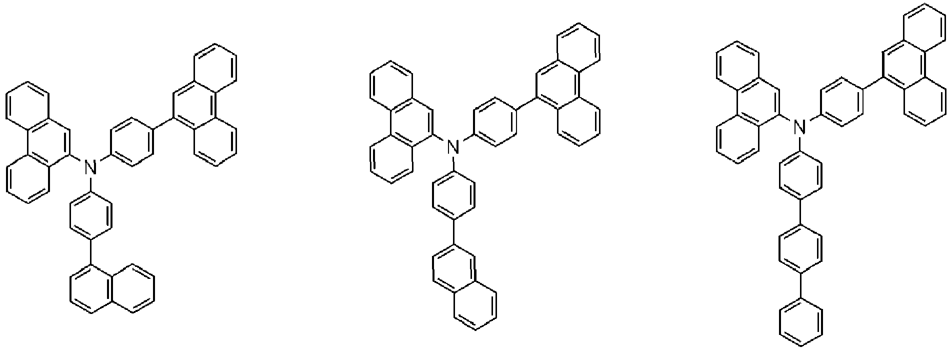

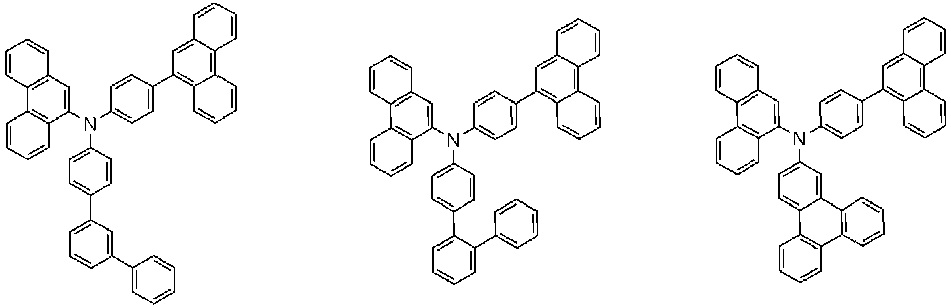

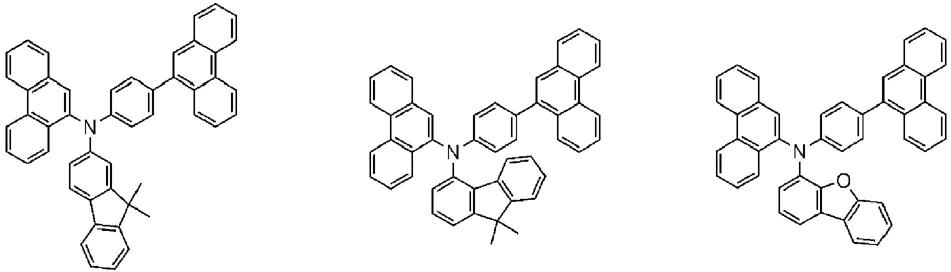

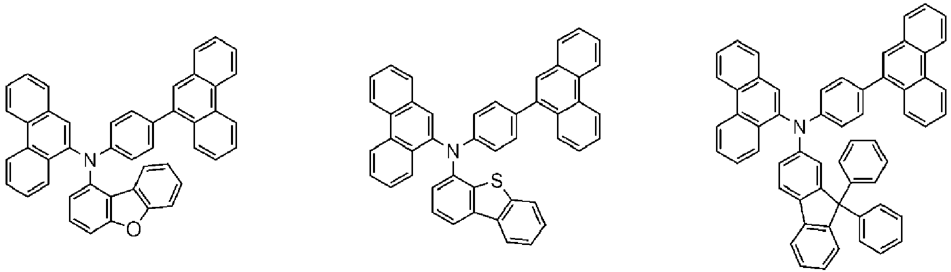

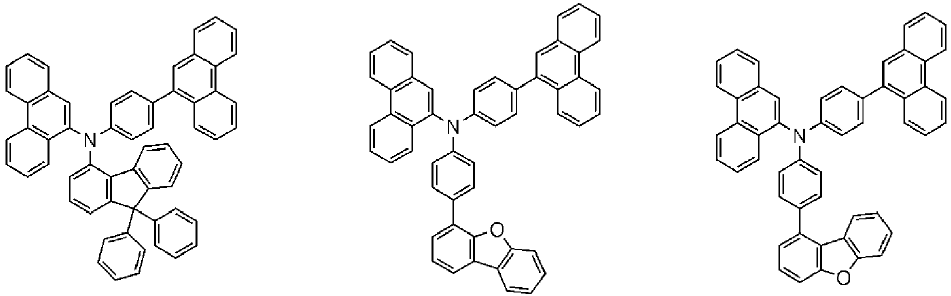

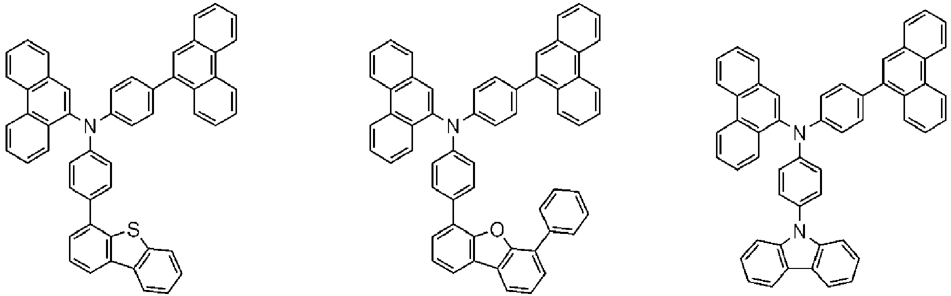

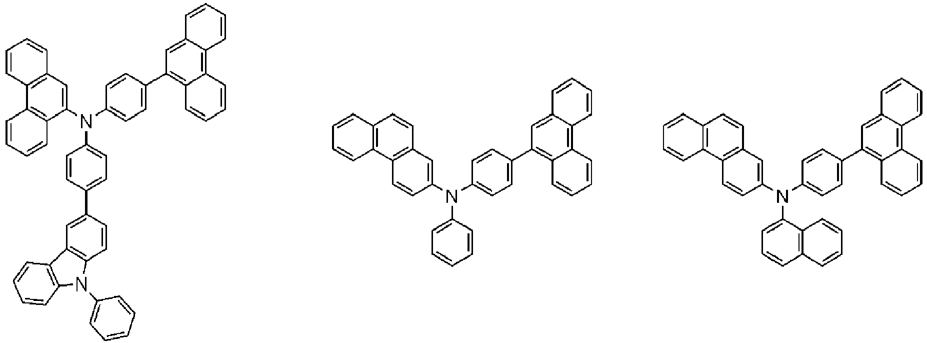

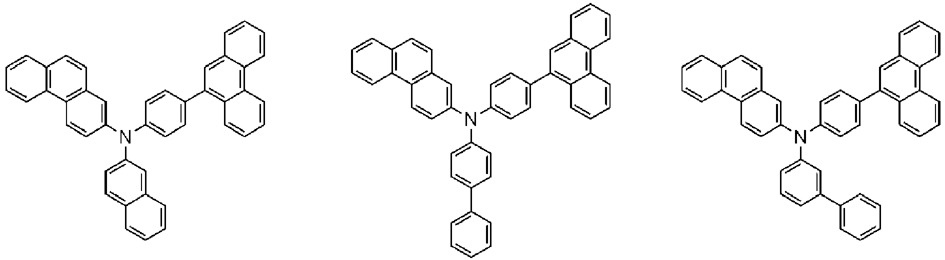

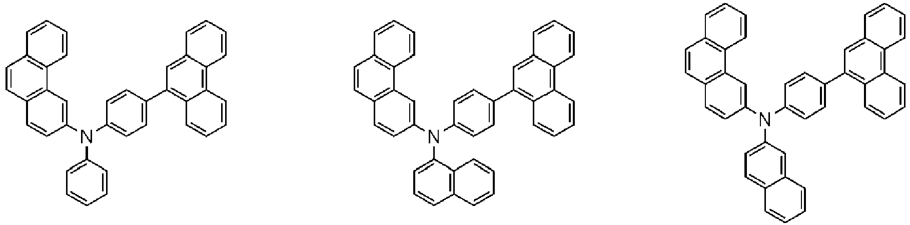

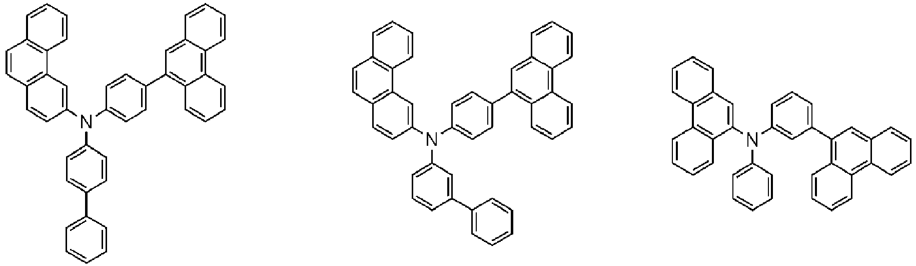

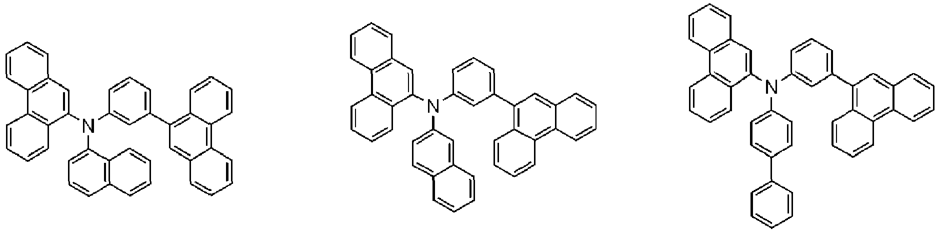

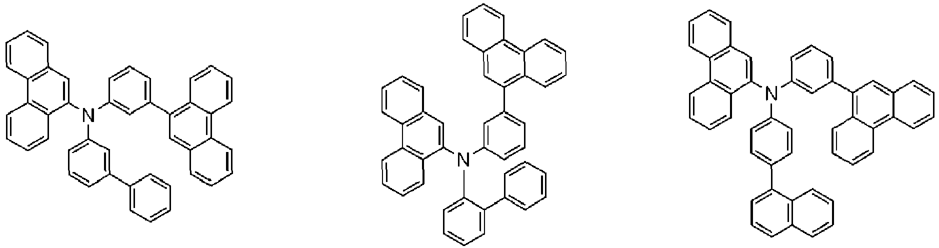

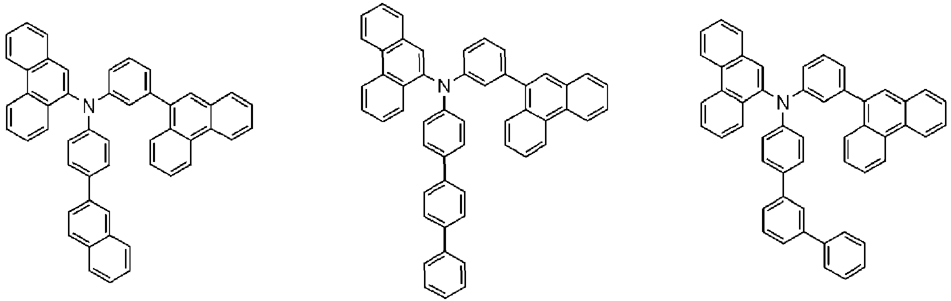

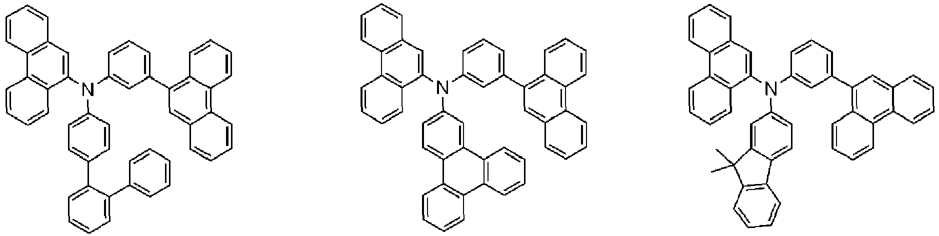

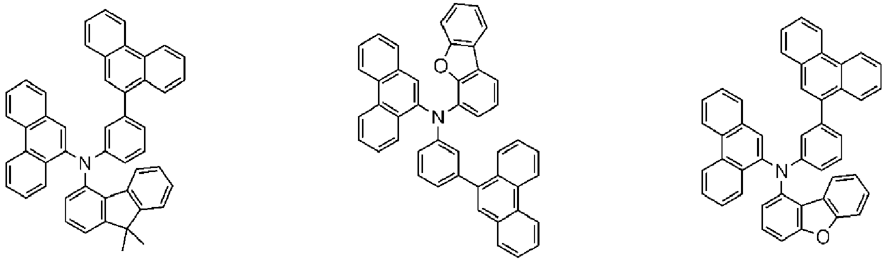

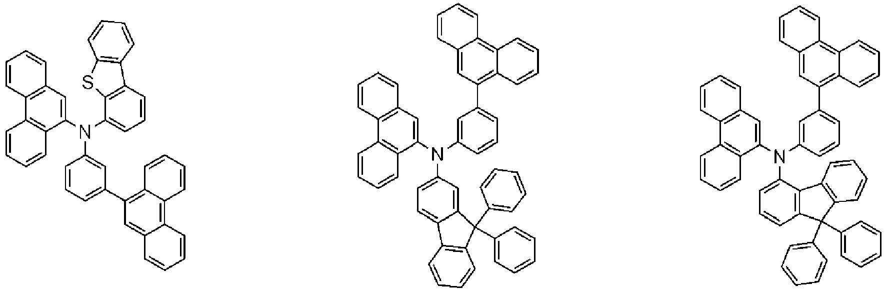

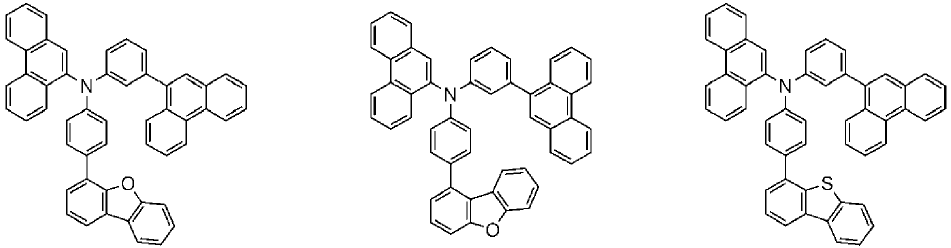

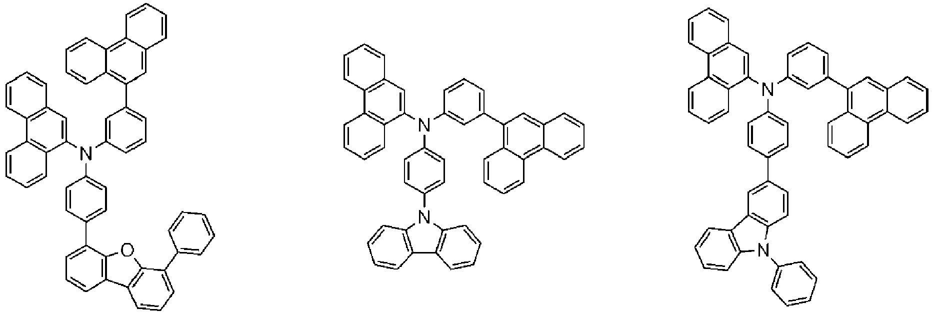

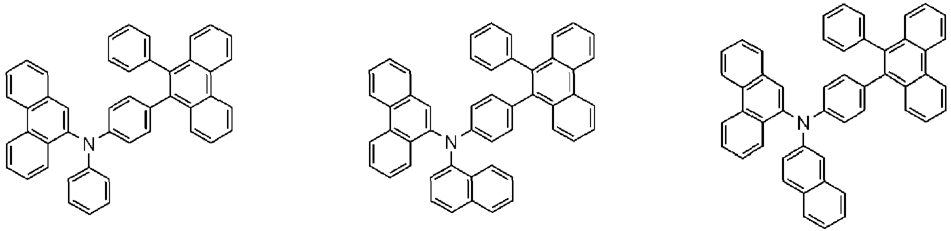

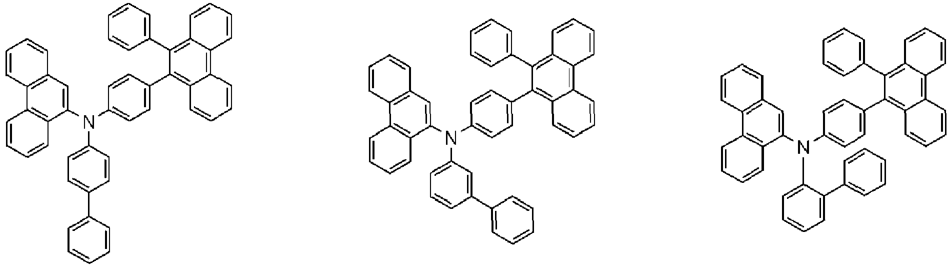

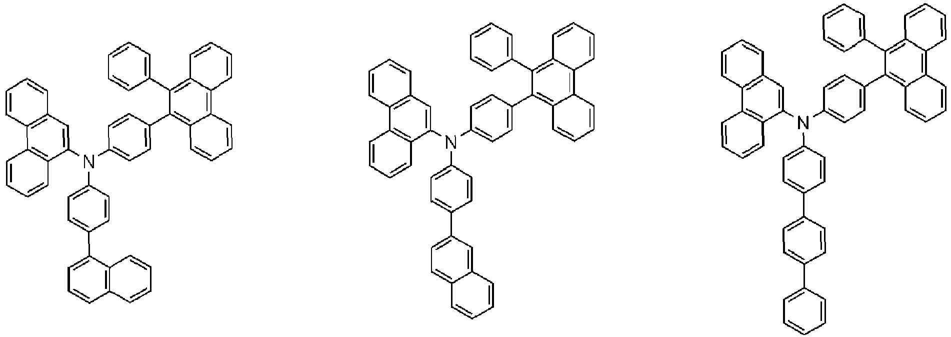

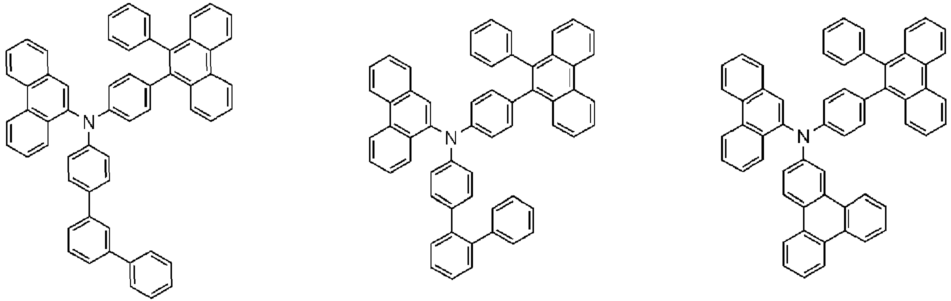

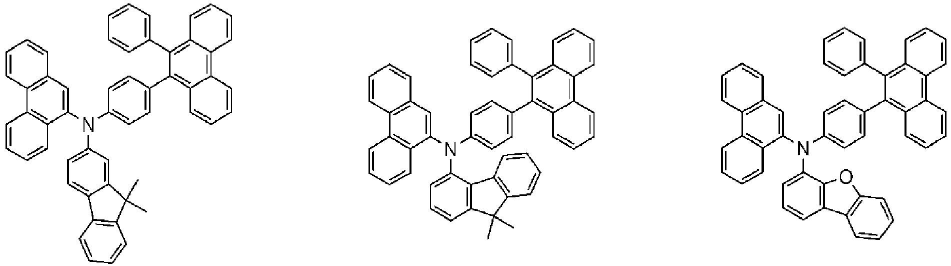

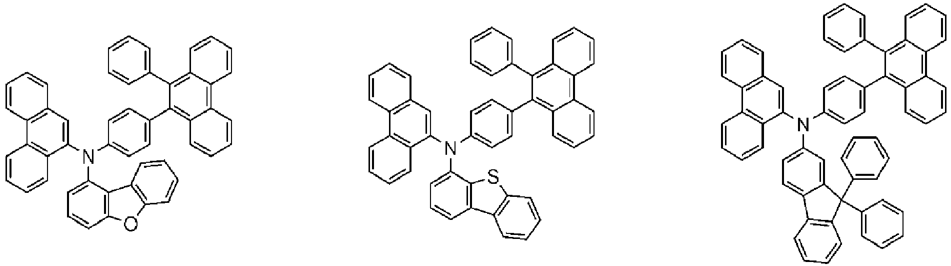

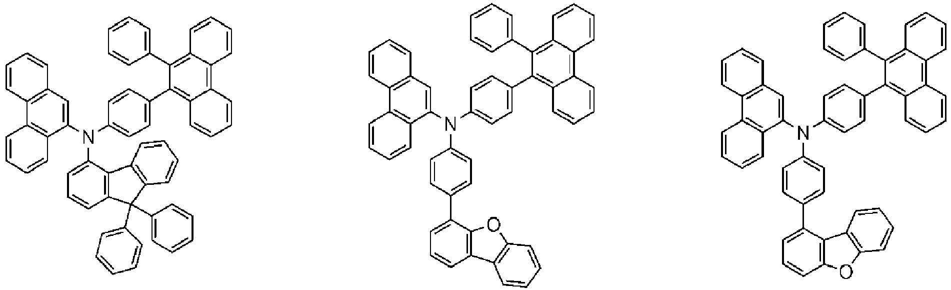

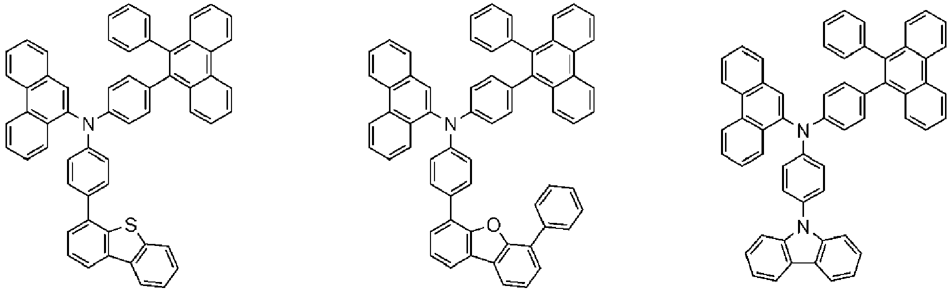

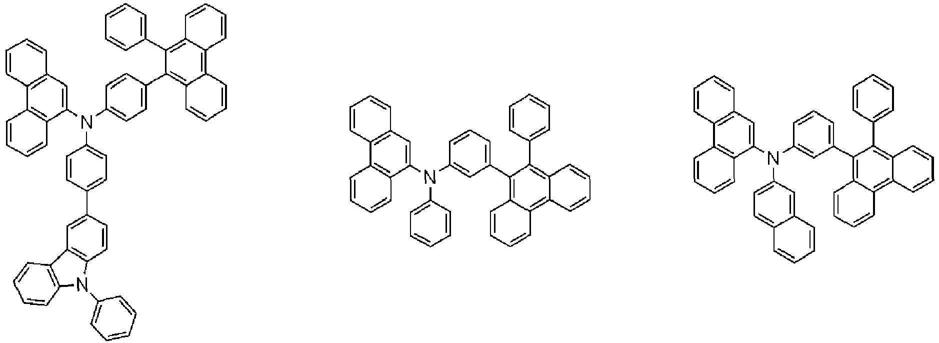

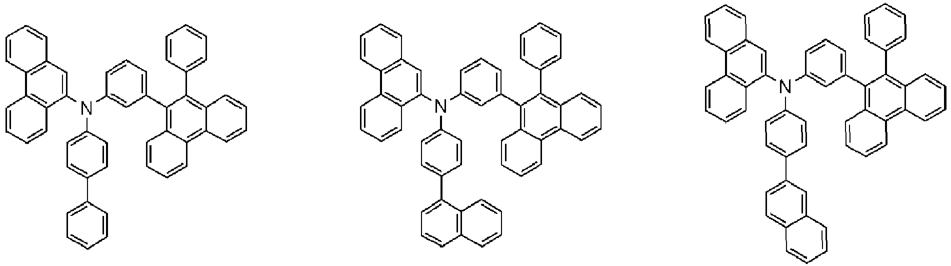

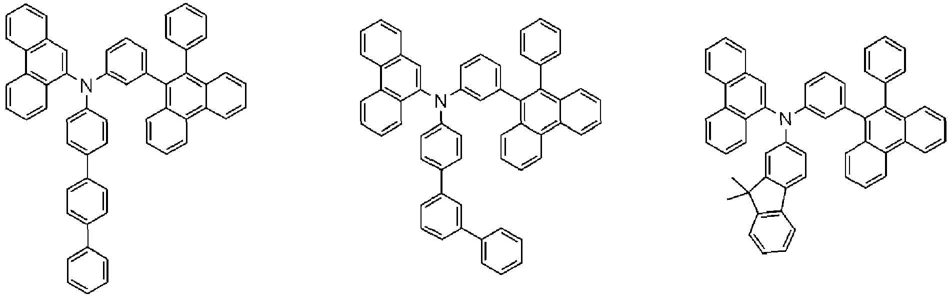

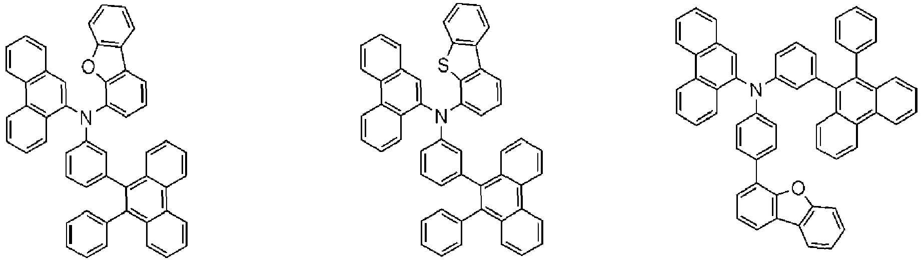

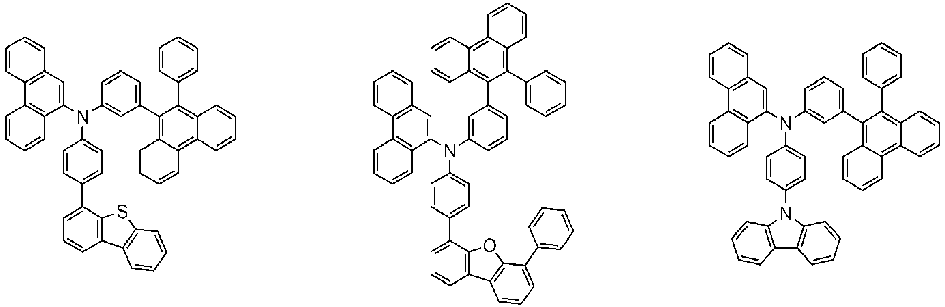

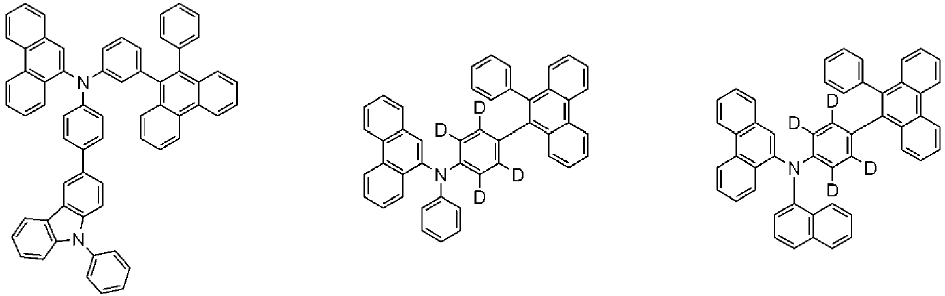

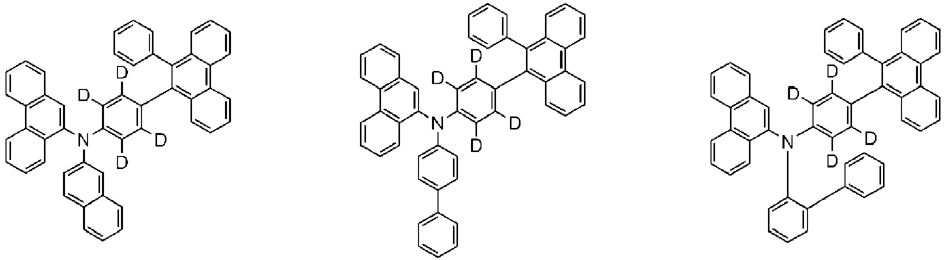

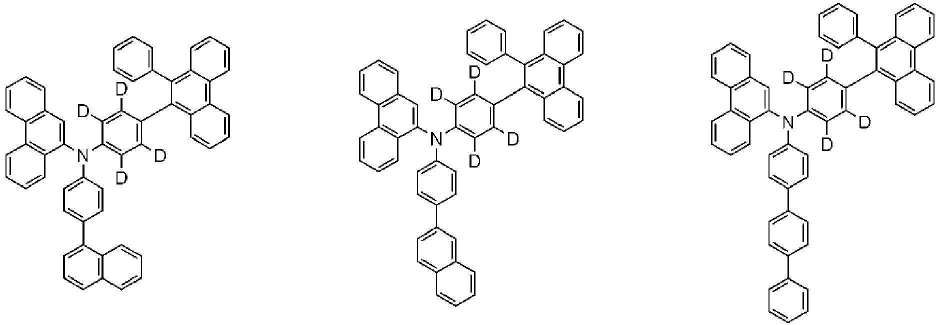

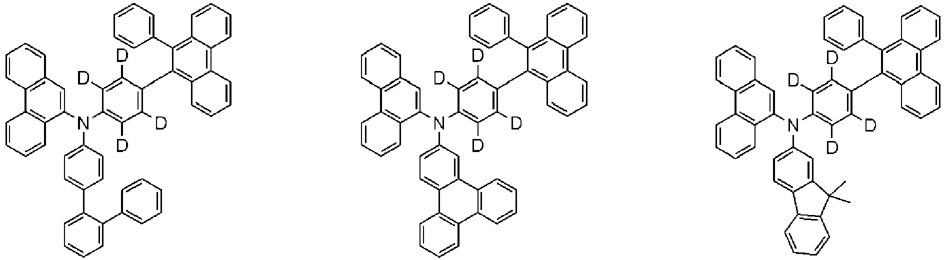

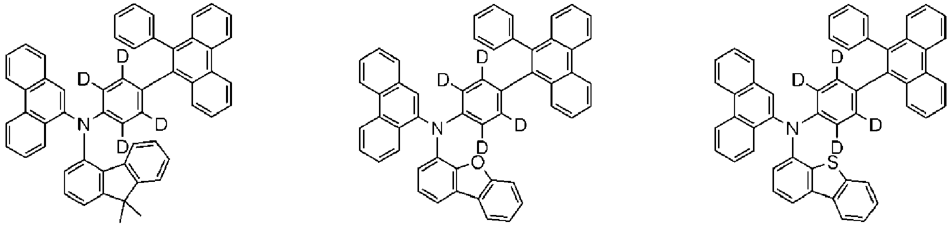

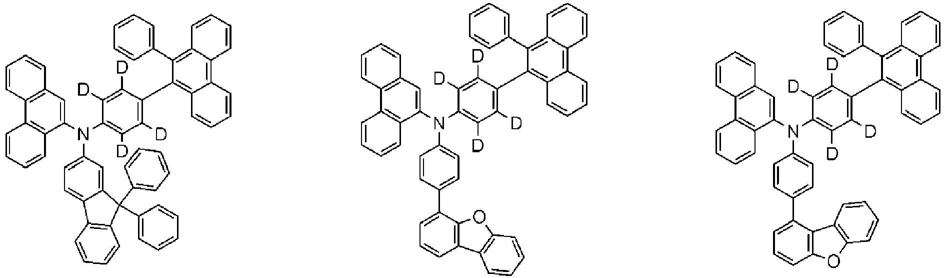

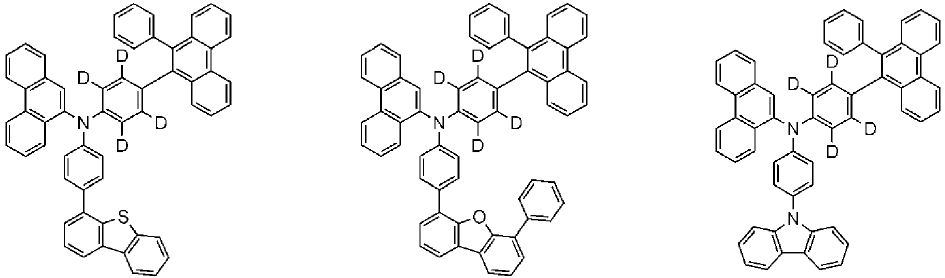

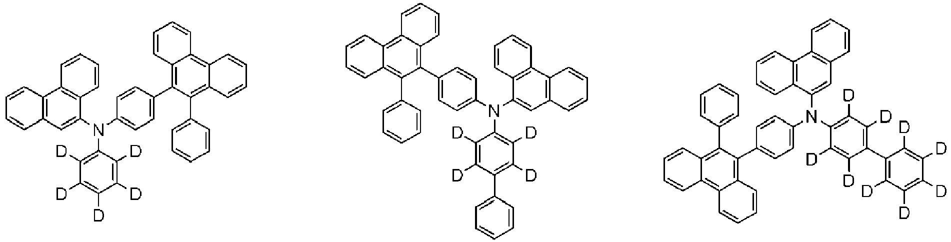

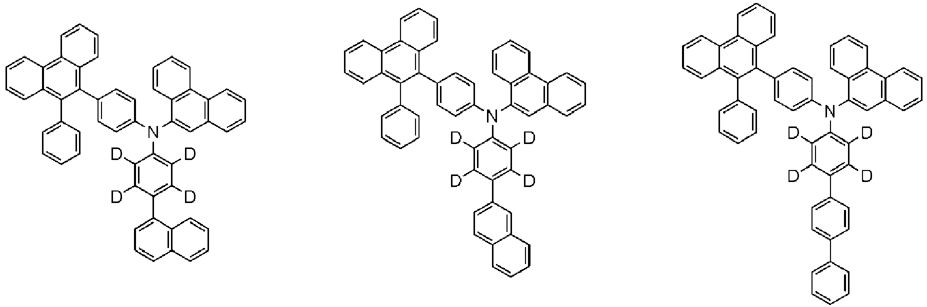

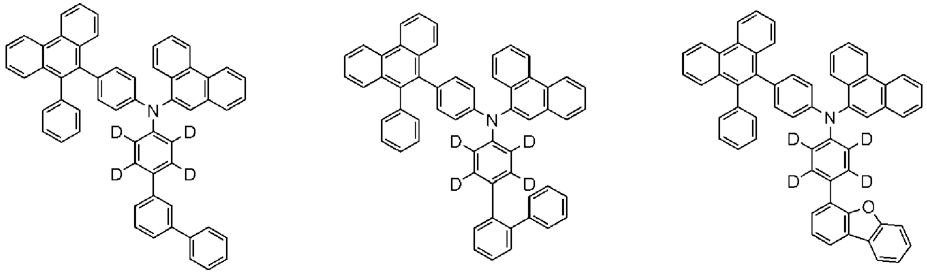

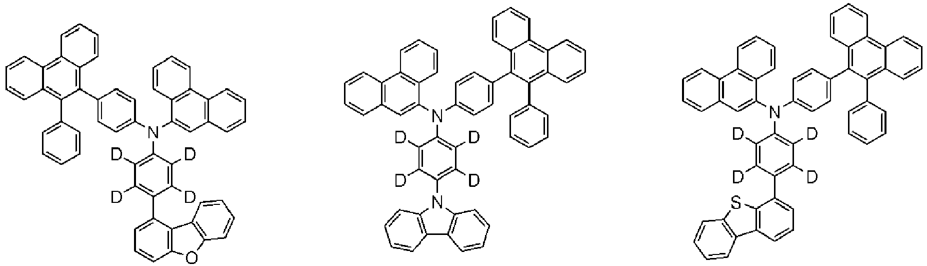

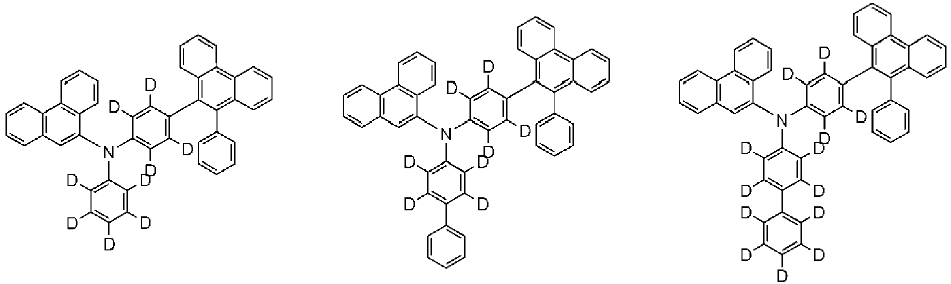

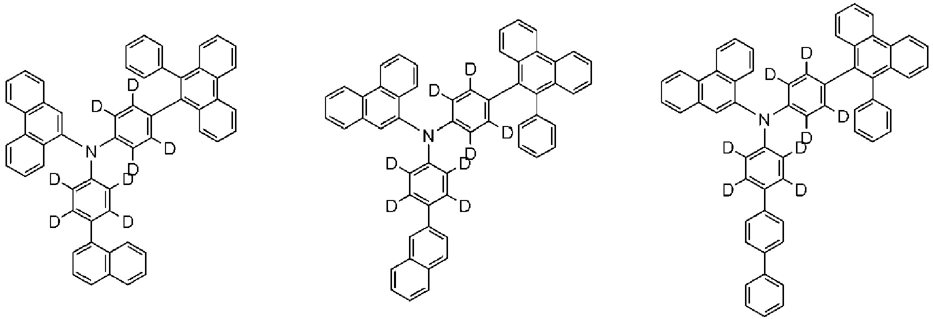

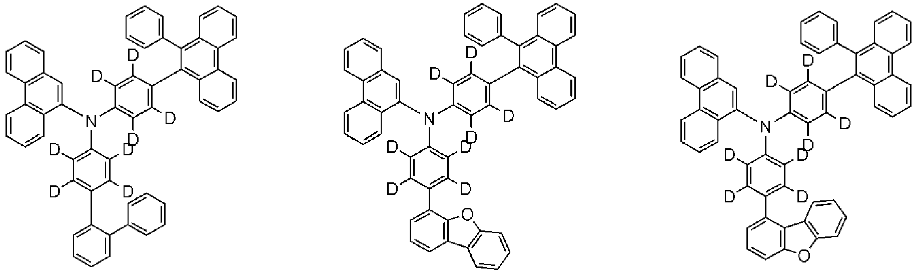

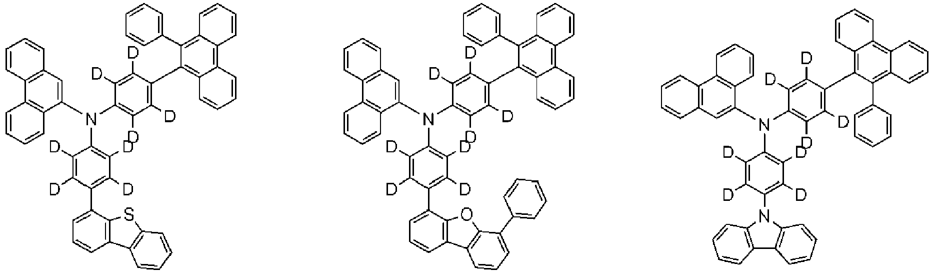

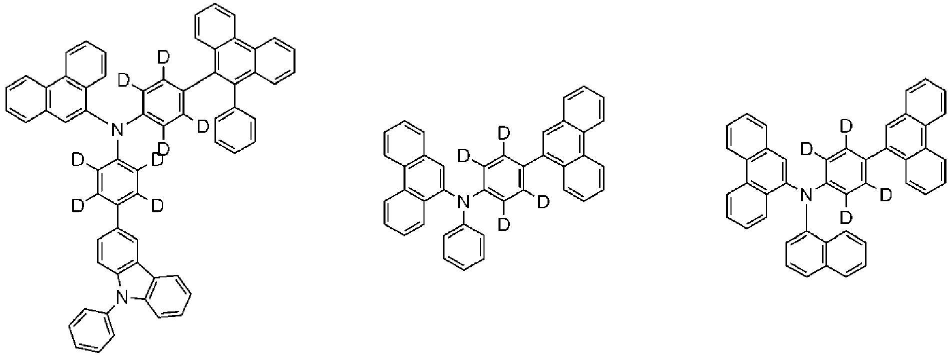

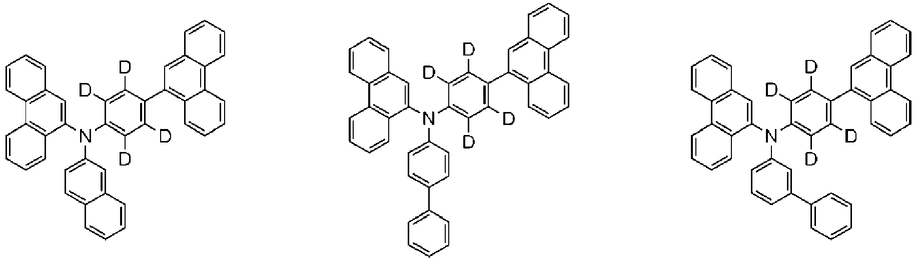

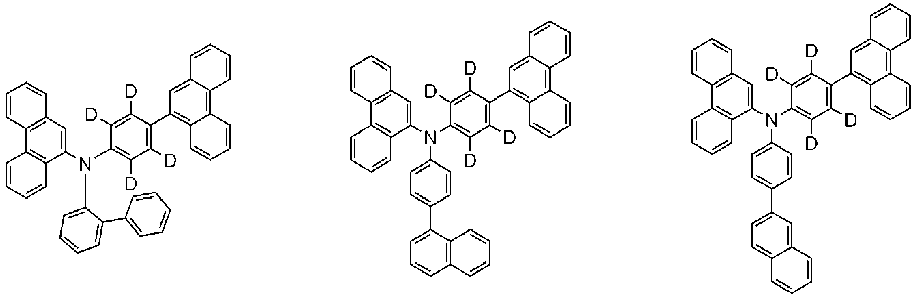

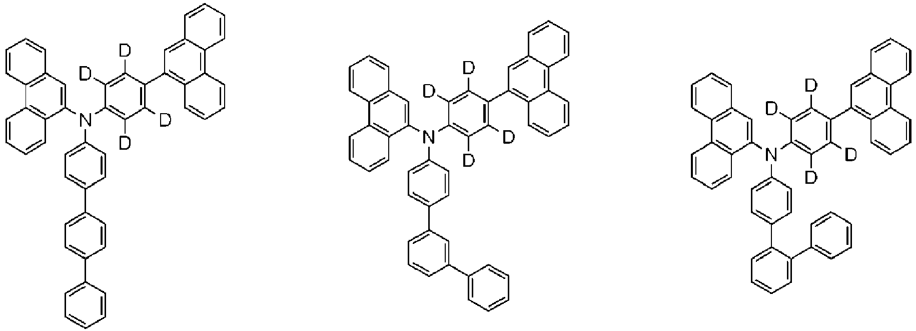

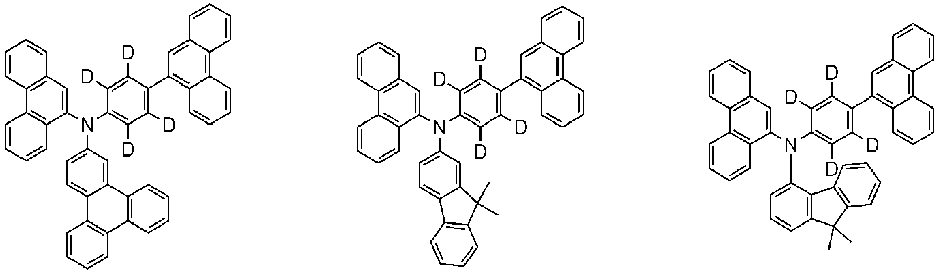

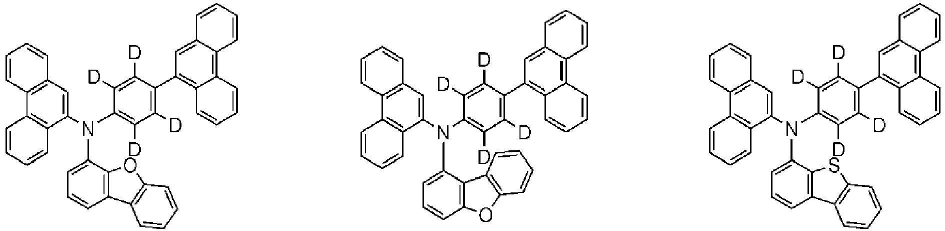

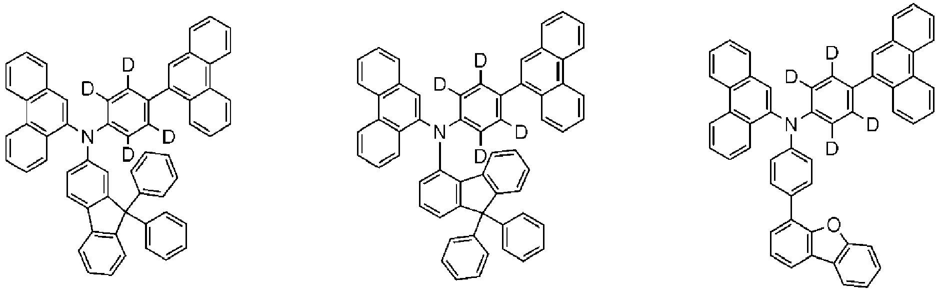

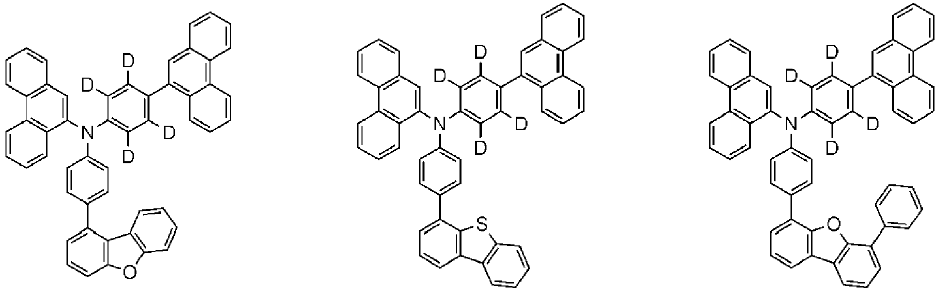

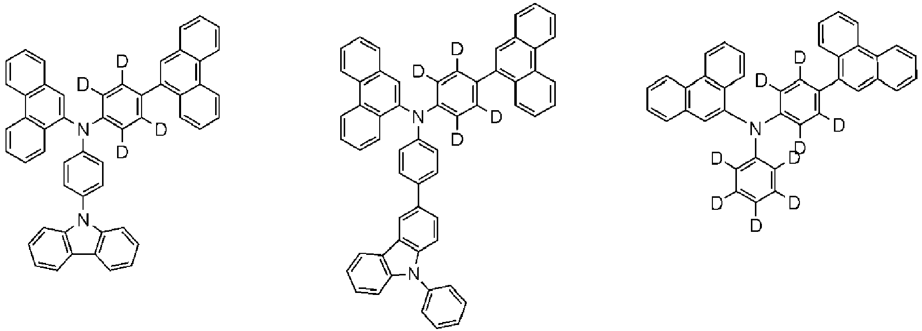

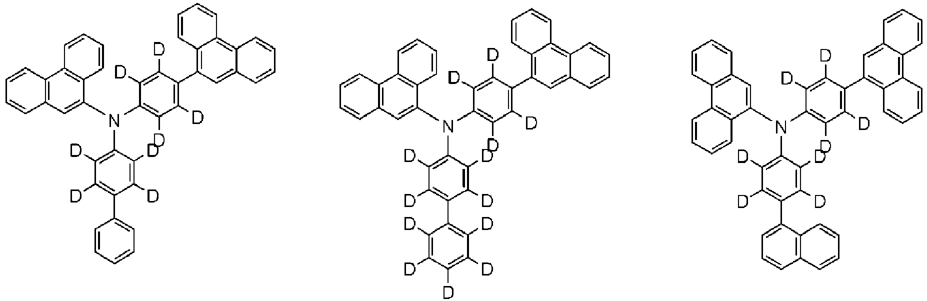

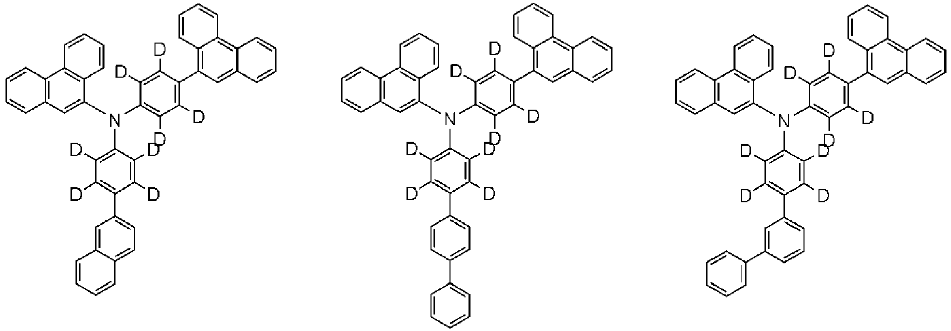

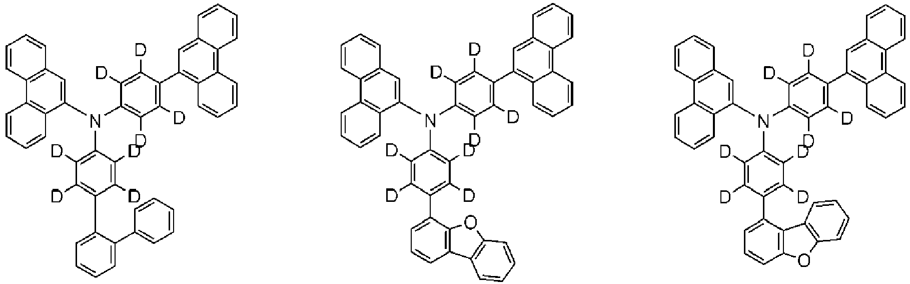

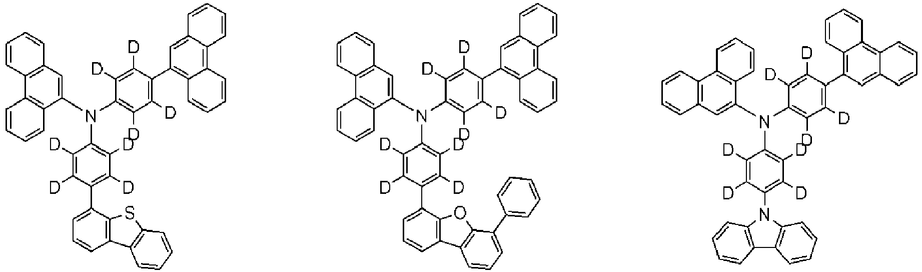

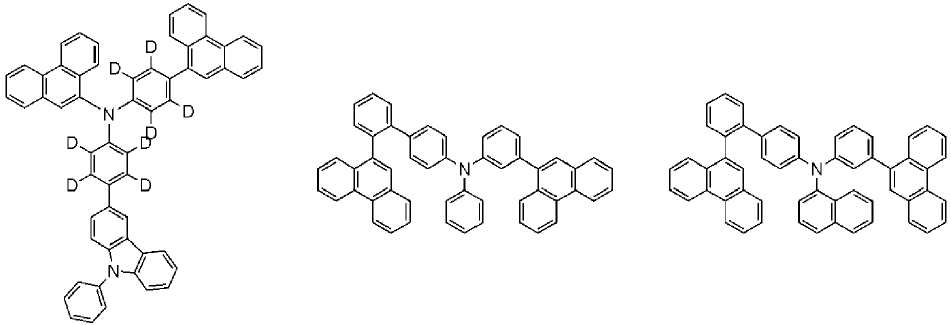

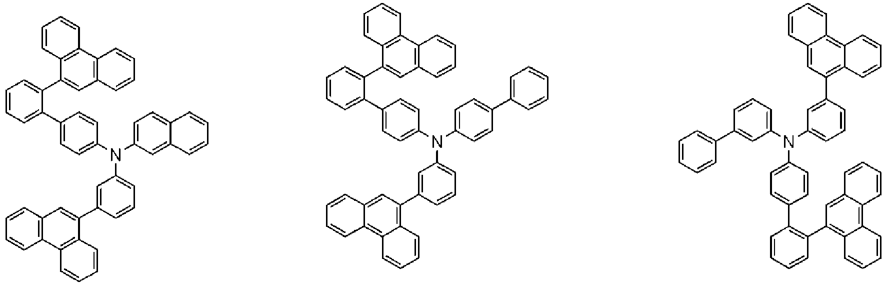

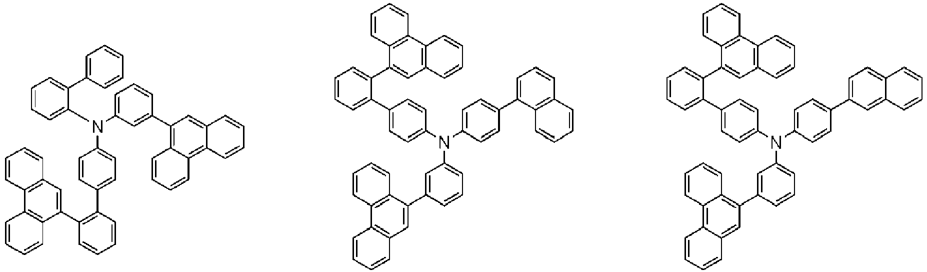

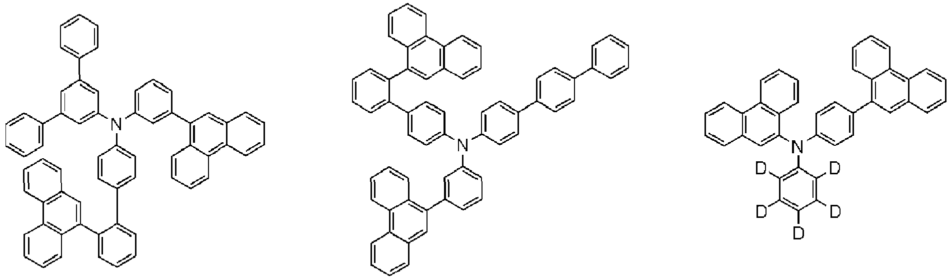

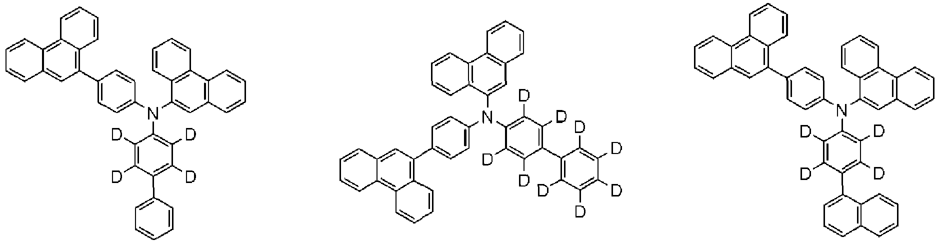

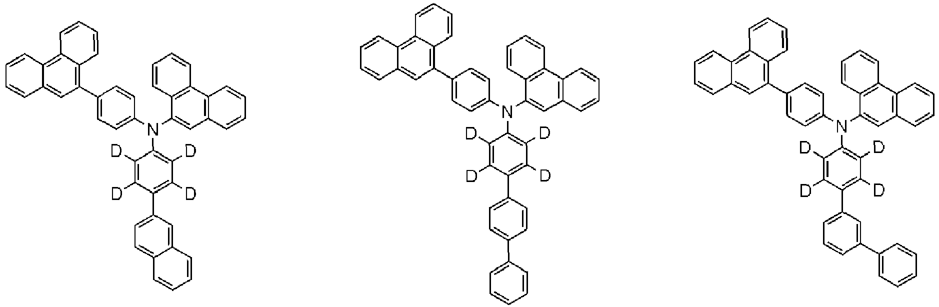

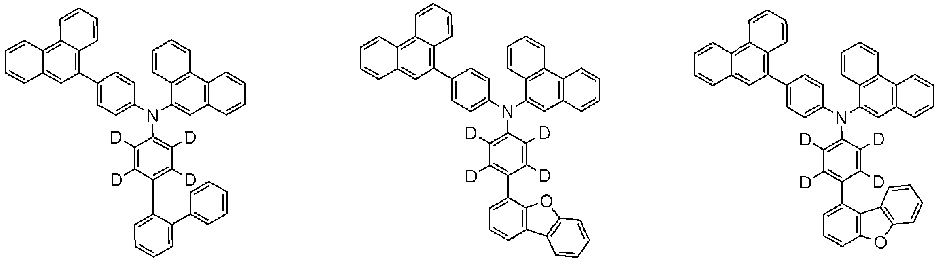

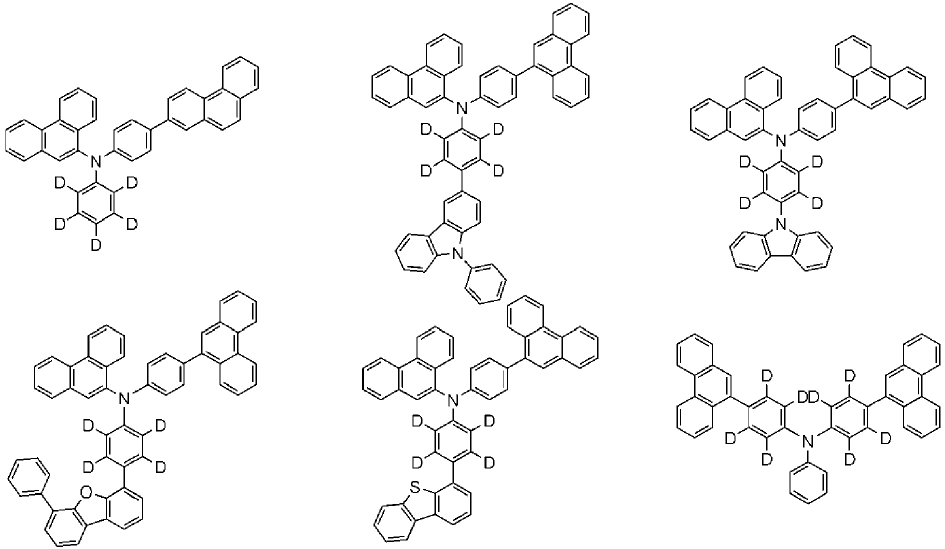

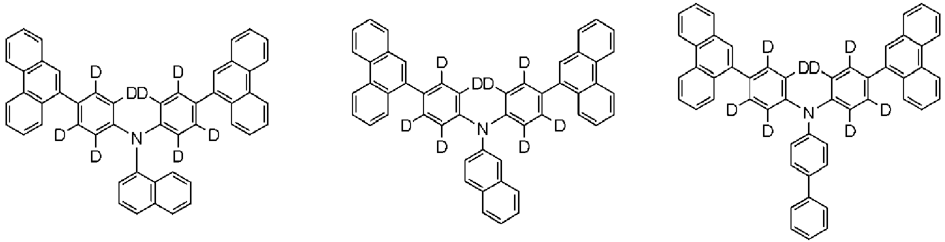

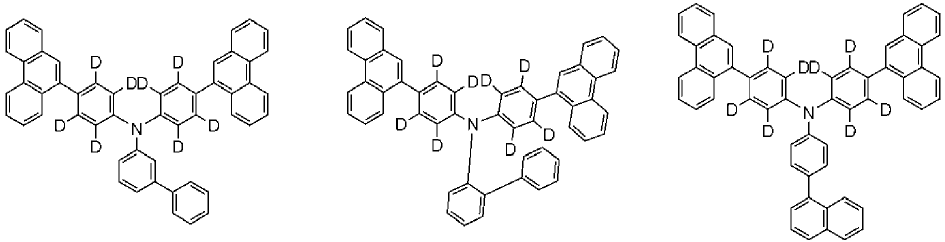

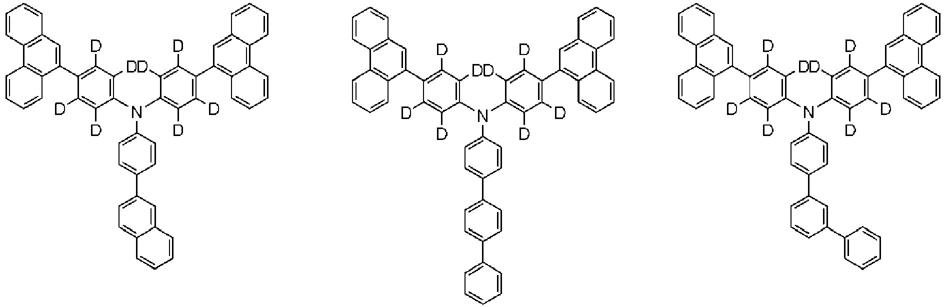

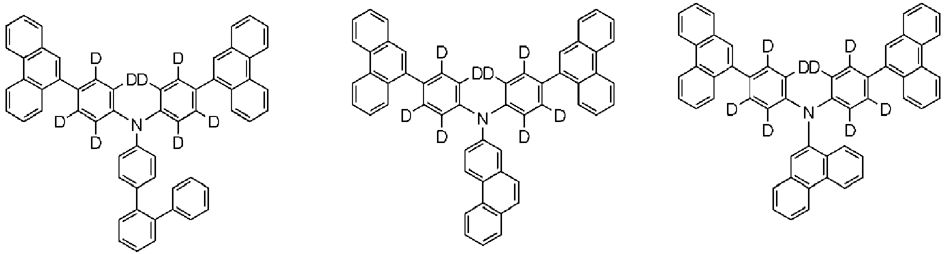

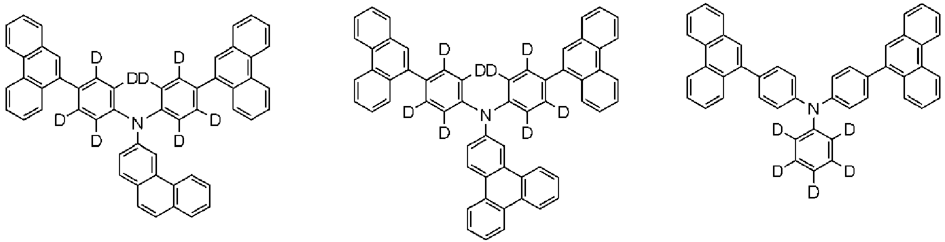

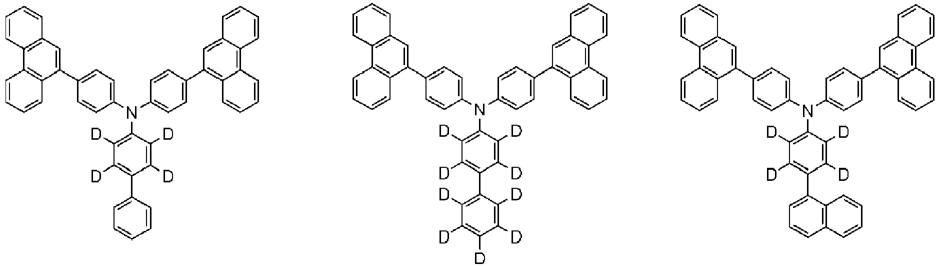

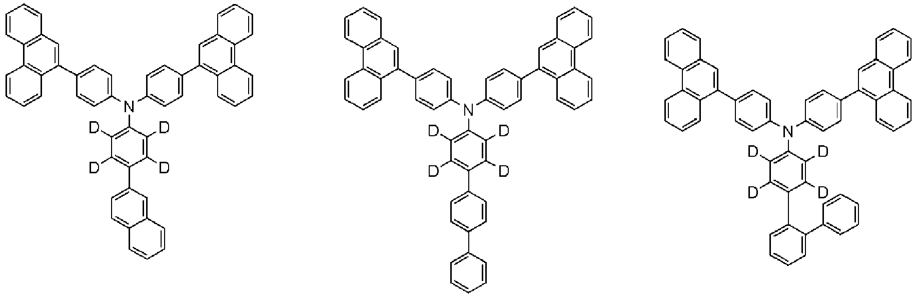

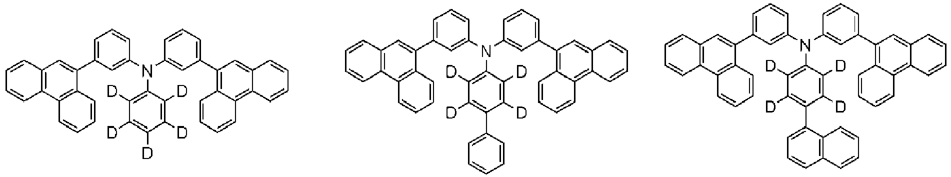

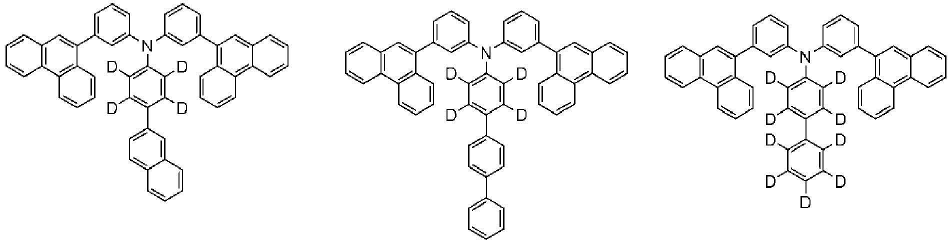

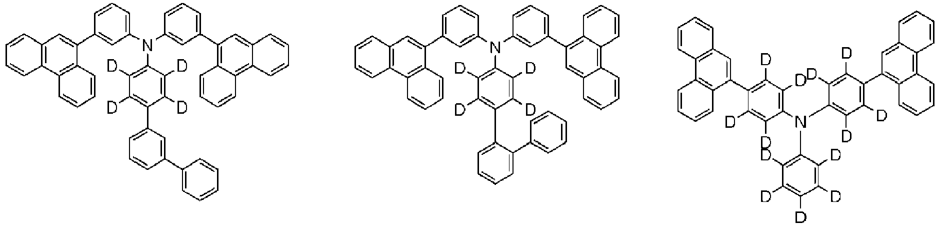

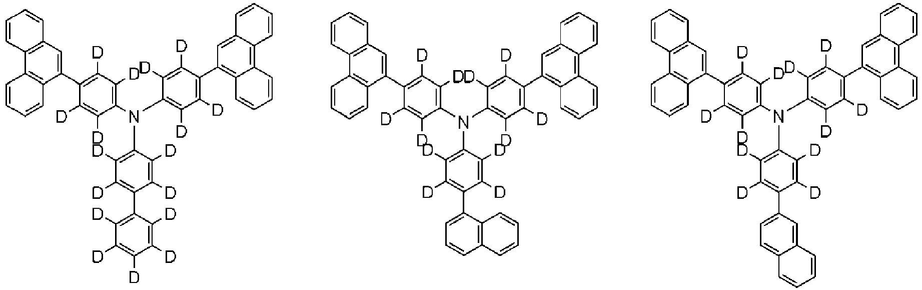

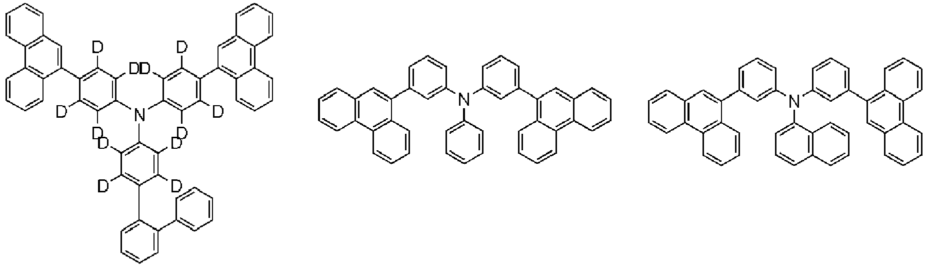

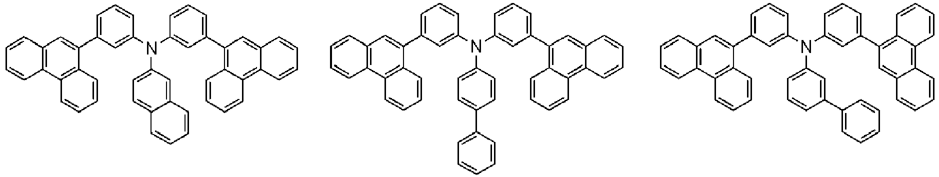

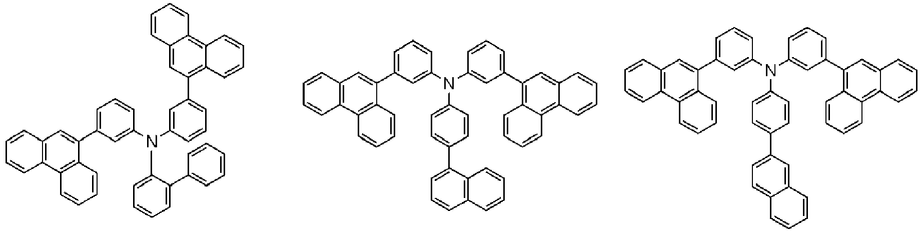

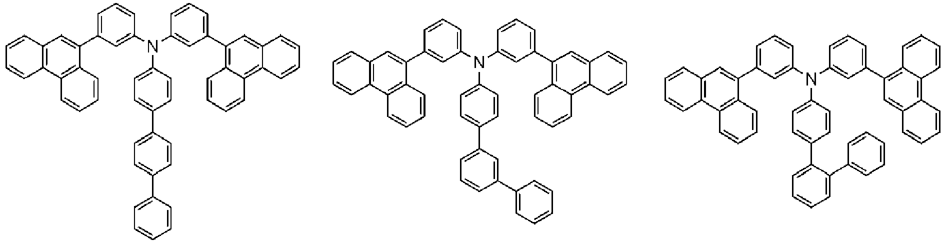

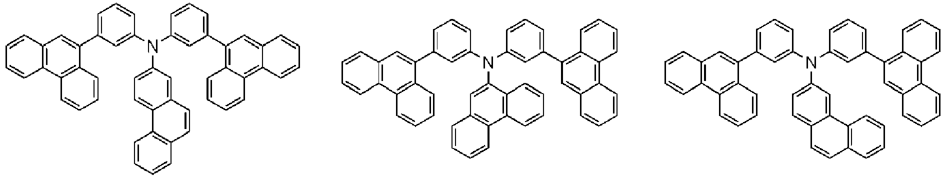

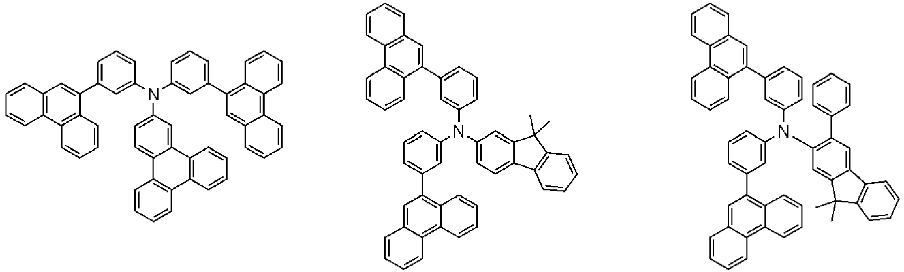

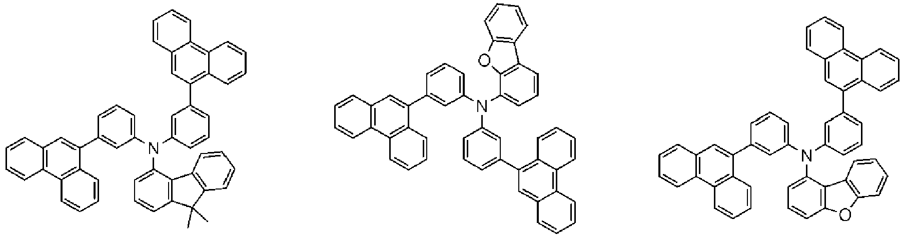

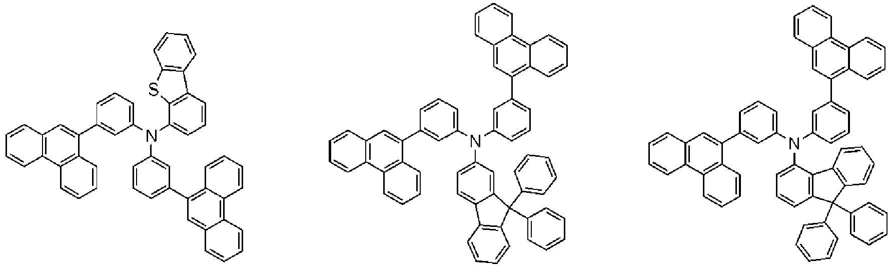

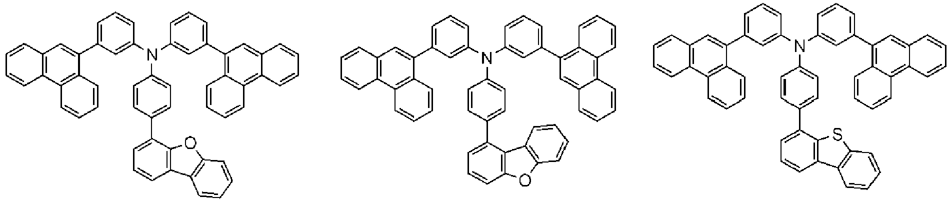

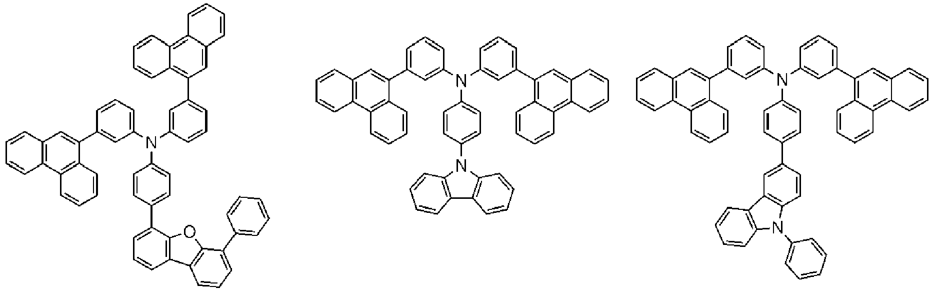

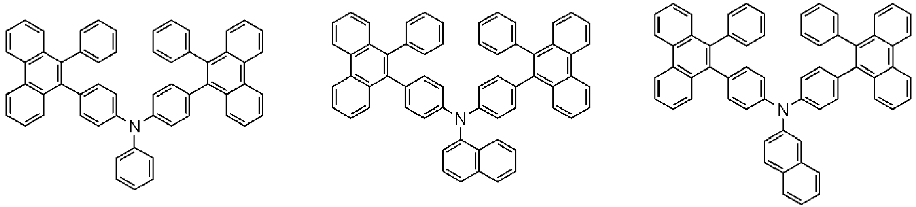

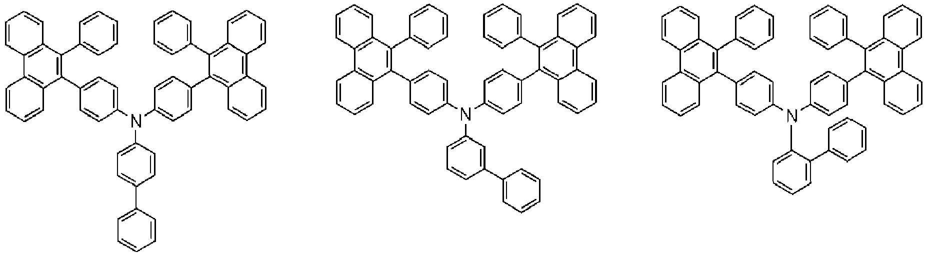

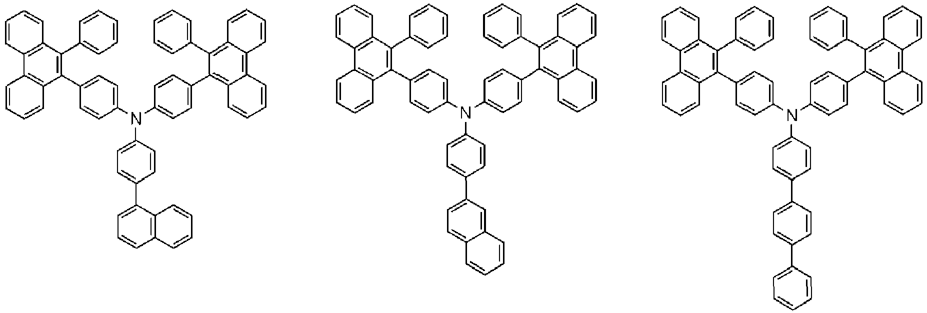

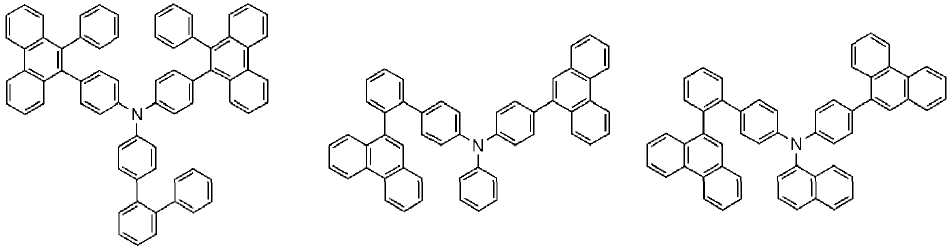

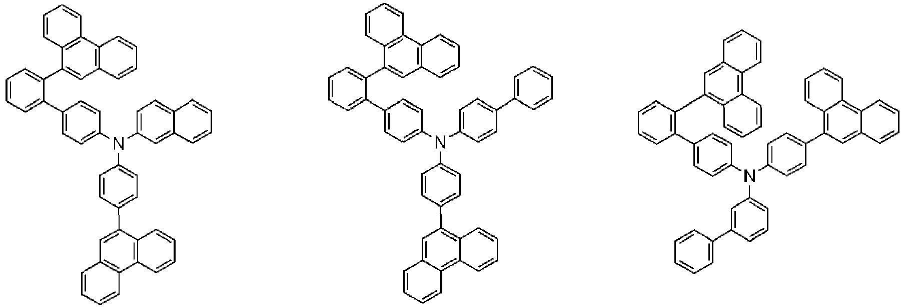

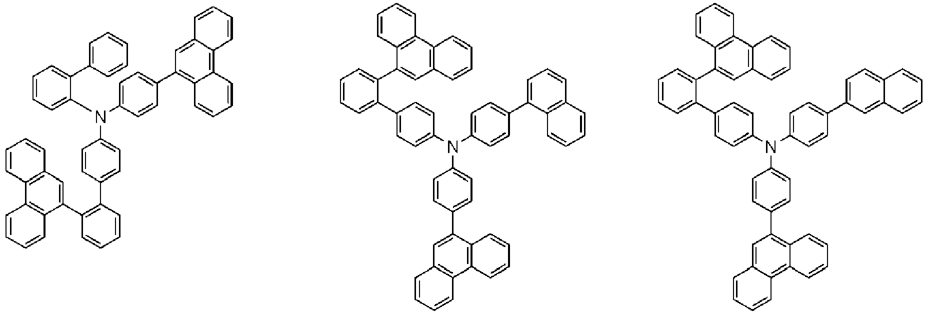

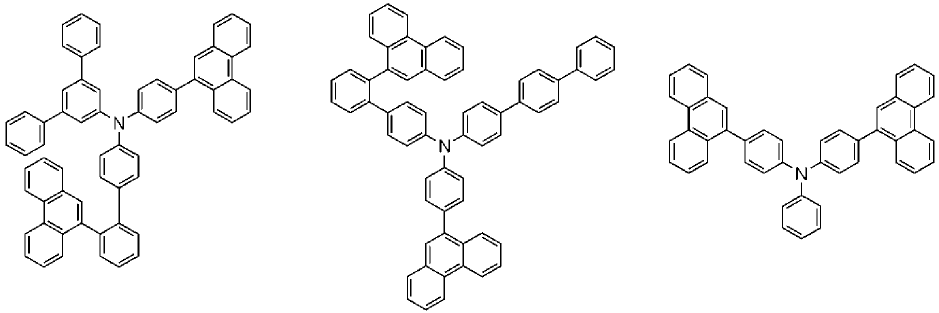

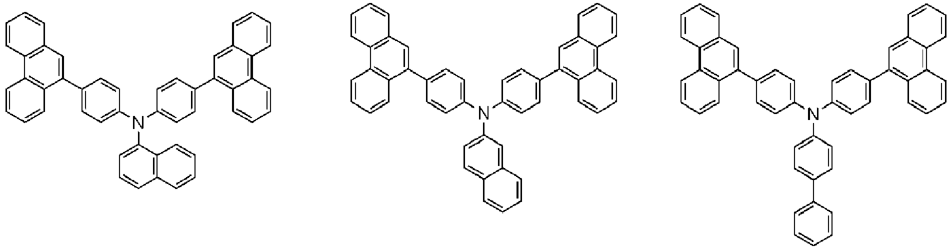

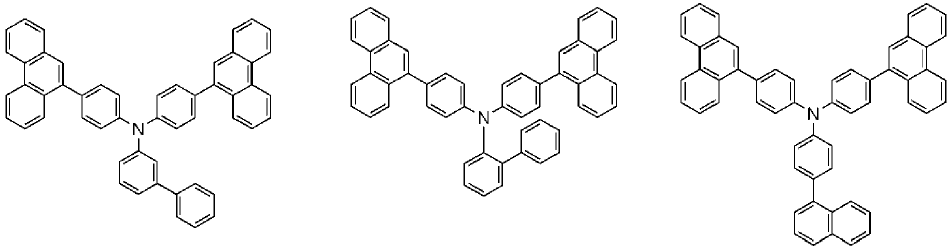

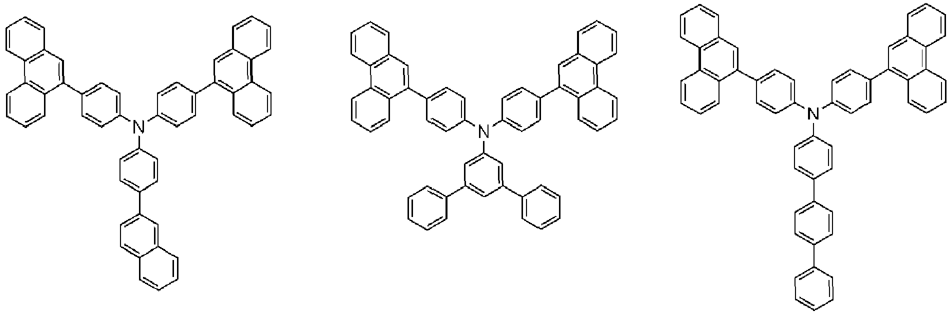

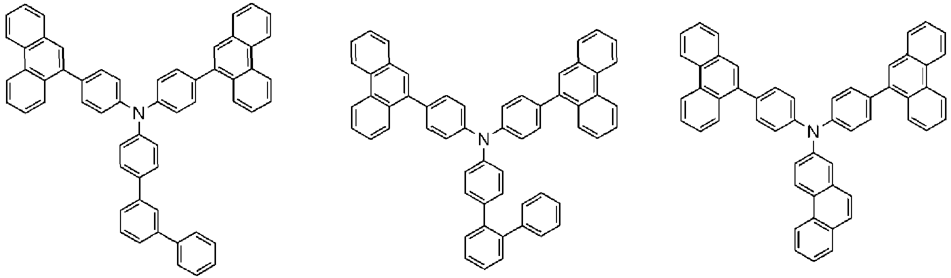

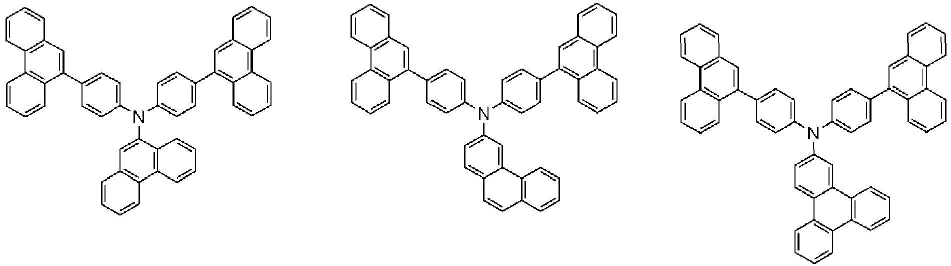

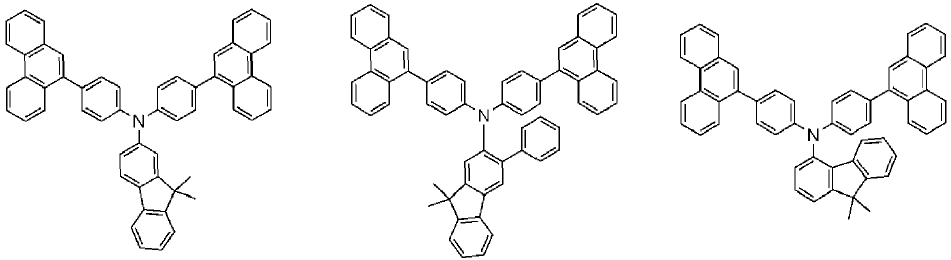

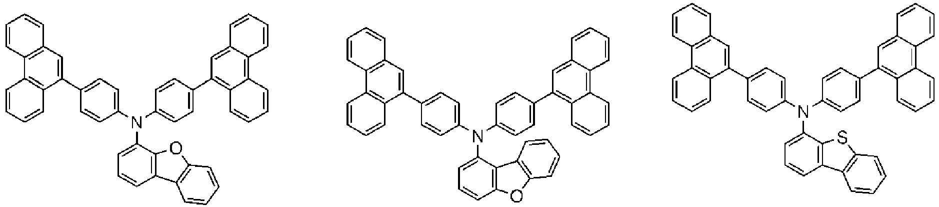

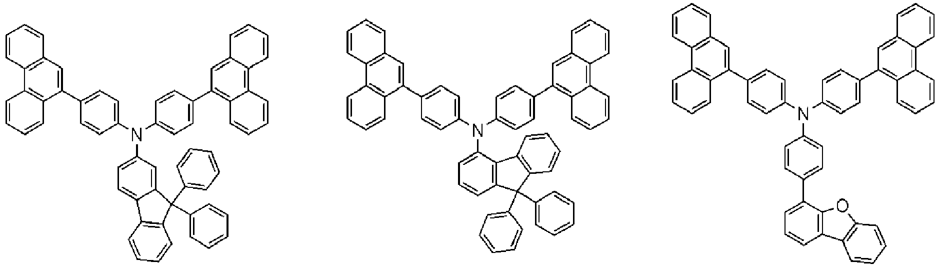

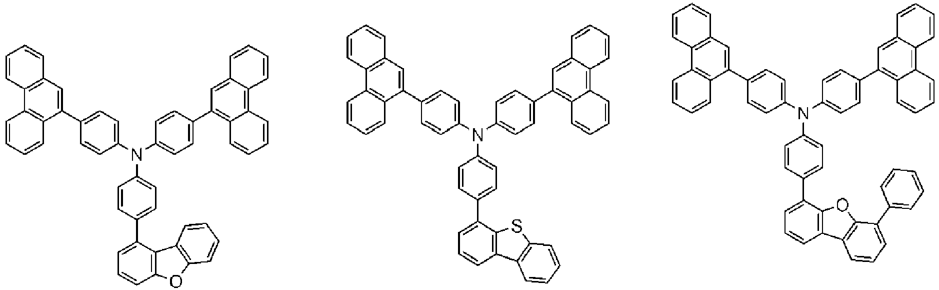

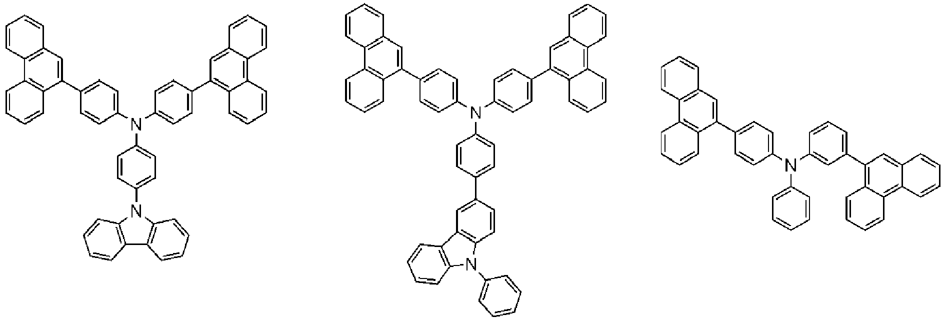

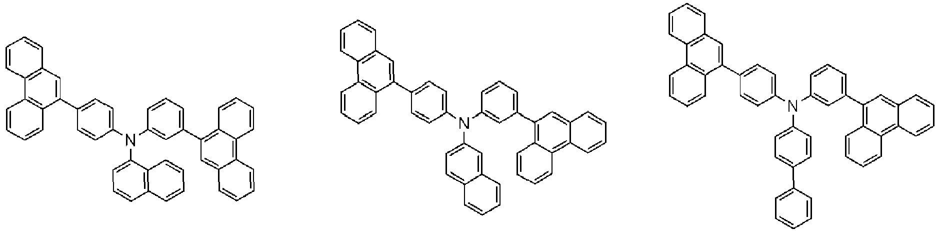

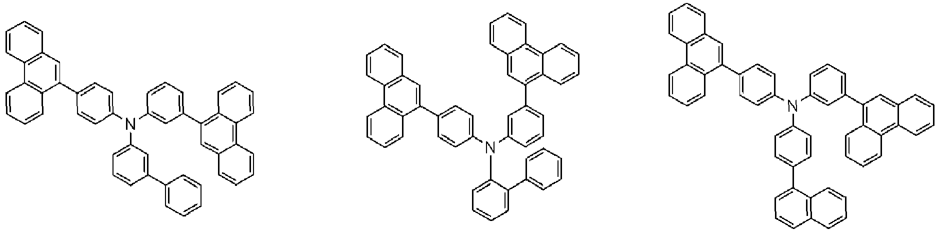

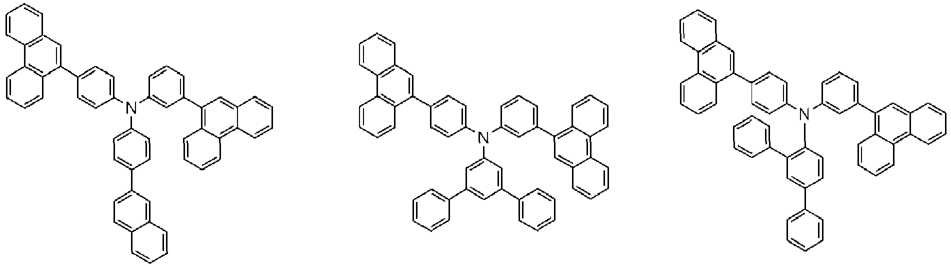

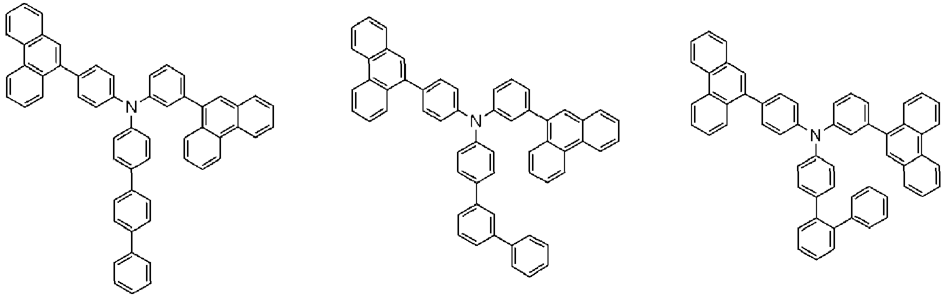

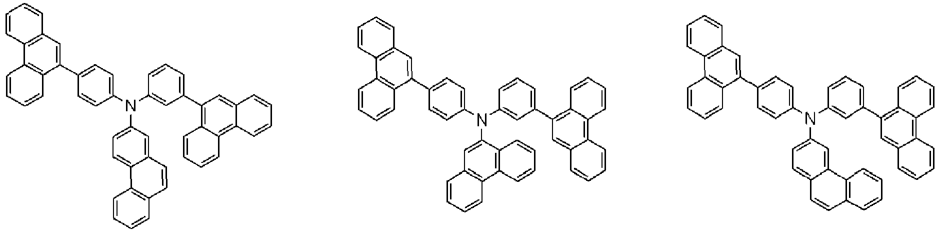

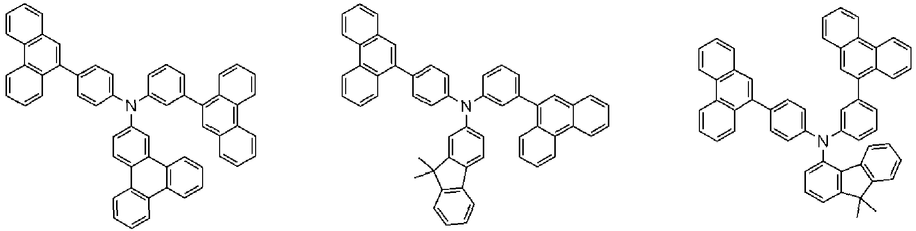

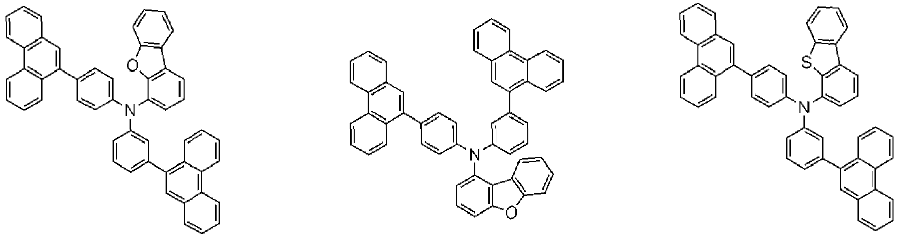

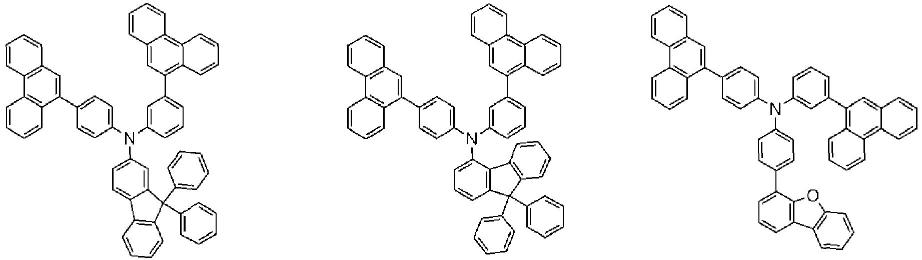

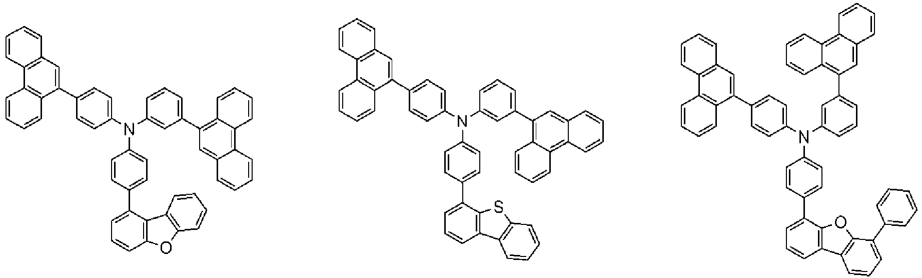

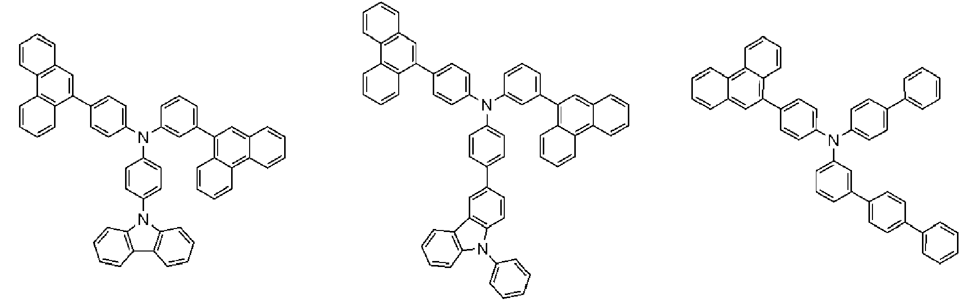

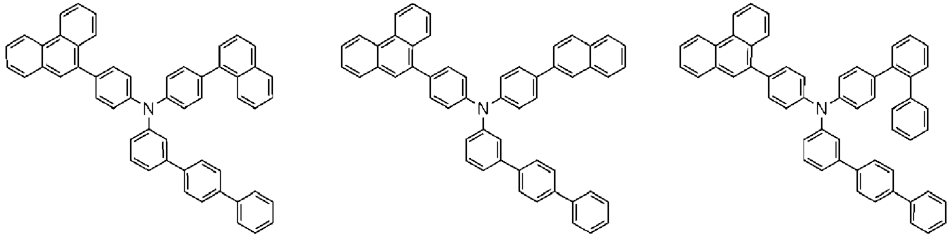

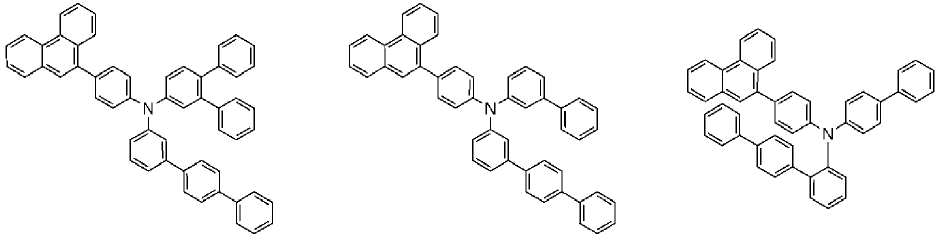

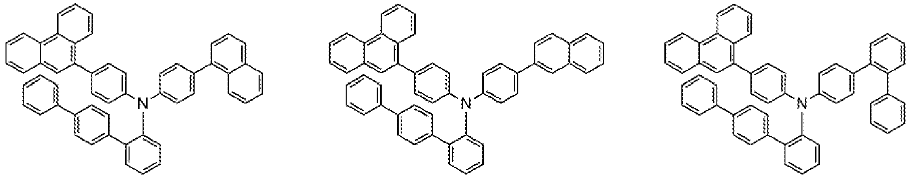

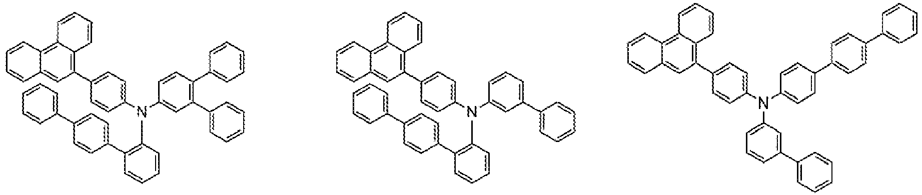

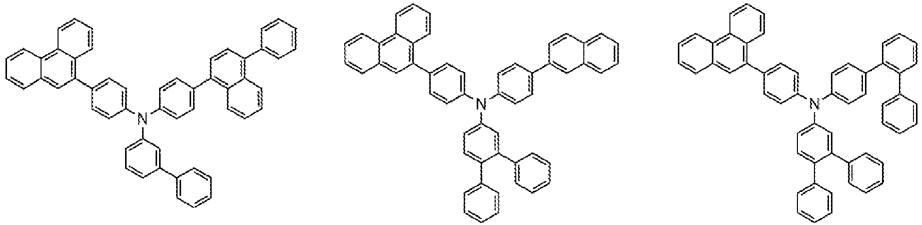

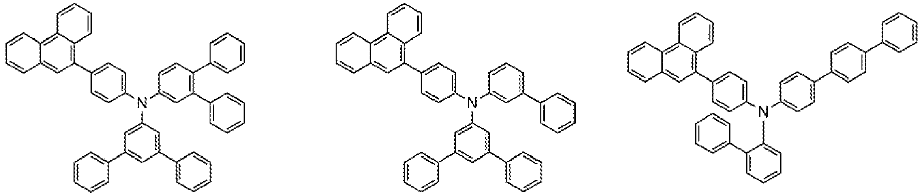

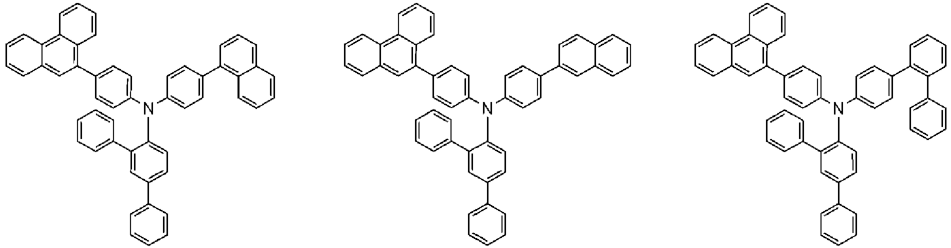

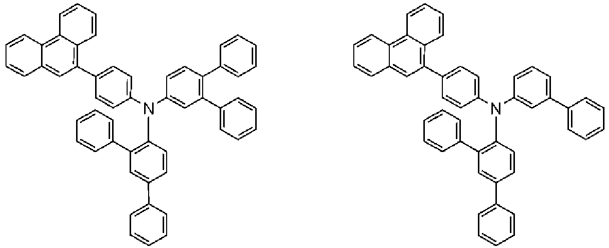

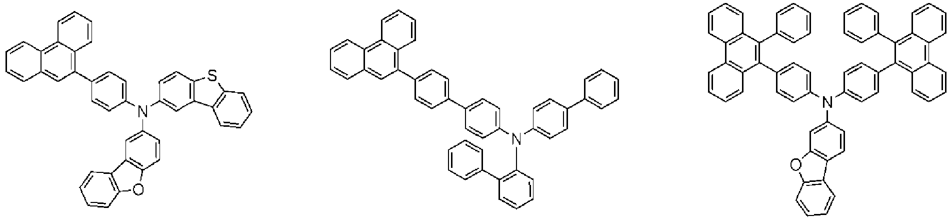

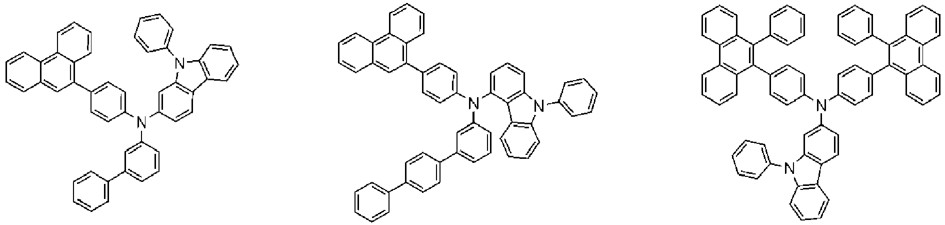

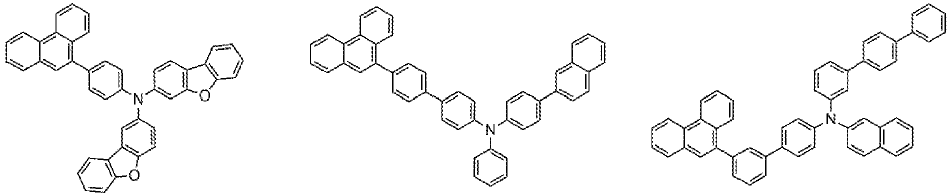

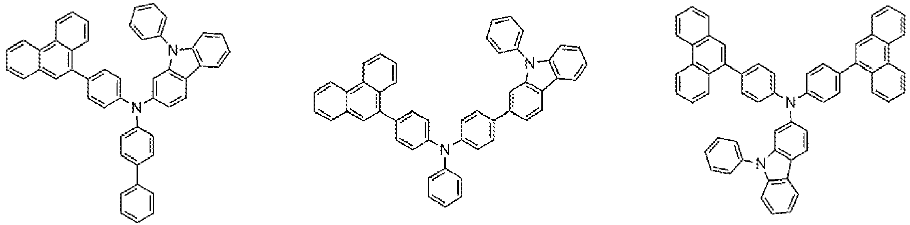

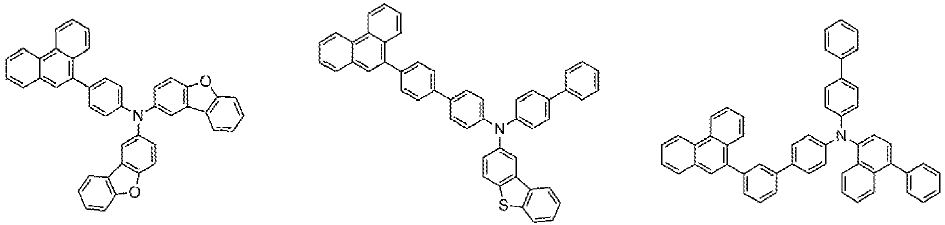

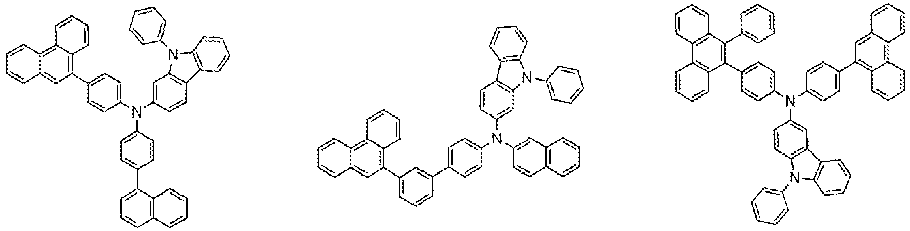

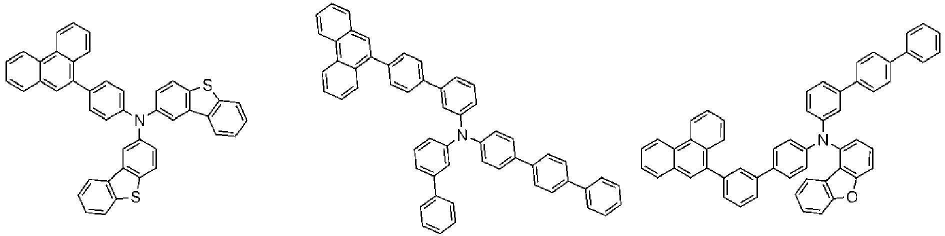

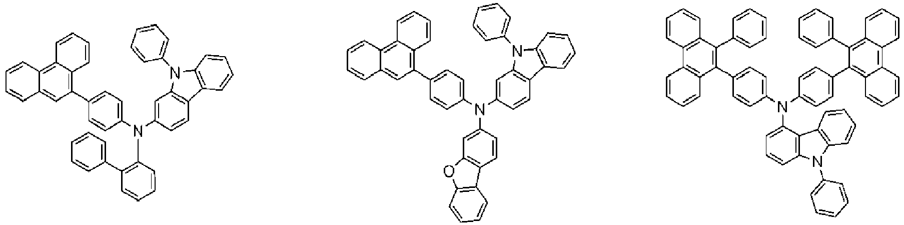

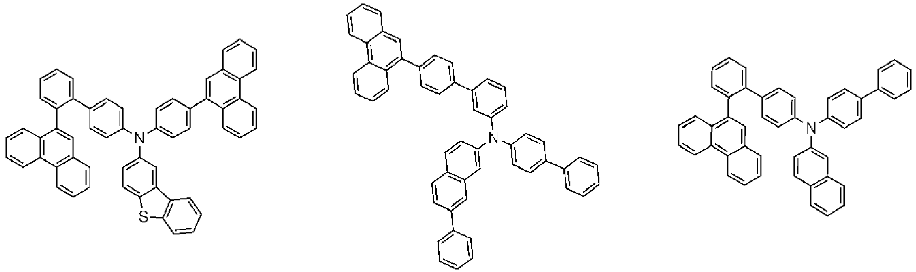

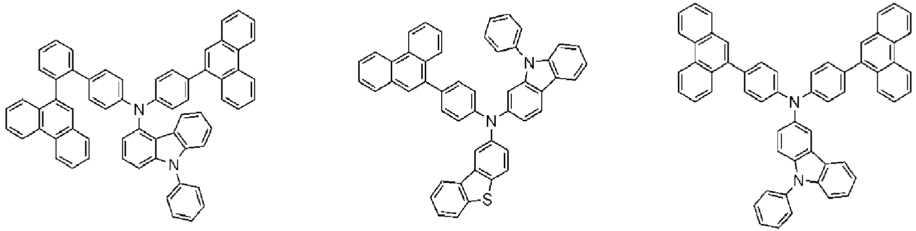

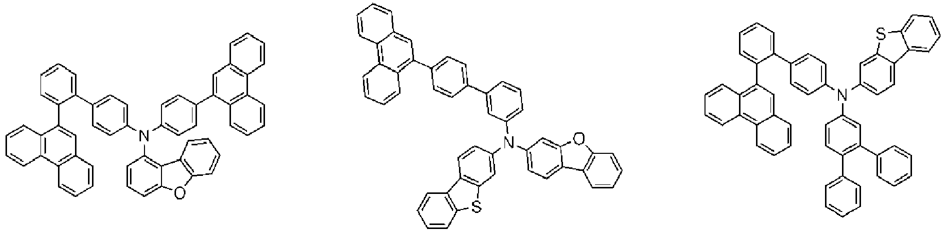

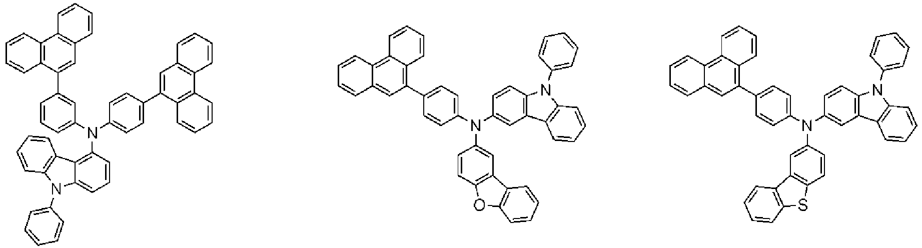

The compound represented by Chemical Formula 2 may be prepared, for example, according to the preparation method as shown in the following Reaction Scheme 2, and the other remaining compounds can be prepared in a similar manner. 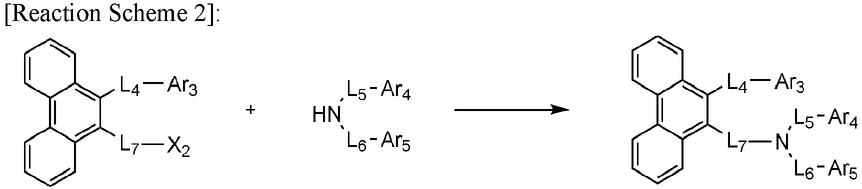 wherein in Reaction Scheme 2, Ar₃ to Ar₅ and L₄ to L₇ are as defined in Chemical Formula 2, and X₂ is halogen, preferably X₂ is chloro or bromo.

The Reaction Scheme 2 is an amine substitution reaction, which is preferably carried out in the presence of a palladium catalyst and a base, and a reactive group for the amine substitution reaction can be modified as known in the art. The above preparation method may be further embodied in the Preparation Examples described hereinafter.

Preferably, the weight ratio of the compound represented by Chemical Formula 1 and the compound represented by Chemical Formula 2 in the light emitting layer is 10:90 to 90:10, more preferably 20:80 to 80:20, 30:70 to 70:30 or 40:60 to 60:40.

Meanwhile, the light emitting layer may further include a dopant in addition to the host. The dopant material is not particularly limited as long as it is a material used for the organic light emitting device. As an example, an aromatic amine derivative, a styrylamine compound, a boron complex, a fluoranthene compound, a metal complex, and the like can be mentioned. Specific examples of the aromatic amine derivatives include substituted or unsubstituted fused aromatic ring derivatives having an arylamino group, examples thereof include pyrene, anthracene, chrysene, and periflanthene having the arylamino group, and the like. The styrylamine compound is a compound where at least one arylvinyl group is substituted in substituted or unsubstituted arylamine, in which one or two or more substituent groups selected from the group consisting of an aryl group, a silyl group, an alkyl group, a cycloalkyl group, and an arylamino group are substituted or unsubstituted. Specific examples thereof include styrylamine, styryldiamine, styryltriamine, styryltetramine, and the like, but are not limited thereto. Further, examples of the metal complex include an iridium complex, a platinum complex, and the like, but are not limited thereto.

### Hole Blocking Layer

The hole blocking layer is a layer provided between the electron transport layer and the light emitting layer in order to prevent the holes injected in the anode from being transferred to the electron transport layer without being recombined in the light emitting layer, which may also be referred to as a hole inhibition layer or a hole stopping layer. The hole blocking layer is preferably a material having the large ionization energy.

### Electron Transport Layer

The organic light emitting device according to the present disclosure may include an electron transport layer on the light emitting layer, if necessary.

The electron transport layer is a layer that receives the electrons from the electron injection layer formed on the cathode and cathode and transports the electrons to the light emitting layer, and that suppress the transfer of holes from the light emitting layer, and an electron transport material is suitably a material which may receive electrons well from a cathode and transfer the electrons to a light emitting layer, and has a large mobility for electrons.

Specific examples of the electron transport material include: an Al complex of 8-hydroxyquinoline; a complex including Alq₃; an organic radical compound; a hydroxyflavone-metal complex, and the like, but are not limited thereto. The electron transport layer may be used with any desired cathode material, as used according to a conventional technique. In particular, appropriate examples of the cathode material are a typical material which has a low work function, followed by an aluminum layer or a silver layer. Specific examples thereof include cesium, barium, calcium, ytterbium, and samarium, in each case followed by an aluminum layer or a silver layer.

### Electron Injection Layer

The organic light emitting device according to the present disclosure may further include an electron injection layer on the light emitting layer (or on an electron transport layer when the electron transport layer is present), if necessary.

The electron injection layer is a layer which injects electrons from an electrode, and is preferably a compound which has a capability of transporting electrons, has an effect of injecting electrons from a cathode and an excellent effect of injecting electrons into a light emitting layer or a light emitting material, prevents excitons produced from the light emitting layer from moving to a hole injection layer, and is also excellent in the ability to form a thin film.

Specific examples of the materials that can be used as the electron injection layer include fluorenone, anthraquinodimethane, diphenoquinone, thiopyran dioxide, oxazole, oxadiazole, triazole, imidazole, perylenetetracarboxylic acid, fluorenylidene methane, anthrone, and the like, and derivatives thereof, a metal complex compound, a nitrogen-containing 5-membered ring derivative, and the like, but are not limited thereto.

Examples of the metal complex compound include 8-hydroxyquinolinato lithium, bis(8-hydroxyquinolinato)zinc, bis(8-hydroxyquinolinato)copper, bis(8-hydroxyquinolinato)manganese, tris(8-hydroxyquinolinato)aluminum, tris(2-methyl-8-hydroxyquinolinato)aluminum, tris(8-hydroxyquinolinato)gallium, bis(10-hydroxybenzo[h]quinolinato)beryllium, bis(10-hydroxybenzo[h]quinolinato)zinc, bis(2-methyl-8-quinolinato)chlorogallium, bis(2-methyl-8-quinolinato)(o-cresolato)gallium, bis(2-methyl-8-quinolinato)(1-naphtholato)aluminum, bis(2-methyl-8-quinolinato)(2-naphtholato)gallium, and the like, but are not limited thereto.

Meanwhile, in the present disclosure, the "electron injection and transport layer" is a layer that performs both the roles of the electron injection layer and the electron transport layer, and the material that serves as each layer may be used alone or in combination, but is not limited thereto.

### Organic Light Emitting Device

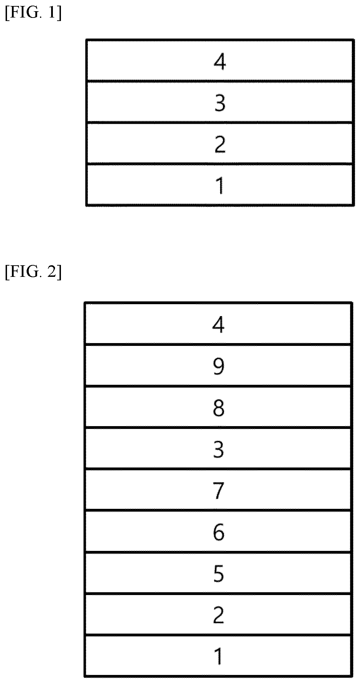

The structure of the organic light emitting device according to the present disclosure is illustrated in FIG. 1. FIG. 1 shows an example of an organic light emitting device comprising a substrate 1, an anode 2, a light emitting layer 3, and a cathode 4. FIG. 2 shows an example of an organic light emitting device comprising a substrate 1, an anode 2, a hole injection layer 5, a hole transport layer 6, an electron blocking layer 7, a light emitting layer 3, a hole blocking layer 8, an electron injection and transport layer 9, and a cathode 4.

The organic light emitting device according to the present disclosure can be manufactured by sequentially stacking the above-described structures. In this case, the organic light emitting device may be manufactured by depositing a metal, metal oxides having conductivity, or an alloy thereof on the substrate by using a PVD (physical vapor deposition) method such as a sputtering method or an e-beam evaporation method to form the anode, forming the respective layers described above thereon, and then depositing a material that can be used as the cathode thereon. In addition to such a method, the organic light emitting device can be manufactured by sequentially depositing from the cathode material to the anode material on a substrate in the reverse order of the above-mentioned configuration (WO 2003/012890). Further, the light emitting layer may be formed by subjecting hosts and dopants to a vacuum deposition method and a solution coating method. Herein, the solution coating method means a spin coating, a dip coating, a doctor blading, an inkjet printing, a screen printing, a spray method, a roll coating, or the like, but is not limited thereto.

On the other hand, the organic light emitting device according to the present disclosure may be a front side emission type, a back side emission type, or a double side emission type according to the used material.

Hereinafter, preferred examples of the present disclosure are presented to aid in the understanding of the invention. However, these examples are presented for illustrative purposes only, and the scope of the present disclosure is not limited thereto.

### [Preparation Example]

### Preparation Example 1-1: Preparation of Compound 1-1

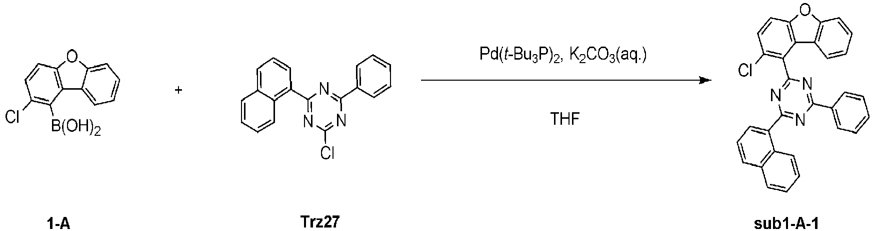

Compound 1-A (15 g, 60.9 mmol) and Compound Trz27 (19.3 g, 60.9 mmol) were added to 300 ml of THF under a nitrogen atmosphere, and the mixture was stirred and refluxed. Then, potassium carbonate (16.8 g, 121.7 mmol) was dissolved in 50 ml of water, added thereto, and the mixture was sufficiently stirred and then bis(tri-tert-butylphosphine)palladium (0) (0.3 g, 0.6 mmol) was added. After 12-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 20.9 g of Compound sub1-A-1. (Yield: 71%, MS: [M+H]⁺= 484)

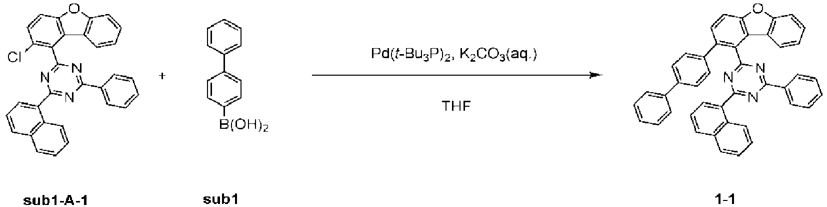

Compound sub1-A-1 (15 g, 31 mmol) and Compound sub1 (6.1 g, 31 mmol) were added to 300 ml of THF under a nitrogen atmosphere, and the mixture was stirred and refluxed. Then, potassium carbonate (8.6 g, 62 mmol) was dissolved in 26 ml of water, added thereto, and the mixture was sufficiently stirred and then bis(tri-tert-butylphosphine)palladium (0) (0.2 g, 0.3 mmol) was added. After 10-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 12.3 g of Compound 1-1. (Yield: 66%, MS: [M+H]⁺= 602)

### Preparation Example 1-2: Preparation of Compound 1-2

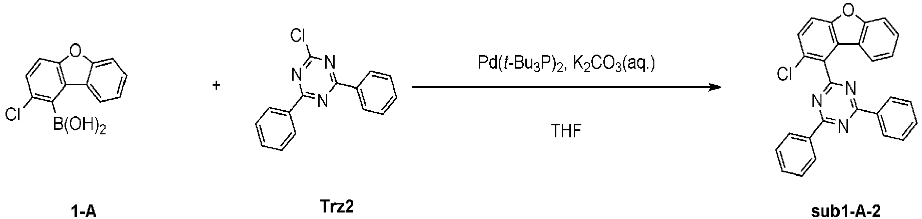

Compound 1-A (15 g, 60.9 mmol) and Compound Trz2 (16.3 g, 60.9 mmol) were added to 300 ml of THF under a nitrogen atmosphere, and the mixture was stirred and refluxed. Then, potassium carbonate (25.2 g, 182.6 mmol) was dissolved in 76 ml of water, added thereto, and the mixture was sufficiently stirred and then bis(tri-tert-butylphosphine)palladium (0) (0.3 g, 0.6 mmol) was added. After 10-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 19.5 g of Compound sub1-A-2. (Yield: 74%, MS: [M+H]⁺= 434)

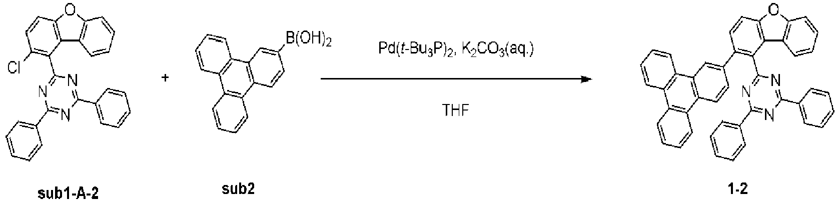

Compound sub1-A-2 (15 g, 34.6 mmol) and Compound sub2 (9.4 g, 34.6 mmol) were added to 300 ml of THF under a nitrogen atmosphere, and the mixture was stirred and refluxed. Then, potassium carbonate (9.6 g, 69.1 mmol) was dissolved in 29 ml of water, added thereto, and the mixture was sufficiently stirred and then bis(tri-tert-butylpliosphine)palladium(0) (0.2 g, 0.3 mmol) was added. After 8-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 14.3 g of Compound 1-2. (Yield: 66%, MS: [M+H]⁺= 626)

### Preparation Example 1-3: Preparation of Compound 1-3

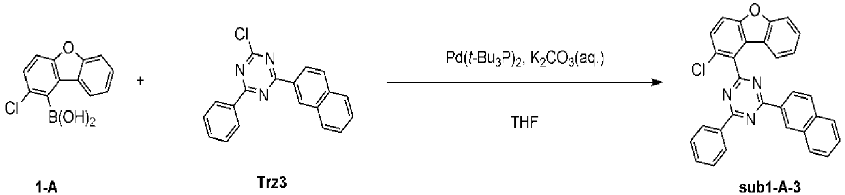

Compound 1-A (15 g, 60.9 mmol) and Compound Trz3 (19.3 g, 60.9 mmol) were added to 300 ml of THF under a nitrogen atmosphere, and the mixture was stirred and refluxed. Then, potassium carbonate (25.2 g, 182.6 mmol) was dissolved in 76 ml of water, added thereto, and the mixture was sufficiently stirred and then bis(tri-tert-butylphosphine)palladium (0) (0.3 g, 0.6 mmol) was added. After 9-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 23.2 g of Compound sub1-A-3. (Yield: 79%, MS: [M+H]⁺= 484)

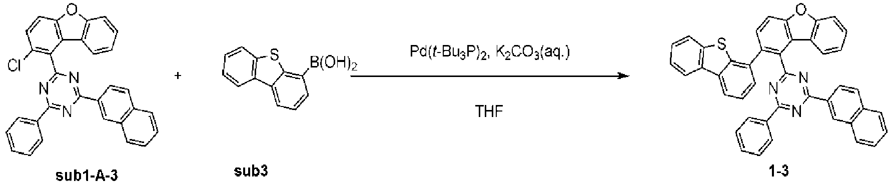

Compound sub1-A-3 (15 g, 31 mmol) and Compound sub3 (7.1 g, 31 mmol) were added to 300 ml of THF under a nitrogen atmosphere, and the mixture was stirred and refluxed. Then, potassium carbonate (8.6 g, 62 mmol) was dissolved in 26 ml of water, added thereto, and the mixture was sufficiently stirred and then bis(tri-tert-butylphosphine)palladium(0) (0.2 g, 0.3 mmol) was added. After 12-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 12.9 g of Compound 1-3. (Yield: 66%, MS: [M+H]⁺= 632)

### Preparation Example 1-4: Preparation of Compound 1-4

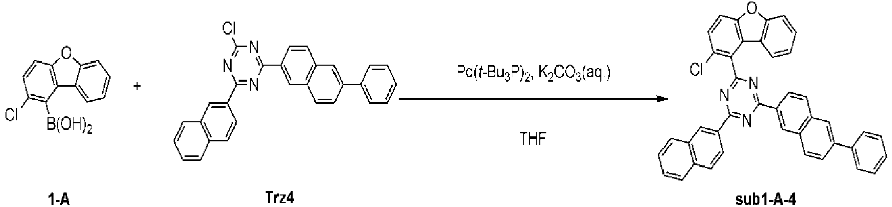

Compound 1-A (15 g, 60.9 mmol) and Compound Trz4 (27 g, 60.9 mmol) were added to 300 ml of THF under a nitrogen atmosphere, and the mixture was stirred and refluxed. Then, potassium carbonate (25.2 g, 182.6 mmol) was dissolved in 76 ml of water, added thereto, and the mixture was sufficiently stirred and then bis(tri-tert-butylphosphine)palladium (0) (0.3 g, 0.6 mmol) was added. After 9-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 26 g of Compound sub1-A-4. (Yield: 70%, MS: [M+H]⁺= 610)

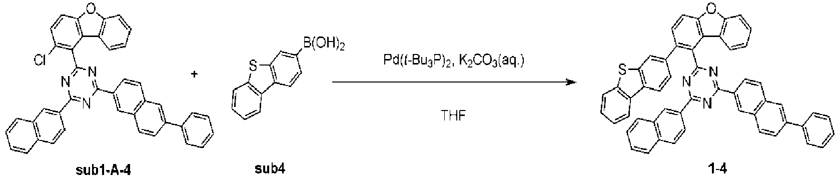

Compound sub1-A-4 (15 g, 24.6 mmol) and Compound sub4 (5.6 g, 24.6 mmol) were added to 300 ml of THF under a nitrogen atmosphere, and the mixture was stirred and refluxed. Then, potassium carbonate (6.8 g, 49.2 mmol) was dissolved in 20 ml of water, added thereto, and the mixture was sufficiently stirred and then bis(tri-tert-butylphosphine)palladium(0) (0.1 g, 0.2 mmol) was added. After 11-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 11.2 g of Compound 1-4. (Yield: 60%, MS: [M+H]⁺= 758)

### Preparation Example 1-5: Preparation of Compound 1-5

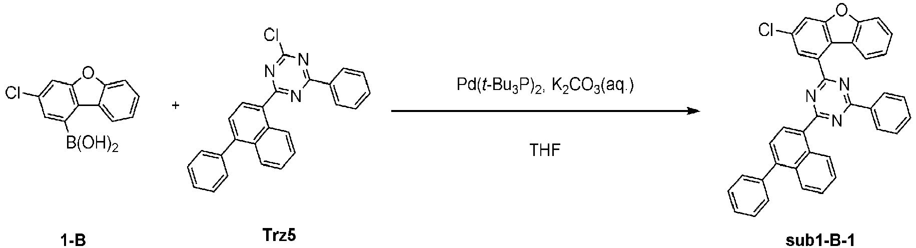

Compound 1-B (15 g, 60.9 mmol) and Compound Trz5 (24 g, 60.9 mmol) were added to 300 ml of THF under a nitrogen atmosphere, and the mixture was stirred and refluxed. Then, potassium carbonate (25.2 g, 182.6 mmol) was dissolved in 76 ml of water, added thereto, and the mixture was sufficiently stirred and then bis(tri-tert-butylphosphine)palladium (0) (0.3 g, 0.6 mmol) was added. After 10-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 26.2 g of Compound sub1-B-1. (Yield: 77%, MS: [M+H]⁺= 560)

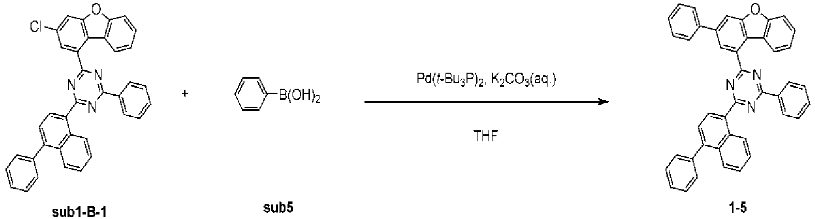

Compound sub1-B-1 (15 g, 26.8 mmol) and Compound sub5 (3.3 g, 26.8 mmol) were added to 300 ml of THF under a nitrogen atmosphere, and the mixture was stirred and refluxed. Then, potassium carbonate (7.4 g, 53.6 mmol) was dissolved in 22 ml of water, added thereto, and the mixture was sufficiently stirred and then bis(tri-tert-butylphosphine)palladium (0) (0.1 g, 0.3 mmol) was added. After 10-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 12.9 g of Compound 1-5. (Yield: 80%, MS: [M+H]⁺= 602)

### Preparation Example 1-6: Preparation of Compound 1-6

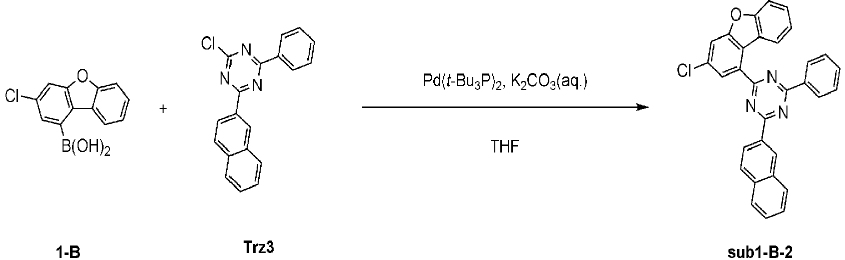

Compound 1-B (15 g, 60.9 mmol) and Compound Trz3 (19.3 g, 60.9 mmol) were added to 300 ml of THF under a nitrogen atmosphere, and the mixture was stirred and refluxed. Then, potassium carbonate (25.2 g, 182.6 mmol) was dissolved in 76 ml of water, added thereto, and the mixture was sufficiently stirred and then bis(tri-tert-butylphosphine)palladium(0) (0.3 g, 0.6 mmol) was added. After 11-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 18.2 g of Compound sub1-B-2. (Yield: 62%, MS: [M+H]⁺= 484)

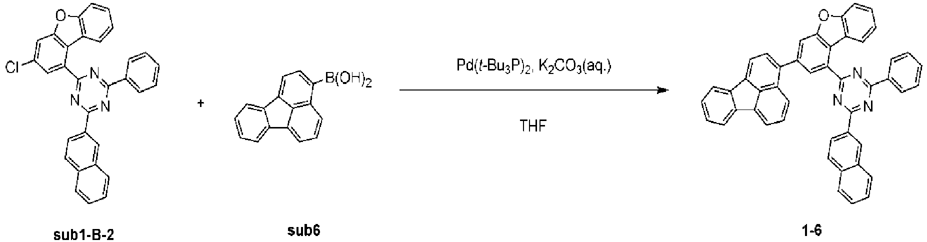

Compound sub1-B-2 (15 g, 31 mmol) and Compound sub6 (7.6 g, 31 mmol) were added to 300 ml of THF under a nitrogen atmosphere, and the mixture was stirred and refluxed. Then, potassium carbonate (8.6 g, 62 mmol) was dissolved in 26 ml of water, added thereto, and the mixture was sufficiently stirred and then bis(tri-tert-butylphosphine)palladium(0) (0.2 g, 0.3 mmol) was added. After 11-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 15.3 g of Compound 1-6. (Yield: 76%, MS: [M+H]⁺= 650)

### Preparation Example 1-7: Preparation of Compound 1-7

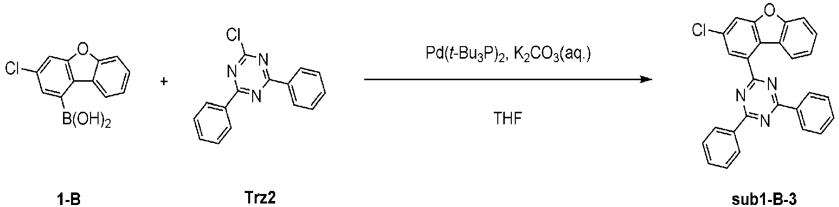

Compound 1-B (15 g, 60.9 mmol) and Compound Trz2 (16.3 g, 60.9 mmol) were added to 300 ml of THF under a nitrogen atmosphere, and the mixture was stirred and refluxed. Then, potassium carbonate (25.2 g, 182.6 mmol) was dissolved in 76 ml of water, added thereto, and the mixture was sufficiently stirred and then bis(tri-tert-butylphosphine)palladium(0) (0.3 g, 0.6 mmol) was added. After 12-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 20.8 g of Compound sub1-B-3. (Yield: 79%, MS: [M+H]⁺= 434)

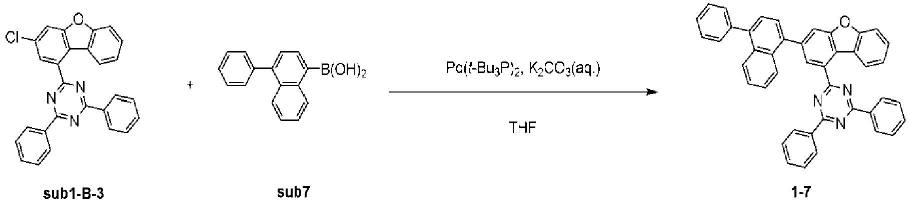

Compound sub1-B-3 (15 g, 34.6 mmol) and Compound sub7 (8.6 g, 34.6 mmol) were added to 300 ml of THF under a nitrogen atmosphere, and the mixture was stirred and refluxed. Then, potassium carbonate (9.6 g, 69.1 mmol) was dissolved in 29 ml of water, added thereto, and the mixture was sufficiently stirred and then bis(tri-tert-butylphosphine)palladium(0) (0.2 g, 0.3 mmol) was added. After 8-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 15.4 g of Compound 1-7. (Yield: 74%, MS: [M+H]+= 602)

### Preparation Example 1-8: Preparation of Compound 1-8

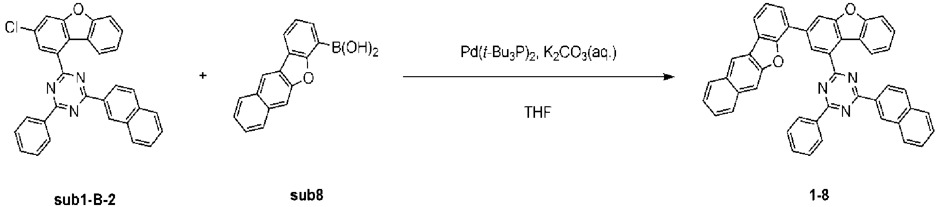

Compound sub1-B-2 (15 g, 31 mmol) and Compound sub8 (8.1 g, 31 mmol) were added to 300 ml of THF under a nitrogen atmosphere, and the mixture was stirred and refluxed. Then, potassium carbonate (8.6 g, 62 mmol) was dissolved in 26 ml of water, added thereto, and the mixture was sufficiently stirred and then bis(tri-tert-butylphosphine)palladium(0) (0.2 g, 0.3 mmol) was added. After 10-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 15.5 g of Compound 1-8. (Yield: 75%, MS: [M+H]⁺= 666)

### Preparation Example 1-9: Preparation of Compound 1-9

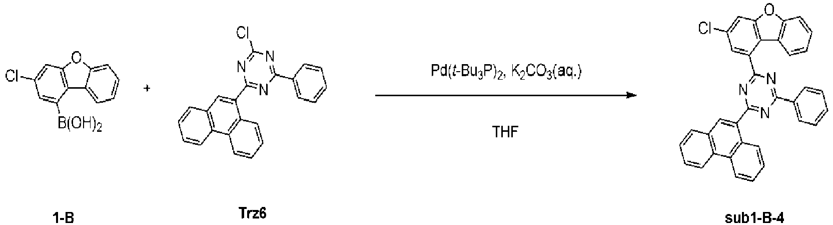

Compound 1-B (15 g, 60.9 mmol) and Compound Trz6 (22.4 g, 60.9 mmol) were added to 300 ml of THF under a nitrogen atmosphere, and the mixture was stirred and refluxed. Then, potassium carbonate (25.2 g, 182.6 mmol) was dissolved in 76 ml of water, added thereto, and the mixture was sufficiently stirred and then bis(tri-tert-butylphosphine)palladium(0) (0.3 g, 0.6 mmol) was added. After 9-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 23.7 g of Compound sub1-B-4. (Yield: 73%, MS: [M+H]⁺= 534)

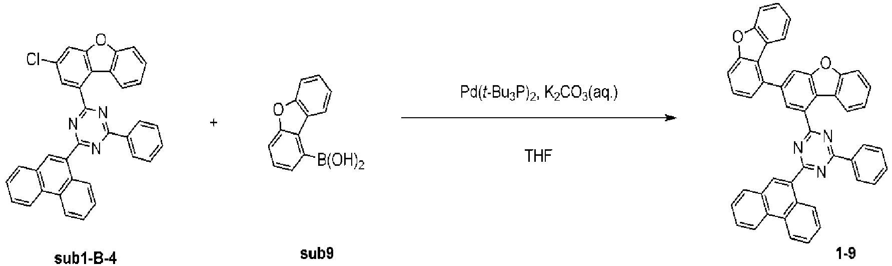

Compound sub1-B-4 (15 g, 28.1 mmol) and Compound sub9 (6 g, 28.1 mmol) were added to 300 ml of THF under a nitrogen atmosphere, and the mixture was stirred and refluxed. Then, potassium carbonate (7.8 g, 56.2 mmol) was dissolved in 23 ml of water, added thereto, and the mixture was sufficiently stirred and then bis(tri-tert-butylphosphine)palladium(0) (0.1 g, 0.3 mmol) was added. After 8-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 11.6 g of Compound 1-9. (Yield: 62%, MS: [M+H]⁺= 666)

### Preparation Example 1-10: Preparation of Compound 1-10

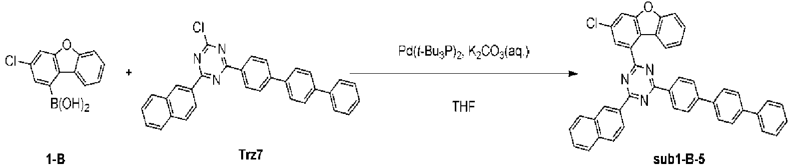

Compound 1-B (15 g, 60.9 mmol) and Compound Trz7 (28.6 g, 60.9 mmol) were added to 300 ml of THF under a nitrogen atmosphere, and the mixture was stirred and refluxed. Then, potassium carbonate (25.2 g, 182.6 mmol) was dissolved in 76 ml of water, added thereto, and the mixture was sufficiently stirred and then bis(tri-tert-butylphosphine)palladium(0) (0.3 g, 0.6 mmol) was added. After 10-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 28.6 g of Compound sub1-B-5. (Yield: 74%, MS: [M+H]⁺= 636)

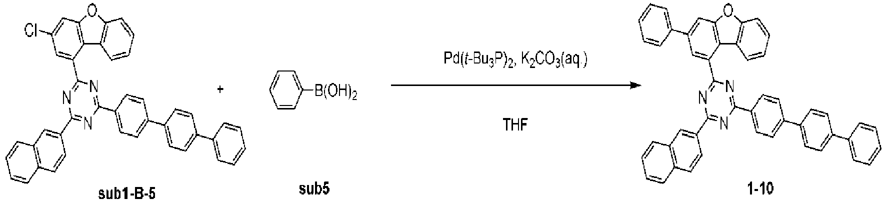

Compound sub1-B-5 (15 g, 23.6 mmol) and Compound sub5 (2.9 g, 23.6 mmol) were added to 300 ml of THF under a nitrogen atmosphere, and the mixture was stirred and refluxed. Then, potassium carbonate (6.5 g, 47.2 mmol) was dissolved in 20 ml of water, added thereto, and the mixture was sufficiently stirred and then bis(tri-tert-butylphosphine)palladium(0) (0.1 g, 0.2 mmol) was added. After 11-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 10.4 g of Compound 1-10. (Yield: 65%, MS: [M+H]⁺= 678)

### Preparation Example 1-11: Preparation of Compound 1-11

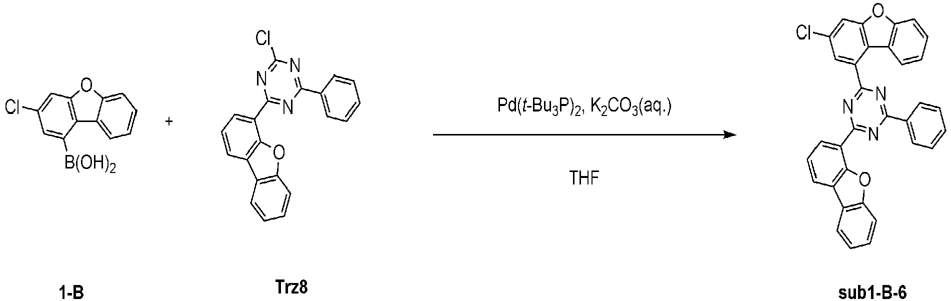

Compound 1-B (15 g, 60.9 mmol) and Compound Trz8 (21.8 g, 60.9 mmol) were added to 300 ml of THF under a nitrogen atmosphere, and the mixture was stirred and refluxed. Then, potassium carbonate (25.2 g, 182.6 mmol) was dissolved in 76 ml of water, added thereto, and the mixture was sufficiently stirred and then bis(tri-tert-butylphosphine)palladium(0) (0.3 g, 0.6 mmol) was added. After 8-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 20.1 g of Compound sub1-B-6. (Yield: 63%, MS: [M+H]⁺= 524)

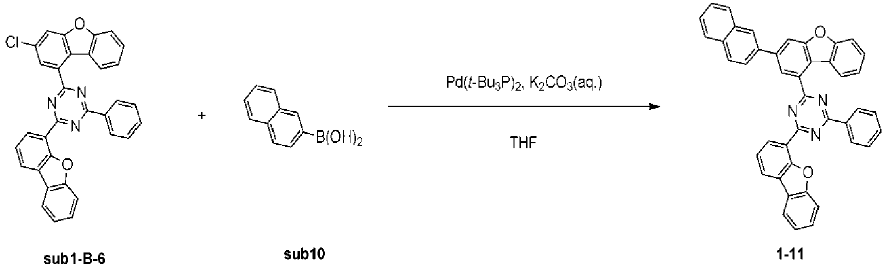

Compound sub1-B-6 (15 g, 28.6 mmol) and Compound sub10 (4.9 g, 28.6 mmol) were added to 300 ml of THF under a nitrogen atmosphere, and the mixture was stirred and refluxed. Then, potassium carbonate (7.9 g, 57.3 mmol) was dissolved in 24 ml of water, added thereto, and the mixture was sufficiently stirred and then bis(tri-tert-butylphosphine)palladium(0) (0.1 g, 0.3 mmol) was added. After 8-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 11.4 g of Compound 1-11. (Yield: 65%, MS: [M+H]⁺= 616)

### Preparation Example 1-12: Preparation of Compound 1-12

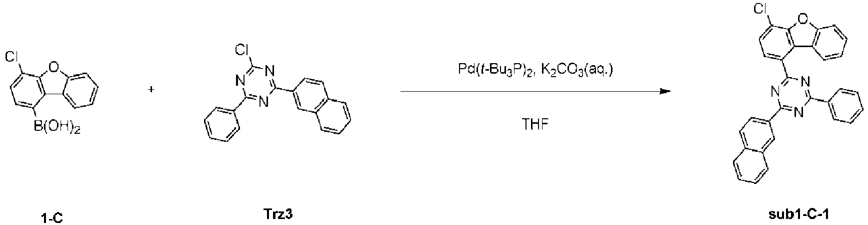

Compound 1-C (15 g, 60.9 mmol) and Compound Trz3 (19.3 g, 60.9 mmol) were added to 300 ml of THF under a nitrogen atmosphere, and the mixture was stirred and refluxed. Then, potassium carbonate (25.2 g, 182.6 mmol) was dissolved in 76 ml of water, added thereto, and the mixture was sufficiently stirred and then bis(tri-tert-butylphosphine)palladium(0) (0.3 g, 0.6 mmol) was added. After 11-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 17.6 g of Compound sub1-C-1. (Yield: 60%, MS: [M+H]⁺= 484)

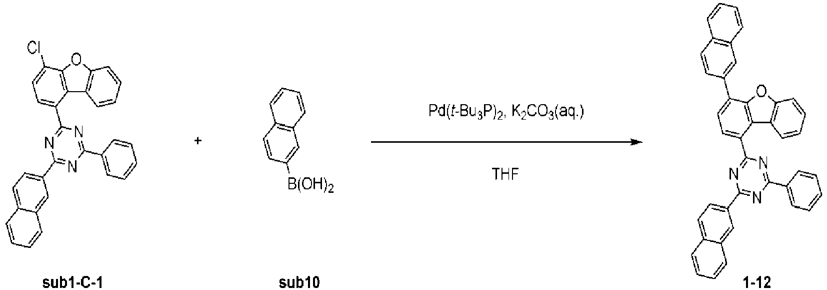

Compound sub1-C-1 (15 g, 31 mmol) and Compound sub10 (5.3 g, 31 mmol) were added to 300 ml of THF under a nitrogen atmosphere, and the mixture was stirred and refluxed. Then, potassium carbonate (8.6 g, 62 mmol) was dissolved in 26 ml of water, added thereto, and the mixture was sufficiently stirred and then bis(tri-tert-butylphosphine)palladium(0) (0.2 g, 0.3 mmol) was added. After 11-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 12.8 g of Compound 1-12. (Yield: 72%, MS: [M+H]⁺= 576)

### Preparation Example 1-13: Preparation of Compound 1-13

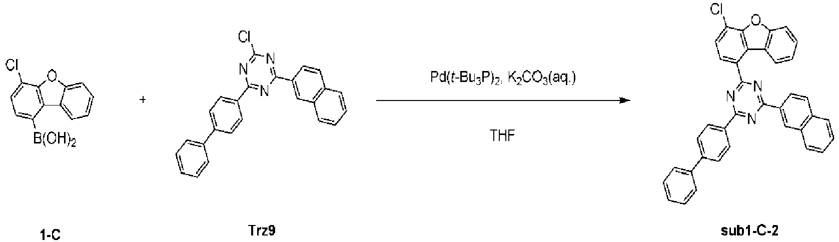

Compound 1-C (15 g, 60.9 mmol) and Compound Trz9 (24 g, 60.9 mmol) were added to 300 ml of THF under a nitrogen atmosphere, and the mixture was stirred and refluxed. Then, potassium carbonate (25.2 g, 182.6 mmol) was dissolved in 76 ml of water, added thereto, and the mixture was sufficiently stirred and then bis(tri-tert-butylphosphine)palladium(0) (0.3 g, 0.6 mmol) was added. After 12-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 23.5 g of Compound sub1-C-2. (Yield: 69%, MS: [M+H]⁺= 560)

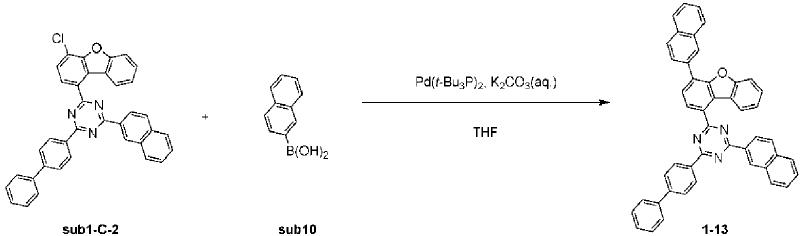

Compound sub1-C-2 (15 g, 26.8 mmol) and Compound sub10 (4.6 g, 26.8 mmol) were added to 300 ml of THF under a nitrogen atmosphere, and the mixture was stirred and refluxed. Then, potassium carbonate (7.4 g, 53.6 mmol) was dissolved in 22 ml of water, added thereto, and the mixture was sufficiently stirred and then bis(tri-tert-butylphosphine)palladium(0) (0.1 g, 0.3 mmol) was added. After 11-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 14 g of Compound 1-13. (Yield: 80%, MS: [M+H]⁺= 652)

### Preparation Example 1-14: Preparation of Compound 1-14

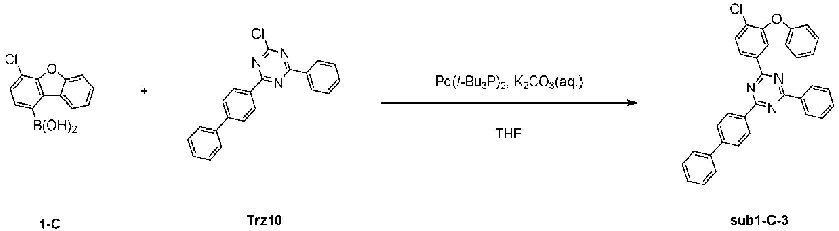

Compound 1-C (15 g, 60.9 mmol) and Compound Trz10 (20.9 g, 60.9 mmol) were added to 300 ml of THF under a nitrogen atmosphere, and the mixture was stirred and refluxed. Then, potassium carbonate (25.2 g, 182.6 mmol) was dissolved in 76 ml of water, added thereto, and the mixture was sufficiently stirred and then bis(tri-tert-butylphosphine)palladium(0) (0.3 g, 0.6 mmol) was added. After 11-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 20.5 g of Compound sub1-C-3. (Yield: 66%, MS: [M+H]⁺= 510)

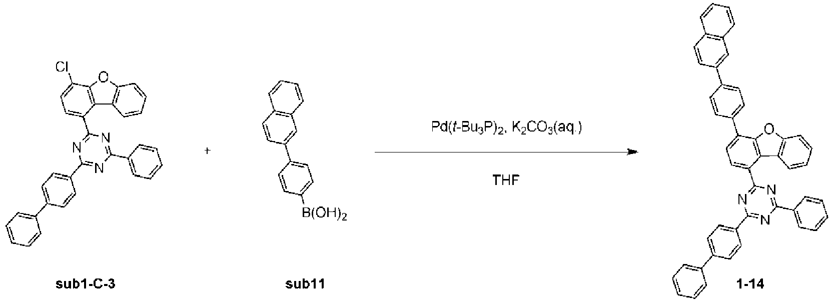

Compound sub 1-C-3 (15 g, 29.4 mmol) and Compound sub 11 (7.3 g, 29.4 mmol) were added to 300 ml of THF under a nitrogen atmosphere, and the mixture was stirred and refluxed. Then, potassium carbonate (8.1 g, 58.8 mmol) was dissolved in 24 ml of water, added thereto, and the mixture was sufficiently stirred and then bis(tri-tert-butylphosphine)palladium(0) (0.2 g, 0.3 mmol) was added. After 10-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 15.3 g of Compound 1-14. (Yield: 77%, MS: [M+H]⁺= 678)

### Preparation Example 1-15: Preparation of Compound 1-15

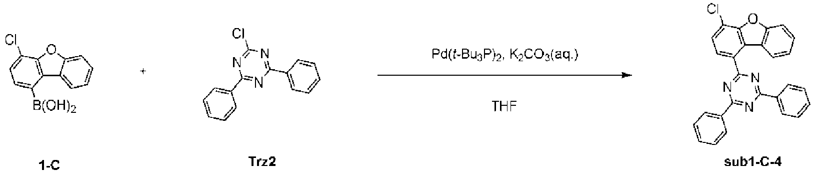

Compound 1-C (15 g, 60.9 mmol) and Compound Trz2 (16.3 g, 60.9 mmol) were added to 300 ml of THF under a nitrogen atmosphere, and the mixture was stirred and refluxed. Then, potassium carbonate (25.2 g, 182.6 mmol) was dissolved in 76 ml of water, added thereto, and the mixture was sufficiently stirred and then bis(tri-tert-butylphosphine)palladium(0) (0.3 g, 0.6 mmol) was added. After 9-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 18.7 g of Compound sub1-C-4. (Yield: 71%, MS: [M+H]⁺= 434)

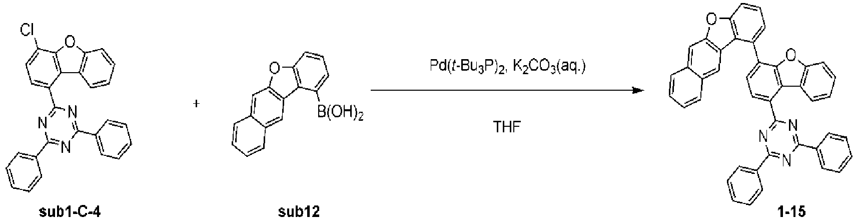

Compound sub1-C-4 (15 g, 37.1 mmol) and Compound sub12 (9.7 g, 37.1 mmol) were added to 300 ml of THF under a nitrogen atmosphere, and the mixture was stirred and refluxed. Then, potassium carbonate (10.3 g, 74.3 mmol) was dissolved in 31 ml of water, added thereto, and the mixture was sufficiently stirred and then bis(tri-tert-butylphosphine)palladium(0) (0.2 g, 0.4 mmol) was added. After 10-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 14.6 g of Compound 1-15. (Yield: 64%, MS: [M+H]⁺= 616)

### Preparation Example 1-16: Preparation of Compound 1-16

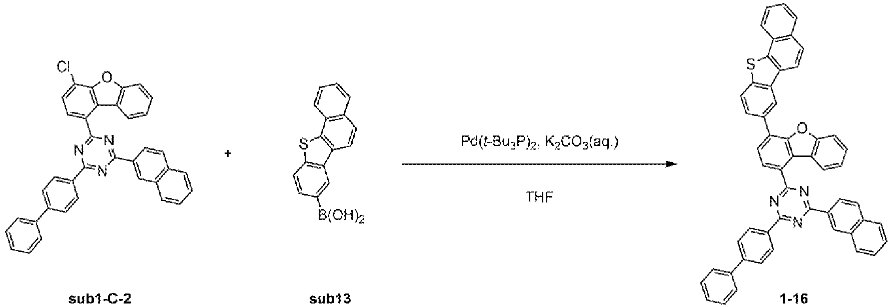

Compound sub1-C-2 (15 g, 26.8 mmol) and Compound sub13 (7.4 g, 26.8 mmol) were added to 300 ml of THF under a nitrogen atmosphere, and the mixture was stirred and refluxed. Then, potassium carbonate (7.4 g, 53.6 mmol) was dissolved in 22 ml of water, added thereto, and the mixture was sufficiently stirred and then bis(tri-tert-butylphosphine)palladium(0) (0.1 g, 0.3 mmol) was added. After 9-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 16.2 g of Compound 1-16. (Yield: 80%, MS: [M+H]⁺= 758)

### Preparation Example 1-17: Preparation of Compound 1-17

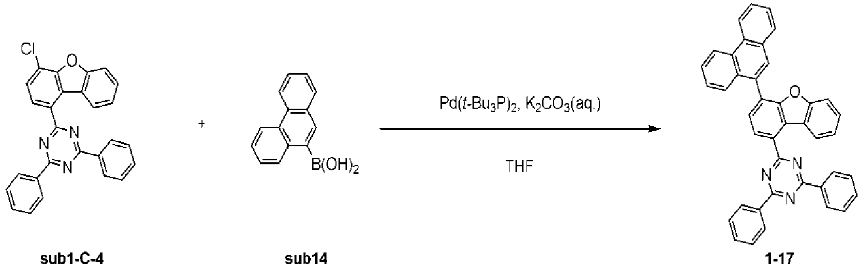

Compound sub1-C-4 (15 g, 34.6 mmol) and Compound sub14 (7.7 g, 34.6 mmol) were added to 300 ml of THF under a nitrogen atmosphere, and the mixture was stirred and refluxed. Then, potassium carbonate (9.6 g, 69.1 mmol) was dissolved in 29 ml of water, added thereto, and the mixture was sufficiently stirred and then bis(tri-tert-butylphosphine)palladium(0) (0.2 g, 0.3 mmol) was added. After 8-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 12.3 g of Compound 1-17. (Yield: 62%, MS: [M+H]⁺= 576)

### Preparation Example 1-18: Preparation of Compound 1-18

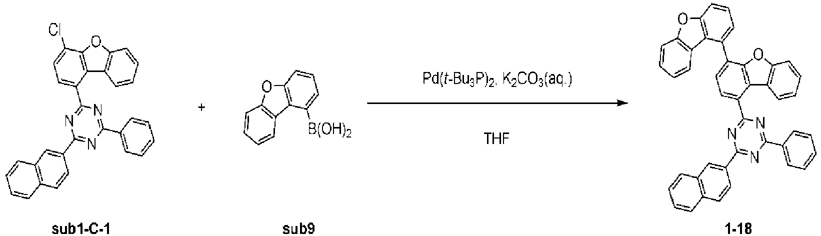

Compound sub1-C-1 (15 g, 31 mmol) and Compound sub9 (6.6 g, 31 mmol) were added to 300 ml of THF under a nitrogen atmosphere, and the mixture was stirred and refluxed. Then, potassium carbonate (8.6 g, 62 mmol) was dissolved in 26 ml of water, added thereto, and the mixture was sufficiently stirred and then bis(tri-tert-butylphosphine)palladium(0) (0.2 g, 0.3 mmol) was added. After 9-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 12 g of Compound 1-18. (Yield: 63%, MS: [M+H]⁺= 616)

### Preparation Example 1-19: Preparation of Compound 1-19

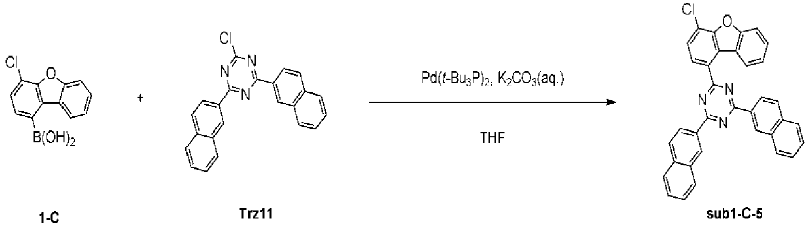

Compound 1-C (15 g, 60.9 mmol) and Compound Trz11 (22.4 g, 60.9 mmol) were added to 300 ml of THF under a nitrogen atmosphere, and the mixture was stirred and refluxed. Then, potassium carbonate (25.2 g, 182.6 mmol) was dissolved in 76 ml of water, added thereto, and the mixture was sufficiently stirred and then bis(tri-tert-butylphosphine)palladium(0) (0.3 g, 0.6 mmol) was added. After 11-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 22.4 g of Compound sub1-C-5. (Yield: 69%, MS: [M+H]⁺= 534)

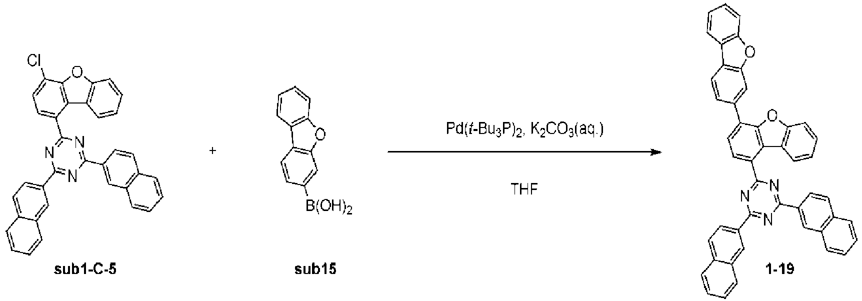

Compound sub1-C-5 (15 g, 28.1 mmol) and Compound sub15 (6 g, 28.1 mmol) were added to 300 ml of THF under a nitrogen atmosphere, and the mixture was stirred and refluxed. Then, potassium carbonate (7.8 g, 56.2 mmol) was dissolved in 23 ml of water, added thereto, and the mixture was sufficiently stirred and then bis(tri-tert-butylphosphine)palladium(0) (0.1 g, 0.3 mmol) was added. After 10-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 13.3 g of Compound 1-19. (Yield: 71%, MS: [M+H]⁺= 666)

### Preparation Example 1-20: Preparation of Compound 1-20

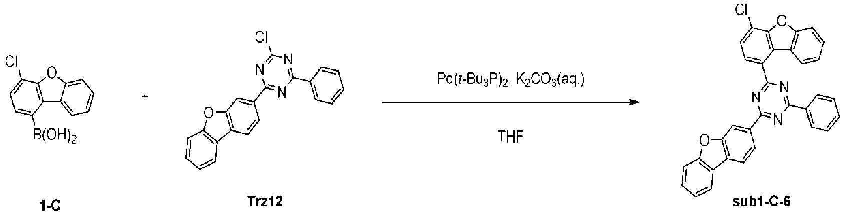

Compound 1-C (15 g, 60.9 mmol) and Compound Trz12(21.8 g, 60.9 mmol) were added to 300 ml of THF under a nitrogen atmosphere, and the mixture was stirred and refluxed. Then, potassium carbonate (25.2 g, 182.6 mmol) was dissolved in 76 ml of water, added thereto, and the mixture was sufficiently stirred and then bis(tri-tert-butylphosphine)palladium(0) (0.3 g, 0.6 mmol) was added. After 10-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 21 g of Compound sub1-C-6. (Yield: 66%, MS: [M+H]⁺= 524)

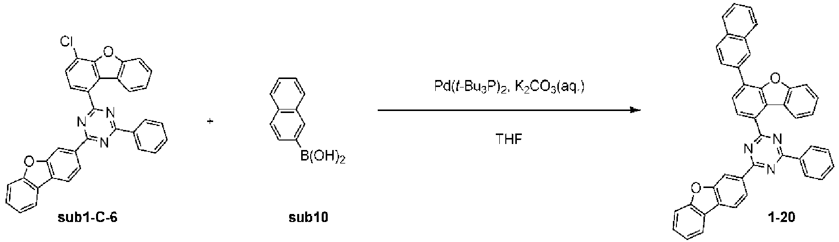

Compound sub1-C-6 (15 g, 28.6 mmol) and Compound sub10 (4.9 g, 28.6 mmol) were added to 300 ml of THF under a nitrogen atmosphere, and the mixture was stirred and refluxed. Then, potassium carbonate (11.9 g, 85.9 mmol) was dissolved in 36 ml of water, added thereto, and the mixture was sufficiently stirred and then bis(tri-tert-butylphosphine)palladium(0) (0.1 g, 0.3 mmol) was added. After 10-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 12.3 g of Compound 1-20. (Yield: 70%, MS: [M+H]⁺= 616)

### Preparation Example 1-21: Preparation of Compound 1-21

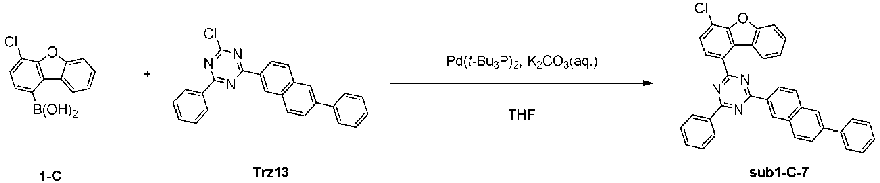

Compound 1-C (15 g, 60.9 mmol) and Compound Trz13 (24 g, 60.9 mmol) were added to 300 ml of THF under a nitrogen atmosphere, and the mixture was stirred and refluxed. Then, potassium carbonate (25.2 g, 182.6 mmol) was dissolved in 76 ml of water, added thereto, and the mixture was sufficiently stirred and then bis(tri-tert-butylphosphine)palladium(0) (0.3 g, 0.6 mmol) was added. After 12-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 26.2 g of Compound sub1-C-7. (Yield: 77%, MS: [M+H]⁺= 560)

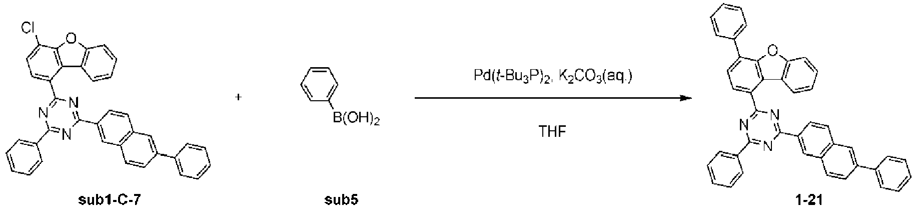

Compound sub1-C-7 (15 g, 26.8 mmol) and Compound sub5 (3.3 g, 26.8 mmol) were added to 300 ml of THF under a nitrogen atmosphere, and the mixture was stirred and refluxed. Then, potassium carbonate (11.1 g, 80.3 mmol) was dissolved in 33 ml of water, added thereto, and the mixture was sufficiently stirred and then bis(tri-tert-butylphosphine)palladium(0) (0.1 g, 0.3 mmol) was added. After 8-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 10.5 g of Compound 1-21. (Yield: 65%, MS: [M+H]⁺= 602)

### Preparation Example 1-22: Preparation of Compound 1-22

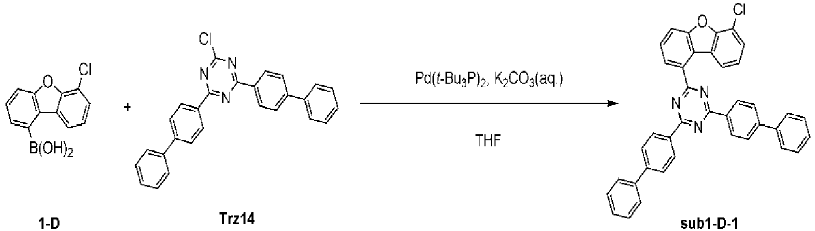

Compound 1-D (15 g, 60.9 mmol) and Compound Trz14 (19.3 g, 60.9 mmol) were added to 300 ml of THF under a nitrogen atmosphere, and the mixture was stirred and refluxed. Then, potassium carbonate (25.2 g, 182.6 mmol) was dissolved in 76 ml of water, added thereto, and the mixture was sufficiently stirred and then bis(tri-tert-butylphosphine)palladium(0) (0.3 g, 0.6 mmol) was added. After 11-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 23.9 g of Compound sub1-D-1. (Yield: 67%, MS: [M+H]⁺= 586)

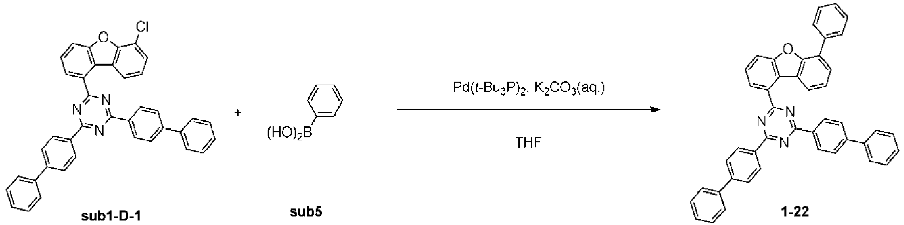

Compound sub1-D-1 (15 g, 25.6 mmol) and Compound sub5 (3.1 g, 25.6 mmol) were added to 300 ml of THF under a nitrogen atmosphere, and the mixture was stirred and refluxed. Then, potassium carbonate (10.6 g, 76.8 mmol) was dissolved in 32 ml of water, added thereto, and the mixture was sufficiently stirred and then bis(tri-tert-butylphosphine)palladium(0) (0.1 g, 0.3 mmol) was added. After 8-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 10.3 g of Compound 1-22. (Yield: 64%, MS: [M+H]⁺= 628)

### Preparation Example 1-23: Preparation of Compound 1-23

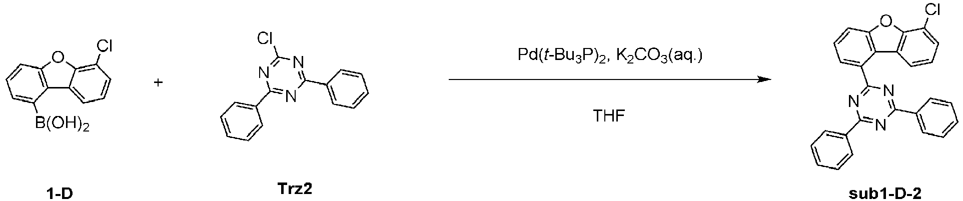

Compound 1-D (15 g, 60.9 mmol) and Compound Trz2 (16.3 g, 60.9 mmol) were added to 300 ml of THF under a nitrogen atmosphere, and the mixture was stirred and refluxed. Then, potassium carbonate (25.2 g, 182.6 mmol) was dissolved in 76 ml of water, added thereto, and the mixture was sufficiently stirred and then bis(tri-tert-butylphosphine)palladium(0) (0.3 g, 0.6 mmol) was added. After 10-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 20 g of Compound sub1-D-2. (Yield: 76%, MS: [M+H]⁺= 434)

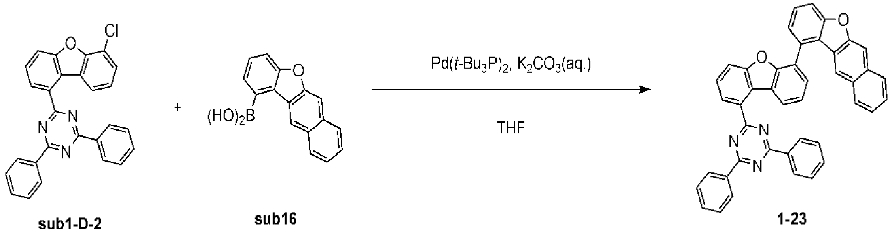

Compound sub1-D-2 (15 g, 34.6 mmol) and Compound sub16 (9.1 g, 34.6 mmol) were added to 300 ml of THF under a nitrogen atmosphere, and the mixture was stirred and refluxed. Then, potassium carbonate (14.3 g, 103.7 mmol) was dissolved in 43 ml of water, added thereto, and the mixture was sufficiently stirred and then bis(tri-tert-butylphosphine)palladium(0) (0.2 g, 0.3 mmol) was added. After 9-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 14 g of Compound 1-23. (Yield: 66%, MS: [M+H]⁺= 616)

### Preparation Example 1-24: Preparation of Compound 1-24

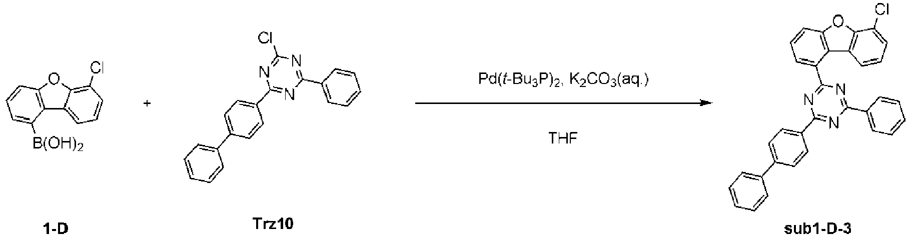

Compound 1-D (15 g, 60.9 mmol) and Compound Trz10 (20.9 g, 60.9 mmol) were added to 300 ml of THF under a nitrogen atmosphere, and the mixture was stirred and refluxed. Then, potassium carbonate (25.2 g, 182.6 mmol) was dissolved in 76 ml of water, added thereto, and the mixture was sufficiently stirred and then bis(tri-tert-butylphosphine)palladium(0) (0.3 g, 0.6 mmol) was added. After 12-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 20.8 g of Compound sub1-D-3. (Yield: 67%, MS: [M+H]⁺= 510)

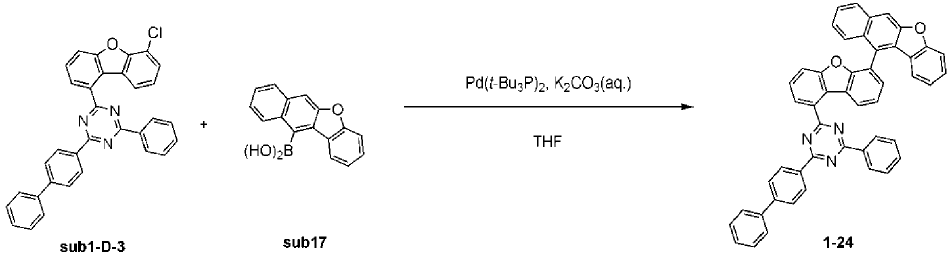

Compound sub1-D-3 (15 g, 29.4 mmol) and Compound sub17 (7.7 g, 29.4 mmol) were added to 300 ml of THF under a nitrogen atmosphere, and the mixture was stirred and refluxed. Then, potassium carbonate (12.2 g, 88.2 mmol) was dissolved in 37 ml of water, added thereto, and the mixture was sufficiently stirred and then bis(tri-tert-butylphosphine)palladium(0) (0.2 g, 0.3 mmol) was added. After 10-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 12.4 g of Compound 1-24. (Yield: 61%, MS: [M+H]⁺= 692)

### Preparation Example 1-25: Preparation of Compound 1-25

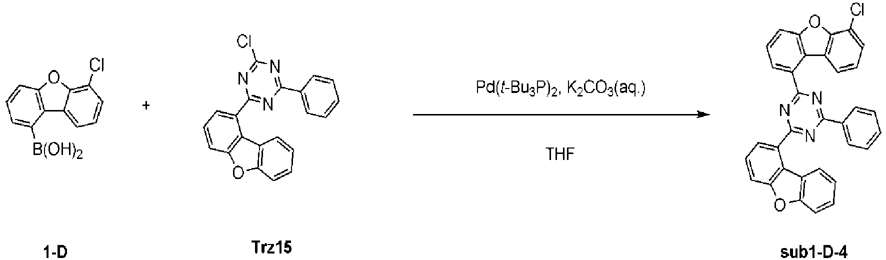

Compound 1-D (15 g, 60.9 mmol) and Compound Trz15 (21.8 g, 60.9 mmol) were added to 300 ml of THF under a nitrogen atmosphere, and the mixture was stirred and refluxed. Then, potassium carbonate (25.2 g, 182.6 mmol) was dissolved in 76 ml of water, added thereto, and the mixture was sufficiently stirred and then bis(tri-tert-butylphosphine)palladium(0) (0.3 g, 0.6 mmol) was added. After 11-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 21.3 g of Compound sub1-D-4. (Yield: 67%, MS: [M+H]⁺= 524)

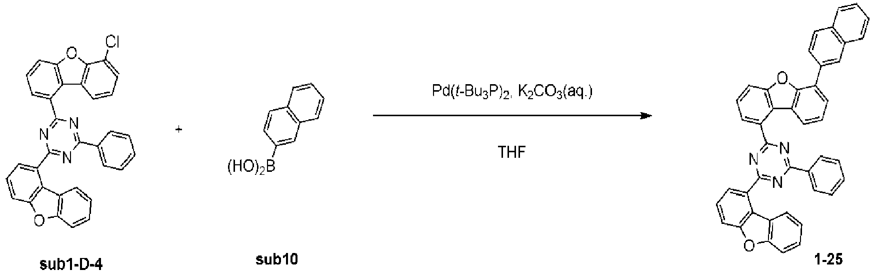

Compound sub1-D-4 (15 g, 28.6 mmol) and Compound sub10 (4.9 g, 28.6 mmol) were added to 300 ml of THF under a nitrogen atmosphere, and the mixture was stirred and refluxed. Then, potassium carbonate (11.9 g, 85.9 mmol) was dissolved in 36 ml of water, added thereto, and the mixture was sufficiently stirred and then bis(tri-tert-butylphosphine)palladium(0) (0.1 g, 0.3 mmol) was added. After 10-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 10.7 g of Compound 1-25. (Yield: 61%, MS: [M+H]⁺= 616)

### Preparation Example 1-26: Preparation of Compound 1-26

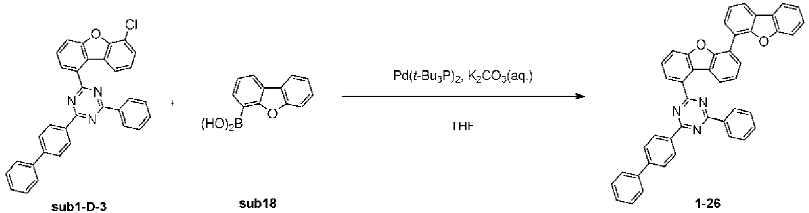

Compound sub1-D-3 (15 g, 29.4 mmol) and Compound sub18 (6.2 g, 29.4 mmol) were added to 300 ml of THF under a nitrogen atmosphere, and the mixture was stirred and refluxed. Then, potassium carbonate (12.2 g, 88.2 mmol) was dissolved in 37 ml of water, added thereto, and the mixture was sufficiently stirred and then bis(tri-tert-butylphosphine)palladium(0) (0.2 g, 0.3 mmol) was added. After 9-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 14.3 g of Compound 1-26. (Yield: 76%, MS: [M+H]⁺= 642)

### Preparation Example 1-27: Preparation of Compound 1-27

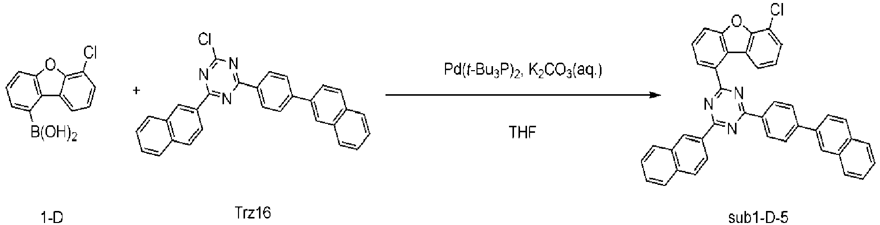

Compound 1-D (15 g, 60.9 mmol) and Compound Trz16 (27 g, 60.9 mmol) were added to 300 ml of THF under a nitrogen atmosphere, and the mixture was stirred and refluxed. Then, potassium carbonate (25.2 g, 182.6 mmol) was dissolved in 76 ml of water, added thereto, and the mixture was sufficiently stirred and then bis(tri-tert-butylphosphine)palladium(0) (0.3 g, 0.6 mmol) was added. After 11-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 27.1 g of Compound sub1-D-5. (Yield: 73%, MS: [M+H]⁺= 610)

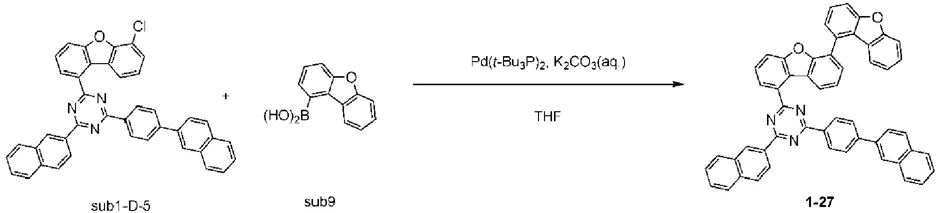

Compound sub1-D-5 (15 g, 24.6 mmol) and Compound sub9 (5.2 g, 24.6 mmol) were added to 300 ml of THF under a nitrogen atmosphere, and the mixture was stirred and refluxed. Then, potassium carbonate (10.2 g, 73.8 mmol) was dissolved in 31 ml of water, added thereto, and the mixture was sufficiently stirred and then bis(tri-tert-butylphosphine)palladium(0) (0.1 g, 0.2 mmol) was added. After 9-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 12.8 g of Compound 1-27. (Yield: 70%, MS: [M+H]⁺= 742)

### Preparation Example 1-28: Preparation of Compound 1-28

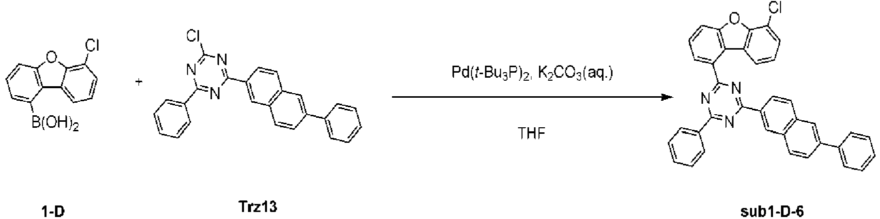

Compound 1-D (15 g, 60.9 mmol) and Compound Trz13 (24 g, 60.9 mmol) were added to 300 ml of THF under a nitrogen atmosphere, and the mixture was stirred and refluxed. Then, potassium carbonate (25.2 g, 182.6 mmol) was dissolved in 76 ml of water, added thereto, and the mixture was sufficiently stirred and then bis(tri-tert-butylphosphine)palladium(0) (0.3 g, 0.6 mmol) was added. After 9-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 20.8 g of Compound sub1-D-6. (Yield: 61%, MS: [M+H]⁺= 560)

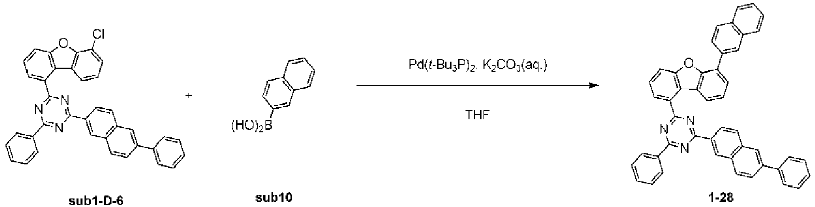

Compound sub1-D-6 (15 g, 26.8 mmol) and Compound sub10 (4.6 g, 26.8 mmol) were added to 300 ml of THF under a nitrogen atmosphere, and the mixture was stirred and refluxed. Then, potassium carbonate (11.1 g, 80.3 mmol) was dissolved in 33 ml of water, added thereto, and the mixture was sufficiently stirred and then bis(tri-tert-butylphosphine)palladium(0) (0.1 g, 0.3 mmol) was added. After 9-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 12.2 g of Compound 1-28. (Yield: 70%, MS: [M+H]⁺= 652)

### Preparation Example 1-29: Preparation of Compound 1-29

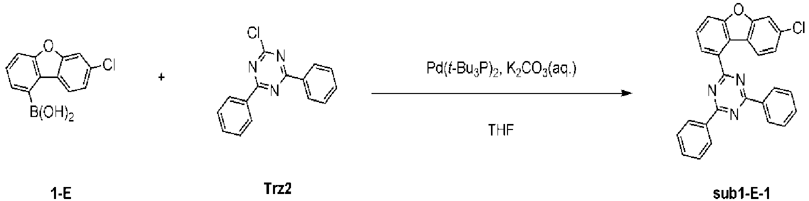

Compound 1-E (15 g, 60.9 mmol) and Compound Trz12 (16.3 g, 60.9 mmol) were added to 300 ml of THF under a nitrogen atmosphere, and the mixture was stirred and refluxed. Then, potassium carbonate (25.2 g, 182.6 mmol) was dissolved in 76 ml of water, added thereto, and the mixture was sufficiently stirred and then bis(tri-tert-butylphosphine)palladium(0) (0.3 g, 0.6 mmol) was added. After 10-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 17.1 g of Compound sub1-E-1. (Yield: 65%, MS: [M+H]⁺= 434)

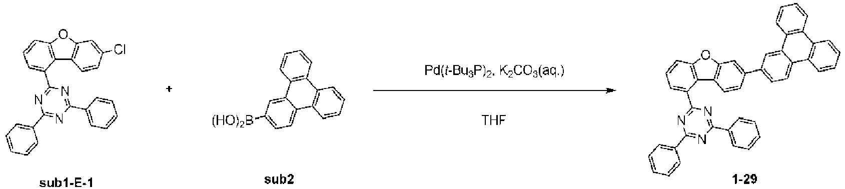

Compound sub1-E-1 (15 g, 34.6 mmol) and Compound sub2 (9.4 g, 34.6 mmol) were added to 300 ml of THF under a nitrogen atmosphere, and the mixture was stirred and refluxed. Then, potassium carbonate (14.3 g, 103.7 mmol) was dissolved in 43 ml of water, added thereto, and the mixture was sufficiently stirred and then bis(tri-tert-butylphosphine)palladium(0) (0.2 g, 0.3 mmol) was added. After 8-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 14.5 g of Compound 1-29. (Yield: 67%, MS: [M+H]⁺= 626)

### Preparation Example 1-30: Preparation of Compound 1-30

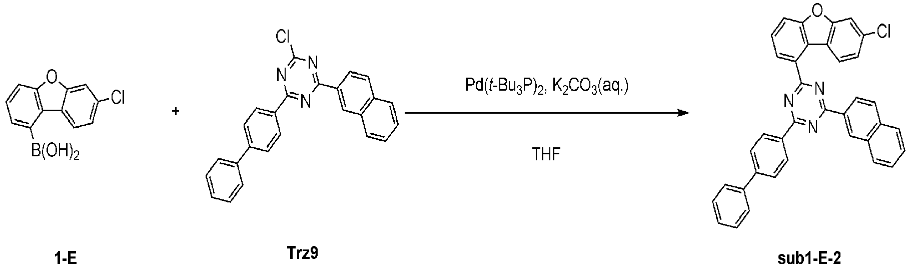

Compound 1-E (15 g, 60.9 mmol) and Compound Trz9 (24 g, 60.9 mmol) were added to 300 ml of THF under a nitrogen atmosphere, and the mixture was stirred and refluxed. Then, potassium carbonate (25.2 g, 182.6 mmol) was dissolved in 76 ml of water, added thereto, and the mixture was sufficiently stirred and then bis(tri-tert-butylphosphine)palladium(0) (0.3 g, 0.6 mmol) was added. After 8-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 26.9 g of Compound sub1-E-2. (Yield: 79%, MS: [M+H]⁺= 560)

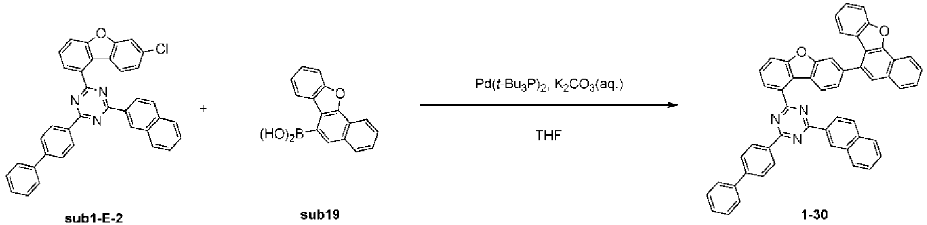

Compound sub 1-E-2 (15 g, 26.8 mmol) and Compound sub 19 (7 g, 26.8 mmol) were added to 300 ml of THF under a nitrogen atmosphere, and the mixture was stirred and refluxed. Then, potassium carbonate (11.1 g, 80.3 mmol) was dissolved in 33 ml of water, added thereto, and the mixture was sufficiently stirred and then bis(tri-tert-butylphosphine)palladium(0) (0.1 g, 0.3 mmol) was added. After 11-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 15.9 g of Compound 1-30. (Yield: 80%, MS: [M+H]⁺= 742)

### Preparation Example 1-31: Preparation of Compound 1-31

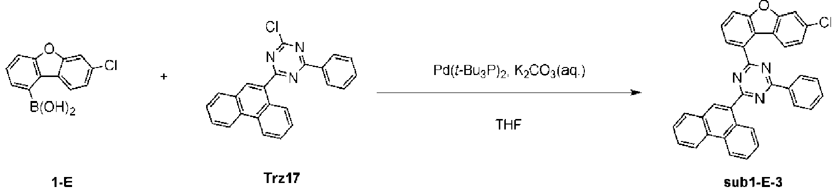

Compound 1-E (15 g, 60.9 mmol) and Compound Trz17 (22.4 g, 60.9 mmol) were added to 300 ml of THF under a nitrogen atmosphere, and the mixture was stirred and refluxed. Then, potassium carbonate (25.2 g, 182.6 mmol) was dissolved in 76 ml of water, added thereto, and the mixture was sufficiently stirred and then bis(tri-tert-butylphosphine)palladium(0) (0.3 g, 0.6 mmol) was added. After 11-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 25.3 g of Compound sub1-E-3. (Yield: 78%, MS: [M+H]⁺= 534)

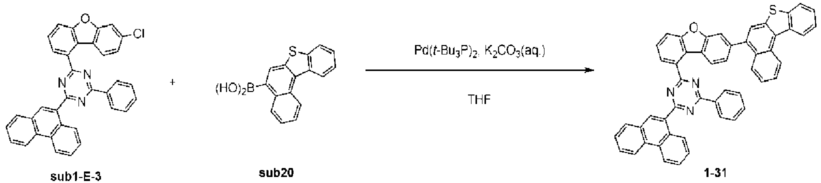

Compound sub1-E-3 (15 g, 28.1 mmol) and Compound sub20 (7.8 g, 28.1 mmol) were added to 300 ml of THF under a nitrogen atmosphere, and the mixture was stirred and refluxed. Then, potassium carbonate (11.6 g, 84.3 mmol) was dissolved in 35 ml of water, added thereto, and the mixture was sufficiently stirred and then bis(tri-tert-butylphosphine)palladium(0) (0.1 g, 0.3 mmol) was added. After 9-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 14.8 g of Compound 1-31. (Yield: 72%, MS: [M+H]⁺= 732)

### Preparation Example 1-32: Preparation of Compound 1-32

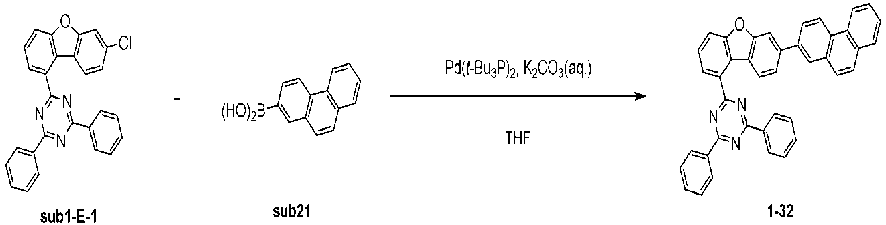

Compound sub1-E-1 (15 g, 34.6 mmol) and Compound sub21 (7.7 g, 34.6 mmol) were added to 300 ml of THF under a nitrogen atmosphere, and the mixture was stirred and refluxed. Then, potassium carbonate (14.3 g, 103.7 mmol) was dissolved in 43 ml of water, added thereto, and the mixture was sufficiently stirred and then bis(tri-tert-butylphosphine)palladium(0) (0.2 g, 0.3 mmol) was added. After 9-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 12.9 g of Compound 1-32. (Yield: 65%, MS: [M+H]⁺= 576)

### Preparation Example 1-33: Preparation of Compound 1-33

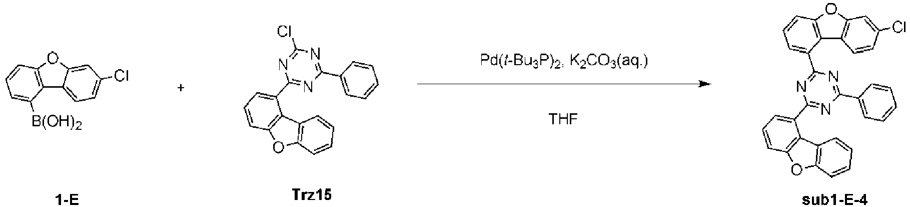

Compound 1-E (15 g, 60.9 mmol) and Compound Trz15 (21.8 g, 60.9 mmol) were added to 300 ml of THF under a nitrogen atmosphere, and the mixture was stirred and refluxed. Then, potassium carbonate (25.2 g, 182.6 mmol) was dissolved in 76 ml of water, added thereto, and the mixture was sufficiently stirred and then bis(tri-tert-butylphosphine)palladium(0) (0.3 g, 0.6 mmol) was added. After 10-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 25.5 g of Compound sub1-E-4. (Yield: 80%, MS: [M+H]⁺= 524)

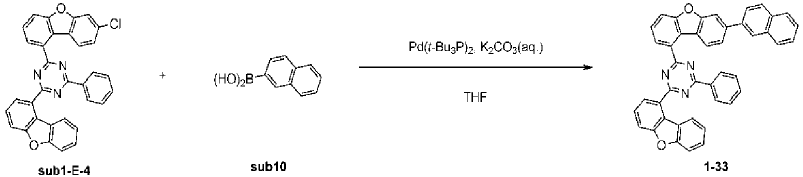

Compound sub1-E-4 (15 g, 28.6 mmol) and Compound sub10 (4.9 g, 28.6 mmol) were added to 300 ml of THF under a nitrogen atmosphere, and the mixture was stirred and refluxed. Then, potassium carbonate (11.9 g, 85.9 mmol) was dissolved in 36 ml of water, added thereto, and the mixture was sufficiently stirred and then bis(tri-tert-butylphosphine)palladium(0) (0.1 g, 0.3 mmol) was added. After 11-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 10.6 g of Compound 1-33. (Yield: 60%, MS: [M+H]⁺= 616)

### Preparation Example 1-34: Preparation of Compound 1-34

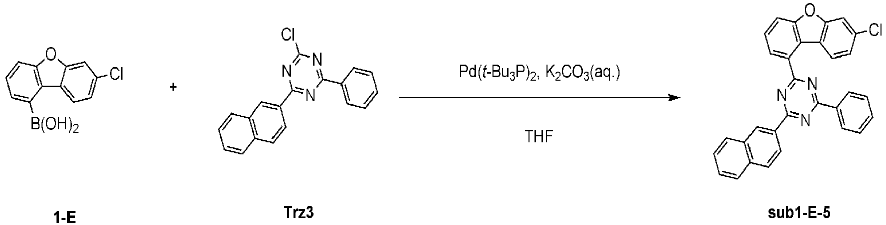

Compound 1-E (15 g, 60.9 mmol) and Compound Trz3 (19.3 g, 60.9 mmol) were added to 300 ml of THF under a nitrogen atmosphere, and the mixture was stirred and refluxed. Then, potassium carbonate (25.2 g, 182.6 mmol) was dissolved in 76 ml of water, added thereto, and the mixture was sufficiently stirred and then bis(tri-tert-butylphosphine)palladium(0) (0.3 g, 0.6 mmol) was added. After 11-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 17.6 g of Compound sub1-E-5. (Yield: 60%, MS: [M+H]⁺= 484)

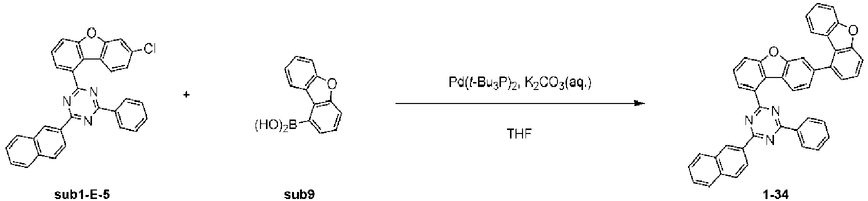

Compound sub1-E-5 (15 g, 31 mmol) and Compound sub9 (6.6 g, 31 mmol) were added to 300 ml of THF under a nitrogen atmosphere, and the mixture was stirred and refluxed. Then, potassium carbonate (12.9 g, 93 mmol) was dissolved in 39 ml of water, added thereto, and the mixture was sufficiently stirred and then bis(tri-tert-butylphosphine)palladium(0) (0.2 g, 0.3 mmol) was added. After 11-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 11.4 g of Compound 1-34. (Yield: 60%, MS: [M+H]⁺= 616)

### Preparation Example 1-35: Preparation of Compound 1-35

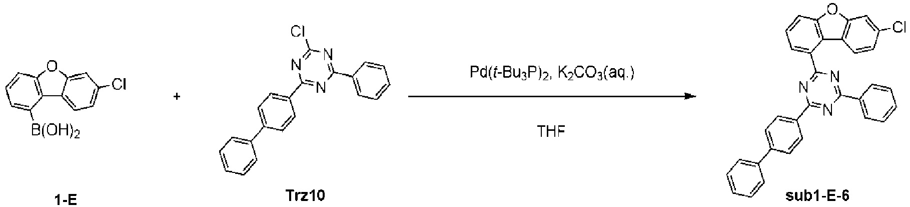

Compound 1-E (15 g, 60.9 mmol) and Compound Trz10 (20.9 g, 60.9 mmol) were added to 300 ml of THF under a nitrogen atmosphere, and the mixture was stirred and refluxed. Then, potassium carbonate (25.2 g, 182.6 mmol) was dissolved in 76 ml of water, added thereto, and the mixture was sufficiently stirred and then bis(tri-tert-butylphosphine)palladium(0) (0.3 g, 0.6 mmol) was added. After 8-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 21.7 g of Compound sub1-E-6. (Yield: 70%, MS: [M+H]⁺= 510)

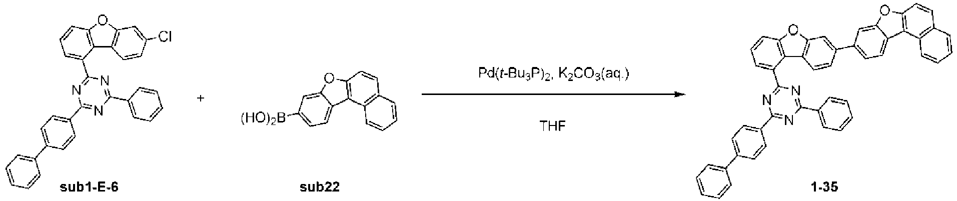

Compound sub1-E-6 (15 g, 29.4 mmol) and Compound sub22 (7.7 g, 29.4 mmol) were added to 300 ml of THF under a nitrogen atmosphere, and the mixture was stirred and refluxed. Then, potassium carbonate (12.2 g, 88.2 mmol) was dissolved in 37 ml of water, added thereto, and the mixture was sufficiently stirred and then bis(tri-tert-butylphosphine)palladium(0) (0.2 g, 0.3 mmol) was added. After 9-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 14.6 g of Compound 1-35. (Yield: 72%, MS: [M+H]⁺= 692)

### Preparation Example 1-36: Preparation of Compound 1-36

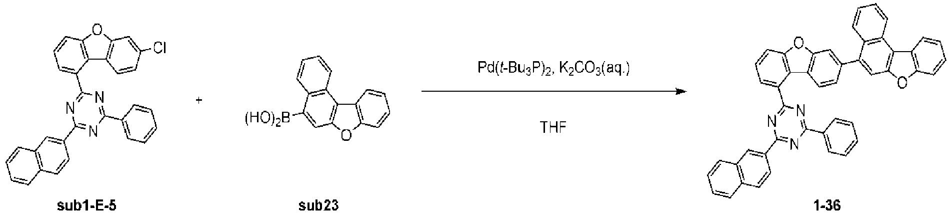

Compound sub1-E-5 (15 g, 31 mmol) and Compound sub23 (8.1 g, 31 mmol) were added to 300 ml of THF under a nitrogen atmosphere, and the mixture was stirred and refluxed. Then, potassium carbonate (12.9 g, 93 mmol) was dissolved in 39 ml of water, added thereto, and the mixture was sufficiently stirred and then bis(tri-tert-butylphosphine)palladium(0) (0.2 g, 0.3 mmol) was added. After 12-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 12.4 g of Compound 1-36. (Yield: 60%, MS: [M+H]⁺= 666)

### Preparation Example 1-37: Preparation of Compound 1-37

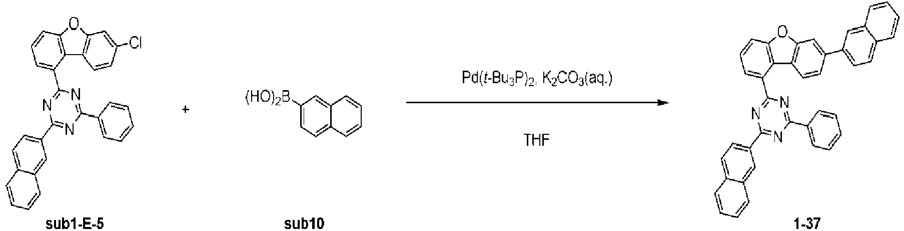

Compound sub1-E-5 (15 g, 31 mmol) and Compound sub10 (5.3 g, 31 mmol) were added to 300 ml of THF under a nitrogen atmosphere, and the mixture was stirred and refluxed. Then, potassium carbonate (12.9 g, 93 mmol) was dissolved in 39 ml of water, added thereto, and the mixture was sufficiently stirred and then bis(tri-tert-butylphosphine)palladium(0) (0.2 g, 0.3 mmol) was added. After 12-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 14.1 g of Compound 1-37. (Yield: 79%, MS: [M+H]⁺= 576)

### Preparation Example 1-38: Preparation of Compound 1-38

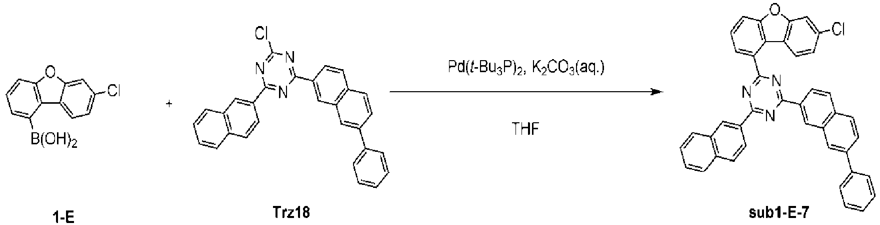

Compound 1-E (15 g, 60.9 mmol) and Compound Trz18 (27 g, 60.9 mmol) were added to 300 ml of THF under a nitrogen atmosphere, and the mixture was stirred and refluxed. Then, potassium carbonate (25.2 g, 182.6 mmol) was dissolved in 76 ml of water, added thereto, and the mixture was sufficiently stirred and then bis(tri-tert-butylphosphine)palladium(0) (0.3 g, 0.6 mmol) was added. After 11-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 24.1 g of Compound sub1-E-7. (Yield: 65%, MS: [M+H]⁺= 610)

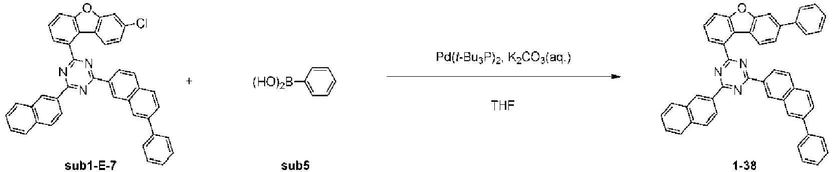

Compound sub1-E-7 (15 g, 24.6 mmol) and Compound sub5 (3 g, 24.6 mmol) were added to 300 ml of THF under a nitrogen atmosphere, and the mixture was stirred and refluxed. Then, potassium carbonate (10.2 g, 73.8 mmol) was dissolved in 31 ml of water, added thereto, and the mixture was sufficiently stirred and then bis(tri-tert-butylphosphine)palladium(0) (0.1 g, 0.2 mmol) was added. After 9-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 10.1 g of Compound 1-38. (Yield: 63%, MS: [M+H]⁺= 652)

### Preparation Example 1-39: Preparation of Compound 1-39

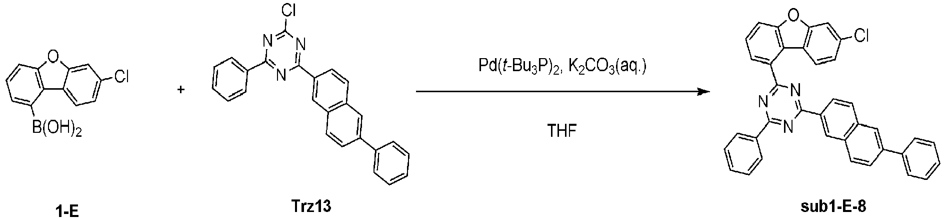

Compound 1-E (15 g, 60.9 mmol) and Compound Trz13 (24 g, 60.9 mmol) were added to 300 ml of THF under a nitrogen atmosphere, and the mixture was stirred and refluxed. Then, potassium carbonate (25.2 g, 182.6 mmol) was dissolved in 76 ml of water, added thereto, and the mixture was sufficiently stirred and then bis(tri-tert-butylphosphine)palladium(0) (0.3 g, 0.6 mmol) was added. After 12-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 26.2 g of Compound sub1-E-8. (Yield: 77%, MS: [M+H]⁺= 560)

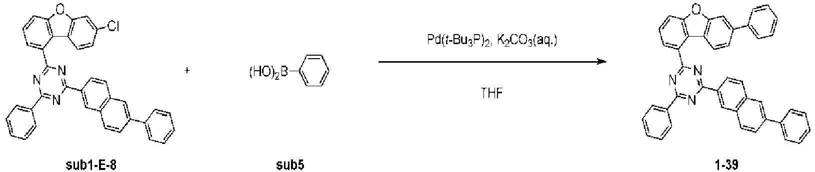

Compound sub1-E-8 (15 g, 26.8 mmol) and Compound sub5 (3.3 g, 26.8 mmol) were added to 300 ml of THF under a nitrogen atmosphere, and the mixture was stirred and refluxed. Then, potassium carbonate (11.1 g, 80.3 mmol) was dissolved in 33 ml of water, added thereto, and the mixture was sufficiently stirred and then bis(tri-tert-butylphosphine)palladium(0) (0.1 g, 0.3 mmol) was added. After 11-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 10.9 g of Compound 1-39. (Yield: 68%, MS: [M+H]⁺= 602)

### Preparation Example 1-40: Preparation of Compound 1-40

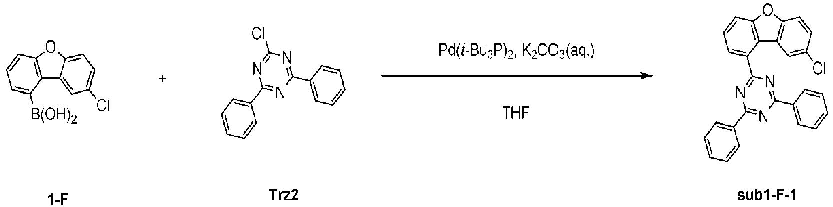

Compound 1-F (15 g, 60.9 mmol) and Compound Trz2 (16.3 g, 60.9 mmol) were added to 300 ml of THF under a nitrogen atmosphere, and the mixture was stirred and refluxed. Then, potassium carbonate (25.2 g, 182.6 mmol) was dissolved in 76 ml of water, added thereto, and the mixture was sufficiently stirred and then bis(tri-tert-butylphosphine)palladium(0) (0.3 g, 0.6 mmol) was added. After 12-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 19.2 g of Compound sub1-F-1. (Yield: 73%, MS: [M+H]⁺= 434)

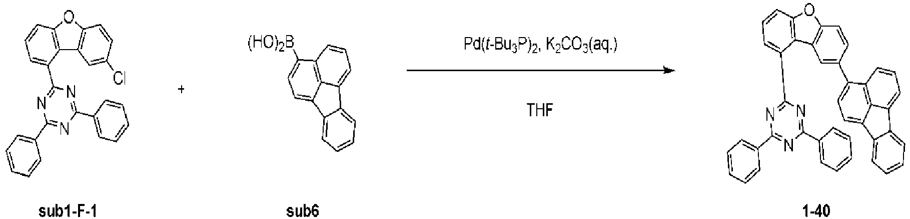

Compound sub1-F-1 (15 g, 34.6 mmol) and Compound sub6 (8.5 g, 34.6 mmol) were added to 300 ml of THF under a nitrogen atmosphere, and the mixture was stirred and refluxed. Then, potassium carbonate (14.3 g, 103.7 mmol) was dissolved in 43 ml of water, added thereto, and the mixture was sufficiently stirred and then bis(tri-tert-butylphosphine)palladium(0) (0.2 g, 0.3 mmol) was added. After 10-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 14.7 g of Compound 1-40. (Yield: 71%, MS: [M+H]⁺= 600)

### Preparation Example 1-41: Preparation of Compound 1-41

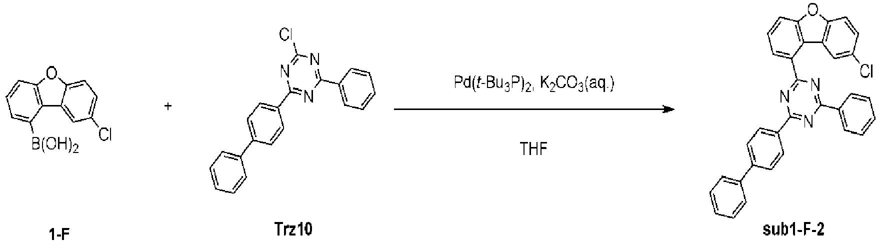

Compound 1-F (15 g, 60.9 mmol) and Compound Trz10 (20.9 g, 60.9 mmol) were added to 300 ml of THF under a nitrogen atmosphere, and the mixture was stirred and refluxed. Then, potassium carbonate (25.2 g, 182.6 mmol) was dissolved in 76 ml of water, added thereto, and the mixture was sufficiently stirred and then bis(tri-tert-butylphosphine)palladium(0) (0.3 g, 0.6 mmol) was added. After 11-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 21.1 g of Compound sub1-F-2. (Yield: 68%, MS: [M+H]⁺= 510)

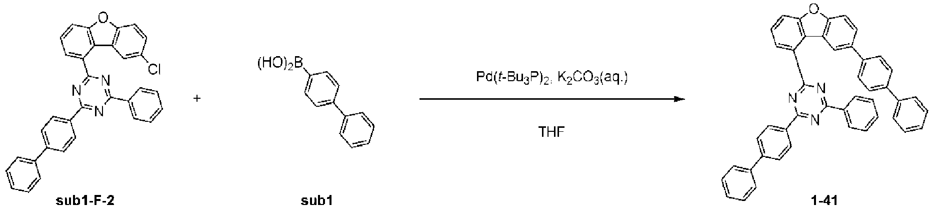

Compound sub1-F-2 (15 g, 29.4 mmol) and Compound sub1 (5.8 g, 29.4 mmol) were added to 300 ml of THF under a nitrogen atmosphere, and the mixture was stirred and refluxed. Then, potassium carbonate (12.2 g, 88.2 mmol) was dissolved in 37 ml of water, added thereto, and the mixture was sufficiently stirred and then bis(tri-tert-butylphosphine)palladium(0) (0.2 g, 0.3 mmol) was added. After 12-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 14.2 g of Compound 1-41. (Yield: 77%, MS: [M+H]⁺= 628)

### Preparation Example 1-42: Preparation of Compound 1-42

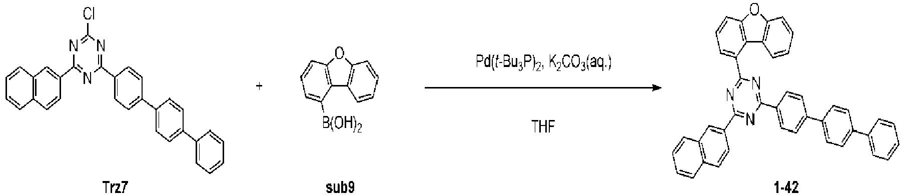

Compound Trz7 (15 g, 31.9 mmol) and Compound sub9 (6.8 g, 31.9 mmol) were added to 300 ml of THF under a nitrogen atmosphere, and the mixture was stirred and refluxed. Then, potassium carbonate (13.2 g, 95.8 mmol) was dissolved in 40 ml of water, added thereto, and the mixture was sufficiently stirred and then bis(tri-tert-butylphosphine)palladium(0) (0.2 g, 0.3 mmol) was added. After 9-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 15.2 g of Compound 1-42. (Yield: 79%, MS: [M+H]⁺= 602)

### Preparation Example 1-43: Preparation of Compound 1-43

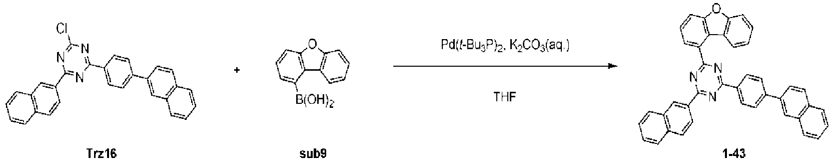

Compound Trz16 (15 g, 33.8 mmol) and Compound sub9 (7.2 g, 33.8 mmol) were added to 300 ml of THF under a nitrogen atmosphere, and the mixture was stirred and refluxed. Then, potassium carbonate (14 g, 101.4 mmol) was dissolved in 42 ml of water, added thereto, and the mixture was sufficiently stirred and then bis(tri-tert-butylphosphine)palladium(0) (0.2 g, 0.3 mmol) was added. After 12-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 15 g of Compound 1-43. (Yield: 77%, MS: [M+H]⁺= 576)

### Preparation Example 1-44: Preparation of Compound 1-44

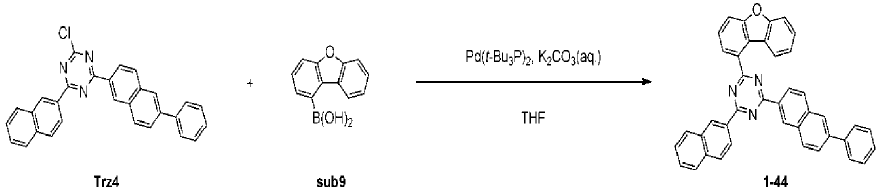

Compound Trz4 (15 g, 33.8 mmol) and Compound sub9 (7.2 g, 33.8 mmol) were added to 300 ml of THF under a nitrogen atmosphere, and the mixture was stirred and refluxed. Then, potassium carbonate (14 g, 101.4 mmol) was dissolved in 42 ml of water, added thereto, and the mixture was sufficiently stirred and then bis(tri-tert-butylphosphine)palladium(0) (0.2 g, 0.3 mmol) was added. After 11-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 14.2 g of Compound 1-44. (Yield: 73%, MS: [M+H]⁺= 576)

### Preparation Example 1-45: Preparation of Compound 1-45

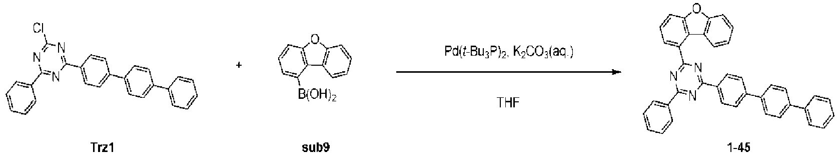

Compound Trz1 (15 g, 35.7 mmol) and Compound sub9 (7.6 g, 35.7 mmol) were added to 300 ml of THF under a nitrogen atmosphere, and the mixture was stirred and refluxed. Then, potassium carbonate (14.8 g, 107.2 mmol) was dissolved in 44 ml of water, added thereto, and the mixture was sufficiently stirred and then bis(tri-tert-butylphosphine)palladium(0) (0.2 g, 0.4 mmol) was added. After 9-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 12.2 g of Compound 1-45. (Yield: 62%, MS: [M+H]⁺= 552)

### Preparation Example 1-46: Preparation of Compound 1-46

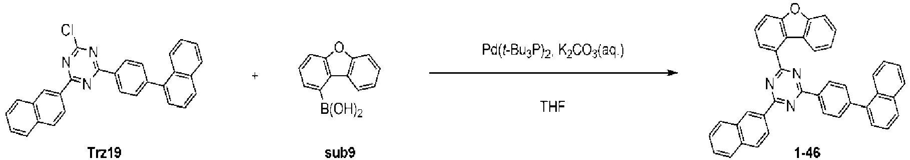

Compound Trz19 (15 g, 33.8 mmol) and Compound sub9 (7.2 g, 33.8 mmol) were added to 300 ml of THF under a nitrogen atmosphere, and the mixture was stirred and refluxed. Then, potassium carbonate (14 g, 101.4 mmol) was dissolved in 42 ml of water, added thereto, and the mixture was sufficiently stirred and then bis(tri-tert-butylphosphine)palladium(0) (0.2 g, 0.3 mmol) was added. After 8-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 13.6 g of Compound 1-46. (Yield: 70%, MS: [M+H]⁺= 576)

### Preparation Example 1-47: Preparation of Compound 1-47

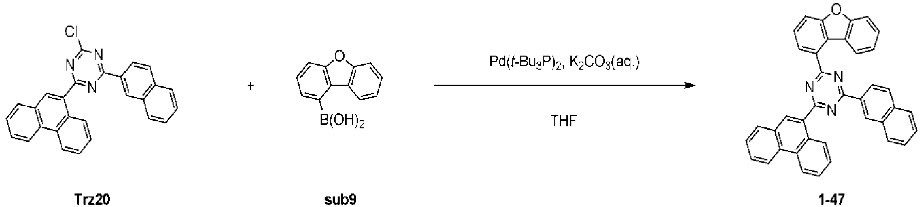

Compound Trz20 (15 g, 35.9 mmol) and Compound sub9 (7.6 g, 35.9 mmol) were added to 300 ml of THF under a nitrogen atmosphere, and the mixture was stirred and refluxed. Then, potassium carbonate (14.9 g, 107.7 mmol) was dissolved in 45 ml of water, added thereto, and the mixture was sufficiently stirred and then bis(tri-tert-butylphosphine)palladium(0) (0.2 g, 0.4 mmol) was added. After 8-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 15 g of Compound 1-47. (Yield: 76%, MS: [M+H]⁺= 550)

### Preparation Example 1-48: Preparation of Compound 1-48

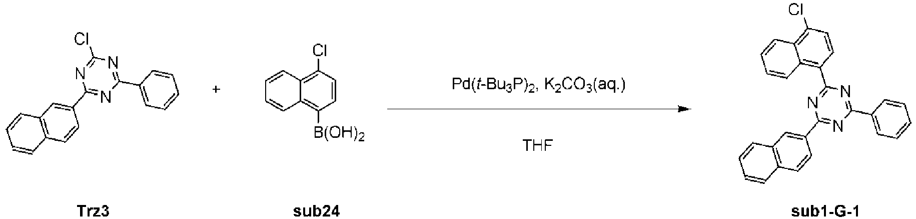

Compound Trz3 (15 g, 47.2 mmol) and Compound sub24 (9.7 g, 47.2 mmol) were added to 300 ml of THF under a nitrogen atmosphere, and the mixture was stirred and refluxed. Then, potassium carbonate (19.6 g, 141.6 mmol) was dissolved in 59 ml of water, added thereto, and the mixture was sufficiently stirred and then bis(tri-tert-butylphosphine)palladium(0) (0.2 g, 0.5 mmol) was added. After 11-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 13 g of Compound sub1-G-1. (Yield: 62%, MS: [M+H]⁺= 444)

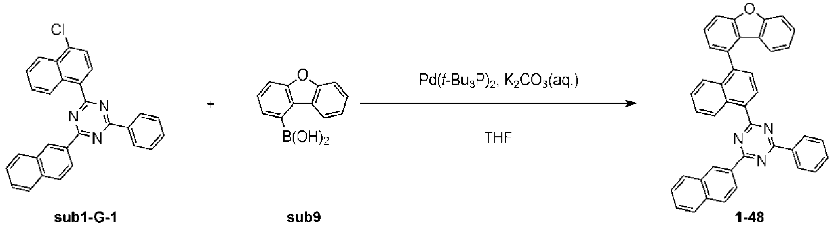

Compound sub1-G-1 (15 g, 33.8 mmol) and Compound sub9 (7.2 g, 33.8 mmol) were added to 300 ml of THF under a nitrogen atmosphere, and the mixture was stirred and refluxed. Then, potassium carbonate (14 g, 101.4 mmol) was dissolved in 42 ml of water, added thereto, and the mixture was sufficiently stirred and then bis(tri-tert-butylphosphine)palladium(0) (0.2 g, 0.3 mmol) was added. After 10-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 15.2 g of Compound 1-48. (Yield: 78%, MS: [M+H]⁺= 576)

### Preparation Example 1-49: Preparation of Compound 1-49

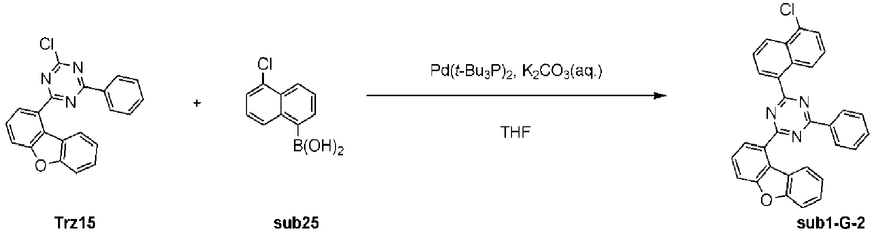

Compound Trz15 (15 g, 41.9 mmol) and Compound sub25 (8.7 g, 41.9 mmol) were added to 300 ml of THF under a nitrogen atmosphere, and the mixture was stirred and refluxed. Then, potassium carbonate (17.4 g, 125.8 mmol) was dissolved in 52 ml of water, added thereto, and the mixture was sufficiently stirred and then bis(tri-tert-butylphosphine)palladium(0) (0.2 g, 0.4 mmol) was added. After 8-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 12.6 g of Compound sub1-G-2. (Yield: 62%, MS: [M+H]⁺= 484)

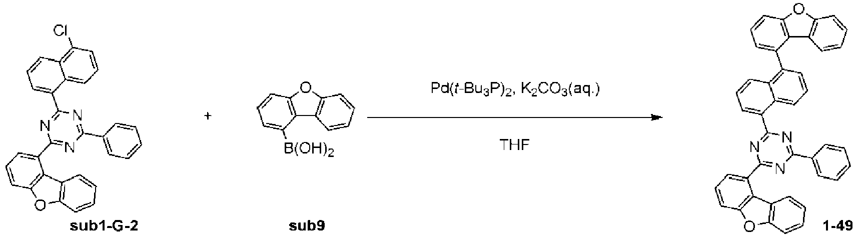

Compound sub1-G-2 (15 g, 31 mmol) and Compound sub9 (6.6 g, 31 mmol) were added to 300 ml of THF under a nitrogen atmosphere, and the mixture was stirred and refluxed. Then, potassium carbonate (12.9 g, 93 mmol) was dissolved in 39 ml of water, added thereto, and the mixture was sufficiently stirred and then bis(tri-tert-butylphosphine)palladium(0) (0.2 g, 0.3 mmol) was added. After 8-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 13.7 g of Compound 1-49. (Yield: 72%, MS: [M+H]⁺= 616)

### Preparation Example 1-50: Preparation of Compound 1-50

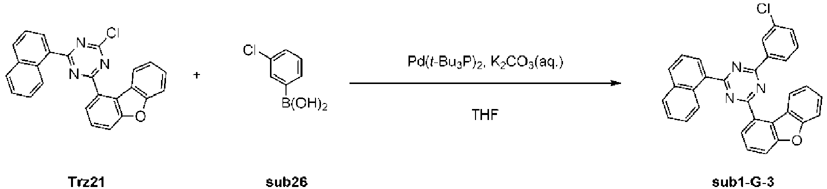

Compound Trz21 (15 g, 36.8 mmol) and Compound sub26 (5.8 g, 36.8 mmol) were added to 300 ml of THF under a nitrogen atmosphere, and the mixture was stirred and refluxed. Then, potassium carbonate (15.2 g, 110.3 mmol) was dissolved in 46 ml of water, added thereto, and the mixture was sufficiently stirred and then bis(tri-tert-butylphosphine)palladium(0) (0.2 g, 0.4 mmol) was added. After 9-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 12.8 g of Compound sub1-G-3. (Yield: 72%, MS: [M+H]⁺= 484)

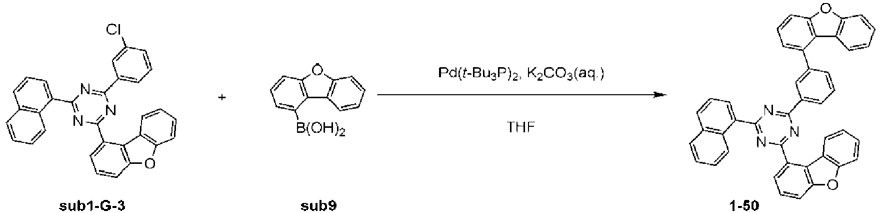

Compound sub1-G-3 (15 g, 31 mmol) and Compound sub9 (6.6 g, 31 mmol) were added to 300 ml of THF under a nitrogen atmosphere, and the mixture was stirred and refluxed. Then, potassium carbonate (12.9 g, 93 mmol) was dissolved in 39 ml of water, added thereto, and the mixture was sufficiently stirred and then bis(tri-tert-butylphosphine)palladium(0) (0.2 g, 0.3 mmol) was added. After 10-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 13.2 g of Compound 1-50. (Yield: 69%, MS: [M+H]⁺= 616)

### Preparation Example 1-51: Preparation of Compound 1-51

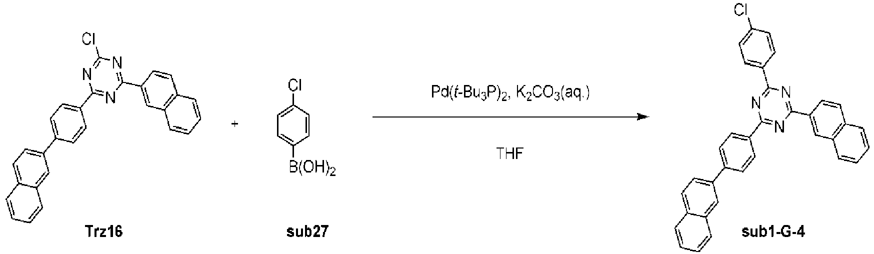

Compound Trz16 (15 g, 36.8 mmol) and Compound sub27 (5.3 g, 33.8 mmol) were added to 300 ml of THF under a nitrogen atmosphere, and the mixture was stirred and refluxed. Then, potassium carbonate (14 g, 101.4 mmol) was dissolved in 42 ml of water, added thereto, and the mixture was sufficiently stirred and then bis(tri-tert-butylphosphine)palladium(0) (0.2 g, 0.3 mmol) was added. After 11-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 13.3 g of Compound sub1-G-4. (Yield: 76%, MS: [M+H]⁺= 520)

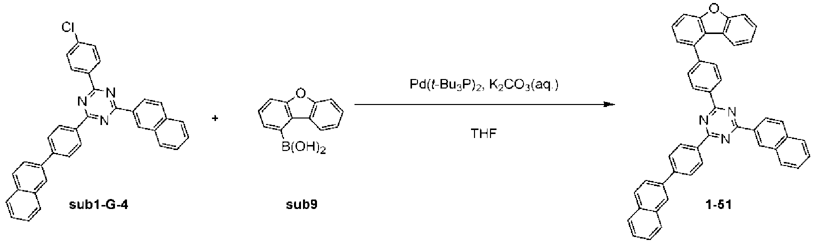

Compound sub1-G-4 (15 g, 28.8 mmol) and Compound sub9 (6.1 g, 28.8 mmol) were added to 300 ml of THF under a nitrogen atmosphere, and the mixture was stirred and refluxed. Then, potassium carbonate (12 g, 86.5 mmol) was dissolved in 36 ml of water, added thereto, and the mixture was sufficiently stirred and then bis(tri-tert-butylphosphine)palladium(0) (0.1 g, 0.3 mmol) was added. After 9-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 13.3 g of Compound 1-51. (Yield: 71%, MS: [M+H]⁺= 652)

### Preparation Example 1-52: Preparation of Compound 1-52

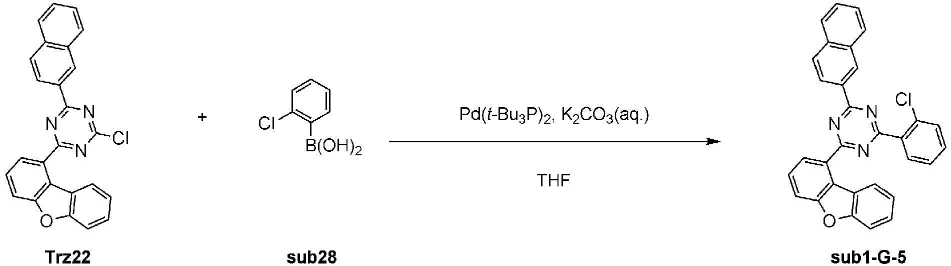

Compound Trz22 (15 g, 36.8 mmol) and Compound sub28 (5.8 g, 36.8 mmol) were added to 300 ml of THF under a nitrogen atmosphere, and the mixture was stirred and refluxed. Then, potassium carbonate (15.2 g, 110.3 mmol) was dissolved in 46 ml of water, added thereto, and the mixture was sufficiently stirred and then bis(tri-tert-butylphosphine)palladium(0) (0.2 g, 0.4 mmol) was added. After 12-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 12.8 g of Compound sub1-G-5. (Yield: 72%, MS: [M+H]⁺= 484)

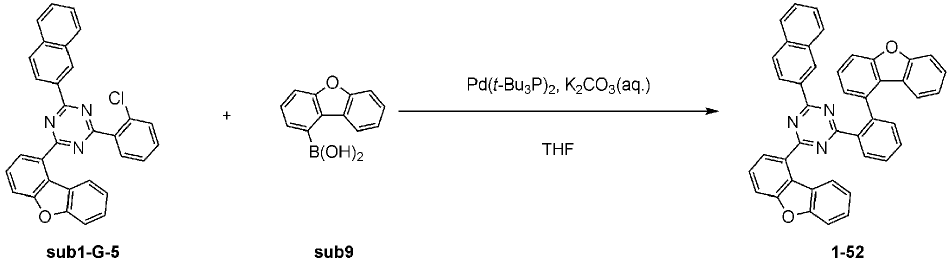

Compound sub1-G-5 (15 g, 31 mmol) and Compound sub9 (6.6 g, 31 mmol) were added to 300 ml of THF under a nitrogen atmosphere, and the mixture was stirred and refluxed. Then, potassium carbonate (12.9 g, 93 mmol) was dissolved in 39 ml of water, added thereto, and the mixture was sufficiently stirred and then bis(tri-tert-butylphosphine)palladium(0) (0.2 g, 0.3 mmol) was added. After 10-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 13 g of Compound 1-52. (Yield: 68%, MS: [M+H]⁺= 616)

### Preparation Example 1-53: Preparation of Compound 1-53

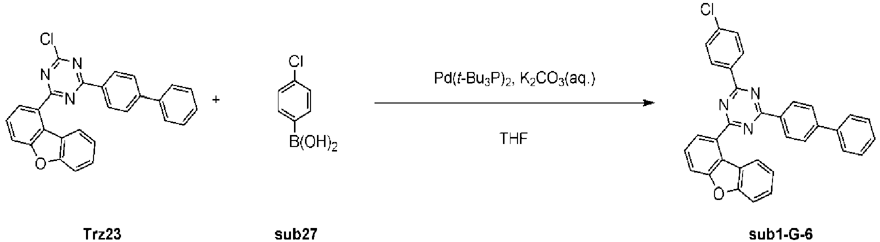

Compound Trz23 (15 g, 34.6 mmol) and Compound sub27 (5.4 g, 34.6 mmol) were added to 300 ml of THF under a nitrogen atmosphere, and the mixture was stirred and refluxed. Then, potassium carbonate (14.3 g, 103.7 mmol) was dissolved in 43 ml of water, added thereto, and the mixture was sufficiently stirred and then bis(tri-tert-butylphosphine)palladium(0) (0.2 g, 0.3 mmol) was added. After 10-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 11.3 g of Compound sub1-G-6. (Yield: 64%, MS: [M+H]⁺= 510)

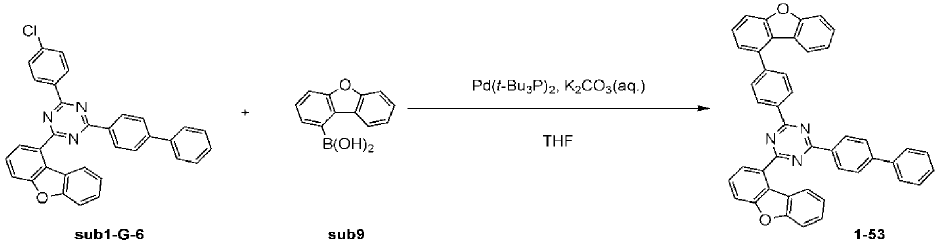

Compound sub1-G-6 (15 g, 31 mmol) and Compound sub9 (6.6 g, 31 mmol) were added to 300 ml of THF under a nitrogen atmosphere, and the mixture was stirred and refluxed. Then, potassium carbonate (12.9 g, 93 mmol) was dissolved in 39 ml of water, added thereto, and the mixture was sufficiently stirred and then bis(tri-tert-butylphosphine)palladium(0) (0.2 g, 0.3 mmol) was added. After 10-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 13 g of Compound 1-53. (Yield: 68%, MS: [M+H]⁺= 616)

### Preparation Example 1-54: Preparation of Compound 1-54

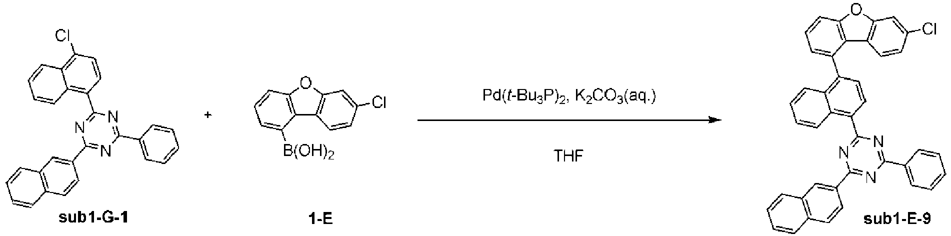

Compound sub-G-1 (15 g, 33.8 mmol) and Compound 1-E (8.3 g, 33.8 mmol) were added to 300 ml of THF under a nitrogen atmosphere, and the mixture was stirred and refluxed. Then, potassium carbonate (14 g, 101.4 mmol) was dissolved in 42 ml of water, added thereto, and the mixture was sufficiently stirred and then bis(tri-tert-butylphosphine)palladium(0) (0.2 g, 0.3 mmol) was added. After 8-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 14.4 g of Compound sub1-E-9. (Yield: 70%, MS: [M+H]⁺= 610)

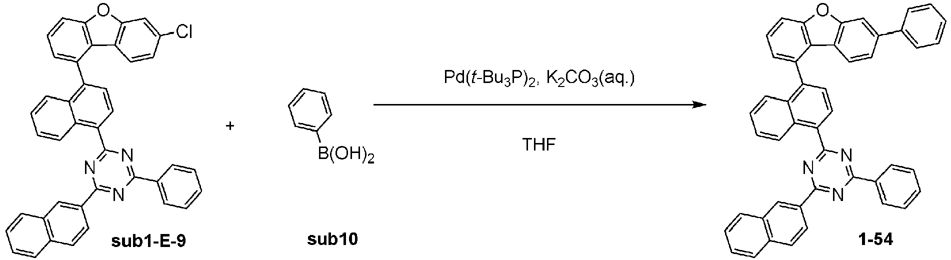

Compound sub 1-E-9 (15 g, 24.6 mmol) and Compound sub 10 (3 g, 24.6 mmol) were added to 300 ml of THF under a nitrogen atmosphere, and the mixture was stirred and refluxed. Then, potassium carbonate (10.2 g, 73.8 mmol) was dissolved in 31 ml of water, added thereto, and the mixture was sufficiently stirred and then bis(tri-tert-butylphosphine)palladium(0) (0.1 g, 0.2 mmol) was added. After 11-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 12.2 g of Compound 1-54. (Yield: 76%, MS: [M+H]⁺= 652)

### Preparation Example 1-55: Preparation of Compound 1-55

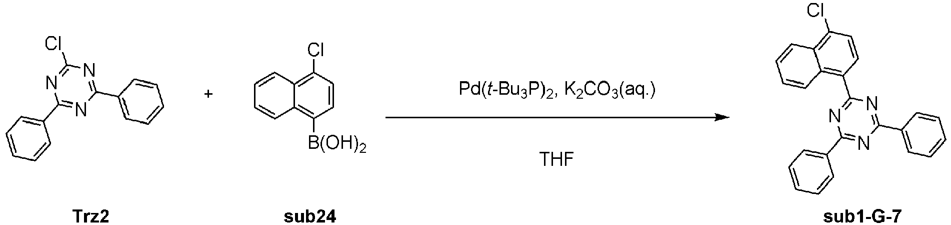

Compound Trz2 (15 g, 56 mmol) and Compound sub24 (11.6 g, 56 mmol) were added to 300 ml of THF under a nitrogen atmosphere, and the mixture was stirred and refluxed. Then, potassium carbonate (23.2 g, 168.1 mmol) was dissolved in 70 ml of water, added thereto, and the mixture was sufficiently stirred and then bis(tri-tert-butylphosphine)palladium(0) (0.3 g, 0.6 mmol) was added. After 11-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 15.6 g of Compound sub1-G-7. (Yield: 71%, MS: [M+H]⁺= 394)

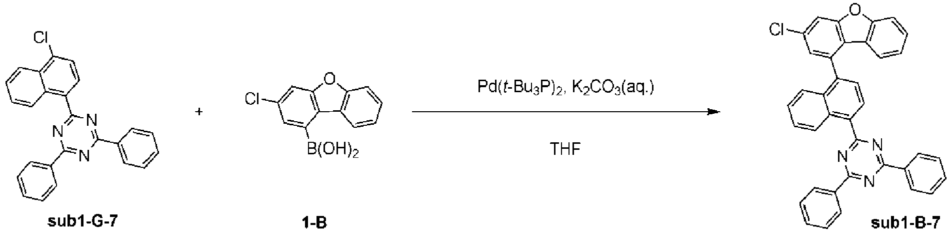

Compound sub1-G-7 (15 g, 38.1 mmol) and Compound 1-B (9.4 g, 38.1 mmol) were added to 300 ml of THF under a nitrogen atmosphere, and the mixture was stirred and refluxed. Then, potassium carbonate (15.8 g, 114.3 mmol) was dissolved in 47 ml of water, added thereto, and the mixture was sufficiently stirred and then bis(tri-tert-butylphosphine)palladium(0) (0.2 g, 0.4 mmol) was added. After 10-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 13.8 g of Compound sub1-B-7. (Yield: 65%, MS: [M+H]⁺= 560)

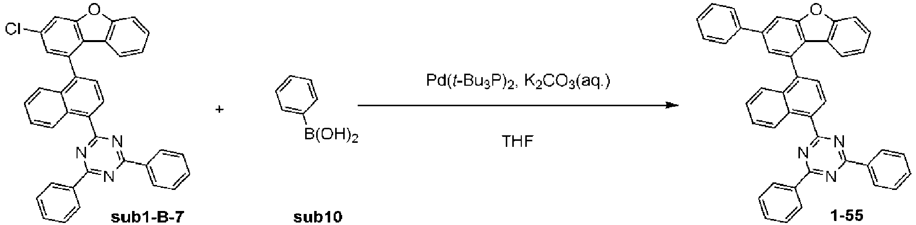

Compound sub1-B-7 (15 g, 26.8 mmol) and Compound sub10 (3.3 g, 26.8 mmol) were added to 300 ml of THF under a nitrogen atmosphere, and the mixture was stirred and refluxed. Then, potassium carbonate (11.1 g, 80.3 mmol) was dissolved in 33 ml of water, added thereto, and the mixture was sufficiently stirred and then bis(tri-tert-butylphosphine) palladium (0) (0.1 g, 0.3 mmol) was added. After 9-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 12.9 g of Compound 1-55. (Yield: 80%, MS: [M+H]⁺= 602)

### Preparation Example 1-56: Preparation of Compound 1-56

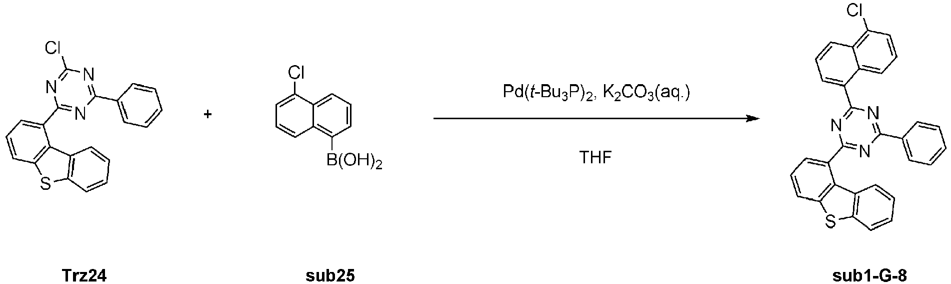

Compound Trz24 (15 g, 38.1 mmol) and Compound sub25 (9.4 g, 38.1mmol) were added to 300 ml of THF under a nitrogen atmosphere, and the mixture was stirred and refluxed. Then, potassium carbonate (15.8 g, 114.3 mmol) was dissolved in 47 ml of water, added thereto, and the mixture was sufficiently stirred and then bis(tri-tert-butylphosphine)palladium(0) (0.2 g, 0.4 mmol) was added. After 10-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 13.8 g of Compound sub1-G-8. (Yield: 65%, MS: [M+H]⁺= 560)

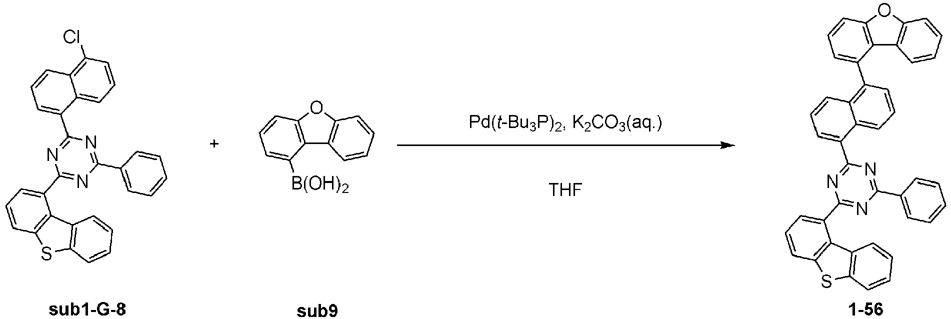

Compound sub1-G-8 (15 g, 30 mmol) and Compound sub9 (6.4 g, 30 mmol) were added to 300 ml of THF under a nitrogen atmosphere, and the mixture was stirred and refluxed. Then, potassium carbonate (12.4 g, 90 mmol) was dissolved in 37 ml of water, added thereto, and the mixture was sufficiently stirred and then bis(tri-tert-butylphosphine)palladium(0) (0.2 g, 0.3 mmol) was added. After 10-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 13.4 g of Compound 1-56. (Yield: 71%, MS: [M+H]⁺= 632)

### Preparation Example 1-57: Preparation of Compound 1-57

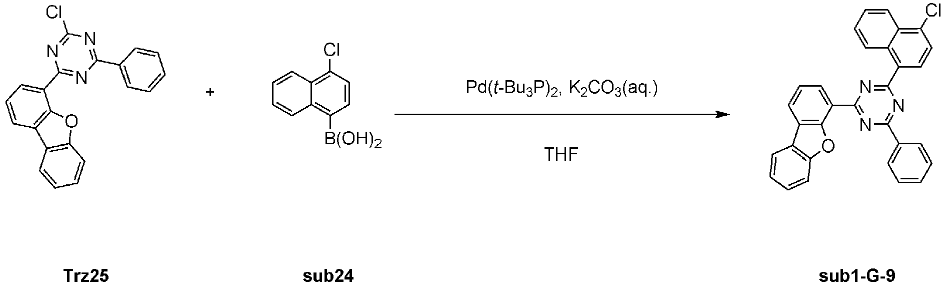

Compound Trz25 (15 g, 41.9 mmol) and Compound sub24 (8.7 g, 41.9 mmol) were added to 300 ml of THF under a nitrogen atmosphere, and the mixture was stirred and refluxed. Then, potassium carbonate (17.4 g, 125.8 mmol) was dissolved in 52 ml of water, added thereto, and the mixture was sufficiently stirred and then bis(tri-tert-butylphosphine)palladium(0) (0.2 g, 0.4 mmol) was added. After 11-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 12.4 g of Compound sub1-G-9. (Yield: 61%, MS: [M+H]⁺= 484)

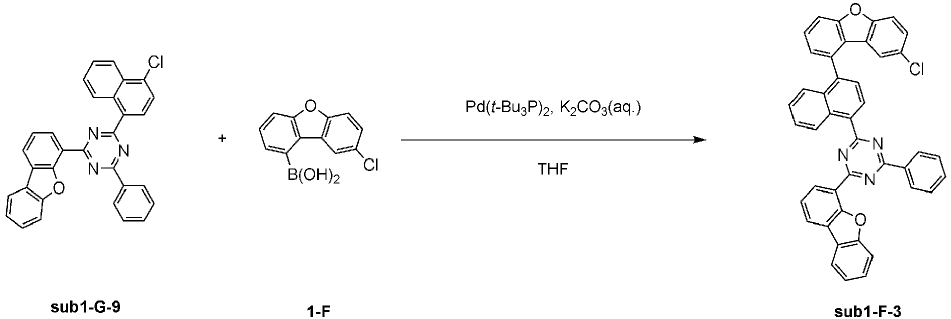

Compound sub1-G-9 (15 g, 31 mmol) and Compound 1-F (7.6 g, 31 mmol) were added to 300 ml of THF under a nitrogen atmosphere, and the mixture was stirred and refluxed. Then, potassium carbonate (12.9 g, 93 mmol) was dissolved in 39 ml of water, added thereto, and the mixture was sufficiently stirred and then bis(tri-tert-butylphosphine)palladium(0) (0.2 g, 0.3 mmol) was added. After 9-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 12.5 g of Compound sub1-F-3. (Yield: 62%, MS: [M+H]⁺= 650)

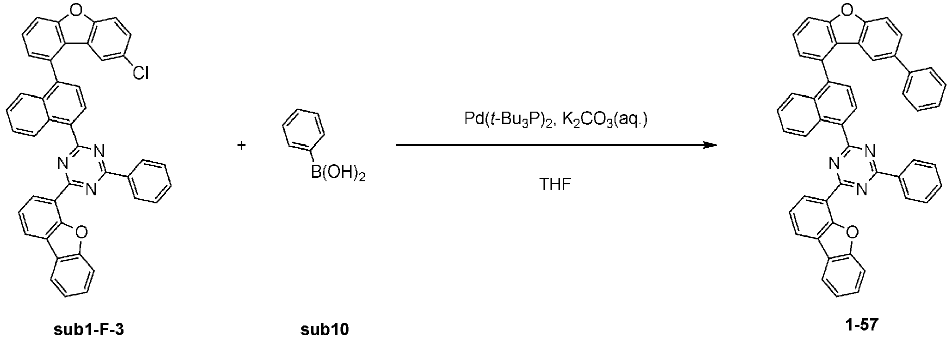

Compound sub1-F-3 (15 g, 23.1 mmol) and Compound sub10 (2.8 g, 23.1 mmol) were added to 300 ml of THF under a nitrogen atmosphere, and the mixture was stirred and refluxed. Then, potassium carbonate (9.6 g, 69.2 mmol) was dissolved in 29 ml of water, added thereto, and the mixture was sufficiently stirred and then bis(tri-tert-butylphosphine)palladium(0) (0.1 g, 0.2 mmol) was added. After 11-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 12.8 g of Compound 1-57. (Yield: 80%, MS: [M+H]⁺= 692)

### Preparation Example 1-58: Preparation of Compound 1-58

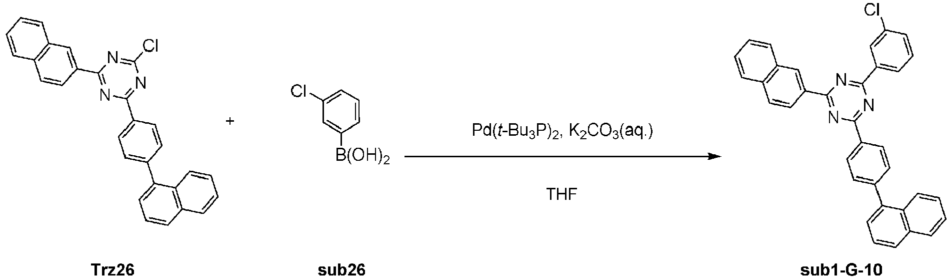

Compound Trz26 (15 g, 33.8 mmol) and Compound sub26 (5.3 g, 33.8 mmol) were added to 300 ml of THF under a nitrogen atmosphere, and the mixture was stirred and refluxed. Then, potassium carbonate (14 g, 101.4 mmol) was dissolved in 42 ml of water, added thereto, and the mixture was sufficiently stirred and then bis(tri-tert-butylphosphine)palladium(0) (0.2 g, 0.3 mmol) was added. After 10-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 10.5 g of Compound sub1-G-10. (Yield: 60%, MS: [M+H]⁺= 520)

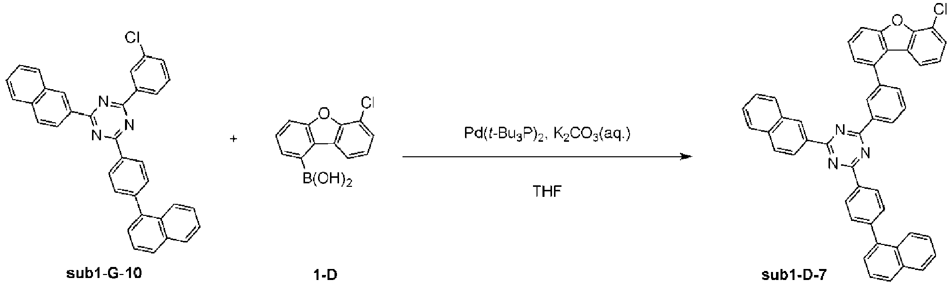

Compound sub1-G-10 (15 g, 28.8 mmol) and Compound 1-D (7.1 g, 28.8 mmol) were added to 300 ml of THF under a nitrogen atmosphere, and the mixture was stirred and refluxed. Then, potassium carbonate (12 g, 86.5 mmol) was dissolved in 36 ml of water, added thereto, and the mixture was sufficiently stirred and then bis(tri-tert-butylphosphine)palladium(0) (0.1 g, 0.3 mmol) was added. After 10-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 15 g of Compound sub1-D-7. (Yield: 76%, MS: [M+H]⁺= 686)

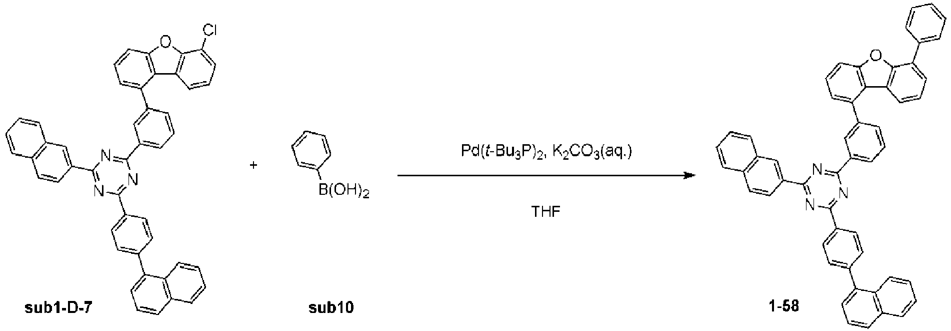

Compound sub1-D-7 (15 g, 21.9 mmol) and Compound 10 (2.7 g, 21.9 mmol) were added to 300 ml of THF under a nitrogen atmosphere, and the mixture was stirred and refluxed. Then, potassium carbonate (9.1 g, 65.6 mmol) was dissolved in 27 ml of water, added thereto, and the mixture was sufficiently stirred and then bis(tri-tert-butylphosphine)palladium(0) (0.1 g, 0.2 mmol) was added. After 12-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 9.9 g of Compound 1-58. (Yield: 62%, MS: [M+H]⁺= 728)

### Preparation Example 1-59: Preparation of Compound 1-59

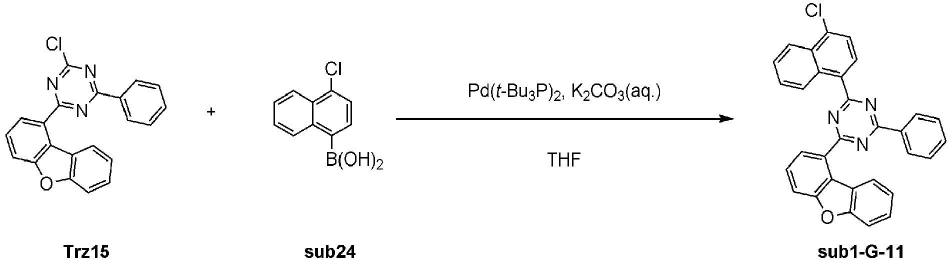

Compound Trz15 (15 g, 41.9 mmol) and Compound sub24 (8.7 g, 41.9 mmol) were added to 300 ml of THF under a nitrogen atmosphere, and the mixture was stirred and refluxed. Then, potassium carbonate (17.4 g, 125.8 mmol) was dissolved in 52 ml of water, added thereto, and the mixture was sufficiently stirred and then bis(tri-tert-butylphosphine)palladium(0) (0.2 g, 0.4 mmol) was added. After 11-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 12.4 g of Compound sub1-G-11. (Yield: 61%, MS: [M+H]⁺= 484)

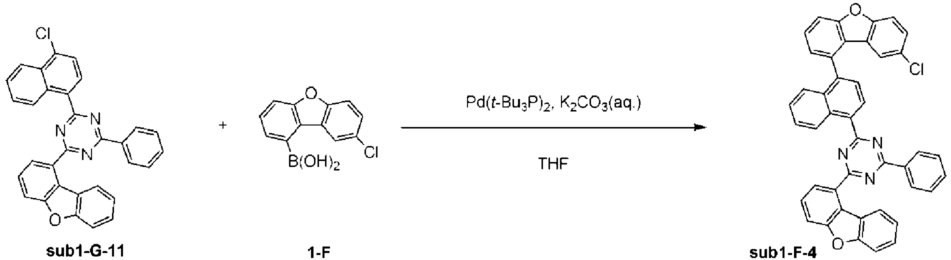

Compound sub1-G-11 (15 g, 28.8 mmol) and Compound 1-F (7.1 g, 28.8 mmol) were added to 300 ml of THF under a nitrogen atmosphere, and the mixture was stirred and refluxed. Then, potassium carbonate (12 g, 86.5 mmol) was dissolved in 36 ml of water, added thereto, and the mixture was sufficiently stirred and then bis(tri-tert-butylphosphine)palladium(0) (0.1 g, 0.3 mmol) was added. After 10-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 15 g of Compound sub1-F-4. (Yield: 76%, MS: [M+H]⁺= 686)

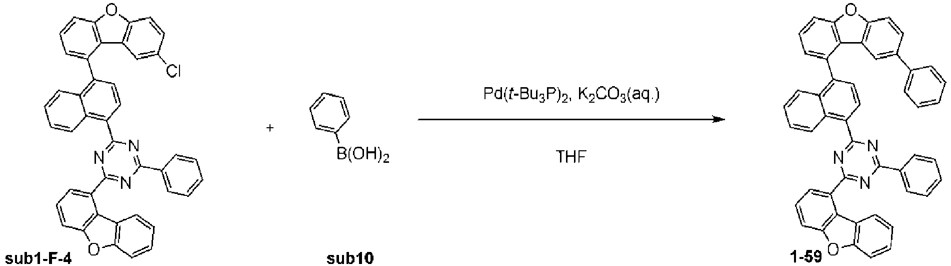

Compound sub 1-F-4 (15 g, 23.1 mmol) and Compound sub 10 (2.8 g, 23.1 mmol) were added to 300 ml of THF under a nitrogen atmosphere, and the mixture was stirred and refluxed. Then, potassium carbonate (9.6 g, 69.2 mmol) was dissolved in 29 ml of water, added thereto, and the mixture was sufficiently stirred and then bis(tri-tert-butylphosphine)palladium(0) (0.1 g, 0.2 mmol) was added. After 10-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 12.1 g of Compound 1-59. (Yield: 76%, MS: [M+H]⁺= 692)

### Preparation Example 1-60: Preparation of Compound 1-60

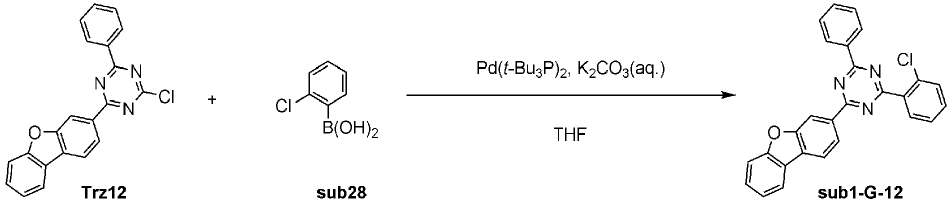

Compound Trz12 (15 g, 41.9 mmol) and Compound sub28 (6.6 g, 41.9 mmol) were added to 300 ml of THF under a nitrogen atmosphere, and the mixture was stirred and refluxed. Then, potassium carbonate (17.4 g, 125.8 mmol) was dissolved in 52 ml of water, added thereto, and the mixture was sufficiently stirred and then bis(tri-tert-butylphosphine)palladium(0) (0.2 g, 0.4 mmol) was added. After 10-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 11.1 g of Compound sub1-G-12. (Yield: 61%, MS: [M+H]⁺= 434)

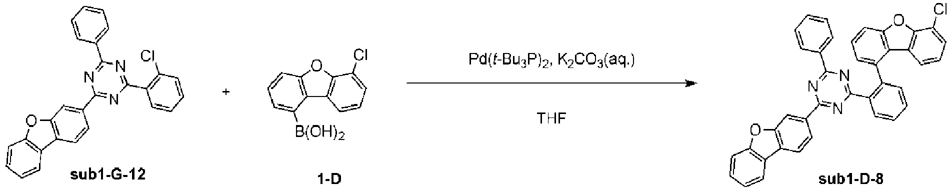

Compound sub1-G-12 (15 g, 34.6 mmol) and Compound 1-D (8.5 g, 34.6 mmol) were added to 300 ml of THF under a nitrogen atmosphere, and the mixture was stirred and refluxed. Then, potassium carbonate (14.3 g, 103.7 mmol) was dissolved in 43 ml of water, added thereto, and the mixture was sufficiently stirred and then bis(tri-tert-butylphosphine)palladium(0) (0.2 g, 0.3 mmol) was added. After 9-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 13.6 g of Compound sub1-D-8. (Yield: 79%, MS: [M+H]⁺= 500)

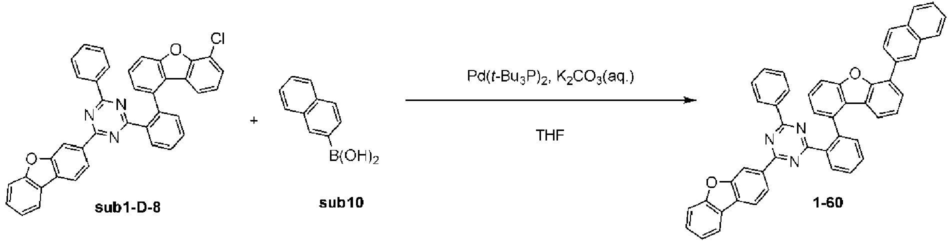

Compound sub1-D-8 (15 g, 25 mmol) and Compound sub10 (4.3 g, 25 mmol) were added to 300 ml of THF under a nitrogen atmosphere, and the mixture was stirred and refluxed. Then, potassium carbonate (10.4 g, 75 mmol) was dissolved in 31 ml of water, added thereto, and the mixture was sufficiently stirred and then bis(tri-tert-butylphosphine)palladium(0) (0.1 g, 0.2 mmol) was added. After 10-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 13.3 g of Compound 1-60. (Yield: 77%, MS: [M+H]⁺= 692)

### Preparation Example 2-1: Preparation of Compound 2-1

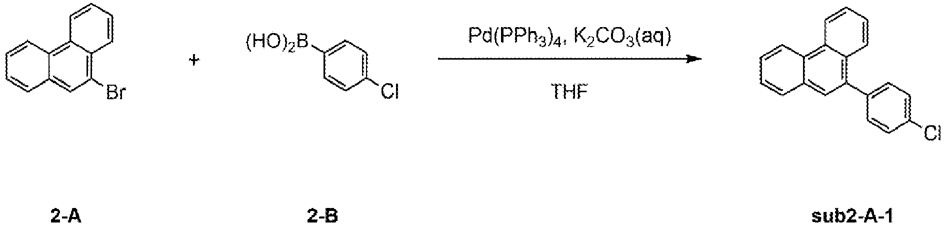

Compound 2-A (15 g, 58.3 mmol) and Compound 2-B (10 g, 64.2 mmol) were added to 300 ml of THF under a nitrogen atmosphere, and the mixture was stirred and refluxed. Then, potassium carbonate (16.1 g, 116.7 mmol) was dissolved in 48 ml of water, added thereto, and the mixture was sufficiently stirred and then tetrakis(triphenylphosphine)palladium(0)(1.3 g, 1.2 mmol) was added. After 11-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 12.6 g of Compound sub2-A-1. (Yield: 75%, MS: [M+H]⁺= 289)

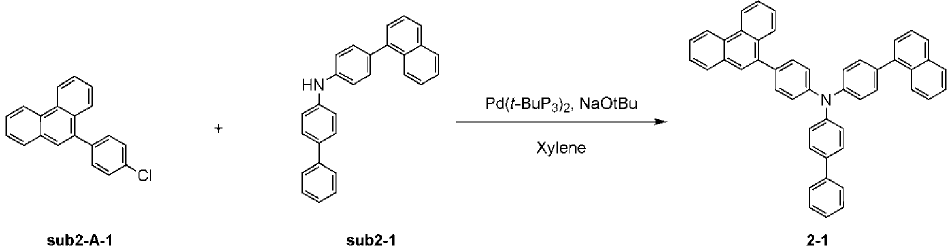

Compound sub2-A-1 (10 g, 34.6 mmol), Compound sub2-1 (12.9 g, 34.6 mmol) and sodium tert-butoxide(4.3 g, 45 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 12.7 g of Compound 2-1. (Yield: 59%, MS: [M+H]⁺= 624)

### Preparation Example 2-2: Preparation of Compound 2-2

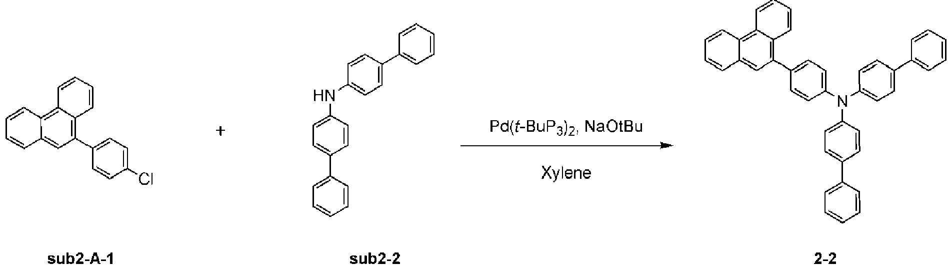

Compound sub2-A-1 (10 g, 34.6 mmol), Compound sub2-2 (11.1 g, 34.6 mmol) and sodium tert-butoxide (4.3 g, 45 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 10.1 g of Compound 2-2. (Yield: 51%, MS: [M+H]⁺= 574)

### Preparation Example 2-3: Preparation of Compound 2-3

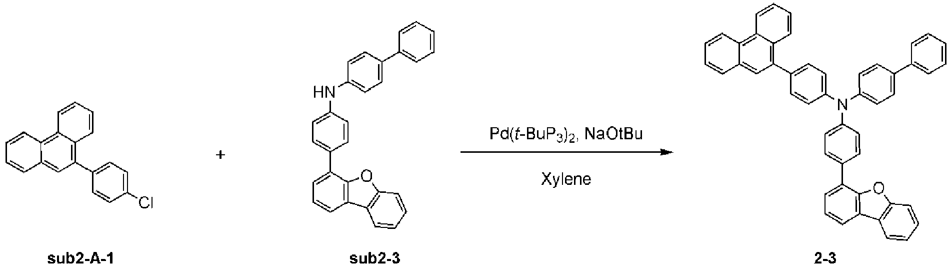

Compound sub2-A-1 (10 g, 34.6 mmol), Compound sub2-3 (14.3 g, 34.6 mmol) and sodium tert-butoxide (4.3 g, 45 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 12.2 g of Compound 2-3. (Yield: 53%, MS: [M+H]⁺= 664)

### Preparation Example 2-4: Preparation of Compound 2-4

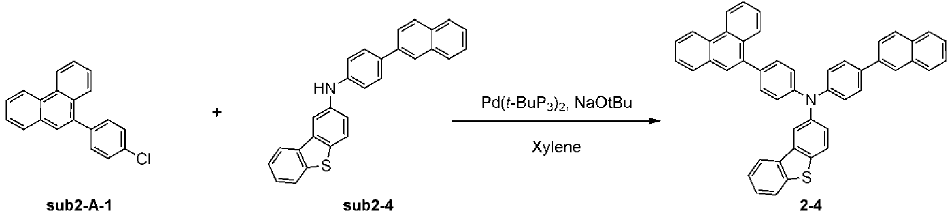

Compound sub2-A-1 (10 g, 34.6 mmol), Compound sub2-4 (13.9 g, 34.6 mmol) and sodium tert-butoxide (4.3 g, 45 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 14 g of Compound 2-4. (Yield: 62%, MS: [M+H]⁺= 654)

### Preparation Example 2-5: Preparation of Compound 2-5

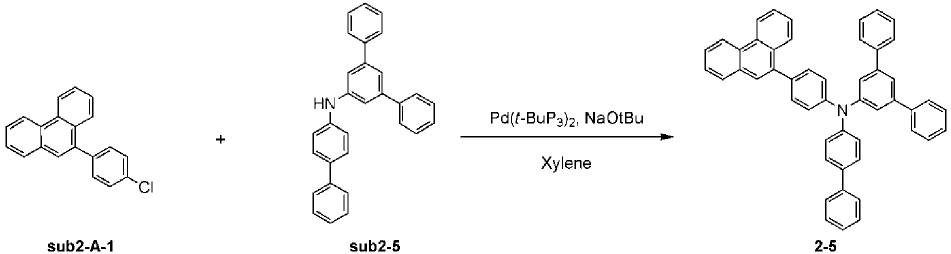

Compound sub2-A-1 (10 g, 34.6 mmol), Compound sub2-5 (13.8 g, 34.6 mmol) and sodium tert-butoxide (4.3 g, 45 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 11.2 g of Compound 2-5. (Yield: 50%, MS: [M+H]⁺= 650)

### Preparation Example 2-6: Preparation of Compound 2-6

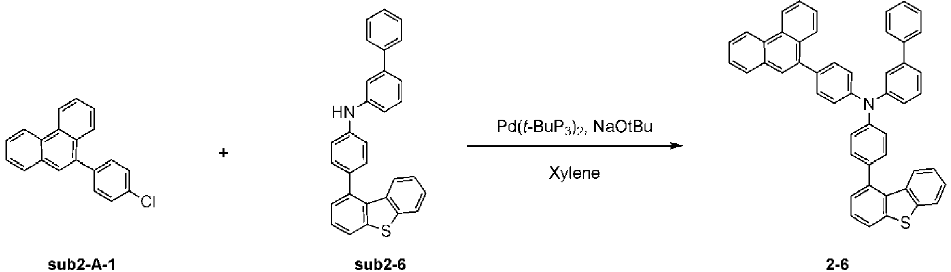

Compound sub2-A-1 (10 g, 34.6 mmol), Compound sub2-6 (14.8 g, 34.6 mmol) and sodium tert-butoxide (4.3 g, 45 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 12.2 g of Compound 2-6. (Yield: 52%, MS: [M+H]⁺= 680)

### Preparation Example 2-7: Preparation of Compound 2-7

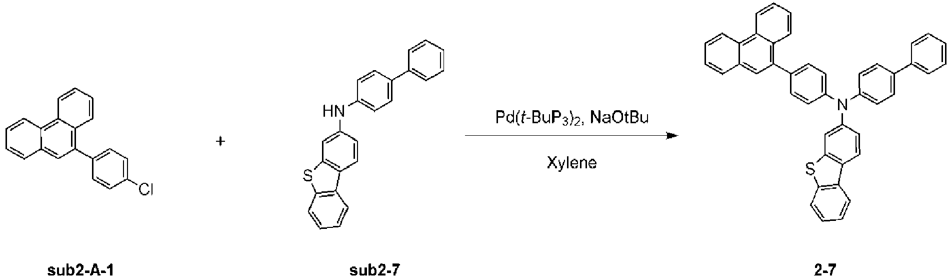

Compound sub2-A-1 (10 g, 34.6 mmol), Compound sub2-7 (12.2 g, 34.6 mmol) and sodium tert-butoxide (4.3 g, 45 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 1 g of Compound 2-7. (Yield: 50%, MS: [M+H]⁺= 61)

### Preparation Example 2-8: Preparation of Compound 2-8

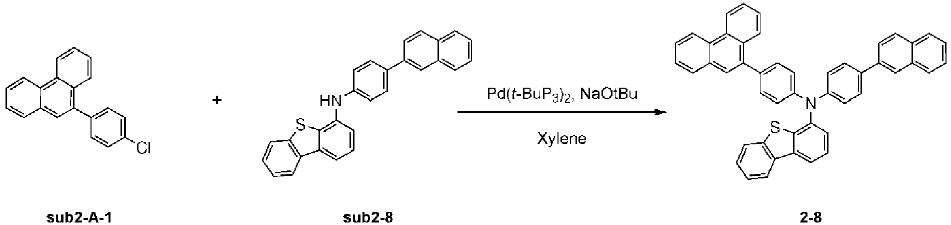

Compound sub2-A-1 (10 g, 34.6 mmol), Compound sub2-8 (13.9 g, 34.6 mmol) and sodium tert-butoxide (4.3 g, 45 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 13.3 g of Compound 2-8. (Yield: 59%, MS: [M+H]⁺= 654)

### Preparation Example 2-9: Preparation of Compound 2-9

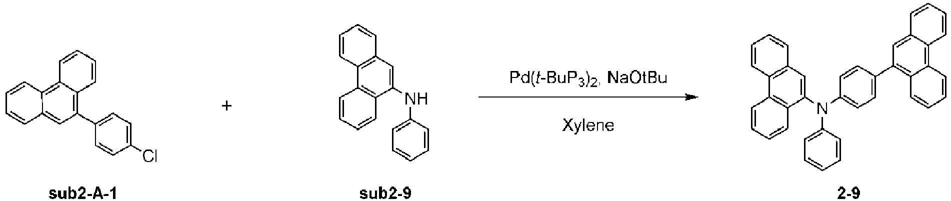

Compound sub2-A-1 (10 g, 34.6 mmol), Compound sub2-9 (9.3 g, 34.6 mmol) and sodium tert-butoxide (4.3 g, 45 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 11.2 g of Compound 2-9. (Yield: 62%, MS: [M+H]⁺= 522)

### Preparation Example 2-10: Preparation of Compound 2-10

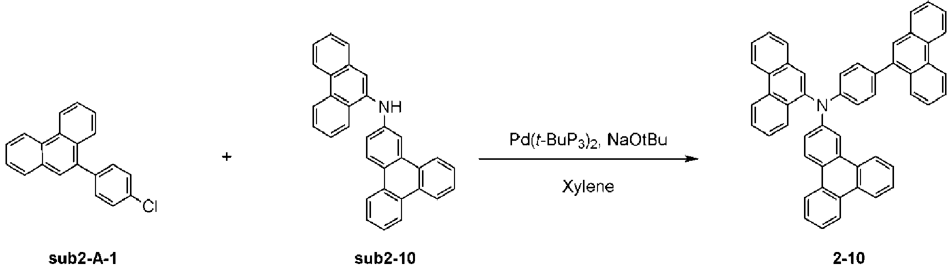

Compound sub2-A-1 (10 g, 34.6 mmol), Compound sub2-10 (14.5 g, 34.6 mmol) and sodium tert-butoxide (4.3 g, 45 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 14.4 g of Compound 2-10. (Yield: 62%, MS: [M+H]⁺= 572)

### Preparation Example 2-11: Preparation of Compound 2-11

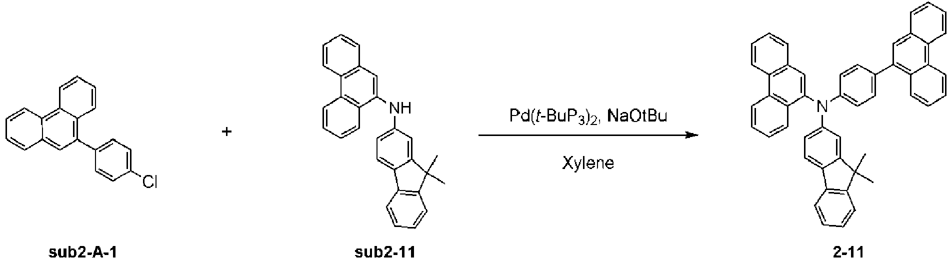

Compound sub2-A-1 (10 g, 34.6 mmol), Compound sub2-11 (13.4 g, 34.6 mmol) and sodium tert-butoxide (4.3 g, 45 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 12.4 g of Compound 2-11. (Yield: 56%, MS: [M+H]⁺= 638)

### Preparation Example 2-12: Preparation of Compound 2-12

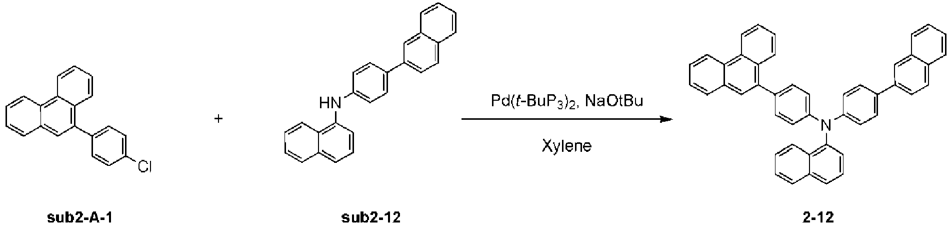

Compound sub2-A-1 (10 g, 34.6 mmol), Compound sub2-12 (12 g, 34.6 mmol) and sodium tert-butoxide (4.3 g, 45 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 11 g of Compound 2-12. (Yield: 53%, MS: [M+H]⁺= 598)

### Preparation Example 2-13: Preparation of Compound 2-13

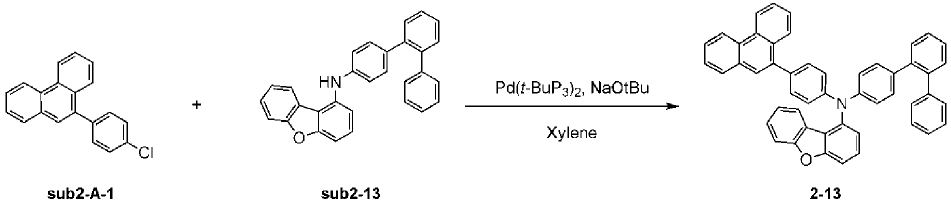

Compound sub2-A-1 (10 g, 34.6 mmol), Compound sub2-13 (14.3 g, 34.6 mmol) and sodium tert-butoxide (4.3 g, 45 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 15.6 g of Compound 2-13. (Yield: 68%, MS: [M+H]⁺= 664)

### Preparation Example 2-14: Preparation of Compound 2-14

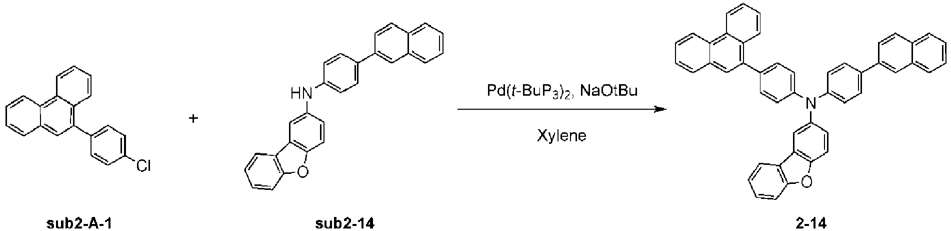

Compound sub2-A-1 (10 g, 34.6 mmol), Compound sub2-14 (13.3 g, 34.6 mmol) and sodium tert-butoxide (4.3 g, 45 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 13.2 g of Compound 2-14. (Yield: 60%, MS: [M+H]⁺= 638)

### Preparation Example 2-15: Preparation of Compound 2-15

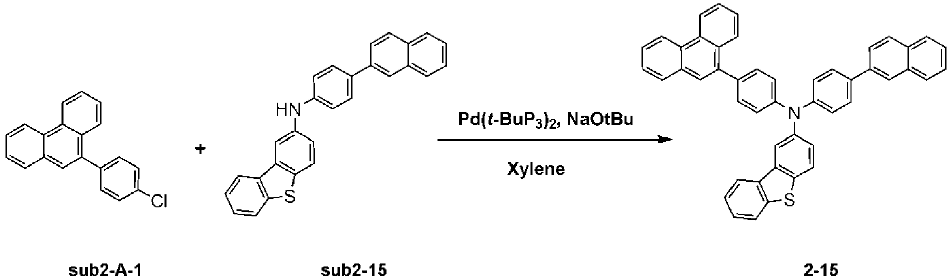

Compound sub2-A-1 (10 g, 34.6 mmol), Compound sub2-15 (13.9 g, 34.6 mmol) and sodium tert-butoxide (3.7 g, 38.1 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 12 g of Compound 2-15. (Yield: 53%, MS: [M+H]⁺= 654)

### Preparation Example 2-16: Preparation of Compound 2-16

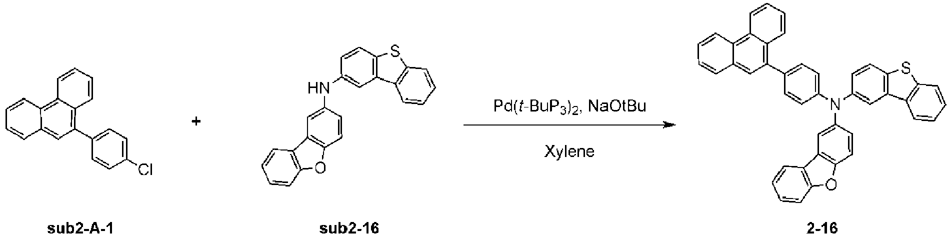

Compound sub2-A-1 (10 g, 34.6 mmol), Compound sub2-16 (12.7 g, 34.6 mmol) and sodium tert-butoxide (4.3 g, 45 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 13.7 g of Compound 2-16. (Yield: 64%, MS: [M+H]⁺= 618)

### Preparation Example 2-17: Preparation of Compound 2-17

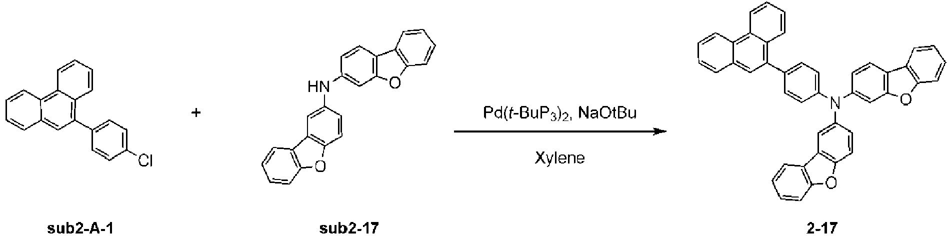

Compound sub2-A-1 (10 g, 34.6 mmol), Compound sub2-17 (12.1 g, 34.6 mmol) and sodium tert-butoxide (4.3 g, 45 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 11.5 g of Compound 2-17. (Yield: 55%, MS: [M+H]⁺= 602)

### Preparation Example 2-18: Preparation of Compound 2-18

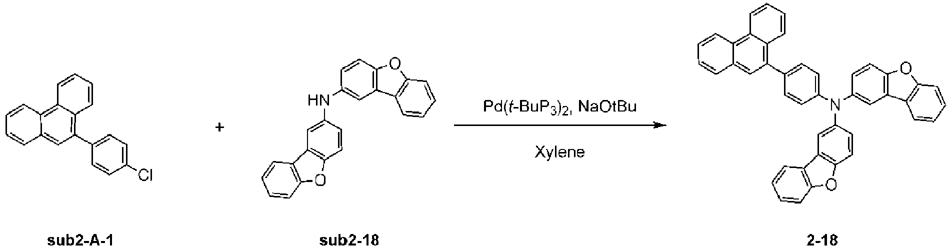

Compound sub2-A-1 (10 g, 34.6 mmol), Compound sub2-18 (12.1 g, 34.6 mmol) and sodium tert-butoxide (4.3 g, 45 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 14.4 g of Compound 2-18. (Yield: 69%, MS: [M+H]⁺= 602)

### Preparation Example 2-19: Preparation of Compound 2-19

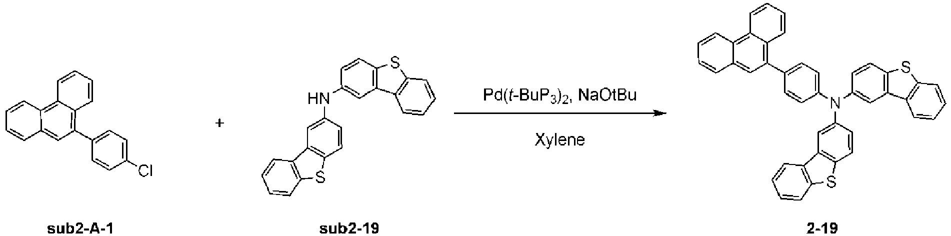

Compound sub2-A-1 (10 g, 34.6 mmol), Compound sub2-19 (13.2 g, 34.6 mmol) and sodium tert-butoxide (4.3 g, 45 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 11.4 g of Compound 2-19. (Yield: 52%, MS: [M+H]⁺= 634)

### Preparation Example 2-20: Preparation of Compound 2-20

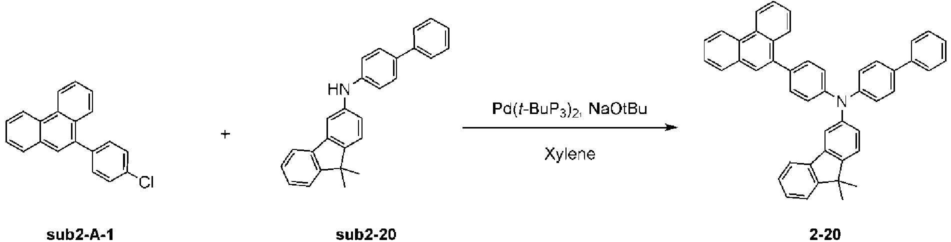

Compound sub2-A-1 (10 g, 34.6 mmol), Compound sub2-20 (12.5 g, 34.6 mmol) and sodium tert-butoxide (4.3 g, 45 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 13.2 g of Compound 2-20. (Yield: 62%, MS: [M+H]⁺= 614)

### Preparation Example 2-21: Preparation of Compound 2-21

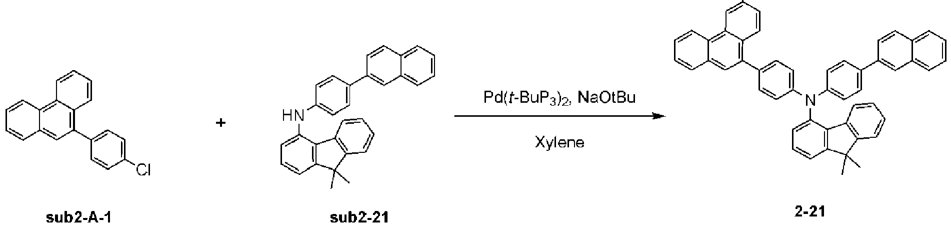

Compound sub2-A-1 (10 g, 34.6 mmol), Compound sub2-21 (14.3 g, 34.6 mmol) and sodium tert-butoxide (4.3 g, 45 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 14.2 g of Compound 2-21. (Yield: 62%, MS: [M+H]⁺= 664)

### Preparation Example 2-22: Preparation of Compound 2-22

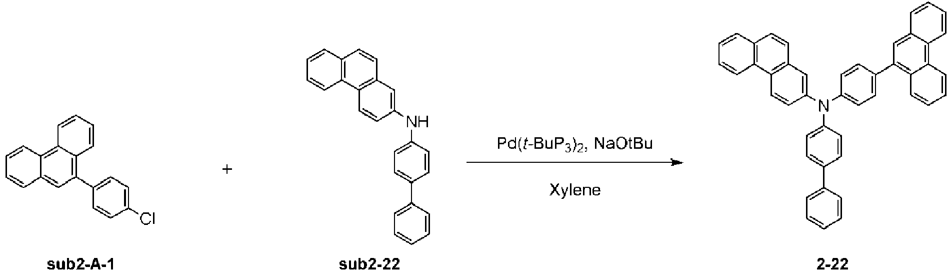

Compound sub2-A-1 (10 g, 34.6 mmol), Compound sub2-22 (12 g, 34.6 mmol) and sodium tert-butoxide (4.3 g, 45 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 11.2 g of Compound 2-22. (Yield: 54%, MS: [M+H]⁺= 598)

### Preparation Example 2-23: Preparation of Compound 2-23

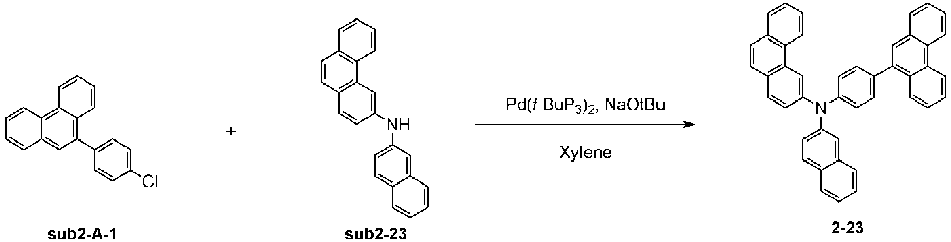

Compound sub2-A-1 (10 g, 34.6 mmol), Compound sub2-23 (11.1 g, 34.6 mmol) and sodium tert-butoxide (4.3 g, 45 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 11.9 g of Compound 2-23. (Yield: 60%, MS: [M+H]⁺= 572)

### Preparation Example 2-24: Preparation of Compound 2-24

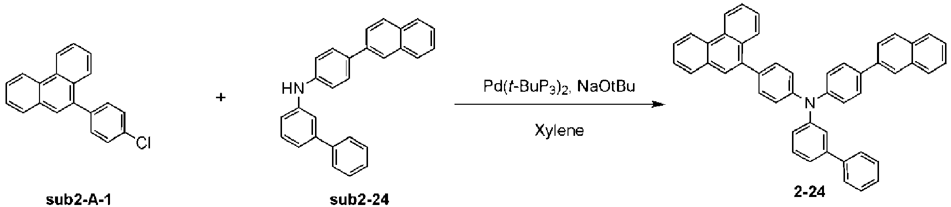

Compound sub2-A-1 (10 g, 34.6 mmol), Compound sub2-24 (12.9 g, 34.6 mmol) and sodium tert-butoxide (4.3 g, 45 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 13.6 g of Compound 2-24. (Yield: 63%, MS: [M+H]⁺= 624)

### Preparation Example 2-25: Preparation of Compound 2-25

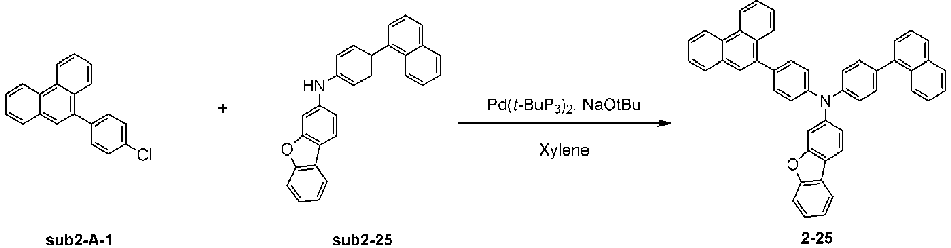

Compound sub2-A-1 (10 g, 34.6 mmol), Compound sub2-25 (13.3 g, 34.6 mmol) and sodium tert-butoxide (4.3 g, 45 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 14.3 g of Compound 2-25. (Yield: 65%, MS: [M+H]⁺= 638)

### Preparation Example 2-26: Preparation of Compound 2-26

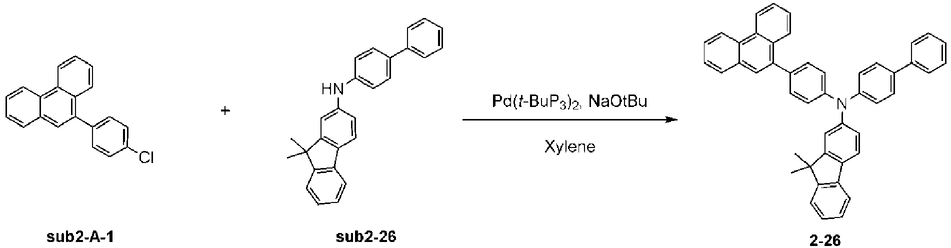

Compound sub2-A-1 (10 g, 34.6 mmol), Compound sub2-26 (12.5 g, 34.6 mmol) and sodium tert-butoxide (4.3 g, 45 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 10.8 g of Compound 2-26. (Yield: 51%, MS: [M+H]⁺= 614)

### Preparation Example 2-27: Preparation of Compound 2-27

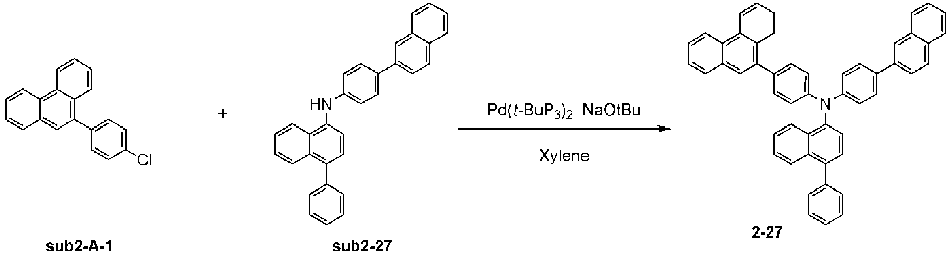

Compound sub2-A-1 (10 g, 34.6 mmol), Compound sub2-27(14.6 g, 34.6 mmol) and sodium tert-butoxide (4.3 g, 45 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 16.1 g of Compound 2-27. (Yield: 69%, MS: [M+H]⁺= 674)

### Preparation Example 2-28: Preparation of Compound 2-28

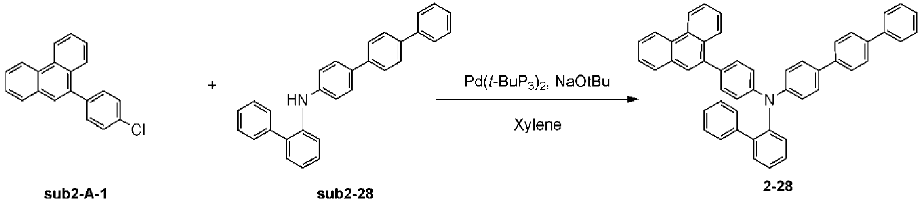

Compound sub2-A-1 (10 g, 34.6 mmol), Compound sub2-28 (13.8 g, 34.6 mmol) and sodium tert-butoxide (4.3 g, 45 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 11.2 g of Compound 2-28. (Yield: 50%, MS: [M+H]⁺= 650)

### Preparation Example 2-29: Preparation of Compound 2-29

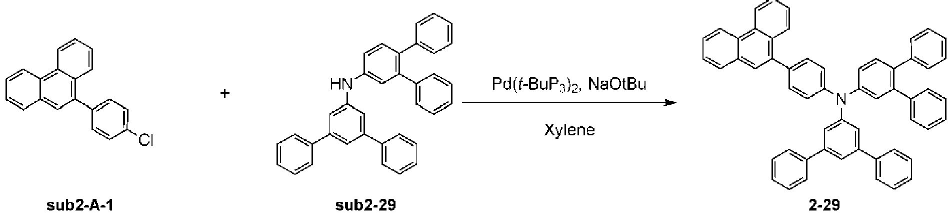

Compound sub2-A-1 (10 g, 34.6 mmol), Compound sub2-29 (16.4 g, 34.6 mmol) and sodium tert-butoxide (4.3 g, 45 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 17.1 g of Compound 2-29. (Yield: 68%, MS: [M+H]⁺= 726)

### Preparation Example 2-30: Preparation of Compound 2-30

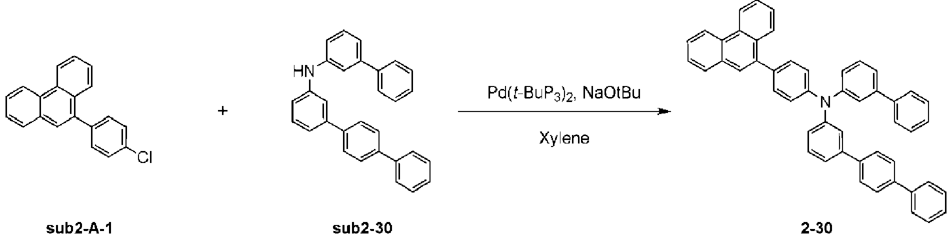

Compound sub2-A-1 (10 g, 34.6 mmol), Compound sub2-30 (13.8 g, 34.6 mmol) and sodium tert-butoxide (4.3 g, 45 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 14.4 g of Compound 2-30. (Yield: 64%, MS: [M+H]⁺= 650)

### Preparation Example 2-31: Preparation of Compound 2-31

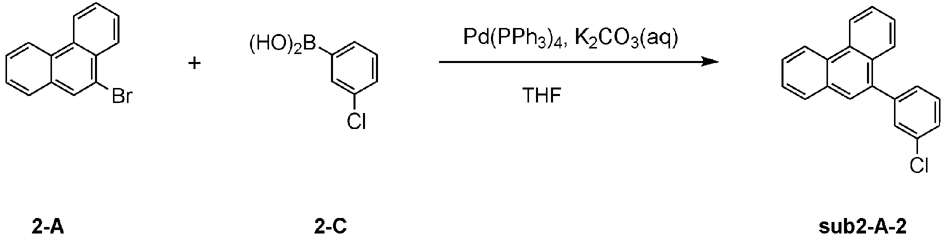

Compound 2-A (15 g, 58.3 mmol) and Compound 2-C (10 g, 64.2 mmol) were added to 300 ml of THF under a nitrogen atmosphere, and the mixture was stirred and refluxed. Then, potassium carbonate (16.1 g, 116.7 mmol) was dissolved in 48 ml of water, added thereto, and the mixture was sufficiently stirred and then tetrakis(triphenylphosphine)palladium(0) (1.3 g, 1.2 mmol) was added. After 10-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 10.6 g of Compound sub2-A-2. (Yield: 63%, MS: [M+H]⁺= 289)

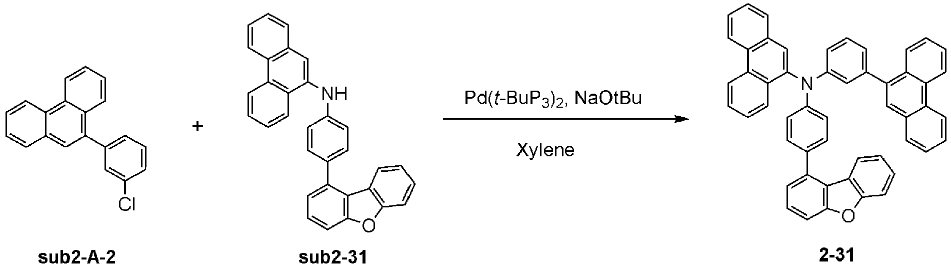

Compound sub2-A-2 (10 g, 34.6 mmol), Compound sub2-31 (15.1 g, 34.6 mmol) and sodium tert-butoxide (4.3 g, 45 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 16.7 g of Compound 2-31. (Yield: 70%, MS: [M+H]⁺= 688)

### Preparation Example 2-32: Preparation of Compound 2-32

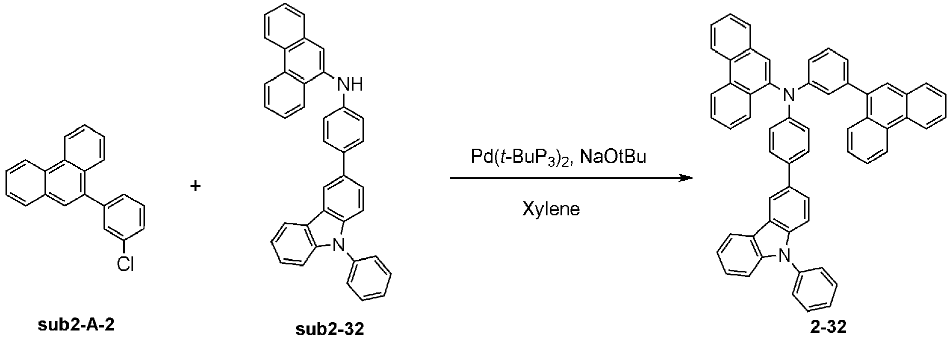

Compound sub2-A-2 (10 g, 34.6 mmol), Compound sub2-32 (17.7 g, 34.6 mmol) and sodium tert-butoxide (4.3 g, 45 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 16.6 g of Compound 2-32. (Yield: 63%, MS: [M+H]⁺= 763)

### Preparation Example 2-33: Preparation of Compound 2-33

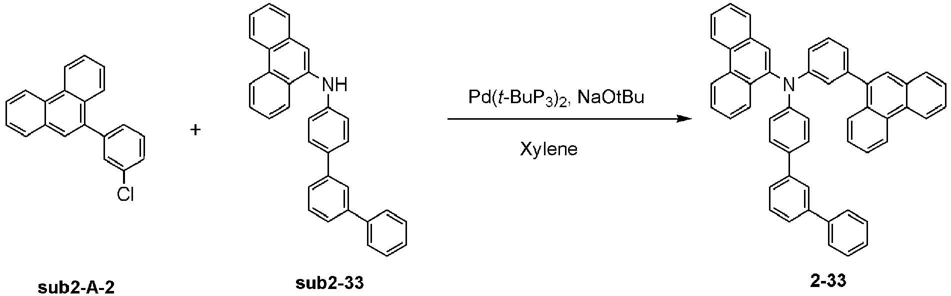

Compound sub2-A-2 (10 g, 34.6 mmol), Compound sub2-33 (14.6 g, 34.6 mmol) and sodium tert-butoxide (4.3 g, 45 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 12.6 g of Compound 2-33. (Yield: 54%, MS: [M+H]⁺= 674)

### Preparation Example 2-34: Preparation of Compound 2-34

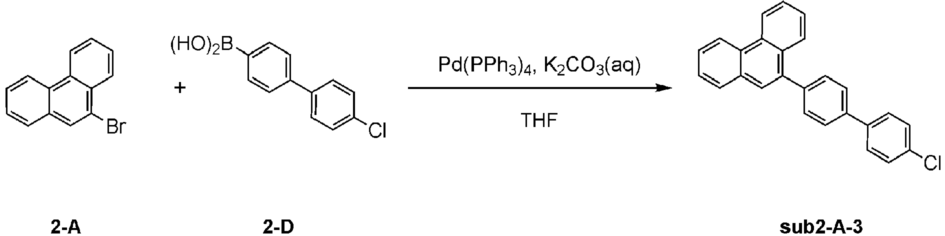

Compound 2-A (15 g, 58.3 mmol) and Compound 2-D (14.9 g, 64.2 mmol) were added to 300 ml of THF under a nitrogen atmosphere, and the mixture was stirred and refluxed. Then, potassium carbonate (16.1 g, 116.7 mmol) was dissolved in 48 ml of water, added thereto, and the mixture was sufficiently stirred and then tetrakis(triphenylphosphine)palladium(0) (1.3 g, 1.2 mmol) was added. After 10-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 16.8 g of Compound sub2-A-3. (Yield: 79%, MS: [M+H]⁺= 365)

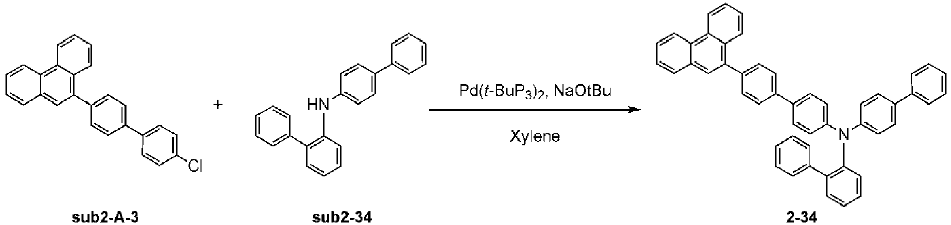

Compound sub2-A-3 (10 g, 27.4 mmol), Compound sub2-34 (8.8 g, 27.4 mmol) and sodium tert-butoxide (3.4 g, 35.7 mmol) were added to 200 ml of xylene under a nitrogen atmosphere, and the mixture was stirred and refluxed. Then, bis(tri-tert-butylphosphine)palladium(0) (0.1 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 11.2 g of Compound 2-34. (Yield: 63%, MS: [M+H]⁺= 650)

### Preparation Example 2-35: Preparation of Compound 2-35

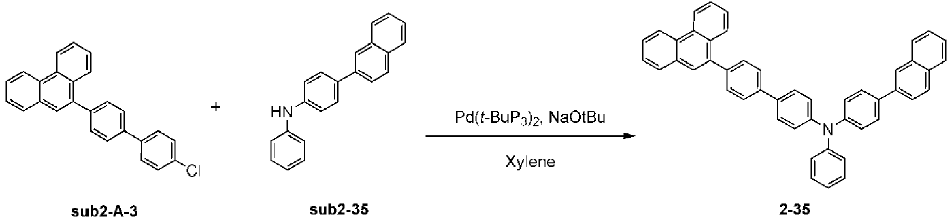

Compound sub2-A-3 (10 g, 27.4 mmol), Compound sub2-35 (8.1 g, 27.4 mmol) and sodium tert-butoxide (3.4 g, 35.7 mmol) were added to 200 ml of xylene under a nitrogen atmosphere, and the mixture was stirred and refluxed. Then, bis(tri-tert-butylphosphine)palladium(0) (0.1 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 8.7 g of Compound 2-35. (Yield: 51%, MS: [M+H]⁺= 624)

### Preparation Example 2-36: Preparation of Compound 2-36

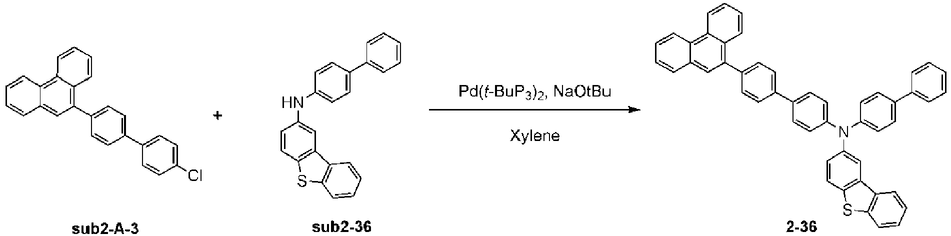

Compound sub2-A-3 (10 g, 27.4 mmol), Compound sub2-36 (9.6 g, 27.4 mmol) and sodium tert-butoxide (3.4 g, 35.6 mmol) were added to 200 ml of xylene under a nitrogen atmosphere, and the mixture was stirred and refluxed. Then, bis(tri-tert-butylphosphine)palladium(0) (0.1 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 12.1 g of Compound 2-36. (Yield: 65%, MS: [M+H]⁺= 680)

### Preparation Example 2-37: Preparation of Compound 2-37

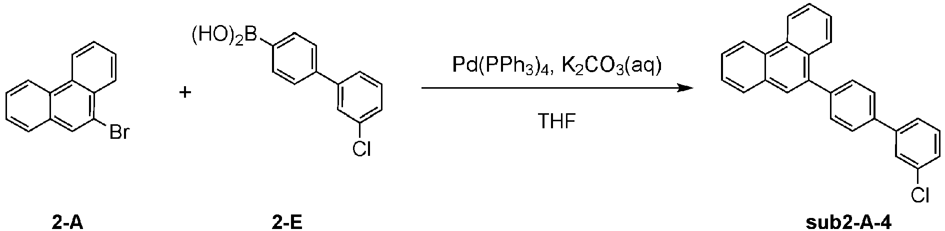

Compound 2-A (15 g, 58.3 mmol) and Compound 2-E (14.9 g, 64.2 mmol) were added to 300 ml of THF under a nitrogen atmosphere, and the mixture was stirred and refluxed. Then, potassium carbonate (16.1 g, 116.7 mmol) was dissolved in 48 ml of water, added thereto, and the mixture was sufficiently stirred and then tetrakis(triphenylphosphine)palladium(0) (1.3 g, 1.2 mmol) was added. After 11-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 14.2 g of Compound sub2-A-4. (Yield: 67%, MS: [M+H]⁺= 365)

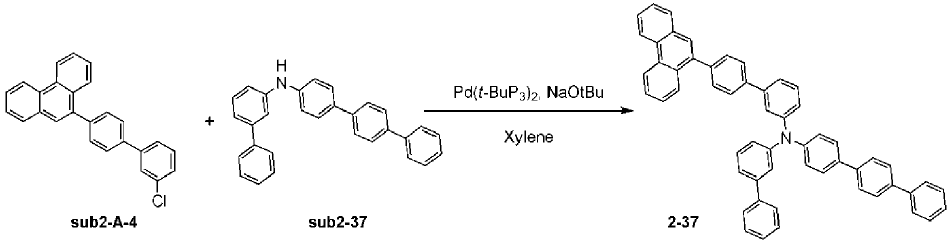

Compound sub2-A-4 (10 g, 27.4 mmol), Compound sub2-37 (10.9 g, 27.4 mmol) and sodium tert-butoxide (3.4 g, 35.6 mmol) were added to 200 ml of xylene under a nitrogen atmosphere, and the mixture was stirred and refluxed. Then, bis(tri-tert-butylphosphine)palladium(0) (0.1 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 13.9 g of Compound 2-37. (Yield: 70%, MS: [M+H]⁺= 726)

### Preparation Example 2-38: Preparation of Compound 2-38

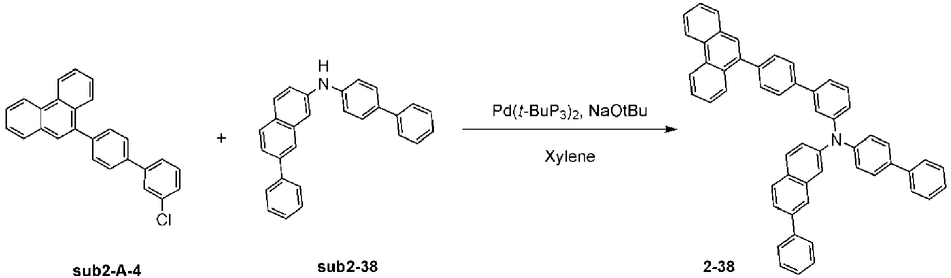

Compound sub2-A-4 (10 g, 27.4 mmol), Compound sub2-38 (10.2 g, 27.4 mmol) and sodium tert-butoxide (3.4 g, 35.6 mmol) were added to 200 ml of xylene under a nitrogen atmosphere, and the mixture was stirred and refluxed. Then, bis(tri-tert-butylphosphine)palladium(0) (0.1 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 10.7 g of Compound 2-38. (Yield: 56%, MS: [M+H]⁺= 700)

### Preparation Example 2-39: Preparation of Compound 2-39

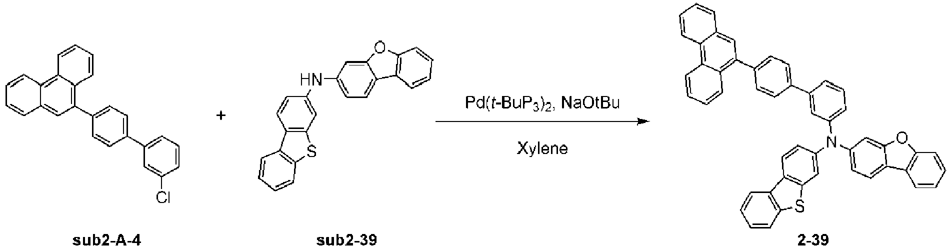

Compound sub2-A-4 (10 g, 27.4 mmol), Compound sub2-39 (10 g, 27.4 mmol) and sodium tert-butoxide (3.4 g, 35.6 mmol) were added to 200 ml of xylene under a nitrogen atmosphere, and the mixture was stirred and refluxed. Then, bis(tri-tert-butylphosphine)palladium(0) (0.1 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 11.8 g of Compound 2-39. (Yield: 62%, MS: [M+H]⁺= 694)

### Preparation Example 2-40: Preparation of Compound 2-40

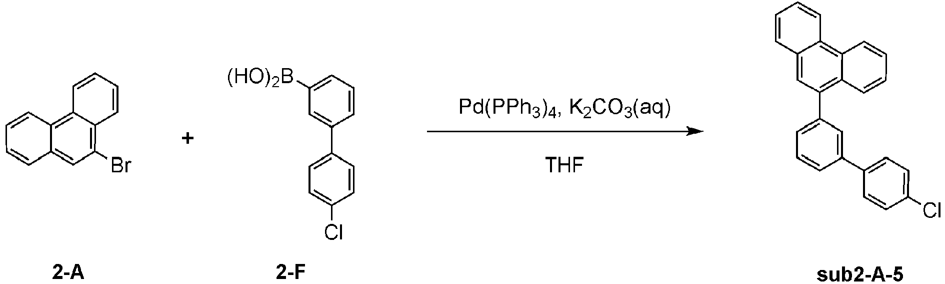

Compound 2-A (15 g, 58.3 mmol) and Compound 2-F (14.9 g, 64.2 mmol) were added to 300 ml of THF under a nitrogen atmosphere, and the mixture was stirred and refluxed. Then, potassium carbonate (16.1 g, 116.7 mmol) was dissolved in 48 ml of water, added thereto, and the mixture was sufficiently stirred and then tetrakis(triphenylphosphine)palladium(0) (1.3 g, 1.2 mmol) was added. After 8-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 14.4 g of Compound sub2-A-5. (Yield: 68%, MS: [M+H]⁺= 365)

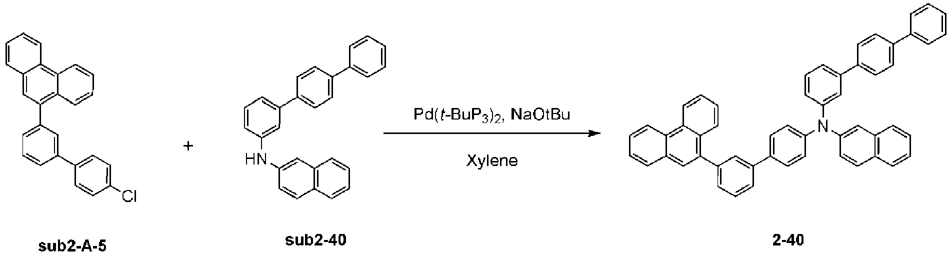

Compound sub2-A-5 (10 g, 27.4 mmol), Compound sub2-40 (10.2 g, 27.4 mmol) and sodium tert-butoxide (3.4 g, 35.6 mmol) were added to 200 ml of xylene under a nitrogen atmosphere, and the mixture was stirred and refluxed. Then, bis(tri-tert-butylphosphine)palladium(0) (0.1 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 10.7 g of Compound 2-40. (Yield: 56%, MS: [M+H]⁺= 700)

### Preparation Example 2-41: Preparation of Compound 2-41

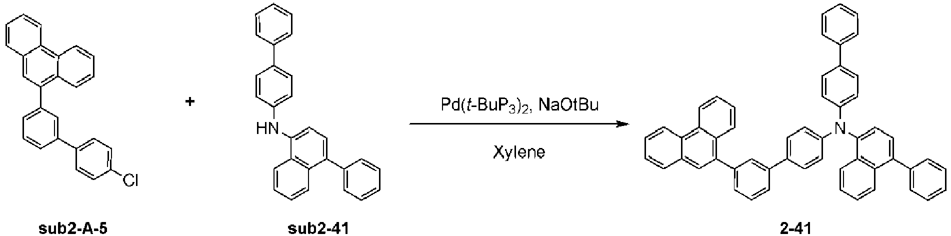

Compound sub2-A-5 (10 g, 27.4 mmol), Compound sub2-41 (10.2 g, 27.4 mmol) and sodium tert-butoxide (3.4 g, 35.6 mmol) were added to 200 ml of xylene under a nitrogen atmosphere, and the mixture was stirred and refluxed. Then, bis(tri-tert-butylphosphine)palladium(0) (0.1 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 9.8 g of Compound 2-41. (Yield: 51%, MS: [M+H]⁺= 700)

### Preparation Example 2-42: Preparation of Compound 2-42

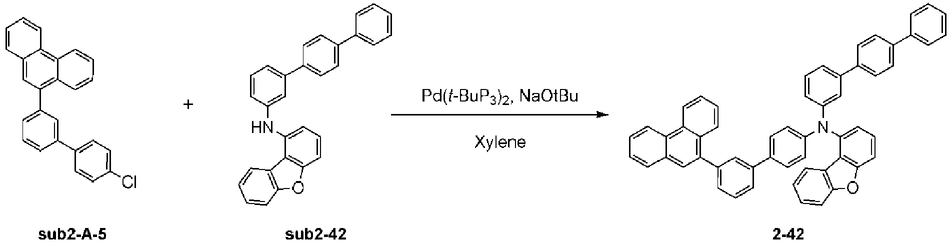

Compound sub2-A-5 (10 g, 27.4 mmol), Compound sub2-42 (11.3 g, 27.4 mmol) and sodium tert-butoxide (3.4 g, 35.6 mmol) were added to 200 ml of xylene under a nitrogen atmosphere, and the mixture was stirred and refluxed. Then, bis(tri-tert-butylphosphine)palladium(0) (0.1 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 11.5 g of Compound 2-42. (Yield: 57%, MS: [M+H]⁺= 740)

### Preparation Example 2-43: Preparation of Compound 2-43

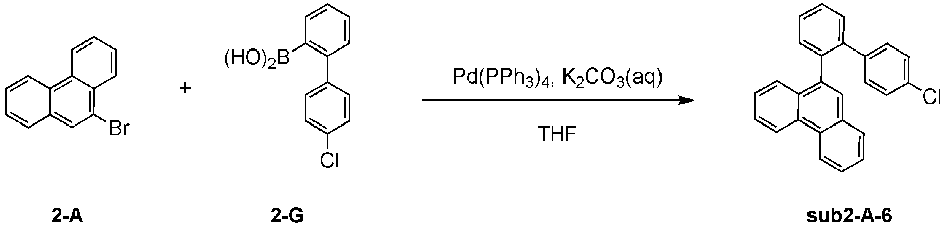

Compound 2-A (15 g, 58.3 mmol) and Compound 2-G (14.9 g, 64.2 mmol) were added to 300 ml of THF under a nitrogen atmosphere, and the mixture was stirred and refluxed. Then, potassium carbonate (16.1 g, 116.7 mmol) was dissolved in 48 ml of water, added thereto, and the mixture was sufficiently stirred and then tetrakis(triphenylphosphine)palladium(0) (1.3 g, 1.2 mmol) was added. After 9-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 14.7 g of Compound sub2-A-6. (Yield: 69%, MS: [M+H]⁺= 365)

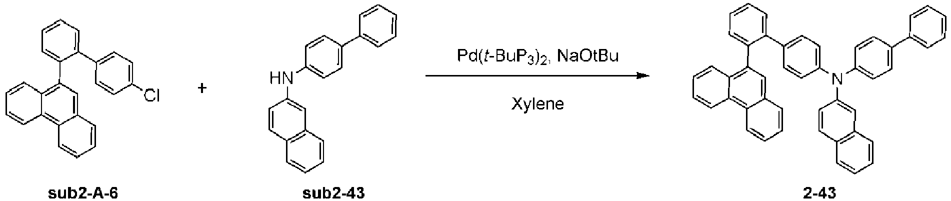

Compound sub2-A-6 (10 g, 27.4 mmol), Compound sub2-43 (8.1 g, 27.4 mmol) and sodium tert-butoxide (3.4 g, 35.6 mmol) were added to 200 ml of xylene under a nitrogen atmosphere, and the mixture was stirred and refluxed. Then, bis(tri-tert-butylphosphine)palladium(0) (0.1 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 9.7 g of Compound 2-43. (Yield: 57%, MS: [M+H]⁺= 624)

### Preparation Example 2-44: Preparation of Compound 2-44

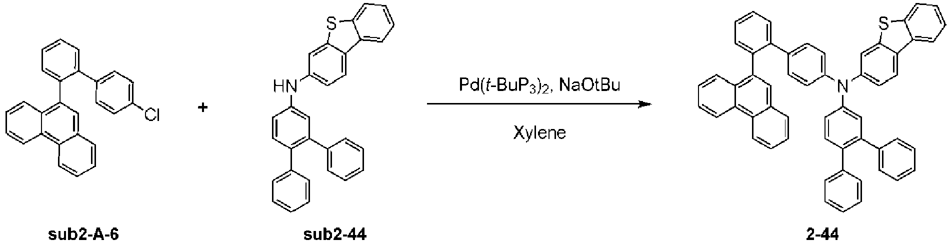

Compound sub2-A-6 (10 g, 27.4 mmol), Compound sub2-44 (11.7 g, 27.4 mmol) and sodium tert-butoxide (3.4 g, 35.6 mmol) were added to 200 ml of xylene under a nitrogen atmosphere, and the mixture was stirred and refluxed. Then, bis(tri-tert-butylphosphine)palladium(0) (0.1 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 12 g of Compound 2-44. (Yield: 58%, MS: [M+H]⁺= 756)

### Preparation Example 2-45: Preparation of Compound 2-45

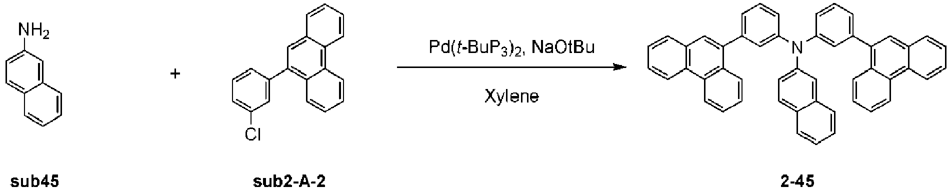

Compound sub45 (10 g, 70.3 mmol), Compound sub2-A-2 (42.6 g, 147.7 mmol) and sodium tert-butoxide (16.9 g, 175.8 mmol) were added to 200 ml of xylene under a nitrogen atmosphere, and the mixture was stirred and refluxed. Then, bis(tri-tert-butylphosphine)palladium(0) (0.7 g, 1.4 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 31 g of Compound 2-45. (Yield: 68%, MS: [M+H]⁺= 648)

### Preparation Example 2-46: Preparation of Compound 2-46

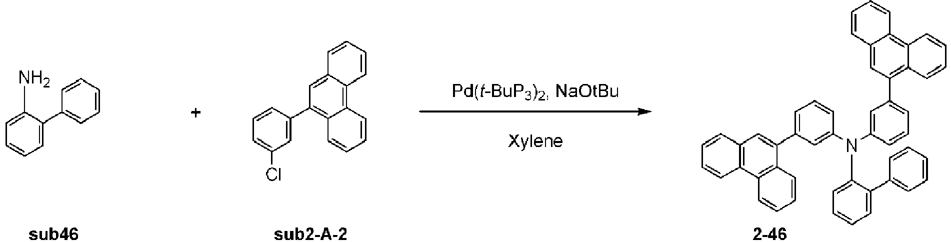

Compound sub46 (10 g, 59.1 mmol), Compound sub2-A-2 (35.8 g, 124.1 mmol) and sodium tert-butoxide (14.2 g, 147.7 mmol) were added to 200 ml of xylene under a nitrogen atmosphere, and the mixture was stirred and refluxed. Then, bis(tri-tert-butylphosphine)palladium(0) (0.6 g, 1.2 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 26.7 g of Compound 2-46. (Yield: 67%, MS: [M+H]⁺= 674)

### Preparation Example 2-47: Preparation of Compound 2-47

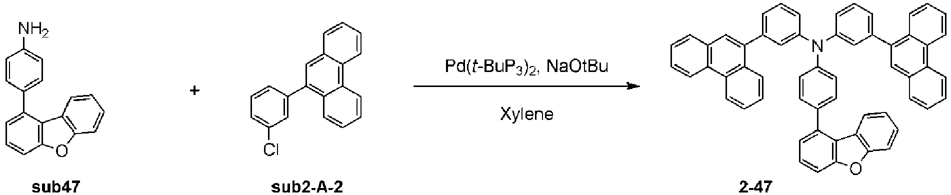

Compound sub47 (10 g, 38.6 mmol), Compound sub2-A-2 (23.4 g, 81 mmol) and sodium tert-butoxide (9.3 g, 96.4 mmol) were added to 200 ml of xylene under a nitrogen atmosphere, and the mixture was stirred and refluxed. Then, bis(tri-tert-butylphosphine)palladium(0) (0.4 g, 0.8 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 15 g of Compound 2-47. (Yield: 51%, MS: [M+H]⁺= 764)

### Preparation Example 2-48: Preparation of Compound 2-48

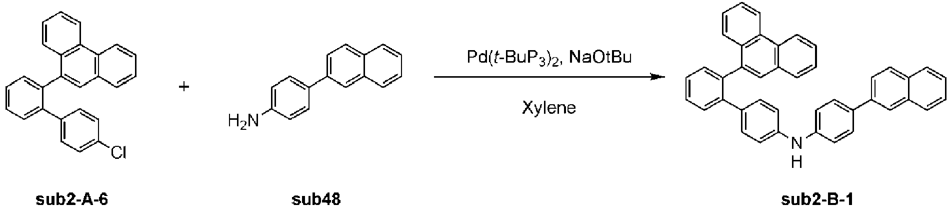

Compound sub1-A-6 (10 g, 27.4 mmol), Compound sub48 (6 g, 27.4 mmol) and sodium tert-butoxide (2.9 g, 30.1 mmol) were added to 200 ml of xylene under a nitrogen atmosphere, and the mixture was stirred and refluxed. Then, bis(tri-tert-butylphosphine)palladium(0) (0.1 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 9 g of Compound sub2-B-1. (Yield: 60%, MS: [M+H]⁺= 548)

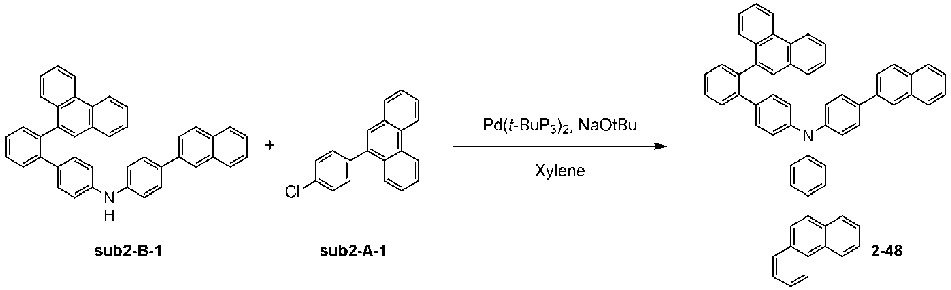

Compound sub2-B-1 (10 g, 18.3 mmol), Compound sub2-A-1 (5.3 g, 18.3 mmol) and sodium tert-butoxide (2.3 g, 23.1 mmol) were added to 200 ml of xylene under a nitrogen atmosphere, and the mixture was stirred and refluxed. Then, bis(tri-tert-butylphosphine)palladium(0) (0.1 g, 0.2 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 7.7 g of Compound 2-48. (Yield: 53%, MS: [M+H]⁺= 800)

### Preparation Example 2-49: Preparation of Compound 2-49

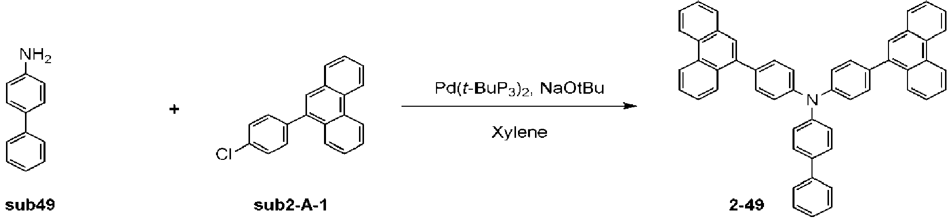

Compound sub49 (10 g, 59.1 mmol), Compound sub2-A-1 (35.8 g, 124.1 mmol) and sodium tert-butoxide (14.2 g, 147.7 mmol) were added to 200 ml of xylene under a nitrogen atmosphere, and the mixture was stirred and refluxed. Then, bis(tri-tert-butylphosphine)palladium(0) (0.6 g, 1.2 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 22.7 g of Compound 2-49. (Yield: 57%, MS: [M+H]⁺= 674)

### Preparation Example 2-50: Preparation of Compound 2-50

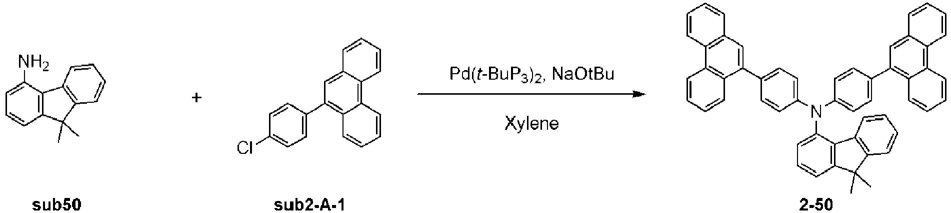

Compound sub50 (10 g, 47.8 mmol), Compound sub2-A-1 (29 g, 100.3 mmol) and sodium tert-butoxide (11.5 g, 119.5 mmol) were added to 200 ml of xylene under a nitrogen atmosphere, and the mixture was stirred and refluxed. Then, bis(tri-tert-butylphosphine)palladium(0) (0.5 g, 1 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 23.9 g of Compound 2-50. (Yield: 70%, MS: [M+H]⁺= 714)

### Preparation Example 2-51: Preparation of Compound 2-51

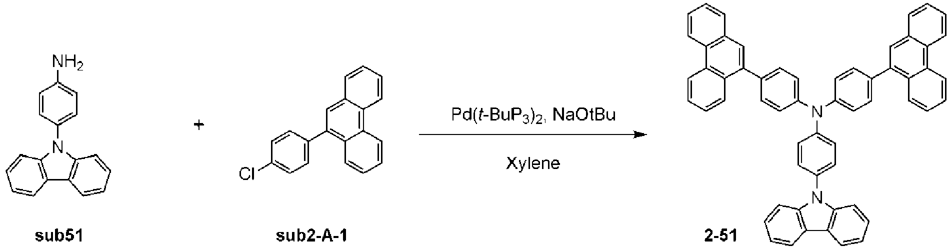

Compound sub51 (10 g, 38.7 mmol), Compound sub2-A-1 (23.5 g, 81.3 mmol) and sodium tert-butoxide (9.3 g, 96.8 mmol) were added to 200 ml of xylene under a nitrogen atmosphere, and the mixture was stirred and refluxed. Then, bis(tri-tert-butylphosphine)palladium(0) (0.4 g, 0.8 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 16.8 g of Compound 2-51. (Yield: 57%, MS: [M+H]⁺= 763)

### Preparation Example 2-52: Preparation of Compound 2-52

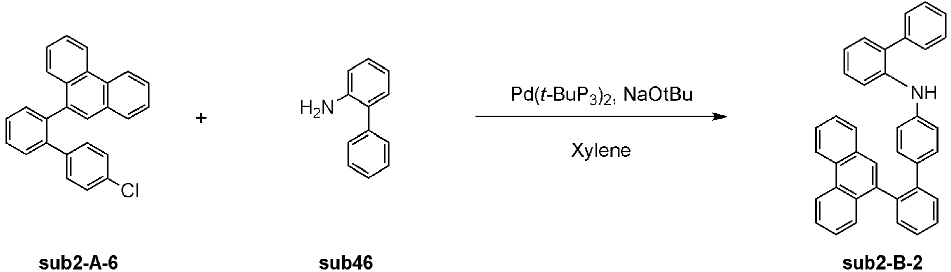

Compound sub2-A-6 (10 g, 27.4 mmol), Compound sub46 (4.6 g, 27.4 mmol) and sodium tert-butoxide (2.9 g, 30.1 mmol) were added to 200 ml of xylene under a nitrogen atmosphere, and the mixture was stirred and refluxed. Then, bis(tri-tert-butylphosphine)palladium(0) (0.1 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 9.4 g of Compound sub2-B-2. (Yield: 69%, MS: [M+H]⁺= 498)

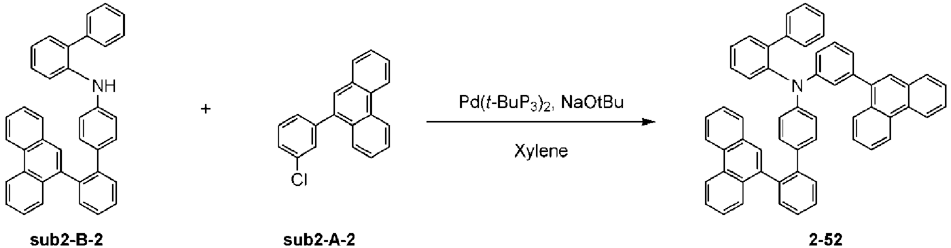

Compound sub2-B-2 (10 g, 20.1 mmol), Compound sub2-A-2 (5.8 g, 20.1 mmol) and sodium tert-butoxide (2.5 g, 26.1 mmol) were added to 200 ml of xylene under a nitrogen atmosphere, and the mixture was stirred and refluxed. Then, bis(tri-tert-butylphosphine)palladium(0) (0.1 g, 0.2 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 8.3 g of Compound 2-52. (Yield: 55%, MS: [M+H]⁺= 750)

### Preparation Example 2-53: Preparation of Compound 2-53

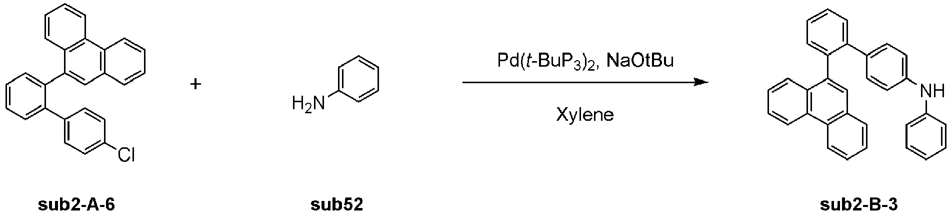

Compound sub2-A-6 (10 g, 27.4 mmol), Compound sub52 (2.6 g, 27.4 mmol) and sodium tert-butoxide (2.9 g, 30.1 mmol) were added to 200 ml of xylene under a nitrogen atmosphere, and the mixture was stirred and refluxed. Then, bis(tri-tert-butylphosphine)palladium(0) (0.1 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 5.9 g of Compound sub2-B-3. (Yield: 51%, MS: [M+H]⁺= 422)

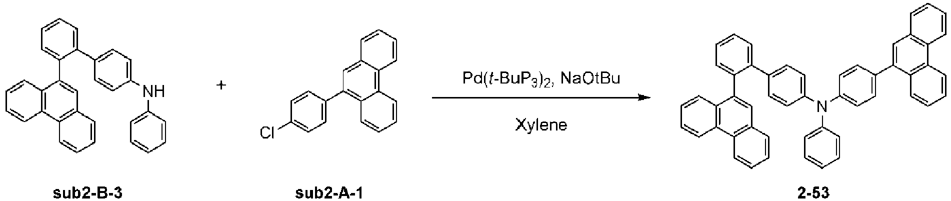

Compound sub2-B-3 (10 g, 23.7 mmol), Compound sub2-A-1 (6.9 g, 23.7 mmol) and sodium tert-butoxide (3 g, 30.8 mmol) were added to 200 ml of xylene under a nitrogen atmosphere, and the mixture was stirred and refluxed. Then, bis(tri-tert-butylphosphine)palladium(0) (0.1 g, 0.2 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 9.3 g of Compound 2-53. (Yield: 58%, MS: [M+H]⁺= 674)

### Preparation Example 2-54: Preparation of Compound 2-54

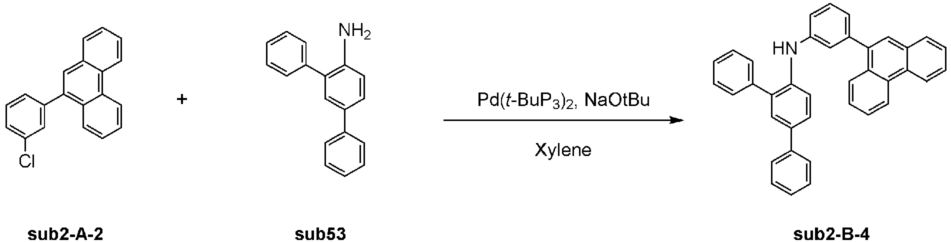

Compound sub2-A-2 (10 g, 34.6 mmol), Compound sub53 (8.5 g, 34.6 mmol) and sodium tert-butoxide (3.7 g, 38.1 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 11.5 g of Compound sub2-B-4. (Yield: 67%, MS: [M+H]⁺= 498)

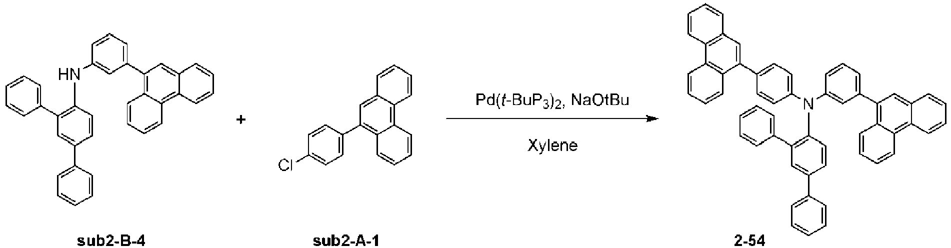

Compound sub2-B-4 (10 g, 20.1 mmol), Compound sub2-A-1 (5.8 g, 20.1 mmol) and sodium tert-butoxide (2.5 g, 26.1 mmol) were added to 200 ml of xylene under a nitrogen atmosphere, and the mixture was stirred and refluxed. Then, bis(tri-tert-butylphosphine)palladium(0) (0.1 g, 0.2 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 7.5 g of Compound 2-54. (Yield: 50%, MS: [M+H]⁺= 750)

### Preparation Example 2-55: Preparation of Compound 2-55

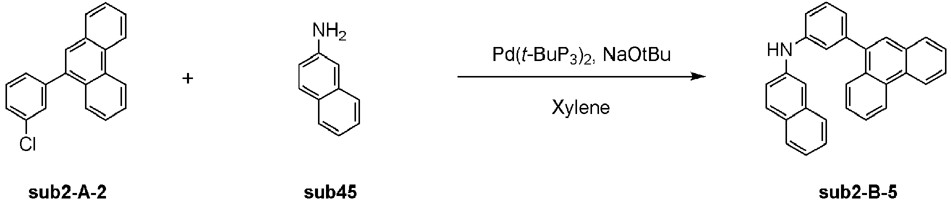

Compound sub2-A-2 (10 g, 34.6 mmol), Compound sub45 (5 g, 34.6 mmol) and sodium tert-butoxide (3.7 g, 38.1 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 9.3 g of Compound sub2-B-5. (Yield: 68%, MS: [M+H]⁺= 396)

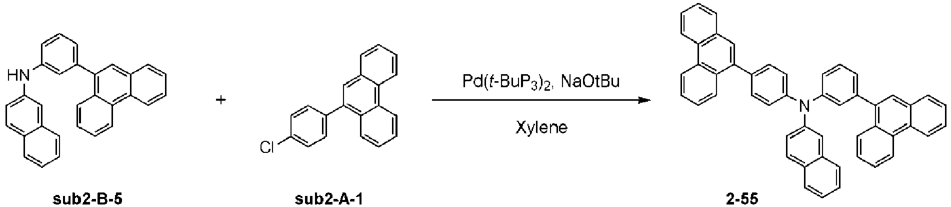

Compound sub2-B-5 (10 g, 25.3 mmol), Compound sub2-A-1 (7.3 g, 25.3 mmol) and sodium tert-butoxide (3.2 g,32.9 mmol) were added to 200 ml of xylene under a nitrogen atmosphere, and the mixture was stirred and refluxed. Then, bis(tri-tert-butylphosphine)palladium(0) (0.1 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 10 g of Compound 2-55. (Yield: 61%, MS: [M+H]⁺= 648)

### Preparation Example 2-56: Preparation of Compound 2-56

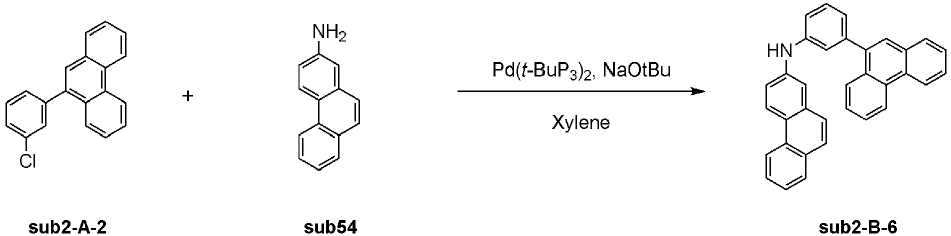

Compound sub2-A-2 (10 g, 34.6 mmol), Compound sub54 (6.7 g, 34.6 mmol) and sodium tert-butoxide (3.7 g, 38.1 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 8.6 g of Compound sub2-B-6. (Yield: 56%, MS: [M+H]⁺= 446)

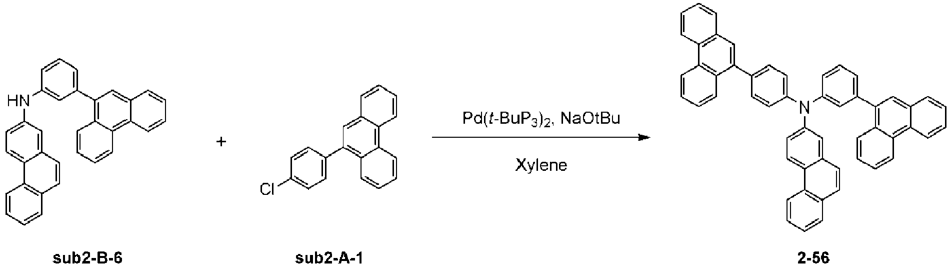

Compound sub2-B-6 (10 g, 22.4 mmol), Compound sub2-A-1 (6.5 g, 22.4 mmol) and sodium tert-butoxide (2.8 g, 29.2 mmol) were added to 200 ml of xylene under a nitrogen atmosphere, and the mixture was stirred and refluxed. Then, bis(tri-tert-butylphosphine)palladium(0) (0.1 g, 0.2 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 8.8 g of Compound 2-56. (Yield: 56%, MS: [M+H]⁺= 698)

### Preparation Example 2-57: Preparation of Compound 2-57

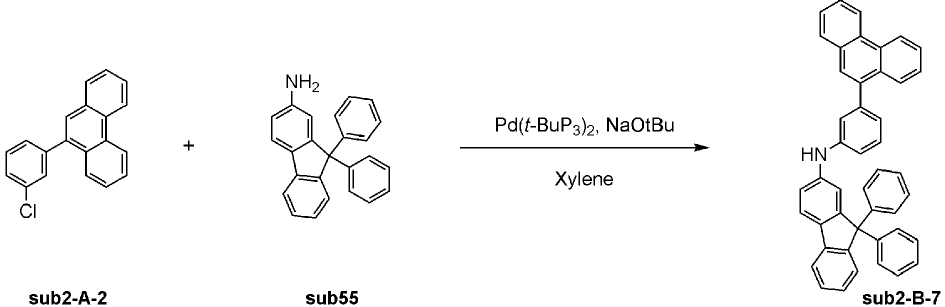

Compound sub2-A-2 (10 g, 34.6 mmol), Compound sub55 (11.5 g, 34.6 mmol) and sodium tert-butoxide (3.7 g, 38.1 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 13.2 g of Compound sub2-B-7. (Yield: 65%, MS: [M+H]⁺= 586)

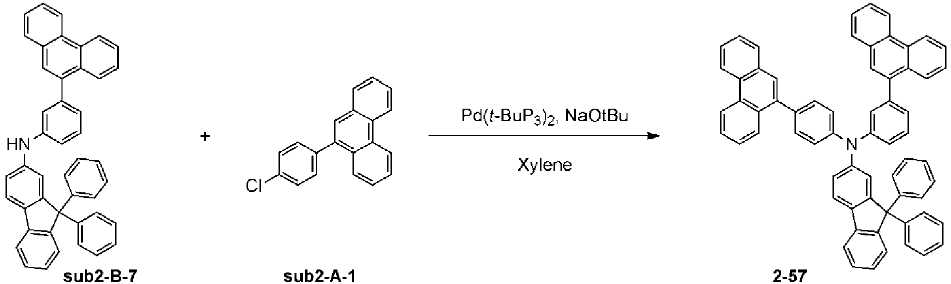

Compound sub2-B-7 (10 g, 17.1 mmol), Compound sub2-A-1 (4.9 g, 17.1 mmol) and sodium tert-butoxide (2.1 g, 22.2 mmol) were added to 200 ml of xylene under a nitrogen atmosphere, and the mixture was stirred and refluxed. Then, bis(tri-tert-butylphosphine)palladium(0) (0.1 g, 0.2 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 7.7 g of Compound 2-57. (Yield: 54%, MS: [M+H]⁺= 838)

### Preparation Example 2-58: Preparation of Compound 2-58

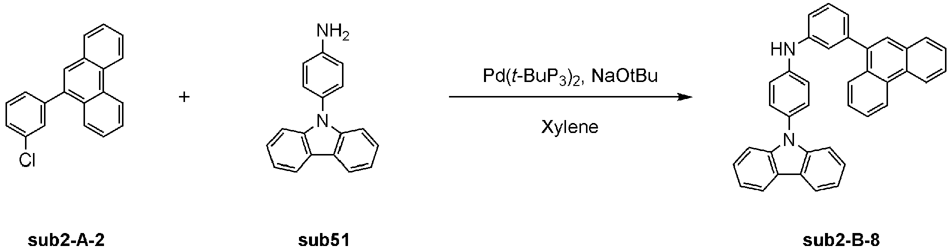

Compound sub2-A-2 (10 g, 34.6 mmol), Compound sub51 (8.9 g, 34.6 mmol) and sodium tert-butoxide (3.7 g, 38.1 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 10.8 g of Compound sub2-B-8. (Yield: 61%, MS: [M+H]⁺= 511)

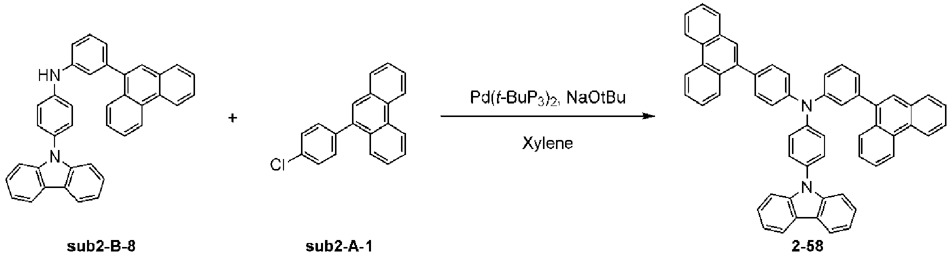

Compound sub2-B-8 (10 g, 19.6 mmol), Compound sub2-A-1 (5.7 g, 19.6 mmol) and sodium tert-butoxide (2.4 g, 25.5 mmol) were added to 200 ml of xylene under a nitrogen atmosphere, and the mixture was stirred and refluxed. Then, bis(tri-tert-butylphosphine)palladium(0) (0.1 g, 0.2 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 7.6 g of Compound 2-58. (Yield: 51%, MS: [M+H]⁺= 763)

### Preparation Example 2-59: Preparation of Compound 2-59

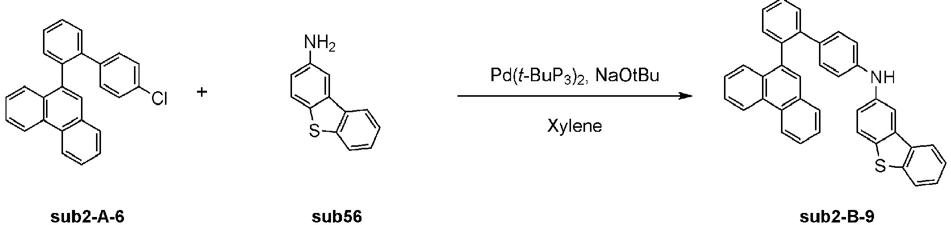

Compound sub2-A-6 (10 g, 27.4 mmol), Compound sub56 (5.5 g, 27.4 mmol) and sodium tert-butoxide (2.9 g, 30.2 mmol) were added to 200 ml of xylene under a nitrogen atmosphere, and the mixture was stirred and refluxed. Then, bis(tri-tert-butylphosphine)palladium(0) (0.1 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 7.5 g of Compound sub2-B-9. (Yield: 52%, MS: [M+H]⁺= 528)

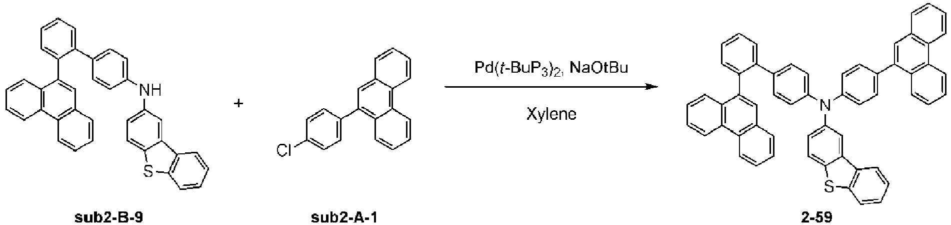

Compound sub2-B-9 (10 g, 19 mmol), Compound sub2-A-1 (5.5 g, 19 mmol) and sodium tert-butoxide (2.4 g, 24.6 mmol) were added to 200 ml of xylene under a nitrogen atmosphere, and the mixture was stirred and refluxed. Then, bis(tri-tert-butylphosphine)palladium(0) (0.1 g, 0.2 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 8.7 g of Compound 2-59. (Yield: 59%, MS: [M+H]⁺= 780)

### Preparation Example 2-60: Preparation of Compound 2-60

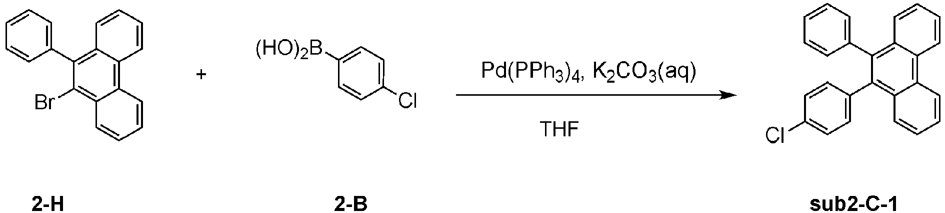

Compound 2-H (15 g, 45 mmol) and Compound 2-B (7.7 g, 49.5 mmol) were added to 300 ml of THF under a nitrogen atmosphere, and the mixture was stirred and refluxed. Then, potassium carbonate (12.4 g, 90 mmol) was dissolved in 37 ml of water, added thereto, and the mixture was sufficiently stirred and then tetrakis(triphenylphosphine)palladium(0) (1 g, 0.9 mmol) was added. After 11-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 12.3 g of Compound sub2-C-1. (Yield: 75%, MS: [M+H]⁺= 365)

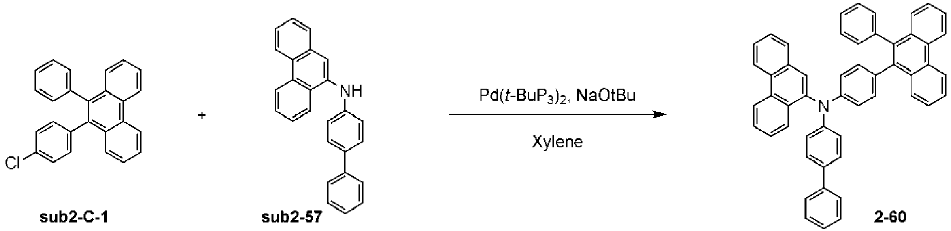

Compound sub2-C-1 (10 g, 27.4 mmol), Compound sub2-57 (9.5 g, 27.4 mmol) and sodium tert-butoxide (3.4 g, 35.6 mmol) were added to 200 ml of xylene under a nitrogen atmosphere, and the mixture was stirred and refluxed. Then, bis(tri-tert-butylphosphine)palladium(0) (0.1 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 12.7 g of Compound 2-60. (Yield: 69%, MS: [M+H]⁺= 674)

### Preparation Example 2-61: Preparation of Compound 2-61

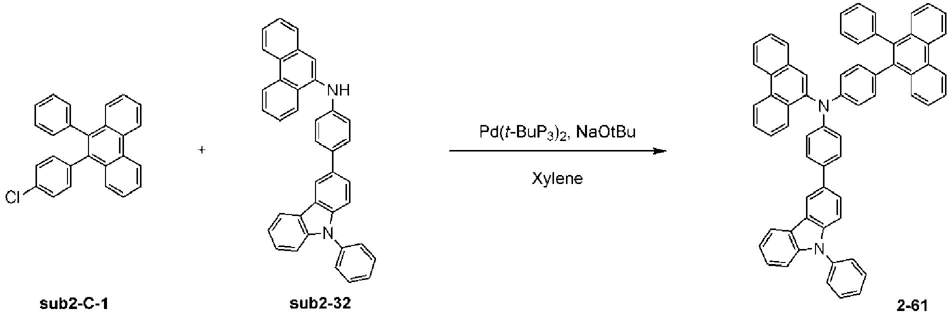

Compound sub2-C-1 (10 g, 27.4 mmol), Compound sub2-32 (14 g, 27.4 mmol) and sodium tert-butoxide (3.4 g, 35.6 mmol) were added to 200 ml of xylene under a nitrogen atmosphere, and the mixture was stirred and refluxed. Then, bis(tri-tert-butylphosphine)palladium(0) (0.1 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 12.6 g of Compound 2-61. (Yield: 55%, MS: [M+H]⁺= 839)

### Preparation Example 2-62: Preparation of Compound 2-62

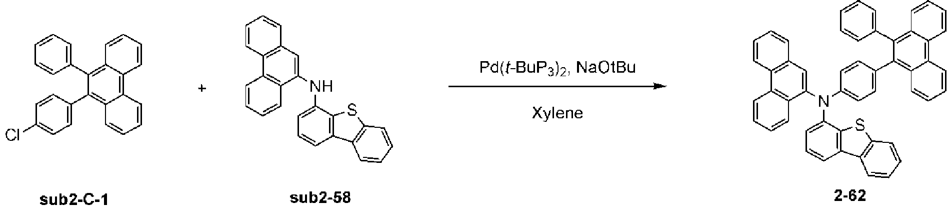

Compound sub2-C-1 (10 g, 27.4 mmol), Compound sub2-58 (10.3 g, 27.4 mmol) and sodium tert-butoxide (3.4 g, 35.6 mmol) were added to 200 ml of xylene under a nitrogen atmosphere, and the mixture was stirred and refluxed. Then, bis(tri-tert-butylphosphine)palladium(0) (0.1 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 12.5 g of Compound 2-62. (Yield: 65%, MS: [M+H]⁺= 704)

### Preparation Example 2-63: Preparation of Compound 2-63

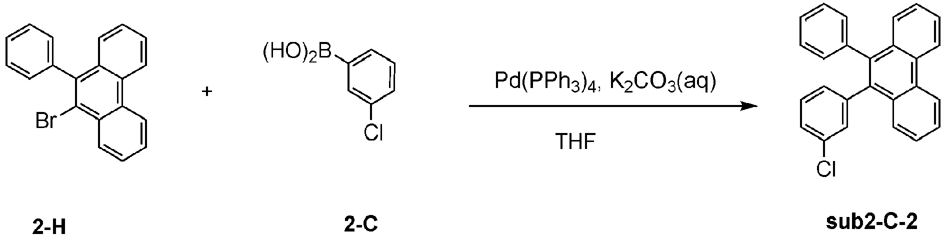

Compound 2-H (15 g, 45 mmol) and Compound 2-C (7.7 g, 49.5 mmol) were added to 300 ml of THF under a nitrogen atmosphere, and the mixture was stirred and refluxed. Then, potassium carbonate (12.4 g, 90 mmol) was dissolved in 37 ml of water, added thereto, and the mixture was sufficiently stirred and then tetrakis(triphenylphosphine)palladium(0) (1 g, 0.9 mmol) was added. After 11-hour reaction, the reaction mixture was cooled to room temperature, and the organic layer and the aqueous layer were separated, and then the organic layer was distilled. This was again dissolved in chloroform, washed twice with water, and then the organic layer was separated, anhydrous magnesium sulfate was added thereto, the mixture was stirred and filtered, and the filtrate was distilled under reduced pressure. The concentrated compound was purified by silica gel column chromatography to give 12.3 g of Compound sub2-C-2. (Yield: 75%, MS: [M+H]⁺= 365)

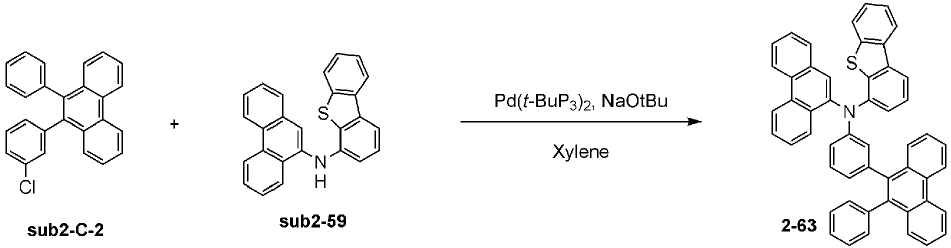

Compound sub2-C-2 (10 g, 27.4 mmol), Compound sub2-59 (10.3 g, 27.4 mmol) and sodium tert-butoxide (3.4 g, 35.6 mmol) were added to 200 ml of xylene under a nitrogen atmosphere, and the mixture was stirred and refluxed. Then, bis(tri-tert-butylphosphine)palladium(0) (0.1 g, 0.3 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 13.5 g of Compound 2-63. (Yield: 70%, MS: [M+H]⁺= 704)

### Preparation Example 2-64: Preparation of Compound 2-64

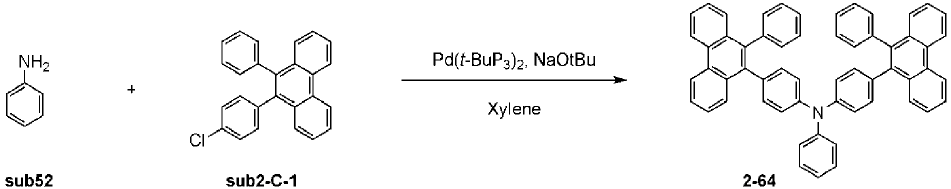

Compound sub52 (10 g, 107.4 mmol), Compound sub2-C-1 (82.3 g, 225.5 mmol) and sodium tert-butoxide (25.8 g, 268.4 mmol) were added to 200 ml of xylene under a nitrogen atmosphere, and the mixture was stirred and refluxed. Then, bis(tri-tert-butylphosphine)palladium(0) (1.1 g, 2.1 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 41 g of Compound 2-64. (Yield: 51%, MS: [M+H]⁺= 750)

### Preparation Example 2-65: Preparation of Compound 2-65

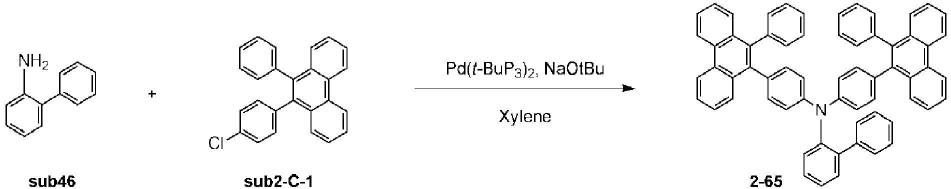

Compound sub46 (10 g, 59.1 mmol), Compound sub2-C-1 (45.3 g, 124.1 mmol) and sodium tert-butoxide (14.2 g, 147.7 mmol) were added to 200 ml of xylene under a nitrogen atmosphere, and the mixture was stirred and refluxed. Then, bis(tri-tert-butylphosphine)palladium(0) (0.6 g, 1.2 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 31.2 g of Compound 2-65. (Yield: 64%, MS: [M+H]⁺= 826)

### Preparation Example 2-66: Preparation of Compound 2-66

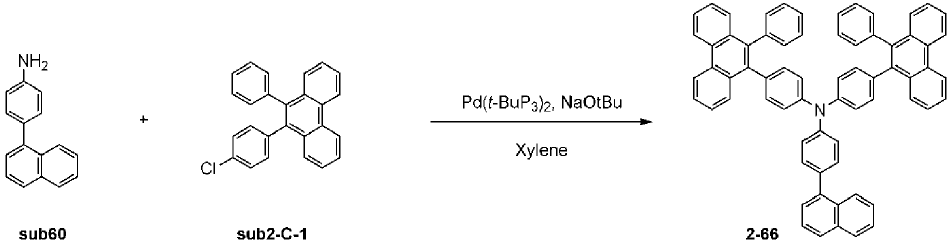

Compound sub60 (10 g, 45.6 mmol), Compound sub2-C-1 (34.9 g, 95.8 mmol) and sodium tert-butoxide (11 g, 114 mmol) were added to 200 ml of xylene under a nitrogen atmosphere, and the mixture was stirred and refluxed. Then, bis(tri-tert-butylphosphine)palladium(0) (0.5 g, 0.9 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 26.7 g of Compound 2-66. (Yield: 67%, MS: [M+H]⁺= 876)

### Preparation Example 2-67: Preparation of Compound 2-67

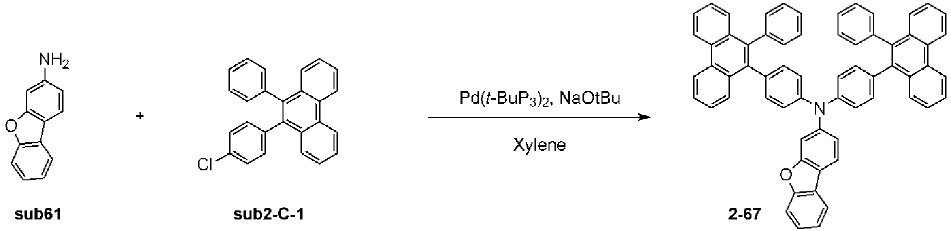

Compound sub61 (10 g, 54.6 mmol), Compound sub2-C-1 (41.8 g, 114.6 mmol) and sodium tert-butoxide (13.1 g, 136.5 mmol) were added to 200 ml of xylene under a nitrogen atmosphere, and the mixture was stirred and refluxed. Then, bis(tri-tert-butylphosphine)palladium(0) (0.6 g, 1.1 mmol) was added thereto. After 5 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 32.1 g of Compound 2-67. (Yield: 70%, MS: [M+H]⁺= 840)

### Preparation Example 2-68: Preparation of Compound 2-68

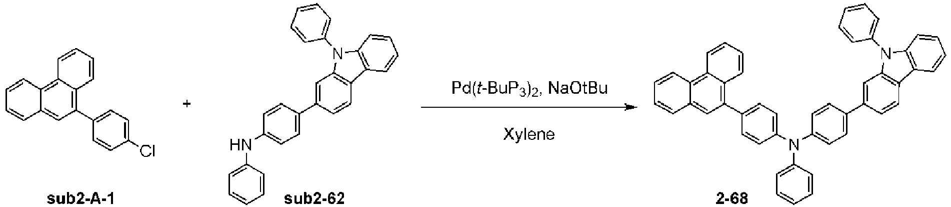

Compound sub2-A-1 (10 g, 34.6 mmol), Compound sub2-62 (15.6 g, 38.1 mmol) and potassium phosphate (22.1 g, 103.9 mmol) were added to 200 ml of xylene under a nitrogen atmosphere, and the mixture was stirred and refluxed. Then, bis(tri-tert-butylphosphine)palladium(0) (0.4 g, 0.7 mmol) was added thereto. After 2 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 12.6 g of Compound 2-68. (Yield: 55%, MS: [M+H]⁺= 663)

### Preparation Example 2-69: Preparation of Compound 2-69

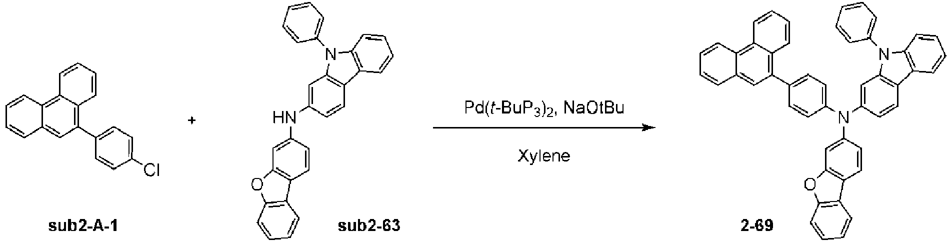

Compound sub2-A-1 (10 g, 34.6 mmol), Compound sub2-63 (16.2 g, 38.1 mmol) and potassium phosphate (22.1 g, 103.9 mmol) were added to 200 ml of xylene under a nitrogen atmosphere, and the mixture was stirred and refluxed. Then, bis(tri-tert-butylphosphine)palladium(0) (0.4 g, 0.7 mmol) was added thereto. After 2 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 12.6 g of Compound 2-69. (Yield: 54%, MS: [M+H]⁺= 677)

### Preparation Example 2-70: Preparation of Compound 2-70

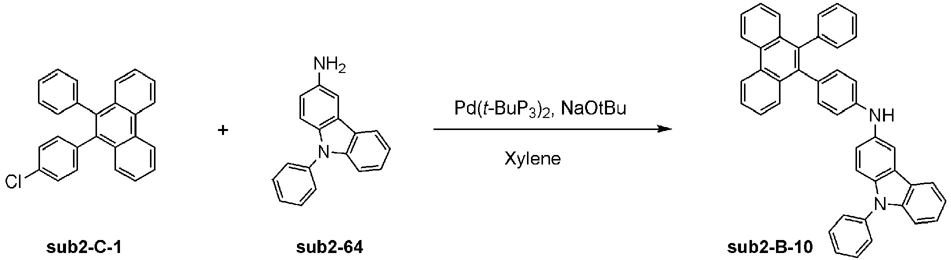

Compound sub2-C-1 (10 g, 27.4 mmol), Compound sub2-64 (7.8 g, 30.1 mmol) and potassium phosphate (17.5 g, 82.2 mmol) were added to 200 ml of xylene under a nitrogen atmosphere, and the mixture was stirred and refluxed. Then, bis(tri-tert-butylphosphine)palladium(0) (0.3 g, 0.5 mmol) was added thereto. After 2 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 11.2 g of Compound sub2-B-10. (Yield: 70%, MS: [M+H]⁺= 587)

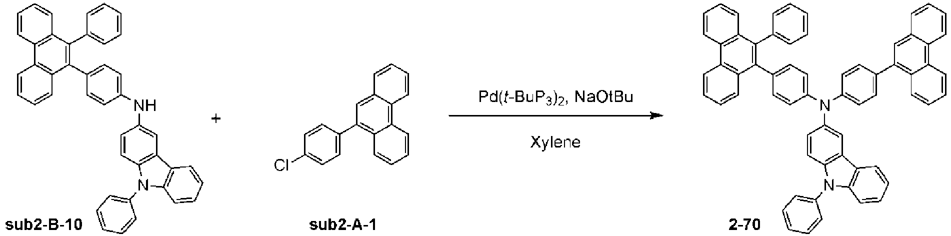

Compound sub2-B-10 (10 g, 17 mmol), Compound sub2-A-1 (5.4 g, 18.7 mmol) and potassium phosphate (10.9 g, 51.1 mmol) were added to 200 ml of xylene under a nitrogen atmosphere, and the mixture was stirred and refluxed. Then, bis(tri-tert-butylphosphine)palladium(0) (0.2 g, 0.3 mmol) was added thereto. After 3 hours, when the reaction was completed, the reaction mixture was cooled to room temperature and the solvent was removed under reduced pressure. Then, the compound was completely dissolved again in chloroform, washed twice with water, and then the organic layer was separated, treated with anhydrous magnesium sulfate, then filtered, and the filtrate was distilled under reduced pressure. The concentrated compound was purified by silica gel column chromatography to give 8.7 g of Compound 2-70. (Yield: 61%, MS: [M+H]⁺= 839)

### [EXAMPLE and COMPARATIVE EXAMPLE]

### Comparative Example 1

A glass substrate on which a thin film of ITO (indium tin oxide) was coated in a thickness of 1000 Å was put into distilled water containing the detergent dissolved therein and washed by the ultrasonic wave. In this case, the used detergent was a product commercially available from Fischer Co. and the distilled water was one which had been twice filtered by using a filter commercially available from Millipore Co. The ITO was washed for 30 minutes, and ultrasonic washing was then repeated twice for 10 minutes by using distilled water. After the washing with distilled water was completed, the substrate was ultrasonically washed with isopropyl alcohol, acetone, and methanol solvent, and dried, after which it was transported to a plasma cleaner. Then, the substrate was cleaned with oxygen plasma for 5 minutes, and then transferred to a vacuum evaporator.

On the ITO transparent electrode thus prepared, the following compound HI-1 was formed as a hole injection layer, but the following compound A-1was p-doped in an amount of 1.5% by weight. The following compound HT-1 was vacuum deposited on the hole injection layer to form a hole transport layer with a film thickness of 800Å. Then, the following compound EB-1 was vacuum deposited to a film thickness of 150 Å on the hole transport layer to form an electron blocking layer. Then, the following compound 1-2 and the following compound Dp-7 were vacuum deposited in a weight ratio of 98:2 on the EB-1 deposited film to form a red light emitting layer with a thickness of 400 Å. The following compound HB-1 was vacuum deposited to a thickness of 30 Å on the light emitting layer to form a hole blocking layer. Then, the following compound ET-1 and the following compound LiQ were vacuum deposited in a ratio of 2: 1 on the hole blocking layer to form an electron injection and transport layer with a thickness of 300 Å. Lithium fluoride (LiF) and aluminum were sequentially deposited to have a thickness of 12 Å and 1000 Å, respectively, on the electron injection and transport layer to form a cathode.

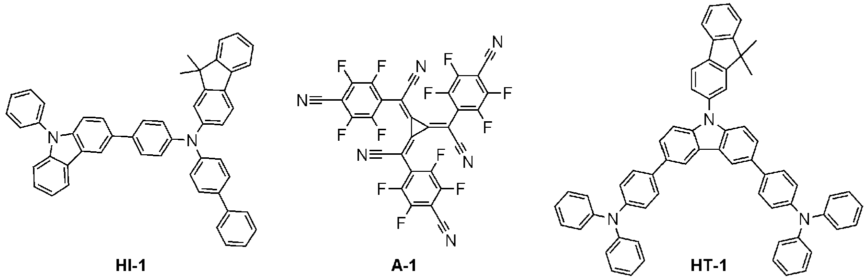

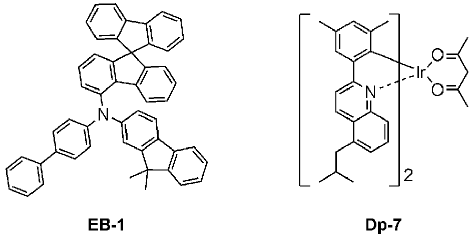

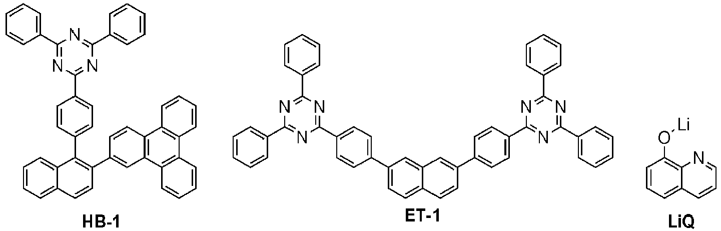

In the above-mentioned processes, the deposition rates of the organic materials were maintained at 0.4 to 0.7 Å/sec, the deposition rates of lithium fluoride and the aluminum of the cathode were maintained at 0.3 Å/sec and 2 Å/sec, respectively, and the degree of vacuum during the deposition was maintained at 2^{∗}10⁻⁷ to 5^{∗}10⁻⁶ torr.

### Examples 1 to 155

The organic light emitting devices were manufactured in the same manner as in Comparative Example 1, except that instead of Compound 1-2 as a host, the first host and the second host listed in Table 1 below were co-deposited at a weight ratio of 1:1 and used.

### Comparative Examples 2 to 61

The organic light emitting devices were manufactured in the same manner as in Comparative Example 1, except that the host material shown in Table 2 was used instead of Compound 1-2 as a host, and the compound shown in Table 2 below was used instead of Compound EB-1 as the electron blocking layer material.

### Comparative Examples 62 to 121

The organic light emitting devices were manufactured in the same manner as in Comparative Example 1, except that instead of Compound 1-2 as a host, the first host and the second host listed in Table 3 below were co-deposited at a weight ratio of 1:1 and used.

Compound B-1 to Compound B-12 in Table 3 are as follows.

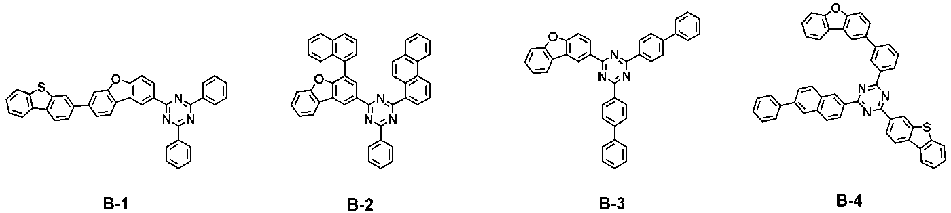

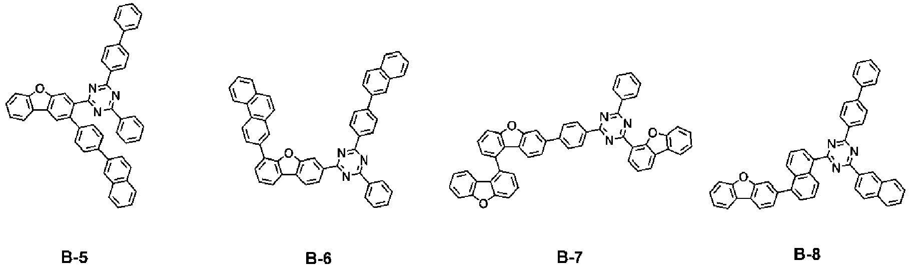

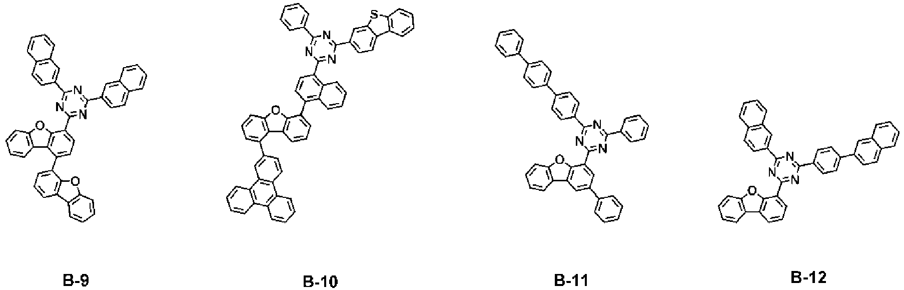

### Comparative Examples 122 to 227

The organic light emitting devices were manufactured in the same manner as in Comparative Example 1, except that instead of Compound 1-2 as a host, the first host and the second host listed in Table 4 below were co-deposited at a weight ratio of 1:1 and used.

Compound C-1 to Compound C-12 in Table 4 are as follows.

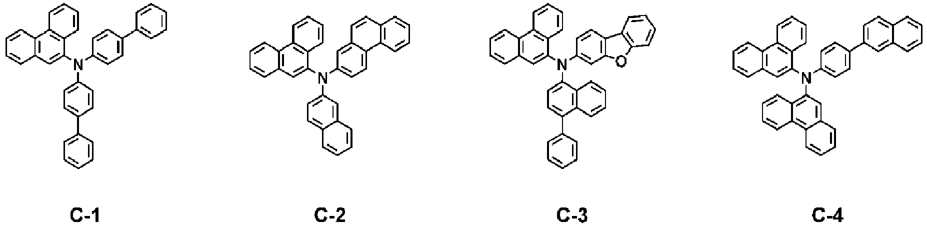

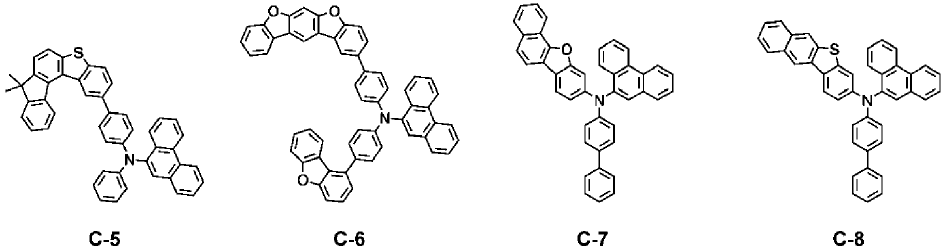

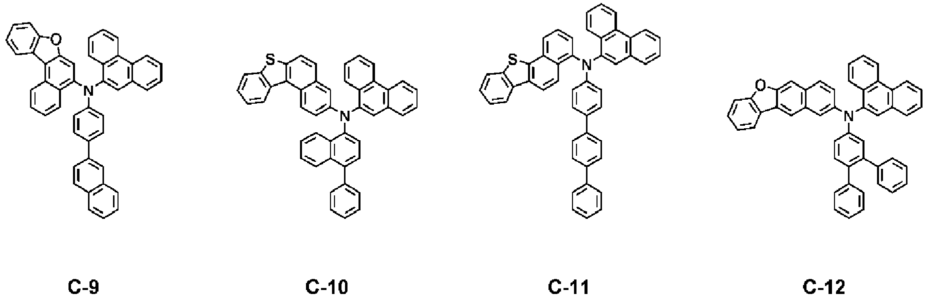

### [Experimental Example]

The voltage, efficiency, and lifetime were measured (based on 15 mA/cm²) by applying a current to the organic light emitting devices manufactured in Examples 1 to 155 and Comparative Examples 1 to 227, and the results are shown in Tables 1 to 4 below. Lifetime T95 means the time required for the luminance to be reduced to 95% of the initial luminance (6,000 nit).

**[Table 1]**

| Category | First host | Second host | Driving voltage (V) | Efficiency (cd/A) | Lifetime T95 (hr) | Light emitting color |
|---|---|---|---|---|---|---|
| Example 1 | Compound 1-2 | Compound 2-1 | 3.96 | 19.6 | 203 | Red |
| Example 2 | Compound 1-2 | Compound 2-27 | 3.94 | 19.3 | 207 | Red |
| Example 3 | Compound 1-2 | Compound 2-39 | 3.97 | 19.8 | 198 | Red |
| Example 4 | Compound 1-2 | Compound 2-54 | 3.88 | 20.4 | 185 | Red |
| Example 5 | Compound 1-2 | Compound 2-60 | 3.93 | 19.1 | 193 | Red |
| Example 6 | Compound 1-3 | Compound 2-3 | 3.92 | 18.9 | 191 | Red |
| Example 7 | Compound 1-3 | Compound 2-10 | 3.88 | 19.2 | 208 | Red |
| Example 8 | Compound 1-3 | Compound 2-68 | 3.90 | 19.6 | 197 | Red |
| Example 9 | Compound 1-3 | Compound 2-44 | 3.89 | 18.7 | 191 | Red |
| Example 10 | Compound 1-3 | Compound 2-49 | 3.92 | 185 | 205 | Red |
| Example 11 | Compound 1-7 | Compound 2-5 | 3.86 | 19.3 | 213 | Red |
| Example 12 | Compound 1-7 | Compound 2-14 | 3.82 | 19.8 | 212 | Red |
| Example 13 | Compound 1-7 | Compound 2-23 | 3.86 | 18.1 | 207 | Red |
| Example 14 | Compound 1-7 | Compound 2-58 | 3.83 | 19.5 | 218 | Red |
| Example 15 | Compound 1-7 | Compound 2-64 | 3.81 | 18.7 | 195 | Red |
| Example 16 | Compound 1-9 | Compound 2-17 | 3.88 | 19.3 | 203 | Red |
| Example 17 | Compound 1-9 | Compound 2-20 | 3.80 | 19.7 | 210 | Red |
| Example 18 | Compound 1-9 | Compound 2-28 | 3.84 | 19.0 | 207 | Red |
| Example 19 | Compound 1-9 | Compound 2-35 | 3.89 | 18.6 | 201 | Red |
| Example 20 | Compound 1-9 | Compound 2-57 | 3.86 | 192 | 195 | Red |
| Example 21 | Compound 1-11 | Compound 2-1 | 3.85 | 18.4 | 203 | Red |
| Example 22 | Compound 1-11 | Compound 2-27 | 3.81 | 18.6 | 205 | Red |
| Example 23 | Compound 1-11 | Compound 2-39 | 3.80 | 18.7 | 197 | Red |
| Example 24 | Compound 1-11 | Compound 2-54 | 3.88 | 19.0 | 206 | Red |
| Example 25 | Compound 1-11 | Compound 2-60 | 3.83 | 18.9 | 194 | Red |
| Example 26 | Compound 1-14 | Compound 2-3 | 3.89 | 20.1 | 213 | Red |
| Example 27 | Compound 1-14 | Compound 2-10 | 3.87 | 20.3 | 215 | Red |
| Example 28 | Compound 1-14 | Compound 2-68 | 3.88 | 20.2 | 201 | Red |
| Example 29 | Compound 1-14 | Compound 2-44 | 3.86 | 19.5 | 217 | Red |
| Example 30 | Compound 1-14 | Compound 2-49 | 3.86 | 20.4 | 220 | Red |
| Example 31 | Compound 1-15 | Compound 2-5 | 3.79 | 19.3 | 208 | Red |
| Example 32 | Compound 1-15 | Compound 2-14 | 3.72 | 20.2 | 211 | Red |
| Example 33 | Compound 1-15 | Compound 2-23 | 3.74 | 20.7 | 210 | Red |
| Example 34 | Compound 1-15 | Compound 2-58 | 3.70 | 19.8 | 203 | Red |
| Example 35 | Compound 1-15 | Compound 2-64 | 3.77 | 20.6 | 215 | Red |
| Example 36 | Compound 1-16 | Compound 2-17 | 3.76 | 19.9 | 221 | Red |
| Example 37 | Compound 1-16 | Compound 2-20 | 3.78 | 20.3 | 216 | Red |
| Example 38 | Compound 1-16 | Compound 2-28 | 3.74 | 20.1 | 220 | Red |
| Example 39 | Compound 1-16 | Compound 2-35 | 3.79 | 20.6 | 208 | Red |
| Example 40 | Compound 1-16 | Compound 2-70 | 3.82 | 20.4 | 215 | Red |
| Example 41 | Compound 1-17 | Compound 2-1 | 3.81 | 20.1 | 203 | Red |
| Example 42 | Compound 1-17 | Compound 2-27 | 3.83 | 20.3 | 214 | Red |
| Example 43 | Compound 1-17 | Compound 2-39 | 3.80 | 20.8 | 209 | Red |
| Example 44 | Compound 1-17 | Compound 2-54 | 3.85 | 20.5 | 205 | Red |
| Example 45 | Compound 1-17 | Compound 2-60 | 3.84 | 21.0 | 215 | Red |
| Example 46 | Compound 1-20 | Compound 2-3 | 3.93 | 19.3 | 201 | Red |
| Example 47 | Compound 1-20 | Compound 2-10 | 3.90 | 20.0 | 228 | Red |
| Example 48 | Compound 1-20 | Compound 2-68 | 3.92 | 20.6 | 210 | Red |
| Example 49 | Compound 1-20 | Compound 2-44 | 3.88 | 19.7 | 224 | Red |
| Example 50 | Compound 1-20 | Compound 2-49 | 3.86 | 20.0 | 217 | Red |
| Example 51 | Compound 1-22 | Compound 2-5 | 3.80 | 20.9 | 234 | Red |
| Example 52 | Compound 1-22 | Compound 2-14 | 3.81 | 20.5 | 221 | Red |
| Example 53 | Compound 1-22 | Compound 2-23 | 3.87 | 19.9 | 216 | Red |
| Example 54 | Compound 1-22 | Compound 2-58 | 3.86 | 20.6 | 224 | Red |
| Example 55 | Compound 1-22 | Compound 2-64 | 3.93 | 20.4 | 225 | Red |
| Example 56 | Compound 1-24 | Compound 2-17 | 3.78 | 20.3 | 217 | Red |
| Example 57 | Compound 1-24 | Compound 2-20 | 3.84 | 21.1 | 230 | Red |
| Example 58 | Compound 1-24 | Compound 2-28 | 3.80 | 21.4 | 228 | Red |
| Example 59 | Compound 1-24 | Compound 2-35 | 3.83 | 20.7 | 233 | Red |
| Example 60 | Compound 1-24 | Compound 2-57 | 3.85 | 20.9 | 215 | Red |
| Example 61 | Compound 1-27 | Compound 2-1 | 3.76 | 20.5 | 238 | Red |
| Example 62 | Compound 1-27 | Compound 2-27 | 3.82 | 19.3 | 211 | Red |
| Example 63 | Compound 1-27 | Compound 2-39 | 3.79 | 19.6 | 223 | Red |
| Example 64 | Compound 1-27 | Compound 2-54 | 3.78 | 19.1 | 226 | Red |
| Example 65 | Compound 1-27 | Compound 2-60 | 3.82 | 20.3 | 230 | Red |
| Example 66 | Compound 1-28 | Compound 2-3 | 3.88 | 19.7 | 227 | Red |
| Example 67 | Compound 1-28 | Compound 2-10 | 3.84 | 20.8 | 218 | Red |
| Example 68 | Compound 1-28 | Compound 2-68 | 3.78 | 19.3 | 215 | Red |
| Example 69 | Compound 1-28 | Compound 2-44 | 3.82 | 19.5 | 220 | Red |
| Example 70 | Compound 1-28 | Compound 2-49 | 3.86 | 20.2 | 218 | Red |
| Example 71 | Compound 1-31 | Compound 2-5 | 3.98 | 20.3 | 256 | Red |
| Example 72 | Compound 1-31 | Compound 2-14 | 3.92 | 20.0 | 248 | Red |
| Example 73 | Compound 1-31 | Compound 2-23 | 3.95 | 20.5 | 251 | Red |
| Example 74 | Compound 1-31 | Compound 2-58 | 3.90 | 20.1 | 252 | Red |
| Example 75 | Compound 1-31 | Compound 2-64 | 3.93 | 19.8 | 265 | Red |
| Example 76 | Compound 1-33 | Compound 2-1 | 3.68 | 22.3 | 281 | Red |
| Example 77 | Compound 1-33 | Compound 2-27 | 3.65 | 22.0 | 277 | Red |
| Example 78 | Compound 1-33 | Compound 2-39 | 3.70 | 21.3 | 288 | Red |
| Example 79 | Compound 1-33 | Compound 2-54 | 3.69 | 22.7 | 270 | Red |
| Example 80 | Compound 1-33 | Compound 2-60 | 3.71 | 21.8 | 274 | Red |
| Example 81 | Compound 1-37 | Compound 2-17 | 3.76 | 222 | 263 | Red |
| Example 82 | Compound 1-37 | Compound 2-20 | 3.70 | 21.9 | 275 | Red |
| Example 83 | Compound 1-37 | Compound 2-28 | 3.74 | 22.0 | 279 | Red |
| Example 84 | Compound 1-37 | Compound 2-35 | 3.79 | 21.8 | 256 | Red |
| Example 85 | Compound 1-37 | Compound 2-70 | 3.74 | 21.5 | 275 | Red |
| Example 86 | Compound 1-38 | Compound 2-3 | 3.72 | 21.0 | 275 | Red |
| Example 87 | Compound 1-38 | Compound 2-10 | 3.70 | 22.1 | 271 | Red |
| Example 88 | Compound 1-38 | Compound 2-68 | 3.75 | 21.5 | 284 | Red |
| Example 89 | Compound 1-38 | Compound 2-44 | 3.74 | 21.3 | 268 | Red |
| Example 90 | Compound 1-38 | Compound 2-49 | 3.71 | 22.3 | 275 | Red |
| Example 91 | Compound 1-40 | Compound 2-5 | 3.73 | 20.7 | 225 | Red |
| Example 92 | Compound 1-40 | Compound 2-14 | 3.70 | 19.1 | 238 | Red |
| Example 93 | Compound 1-40 | Compound 2-23 | 3.76 | 19.7 | 231 | Red |
| Example 94 | Compound 1-40 | Compound 2-58 | 3.74 | 19.0 | 240 | Red |
| Example 95 | Compound 1-40 | Compound 2-64 | 3.80 | 19.4 | 234 | Red |
| Example 96 | Compound 1-41 | Compound 2-17 | 3.83 | 19.0 | 241 | Red |
| Example 97 | Compound 1-41 | Compound 2-20 | 3.87 | 19.5 | 236 | Red |
| Example 98 | Compound 1-41 | Compound 2-28 | 3.83 | 18.9 | 228 | Red |
| Example 99 | Compound 1-41 | Compound 2-35 | 3.86 | 19.8 | 234 | Red |
| Example 100 | Compound 1-41 | Compound 2-57 | 3.79 | 19.4 | 225 | Red |
| Example 101 | Compound 1-43 | Compound 2-1 | 3.81 | 19.5 | 197 | Red |
| Example 102 | Compound 1-43 | Compound 2-27 | 3.80 | 20.0 | 202 | Red |
| Example 103 | Compound 1-43 | Compound 2-39 | 3.84 | 19.4 | 213 | Red |
| Example 104 | Compound 1-43 | Compound 2-54 | 3.79 | 20.8 | 204 | Red |
| Example 105 | Compound 1-43 | Compound 2-60 | 3.85 | 19.7 | 195 | Red |
| Example 106 | Compound 1-45 | Compound 2-3 | 3.87 | 20.1 | 194 | Red |
| Example 107 | Compound 1-45 | Compound 2-10 | 3.91 | 18.8 | 203 | Red |
| Example 108 | Compound 1-45 | Compound 2-68 | 3.88 | 19.3 | 201 | Red |
| Example 109 | Compound 1-45 | Compound 2-44 | 3.93 | 20.7 | 198 | Red |
| Example 110 | Compound 1-45 | Compound 2-49 | 3.85 | 18.9 | 194 | Red |
| Example 111 | Compound 1-47 | Compound 2-5 | 3.79 | 20.1 | 209 | Red |
| Example 112 | Compound 1-47 | Compound 2-14 | 3.82 | 20.3 | 201 | Red |
| Example 113 | Compound 1-47 | Compound 2-23 | 3.84 | 20.0 | 197 | Red |
| Example 114 | Compound 1-47 | Compound 2-58 | 3.86 | 19.9 | 194 | Red |
| Example 115 | Compound 1-47 | Compound 2-64 | 3.80 | 19.6 | 205 | Red |
| Example 116 | Compound 1-48 | Compound 2-17 | 3.83 | 19.6 | 217 | Red |
| Example 117 | Compound 1-48 | Compound 2-20 | 3.87 | 18.8 | 214 | Red |
| Example 118 | Compound 1-48 | Compound 2-28 | 3.80 | 19.7 | 203 | Red |
| Example 119 | Compound 1-48 | Compound 2-35 | 3.88 | 19.4 | 198 | Red |
| Example 120 | Compound 1-48 | Compound 2-70 | 3.92 | 18.9 | 201 | Red |
| Example 121 | Compound 1-52 | Compound 2-1 | 3.91 | 19.6 | 197 | Red |
| Example 122 | Compound 1-52 | Compound 2-27 | 3.94 | 19.3 | 190 | Red |
| Example 123 | Compound 1-52 | Compound 2-39 | 3.92 | 19.2 | 203 | Red |
| Example 124 | Compound 1-52 | Compound 2-54 | 3.88 | 18.9 | 194 | Red |
| Example 125 | Compound 1-52 | Compound 2-60 | 3.94 | 19.7 | 191 | Red |
| Example 126 | Compound 1-53 | Compound 2-3 | 3.87 | 18.8 | 203 | Red |
| Example 127 | Compound 1-53 | Compound 2-10 | 3.90 | 19.1 | 209 | Red |
| Example 128 | Compound 1-53 | Compound 2-68 | 3.86 | 18.6 | 198 | Red |
| Example 129 | Compound 1-53 | Compound 2-44 | 3.93 | 19.0 | 204 | Red |
| Example 130 | Compound 1-53 | Compound 2-49 | 3.90 | 19.3 | 195 | Red |
| Example 131 | Compound 1-55 | Compound 2-5 | 3.87 | 20.3 | 223 | Red |
| Example 132 | Compound 1-55 | Compound 2-14 | 3.82 | 19.9 | 224 | Red |
| Example 133 | Compound 1-55 | Compound 2-23 | 3.83 | 20.6 | 218 | Red |
| Example 134 | Compound 1-55 | Compound 2-58 | 3.84 | 20.4 | 208 | Red |
| Example 135 | Compound 1-55 | Compound 2-64 | 3.90 | 19.7 | 225 | Red |
| Example 136 | Compound 1-56 | Compound 2-17 | 3.98 | 20.0 | 195 | Red |
| Example 137 | Compound 1-56 | Compound 2-20 | 3.94 | 20.7 | 192 | Red |
| Example 138 | Compound 1-56 | Compound 2-28 | 3.92 | 19.4 | 197 | Red |
| Example 139 | Compound 1-56 | Compound 2-35 | 3.95 | 20.3 | 203 | Red |
| Example 140 | Compound 1-56 | Compound 2-57 | 3.97 | 19.8 | 195 | Red |
| Example 141 | Compound 1-57 | Compound 2-1 | 3.91 | 18.1 | 213 | Red |
| Example 142 | Compound 1-57 | Compound 2-27 | 3.94 | 19.0 | 220 | Red |
| Example 143 | Compound 1-57 | Compound 2-39 | 3.88 | 18.5 | 229 | Red |
| Example 144 | Compound 1-57 | Compound 2-54 | 3.93 | 18.9 | 217 | Red |
| Example 145 | Compound 1-57 | Compound 2-60 | 3.90 | 19.4 | 224 | Red |
| Example 146 | Compound 1-58 | Compound 2-3 | 3.87 | 18.7 | 199 | Red |
| Example 147 | Compound 1-58 | Compound 2-10 | 3.90 | 18.5 | 201 | Red |
| Example 148 | Compound 1-58 | Compound 2-68 | 3.93 | 19.2 | 203 | Red |
| Example 149 | Compound 1-58 | Compound 2-44 | 3.87 | 19.4 | 195 | Red |
| Example 150 | Compound 1-58 | Compound 2-49 | 3.84 | 19.0 | 198 | Red |
| Example 151 | Compound 1-60 | Compound 2-5 | 3.94 | 18.9 | 203 | Red |
| Example 152 | Compound 1-60 | Compound 2-14 | 3.85 | 19.1 | 197 | Red |
| Example 153 | Compound 1-60 | Compound 2-23 | 3.88 | 18.5 | 211 | Red |
| Example 154 | Compound 1-60 | Compound 2-58 | 3.95 | 19.6 | 207 | Red |
| Example 155 | Compound 1-60 | Compound 2-64 | 3.91 | 19.4 | 208 | Red |

**[Table 2]**

| Category | Host | Electron blocking layer | Driving voltage(V) | Efficiency (cd/A) | Lifetime T95(hr) | Light emitting color |
|---|---|---|---|---|---|---|
| Comparative Example 1 | Compound 1-2 | Compound EB-1 | 4.37 | 14.8 | 117 | Red |
| Comparative Example 2 | Compound 1-2 | Compound 2-1 | 4.39 | 14.0 | 101 | Red |
| Comparative Example 3 | Compound 1-2 | Compound 2-27 | 4.48 | 14.1 | 103 | Red |
| Comparative Example 4 | Compound 1-2 | Compound 2-39 | 4.49 | 14.8 | 98 | Red |
| Comparative Example 5 | Compound 1-2 | Compound 2-54 | 4.40 | 15.5 | 92 | Red |
| Comparative Example 6 | Compound 1-2 | Compound 2-60 | 4.43 | 15.1 | 111 | Red |
| Comparative Example 7 | Compound 1-11 | Compound 2-3 | 4.36 | 152 | 114 | Red |
| Comparative Example 8 | Compound 1-11 | Compound 2-10 | 4.39 | 15.0 | 103 | Red |
| Comparative Example 9 | Compound 1-11 | Compound 2-68 | 4.41 | 15.3 | 104 | Red |
| Comparative Example 10 | Compound 1-11 | Compound 2-44 | 4.42 | 14.4 | 107 | Red |
| Comparative Example 11 | Compound 1-11 | Compound 2-49 | 4.39 | 14.9 | 106 | Red |
| Comparative Example 12 | Compound 1-15 | Compound 2-5 | 4.40 | 152 | 138 | Red |
| Comparative Example 13 | Compound 1-15 | Compound 2-14 | 4.45 | 15.6 | 127 | Red |
| Comparative Example 14 | Compound 1-15 | Compound 2-23 | 4.43 | 15.0 | 121 | Red |
| Comparative Example 15 | Compound 1-15 | Compound 2-58 | 4.48 | 15.3 | 114 | Red |
| Comparative Example 16 | Compound 1-15 | Compound 2-64 | 4.45 | 15.7 | 121 | Red |
| Comparative Example 17 | Compound 1-17 | Compound 2-17 | 4.43 | 15.3 | 105 | Red |
| Comparative Example 18 | Compound 1-17 | Compound 2-20 | 4.44 | 15.4 | 103 | Red |
| Comparative Example 19 | Compound 1-17 | Compound 2-28 | 4.46 | 15.4 | 110 | Red |
| Comparative Example 20 | Compound 1-17 | Compound 2-35 | 4.41 | 14.8 | 107 | Red |
| Comparative Example 21 | Compound 1-17 | Compound 2-70 | 4.44 | 14.9 | 111 | Red |
| Comparative Example 22 | Compound 1-27 | Compound 2-1 | 4.38 | 15.0 | 108 | Red |
| Comparative Example 23 | Compound 1-27 | Compound 2-27 | 4.37 | 14.8 | 103 | Red |
| Comparative Example 24 | Compound 1-27 | Compound 2-39 | 4.36 | 14.1 | 100 | Red |
| Comparative Example 25 | Compound 1-27 | Compound 2-54 | 4.39 | 14.4 | 101 | Red |
| Comparative Example 26 | Compound 1-27 | Compound 2-60 | 4.38 | 14.7 | 111 | Red |
| Comparative Example 27 | Compound 1-37 | Compound 2-3 | 4.37 | 15.3 | 106 | Red |
| Comparative Example 28 | Compound 1-37 | Compound 2-10 | 4.39 | 15.4 | 108 | Red |
| Comparative Example 29 | Compound 1-37 | Compound 2-68 | 4.38 | 15.3 | 117 | Red |
| Comparative Example 30 | Compound 1-37 | Compound 2-44 | 4.37 | 15.0 | 104 | Red |
| Comparative Example 31 | Compound 1-37 | Compound 2-49 | 4.36 | 15.1 | 111 | Red |
| Comparative Example 32 | Compound 1-41 | Compound 2-5 | 4.42 | 14.6 | 109 | Red |
| Comparative Example 33 | Compound 1-41 | Compound 2-14 | 4.45 | 14.0 | 91 | Red |
| Comparative Example 34 | Compound 1-41 | Compound 2-23 | 4.36 | 14.2 | 95 | Red |
| Comparative Example 35 | Compound 1-41 | Compound 2-58 | 4.39 | 14.3 | 108 | Red |
| Comparative Example 36 | Compound 1-41 | Compound 2-64 | 4.35 | 14.0 | 94 | Red |
| Comparative Example 37 | Compound 1-45 | Compound 2-17 | 4.38 | 14.1 | 92 | Red |
| Comparative Example 38 | Compound 1-45 | Compound 2-20 | 4.39 | 14.5 | 98 | Red |
| Comparative Example 39 | Compound 1-45 | Compound 2-28 | 4.37 | 14.3 | 95 | Red |
| Comparative Example 40 | Compound 1-45 | Compound 2-35 | 4.36 | 14.7 | 91 | Red |
| Comparative Example 41 | Compound 1-45 | Compound 2-57 | 4.38 | 14.0 | 89 | Red |
| Comparative Example 42 | Compound 1-53 | Compound 2-1 | 4.38 | 15.1 | 97 | Red |
| Comparative Example 43 | Compound 1-53 | Compound 2-27 | 4.39 | 15.3 | 101 | Red |
| Comparative Example 44 | Compound 1-53 | Compound 2-39 | 4.42 | 15.0 | 96 | Red |
| Comparative Example 45 | Compound 1-53 | Compound 2-54 | 4.40 | 14.8 | 98 | Red |
| Comparative Example 46 | Compound 1-53 | Compound 2-60 | 4.34 | 14.9 | 94 | Red |
| Comparative Example 47 | Compound 1-55 | Compound 2-3 | 4.46 | 14.7 | 104 | Red |
| Comparative Example 48 | Compound 1-55 | Compound 2-10 | 4.38 | 15.0 | 107 | Red |
| Comparative Example 49 | Compound 1-55 | Compound 2-68 | 4.39 | 14.8 | 106 | Red |
| Comparative Example 50 | Compound 1-55 | Compound 2-44 | 4.47 | 15.3 | 104 | Red |
| Comparative Example 51 | Compound 1-55 | Compound 2-49 | 4.42 | 15.0 | 112 | Red |
| Comparative Example 52 | Compound 1-57 | Compound 2-5 | 4.41 | 14.1 | 101 | Red |
| Comparative Example 53 | Compound 1-57 | Compound 2-14 | 4.40 | 14.9 | 107 | Red |
| Comparative Example 54 | Compound 1-57 | Compound 2-23 | 4.43 | 14.6 | 108 | Red |
| Comparative Example 55 | Compound 1-57 | Compound 2-58 | 4.39 | 14.7 | 99 | Red |
| Comparative Example 56 | Compound 1-57 | Compound 2-64 | 4.45 | 15.0 | 101 | Red |
| Comparative Example 57 | Compound 1-60 | Compound 2-17 | 4.40 | 14.5 | 91 | Red |
| Comparative Example 58 | Compound 1-60 | Compound 2-20 | 4.41 | 15.0 | 99 | Red |
| Comparative Example 59 | Compound 1-60 | Compound 2-28 | 4.42 | 14.3 | 104 | Red |
| Comparative Example 60 | Compound 1-60 | Compound 2-35 | 4.44 | 15.1 | 96 | Red |
| Comparative Example 61 | Compound 1-60 | Compound 2-70 | 4.39 | 14.5 | 93 | Red |

**[Table 3]**

| Category | First host | Second host | Driving voltage(V) | Efficiency (cd/A) | Lifetime T95(hr) | Light emitting color |
|---|---|---|---|---|---|---|
| Comparative Example 62 | Compound B-1 | Compound 2-1 | 4.31 | 13.1 | 91 | Red |
| Comparative Example 63 | Compound B-1 | Compound 2-27 | 4.36 | 13.8 | 103 | Red |
| Comparative Example 64 | Compound B-1 | Compound 2-39 | 4.34 | 13.6 | 97 | Red |
| Comparative Example 65 | Compound B-1 | Compound 2-54 | 4.39 | 14.0 | 102 | Red |
| Comparative Example 66 | Compound B-1 | Compound 2-60 | 4.36 | 13.9 | 95 | Red |
| Comparative Example 67 | Compound B-2 | Compound 2-3 | 4.33 | 13.3 | 84 | Red |
| Comparative Example 68 | Compound B-2 | Compound 2-10 | 4.40 | 13.8 | 93 | Red |
| Comparative Example 69 | Compound B-2 | Compound 2-68 | 4.38 | 13.6 | 95 | Red |
| Comparative Example 70 | Compound B-2 | Compound 2-44 | 4.31 | 13.9 | 87 | Red |
| Comparative Example 71 | Compound B-2 | Compound 2-49 | 4.36 | 14.1 | 95 | Red |
| Comparative Example 72 | Compound B-3 | Compound 2-5 | 4.40 | 13.2 | 108 | Red |
| Comparative Example 73 | Compound B-3 | Compound 2-14 | 4.43 | 14.0 | 97 | Red |
| Comparative Example 74 | Compound B-3 | Compound 2-23 | 4.41 | 13.4 | 101 | Red |
| Comparative Example 75 | Compound B-3 | Compound 2-58 | 4.39 | 14.3 | 104 | Red |
| Comparative Example 76 | Compound B-3 | Compound 2-64 | 4.42 | 142 | 101 | Red |
| Comparative Example 77 | Compound B-4 | Compound 2-17 | 4.35 | 13.8 | 90 | Red |
| Comparative Example 78 | Compound B-4 | Compound 2-20 | 4.38 | 142 | 97 | Red |
| Comparative Example 79 | Compound B-4 | Compound 2-28 | 4.36 | 13.6 | 91 | Red |
| Comparative Example 80 | Compound B-4 | Compound 2-35 | 4.40 | 14.1 | 92 | Red |
| Comparative Example 81 | Compound B-4 | Compound 2-57 | 4.42 | 13.7 | 89 | Red |
| Comparative Example 82 | Compound B-5 | Compound 2-1 | 4.27 | 15.0 | 128 | Red |
| Comparative Example 83 | Compound B-5 | Compound 2-27 | 4.29 | 14.8 | 127 | Red |
| Comparative Example 84 | Compound B-5 | Compound 2-39 | 4.30 | 15.3 | 124 | Red |
| Comparative Example 85 | Compound B-5 | Compound 2-54 | 4.27 | 14.9 | 121 | Red |
| Comparative Example 86 | Compound B-5 | Compound 2-60 | 4.29 | 14.7 | 128 | Red |
| Comparative Example 87 | Compound B-6 | Compound 2-3 | 4.30 | 15.3 | 114 | Red |
| Comparative Example 88 | Compound B-6 | Compound 2-10 | 4.28 | 15.0 | 124 | Red |
| Comparative Example 89 | Compound B-6 | Compound 2-68 | 4.26 | 15.5 | 117 | Red |
| Comparative Example 90 | Compound B-6 | Compound 2-44 | 4.31 | 15.8 | 124 | Red |
| Comparative Example 91 | Compound B-6 | Compound 2-49 | 4.27 | 14.6 | 111 | Red |
| Comparative Example 92 | Compound B-7 | Compound 2-5 | 4.29 | 15.6 | 129 | Red |
| Comparative Example 93 | Compound B-7 | Compound 2-14 | 4.31 | 14.7 | 131 | Red |
| Comparative Example 94 | Compound B-7 | Compound 2-23 | 4.27 | 15.0 | 125 | Red |
| Comparative Example 95 | Compound B-7 | Compound 2-58 | 4.24 | 14.9 | 117 | Red |
| Comparative Example 96 | Compound B-7 | Compound 2-64 | 4.28 | 14.6 | 124 | Red |
| Comparative Example 97 | Compound B-8 | Compound 2-17 | 4.21 | 14.0 | 112 | Red |
| Comparative Example 98 | Compound B-8 | Compound 2-20 | 4.29 | 15.3 | 116 | Red |
| Comparative Example 99 | Compound B-8 | Compound 2-28 | 4.25 | 14.1 | 120 | Red |
| Comparative Example 100 | Compound B-8 | Compound 2-35 | 4.23 | 152 | 109 | Red |
| Comparative Example 101 | Compound B-8 | Compound 2-57 | 4.20 | 15.0 | 124 | Red |
| Comparative Example 102 | Compound B-9 | Compound 2-1 | 4.11 | 15.5 | 143 | Red |
| Comparative Example 103 | Compound B-9 | Compound 2-27 | 4.10 | 15.7 | 139 | Red |
| Comparative Example 104 | Compound B-9 | Compound 2-39 | 4.13 | 15.8 | 137 | Red |
| Comparative Example 105 | Compound B-9 | Compound 2-54 | 4.15 | 14.9 | 130 | Red |
| Comparative Example 106 | Compound B-9 | Compound 2-60 | 4.09 | 15.1 | 141 | Red |
| Comparative Example 107 | Compound B-10 | Compound 2-3 | 4.13 | 15.6 | 137 | Red |
| Comparative Example 108 | CompoundB-10 | Compound 2-10 | 4.15 | 16.1 | 126 | Red |
| Comparative Example 109 | CompoundB-10 | Compound 2-68 | 4.17 | 16.0 | 134 | Red |
| Comparative Example 110 | Compound B-10 | Compound 2-44 | 4.10 | 15.7 | 126 | Red |
| Comparative Example 111 | Compound B-10 | Compound 2-49 | 4.14 | 15.4 | 129 | Red |
| Comparative Example 112 | CompoundB-11 | Compound 2-5 | 4.10 | 15.8 | 142 | Red |
| Comparative Example 113 | Compound B-11 | Compound 2-14 | 4.09 | 16.3 | 137 | Red |
| Comparative Example 114 | CompoundB-11 | Compound 2-23 | 4.17 | 15.9 | 130 | Red |
| Comparative Example 115 | CompoundB-11 | Compound 2-58 | 4.16 | 16.4 | 124 | Red |
| Comparative Example 116 | CompoundB-11 | Compound 2-64 | 4.18 | 16.1 | 132 | Red |
| Comparative Example 117 | CompoundB-12 | Compound 2-17 | 4.09 | 16.0 | 147 | Red |
| Comparative Example 118 | Compound B-12 | Compound 2-20 | 4.12 | 16.5 | 129 | Red |
| Comparative Example 119 | Compound B-12 | Compound 2-28 | 4.08 | 16.3 | 144 | Red |
| Comparative Example 120 | CompoundB-12 | Compound 2-35 | 4.17 | 15.7 | 136 | Red |
| Comparative Example 121 | CompoundB-12 | Compound 2-70 | 4.13 | 15.4 | 141 | Red |

**[Table 4]**

| Category | First host | Second host | Driving voltage(V) | Efficiency (cd/A) | Lifetime T95 (hr) | Light emitting color |
|---|---|---|---|---|---|---|
| Comparative Example 122 | Compound 1 -2 | Compound C-1 | 4.21 | 15.0 | 131 | Red |
| Comparative Example 123 | Compound 1-11 | Compound C-1 | 4.26 | 14.8 | 123 | Red |
| Comparative Example 124 | Compound 1-15 | Compound C-1 | 4.17 | 15.3 | 117 | Red |
| Comparative Example 125 | Compound 1-28 | Compound C-1 | 4.25 | 14.9 | 128 | Red |
| Comparative Example 126 | Compound 1-33 | Compound C-1 | 4.16 | 14.7 | 105 | Red |
| Comparative Example 127 | Compound 1-40 | Compound C-1 | 4.23 | 15.3 | 122 | Red |
| Comparative Example 128 | Compound 1-43 | Compound C-1 | 4.30 | 15.8 | 111 | Red |
| Comparative Example 129 | Compound 1-55 | Compound C-1 | 4.28 | 14.6 | 130 | Red |
| Comparative Example 130 | Compound 1 -3 | Compound C-2 | 4.20 | 14.0 | 114 | Red |
| Comparative Example 131 | Compound 1-7 | Compound C-2 | 4.16 | 14.8 | 105 | Red |
| Comparative Example 132 | Compound 1-17 | Compound C-2 | 4.30 | 15.3 | 109 | Red |
| Comparative Example 133 | Compound 1-24 | Compound C-2 | 4.13 | 14.9 | 102 | Red |
| Comparative Example 134 | Compound 1-37 | Compound C-2 | 4.21 | 15.7 | 123 | Red |
| Comparative Example 135 | Compound 1-47 | Compound C-2 | 4.19 | 16.0 | 127 | Red |
| Comparative Example 136 | Compound 1-48 | Compound C-2 | 4.22 | 15.4 | 120 | Red |
| Comparative Example 137 | Compound 1-58 | Compound C-2 | 4.31 | 15.1 | 114 | Red |
| Comparative Example 138 | Compound 1 -9 | Compound C-3 | 4.18 | 14.3 | 135 | Red |
| Comparative Example 139 | Compound 1-16 | Compound C-3 | 4.26 | 15.1 | 134 | Red |
| Comparative Example 140 | Compound 1-22 | Compound C-3 | 4.20 | 14.7 | 129 | Red |
| Comparative Example 141 | Compound 1-38 | Compound C-3 | 4.12 | 14.0 | 135 | Red |
| Comparative Example 142 | Compound 1-41 | Compound C-3 | 4.17 | 14.9 | 124 | Red |
| Comparative Example 143 | Compound 1-45 | Compound C-3 | 4.24 | 15.1 | 132 | Red |
| Comparative Example 144 | Compound 1-53 | Compound C-3 | 4.22 | 14.8 | 127 | Red |
| Comparative Example 145 | Compound 1-57 | Compound C-3 | 4.22 | 15.6 | 121 | Red |
| Comparative Example 146 | Compound 1 -2 | Compound C-4 | 4.19 | 17.0 | 141 | Red |
| Comparative Example 147 | Compound 1-14 | Compound C-4 | 4.20 | 16.8 | 135 | Red |
| Comparative Example 148 | Compound 1-20 | Compound C-4 | 4.21 | 15.7 | 149 | Red |
| Comparative Example 149 | Compound 1-27 | Compound C-4 | 4.16 | 17.9 | 136 | Red |
| Comparative Example 150 | Compound 1-31 | Compound C-4 | 4.11 | 16.3 | 148 | Red |
| Comparative Example 151 | Compound 1-52 | Compound C-4 | 4.17 | 17.3 | 152 | Red |
| Comparative Example 152 | Compound 1-56 | Compound C-4 | 4.19 | 16.8 | 134 | Red |
| Comparative Example 153 | Compound 1-60 | Compound C-4 | 4.15 | 17.6 | 141 | Red |
| Comparative Example 154 | Compound 1 -2 | Compound C-5 | 4.37 | 13.0 | 81 | Red |
| Comparative Example 155 | Compound 1-11 | Compound C-5 | 4.34 | 13.9 | 92 | Red |
| Comparative Example 156 | Compound 1-15 | Compound C-5 | 4.38 | 13.1 | 89 | Red |
| Comparative Example 157 | Compound 1-28 | Compound C-5 | 4.41 | 12.8 | 93 | Red |
| Comparative Example 158 | Compound 1-33 | Compound C-5 | 4.39 | 13.3 | 95 | Red |
| Comparative Example 159 | Compound 1-40 | Compound C-5 | 4.31 | 13.8 | 87 | Red |
| Comparative Example 160 | Compound 1-43 | Compound C-5 | 4.33 | 13.2 | 84 | Red |
| Comparative Example 161 | Compound 1-55 | Compound C-5 | 4.34 | 13.0 | 80 | Red |
| Comparative Example 162 | Compound 1 -3 | Compound C-6 | 4.31 | 14.1 | 86 | Red |
| Comparative Example 163 | Compound 1-7 | Compound C-6 | 4.30 | 14.4 | 80 | Red |
| Comparative Example 164 | Compound 1-17 | Compound C-6 | 4.35 | 15.1 | 93 | Red |
| Comparative Example 165 | Compound 1-24 | Compound C-6 | 4.33 | 14.7 | 92 | Red |
| Comparative Example 166 | Compound 1-37 | Compound C-6 | 4.31 | 14.6 | 95 | Red |
| Comparative Example 167 | Compound 1-47 | Compound C-6 | 4.29 | 15.3 | 97 | Red |
| Comparative Example 168 | Compound 1-48 | Compound C-6 | 4.32 | 14.8 | 92 | Red |
| Comparative Example 169 | Compound 1-58 | Compound C-6 | 4.30 | 15.3 | 86 | Red |
| Comparative Example 170 | Compound 1 -9 | Compound C-7 | 4.29 | 16.6 | 129 | Red |
| Comparative Example 171 | Compound 1-16 | Compound C-7 | 4.23 | 16.1 | 131 | Red |
| Comparative Example 172 | Compound 1-22 | Compound C-7 | 4.27 | 16.5 | 134 | Red |
| Comparative Example 173 | Compound 1-38 | Compound C-7 | 4.28 | 15.8 | 140 | Red |
| Comparative Example 174 | Compound 1-41 | Compound C-7 | 4.20 | 15.9 | 137 | Red |
| Comparative Example 175 | Compound 1-45 | Compound C-7 | 4.29 | 16.3 | 143 | Red |
| Comparative Example 176 | Compound 1-53 | Compound C-7 | 4.30 | 16.8 | 129 | Red |
| Comparative Example 177 | Compound 1-57 | Compound C-7 | 4.27 | 162 | 143 | Red |
| Comparative Example 178 | Compound 1 -2 | Compound C-8 | 4.15 | 17.2 | 132 | Red |
| Comparative Example 179 | Compound 1-14 | Compound C-8 | 4.13 | 17.3 | 124 | Red |
| Comparative Example 180 | Compound 1-20 | Compound C-8 | 4.21 | 16.9 | 126 | Red |
| Comparative Example 181 | Compound 1-27 | Compound C-8 | 4.18 | 162 | 119 | Red |
| Comparative Example 182 | Compound 1-31 | Compound C-8 | 4.12 | 16.1 | 137 | Red |
| Comparative Example 183 | Compound 1-52 | Compound C-8 | 4.17 | 16.7 | 124 | Red |
| Comparative Example 184 | Compound 1-56 | Compound C-8 | 4.20 | 17.2 | 130 | Red |
| Comparative Example 185 | Compound 1-60 | Compound C-8 | 4.19 | 17.5 | 142 | Red |
| Comparative Example 186 | Compound 1 -2 | Compound C-9 | 4.21 | 15.3 | 102 | Red |
| Comparative Example 187 | Compound 1-11 | Compound C-9 | 4.16 | 15.6 | 107 | Red |
| Comparative Example 188 | Compound 1-15 | Compound C-9 | 4.24 | 15.1 | 105 | Red |
| Comparative Example 189 | Compound 1-28 | Compound C-9 | 4.27 | 16.0 | 94 | Red |
| Comparative Example 190 | Compound 1-33 | Compound C-9 | 4.19 | 15.3 | 103 | Red |
| Comparative Example 201 | Compound 1-40 | Compound C-9 | 4.22 | 15.8 | 98 | Red |
| Comparative Example 202 | Compound 1-43 | Compound C-9 | 4.26 | 14.7 | 91 | Red |
| Comparative Example 203 | Compound 1-55 | Compound C-9 | 4.27 | 14.9 | 97 | Red |
| Comparative Example 204 | Compound 1 -3 | Compound C-10 | 4.20 | 16.9 | 106 | Red |
| Comparative Example 205 | Compound 1-7 | Compound C-10 | 4.21 | 15.4 | 100 | Red |
| Comparative Example 206 | Compound 1-17 | Compound C-10 | 4.19 | 16.8 | 109 | Red |
| Comparative Example 207 | Compound 1-24 | Compound C-10 | 4.22 | 15.0 | 98 | Red |
| Comparative Example 208 | Compound 1-37 | Compound C-10 | 4.17 | 162 | 112 | Red |
| Comparative Example 209 | Compound 1-47 | Compound C-10 | 4.26 | 16.7 | 101 | Red |
| Comparative Example 210 | Compound 1-48 | Compound C-10 | 4.28 | 16.0 | 94 | Red |
| Comparative Example 211 | Compound 1-58 | Compound C-10 | 4.26 | 15.4 | 110 | Red |
| Comparative Example 212 | Compound 1 -9 | Compound C-11 | 4.31 | 172 | 116 | Red |
| Comparative Example 213 | Compound 1-16 | Compound C-11 | 4.30 | 16.6 | 121 | Red |
| Comparative Example 214 | Compound 1-22 | Compound C-11 | 4.35 | 17.1 | 108 | Red |
| Comparative Example 215 | Compound 1-38 | Compound C-11 | 4.35 | 16.4 | 129 | Red |
| Comparative Example 216 | Compound 1-41 | Compound C-11 | 4.34 | 17.8 | 120 | Red |
| Comparative Example 217 | Compound 1-45 | Compound C-11 | 4.31 | 17.8 | 113 | Red |
| Comparative Example 218 | Compound 1-53 | Compound C-11 | 4.32 | 16.5 | 114 | Red |
| Comparative Example 219 | Compound 1-57 | Compound C-11 | 4.39 | 16.9 | 109 | Red |
| Comparative Example 220 | Compound 1 -2 | Compound C-12 | 4.18 | 16.7 | 103 | Red |
| Comparative Example 221 | Compound 1-14 | Compound C-12 | 4.21 | 17.0 | 92 | Red |
| Comparative Example 222 | Compound 1-20 | Compound C-12 | 4.23 | 17.4 | 99 | Red |
| Comparative Example 223 | Compound 1-27 | Compound C-12 | 4.20 | 16.8 | 108 | Red |
| Comparative Example 224 | Compound 1-31 | Compound C-12 | 4.27 | 17.2 | 96 | Red |
| Comparative Example 225 | Compound 1-52 | Compound C-12 | 4.26 | 17.3 | 91 | Red |
| Comparative Example 226 | Compound 1-56 | Compound C-12 | 4.24 | 17.5 | 105 | Red |
| Comparative Example 227 | Compound 1-60 | Compound C-12 | 4.19 | 16.1 | 112 | Red |

When a current was applied to the organic light emitting devices manufactured according to Examples 1 to 155 and Comparative Examples 1 to 227, the results of Tables 1 to 4 above were obtained. In the organic light emitting device of Comparative Example 1, a material that has been widely used conventionally was used.

In Comparative Examples 2 to 61, the organic light emitting devices were manufactured by using the compound represented by Chemical Formula 2 of the present disclosure as the electron blocking layer, and using a single host as the light emitting layer in the same manner as in Comparative Example 1. When the compound represented by Chemical Formula 1 and the compound represented by Chemical Formula 2 were co-deposited and used as the light emitting layer as in Example of Table 1, it was confirmed that the driving voltage decreased and the efficiency and lifetime increased as compared with Comparative Example of Table 2.

Further, when Comparative Example compounds B-1 to B-12 and the compound represented by Chemical Formula 2 of the present disclosure were co-deposited and used as the light emitting layer as shown in Table 3, the result showed that the driving voltage generally increased and the efficiency and lifetime decreased as compared with a combination of the present disclosure. As shown in Table 4, even when Comparative Example compounds C-1 to C-12 and the compounds represented by Chemical Formula 1 of the present disclosure were co-deposited and used as the light emitting layer, the result showed that the driving voltage increased and the efficiency and lifetime decreased.

From these results, it can be seen that when the compound represented by Chemical Formula 1 as the first host and the compound represented by Chemical Formula 2 as the second host were used in combination, energy transfer to the red dopant in the light emitting layer was well performed, thereby improving the driving voltage and increasing the efficiency and lifetime. In addition, it can be inferred that the combination of the compounds of Examples can form a more stable balance within the light emitting layer than the combination of the compounds of Comparative Examples to form excitons by the combination of electrons and holes, thereby further improving the efficiency and lifetime of the manufactured organic light emitting devices.

That is, when the compound represented by Chemical Formula 1 and the compound represented by Chemical Formula 2 of the present disclosure were used in combination as a host of the light emitting layer, the driving voltage, luminous efficiency, and lifetime characteristics of the organic light emitting devices could be improved.

### <Description of Symbols>

1: substrate 2: anode
3: light emitting layer 4: cathode
5: hole injection layer 6: hole transport layer
7: electron blocking layer 8: hole blocking layer
9: electron injection and transport layer

## Claims

1. An organic light emitting device comprising:
an anode (2);
a cathode (4); and
a light emitting layer (3) disposed between the anode and the cathode,
wherein the light emitting layer includes a compound represented by the following Chemical Formula 1 and a compound represented by the following Chemical Formula 2: 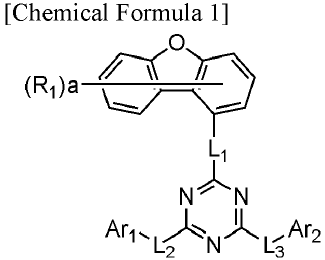
wherein in Chemical Formula 1,
Ar₁ and Ar₂ are each independently a substituted or unsubstituted C₆₋₆₀ aryl; or a substituted or unsubstituted C₂₋₆₀ heteroaryl containing one or more selected from the group consisting of N, O and S,
L₁ to L₃ are each independently a single bond; or a substituted or unsubstituted C₆₋₆₀ arylene,
R₁ is hydrogen; deuterium; a substituted or unsubstituted C₆₋₆₀ aryl; or a substituted or unsubstituted C₂₋₆₀ heteroaryl containing one or more selected from the group consisting of N, O and S,
a is an integer of 0 to 7, 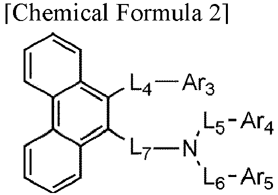
wherein in Chemical Formula 2,
Ar₃ is hydrogen; a substituted or unsubstituted C₆₋₆₀ aryl; or a substituted or unsubstituted C₂₋₆₀ heteroaryl containing one or more selected from the group consisting of N, O and S,
Aᵣ₄ and Ar₅ are each independently a substituted or unsubstituted C₆₋₆₀ aryl; or a substituted or unsubstituted C₂₋₆₀ heteroaryl containing one or more selected from the group consisting of N, O and S,
L₄ to L₆ are each independently a single bond; a substituted or unsubstituted C₆₋₆₀ arylene; or a substituted or unsubstituted C₂₋₆₀ heteroarylene containing one or more selected from the group consisting of N, O and S, and
L₇ is a substituted or unsubstituted C₆₋₆₀ arylene.

2. The organic light emitting device according to claim 1,
wherein the compound represented by Chemical Formula 1 is represented by any one of the following Chemical Formulas 1-1 to 1-3: 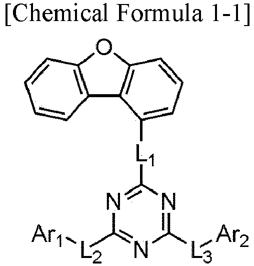 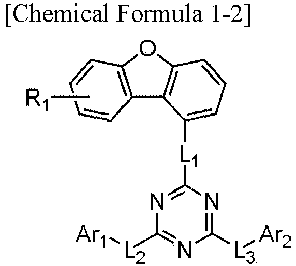 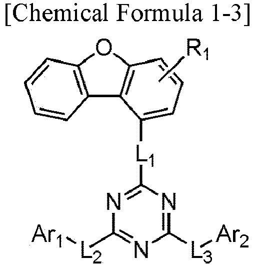
wherein in Chemical Formulas 1-1 to 1-3,
Ar₁ and Ar₂, L₁ to L₃ and R₁ are as defined in claim 1.

3. The organic light emitting device according to claim 1,
wherein Ar₁ and Ar₂ are each independently phenyl, biphenylyl, terphenylyl, naphthyl, phenanthrenyl, dibenzofuranyl, or dibenzothiophenyl.

4. The organic light emitting device according to claim 1,
wherein L₁ to L₃ are each independently a single bond or any one selected from the group consisting of the following:

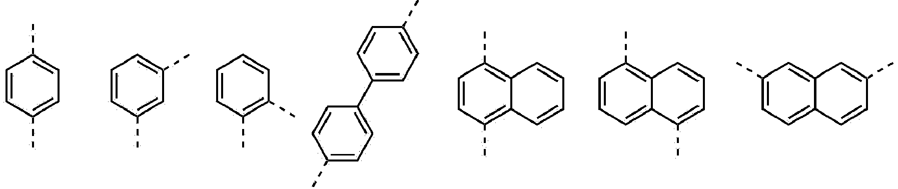

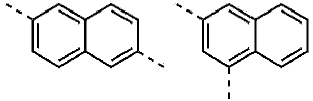

5. The organic light emitting device according to claim 1,
wherein each R₁ is each independently hydrogen, deuterium, phenyl, biphenylyl, terphenylyl, naphthyl, phenanthrenyl, triphenylenyl, naphthyl phenyl, phenyl naphthyl, fluoranthenyl, dihydroindenyl, dibenzofuranyl, dibenzothiophenyl, benzonaphthofuranyl, or benzonaphthothiophenyl.

6. The organic light emitting device according to claim 1,
wherein at least one of Ar₁, Ar₂ and R₁ is naphthyl, phenyl naphthyl, naphthyl phenyl, phenanthrenyl, fluoranthenyl, dibenzofuranyl, dibenzothiophenyl, benzonaphthofuranyl, or benzonaphthothiophenyl.

7. The organic light emitting device according to claim 1,
wherein a is 0 or 1.

8. The organic light emitting device according to claim 1,
wherein Ar₃ is hydrogen or phenyl.

9. The organic light emitting device according to claim 1,
wherein Ar₄ and Ar₅ are each independently phenyl, phenyl substituted with 5 deuteriums, biphenylyl, biphenylyl substituted with 4 deuteriums, biphenylyl substituted with 9 deuteriums, terphenylyl, terphenylyl substituted with 4 deuteriums, quarterphenylyl, naphthyl, phenanthrenyl, triphenylenyl, dimethylfluorenyl, diphenylfluorenyl, carbazolyl, phenylcarbazolyl, dibenzofuranyl, dibenzothiophenyl, or phenyl dibenzofuranyl.

10. The organic light emitting device according to claim 1,
wherein Ar₄ and Ar₅ are each independently any one selected from the group consisting of the following:

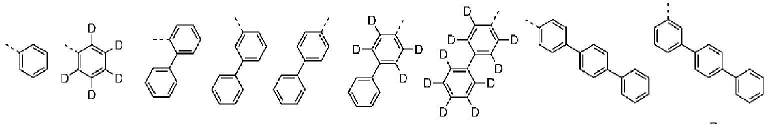

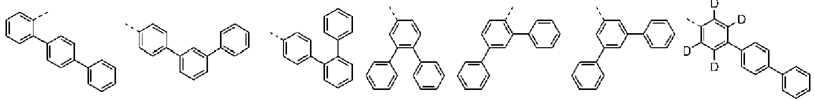

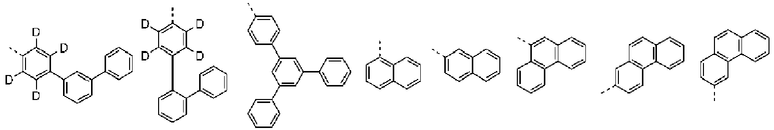

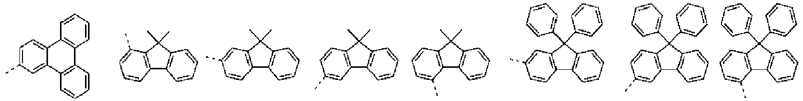

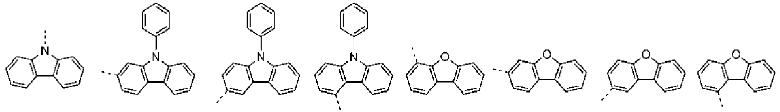

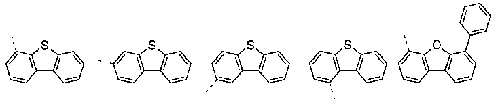

11. The organic light emitting device according to claim 1,
wherein L₄ to L₆ are each independently a single bond, phenylene, phenylene substituted with 4 deuteriums, biphenylylene, naphthylene, phenyl naphthylene, carbazolylene, phenyl carbazolylene, phenyl carbazolylene substituted with 4 deuteriums, dibenzofuranylene, phenyl dibenzofuranylene, phenyl dibenzofuranylene substituted with 4 deuteriums, or dimethylfluorenylene.

12. The organic light emitting device according to claim 1,
wherein L₄ to L₆ are each independently a single bond or any one selected from the group consisting of the following:

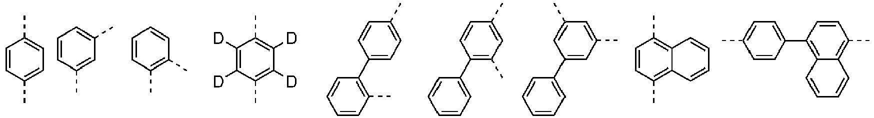

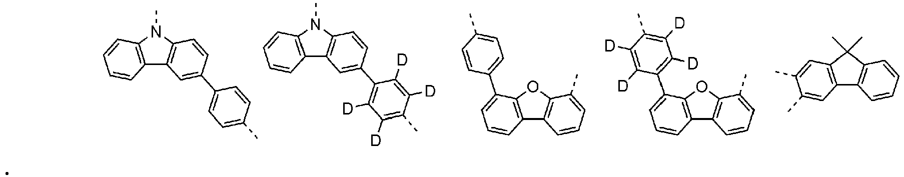

13. The organic light emitting device according to claim 1,
wherein L₇ is a substituted or unsubstituted phenylene, a substituted or unsubstituted biphenylylene, or a substituted or unsubstituted naphthylene.

14. The organic light emitting device according to claim 1,
wherein the compound represented by Chemical Formula 2 is represented by the following Chemical Formula 2-1: 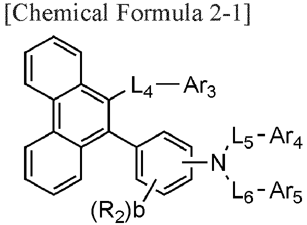 wherein in Chemical Formula 2-1,
Ar₃ to Ar₅ and L₄ to L₆ are as defined in claim 1,
R₂ is hydrogen; deuterium; or a substituted or unsubstituted C₆₋₆₀ aryl, and
b is an integer of 0 to 4.

15. The organic light emitting device according to claim 14,
wherein R₂ is hydrogen or deuterium.

## Patentansprüche

1. Organische lichtemittierende Vorrichtung, umfassend:
eine Anode (2),
eine Kathode (4) und
eine lichtemittierende Schicht (3), die zwischen der Anode und der Kathode angeordnet ist,
wobei die lichtemittierende Schicht eine durch die folgende chemische Formel 1 dargestellte Verbindung und eine durch die folgende chemische Formel 2 dargestellte Verbindung einschließt: 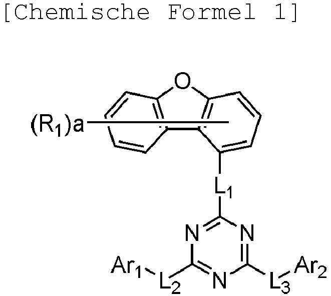
wobei in der chemischen Formel 1
Ar₁ und Ar₂ jeweils unabhängig ein substituiertes oder unsubstituiertes C₆₋₆₀-Aryl oder ein substituiertes oder unsubstituiertes C₂₋₆₀-Heteroaryl sind, das mindestens eines oder mehrere, ausgewählt aus der Gruppe, bestehend aus N, O und S, enthält,
L₁ bis L₃ jeweils unabhängig eine Einfachbindung oder ein substituiertes oder unsubstituiertes C₆₋₆₀-Arylen sind,
R₁ Wasserstoff, Deuterium, ein substituiertes oder unsubstituiertes C₆₋₆₀-Aryl oder ein substituiertes oder unsubstituiertes C₂₋₆₀-Heteroaryl ist, das mindestens eines, ausgewählt aus der Gruppe, bestehend aus N, O und S, enthält,
a eine ganze Zahl von 0 bis 7 ist, 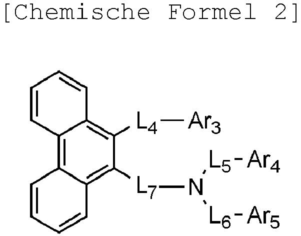
wobei in der chemischen Formel 2
Ar₃ Wasserstoff, ein substituiertes oder unsubstituiertes C₆₋₆₀-Aryl oder ein substituiertes oder unsubstituiertes C₂₋₆₀-Heteroaryl ist, das mindestens eines, ausgewählt aus der Gruppe, bestehend aus N, O und S, enthält,
Ar₄ und Ar₅ jeweils unabhängig ein substituiertes oder unsubstituiertes C₆₋₆₀-Aryl oder ein substituiertes oder unsubstituiertes C₂₋₆₀-Heteroaryl sind, das eines oder mehrere, ausgewählt aus der Gruppe, bestehend aus N, O und S, enthält,
L₄ bis L₆ jeweils unabhängig eine Einfachbindung, ein substituiertes oder unsubstituiertes C₆₋₆₀-Arylen oder ein substituiertes oder unsubstituiertes C₂₋₆₀-Heteroarylen sind, das eines oder mehrere, ausgewählt aus der Gruppe, bestehend aus N, O und S, enthält, und
L₇ ein substituiertes oder unsubstituiertes C₆₋₆₀-Arylen ist.

2. Organische lichtemittierende Vorrichtung gemäß Anspruch 1,
wobei die durch die folgende chemische Formel 1 dargestellte Verbindung durch eine der folgenden chemischen Formeln 1-1 bis 1-3 dargestellt ist: 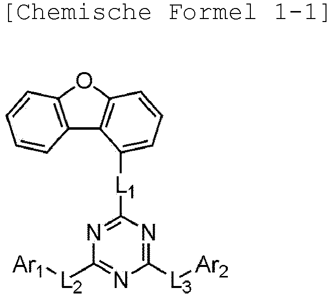 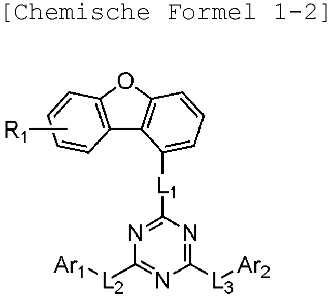 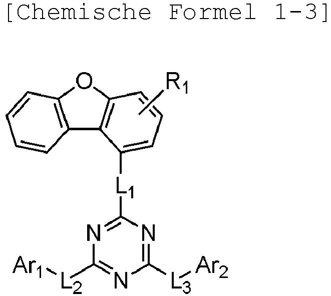
wobei in den chemischen Formeln 1-1 bis 1-3
Ar₁ und Ar₂, L₁ bis L₃ und R₁ so wie in Anspruch 1 definiert sind.

3. Organische lichtemittierende Vorrichtung gemäß Anspruch 1,
wobei Ar₁ und Ar₂ jeweils unabhängig Phenyl, Biphenylyl, Terphenylyl, Naphthyl, Phenanthrenyl, Dibenzofuranyl oder Dibenzothiophenyl sind.

4. Organische lichtemittierende Vorrichtung gemäß Anspruch 1,
wobei L₁ bis L₃ jeweils unabhängig eine Einfachbindung oder eines, ausgewählt aus der Gruppe, bestehend aus den Folgenden, sind:

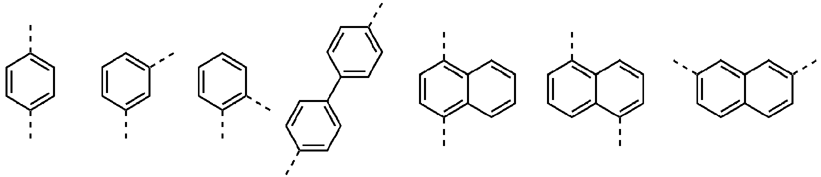

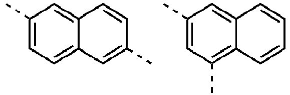

5. Organische lichtemittierende Vorrichtung gemäß Anspruch 1,
wobei jedes R₁ jeweils unabhängig Wasserstoff, Deuterium, Phenyl, Biphenylyl, Terphenylyl, Naphthyl, Phenanthrenyl, Triphenylenyl, Naphthylphenyl, Phenylnaphthyl, Fluoranthenyl, Dihydroindenyl, Dibenzofuranyl, Dibenzothiophenyl, Benzonaphthofuranyl oder Benzonaphthothiophenyl ist.

6. Organische lichtemittierende Vorrichtung gemäß Anspruch 1,
wobei mindestens eines von Ar₁, Ar₂ und R₁ Naphthyl, Phenylnaphthyl, Naphthylphenyl, Phenanthrenyl, Fluoranthenyl, Dibenzofuranyl, Dibenzothiophenyl, Benzonaphthofuranyl oder Benzonaphthothiophenyl ist.

7. Organische lichtemittierende Vorrichtung gemäß Anspruch 1,
wobei a 0 oder 1 ist.

8. Organische lichtemittierende Vorrichtung gemäß Anspruch 1,
wobei Ar₃ Wasserstoff oder Phenyl ist.

9. Organische lichtemittierende Vorrichtung gemäß Anspruch 1,
wobei Ar₄ und Ar₅ jeweils unabhängig Phenyl, Phenyl, substituiert mit 5 Deuterium, Biphenylyl, Biphenylyl, substituiert mit 4 Deuterium, Biphenylyl, substituiert mit 9 Deuterium, Terphenylyl, Terphenylyl, substituiert mit 4 Deuterium, Quarterphenylyl, Naphthyl, Phenanthrenyl, Triphenylenyl, Dimethylfluorenyl, Diphenylfluorenyl, Carbazolyl, Phenylcarbazolyl, Dibenzofuranyl, Dibenzothiophenyl oder Phenyldibenzofuranyl sind.

10. Organische lichtemittierende Vorrichtung gemäß Anspruch 1,
wobei Ar₄ und Ar₅ jeweils unabhängig eines, ausgewählt aus der Gruppe, bestehend aus den Folgenden, sind:

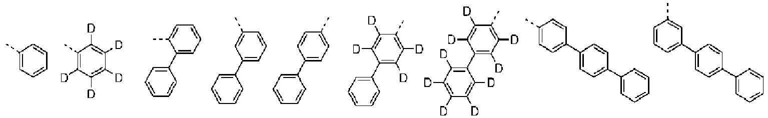

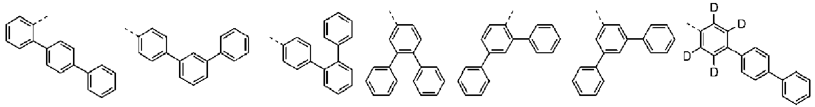

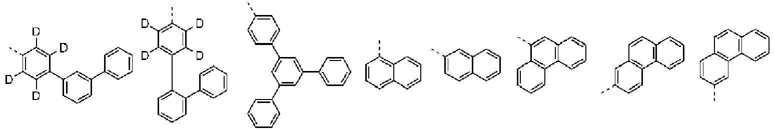

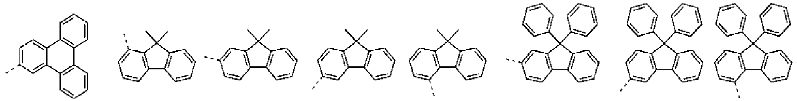

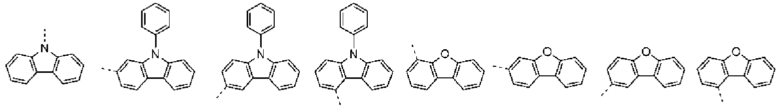

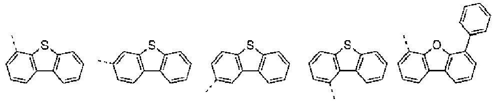

11. Organische lichtemittierende Vorrichtung gemäß Anspruch 1,
wobei L₄ bis L₆ jeweils unabhängig eine Einfachbindung, Phenylen, Phenylen, substituiert mit 4 Deuterium, Biphenylylen, Naphthylen, Phenylnaphthylen, Carbazolylen, Phenylcarbazolylen, Phenylcarbazolylen, substituiert mit 4 Deuterium, Dibenzofuranylen, Phenyldibenzofuranylen, Phenyldibenzofuranylen, substituiert mit 4 Deuterium oder Dimethylfluorenylen sind.

12. Organische lichtemittierende Vorrichtung gemäß Anspruch 1,
wobei L₄ bis L₆ jeweils unabhängig eine Einfachbindung oder eines, ausgewählt aus der Gruppe, bestehend aus den Folgenden, sind:

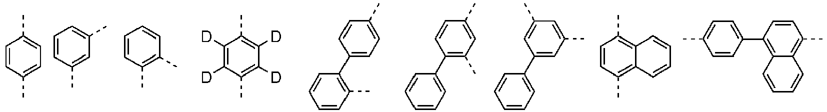

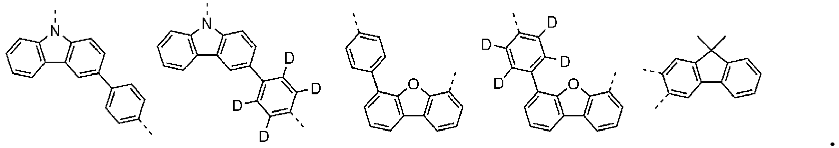

13. Organische lichtemittierende Vorrichtung gemäß Anspruch 1,
wobei L₇ ein substituiertes oder unsubstituiertes Phenylen, ein substituiertes oder unsubstituiertes Biphenylylen oder ein substituiertes oder unsubstituiertes Naphthylen ist.

14. Organische lichtemittierende Vorrichtung gemäß Anspruch 1,
wobei die durch die chemische Formel 2 dargestellte Verbindung durch die folgende chemische Formel 2-1 dargestellt ist: 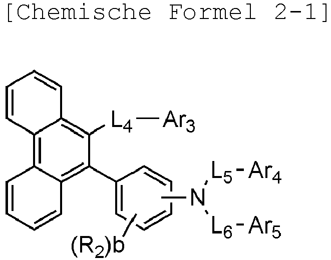
wobei in der chemischen Formel 2-1
Ar₃ bis Ar₅ und L₄ bis L₆ so wie in Anspruch 1 definiert sind,
R₂ Wasserstoff, Deuterium oder ein substituiertes oder unsubstituiertes C₆₋₆₀-Aryl ist und
b eine ganze Zahl von 0 bis 4 ist.

15. Organische lichtemittierende Vorrichtung gemäß Anspruch 14,
wobei R₂ Wasserstoff oder Deuterium ist.

## Revendications

1. Dispositif électroluminescent organique comprenant :
une anode (2) ;
une cathode (4) ; et
une couche électroluminescente (3) disposée entre l'anode et la cathode,
dans lequel la couche électroluminescente inclut un composé représenté par la formule chimique 1 suivante et un composé représenté par la formule chimique 2 suivante : 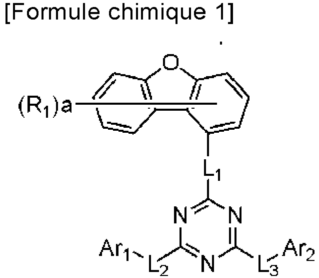
dans lequel, dans la formule chimique 1,
Ar₁ et Ar₂ sont chacun indépendamment un aryle en C₆₋₆₀ substitué ou non substitué ; ou un hétéroaryle en C₂₋₆₀ substitué ou non substitué contenant un ou plusieurs sélectionnés dans le groupe consistant en N, O et S,
L₁ à L₃ sont chacun indépendamment une liaison simple ; ou un arylène en C₆₋₆₀ substitué ou non substitué,
R₁ est de l'hydrogène ; du deutérium ; un aryle en C₆₋₆₀ substitué ou non substitué ; ou un hétéroaryle en C₂₋₆₀ substitué ou non substitué contenant un ou plusieurs sélectionnés dans le groupe consistant en N, O et S,
a est un entier allant de 0 à 7, 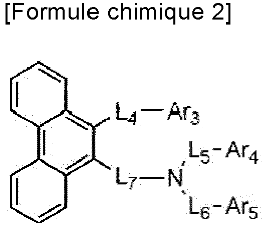
dans lequel, dans la formule chimique 2,
Ar₃ est de l'hydrogène ; un aryle en C₆₋₆₀ substitué ou non substitué ; ou un hétéroaryle en C₂₋₆₀ substitué ou non substitué contenant un ou plusieurs sélectionnés dans le groupe consistant en N, O et S,
Ar₄ et Ar₅ sont chacun indépendamment un aryle en C₆₋₆₀ substitué ou non substitué ; ou un hétéroaryle en C₂₋₆₀ substitué ou non substitué contenant un ou plusieurs sélectionnés dans le groupe consistant en N, O et S,
L₄ à L₆ sont chacun indépendamment une liaison simple ; un arylène en C₆₋₆₀ substitué ou non substitué ; ou un hétéroarylène en C₂₋₆₀ substitué ou non substitué contenant un ou plusieurs sélectionnés dans le groupe consistant en N, O et S, et
L₇ est un arylène en C₆₋₆₀ substitué ou non substitué,

2. Dispositif électroluminescent organique selon la revendication 1,
dans lequel le composé représenté par la formule chimique 1 est représenté par l'une quelconque des formules chimiques 1-1 à 1-3 suivantes : 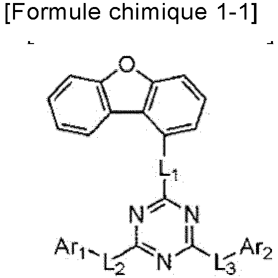 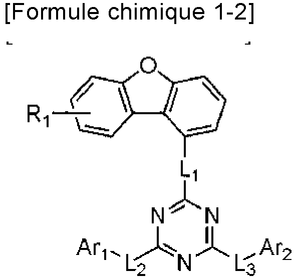 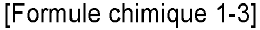 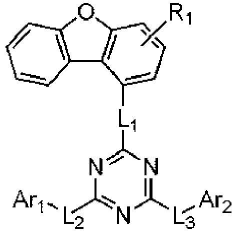
dans lequel, dans les formules chimiques 1-1 à 1-3,
Ar₁ et Ar₂, L₁ à L₃ et R₁ sont tels que définis dans la revendication 1.

3. Dispositif électroluminescent organique selon la revendication 1,
dans lequel Ar₁ et Ar₂ sont chacun indépendamment du phényle, du biphénylyle, du terphénylyle, du naphtyle, du phénanthrényle, du dibenzofuranyle, ou du dibenzothiophényle.

4. Dispositif électroluminescent organique selon la revendication 1,
dans lequel L₁ à L₃ sont chacun indépendamment une liaison simple ou un quelconque sélectionné dans le groupe consistant en ce qui suit :

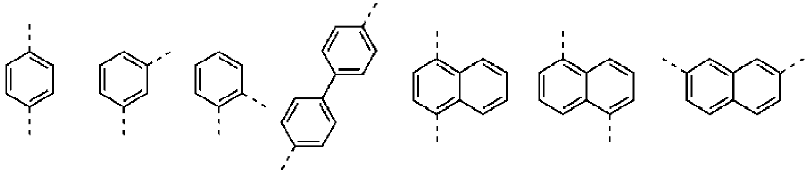

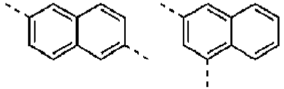

5. Dispositif électroluminescent organique selon la revendication 1,
dans lequel chaque R₁ est chacun indépendamment de l'hydrogène, du deutérium, du phényle, du biphénylyle, du terphénylyle, du naphtyle, du phénanthrényle, du triphénylènyle, du naphtyle phényle, du phényle naphtyle, du fluoranthényle, du dihydroindényle, du dibenzofuranyle, du dibenzothiophényle, du benzonaphtofuranyle, ou du benzonaphtothiophényle.

6. Dispositif électroluminescent organique selon la revendication 1,
dans lequel au moins un parmi Ar₁, Ar₂ et R₁ est du naphtyle, du phényle naphtyle, du naphtyle phényle, du phénanthrényle, du fluoranthényle, du dibenzofuranyle, du dibenzothiophényle, du benzonaphtofuranyle, ou du benzonaphtothiophényle.

7. Dispositif électroluminescent organique selon la revendication 1,
dans lequel a vaut 0 ou 1.

8. Dispositif électroluminescent organique selon la revendication 1,
dans lequel Ar₃ est de l'hydrogène ou du phényle.

9. Dispositif électroluminescent organique selon la revendication 1,
dans lequel Ar₄ et Ar₅ sont chacun indépendamment du phényle, du phényle substitué avec 5 deutériums, du biphénylyle, du biphénylyle substitué avec 4 deutériums, du biphénylyle substitué avec 9 deutériums, du terphénylyle, du terphénylyle substitué avec 4 deutériums, du quarterphénylyle, du naphtyle, du phénanthrényle, du triphénylènyle, du diméthylfluorényle, du diphénylfluorényle, du carbazolyle, du phénylcarbazolyle, du dibenzofuranyle, du dibenzothiophényle, ou du phényle dibenzofuranyle.

10. Dispositif électroluminescent organique selon la revendication 1,
dans lequel Ar₄ et Ar₅ sont chacun indépendamment l'un quelconque sélectionné dans le groupe consistant en ce qui suit :

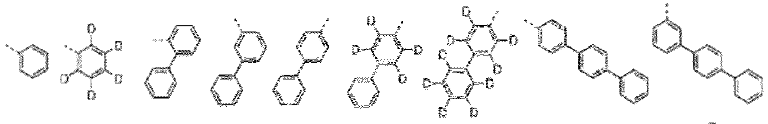

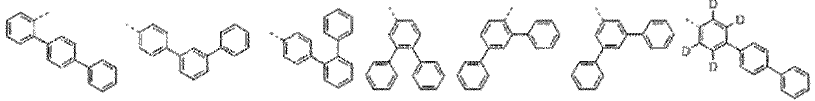

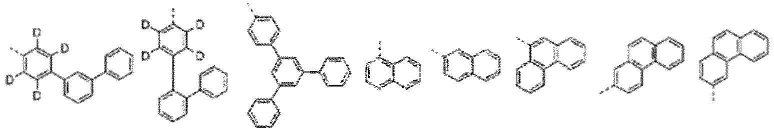

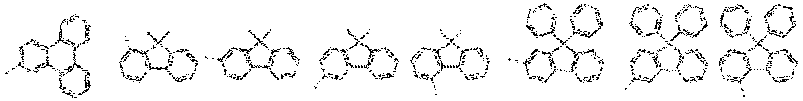

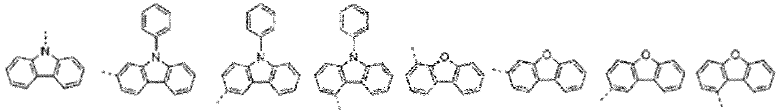

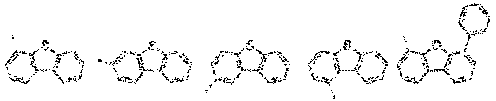

11. Dispositif électroluminescent organique selon la revendication 1, dans lequel L₄ à L₆ sont chacun indépendamment une liaison simple, du phénylène, du phénylène substitué avec 4 deutériums, du biphénylylène, du naphtylène, du phényle naphtylène, du carbazolylène, du phényle carbazolylène, du phényle carbazolylène substitué avec 4 deutériums, du dibenzofuranylène, du phényle dibenzofuranylène, du phényle dibenzofuranylène substitué avec 4 deutériums, ou du diméthylfluorénylène.

12. Dispositif électroluminescent organique selon la revendication 1,
dans lequel L₄ à L₆ sont chacun indépendamment une liaison simple ou l'un quelconque sélectionné dans le groupe consistant en ce qui suit :

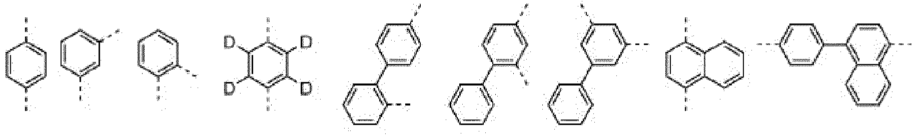

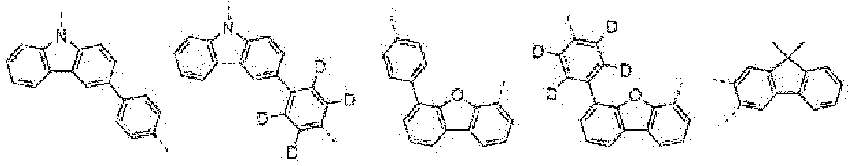

13. Dispositif électroluminescent organique selon la revendication 1,
dans lequel L₇ est un phénylène substitué ou non substitué, un biphénylylène substitué ou non substitué, ou un naphtylène substitué ou non substitué.

14. Dispositif électroluminescent organique selon la revendication 1,
dans lequel le composé représenté par la formule chimique 2 est représenté par la formule chimique 2-1 suivante : 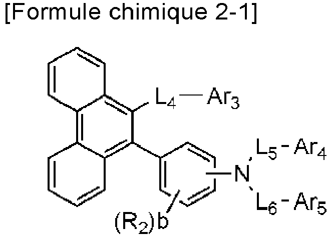 dans lequel, dans la formule chimique 2-1,
Ar₃ à Ar₅ et L₄ à L₆ sont tels que définis dans la revendication 1,
R₂ est de l'hydrogène ; du deutérium ; ou un aryle en C₆₋₆₀ substitué ou non substitué, et
b est un entier allant de 0 à 4.

15. Dispositif électroluminescent organique selon la revendication 14,
dans lequel R₂ est de l'hydrogène ou du deutérium.
